(19) Europäisches Patentamt
European Patent Office
Office européen des brevets

(11) EP 4 002 509 A1

(12) **EUROPEAN PATENT APPLICATION**

(43) Date of publication:
**25.05.2022 Bulletin 2022/21**

(21) Application number: **21208148.3**

(22) Date of filing: **15.11.2021**

(51) International Patent Classification (IPC):
***H01L 51/54*** *(2006.01)*

(52) Cooperative Patent Classification (CPC):
**H01L 51/5004; H01L 51/504;** H01L 51/0085; H01L 2251/5384; H01L 2251/552; H01L 2251/558

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **20.11.2020 KR 20200156926**
**12.11.2021 KR 20210155885**

(71) Applicant: **Samsung Electronics Co., Ltd.**
**Gyeonggi-do 16677 (KR)**

(72) Inventors:
- **KWAK, Seungyeon**
**16678 Suwon-si (KR)**
- **KIM, Hyungjun**
**16678 Suwon-si (KR)**
- **SIM, Myungsun**
**16678 Suwon-si (KR)**
- **LEE, Kum Hee**
**16678 Suwon-si (KR)**
- **LEE, Sunghun**
**16678 Suwon-si (KR)**
- **YI, Jeoungin**
**16678 Suwon-si (KR)**
- **CHOI, Byoungki**
**16678 Suwon-si (KR)**
- **HWANG, Kyuyoung**
**16678 Suwon-si (KR)**

(74) Representative: **Elkington and Fife LLP**
**Prospect House**
**8 Pembroke Road**
**Sevenoaks, Kent TN13 1XR (GB)**

(54) **LIGHT-EMITTING DEVICE AND ELECTRONIC APPARATUS INCLUDING THE SAME**

(57) Provided are a light-emitting device and an electronic apparatus including the same, the light-emitting device including: a first electrode; a second electrode facing the first electrode; and an emission layer between the first electrode and the second electrode. The emission layer includes i) a first emission layer and ii) a second emission layer located between the first emission layer and the second electrode, the first emission layer is in direct contact with the second emission layer, the first emission layer includes a dopant, a first hole-transporting compound, and a first compound, the second emission layer includes a dopant, a second hole-transporting compound, and a second compound, the dopant included in the first emission layer and the dopant included in the second emission layer are identical to each other, the first compound and the second compound are different from each other, and an absolute value of the difference between a HOMO energy level of the second hole-transporting compound and a HOMO energy level of the second compound is 0.3 eV or less.

FIG. 2

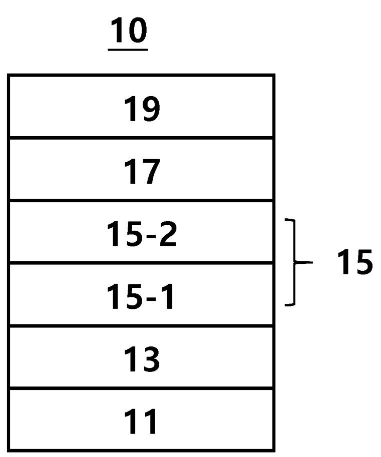


EP 4 002 509 A1

## Description

### FIELD OF THE INVENTION

One or more embodiments relate to a light-emitting device and an electronic apparatus including the same.

### BACKGROUND OF THE INVENTION

From among light-emitting devices, organic light-emitting devices are self-emission devices, which have improved characteristics in terms of viewing angles, response time, luminance, driving voltage, and response speed, and produce full-color images.

In an example, an organic light-emitting device includes an anode, a cathode, and an organic layer located between the anode and the cathode, wherein the organic layer includes an emission layer. A hole-transporting region may be located between the anode and the emission layer, and an electron-transporting region may be located between the emission layer and the cathode. Holes provided from the anode may move toward the emission layer through the hole-transporting region, and electrons provided from the cathode may move toward the emission layer through the electron-transporting region. The holes and the electrons recombine in the emission layer to produce excitons. These excitons transition from an excited state to a ground state to thereby generate light.

### SUMMARY OF THE INVENTION

One or more embodiments provide a light-emitting device having an emission layer and an electronic apparatus including the same.

Additional aspects will be set forth in part in the description, which follows and, in part, will be apparent from the description, or may be learned by practice of the presented embodiments of the disclosure.

According to one or more embodiments, a light-emitting device includes

a first electrode,
a second electrode facing the first electrode,
an emission layer between the first electrode and the second electrode,
the emission layer includes i) a first emission layer and ii) a second emission layer located between the first emission layer and the second electrode,
the first emission layer is in direct contact with the second emission layer,
the first emission layer includes a dopant, a first hole-transporting compound, and a first compound,
the second emission layer includes a dopant, a second hole-transporting compound, and a second compound,
the dopant included in the first emission layer and the dopant included in the second emission layer are identical to each other,
the first compound and the second compound are different from each other,
the absolute value of the difference between the highest occupied molecular orbital (HOMO) energy level of the second hole-transporting compound and the HOMO energy level of the second compound is 0.3 eV or less, and
the HOMO energy level of the second hole-transporting compound and the HOMO energy level of the second compound are negative values measured by using a photoelectron spectroscopy in air.

According to one or more embodiments, an electronic apparatus includes the light-emitting device.

### BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 shows an exemplary diagram illustrating a highest occupied molecular orbital (HOMO) energy level of first hole-transporting compound (HOMO(HT1)), a HOMO energy level of a first compound (HOMO(ET)), a HOMO energy level of a second hole-transporting compound (HOMO(HT2)), a HOMO energy level of a second compound (HOMO(BP)), and a HOMO energy level of a dopant (HOMO(D)); and
FIG. 2 is a schematic view of an organic light-emitting device according to an exemplary embodiment.

## DETAILED DESCRIPTION OF THE EMBODIMENTS

Reference will now be made in detail to embodiments, examples of which are illustrated in the accompanying drawings, wherein like reference numerals refer to like elements throughout the specification. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

It will be understood that when an element is referred to as being "on" another element, it can be directly on the other element or intervening elements may be present therebetween In contrast, when an element is referred to as being "directly on" another element, there are no intervening elements present

It will be understood that, although the terms "first," "second," "third" etc. may be used herein to describe various elements, components, regions, layers and/or sections, these elements, components, regions, layers and/or sections should not be limited by these terms These terms are only used to distinguish one element, component, region, layer or section from another element, component, region, layer or section Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, "a," "an," "the," and "at least one" do not denote a limitation of quantity, and are intended to cover both the singular and plural, unless the context clearly indicates otherwise. For example, "an element" has the same meaning as "at least one element," unless the context clearly indicates otherwise.

"Or" means "and/or." As used herein, the term "and/or" includes any and all combinations of one or more of the associated listed items It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures It will be understood that relative terms are intended to encompass different orientations of the device in addition to the orientation depicted in the Figures For example, if the device in one of the figures is turned over, elements described as being on the "lower" side of other elements would then be oriented on "upper" sides of the other elements The exemplary term "lower," can therefore, encompasses both an orientation of "lower" and "upper," depending on the particular orientation of the figure Similarly, if the device in one of the figures is turned over, elements described as "below" or "beneath" other elements would then be oriented "above" the other elements The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within $\pm$ 30%, 20%, 10% or 5% of the stated value.

Unless otherwise defined, all terms (including technical and scientific terms) used herein have the same meaning as commonly understood by one of ordinary skill in the art to which this disclosure belongs It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments As such, variations from the shapes of the illustrations as a result, for example, of manufacturing techniques and/or tolerances, are to be expected Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features Moreover, sharp angles that are illustrated may be rounded Thus, the regions illustrated in the figures are schematic in nature and their shapes are not intended to illustrate the precise shape of a region and are not intended to limit the scope of the present claims.

The light-emitting device may include: a first electrode; a second electrode facing the first electrode; and an emission layer located between the first electrode and the second electrode, wherein the emission layer may include i) a first emission layer; and ii) a second emission layer located between the first emission layer and the second electrode.

The first emission layer may be in direct contact with the second emission layer.

The first emission layer includes a dopant, a first hole-transporting compound, and a first compound, and the second emission layer includes a dopant, a second hole-transporting compound, and a second compound.

The dopant, the first hole-transporting compound, and the first compound included in the first emission layer may be different from each other.

The dopant, the second hole-transporting compound, and the second compound included in the second emission layer may be different from each other.

The total weight of the first hole-transporting compound and the first compound in the first emission layer may be greater than the weight of the dopant included in the first emission layer.

The total weight of the second hole-transporting compound and the second compound in the second emission layer may be greater than the weight of the dopant included in the second emission layer.

The dopant included in the first emission layer and the dopant included in the second emission layer may be identical to each other. The detailed description of the dopants is the same as described in the present specification.

In one or more embodiments, the dopant may be a phosphorescent dopant.

In one or more embodiments, the dopant may be a transition metal-containing organometallic compound.

In one or more embodiments, the dopant may be a transition metal-containing heteroleptic organometallic compound.

In one or more embodiments, the dopant may be an organometallic compound represented by Formula 1. Formula 1 will be described in detail later.

In one or more embodiments, the dopant includes a transition metal-containing organometallic compound, wherein the transition metal-containing organometallic compound includes a pyridine group, a benzimidazole group(or a naphthimidazole group), and a dibenzofuran group (or azadibenzofuran group, a dibenzothiophene group, or an azadibenzothiophene group), each of the pyridine group and the benzimidazole group (or a naphthimidazole group) may be attached to the transition metal of the transition metal-containing organometallic compound via nitrogen, and the dibenzofuran group (or azadibenzofuran group, a dibenzothiophene group, or an azadibenzothiophene group) may be attached to the transition metal of the transition metal-containing organometallic compound via carbon. The pyridine group, the benzimidazole group (or a naphthimidazole group), and the dibenzofuran group (or an azadibenzofuran group, a dibenzothiophene group, or an azadibenzothiophene group) may be optionally substituted with at least one $R_1$. $R_1$ is the same as described in connection with Formula 1.

In one or more embodiments, the dopant may be a transition metal-containing organometallic compound, and the transition metal-containing organometallic compound may include a group represented by $-Si(Q_3)(Q_4)(Q_5)$, a group represented by $-Ge(Q_3)(Q_4)(Q_5)$, or any combination thereof. $-Si(Q_3)(Q_4)(Q_5)$ and $-Ge(Q_3)(Q_4)(Q_5)$ are the same as described in connection with Formula 1.

Each of the first hole-transporting compound and the second hole-transporting compound may include at least one $\pi$ electron rich $C_3$-$C_{60}$ cyclic group (for example, $\pi$ electron rich $C_6$-$C_{60}$ cyclic group, such as a carbazole group, an indolocarbazole group, a benzene group, etc.) and may not include an electron-transporting group. Examples of the electron-transporting group include a cyano group, a fluoro group, a $\pi$ electron-deficient nitrogen-containing $C_1$-$C_{60}$ cyclic group (for example, a $\pi$ electron-deficient nitrogen-containing $C_5$-$C_{60}$ cyclic group), a phosphine oxide group, and a sulfoxide group.

In one or more embodiments, the first hole-transporting compound and the second hole-transporting compound may each be a compound represented by Formula 5. Formula 5 will be described in detail later.

In one or more embodiments, the first hole-transporting compound and the second hole-transporting compound may be different from each other.

In one or more embodiments, the first hole-transporting compound and the second hole-transporting compound may be identical to each other.

The first compound included in the first emission layer and the second compound included in the second emission layer may be different from each other.

In one or more embodiments, the first compound may be an electron-transporting compound. For example, the first compound may be a compound containing at least one electron-transporting group. The electron-transporting group may be a cyano group, a fluoro group, a $\pi$ electron-deficient nitrogen-containing $C_1$-$C_{60}$ cyclic group, a phosphine oxide group, a sulfoxide group, or a combination thereof.

In one or more embodiments, the first compound may be a compound represented by Formula 7. Formula 7 will be described in detail later.

The absolute value of the difference between the highest occupied molecular orbital (HOMO) energy level of the second hole-transporting compound included in the second emission layer and the HOMO energy level of the second compound included in the second emission layer may be about 0.3 eV or less. The second compound included in the second emission layer may be any compound that satisfies the absolute value relationship of the difference in HOMO energy levels as described above.

In one or more embodiments, the second compound may be a bipolar compound.

In one or more embodiments, the second compound may be a compound represented by Formula 9 below. Formula 9 is the same as described in the present specification.

The "HOMO energy level" is a found value measured by using a photoelectron spectroscopy in air, and is a negative value.

Hereinafter, the HOMO energy level relationship among the dopant, the first hole-transporting compound, the first compound, the second hole-transporting compound and the second compound will be described with reference to FIG. 1.

FIG. 1 shows an example of a diagram illustrating a highest occupied molecular orbital (HOMO) energy level of first hole-transporting compound (HOMO(HT1)), a HOMO energy level of a first compound (HOMO(ET)), a HOMO energy level of a second hole-transporting compound (HOMO(HT2)), a HOMO energy level of a second compound (HOMO(BP)), and a HOMO energy level of a dopant (HOMO(D)).

The "HOMO energy level" illustrated in FIG. 1 is a found value obtained by measuring by using a photoelectron spectroscopy in air, and is a negative value.

The HOMO energy level of the first hole-transporting compound (HOMO(HT1)) may be smaller than the HOMO energy level of the second hole-transporting compound (HOMO(HT2)).

The minimum value from among the HOMO energy level of the first hole-transporting compound (HOMO(HT1)) and the HOMO energy level of the second hole-transporting compound (HOMO(HT2)) may be about -5.80 eV or more.

For example, the minimum value from among the HOMO energy level of the first hole-transporting compound (HOMO (HT1)) and the HOMO energy level of the second hole-transporting compound (HOMO (HT2)) may be about -5.80 eV or more, from about -5.80 eV to about -5.30 eV, from about -5.80 eV to about -5.40 eV, from about -5.70 eV to about -5.20 eV, from about -5.65 eV to about -5.20 eV, from about - 5.70 eV to about -5.30 eV, from about -5.70 eV to about -5.40 eV, or from about -5.65 eV to about -5.45 eV.

In one or more embodiments, the HOMO energy level of the first hole-transporting compound (HOMO(HT1)) and the HOMO energy level of the second hole-transporting compound (HOMO(HT2)) may each be about -5.80 eV or more.

For example, the HOMO energy level of the first hole-transporting compound (HOMO(HT1)) and the HOMO energy level of the second hole-transporting compound (HOMO(HT2)) may each be about -5.80 eV or more, from about -5.80 eV to about - 5.30 eV, from about -5.80 eV to about -5.40 eV, from about -5.70 eV to about -5.20 eV, from about -5.65 eV to about -5.20 eV, from about -5.70 eV to about -5.30 eV, from about -5.70 eV to about -5.40 eV, or from about -5.65 eV to about -5.45 eV.

The HOMO energy level of the first compound (HOMO(ET)) may be smaller than the HOMO energy level of the second compound (HOMO(BP)).

For example, the HOMO energy level of the first compound (HOMO(ET)) and the HOMO energy level of the second compound (HOMO(BP)) may be about -6.15 eV or more, or about -6.08 eV or more, respectively.

In one or more embodiments, the HOMO energy level of the second compound (HOMO(BP)) may be about -6.00 eV or more, about -5.90 eV or more, or about -5.80 eV or more.

The absolute value of the difference (ΔHOMO2) between the HOMO energy level of the second hole-transporting compound (HOMO(HT2)) and the HOMO energy level of the second compound (HOMO(BP)) may be about 0.30 eV or less, about 0.20 eV or less, about 0.16 eV or less, from about 0.001 eV to about 0.30 eV, from about 0.001 eV to about 0.20 eV, from about 0.001 eV to about 0.16 eV, from about 0.01 eV to about 0.20 eV, from about 0.01 eV to about 0.16 eV, from about 0.02 eV to about 0.16 eV, from about 0.03 eV to about 0.16 eV, from about 0.04 eV to about 0.16 eV, from about 0.05 eV to about 0.16 eV, from about 0.06 eV to about 0.16 eV, from about 0.07 eV to about 0.16 eV, from about 0.08 eV to about 0.16 eV, or from about 0.09 eV to about 0.16 eV.

The maximum value from among the HOMO energy level of the first hole-transporting compound (HOMO(HT1)), the HOMO energy level of the first compound (HOMO(ET)), the HOMO energy level of the second hole-transporting compound (HOMO(HT2)), and the HOMO energy level of the second compound (HOMO(BP)) may be smaller than the HOMO energy level of the dopant (HOMO(D)).

For example, the HOMO energy level of the dopant (HOMO(D)) may be from about -5.60 eV to about -5.20eV, for ex ample, about -5.50 eV to about -5.25eV.

In one or more embodiments, the first hole-transporting compound and the second hole-transporting compound may be different from each other, and may satisfy the condition of, as illustrated in FIG. 1, HOMO(D) > HOMO(HT2) > HOMO(HT1) > HOMO(BP) > HOMO (ET).

In the light-emitting device including the emission layer including the first emission layer and the second emission layer as described above, hole mobility in the second emission layer is improved, the electrical resistance of the emission layer is lowered when the light-emitting device is driven, and the exciton distribution into the second emission layer may be enlarged. Accordingly, the light-emitting device may have excellent characteristics in terms of driving voltage, luminescence efficiency, roll-off ratio and/or lifespan.

In one or more embodiments, in the second emission layer, the weight of the second compound may be the

same as the weight of the second hole-transporting compound. In one or more embodiments, in the second emission layer, the weight of the second compound in the second emission layer may be greater than the weight of the second hole-transporting compound. In one or more embodiments, in the second emission layer, the weight of the second compound in the second emission layer may be less than the weight of the second hole-transporting compound. In one or more embodiments, in the second emission layer, the weight ratio of the second hole-transporting compound to the second compound may be from 2:8 to 8:2, for example, 3:7 to 7:3, or 4:6 to 6:4, or 5:5.

In one or more embodiments, the thickness of the second emission layer may be the same as the thickness of the first emission layer.

In one or more embodiments, the thickness of the second emission layer may be greater than the thickness of the first emission layer.

In one or more embodiments, the light emitted from the emission layer to the outside through at least one of the first electrode and the second electrode may not be white light.

In one or more embodiments, the light emitted from the emission layer to the outside through at least one of the first electrode and the second electrode may be green light having a maximum emission wavelength of about 500 nm to about 580 nm.

In one or more embodiments, the light-emitting device may further include a hole-transporting region located between the first electrode and the emission layer, and the hole-transporting region may not include a charge-generation layer or an emission layer. The hole-transporting region may include a hole injection layer, a hole-transporting layer, an electron-blocking layer, a buffer layer, or a combination thereof.

In one or more embodiments, the light-emitting device may further include an electron-transporting region located between the emission layer and the second electrode, and the electron-transporting region may not include a charge-generation layer and an emission layer. The electron-transporting region may include a hole-blocking layer, an electron-transporting layer, an electron injection layer, or any combination thereof.

In one or more embodiments, the emission layer may not include compounds of Group A:

Group A

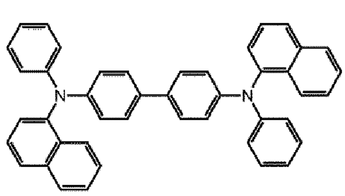
NPB

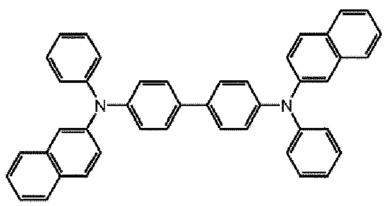
β-NPB

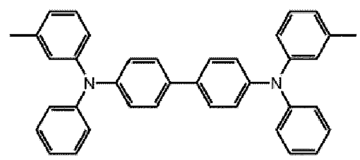
TPD

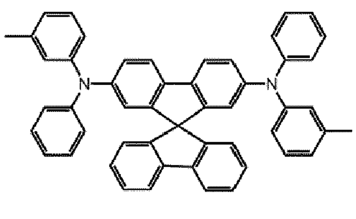
Spiro-TPD

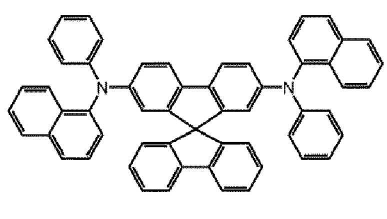
Spiro-NPB

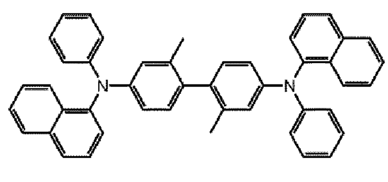
methylated NPB

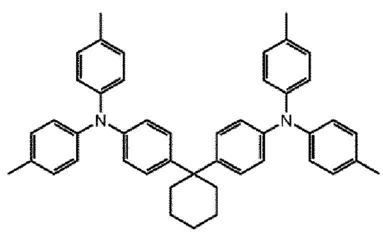
TAPC

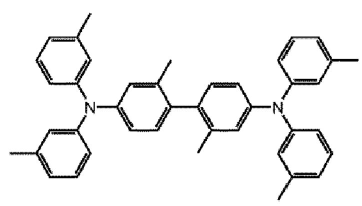
HMTPD

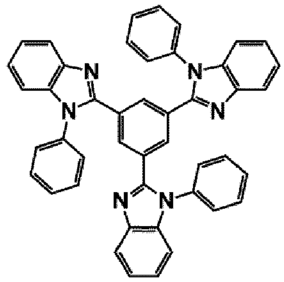

TPBi

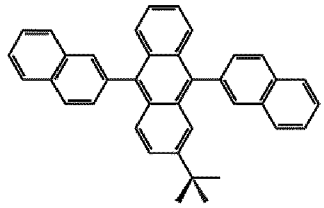

TBADN

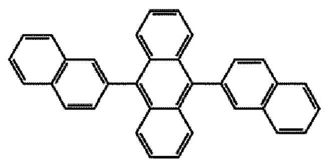

ADN

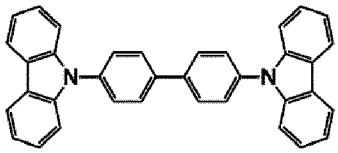

CBP

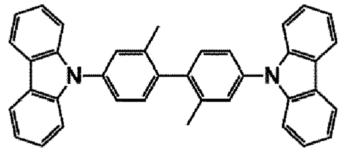

CDBP

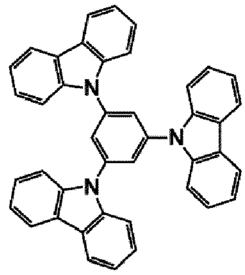

TCP

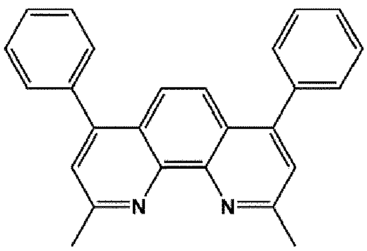

BCP

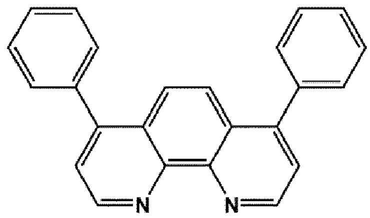

Bphen

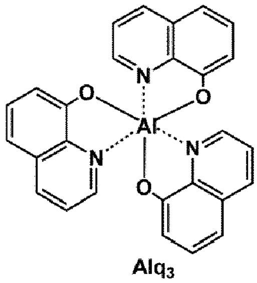

$Alq_3$

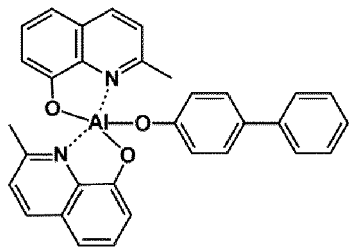

BAlq

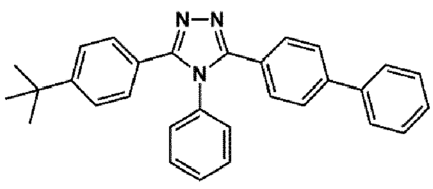

TAZ

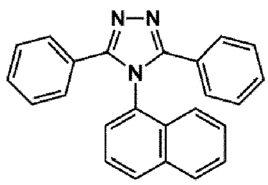

NTAZ

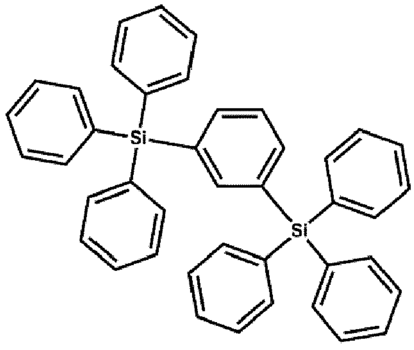

m-bis-(triphenylsilyl)benzene

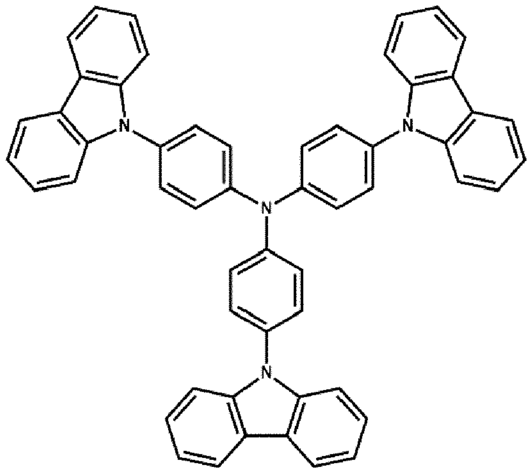

TCTA(4,4',4"-tris(carbazol-9-yl)triphenylamine)

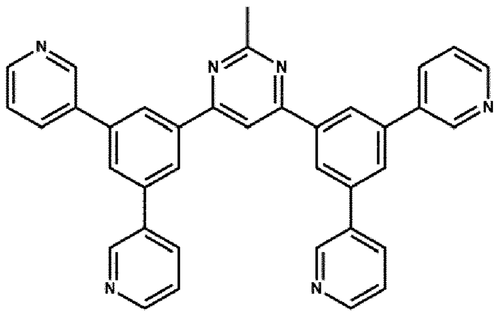

B3PYMPM(4,6-bis(3,5-di(pyridine-3-yl)phenyl)-2-methylpyrimidine)

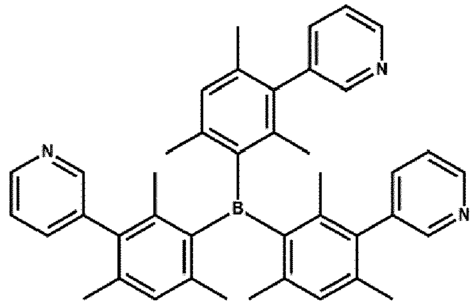

3TPYMB(tris(2,4,6-trimethyl-3-(pyridine-3-yl)phenyl)borane)

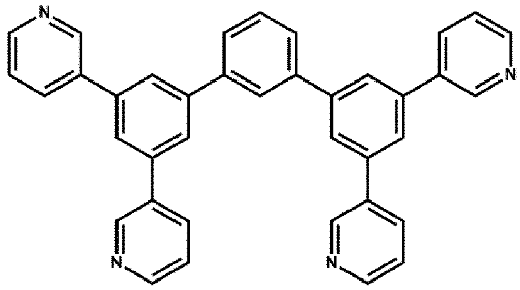

BmPyPhB(1,3-bis[3,5-di(pyridine-3-yl)phenyl]benzene)

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

Description of Formula 1

Formula 1 is shown below.

$$M(L_1)_{n1}(L_2)_{n2}$$

M in Formula 1 may be a transition metal.

For example, M may be a Period 1 transition metal, a Period 2 transition metal, or a Period 3 transition metal of Periodic Table of Elements.

In one or more embodiments, M may be iridium (Ir), platinum (Pt), osmium (Os), titanium (Ti), zirconium (Zr), hafnium (Hf), europium (Eu), terbium (Tb), thulium (Tm)), or rhodium (Rh).

In one or more embodiments, M may be Ir, Pt, Os, or Rh.

In Formula 1, $L_1$ may be a ligand represented by Formula 2A, and $L_2$ may be a ligand represented by Formula 2B:

<Formula 2A>

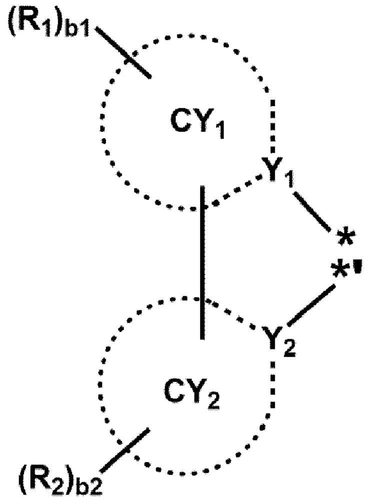

<Formula 2B>

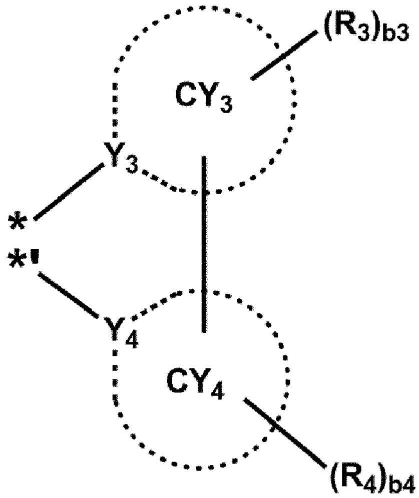

Formulae 2A and 2B are the same as described in the present specification.

n1 in Formula 1 may be 1, 2, or 3, wherein, when n1 is 2 or more, two or more of $L_1$(s) may be identical to or different from each other.

n2 in Formula 1 may be 0, 1, or 2, wherein, when n2 is 2, two $L_2$(s) may be identical to or different from each other.

The sum of n1 and n2 in Formula 1 may be 2 or 3. For example, the sum of the n1 and n2 may be 3.

In one or more embodiments, in Formula 1, i) M may be Ir, and the sum of n1 and n2 may be 3; or ii) M may be Pt, and the sum of n1 and n2 may be 2.

In one or more embodiments, in Formula 1, M may be Ir, and i) n1 may be 1 and n2 may be 2, or ii) n1 may be 2 and n2 may be 1.

$L_1$ and $L_2$ in Formula 1 may be different from each other.

$Y_1$ to $Y_4$ in Formulae 2A to 2B may be each independently be C or N. For example, $Y_1$ and $Y_3$ may each be N, and $Y_2$ and $Y_4$ may each be C.

Ring $CY_1$ to ring $CY_4$ in Formulae 2A and 2B may each independently be a $C_5$-$C_{30}$ carbocyclic group or a $C_1$-$C_{30}$ heterocyclic group.

For example, ring $CY_1$ to ring $CY_4$ may each independently be, i) a third ring, ii) a fourth ring, iii) a condensed ring in which two or more third rings are condensed with each other, iv) a condensed ring in which two or more fourth rings are condensed with each other, or v) a condensed ring in which one or more third rings and one or more fourth rings are condensed with each other,

the third ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and

the fourth ring may be an adamantane group, a norbornane group, a norbornene group, a cyclohexane group, a cyclohexene group, a benzene group, a pyridine group, a pyrimidine group, a pyrazine group, a pyridazine group, or a triazine group.

In one or more embodiments, ring $CY_1$ to ring $CY_4$ may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthrobenzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isooxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group, a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a 5,6,7,8-tetrahydroisoquinoline group, a 5,6,7,8-tetrahydroquinoline group, an adamantane group, a norbornane group, a norbornene group, a benzene group condensed with a cyclohexane group, a benzene group condensed with a norbornane group, a pyridine group condensed with a cyclohexane group, or a pyridine group condensed with a norbornane group.

In one or more embodiments, ring $CY_1$ may be an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthroa benzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a pyrrole group, a pyrazole group, an imidazole group, a triazole group, an oxazole group, an isooxazole group, a thiazole group, an isothiazole group, an oxadiazole group, a thiadiazole group, an azasilole group, an azaborole group, an azaphosphole group, an azagermole group, an azaselenophene group, a benzopyrrole group, a benzopyrazole group, a benzimidazole group, a benzoxazole group, a benzisoxazole group, a benzothiazole group, a benzisothiazole group, a benzoxadiazole group,

a benzothiadiazole group, a pyridinopyrrole group, a pyridinopyrazole group, a pyridinoimidazole group, a pyridinooxazole group, a pyridinoisoxazole group, a pyridinothiazole group, a pyridinoisothiazole group, a pyridinooxadiazole group, a pyridinothiadiazole group, a pyrimidinopyrrole group, a pyrimidinopyrazole group, a pyrimidinoimidazole group, a pyrimidinooxazole group, a pyrimidinoisoxazole group, a pyrimidinothiazole group, a pyrimidinoisothiazole group, a pyrimidinooxadiazole group, a pyrimidinothiadiazole group, a 5,6,7,8-tetrahydroisoquinoline group, a 5,6,7,8-tetrahydroquinoline group, a pyridine group condensed with a cyclohexane group, or a pyridine group condensed with a norbornane group.

In one or more embodiments, ring $CY_2$ and $CY_4$ may each independently be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a pyrrole group, a furan group, a thiophene group, a silole group, a borole group, a phosphole group, a germole group, a selenophene group, an indene group, an indole group, a benzofuran group, a benzothiophene group, a benzosilole group, a benzoborole group, a benzophosphole group, a benzogermole group, a benzoselenophene group, a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthro benzothiophene group, a phenanthrobenzosilole group, a phenanthrobenzoborole group, a phenanthrobenzophosphole group, a phenanthrobenzogermole group, a phenanthrobenzoselenophene group, a dibenzothiophene 5-oxide group, a 9H-fluorene-9-one group, a dibenzothiophene 5,5-dioxide group, an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthroa benzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, an adamantane group, a norbornane group, a norbornene group, a benzene group condensed with a cyclohexane group, or a benzene group condensed with a norbornane group.

In one or more embodiments, ring $CY_3$ may be an azaindene group, an azaindole group, an azabenzofuran group, an azabenzothiophene group, an azabenzosilole group, an azabenzoborole group, an azabenzophosphole group, an azabenzogermole group, an azabenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthroa benzothiophene group, an azaphenanthrobenzosilole group, an azaphenanthrobenzoborole group, an azaphenanthrobenzophosphole group, an azaphenanthrobenzogermole group, an azaphenanthrobenzoselenophene group, an azadibenzothiophene 5-oxide group, an aza9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a benzoquinoline group, a benzoisoquinoline group, a benzoquinoxaline group, a benzoquinazoline group, a phenanthroline group, a phenanthridine group, a 5,6,7,8-tetrahydroquinoline group, a pyridine group condensed with a cyclohexane group, or a pyridine group condensed with a norbornane group.

In one or more embodiments, ring $CY_1$ of Formula 2A may be a pyridine group, a benzimidazole group, a

pyridinoimidazole group, or a pyrimidinoimidazole group.

In one or more embodiments, ring $CY_2$ in Formula 2A may be a fluorene group, a carbazole group, a dibenzofuran group, a dibenzothiophene group, a dibenzosilole group, a dibenzoborole group, a dibenzophosphole group, a dibenzogermole group, a dibenzoselenophene group, a benzofluorene group, a benzocarbazole group, a naphthobenzofuran group, a naphthobenzothiophene group, a naphthobenzosilole group, a naphthobenzoborole group, a naphthobenzophosphole group, a naphthobenzogermole group, a naphthobenzoselenophene group, a dibenzofluorene group, a dibenzocarbazole group, a dinaphthofuran group, a dinaphthothiophene group, a dinaphthosilole group, a dinaphthoborole group, a dinaphthophosphole group, a dinaphthogermole group, a dinaphthoselenophene group, an indenophenanthrene group, an indolophenanthrene group, a phenanthrobenzofuran group, a phenanthrobenzothiophene group, a phenanthrobenzosilole group, a phenanthrobenzoborole group, a phenanthrobenzophosphole group, a phenanthrobenzogermole group, a phenanthrobenzoselenophene group, an azafluorene group, an azacarbazole group, an azadibenzofuran group, an azadibenzothiophene group, an azadibenzosilole group, an azadibenzoborole group, an azadibenzophosphole group, an azadibenzogermole group, an azadibenzoselenophene group, an azabenzofluorene group, an azabenzocarbazole group, an azanaphthobenzofuran group, an azanaphthobenzothiophene group, an azanaphthobenzosilole group, an azanaphthobenzoborole group, an azanaphthobenzophosphole group, an azanaphthobenzogermole group, an azanaphthobenzoselenophene group, an azadibenzofluorene group, an azadibenzocarbazole group, an azadinaphthofuran group, an azadinaphthothiophene group, an azadinaphthosilole group, an azadinaphthoborole group, an azadinaphthophosphole group, an azadinaphthogermole group, an azadinaphthoselenophene group, an azaindenophenanthrene group, an azaindolophenanthrene group, an azaphenanthrobenzofuran group, an azaphenanthroa benzothiophene group, an azaphenanthrobenzosilole group, an azaphenanthrobenzoborole group, an azaphenanthrobenzophosphole group, an azaphenanthrobenzogermole group, or an azaphenanthrobenzoselenophene group.

In one or more embodiments, ring $CY_3$ of Formula 2B may be a pyridine group, a pyrimidine group, a pyrazine group, a pyridazine group, a triazine group, a 5,6,7,8-tetrahydroquinoline group, a pyridine group condensed with a cyclohexane group, or a pyridine group condensed with a norbornane group.

In one or more embodiments, ring $CY_4$ of Formula 2B may be a benzene group, a naphthalene group, an anthracene group, a phenanthrene group, a triphenylene group, a pyrene group, a chrysene group, a 1,2,3,4-tetrahydronaphthalene group, a benzene group condensed with a cyclohexane group, or a benzene group condensed with a norbornane group.

For example, ring $CY_1$ and ring $CY_3$ in Formulae 2A and 2B may be different from each other.

In one or more embodiments, ring $CY_2$ and ring $CY_4$ in Formulae 2A and 2B may be different from each other.

In one or more embodiments, ring $CY_1$ to ring $CY_4$ may be different from each other.

$R_1$ to $R_4$ in Formulae 2A and 2B may each independently be hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted C1-$C_{10}$heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or - $P(Q_8)(Q_9)$. $Q_1$ to $Q_9$ are the same as described in the present specification.

In one or more embodiments, $R_1$ to $R_4$ in Formulae 2A and 2B may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a C1-$C_{20}$ alkyl group, a $C_1$-$C_{20}$ alkoxy group, or a $C_1$-$C_{20}$ alkylthio group;

a $C_1$-$C_{20}$ alkyl group, a $C_1$-$C_{20}$ alkoxy group, or a $C_1$-$C_{20}$ alkylthio group, each substituted with deuterium, -F, -Cl, -Br, -I, $-CD_3$, $-CD_2H$, $-CDH_2$, $-CF_3$, - $CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cy-

clohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a pyridinyl group, a pyrimidinyl group, or any combination thereof; a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a ($C_1$-$C_{20}$ alkyl)a phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a (phenyl)$C_1$-$C_{10}$ alkyl group, a $C_1$-$C_{20}$ alkoxy group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.2]octyl group, a phenyl group, a ($C_1$-$C_{20}$ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or

$-N(Q_1)(Q_2)$, $-Si(Q_3)(Q_4)(Q_5)$, $-Ge(Q_3)(Q_4)(Q_5)$, $-B(Q_6)(Q_7)$, - $P(=O)(Q_8)(Q_9)$ or $-P(Q_8)(Q_9)$,

wherein $Q_1$ to $Q_9$ are each independently:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or - $CD_2CDH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or any combination thereof.

In one or more embodiments, $R_1$ to $R_4$ may each independently be:

hydrogen, deuterium, -F, or a cyano group;

a $C_1$-$C_{20}$ alkyl group unsubstituted or substituted with deuterium, a cyano group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a $C_1$-$C_{10}$ heterocycloalkyl group, a deuterated $C_1$-$C_{10}$ heterocycloalkyl group, a fluorinated $C_1$-$C_{10}$ heterocycloalkyl group, a ($C_1$-$C_{20}$ alkyl)$C_1$-$C_{10}$ heterocycloalkyl group, a phenyl group, a deuterated a phenyl group, a fluorinated a phenyl group, a ($C_1$-$C_{20}$ alkyl)phenyl group, a biphenyl group, a deuterated a biphenyl group, a fluorinated a biphenyl group, a ($C_1$-$C_{20}$ alkyl)biphenyl group, a dibenzofuranyl group, a deuterated a dibenzofuranyl group, a fluorinated a dibenzofuranyl group, a ($C_1$-$C_{20}$ alkyl)dibenzofuranyl group, a dibenzothiophenyl group, a deuterated a dibenzothiophenyl group, a fluorinated a dibenzothiophenyl group, a ($C_1$-$C_{20}$ alkyl)dibenzothiophenyl group, or any combi-

nation thereof;

a $C_3$-$C_{10}$ cycloalkyl group, a $C_1$-$C_{10}$ heterocycloalkyl group, a phenyl group, or a biphenyl group, each unsubstituted or substituted with deuterium, a cyano group, a $C_1$-$C_{20}$ alkyl group, a deuterated $C_1$-$C_{20}$ alkyl group, fluorinated $C_1$-$C_{20}$ alkyl group, a $C_1$-$C_{20}$ alkoxy group, a deuterated $C_1$-$C_{20}$ alkoxy group, a fluorinated $C_1$-$C_{20}$ alkoxy group, a $C_3$-$C_{10}$ cycloalkyl group, a deuterated $C_3$-$C_{10}$ cycloalkyl group, a fluorinated $C_3$-$C_{10}$ cycloalkyl group, a ($C_1$-$C_{20}$ alkyl)$C_3$-$C_{10}$ cycloalkyl group, a $C_1$-$C_{10}$ heterocycloalkyl group, a deuterated $C_1$-$C_{10}$ heterocycloalkyl group, a fluorinated $C_1$-$C_{10}$ heterocycloalkyl group, a ($C_1$-$C_{20}$ alkyl)$C_1$-$C_{10}$ heterocycloalkyl group, a phenyl group, a deuterated phenyl group, a fluorinated a phenyl group, a ($C_1$-$C_{20}$ alkyl)phenyl group, a biphenyl group, a deuterated biphenyl group, a fluorinated a biphenyl group, a ($C_1$-$C_{20}$ alkyl)biphenyl group, a dibenzofuranyl group, a deuterated dibenzofuranyl group, a fluorinated a dibenzofuranyl group, a ($C_1$-$C_{20}$ alkyl)dibenzofuranyl group, a dibenzothiophenyl group, a deuterated dibenzothiophenyl group, a fluorinated a dibenzothiophenyl group, a ($C_1$-$C_{20}$ alkyl)dibenzothiophenyl group, or any combination thereof; or

$$-Si(Q_3)(Q_4)(Q_5) \text{ or } -Ge(Q_3)(Q_4)(Q_5).$$

b1 to b4 in Formula 2A and 2B indicate the numbers of $R_1$ to $R_4$, respectively, and may each independently be an integer from 0 to 20. When b1 is 2 or more, two or more of $R_1$(s) may be identical to or different from each other, when b2 is 2 or more, two or more of $R_2$(s) may be identical to or different from each other, when b3 is 2 or more, two or more of $R_3$(s) may be identical to or different from each other, and when b4 is 2 or more, two or more of $R_4$(s) may be identical to or different from each other. For example, b1 to b4 may each independently be an integer from 0 to 8.

In one or more embodiments, n2 in Formula 1 may not be 0, b3 of Formula 2B may not be 0, and at least one of $R_3$(s) in the number of b3 may be $-Si(Q_3)(Q_4)(Q_5)$ or $-Ge(Q_3)(Q_4)(Q_5)$. $Q_3$ to $Q_5$ are the same as described in the present specification.

For example, $Q_3$ to $Q_5$ may each independently be:

a $C_1$-$C_{60}$ alkyl group unsubstituted or substituted with deuterium, a C1-$C_{60}$ alkyl group, a $C_6$-$C_{60}$ aryl group, or any combination thereof; or

a $C_6$-$C_{60}$ aryl group unsubstituted or substituted with deuterium, a C1-$C_{60}$ alkyl group, a $C_6$-$C_{60}$ aryl group, or any combination thereof.

In one or more embodiments, $Q_3$ to $Q_5$ may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or - $CD_2CDH_2$; or

an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or any combination thereof.

In one or more embodiments, $Q_3$ to $Q_5$ may be identical to each other.

In one or more embodiments, two or more of $Q_3$ to $Q_5$ may be different from each other.

In one or more embodiments, the organometallic compound represented by Formula 1 may include at least one deuterium.

In one or more embodiments, the organometallic compound represented by Formula 1 may satisfy at least one of Condition (1) to Condition (8):

Condition (1) b1 in Formula 2A is not 0, and at least one of $R_1$(s) in the number of b1 includes deuterium.
Condition (2) b2 in Formula 2A is not 0, and at least one of $R_2$(s) in the number of b2 includes deuterium.
Condition (3) b3 in Formula 2B is not 0, and at least one of $R_3$(s) in the number of b3 includes deuterium.
Condition (4) b4 in Formula 2B is not 0, and at least one of $R_4$(s) in the number of b4 includes deuterium.
Condition (5) b1 in Formula 2A is not 0, and at least one of $R_1$(s) in the number of b1 includes a fluoro group.
Condition (6) b2 in Formula 2A is not 0, and at least one of $R_2$(s) in the number of b2 includes a fluoro group.
Condition (7) b3 in Formula 2B is not 0, and at least one of $R_3$(s) in the number of b3 includes a fluoro group.
Condition (8) b4 in Formula 2B is not 0, and at least one of $R_4$(s) in the number of b4 includes a fluoro group

In one or more embodiments, $R_1$ to $R_4$ in Formulae 2A and 2B may each independently be hydrogen, deuterium,

-F, a cyano group, a nitro group, $-SF_5$, $-CH_3$, - $CD_3$, $-CD_2H$, $-CDH_2$, $-CF_3$, $-CF_2H$, $-CFH_2$, $-OCH_3$, $-OCDH_2$, $-OCD_2H$, $-OCD_3$, $-SCH_3$, - $SCDH_2$, $-SCD_2H$, $-SCD_3$, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-230, a group represented by one of Formulae 9-201 to 9-230 in which at least one hydrogen is substituted with deuterium, a group represented by one of Formulae 9-201 to 9-230 in which at least one hydrogen is substituted with -F, a group represented by one of Formulae 10-1 to 10-145, a group represented by one of Formulae 10-1 to 10-145 in which at least one hydrogen is substituted with deuterium, a group represented by one of Formulae 10-1 to 10-145 in which at least one hydrogen is substituted with -F, a group represented by one of Formulae 10-201 to 10-354, a group represented by one of Formulae 10-201 to 10-354 in which at least one hydrogen is substituted with deuterium, a group represented by one of Formulae 10-201 to 10-354 in which at least one hydrogen is substituted with -F, $-Si(Q_3)(Q_4)(Q_5)$ or $-Ge(Q_3)(Q_4)(Q_5)$(where $Q_3$ to $Q_5$ are the same as described in the present specification):

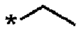
9-1
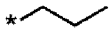
9-2
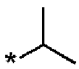
9-3
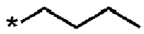
9-4
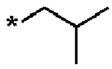
9-5
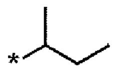
9-6
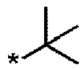
9-7
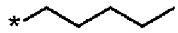
9-8

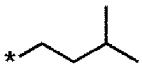
9-9
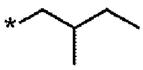
9-10
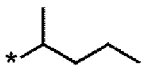
9-11
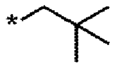
9-12
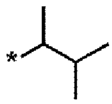
9-13
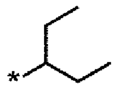
9-14
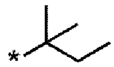
9-15

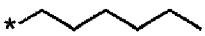
9-16
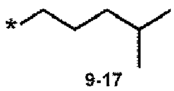
9-17
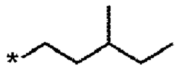
9-18
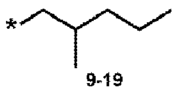
9-19
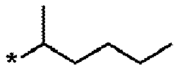
9-20
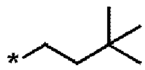
9-21

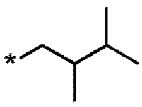
9-22
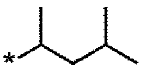
9-23
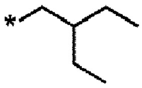
9-24
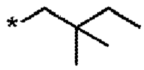
9-25
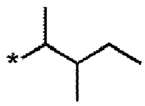
9-26
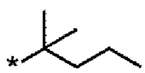
9-27
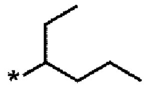
9-28

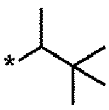
9-29
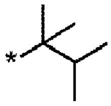
9-30
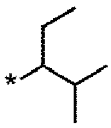
9-31
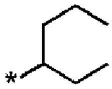
9-32
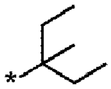
9-33
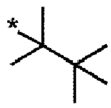
9-34
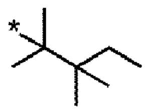
9-35
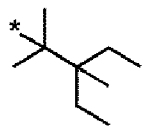
9-36

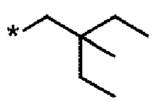
9-37
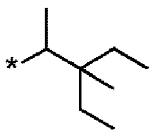
9-38
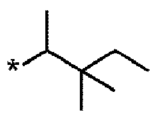
9-39

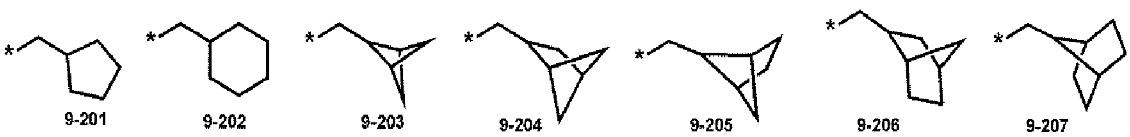
9-201 9-202 9-203 9-204 9-205 9-206 9-207

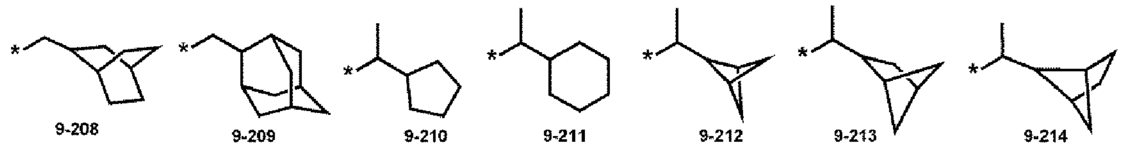

9-208 9-209 9-210 9-211 9-212 9-213 9-214

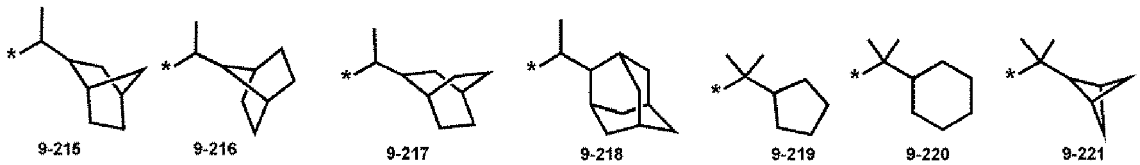

9-215 9-216 9-217 9-218 9-219 9-220 9-221

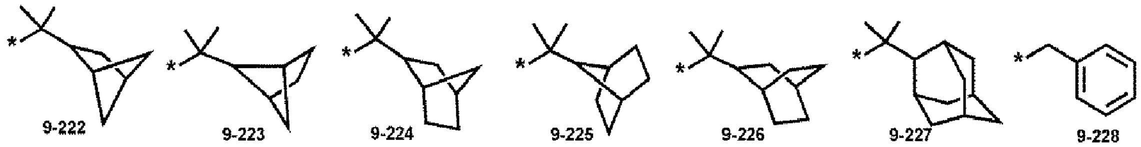

9-222 9-223 9-224 9-225 9-226 9-227 9-228

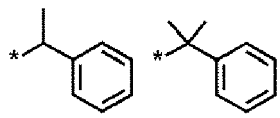

9-229 9-230

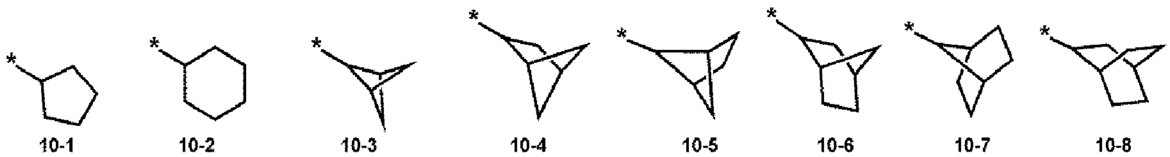

10-1 10-2 10-3 10-4 10-5 10-6 10-7 10-8

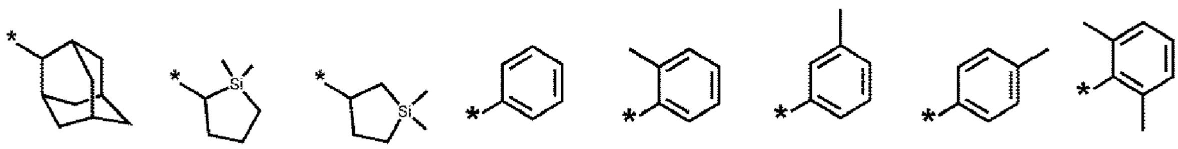

10-9 10-10 10-11 10-12 10-13 10-14 10-15 10-16

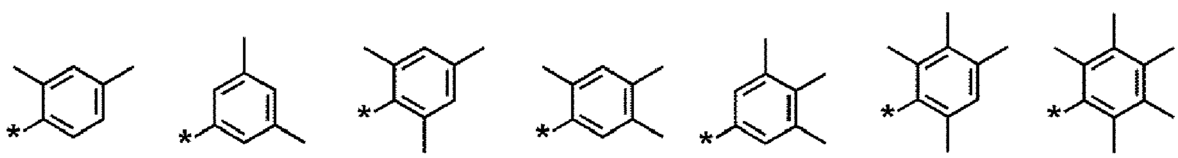

10-17 10-18 10-19 10-20 10-21 10-22 10-23

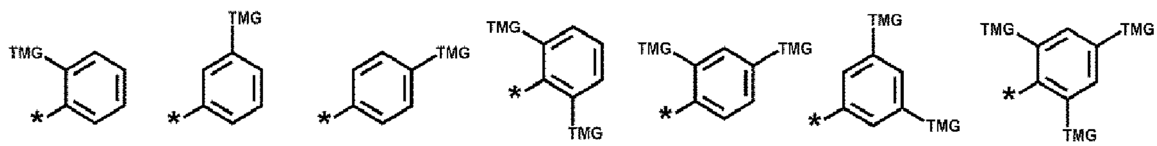

10-24 10-25 10-26 10-27 10-28 10-29 10-30

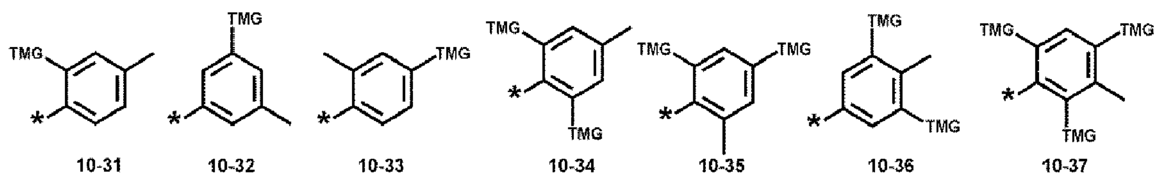

10-31 10-32 10-33 10-34 10-35 10-36 10-37

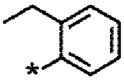

10-38

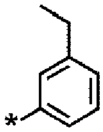

10-39

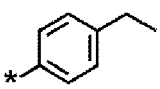

10-40

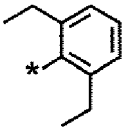

10-41

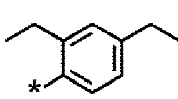

10-42

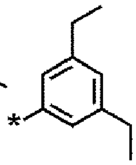

10-43

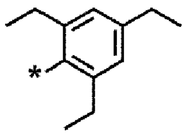

10-44

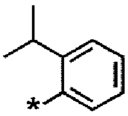

10-45

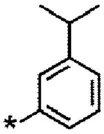

10-46

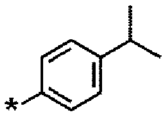

10-47

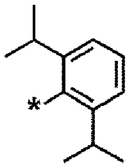

10-48

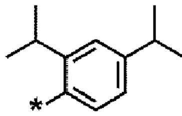

10-49

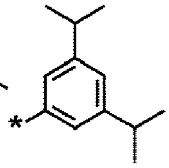

10-50

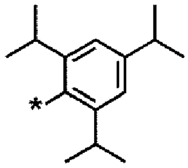

10-51

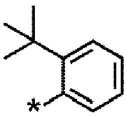

10-52

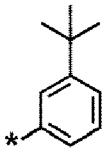

10-53

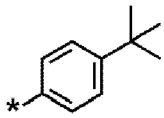

10-54

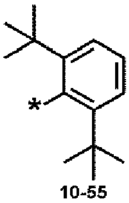

10-55

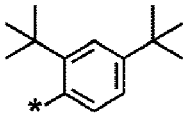

10-56

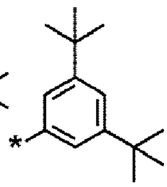

10-57

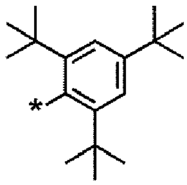

10-58

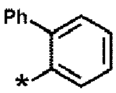

10-59

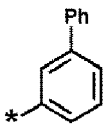

10-60

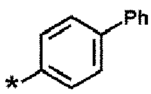

10-61

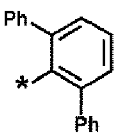

10-62

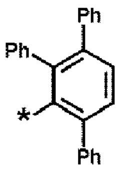

10-63

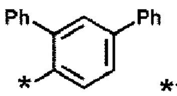

10-64

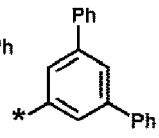

10-65

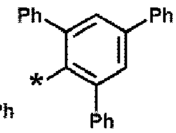

10-66

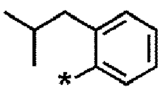

10-67

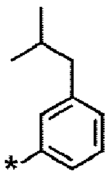

10-68

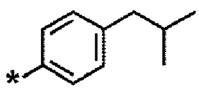

10-69

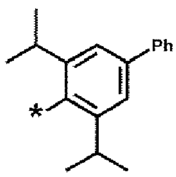

10-70

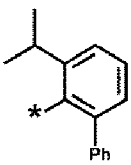

10-71

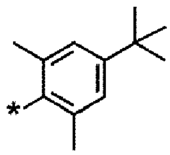

10-72

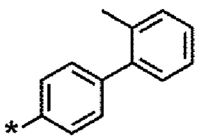

10-73

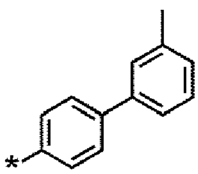

10-74

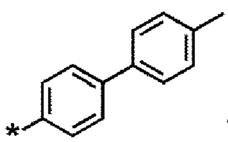

10-75

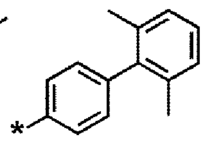

10-76

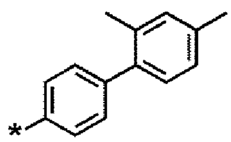

10-77

10-78

10-79

10-80

10-81

10-82

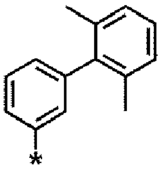
10-83
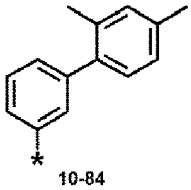
10-84
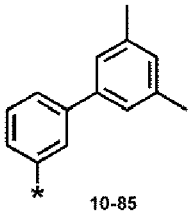
10-85
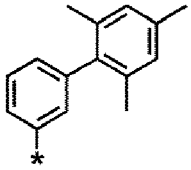
10-86
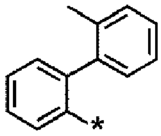
10-87
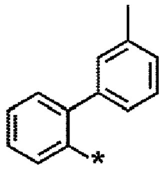
10-88

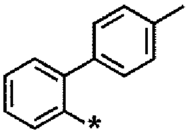
10-89
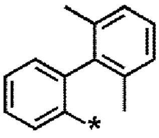
10-90
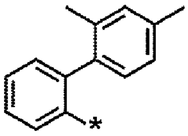
10-91
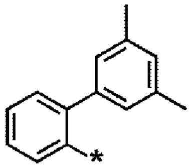
10-92
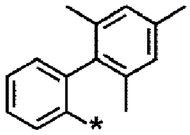
10-93
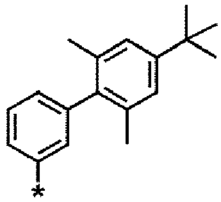
10-94

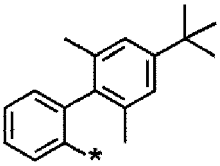
10-95
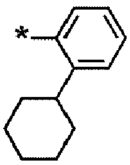
10-96
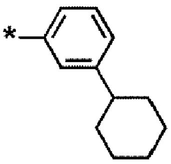
10-97
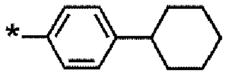
10-98
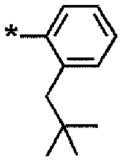
10-99
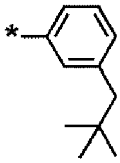
10-100

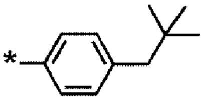
10-101
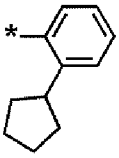
10-102
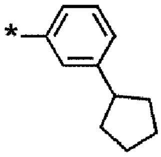
10-103
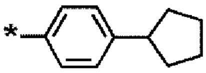
10-104
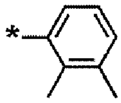
10-105
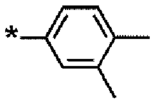
10-106

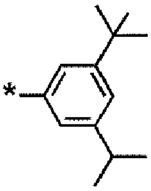
10-107
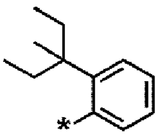
10-108
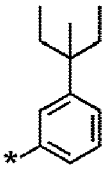
10-109
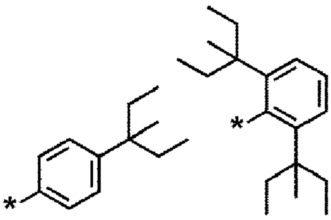
10-110
10-111
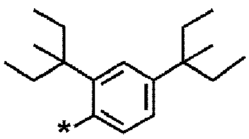
10-112

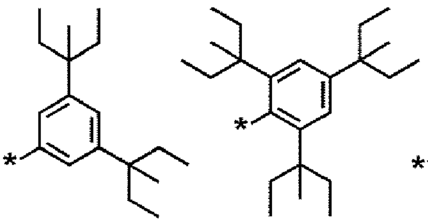
10-113
10-114
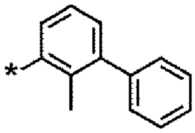
10-115
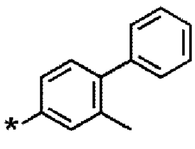
10-116
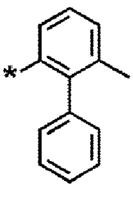
10-117
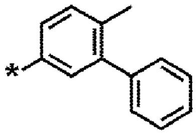
10-118

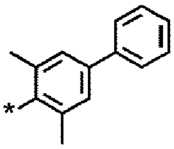
10-119
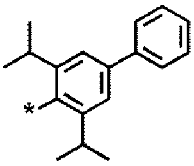
10-120
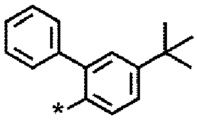
10-121
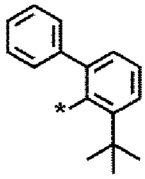
10-122
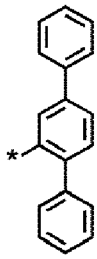
10-123
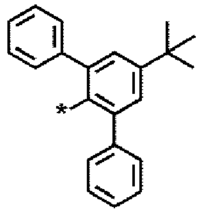
10-124

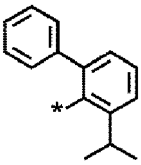
10-125
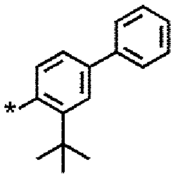
10-126
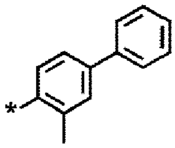
10-127
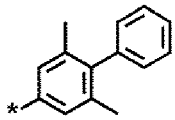
10-128
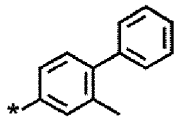
10-129
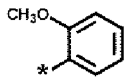
10-130

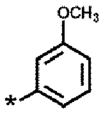
10-131
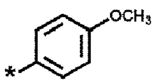
10-132
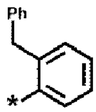
10-133
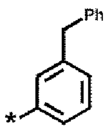
10-134
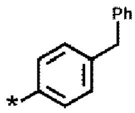
10-135
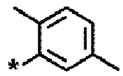
10-136
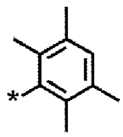
10-137
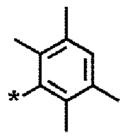
10-138

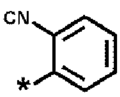
10-139
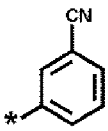
10-140
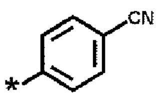
10-141
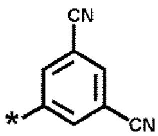
10-142
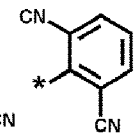
10-143
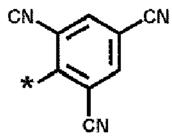
10-144
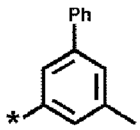
10-145

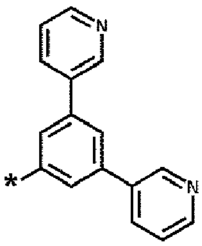
10-201
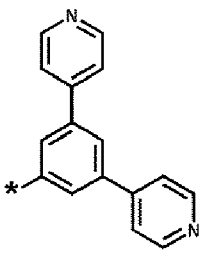
10-202
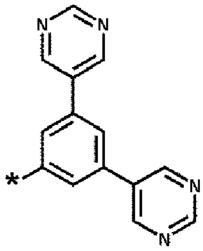
10-203
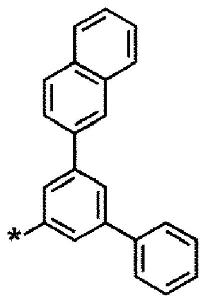
10-204
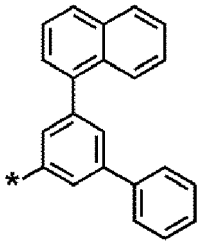
10-205

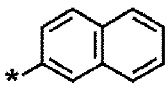
10-206
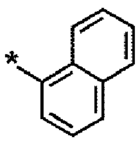
10-207
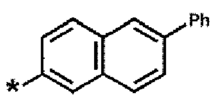
10-208
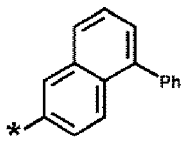
10-209
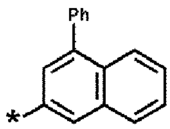
10-210

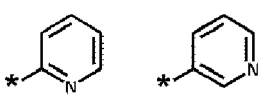
10-211 10-212
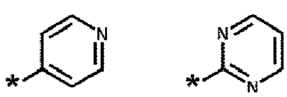
10-213 10-214
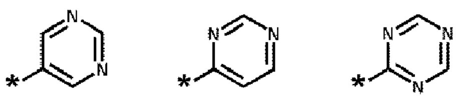
10-215 10-216 10-217

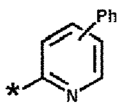
10-218
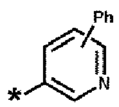
10-219
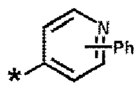
10-220
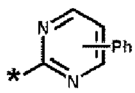
10-221
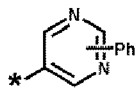
10-222
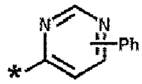
10-223
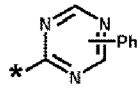
10-224

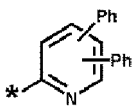
10-225
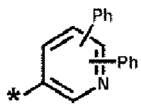
10-226
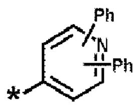
10-227
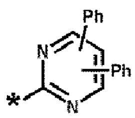
10-228
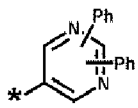
10-229
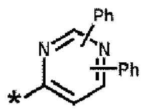
10-230
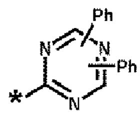
10-231

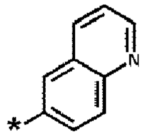
10-232
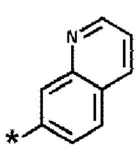
10-233
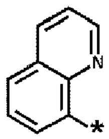
10-234
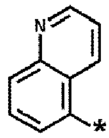
10-235
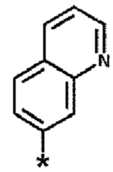
10-236
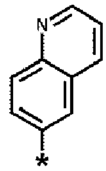
10-237

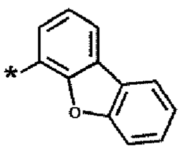
10-238
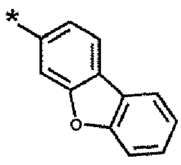
10-239
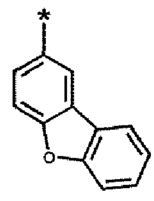
10-240
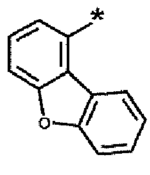
10-241
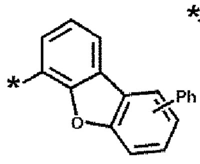
10-242
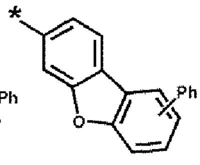
10-243

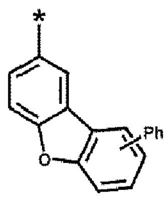
10-244
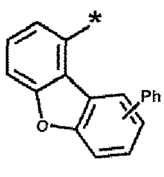
10-245
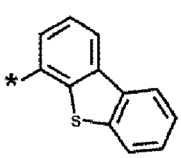
10-246
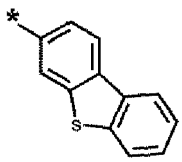
10-247
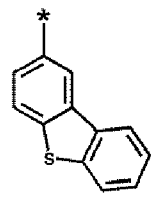
10-248
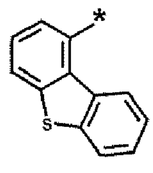
10-249

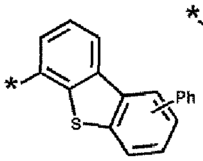
10-250
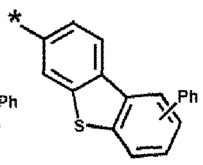
10-251
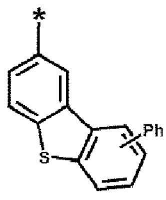
10-252
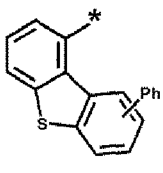
10-253
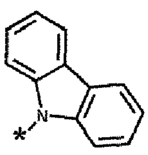
10-254
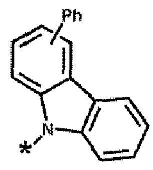
10-255

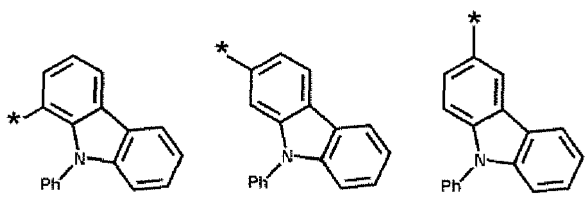
10-256
10-257
10-258
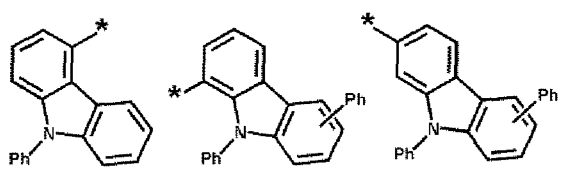
10-259
10-260
10-261

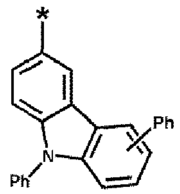
10-262

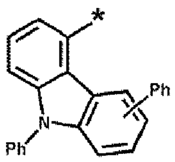
10-263

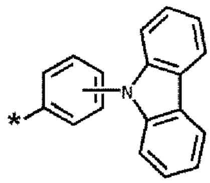
10-264

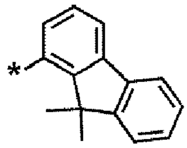
10-265

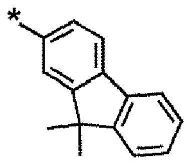
10-266

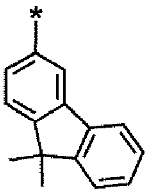
10-267

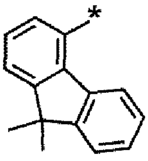
10-268

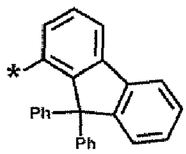
10-269

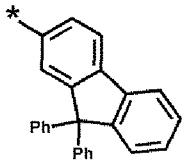
10-270

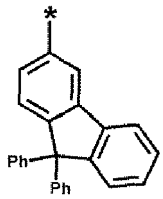
10-271

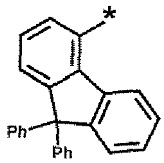
10-272

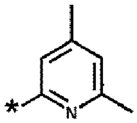
10-273

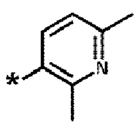
10-274

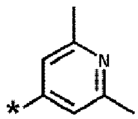
10-275

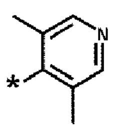
10-276

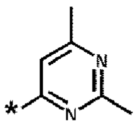
10-277

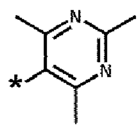
10-278

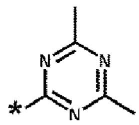
10-279

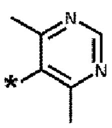
10-280

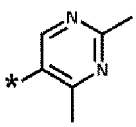
10-281

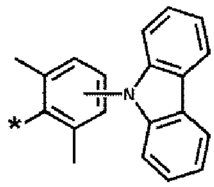
10-282

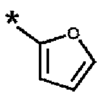
10-283

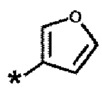
10-284

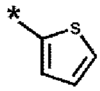
10-285

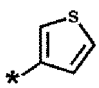
10-286

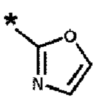
10-287

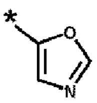
10-288

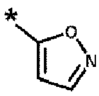
10-289

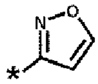
10-290

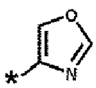
10-291

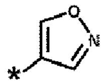
10-292

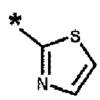
10-293

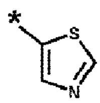
10-294

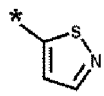
10-295

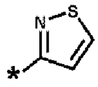
10-296

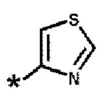
10-297

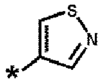
10-298

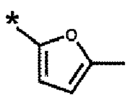
10-299

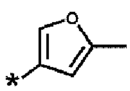
10-300

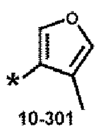
10-301

10-302

10-303

10-304

10-305

10-306

10-307

10-308

10-309

10-310

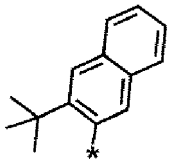 10-311
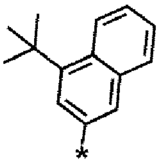 10-312
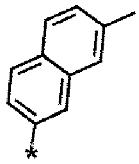 10-313
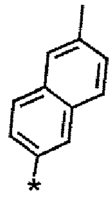 10-314
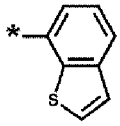 10-315
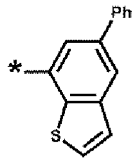 10-316
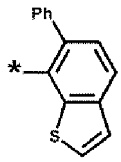 10-317

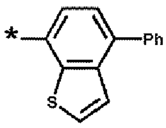 10-318
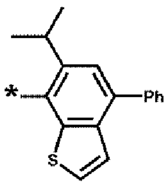 10-319
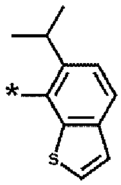 10-320
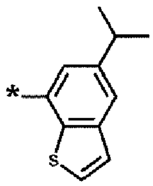 10-321
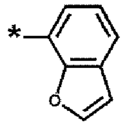 10-322
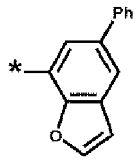 10-323
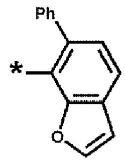 10-324

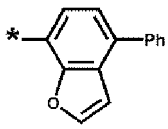 10-325
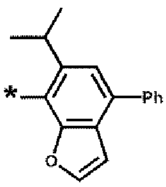 10-326
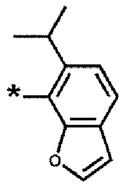 10-327
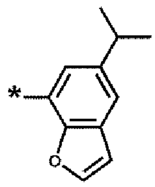 10-328
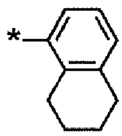 10-329
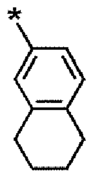 10-330
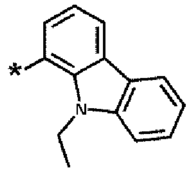 10-331

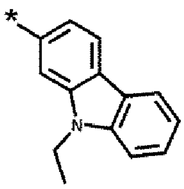 10-332
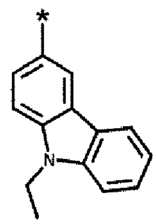 10-333
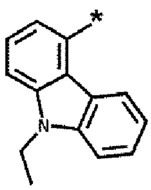 10-334
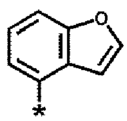 10-335
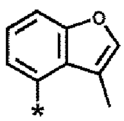 10-336
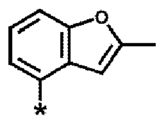 10-337

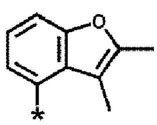 10-338
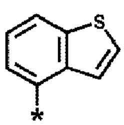 10-339
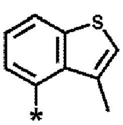 10-340
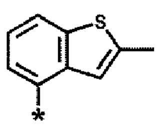 10-341
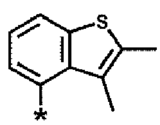 10-342
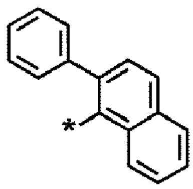 10-343

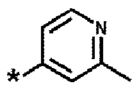 10-344
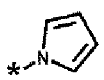 10-345
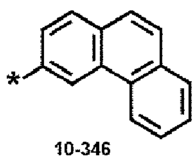 10-346
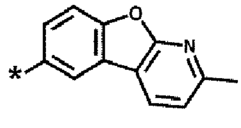 10-347
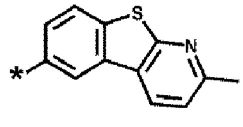 10-348

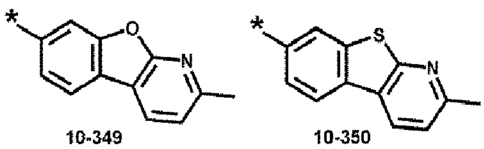
10-349 10-350
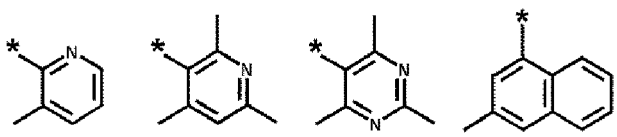
10-351 10-352 10-353 10-354

In Formulae 9-1 to 9-39, 9-201 to 9-230, 10-1 to 10-145 and 10-201 to 10-354, * indicates a binding site to a

neighboring atom, Ph is a phenyl group, TMS is a trimethylsilyl group, TMG is a trimethylgermyl group, and OMe is a methoxy group.

The "group represented by one of Formulae 9-1 to 9-39 in which at least one hydrogen is substituted with deuterium" and the "group represented by one of Formulae 9-201 to 9-230 in which at least one hydrogen is substituted with deuterium" may be, for example, a group represented by one of Formulae 9-501 to 9-514 and 9-601 to 9-637:

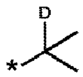
9-501
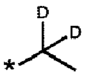
9-502
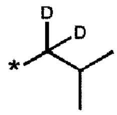
9-503
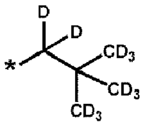
9-504
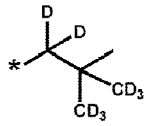
9-505
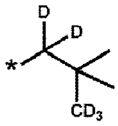
9-506
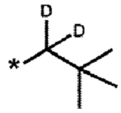
9-507
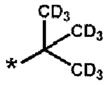
9-508
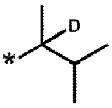
9-509
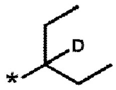
9-510
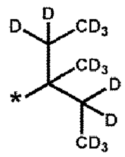
9-511
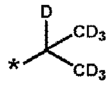
9-512
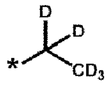
9-513
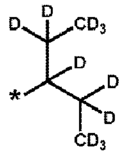
9-514
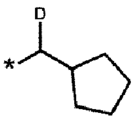
9-601
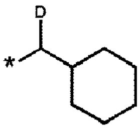
9-602
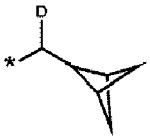
9-603
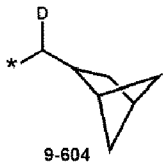
9-604
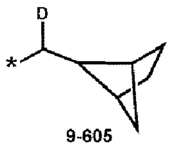
9-605
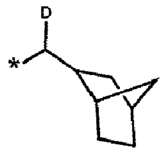
9-606
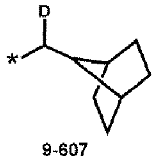
9-607
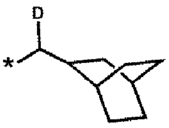
9-608
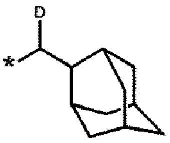
9-609
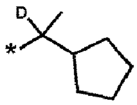
9-610
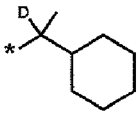
9-611
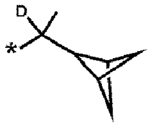
9-612
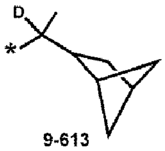
9-613
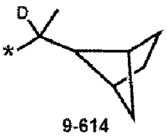
9-614
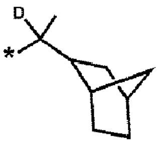
9-615
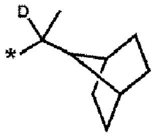
9-616
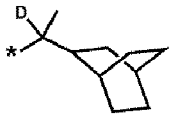
9-617
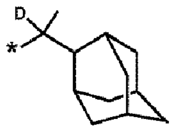
9-618
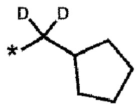
9-619
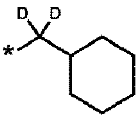
9-620
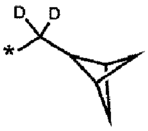
9-621
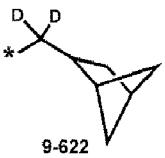
9-622
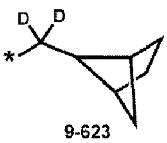
9-623
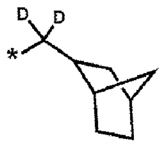
9-624
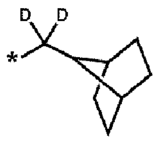
9-625
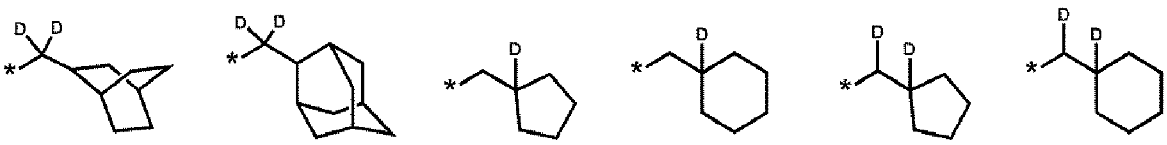
9-626 9-627 9-628 9-629 9-630 9-631

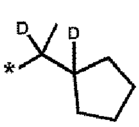 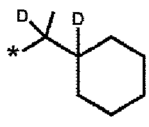 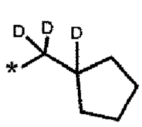 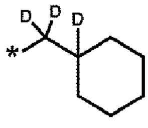 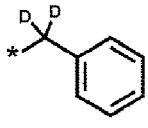 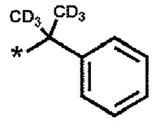

9-632 9-633 9-634 9-635 9-636 9-637

The "group represented by one of Formulae 9-1 to 9-39 in which at least one hydrogen is substituted with -F" and the "group represented by one of Formulae 9-201 to 9-230 in which at least one hydrogen is substituted with -F" may be, for example, a group represented by one of Formulae 9-701 to 9-710:

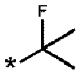 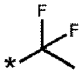 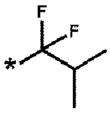 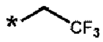 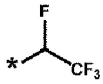 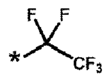 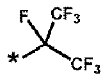

9-701 9-702 9-703 9-704 9-705 9-706 9-707

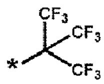 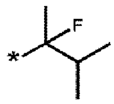 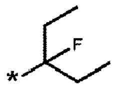

9-708 9-709 9-710

The "group represented by one of Formulae 10-1 to 10-145 in which at least one hydrogen is substituted with deuterium" and the "group represented by one of

Formulae 10-201 to 10-354 in which at least one hydrogen is substituted with deuterium" may be, for example, a group represented by one of Formulae 10-501 to 10-553:

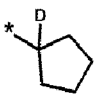 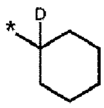 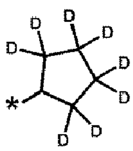 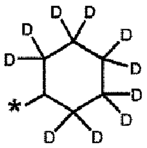 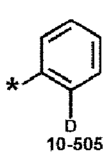 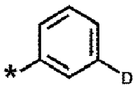 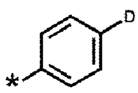 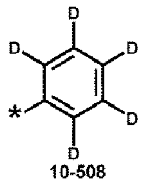

10-501 10-502 10-503 10-504 10-505 10-506 10-507 10-508

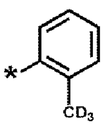 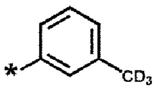 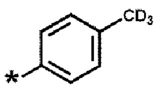 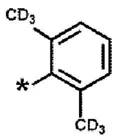 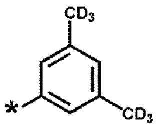 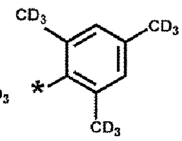 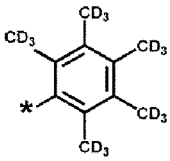

10-509 10-510 10-511 10-512 10-513 10-514 10-515

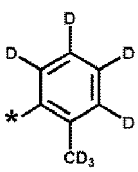 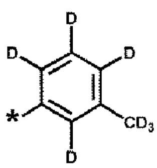 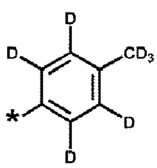 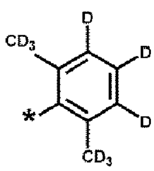 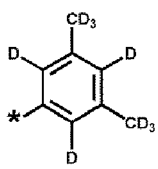 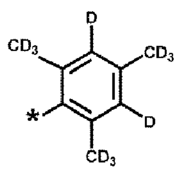

10-516 10-517 10-518 10-519 10-520 10-521

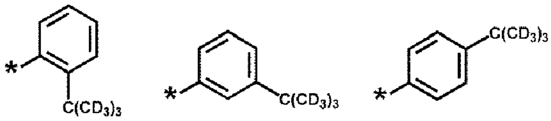 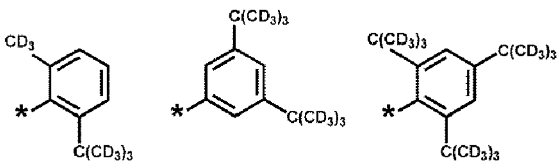

10-522 10-523 10-524 10-525 10-526 10-527

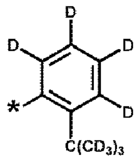
10-528

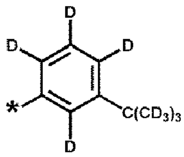
10-529

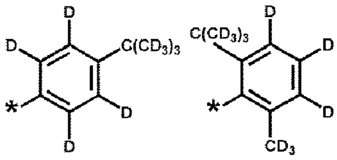
10-530 10-531

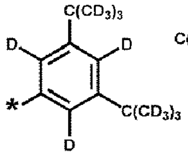
10-532

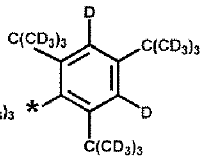
10-533

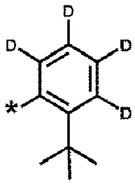
10-534

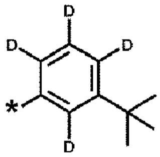
10-535

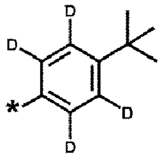
10-536

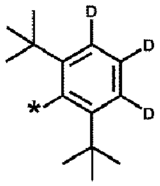
10-537

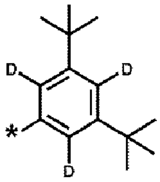
10-538

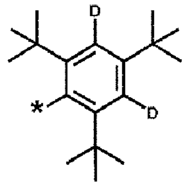
10-540

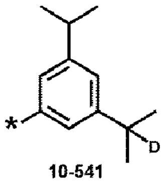
10-541

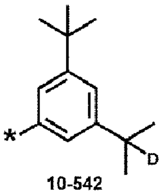
10-542

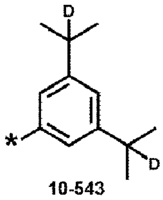
10-543

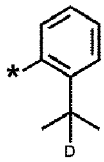
10-544

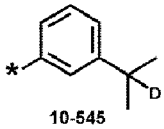
10-545

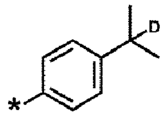
10-546

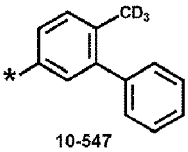
10-547

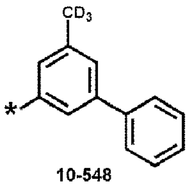
10-548

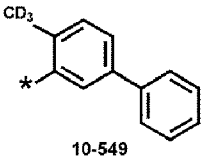
10-549

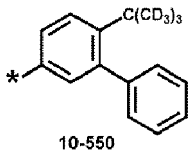
10-550

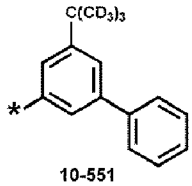
10-551

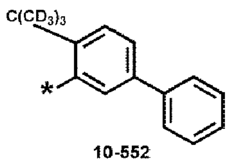
10-552

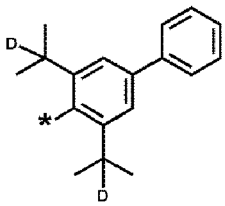
10-553

The "group represented by one of Formulae 10-1 to 10-145 in which at least one hydrogen is substituted with -F" and the "group represented by one of Formulae 10-201 to 10-354 in which at least one hydrogen is substituted with -F" may be, for example, a group represented by one of Formulae 10-601 to 10-636:

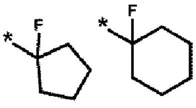
10-601 10-602

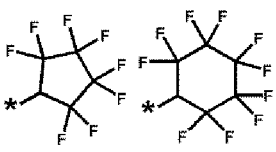
10-603 10-604

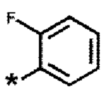
10-605

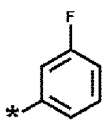
10-606

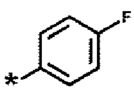
10-607

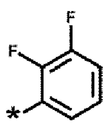
10-608

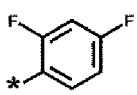
10-609

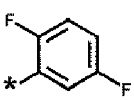
10-610

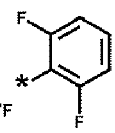
10-611

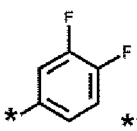
10-612

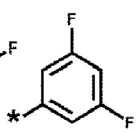
10-613

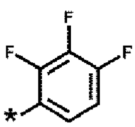
10-614

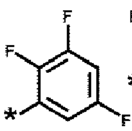
10-615

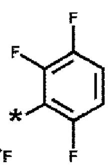
10-616

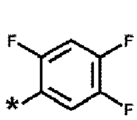
10-617

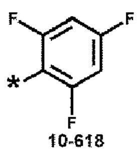
10-618

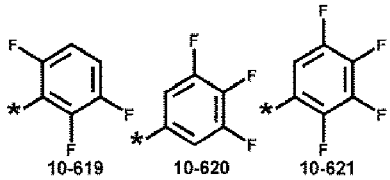

10-619 10-620 10-621

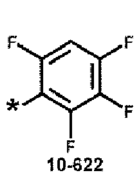

10-622

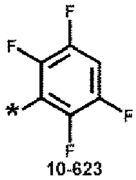

10-623

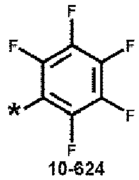

10-624

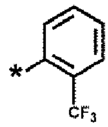

10-625

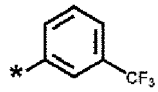

10-626

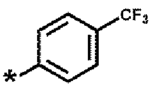

10-627

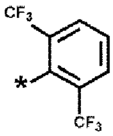

10-628

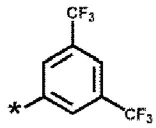

10-629

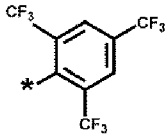

10-630

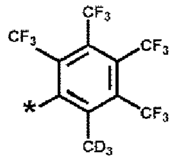

10-631

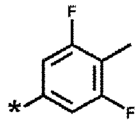

10-632

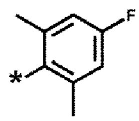

10-633

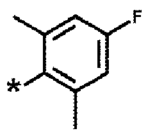

10-634

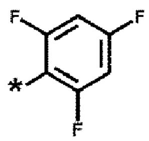

10-635

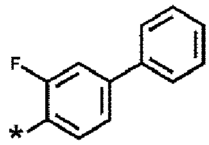

10-636

In Formulae 2A and 2B, i) two or more of a plurality of $R_1$(s) may be optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, ii) two or more of a plurality of $R_2$(s) may be optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, iii) two or more of a plurality of $R_3$(s) may be optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$, iv) two or more of a plurality of $R_4$(s) may be optionally linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$. $R_{10a}$ may be the same as described in connection with $R_1$.

[0112] * and *' in Formulae 2A and 2B each indicate a binding site to M in Formula 1. In one or more embodiments, a group represented by

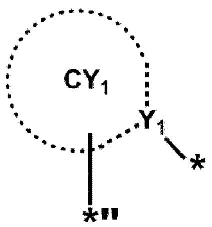

in Formula 2A may be a group represented by one of Formulae CY1(1) to CY1(42):

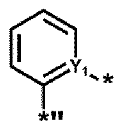

CY1(1)

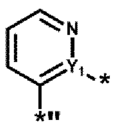

CY1(2)

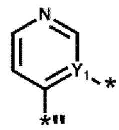

CY1(3)

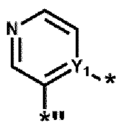

CY1(4)

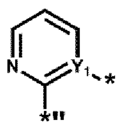

CY1(5)

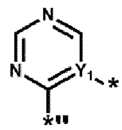

CY1(6)

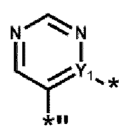

CY1(7)

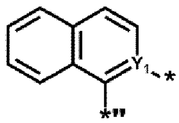

CY1(8)

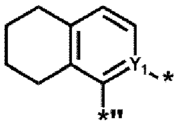
CY1(9)

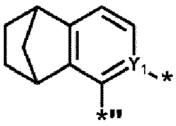
CY1(10)

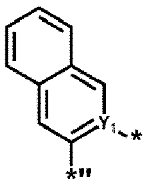
CY1(11)

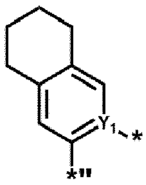
CY1(12)

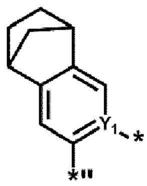
CY1(13)

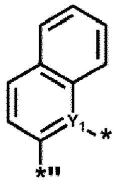
CY1(14)

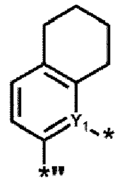
CY1(15)

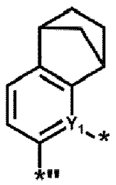
CY1(16)

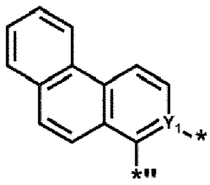
CY1(17)

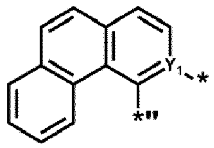
CY1(18)

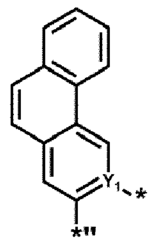
CY1(19)

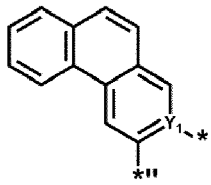
CY1(20)

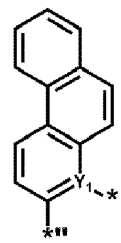
CY1(21)

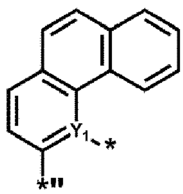
CY1(22)

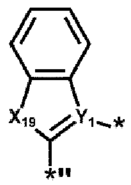
CY1(23)

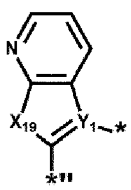
CY1(24)

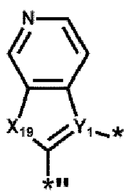
CY1(25)

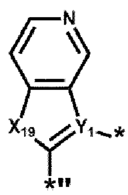
CY1(26)

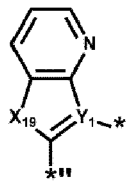
CY1(27)

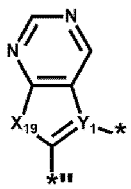
CY1(28)

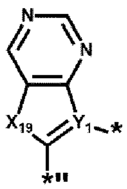
CY1(29)

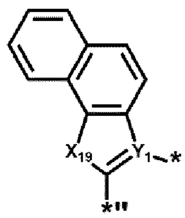
CY1(30)

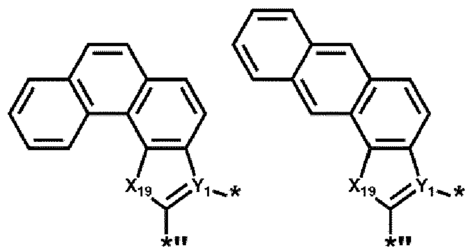
CY1(31)

CY1(32)

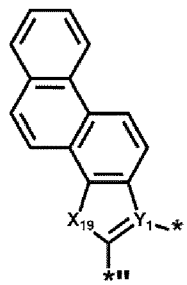
CY1(33)

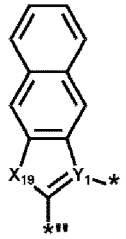
CY1(34)

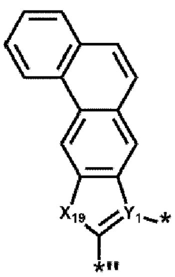
CY1(35)

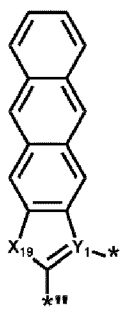
CY1(36)

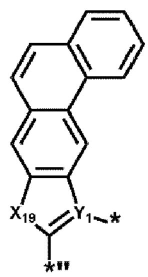
CY1(37)

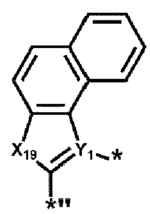
CY1(38)

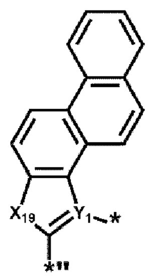
CY1(39)

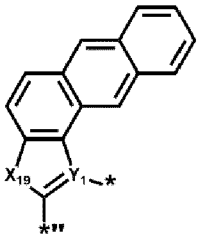
CY1(40)

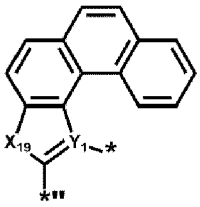
CY1(41)

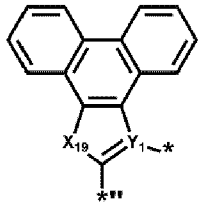
CY1(42)

In Formulae CY1(1) to CY1(42),

$X_{19}$ is O, S, N($R_{19a}$), C($R_{19a}$)($R_{19b}$), or Si($R_{19a}$)($R_{19b}$), and $R_{19a}$ and $R_{19b}$ are the same as described in connection with $R_1$, $Y_1$ may be carbon or nitrogen, and

**[0114]** * indicates a binding site to M in Formula 1, and *" indicates a binding site to a neighboring carbon atom in Formula 2A. In one or more embodiments, a group represented by

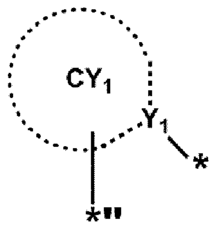

in Formula 2A may be a group represented by one of Formulae CY1(1) to CY1(22).

In one or more embodiments, a group represented by

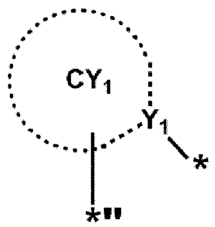

in Formula 2A may be a group represented by one of Formulae $CY_1$(23) to $CY_1$(42).

In one or more embodiments, a group represented by

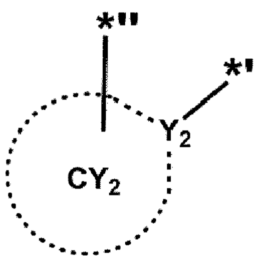

in Formula 2A may be a group represented by one of Formulae CY2(1) to CY2(40):

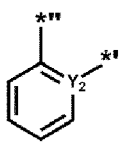
CY2(1)

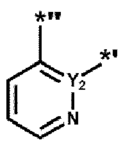
CY2(2)

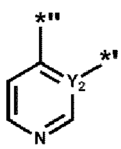
CY2(3)

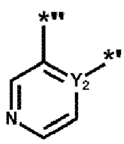
CY2(4)

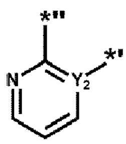
CY2(5)

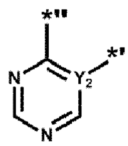
CY2(6)

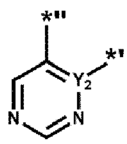
CY2(7)

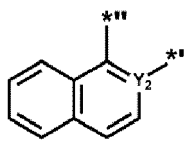
CY2(8)

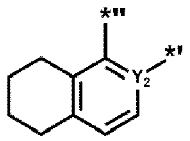
CY2(9)

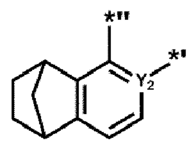
CY2(10)

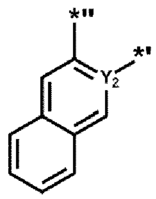
CY2(11)

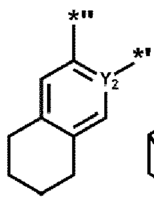
CY2(12)

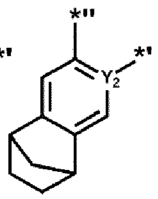
CY2(13)

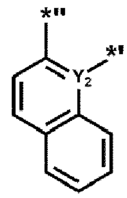
CY2(14)

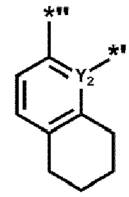
CY2(15)

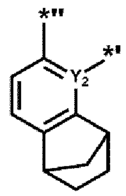
CY2(16)

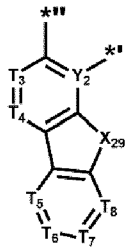
CY2(17)

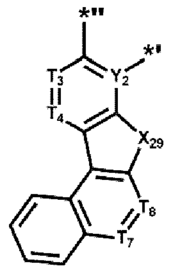
CY2(18)

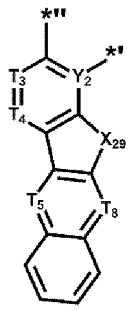
CY2(19)

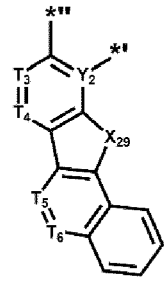
CY2(20)

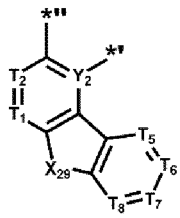
CY2(21)

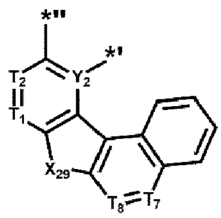
CY2(22)

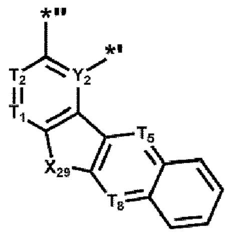
CY2(23)

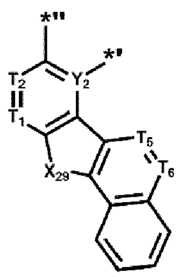
CY2(24)

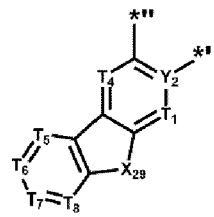
CY2(25)

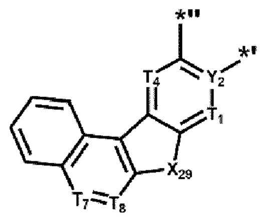
CY2(26)

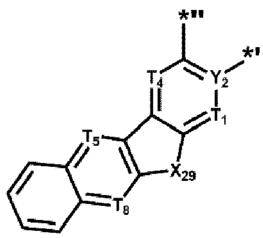
CY2(27)

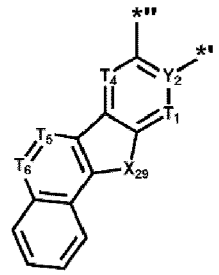
CY2(28)

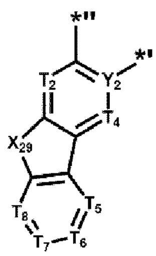
CY2(29)

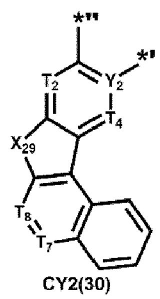
CY2(30)

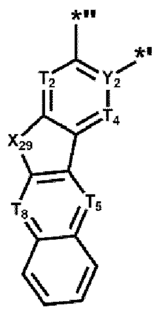
CY2(31)

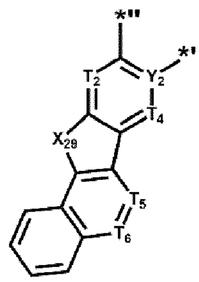
CY2(32)

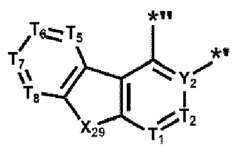
CY2(33)

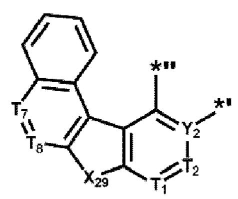
CY2(34)

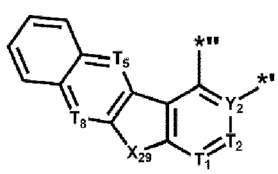
CY2(35)

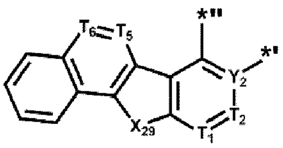

CY2(36)

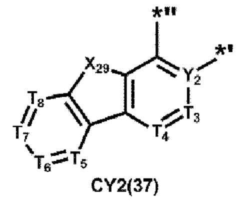

CY2(37)

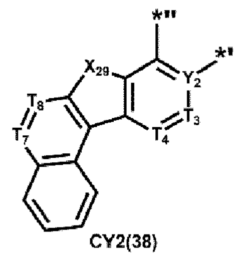

CY2(38)

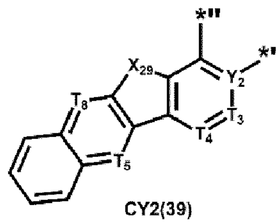

CY2(39)

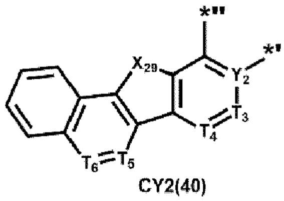

CY2(40)

In Formulae CY2(1) to CY2(40),

$T_1$ to $T_8$ may each be carbon or nitrogen,
$Y_2$ may be carbon or nitrogen,
$X_{29}$ is O, S, N($R_{29a}$), C($R_{29a}$)($R_{29b}$), or Si($R_{29a}$)($R_{29b}$), and $R_{29a}$ and $R_{29b}$ are the same as described in connection with $R_2$,
*' indicates a binding site to M in Formula 1, and *" indicates a binding site to ring $CY_1$ in Formula 2A.

For example, $T_1$ to $T_8$ in Formulae CY2(17) to CY2(40) may each be carbon. In one or more embodiments,

at least one of $T_3$ to $T_8$ in Formula CY2(17) may be nitrogen,
at least one of $T_3$, $T_4$, $T_7$ and $T_8$ in Formula CY2(18) may be nitrogen,
at least one of $T_3$, $T_4$, $T_5$ and $T_8$ in Formula CY2(19) may be nitrogen,
at least one of $T_3$, $T_4$, $T_5$ and $T_6$ in Formula CY2(20) may be nitrogen,
at least one of $T_1$, $T_2$, $T_5$, $T_6$, $T_7$ and $T_8$ in Formula CY2(21) may be nitrogen,
at least one of $T_1$, $T_2$, $T_7$ and $T_8$ in Formula CY2(22) may be nitrogen,
at least one of $T_1$, $T_2$, $T_5$ and $T_8$ in Formula CY2(23) may be nitrogen,
at least one of $T_1$, $T_2$, $T_5$ and $T_6$ of Formula CY2(24) may be nitrogen,
at least one of $T_1$, $T_4$, $T_5$, $T_6$, $T_7$ and $T_8$ in Formula CY2(25) may be nitrogen,
at least one of $T_1$, $T_4$, $T_7$ and $T_8$ in Formula CY2(26) may be nitrogen,
at least one of $T_1$, $T_4$, $T_5$ and $T_8$ in Formula CY2(27)may be nitrogen,
at least one of $T_1$, $T_4$, $T_5$ and $T_6$ in Formula CY2(28) may be nitrogen,
at least one of $T_2$, $T_4$, $T_5$, $T_6$, $T_7$ and $T_8$ in Formula CY2(29) may be nitrogen,
at least one of $T_2$, $T_4$, $T_7$ and $T_8$ in Formula CY2(30) may be nitrogen,
at least one of $T_2$, $T_4$, $T_5$ and $T_8$ in Formula CY2(31) may be nitrogen,
at least one of $T_2$, $T_4$, $T_5$ and $T_6$ of Formula CY2(32) may be nitrogen,
at least one of $T_1$, $T_2$, $T_5$, $T_6$, $T_7$ and $T_8$ in Formula CY2(33) may be nitrogen,
at least one of $T_1$, $T_2$, $T_7$ and $T_8$ in Formula CY2(34) may be nitrogen,
at least one of $T_1$, $T_2$, $T_5$ and $T_8$ in Formula CY2(35) may be nitrogen,
at least one of $T_1$, $T_2$, $T_5$ and $T_6$ of Formula CY2(36) may be nitrogen,
at least one of $T_3$ to $T_8$ of Formula CY2(37) may be nitrogen,
at least one of $T_3$, $T_4$, $T_7$ and $T_8$ of Formula CY2(38) may be nitrogen,
at least one of $T_3$, $T_4$, $T_5$ and $T_8$ in Formula CY2(39) may be nitrogen,
or at least one of $T_3$ to $T_6$ of Formula CY2(40) may be nitrogen.

In one or more embodiments, in Formulae CY2(17) to CY2(40), $T_8$ may be N and $T_1$ to $T_7$ may each be carbon.

In one or more embodiments, a group represented by

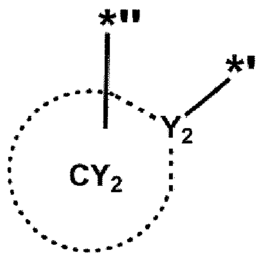

in Formula 2A may be a group represented by one of Formulae CY2(17) to CY2(40).

In one or more embodiments, a group represented by

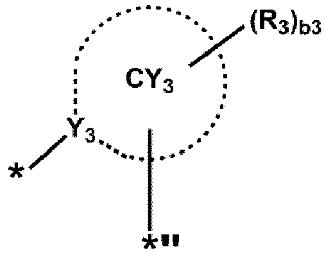

in Formula 2B may be a group represented by Formula CY3(1):

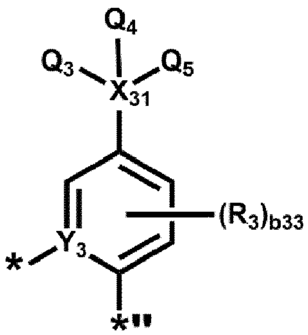

CY3(1)

In Formula CY3(1),

$Y_3$ may be carbon or nitrogen,
$X_{31}$ may be Si or Ge, and
$R_3$ and $Q_3$ to $Q_5$ are the same as described in the present specification,
b33 may each independently be an integer from 0 to 3,
two or more of $R_3$(s) in the number of b33 may optionally be linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$ (for example, a cyclohexane group, a norbornane group, a benzene group, a pyridine group, a naphthalene group, a quinoline group, or an isoquinoline group, each unsubstituted or substituted with at least one $R_{10a}$),
* indicates a binding site to M in Formula 1, and
*" indicates a binding site to ring $CY_4$ in Formula 2B.

For example, at least one of $R_3$(s) in the number of b33 in Formula CY3(1) may include two or more of carbon.

In one or more embodiments, a group represented by

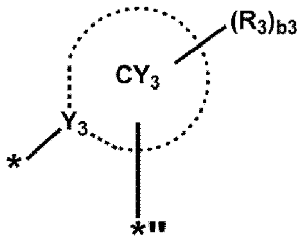

in Formula 2B may be a group represented by one of Formulae CY3-1 to CY3-16:

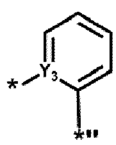
CY3-1

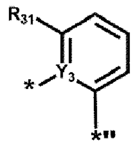
CY3-2

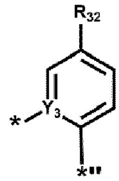
CY3-3

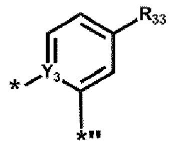
CY3-4

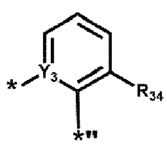
CY3-5

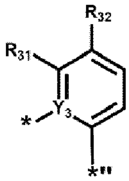
CY3-6

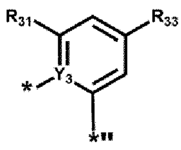
CY3-7

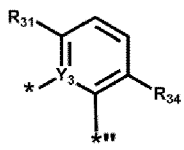
CY3-8

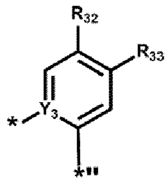
CY3-9

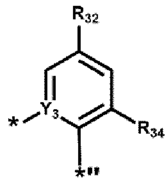
CY3-10

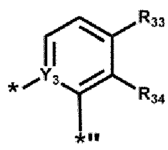
CY3-11

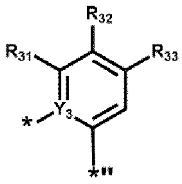
CY3-12

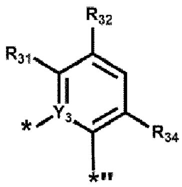
CY3-13

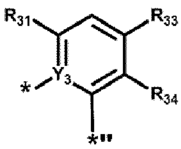
CY3-14

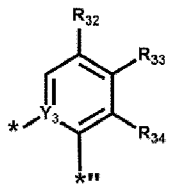
CY3-15

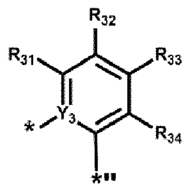
CY3-16

In Formulae CY3-1 to CY3-16,

$R_{31}$ to $R_{34}$ are the same as described in connection with $R_3$, and each of $R_{31}$ to $R_{34}$ is not hydrogen,
$Y_3$ may be carbon or nitrogen
* indicates a binding site to M in Formula 1, and *" indicates a binding site to ring $CY_4$ in Formula 2B.

For example, $R_{32}$ in Formulae CY3-1 to CY3-16 may be a $C_1$-$C_{10}$ alkyl group substituted with at least one deuterium; -Si($Q_3$)($Q_4$)($Q_5$); or -Ge($Q_3$)($Q_4$)($Q_5$).

In one or more embodiments, $R_{33}$ in Formulae CY3-1 to CY3-16 may include two or more of carbons.

In one or more embodiments, $R_{33}$ and $R_{34}$ in Formulae CY3-1 to CY3-16 may optionally be linked to each other to form a $C_5$-$C_{30}$ carbocyclic group that is unsubstituted or substituted with at least one $R_{10a}$ or a $C_1$-$C_{30}$ heterocyclic group that is unsubstituted or substituted with at least one $R_{10a}$ (for example, a cyclohexane group, a norbornane group, a benzene group, a pyridine group, a naphthalene group, a quinoline group, or an isoquinoline group, each unsubstituted or substituted with at least one $R_{10a}$).

In one or more embodiments, a group represented by

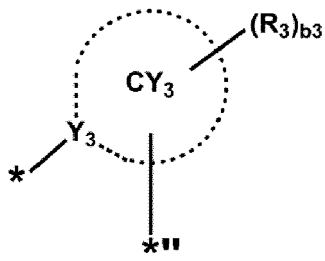

in Formula 2B may be a group represented by Formula CY3-3, CY3-6, CY3-9, CY3-10, CY3-12, CY3-13, CY3-15, or CY3-16, and $R_{32}$ in Formulae CY3-3, CY3-6, CY3-9, CY3-10, CY3-12, CY3-13, CY3-15 and CY3-16 may be $-Si(Q_3)(Q_4)(Q_5)$; or - $Ge(Q_3)(Q_4)(Q_5)$. In one or more embodiments, a group represented by

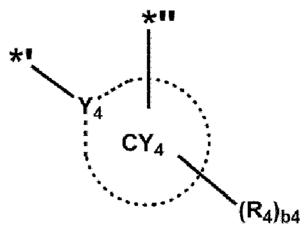

in Formula 2B may be a group represented by one of Formulae CY4-1 to CY4-16:

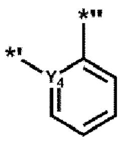
CY4-1

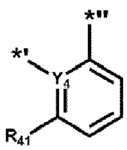
CY4-2

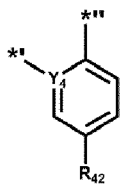
CY4-3

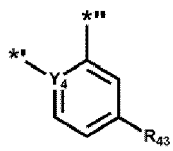
CY4-4

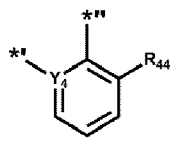
CY4-5

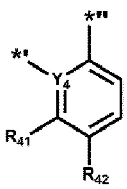
CY4-6

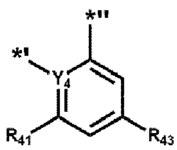
CY4-7

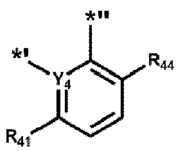
CY4-8

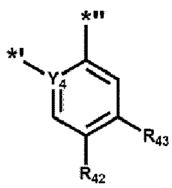
CY4-9

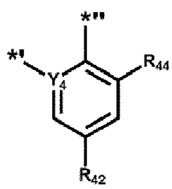
CY4-10

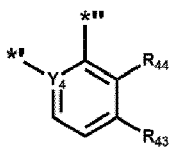
CY4-11

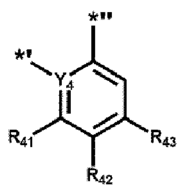
CY4-12

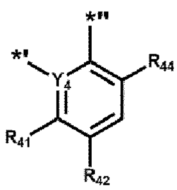
CY4-13

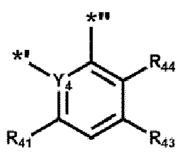
CY4-14

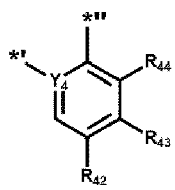
CY4-15

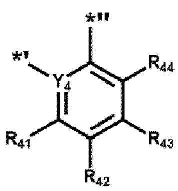
CY4-16

In Formulae CY4-1 to CY4-16,

$Y_4$ may be carbon or nitrogen, $R_{41}$ to $R_{44}$ are the same as described in connection with $R_4$, and each of $R_{41}$ to $R_{44}$ is not hydrogen,
*' indicates a binding site to M in Formula 1, and
*" indicates a binding site to ring $CY_3$ in Formula 2B.

In one or more embodiments, the organometallic compound represented by Formula 1 may emit green light with a maximum emission wavelength in the range of about 500 nm to about 580 nm (in photoluminescence (PL)

spectrum).

In one or more embodiments, the organometallic compound represented by Formula 1 may satisfy Condition 1 or Condition 2:

Condition 1

A group represented by

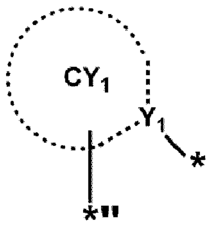

in Formula 2A is a group represented by one of Formulae $CY_1(1)$ to $CY_1(22)$, and

a group represented by

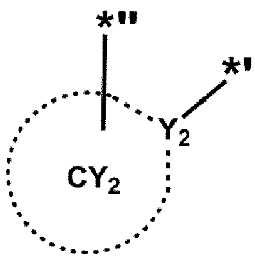

in Formula 2A is a group represented by one of Formulae CY2(17) to CY2(40) , and

a group represented by

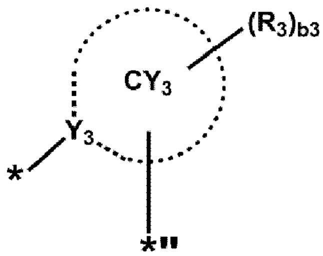

in Formula 2B is a group represented by Formula CY3(1) (for example, a group represented by Formula CY3-3, CY3-6, CY3-9, CY3-10, CY3-12, CY3-13, CY3-15, or CY3-16 in which $R_{32}$ is -Si($Q_3$)($Q_4$)($Q_5$) or -Ge($Q_3$)($Q_4$)($Q_5$)), and

a group represented by

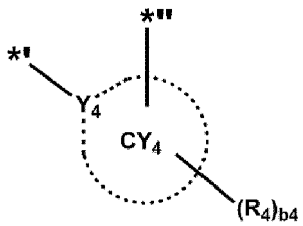

in Formula 2B is a group represented by one of Formulae CY4-1 to CY4-16.

Condition 2

A group represented by

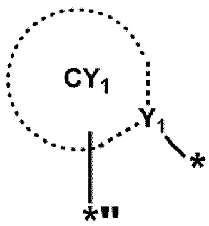

in Formula 2A is a group represented by one of Formulae $CY_1(23)$ to $CY_1(42)$,

a group represented by

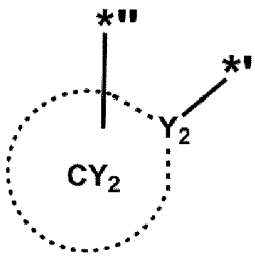

in Formula 2A is a group represented by one of Formulae CY2(17) to CY2(40),

a group represented by

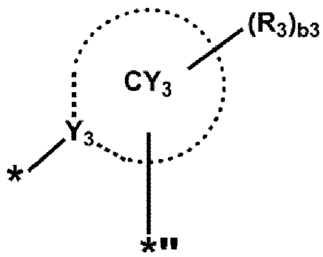

in Formula 2B is a group represented by Formula CY3(1) (for example, a group represented by Formula CY3-3, CY3-6, CY3-9, CY3-10, CY3-12, CY3-13, CY3-15, or CY3-16 in which $R_{32}$ is $-Si(Q_3)(Q_4)(Q_5)$ or $-Ge(Q_3)(Q_4)(Q_5)$), and

a group represented by

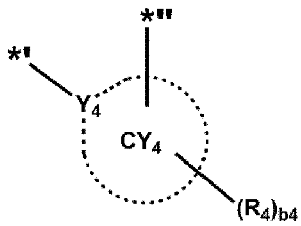

in Formula 2B is a group represented by one of Formulae CY4-1 to CY4-16. Description of Formulae 5, 7, and 9

Formula 5

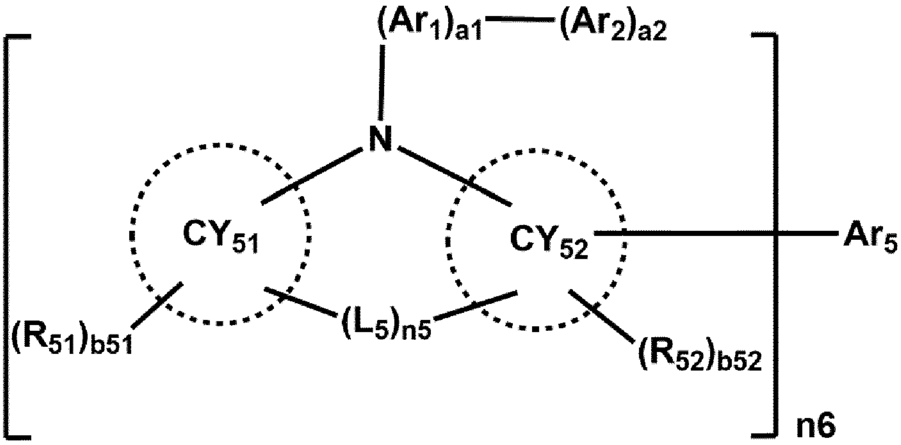

Formula 7

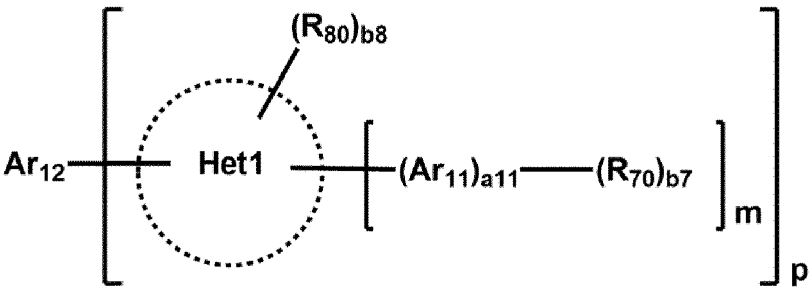

Formula 9

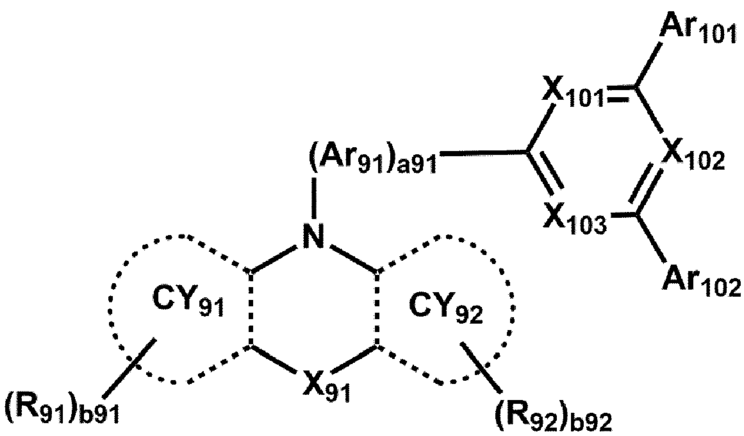

$Ar_1$, $Ar_2$, $Ar_{11}$, $Ar_{101}$, and $Ar_{102}$ in Formulae 5, 7, and 9 may each independently be a $C_5$-$C_{60}$ carbocyclic group unsubstituted or substituted with at least one $R_{50}$ or a $C_1$-$C_{60}$ heterocyclic group unsubstituted or substituted with at least one $R_{50}$,

$Ar_{91}$ in Formula 9 may be a single bond, a $C_5$-$C_{60}$ carbocyclic group unsubstituted or substituted with at least one $R_{90}$, or a $C_1$-$C_{60}$ heterocyclic group unsubstituted or substituted with at least one $R_{90}$,

$Ar_5$ and $Ar_{12}$ in Formulae 5 and 7 may each independently be a single bond, a $C_5$-$C_{60}$ carbocyclic group unsubstituted or substituted with at least one $R_{50a}$, or a $C_1$-$C_{60}$ heterocyclic group unsubstituted or substituted with at least one $R_{50a}$, or may not exist,
n6 in Formula 5 may be 1, 2, or 3, and when n6 is 1, $Ar_5$ may not exist,
p in Formula 7 may be 1, 2, or 3, and when p is 1, $Ar_{12}$ may not exist,
a1 and a2 in Formula 5 may each independently be an integer from 0 to 5, and the sum of a1 and a2 may be 1 or more,
ring $CY_{51}$, ring $CY_{52}$, ring $CY_{91}$ and ring $CY_{92}$ in Formulae 5 and 9 may each independently be a $C_5$-$C_{60}$ carbocyclic group or a $C_1$-$C_{60}$ heterocyclic group, and ring $CY_{51}$ and ring $CY_{52}$ may be optionally combined with each other with a $C_5$-$C_{60}$ carbocyclic group unsubstituted or substituted with at least one $R_{50b}$ or a $C_1$-$C_{60}$ heterocyclic group unsubstituted or substituted with at least one $R_{50b}$ therebetween,
$L_5$ in Formula 5 may be a single bond, O, S, $N(R_{50c})$, $C(R_{50c})(R_{50d})$, or $Si(R_{50c})(R_{50d})$, and n5 may be 0 or 1, wherein, when n5 is 0, $L_5$ may not exist,
Het1 in Formula 7 may be a $\pi$ electron-deficient nitrogen-containing C1-C60 cyclic group, and
a11, a91 and m in Formulae 7 and 9 may each independently be an integer from 1 to 10,

In Formula 9, $X_{101}$ may be N or $C(R_{101})$, $X_{102}$ may be N or $C(R_{102})$, $X_{103}$ may be N or $C(R_{103})$, and at least two of $X_{101}$ to $X_{103}$ may be N, and
$X_{91}$ in Formula 9 may be a single bond, O, S, $N(R_{91a})$, $C(R_{91a})(R_{91b})$, or $Si(R_{91a})(R_{91b})$.

The term "$\pi$ electron-deficient nitrogen-containing $C_1$-$C_{60}$ cyclic group" as used herein refers to a cyclic group having 1 to 60 carbon atoms including at least one *-N=*' as a ring-constituting moiety, and may be, for example, a) a first ring, b) a condensed ring in which two or more first rings are condensed with each other, or c) a condensed ring in which at least one first ring is condensed with at least one second ring. The first ring and the second ring are the same as described in the present specification.

The $\pi$ electron-deficient nitrogen-containing $C_1$-$C_{60}$ cyclic group may be, for example, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole group, a benzoisoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, a benzonaphthofuran group, a benzonaphthothiophene group, an (indolo)phenanthrene group, a (benzofurano)phenanthrene group, a (benzothieno)phenanthrene group, or a pyridopyrazine group.

The term "$\pi$ electron-rich $C_3$-$C_{60}$ cyclic group" used herein refers to a cyclic group having 3 to 60 carbon atoms not including *-N=*' as a ring-constituting moiety, and may be, for example, a) a second ring or b) a condensed cyclic group in which two or more second rings are condensed with each other. The second ring are the same as described in the present specification.

The $\pi$ electron-rich $C_3$-$C_{60}$ cyclic group may be, for example, a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, an indene group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, a dihydroacridine group, a

pyrrolophenanthrene group, a furanophenanthrene group, or a thienophenanthrene group.

In some embodiments,

$Ar_1$, $Ar_2$, $Ar_{11}$, $Ar_{101}$ and $Ar_{102}$ in Formulae 5, 7 and 9 may each independently be a group derived from i) a first ring unsubstituted or substituted with at least one $R_{50}$, ii) a second ring unsubstituted or substituted with at least one $R_{50}$, iii) a condensed cyclic group in which two or more first rings, substituted or unsubstituted with at least one $R_{50}$, are condensed with each other, iv) a condensed cyclic group in which two or more second rings, substituted or unsubstituted with at least one $R_{50}$, are condensed with each other, or v) a condensed cyclic group in which at least one first ring unsubstituted or substituted with at least one $R_{50}$ is condensed with at least one second ring unsubstituted or substituted with at least one $R_{50}$,

$Ar_{91}$ in Formula 9 may be a single bond, or a group derived from i) a first ring unsubstituted or substituted with at least one $R_{90}$, ii) a second ring unsubstituted or substituted with at least one $R_{90}$, iii) a condensed cyclic group in which two or more first rings, unsubstituted or substituted with at least one $R_{90}$, are condensed with each other, iv) a condensed cyclic group in which two or more second rings, unsubstituted or substituted with at least one $R_{90}$, are condensed with each other, or v) a condensed cyclic group in which at least one first ring unsubstituted or substituted with at least one $R_{90}$ is condensed with at least one second ring unsubstituted or substituted with at least one $R_{90}$,

$Ar_5$ and $Ar_{12}$ in Formulae 5 and 7 may each independently be a single bond, or a group derived from i) a first ring unsubstituted or substituted with at least one $R_{50a}$, ii) a second ring unsubstituted or substituted with at least one $R_{50a}$, iii) a condensed cyclic group in which two or more first rings, substituted or unsubstituted with at least one $R_{50a}$, are condensed with each other, iv) a condensed cyclic group in which two or more second rings, substituted or unsubstituted with at least one $R_{50a}$, are condensed with each other, or v) a condensed cyclic group in which at least one first ring unsubstituted or substituted with at least one $R_{50a}$ is condensed with at least one second ring unsubstituted or substituted with at least one $R_{50a}$, or may not exist,

ring $CY_{51}$, ring $CY_{52}$, ring $CY_{91}$ and ring $CY_{92}$ in Formulae 5 and 9 may each independently be i) a first ring, ii) a second ring, iii) a condensed ring in which two or more first rings are condensed with each other, iv) a condensed ring in which two or more second rings are condensed with each other, or v) a condensed ring in which one or more first rings and one or more second rings are condensed with each other,

Het1 in Formula 7 may be a group derived from i) a first ring, ii) a condensed cyclic group in which two or more first rings are condensed with each other or iii) a condensed cyclic group in which at least one first ring is condensed with at least one second ring,

the first ring may be an imidazole group, a pyrazole group, a thiazole group, an isothiazole group, an oxazole group, an isoxazole group, a pyridine group, a pyrazine group, a pyridazine group, a pyrimidine group, a triazole group, a tetrazole group, an oxadiazole group, a triazine group, or a thiadiazole group, and

the second ring may be a benzene group, a cyclopentadiene group, a pyrrole group, a furan group, a thiophene group, or a silole group.

In one or more embodiments, $Ar_1$, $Ar_2$, $Ar_{11}$, $Ar_{101}$ and $Ar_{102}$ in Formulae 5, 7, and 9 may each independently be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, an indene group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, a dihydroacridine group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole group, a benzoisoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, a benzonaphthofuran group, a benzonaphthothiophene group, an (indolo)phenanthrene group, a (benzofurano)phenanthrene group, or a (benzothieno)phenanthrene group, each unsubstituted or substituted with at least one $R_{50}$.

In one or more embodiments, $Ar_{91}$ in Formula 9 may be a single bond, or a benzene group, a heptalene group,

an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, an indene group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, a dihydroacridine group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole group, a benzoisoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, a benzonaphthofuran group, a benzonaphthothiophene group, an (an indolo)phenanthrene group, a (benzofurano)phenanthrene group, or a (benzothieno)phenanthrene group, each unsubstituted or substituted with at least one $R_{90}$.

In one or more embodiments, $Ar_5$ and $Ar_{12}$ in Formulae 5 and 7 may each independently be a single bond, or a benzene group, a naphthalene group, or a carbazole group, each unsubstituted or substituted with at least one $R_{50a}$, or may not exist.

In one or more embodiments, ring $CY_{51}$, ring $CY_{52}$, ring $CY_{91}$ and ring $CY_{92}$ of Formulae 5 and 9 may each independently be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentacene group, a hexacene group, a pentaphene group, a rubicene group, a coronene group, an ovalene group, a pyrrole group, a furan group, a thiophene group, an isoindole group, an indole group, an indene group, a benzofuran group, a benzothiophene group, a benzosilole group, a naphthopyrrole group, a naphthofuran group, a naphthothiophene group, a naphthosilole group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, a benzosilolocarbazole group, a triindolobenzene group, an acridine group, a dihydroacridine group, an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole group, a benzoisoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, a pyrrolophenanthrene group, a furanophenanthrene group, or a thienophenanthrene group.

In one or more embodiments, Het1 in Formula 7 may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a benzoisoquinoline group, a phthalazine group, a naphthyridine group, a quinoxaline group, a benzoquinoxaline group, a quinazoline group, a cinnoline group, a phenanthridine group, an acridine group, a phenanthroline group, a phenazine group, a benzimidazole group, an isobenzothiazole group, a benzoxazole group, a benzoisoxazole group, a triazole group, a tetrazole group, an oxadiazole group, a triazine group, a thiadiazole group, an imidazopyridine group, an imidazopyrimidine group, an azacarbazole group, an azadibenzofuran group, an azadibenzothiophene group, an azadibenzosilole group, or a pyridopyrazine group.

In one or more embodiments, $Ar_1$, $Ar_2$, $Ar_{11}$, $Ar_{101}$ and $Ar_{102}$ in Formulae 5, 7, and 9 may each independently be a $\pi$ electron-rich $C_3$-$C_{60}$ cyclic group unsubstituted or substituted with at least one $R_{50}$.

In one or more embodiments, $Ar_{91}$ in Formula 9 may be a single bond, or a $\pi$ electron-rich $C_3$-$C_{60}$ cyclic group unsubstituted or substituted with at least one $R_{90}$.

In one or more embodiments, $Ar_5$ and $Ar_{12}$ in Formulae 5 and 7 may each independently be a single bond or a $\pi$ electron-rich $C_3$-$C_{60}$ cyclic group unsubstituted or substituted with at least one $R_{50a}$, or may not exist.

In one or more embodiments, ring $CY_{51}$, ring $CY_{52}$, ring $CY_{91}$, and ring $CY_{92}$ in Formulae 5 and 9 may each independently be a π electron-rich $C_3$-$C_{60}$ cyclic group.

In one or more embodiments, ring $CY_{91}$ and ring $CY_{92}$ in Formula 9 may each independently be a benzene group, a naphthalene group, a phenanthrene group, a dibenzofuran group, a dibenzothiophene group, a carbazole group, a fluorene group, or a dibenzosilole group.

In one or more embodiments, one of ring $CY_{91}$ and ring $CY_{92}$ in Formula 9 may be a benzene group, a naphthalene group, or a phenanthrene group, and the other one may be a dibenzofuran group, a dibenzothiophene group, a carbazole group, a fluorene group, or a dibenzosilole group.

In one or more embodiments, n6 and p in Formulae 5 and 7 may each independently be 1 or 2.

In one or more embodiments, when n6 in Formula 5 is 1, at least one of ring $CY_{51}$ and ring $CY_{52}$ may not be a benzene group.

In one or more embodiments, when n6 in Formula 5 is 1, at least one of ring $CY_{51}$ and ring $CY_{52}$ may be a) a condensed ring in which two or more first rings are condensed with each other, b) a condensed ring in which two or more second rings are condensed with each other, or c) a condensed ring in which at least one first ring is condensed with at least one second ring. In this regard, the first ring and the second ring are the same as described in the present specification.

In one or more embodiments, the compound represented by Formula 5 may be a compound represented by Formula 5(1):

Formula 5(1)

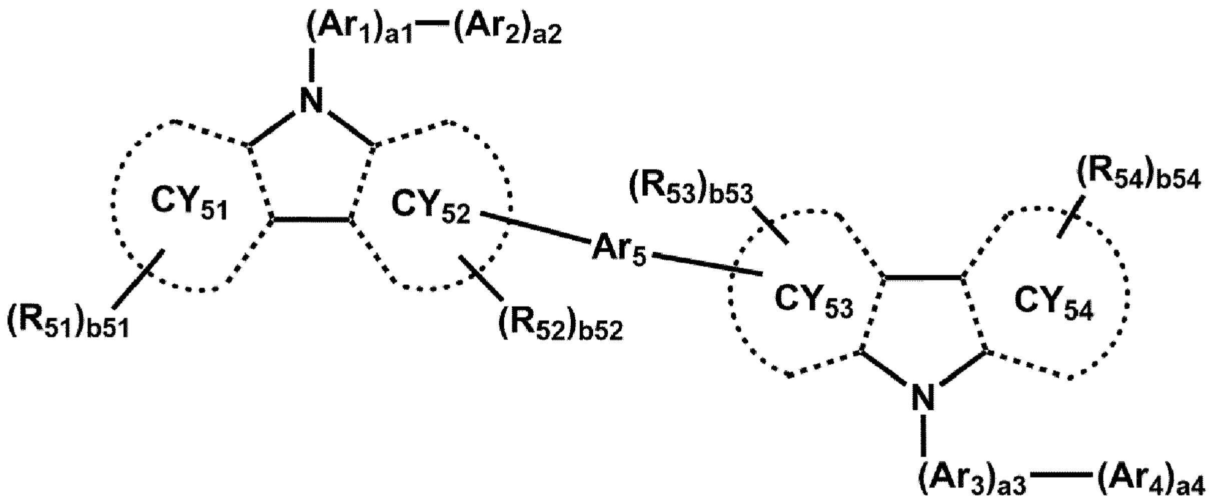

In Formula 5(1),

$Ar_5$ may be a single bond, a $C_5$-$C_{60}$ carbocyclic group unsubstituted or substituted with at least one $R_{50a}$, or a $C_1$-$C_{60}$ heterocyclic group unsubstituted or substituted with at least one $R_{50a}$,
$Ar_1$, $Ar_2$, $Ar_5$, a1, a2, ring $CY_{51}$, ring $CY_{52}$, $R_{51}$, $R_{52}$, b51, and b52 are the same as described in the present specification,
$Ar_3$ and $Ar_4$ may each independently be a $C_5$-$C_{60}$ carbocyclic group unsubstituted or substituted with at least one $R_{50}$ or a $C_1$-$C_{60}$ heterocyclic group unsubstituted or substituted with at least one $R_{50}$,
a3, a4, ring $CY_{53}$, ring $CY_{54}$, $R_{53}$, $R_{54}$, b53, and b54 are the same as described in connection with a1, a2, ring $CY_{51}$, ring $CY_{52}$, $R_{51}$, $R_{52}$, b51, and b52, respectively.

For example, $Ar_5$ in Formula 5(1) may be a single bond.

In one or more embodiments, the compound represented by Formula 7 may include a compound represented by Formula 7(1):

Formula 7(1)

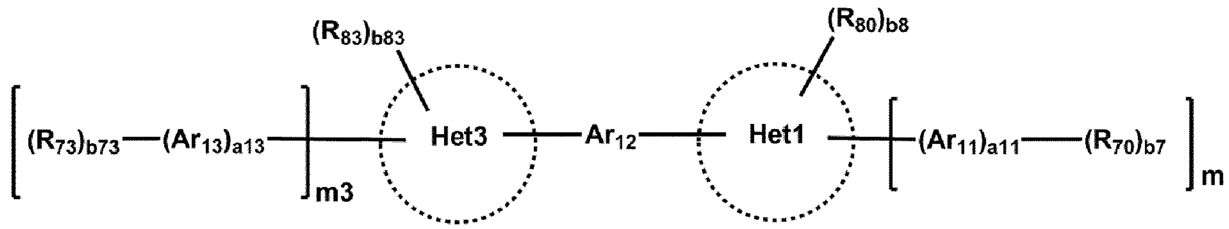

In Formula 7(1),

$Ar_{12}$ may be a single bond, a $C_5$-$C_{60}$ carbocyclic group unsubstituted or substituted with at least one $R_{50a}$, or a $C_1$-$C_{60}$ heterocyclic group unsubstituted or substituted with at least one $R_{50a}$,
Het1, $Ar_{11}$, $R_{70}$, $R_{80}$, a11, b7, b8, and m are the same as described in the present specification, and
Het3, $Ar_{13}$, $R_{73}$, $R_{83}$, a13, b73, b83, and m3 are the same as described in connection with Het1, $Ar_{11}$, $R_{70}$, $R_{80}$, a11, b7, b8, and m, respectively.

In one or more embodiments, a group represented by

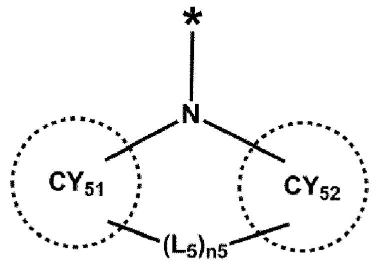

in Formula 5, a group represented by

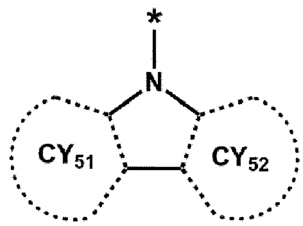

in Formula 5(1) and a group represented by

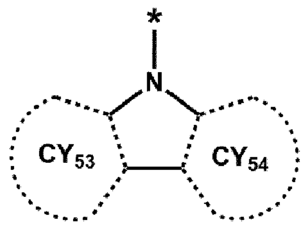

in Formula 5(1) may each independently be a group represented by one of Formulae 2-1 to 2-93:

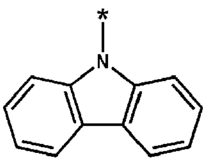

2-1

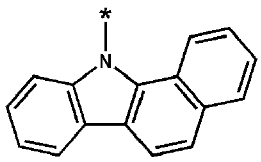

2-2

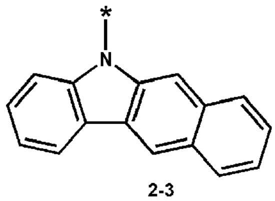

2-3

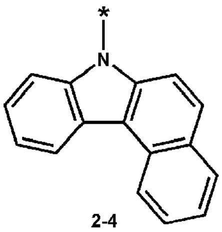

2-4

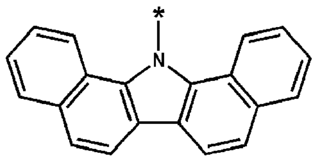

2-5

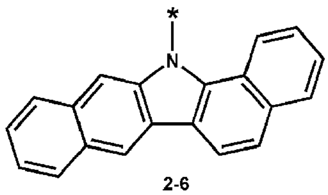

2-6

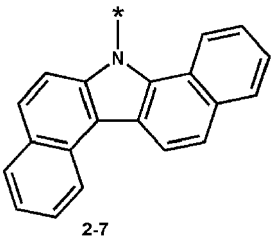

2-7

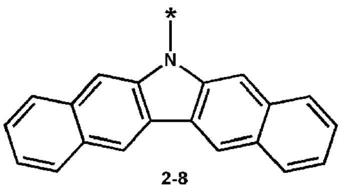

2-8

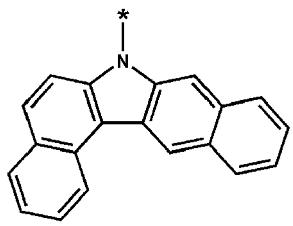

2-9

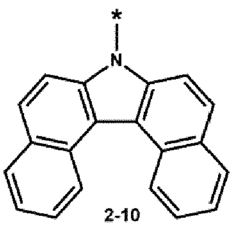

2-10

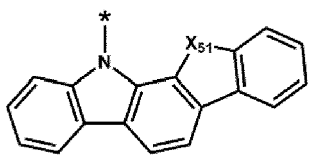

2-11

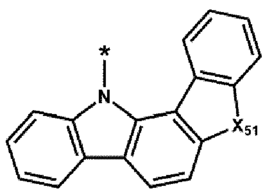

2-12

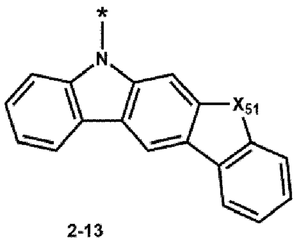

2-13

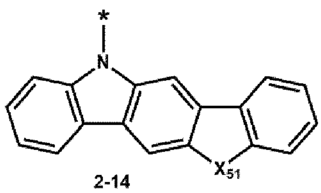

2-14

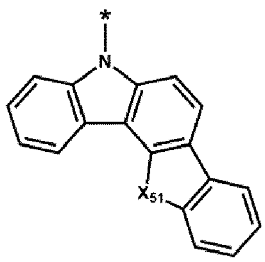

2-15

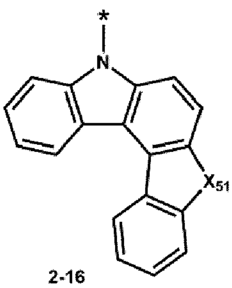

2-16

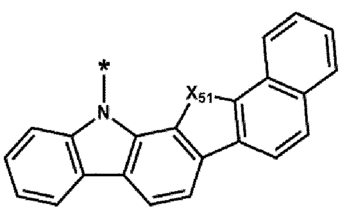

2-17

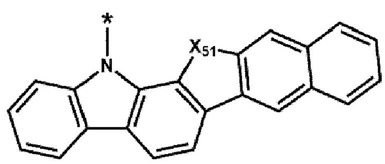

2-18

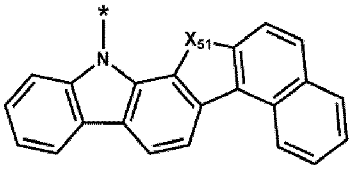
2-19

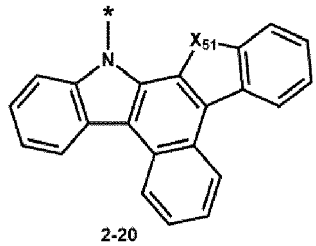
2-20

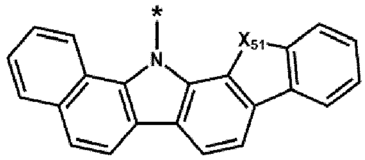
2-21

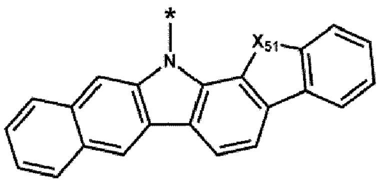
2-22

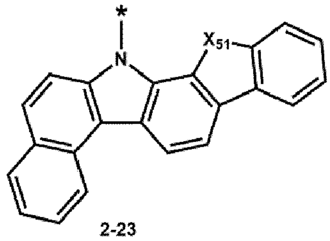
2-23

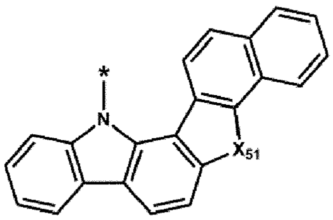
2-24

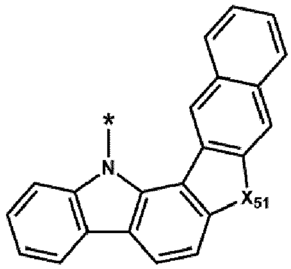
2-25

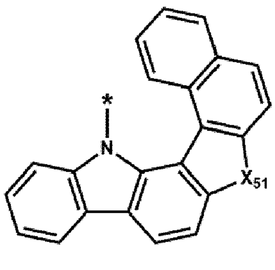
2-26

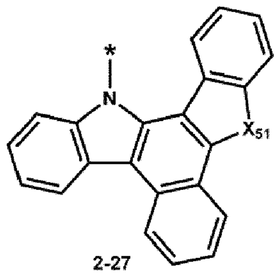
2-27

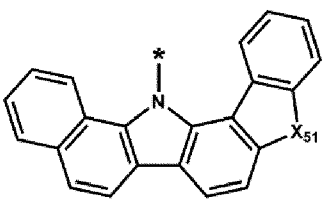
2-28

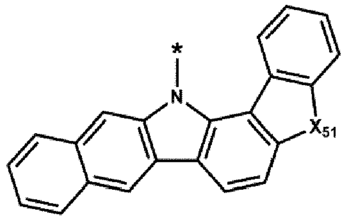
2-29

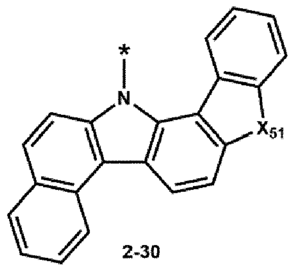
2-30

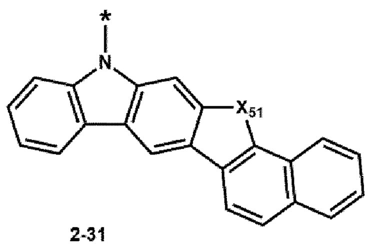
2-31

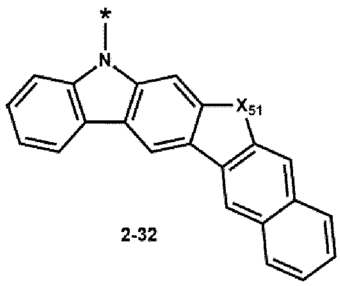
2-32

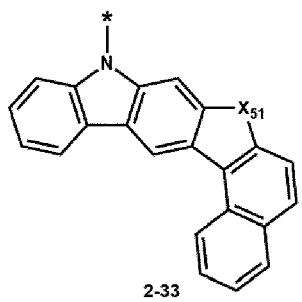
2-33

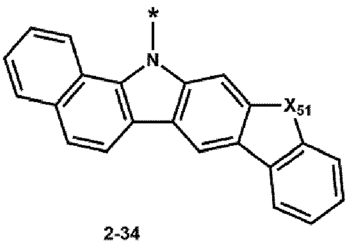

2-34

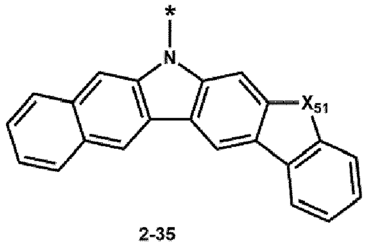

2-35

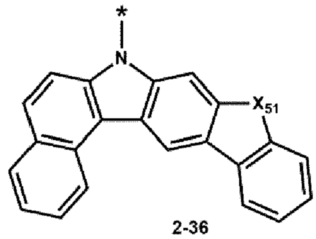

2-36

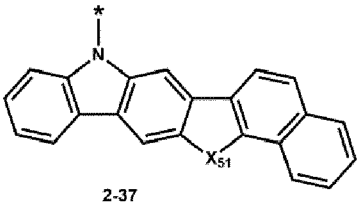

2-37

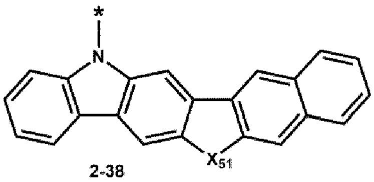

2-38

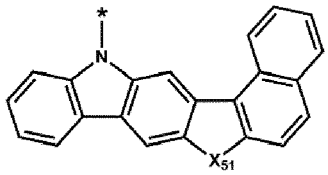

2-39

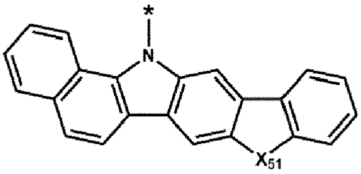

2-40

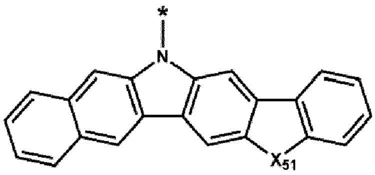

2-41

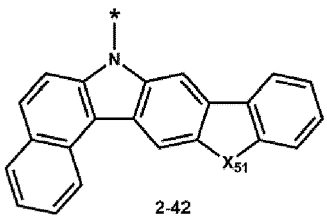

2-42

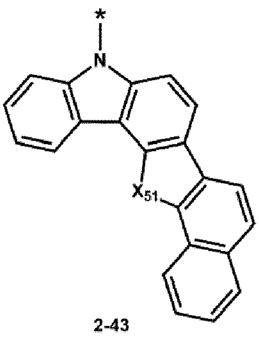

2-43

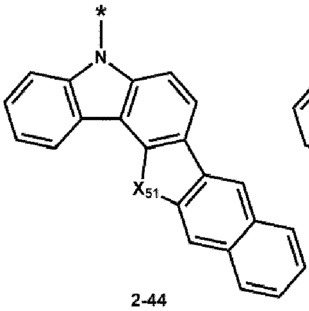

2-44

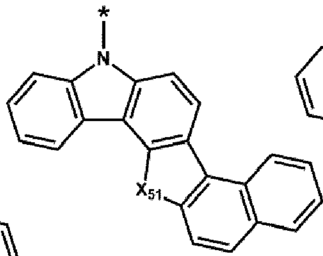

2-45

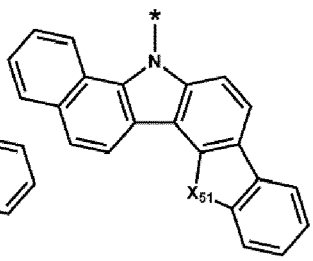

2-46

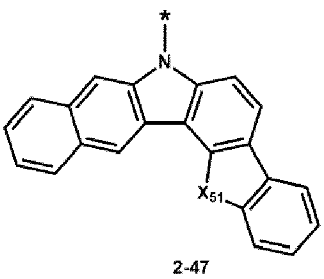

2-47

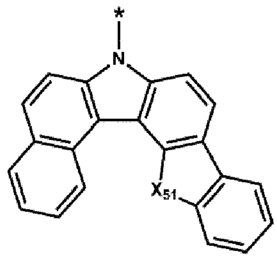

2-48

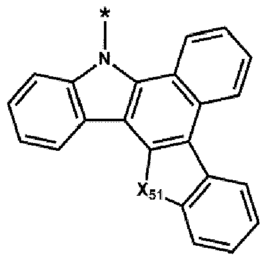

2-49

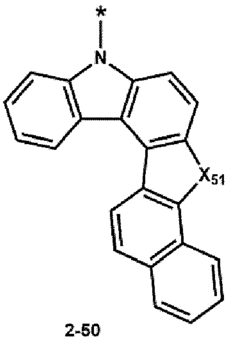

2-50

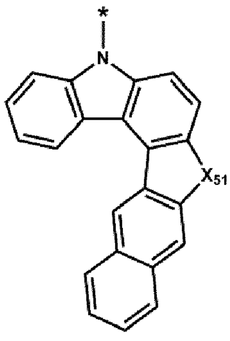

2-51

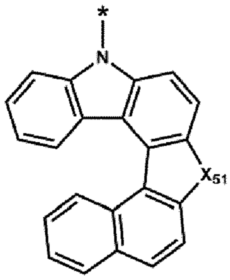

2-52

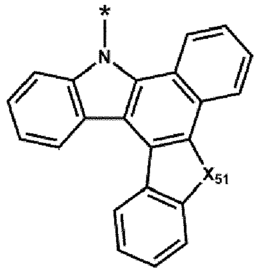

2-53

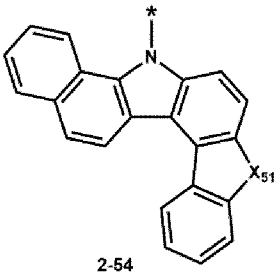

2-54

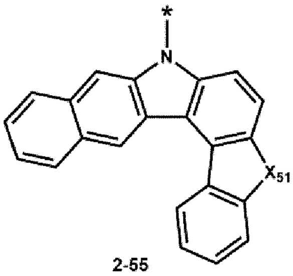

2-55

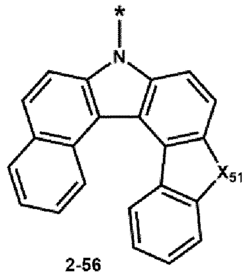

2-56

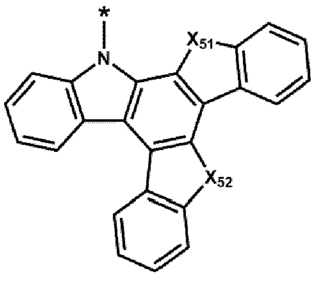

2-57

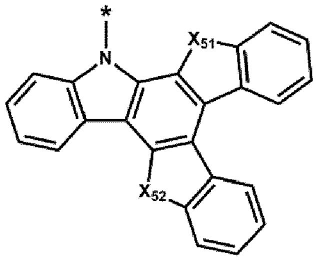

2-58

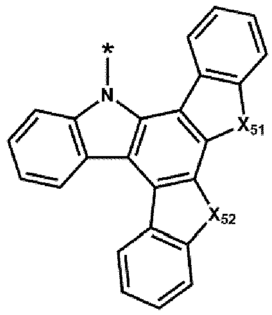

2-59

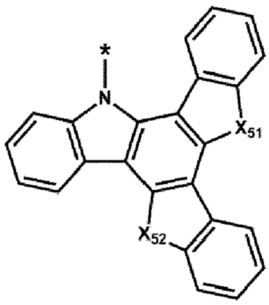

2-60

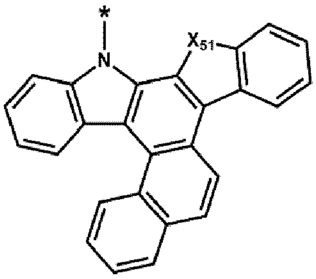

2-61

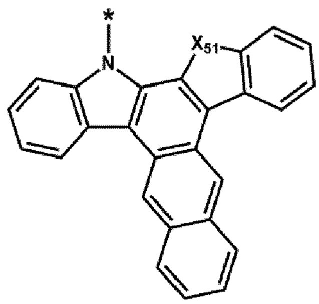

2-62

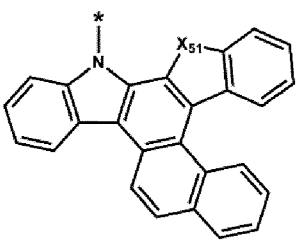

2-63

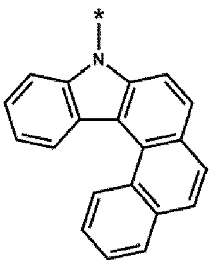

2-64

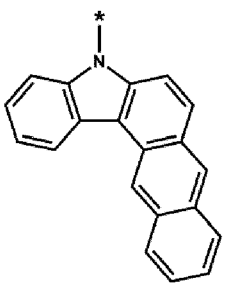

2-65

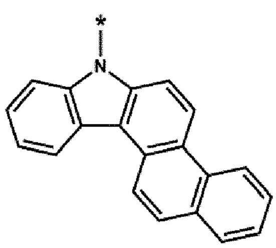

2-66

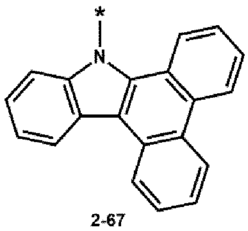
2-67

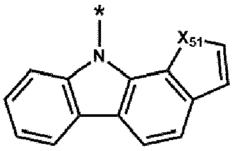
2-68

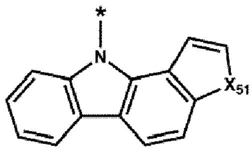
2-69

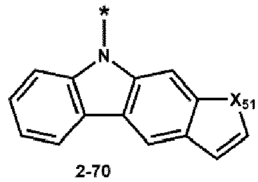
2-70

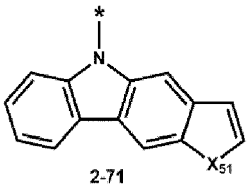
2-71

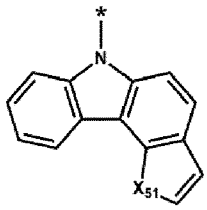
2-72

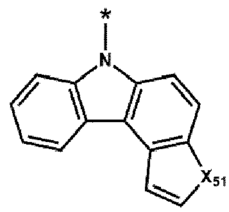
2-73

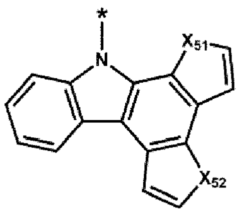
2-74

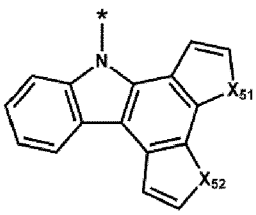
2-75

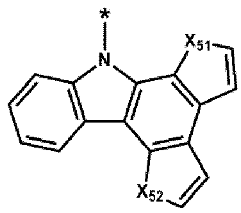
2-76

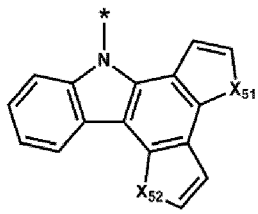
2-77

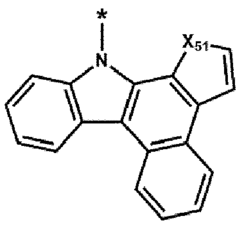
2-78

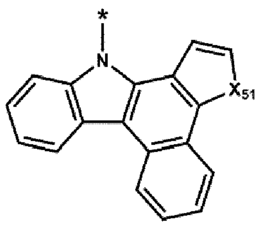
2-79

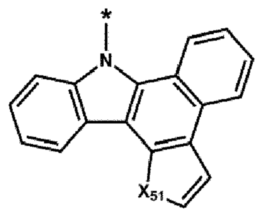
2-80

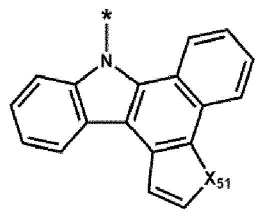
2-81

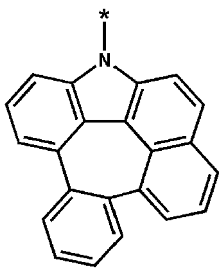
2-82

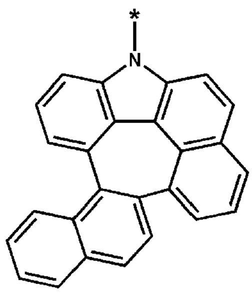
2-83

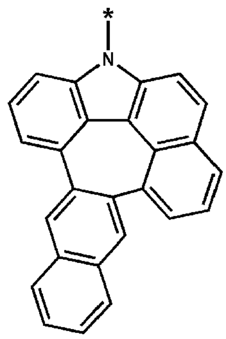
2-84

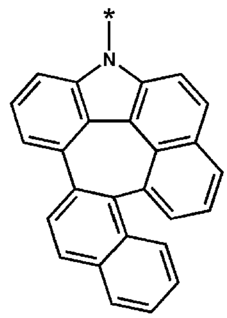
2-85

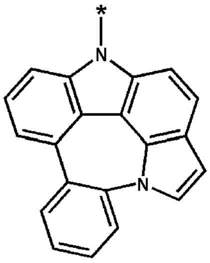
2-86

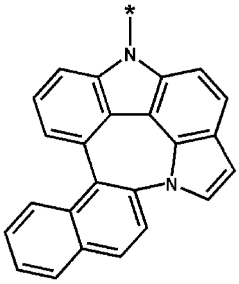
2-87

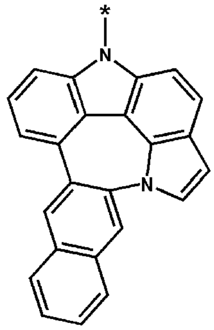
2-88

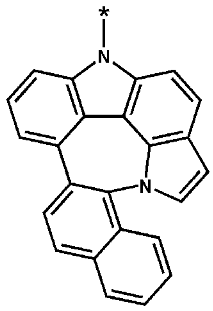
2-89

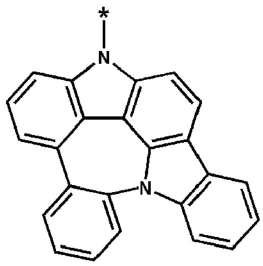
2-90

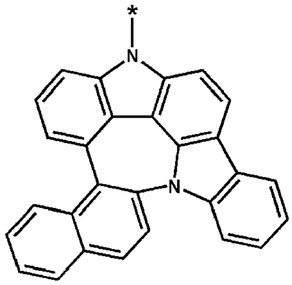
2-91

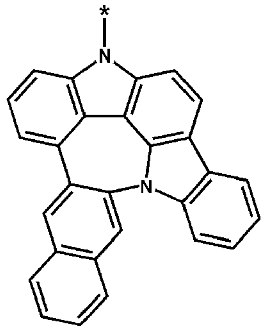
2-92

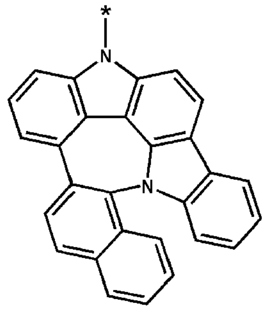
2-93

In Formulae 2-1 to 2-93,

$X_{51}$ may be O, S, N($R_{51a}$), C($R_{51a}$)($R_{51b}$), or Si($R_{51a}$)($R_{51b}$),
X52 may be O, S, N($R_{52a}$), C(R52a)(R52b), or Si(R52a)(R52b),
$R_{51a}$, $R_{51b}$, $R_{52a}$, and $R_{52b}$ are the same as described in connection with $R_{51}$, and
* indicates a binding site to $Ar_1$ or $Ar_2$ in Formula 5 or 5(1).

In one or more embodiments, Het1 in Formula 7 and Het1 and Het3 in Formula 7(1) may each independently be a group derived from one of Formulae 3-1 to 3-40:

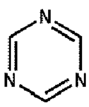
3-1

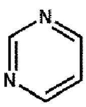
3-2

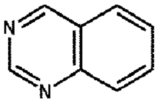
3-3

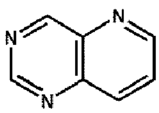
3-4

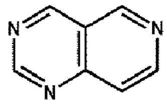
3-5

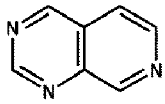
3-6

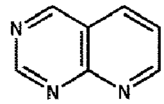
3-7

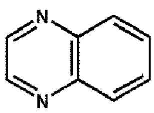
3-8

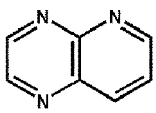
3-9

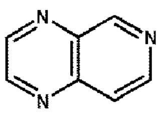
3-10

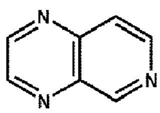
3-11

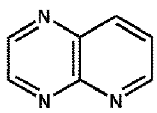
3-12

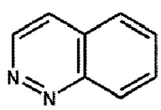
3-13

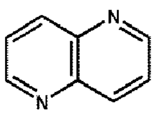
3-14

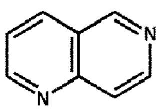
3-15

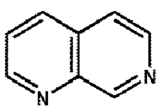
3-16

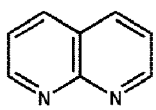
3-17

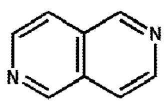
3-18

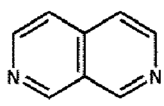
3-19

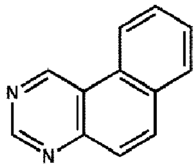
3-20

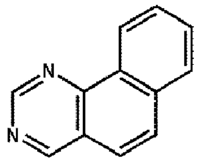
3-21

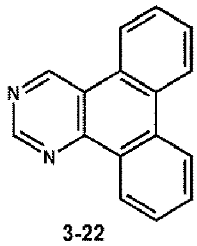
3-22

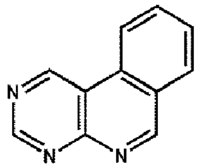
3-23

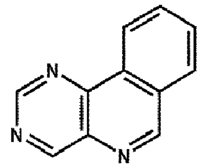
3-24

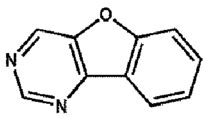
3-25

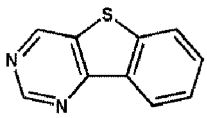
3-26

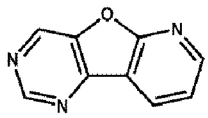
3-27

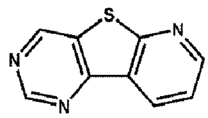
3-28

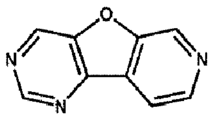
3-29

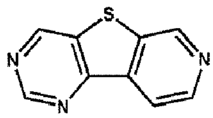
3-30

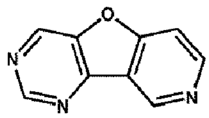
3-31

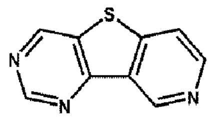
3-32

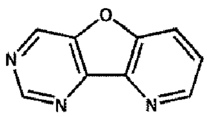
3-33

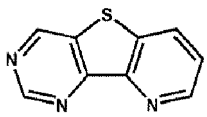
3-34

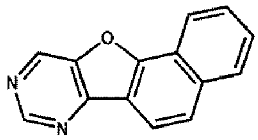
3-35

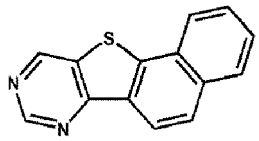
3-36

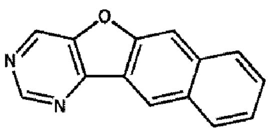
3-37

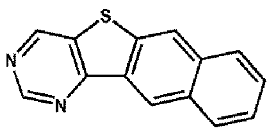
3-38

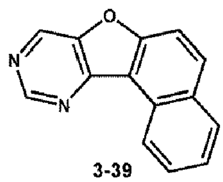
3-39

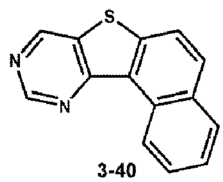
3-40

In one or more embodiments, a group represented by

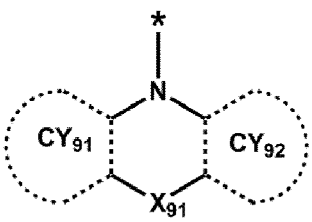

in Formula 9 may be a group represented by one of Formulae 9-1 to 9-6:

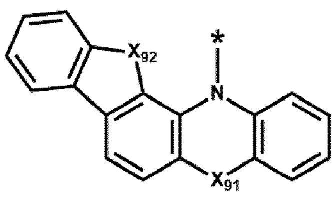
9-1

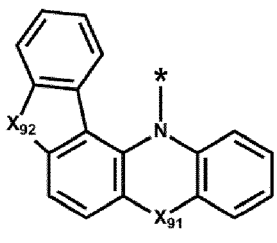
9-2

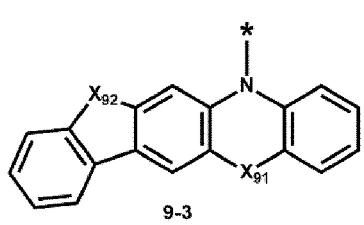
9-3

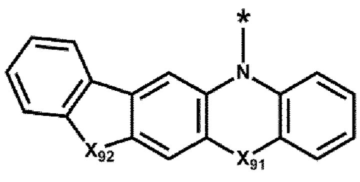

9-4

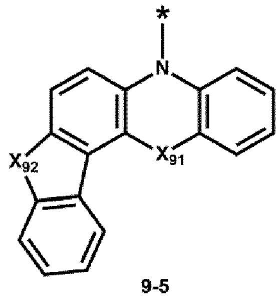

9-5

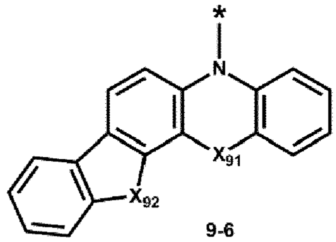

9-6

In Formulae 9-1 to 9-6,

$X_{91}$ is the same as described above,
$X_{92}$ may be O, S, $N(R_{92a})$, $C(R_{92a})(R_{92b})$, or $Si(R_{92a})(R_{92b})$, and
* indicates a binding site to an adjacent atom.

In one or more embodiments, $X_{101}$ to $X_{103}$ in Formula 9 may be N.

a1 and a2 in Formulae 5 and 5(1) may indicate the number of $Ar_1$(s) and the number of $Ar_2$(s), respectively, and may each independently be an integer from 0 to 5 (for example, 0, 1, or 2), and the sum of a1 and a2 may be 1 or more. When a1 is 2 or more, two or more of $Ar_1$(s) may be identical to or different from each other, and when a2 is 2 or more, two or more of $Ar_2$(s) may be identical to each other or different from each other. When a1 is 0, $*-(Ar_1)_{a1}-*'$ in Formula 2 may be a single bond.

a11 and m in Formulae 7 and 7(1) indicate the number of $Ar_{11}$(s) and the number of $*-(Ar_{11})_{a11}-(R_{70})_{a70}$ (s), respectively, and may each independently be an integer from 1 to 10. When a11 is 2 or more, two or more of $Ar_{11}$(s) may be identical to or different from each other, and when m is 2 or more, two or more of $*-(Ar_{11})_{a11}-(R_{70})_{a70}$(s) may be identical to or different from each other.

In one or more embodiments, a11 and m in Formulae 7 and 7(1) may each independently be an integer from 1 to 3.

a91 in Formula 9 indicates the number of $Ar_{91}$(s), and may be an integer from 1 to 10.

$R_{50}$ to $R_{54}$, $R_{50a}$ to $R_{50d}$, $R_{51a}$, $R_{51b}$, $R_{52a}$, $R_{52b}$, $R_{70}$, $R_{73}$, $R_{80}$, $R_{83}$, $R_{90}$ to $R_{92}$, $R_{91a}$, $R_{91b}$, $R_{92a}$, $R_{92b}$, and $R_{101}$ to $R_{103}$ used herein may each independently be hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$heterocycloalkenyl group, a substituted or unsubstituted $C_6$-$C_{60}$ aryl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted monovalent non-aromatic condensed polycyclic group, a substituted or unsubstituted monovalent non-aromatic condensed heteropolycyclic group, $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or $-P(Q_8)(Q_9)$. $Q_1$ to $Q_9$ are the same as described in the present specification.

For example, $R_{50}$ to $R_{54}$, $R_{50a}$ to $R_{50d}$, $R_{51a}$, $R_{51b}$, $R_{52a}$, $R_{52b}$, $R_{70}$, $R_{73}$, $R_{80}$, $R_{83}$, $R_{90}$ to $R_{92}$, $R_{91a}$, $R_{91b}$, $R_{92a}$, $R_{92b}$, and $R_{101}$ to $R_{103}$ may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, $-SF_5$, a $C_1$-$C_{20}$ alkyl group, or a $C_1$-$C_{20}$ alkoxy group;

a $C_1$-$C_{20}$ alkyl group or a $C_1$-$C_{20}$ alkoxy group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_1$-$C_{20}$ alkyl group, a fluorinated $C_1$-$C_{20}$ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (norbornanyl group), a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a pyridinyl group, a pyrimidinyl group, or any combination thereof; a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterated $C_1$-$C_{20}$ alkyl group, a fluorinated $C_1$-$C_{20}$ alkyl group, a $C_1$-$C_{20}$ alkoxy group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a (C1-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or $-N(Q_1)(Q_2)$, $-Si(Q_3)(Q_4)(Q_5)$, $-Ge(Q_3)(Q_4)(Q_5)$, $-B(Q_6)(Q_7)$, $-P(=O)(Q_8)(Q_9)$, or - $P(Q_8)(Q_9)$,
wherein $Q_1$ to $Q_9$ are each independently:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or - $CD_2CDH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{20}$ alkyl group, a phenyl group, or any combination thereof.

b51 to b54, b7, b73, b8, b83, b91, and b92 indicates the numbers of $R_{51}$ to $R_{54}$, $R_{70}$, $R_{73}$, $R_{80}$, $R_{83}$, $R_{91}$, and $R_{92}$, respectively, and may each independently be an integer from 0 to 20. For example, b51 to b54, b7, b73, b8, b83, b91, and b92 may each independently be an integer from 0 to 10. when b51 is 2 or more, two or more of $R_{51}$(s) may be identical to or different from each other, when b52 is 2 or more, two or more of $R_{52}$(s) may be identical to or different from each other, when b53 is 2 or more, two or more of $R_{53}$(s) may be identical to or different from each

other, when b54 is 2 or more, two or more of $R_{54}$(s) may be identical to or different from each other, when b7 is 2 or more, two or more of $R_{70}$(s) may be identical to or different from each other, when b73 is 2 or more, two or more of $R_{73}$(s) may be identical to or different from each other, when b8 is 2 or more, two or more of $R_{80}$(s) may be identical to or different from each other, when b83 is 2 or more, two or more of $R_{83}$(s) may be identical to or different from each other, when b91 is 2 or more, two or more of $R_{91}$(s) may be identical to or different from each other, when b92 is 2 or more, two or more of $R_{92}$(s) may be identical to or different from each other.

For example, $R_{50}$ to $R_{54}$, $R_{50a}$ to $R_{50d}$, $R_{51a}$, $R_{51b}$, $R_{52a}$, $R_{52b}$, $R_{70}$, $R_{73}$, $R_{80}$, $R_{83}$, $R_{90}$ to $R_{92}$, $R_{91a}$, $R_{91b}$, $R_{92a}$, $R_{92b}$, and $R_{101}$ to $R_{103}$ may each independently be:

hydrogen or deuterium;
a $C_1$-$C_{20}$ alkyl group or a $C_1$-$C_{20}$ alkoxy group, each substituted or unsubstituted with deuterium, a phenyl group, a naphthyl group, an anthracenyl group, a phenanthrenyl group, a triphenylenyl group, a fluorenyl group, a di($C_1$-$C_{10}$ alkyl)fluorenyl group, a di($C_6$-$C_{60}$ aryl)fluorenyl group, a dibenzosilolyl group, a di($C_1$-$C_{10}$ alkyl)dibenzosilolyl group, a di($C_6$-$C_{60}$ aryl)dibenzosilolyl group, a carbazolyl group, a ($C_1$-$C_{10}$ alkyl)carbazolyl group, a ($C_6$-$C_{60}$ aryl)carbazolyl group, a dibenzofuranyl group, a dibenzothiophenyl group, a biphenyl group, a terphenyl group, -N($Q_{31}$)($Q_{32}$), or any combination thereof;
a π electron-rich $C_3$-$C_{60}$ cyclic group, unsubstituted or substituted with deuterium, a $C_1$-$C_{20}$ alkyl group, a $C_1$-$C_{20}$ alkoxy group, a phenyl group, a naphthyl group, an anthracenyl group, a phenanthrenyl group, a triphenylenyl group, a fluorenyl group, a di($C_1$-$C_{10}$ alkyl)fluorenyl group, a di($C_6$-$C_{60}$ aryl)fluorenyl group, a dibenzosilolyl group, a di($C_1$-$C_{10}$ alkyl)dibenzosilolyl group, a di($C_6$-$C_{60}$ aryl)dibenzosilolyl group, a carbazolyl group, a ($C_1$-$C_{10}$ alkyl)carbazolyl group, a ($C_6$-$C_{60}$ aryl)carbazolyl group, a dibenzofuranyl group, a dibenzothiophenyl group, a biphenyl group, a terphenyl group, -N($Q_{31}$)($Q_{32}$), or any combination thereof; or -N($Q_1$)($Q_2$).

In this regard, $Q_1$, $Q_2$, $Q_{31}$, and $Q_{32}$ are the same as described in the present specification.
In one or more embodiments, $R_{50}$ to $R_{54}$, $R_{50a}$ to $R_{50d}$, $R_{51a}$, $R_{51b}$, $R_{52a}$, $R_{52b}$, $R_{70}$, $R_{73}$, $R_{80}$, $R_{83}$, $R_{90}$ to $R_{92}$, $R_{91a}$, $R_{91b}$, $R_{92a}$, $R_{92b}$, and $R_{101}$ to $R_{103}$ may each independently be:

hydrogen or deuterium;
a $C_1$-$C_{20}$ alkyl group unsubstituted or substituted with deuterium, a phenyl group, a naphthyl group, an anthracenyl group, a phenanthrenyl group, a triphenylenyl group, a fluorenyl group, a di($C_1$-$C_{10}$ alkyl)fluorenyl group, a di($C_6$-$C_{60}$ aryl)fluorenyl group, a dibenzosilolyl group, a di($C_1$-$C_{10}$ alkyl)dibenzosilolyl group, a di($C_6$-$C_{60}$ aryl)dibenzosilolyl group, a carbazolyl group, a ($C_1$-$C_{10}$ alkyl)carbazolyl group, a ($C_6$-$C_{60}$ aryl)carbazolyl group, a dibenzofuranyl group, a dibenzothiophenyl group, a biphenyl group, a terphenyl group, -N($Q_{31}$)($Q_{32}$), or any combination thereof; or
a phenyl group, a naphthyl group, an anthracenyl group, a phenanthrenyl group, a triphenylenyl group, a fluorenyl group, a dibenzosilolyl group, a carbazolyl group, a dibenzofuranyl group, or a dibenzothiophenyl group, each unsubstituted or substituted with deuterium, a $C_1$-$C_{20}$ alkyl group, a $C_1$-$C_{20}$ alkoxy group, a phenyl group, a naphthyl group, an anthracenyl group, a phenanthrenyl group, a triphenylenyl group, a fluorenyl group, a di($C_1$-$C_{10}$ alkyl)fluorenyl group, a di($C_6$-$C_{60}$ aryl)fluorenyl group, a dibenzosilolyl group, a di($C_1$-$C_{10}$ alkyl)dibenzosilolyl group, a di($C_6$-$C_{60}$ aryl)dibenzosilolyl group, a carbazolyl group, a ($C_1$-$C_{10}$ alkyl)carbazolyl group, a ($C_6$-$C_{60}$ aryl)carbazolyl group, a dibenzofuranyl group, a dibenzothiophenyl group, a biphenyl group, a terphenyl group, or any combination thereof.

In this regard, $Q_{31}$ and $Q_{32}$ are the same as described in the present specification.
In Formulae 5, 7, and 9, 1) two or more of $R_{51}$(s) may optionally be combined with each other to form a $C_5$-$C_{60}$ carbocyclic group unsubstituted or substituted with at least one $R_{10a}$ or a $C_1$-$C_{60}$ heterocyclic group unsubstituted or substituted with at least one $R_{10a}$, 2) two or more of $R_{52}$(s) may optionally be combined with each other to form a $C_5$-$C_{60}$ carbocyclic group unsubstituted or substituted with at least one $R_{10a}$ or a $C_1$-$C_{60}$ heterocyclic group unsubstituted or substituted with at least one $R_{10a}$, and 3) two or more of ring $CY_{51}$, ring $CY_{52}$, $R_{51}$, and $R_{52}$ may optionally be combined with each other to form a $C_5$-$C_{60}$ carbocyclic group unsubstituted or substituted with at least one $R_{10a}$ or a $C_1$-$C_{60}$ heterocyclic group unsubstituted or substituted with at least one $R_{10a}$. $R_{10a}$ may be the same as described in connection with $R_1$.

Description of examples of compound

In one or more embodiments, the dopants included in the first emission layer and the second emission layer may be one of compounds of Group 1-1 to Group 1-7: Group 1-1

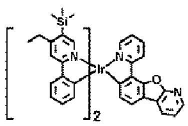
1

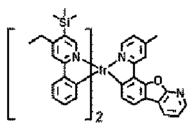
2

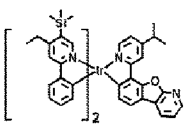
3

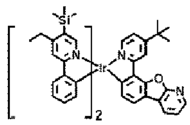
4

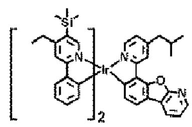
5

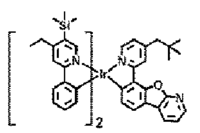
6

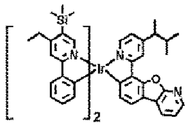
7

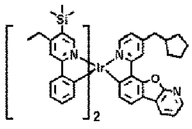
8

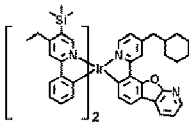
9

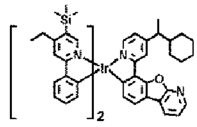
10

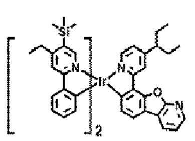
11

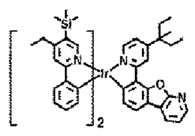
12

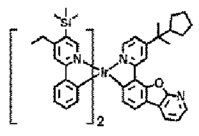
13

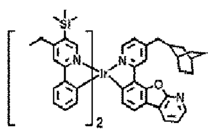
14

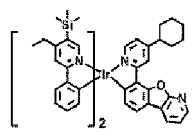
15

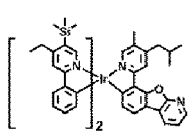
16

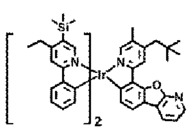
17

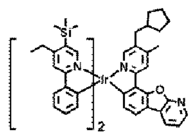
18

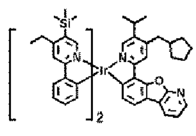
19

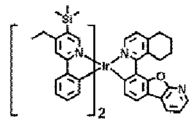
20

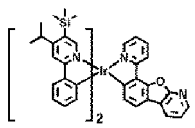
21

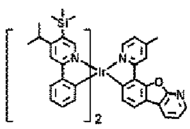
22

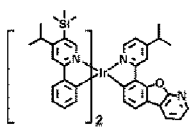
23

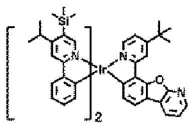
24

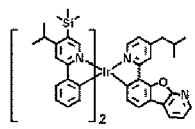
25

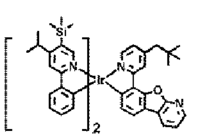
26

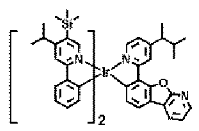
27

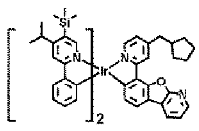
28

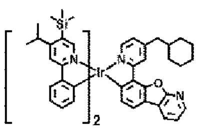
29

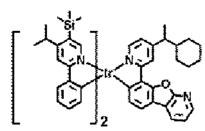
30

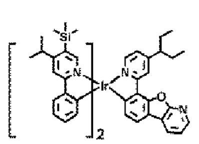
31

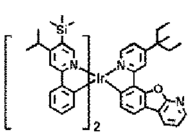
32

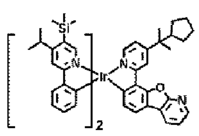
33

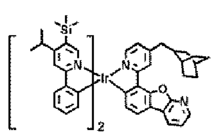
34

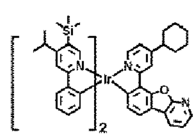
35

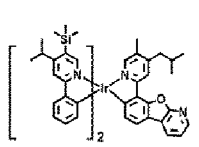
36

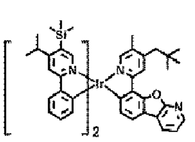
37

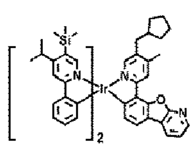
38

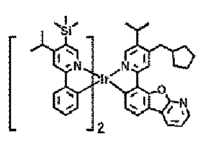
39

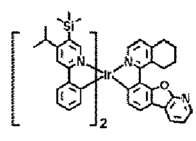
40

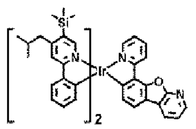
41
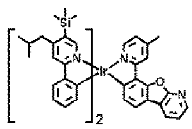
42
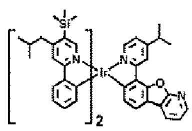
43
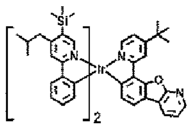
44
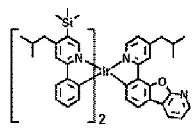
45

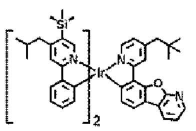
46
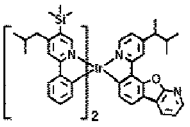
47
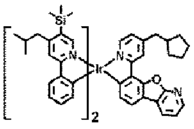
48
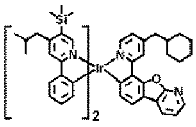
49
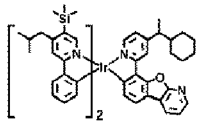
50

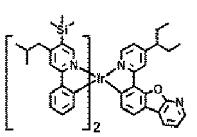
51
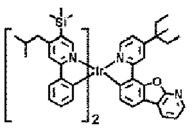
52
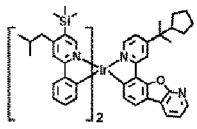
53
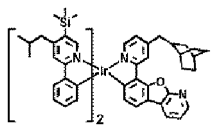
54
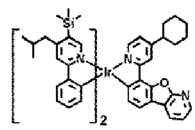
55

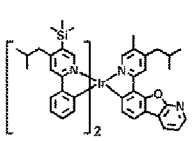
56
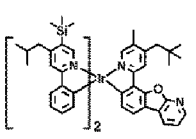
57
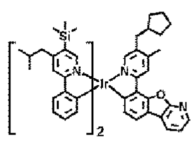
58
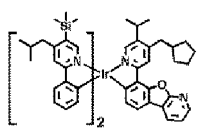
59
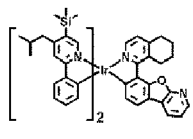
60

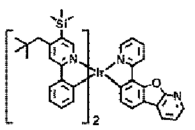
61
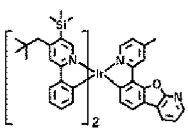
62
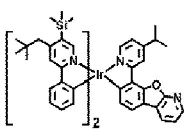
63
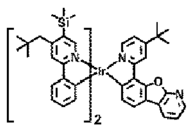
64
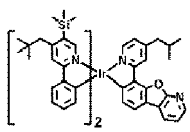
65

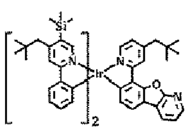
66
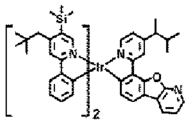
67
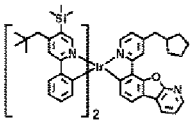
68
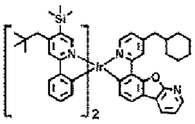
69
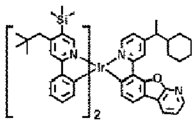
70

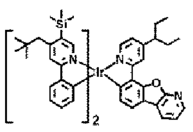
71
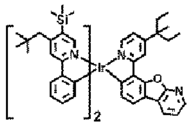
72
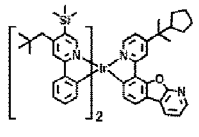
73
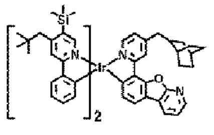
74
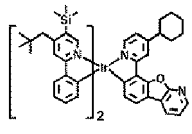
75

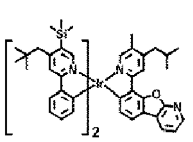
76
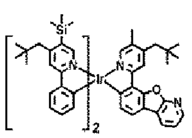
77
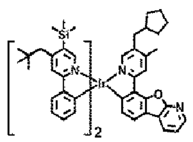
78
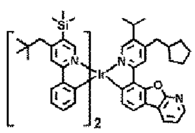
79
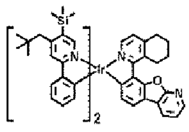
80

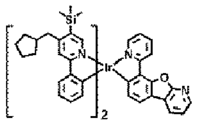
81
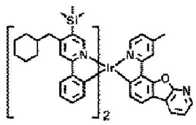
82
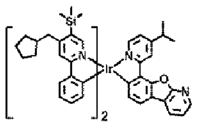
83
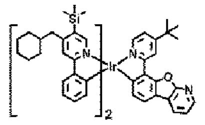
84
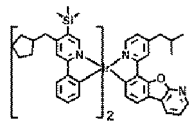
85
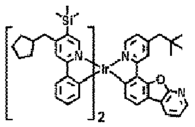
86
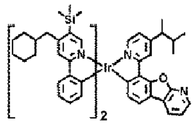
87
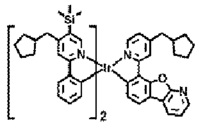
88
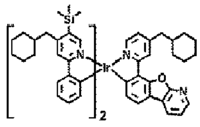
89
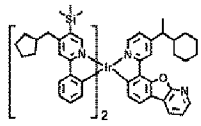
90
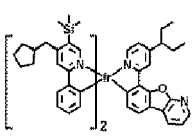
91
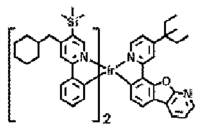
92
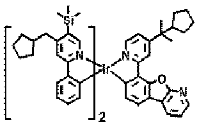
93
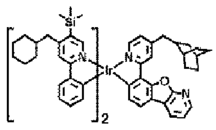
94
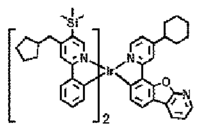
95
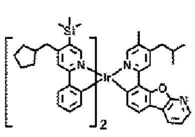
96
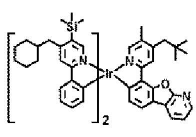
97
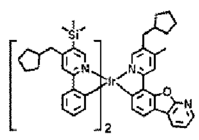
98
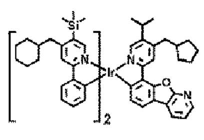
99
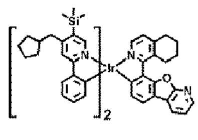
100
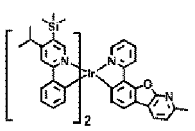
101
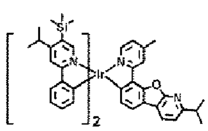
102
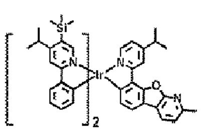
103
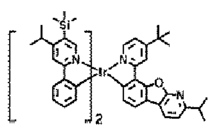
104
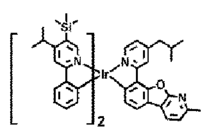
105
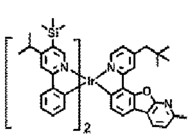
106
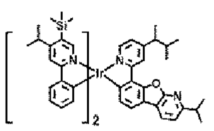
107
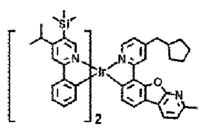
108
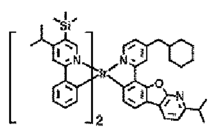
109
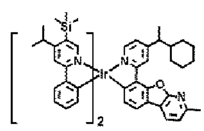
110
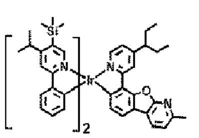
111
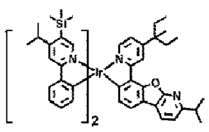
112
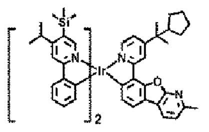
113
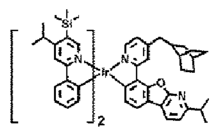
114
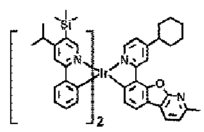
115
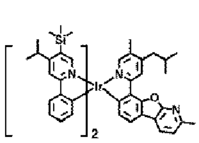
116
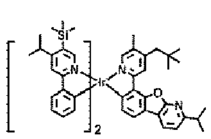
117
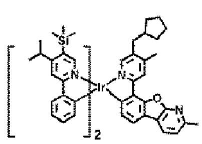
118
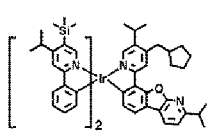
119
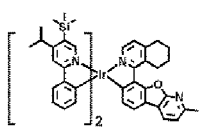
120

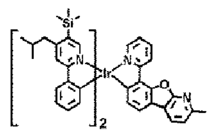
121

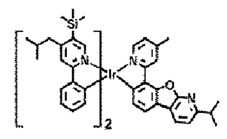
122

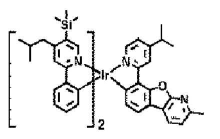
123

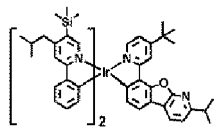
124

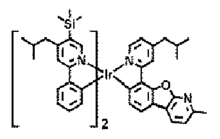
125

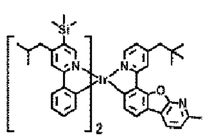
126

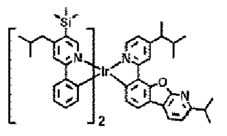
127

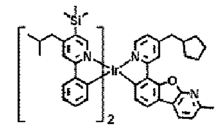
128

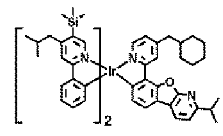
129

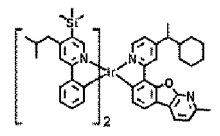
130

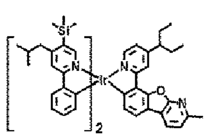
131

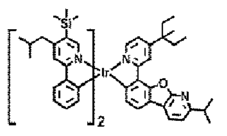
132

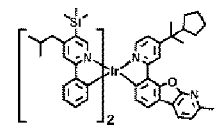
133

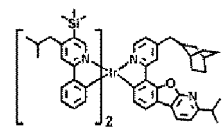
134

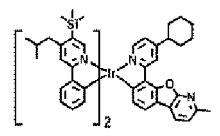
135

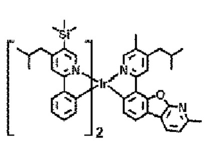
136

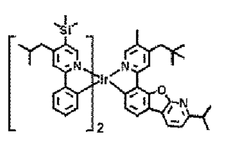
137

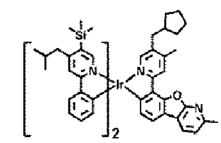
138

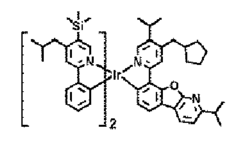
139

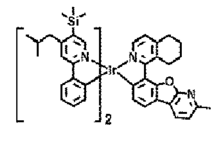
140

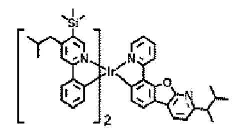
141

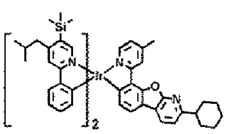
142

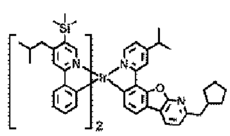
143

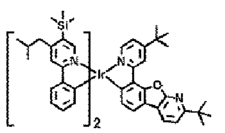
144

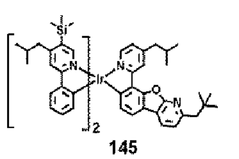
145

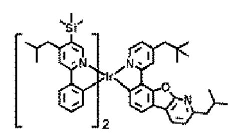
146

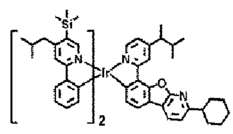
147

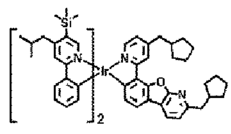
148

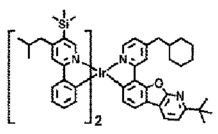
149

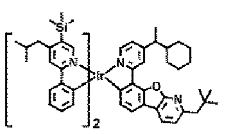
150

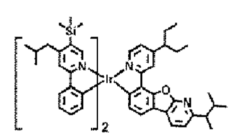
151

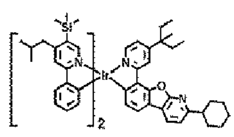
152

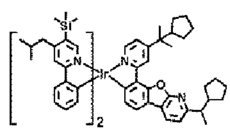
153

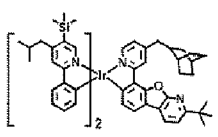
154

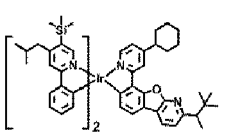
155

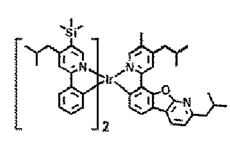
156

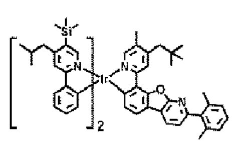
157

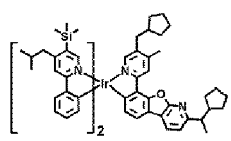
158

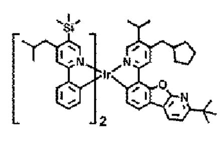
159

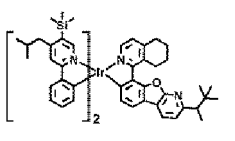
160

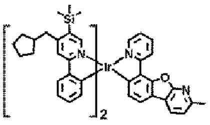
161

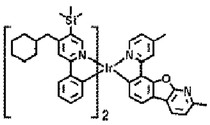
162

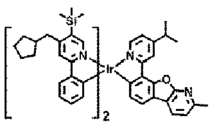
163

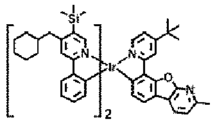
164

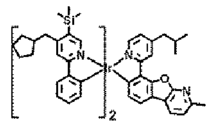
165

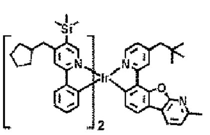
166

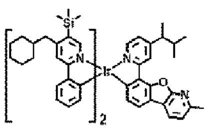
167

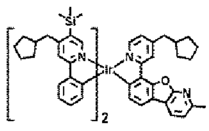
168

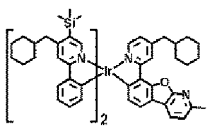
169

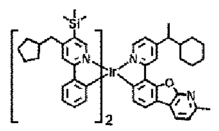
170

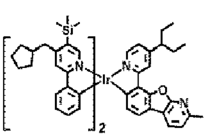
171

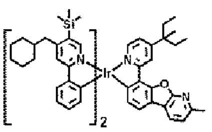
172

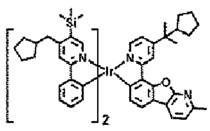
173

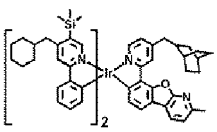
174

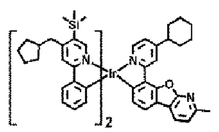
175

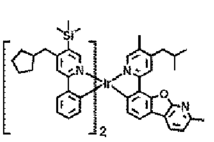
176

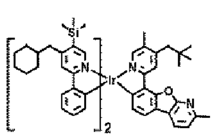
177

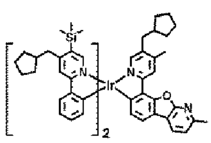
178

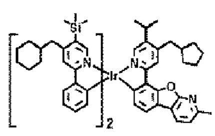
179

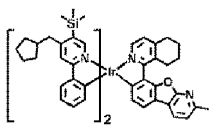
180

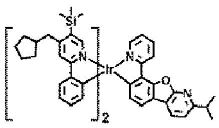
181

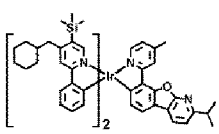
182

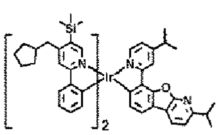
183

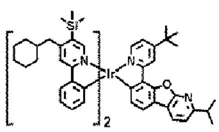
184

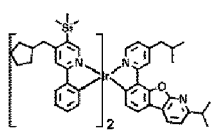
185

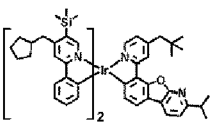
186

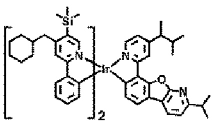
187

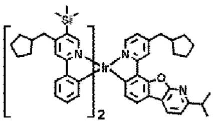
188

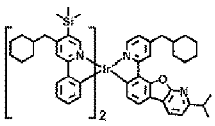
189

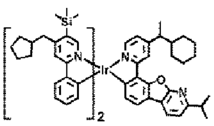
190

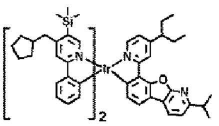
191

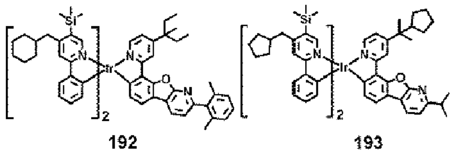
192

193

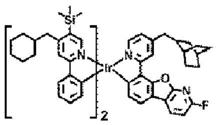
194

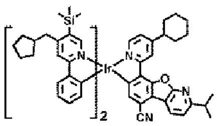
195

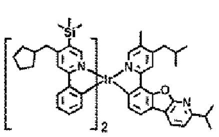
196

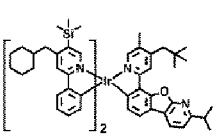
197

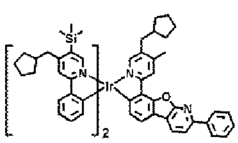
198

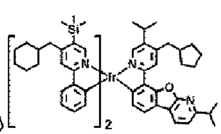
199

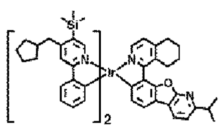
200

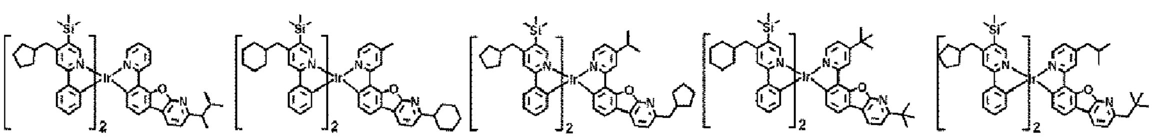
201

202

203

204

205

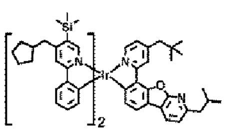
206
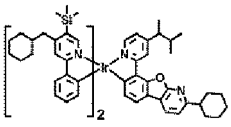
207
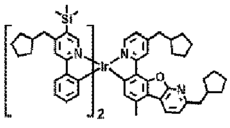
208
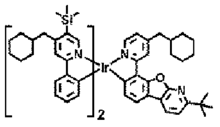
209
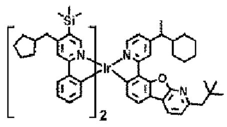
210

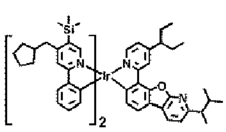
211
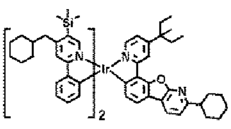
212
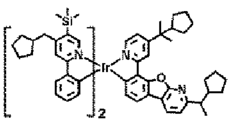
213
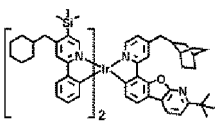
214
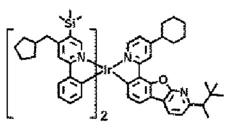
215

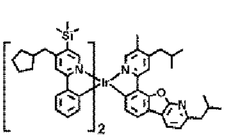
216
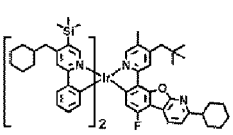
217
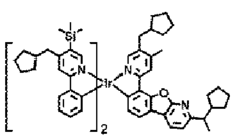
218
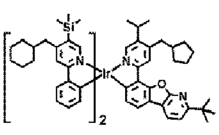
219
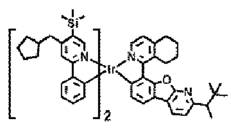
220

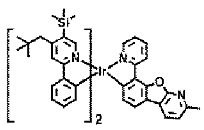
221
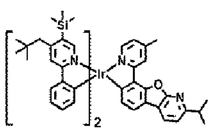
222
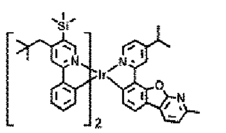
223
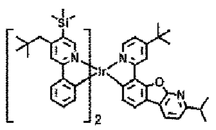
224
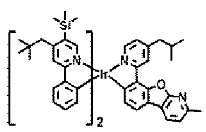
225

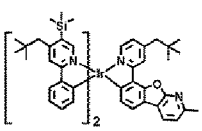
226
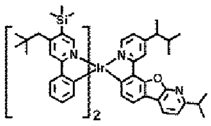
227
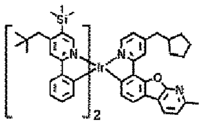
228
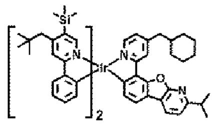
229
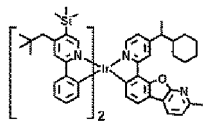
230

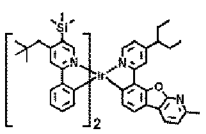
231
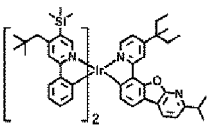
232
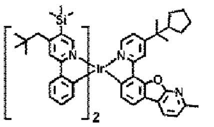
233
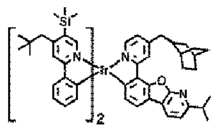
234
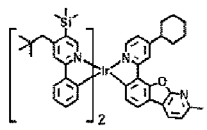
235

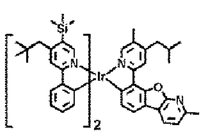
236
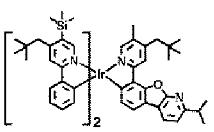
237
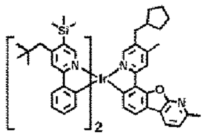
238
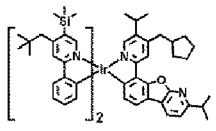
239
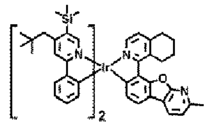
240

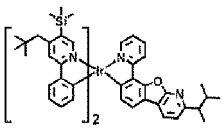
241
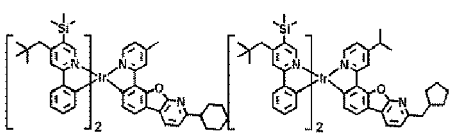
242
243
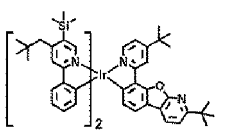
244
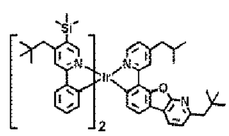
245

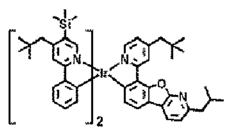
246

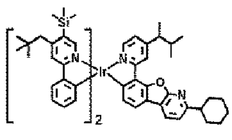
247

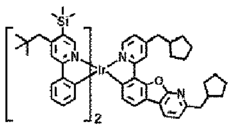
248

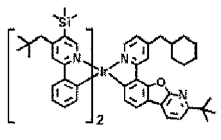
249

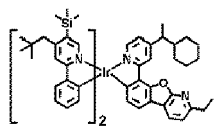
250

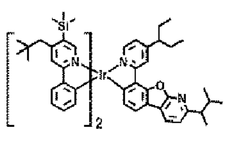
251

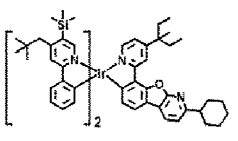
252

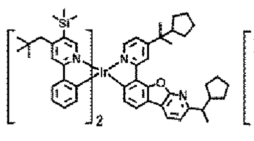
253

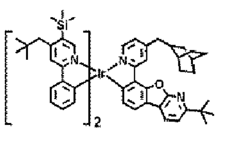
254

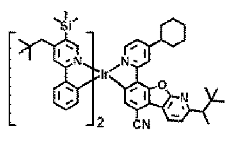
255

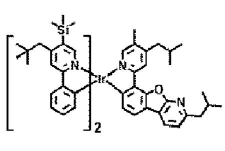
256

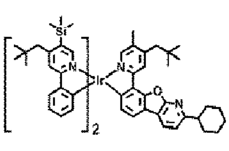
257

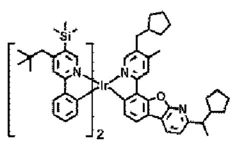
258

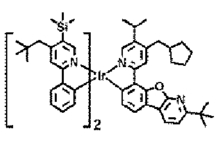
259

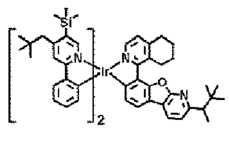
260

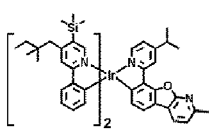
261

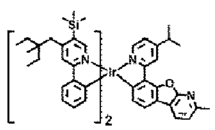
262

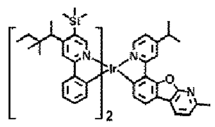
263

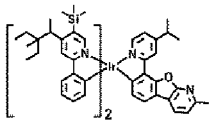
264

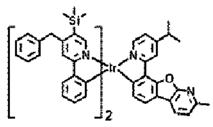
265

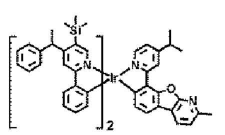
266

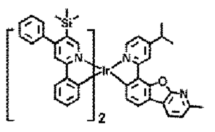
267

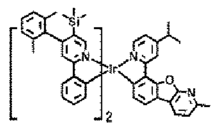
268

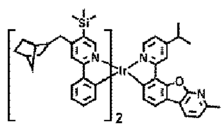
269

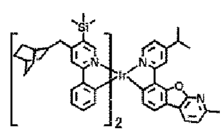
270

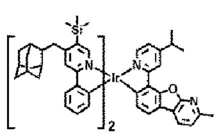
271

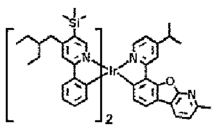
272

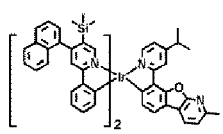
273

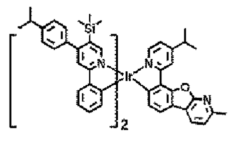
274

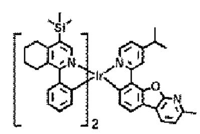
275

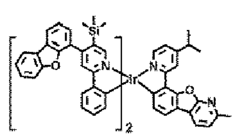
276

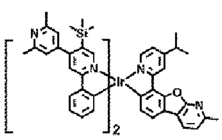
277

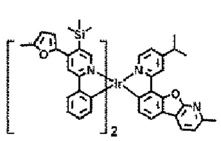
278

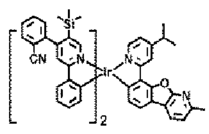
279

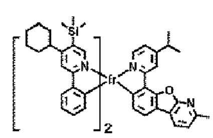
280

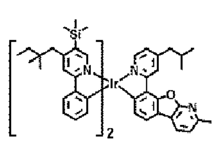
281

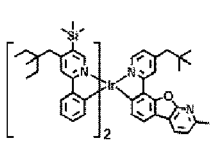
282

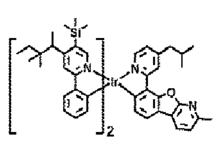
283

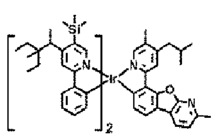
284

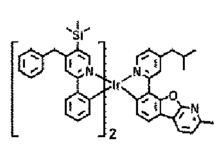
285

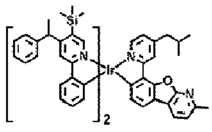
286
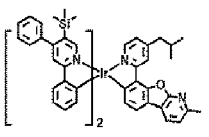
287
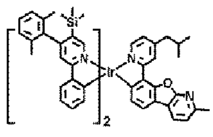
288
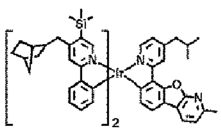
289
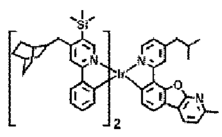
290

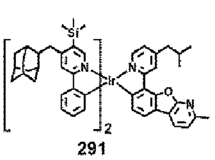
291
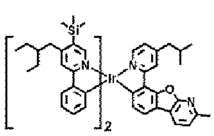
292
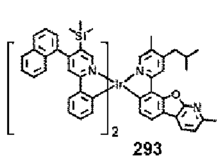
293
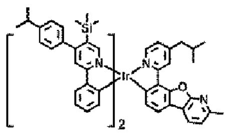
294
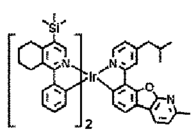
295

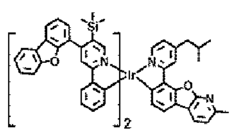
296
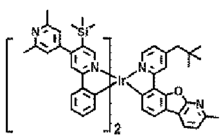
297
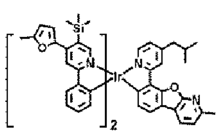
298
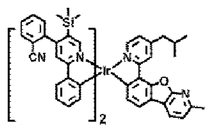
299
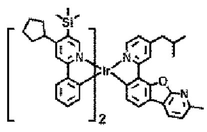
300

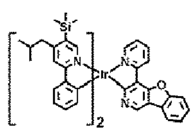
301
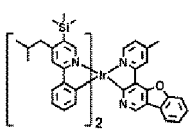
302
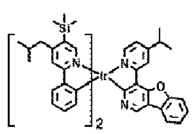
303
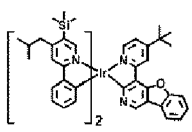
304
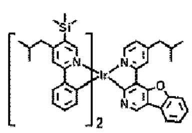
305

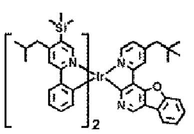
306
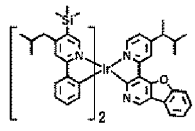
307
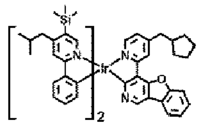
308
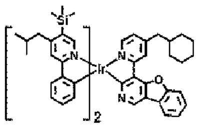
309
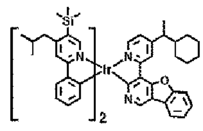
310

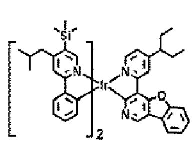
311
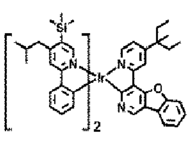
312
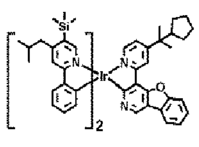
313
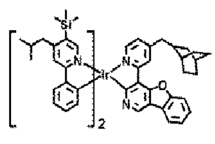
314
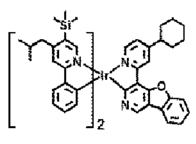
315

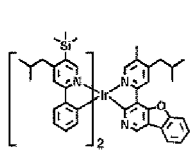
316
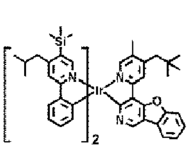
317
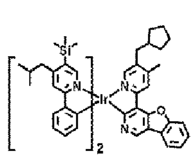
318
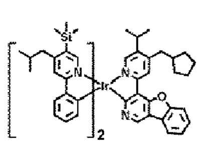
319
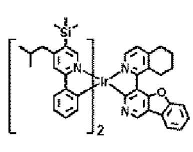
320

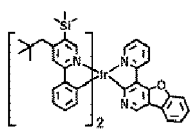
321
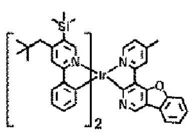
322
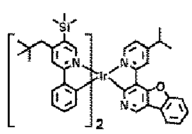
323
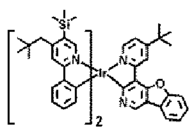
324
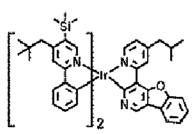
325

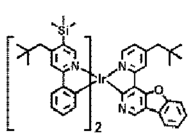
326
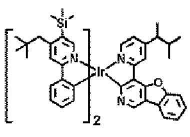
327
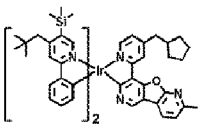
328
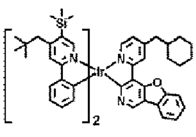
329
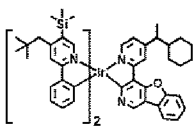
330

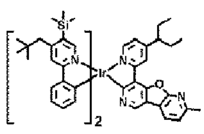
331
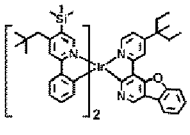
332
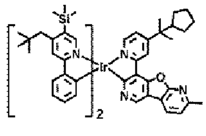
333
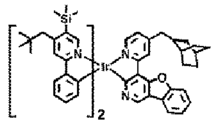
334
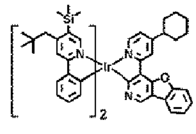
335

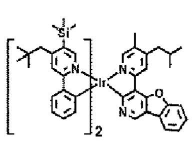
336
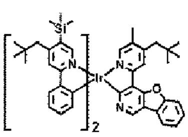
337
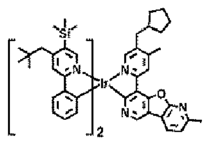
338
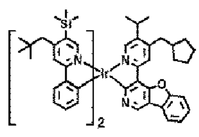
339
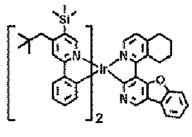
340

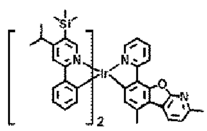
341
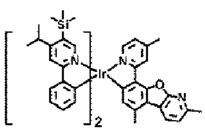
342
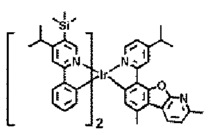
343
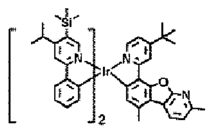
344
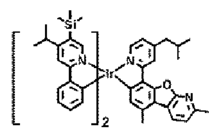
345

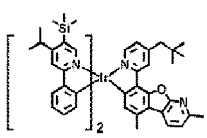
346
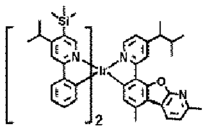
347
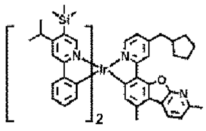
348
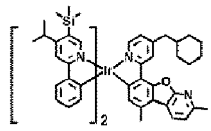
349
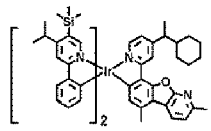
350

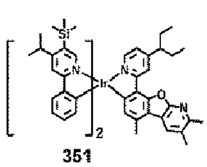
351
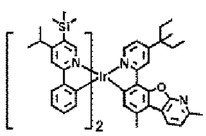
352
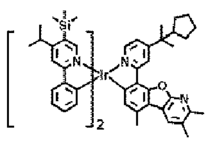
353
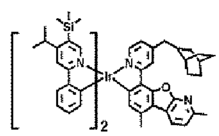
354
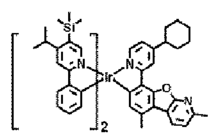
355

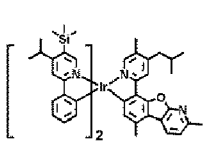
356
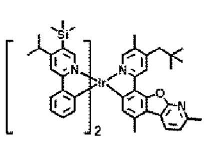
357
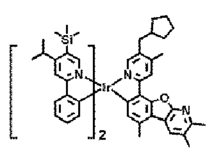
358
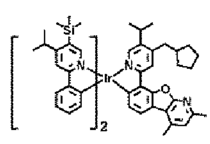
359
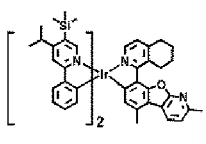
360

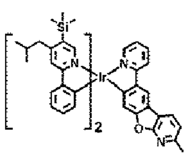
361
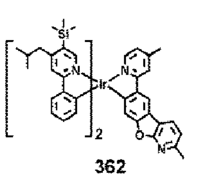
362
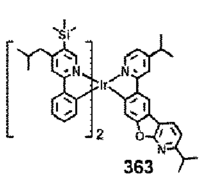
363
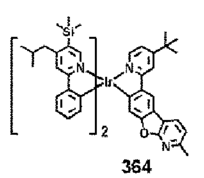
364
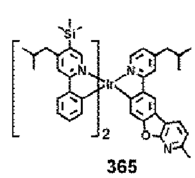
365

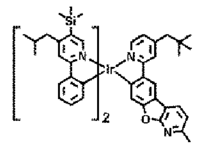 366 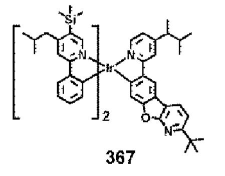 367 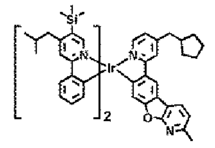 368 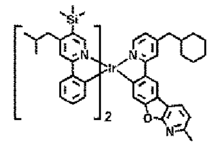 369 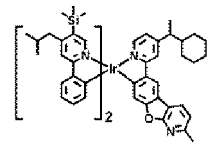 370

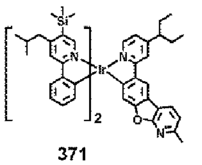 371 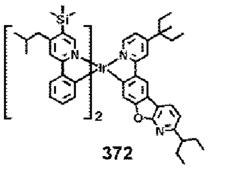 372 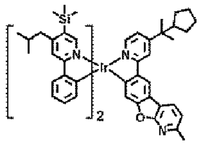 373 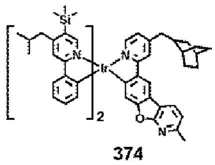 374 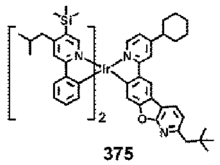 375

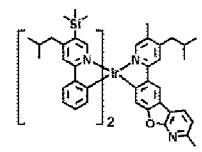 376 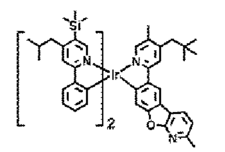 377 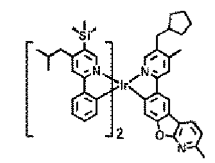 378 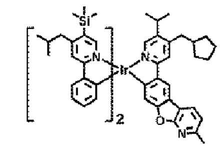 379 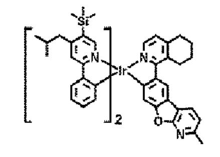 380

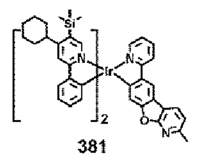 381 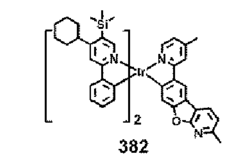 382 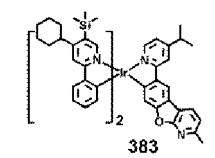 383 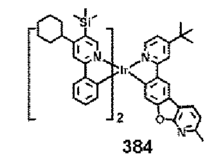 384 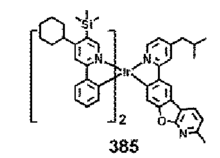 385

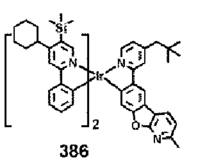 386 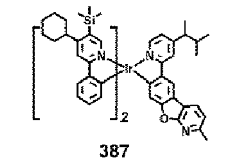 387 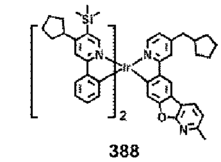 388 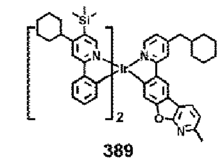 389 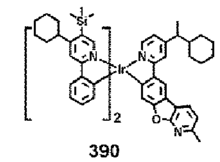 390

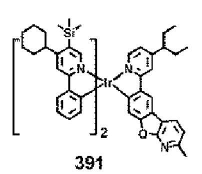 391 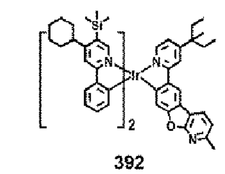 392 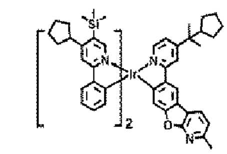 393 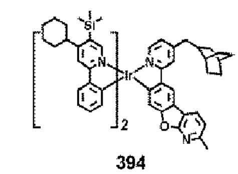 394 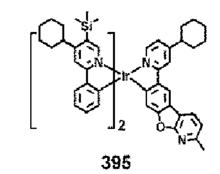 395

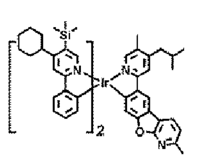 396 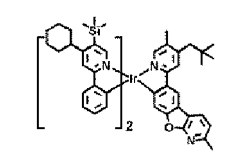 397 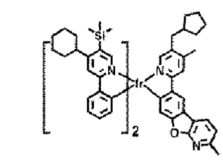 398 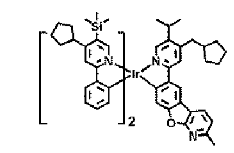 399 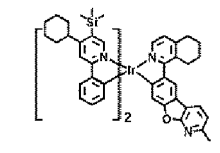 400

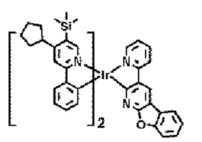 401 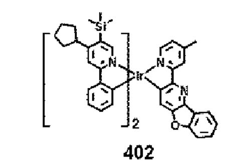 402 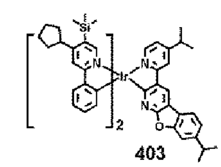 403 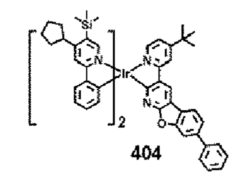 404 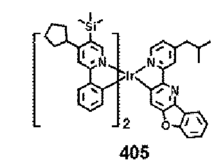 405

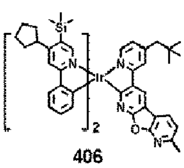
406
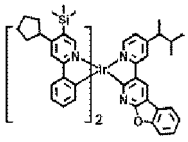
407
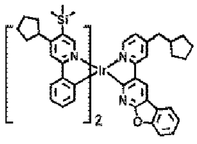
408
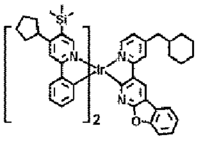
409
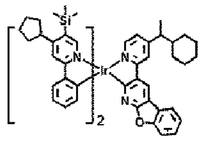
410

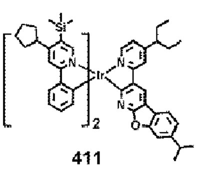
411
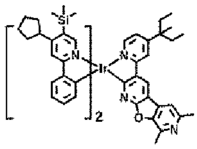
412
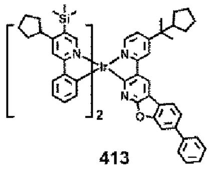
413
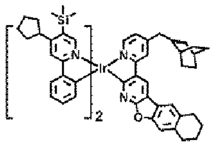
414
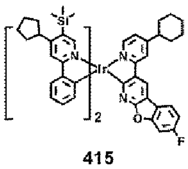
415

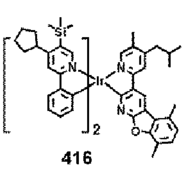
416
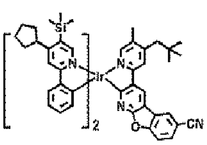
417
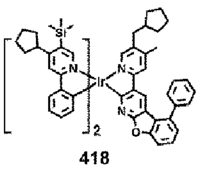
418
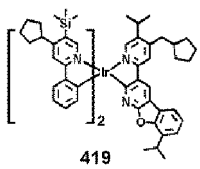
419
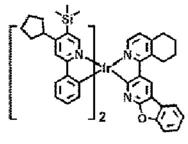
420

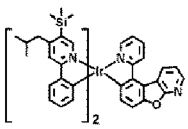
421
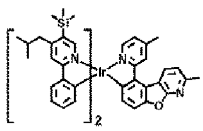
422
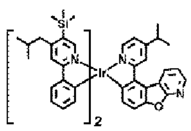
423
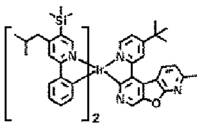
424
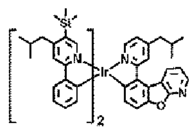
425

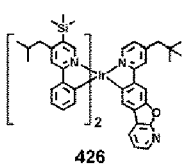
426
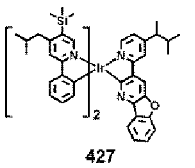
427
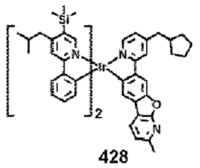
428
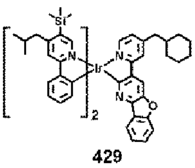
429
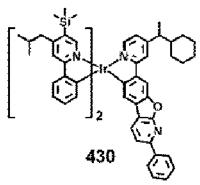
430

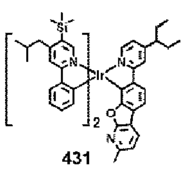
431
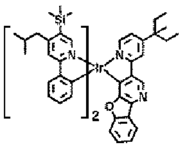
432
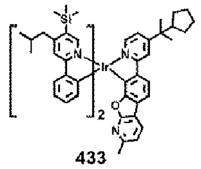
433
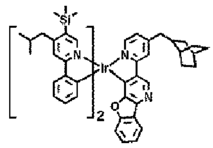
434
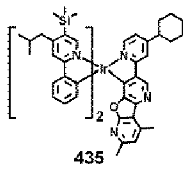
435

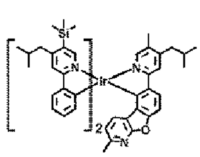
436
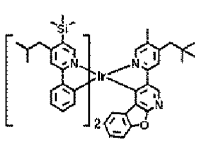
437
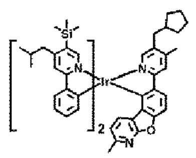
438
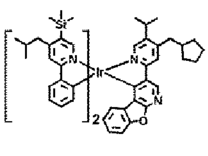
439
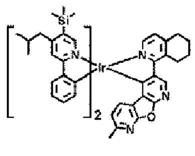
440

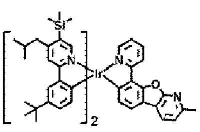
441
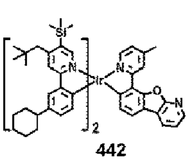
442
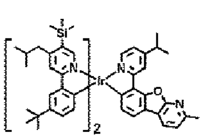
443
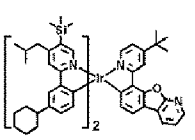
444
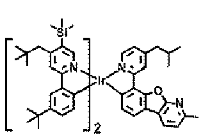
445

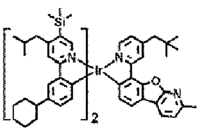
446
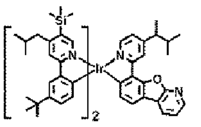
447
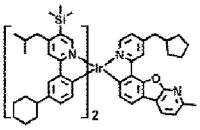
448
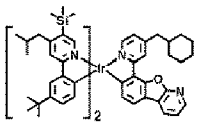
449
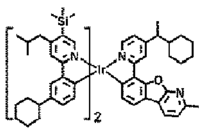
450

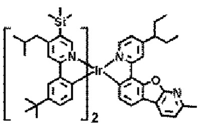
451
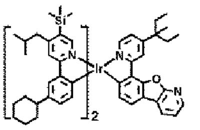
452
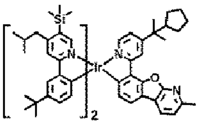
453
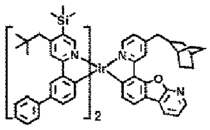
454
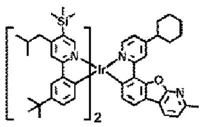
455

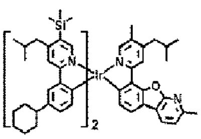
456
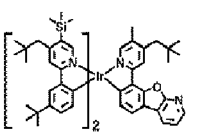
457
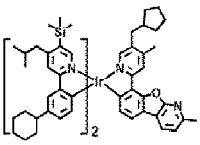
458
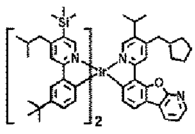
459
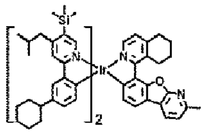
460

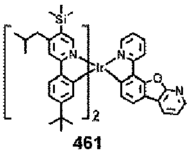
461
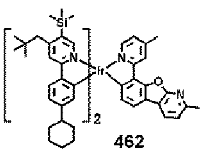
462
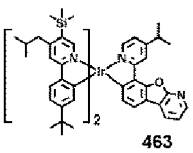
463
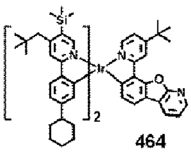
464
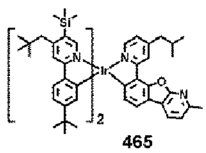
465

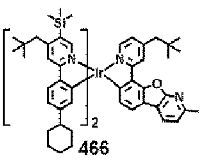
466
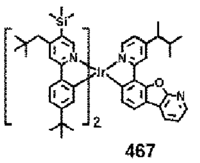
467
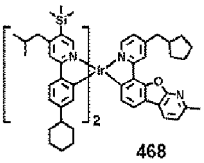
468
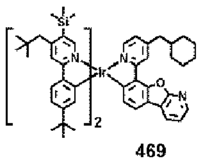
469
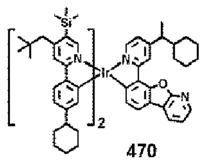
470

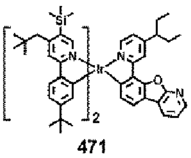
471
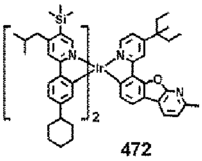
472
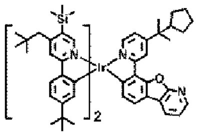
473
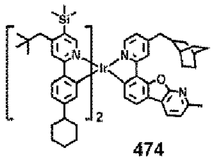
474
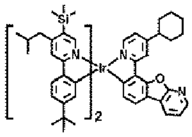
475

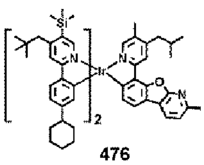
476
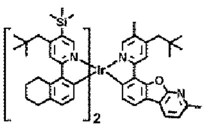
477
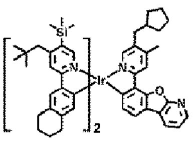
478
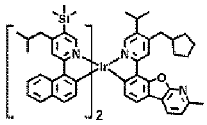
479
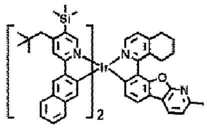
480

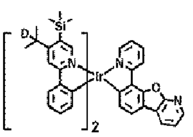
481
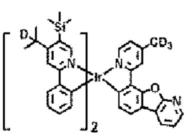
482
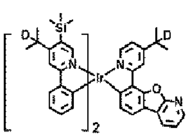
483
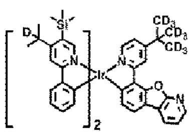
484
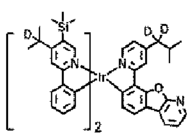
485

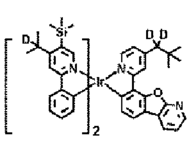
486
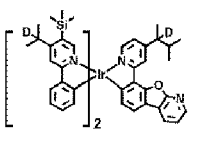
487
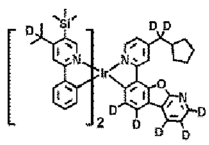
488
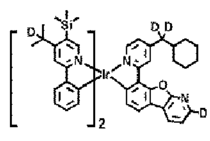
489
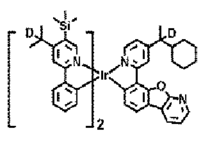
490

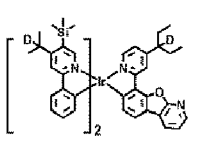
491
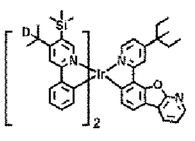
492
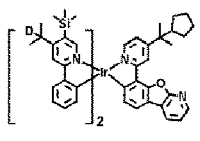
493
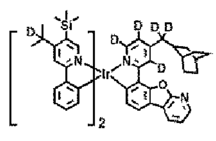
494
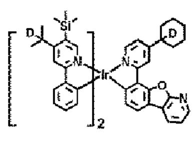
495

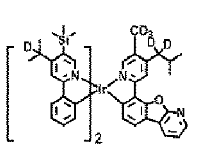
496
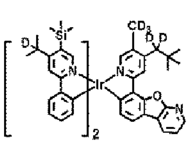
497
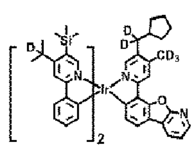
498
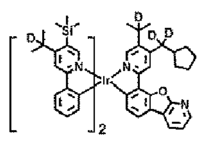
499
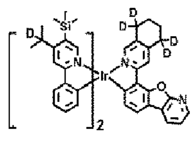
500

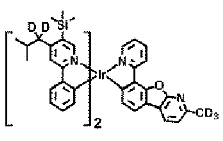
501
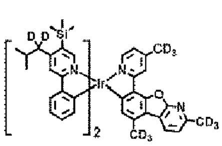
502
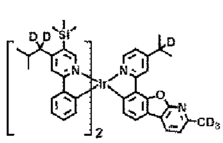
503
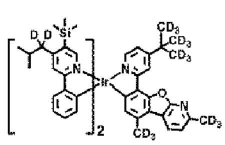
504
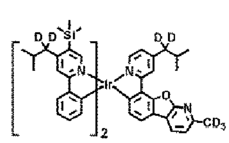
505

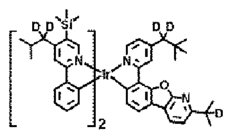
506
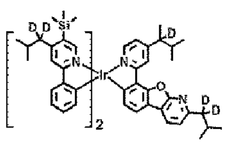
507
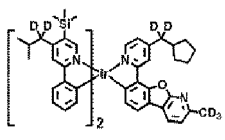
508
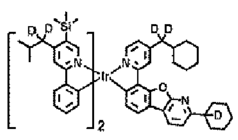
509
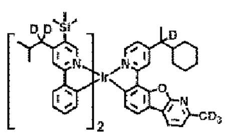
510

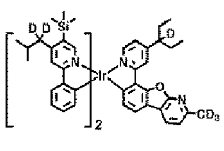
511
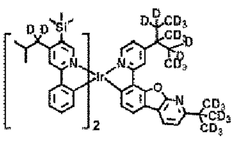
512
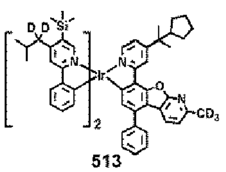
513
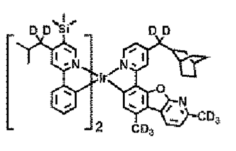
514
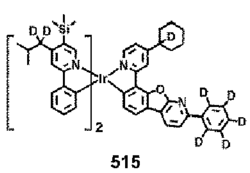
515

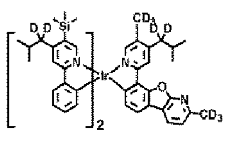
516
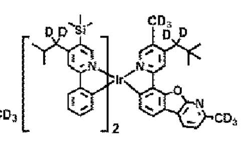
517
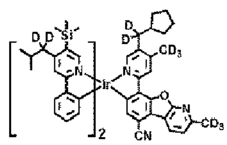
518
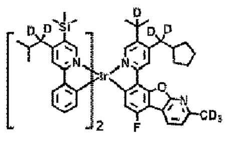
519
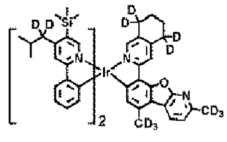
520

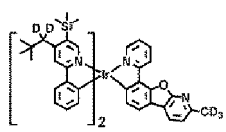
521
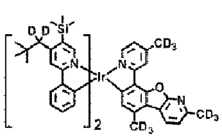
522
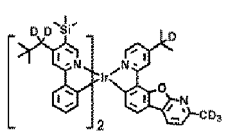
523
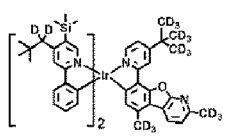
524
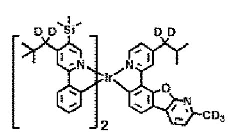
525

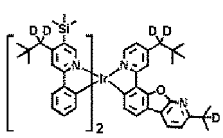
526
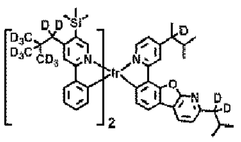
527
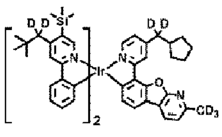
528
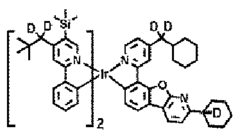
529
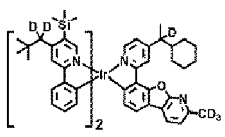
530

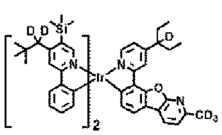
531
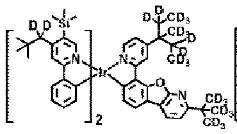
532
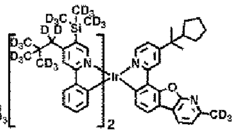
533
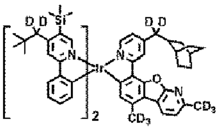
534
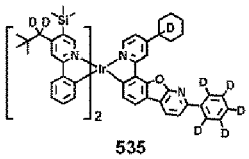
535

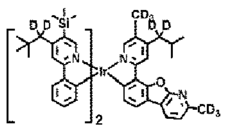
536
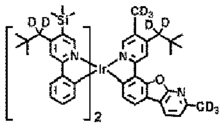
537
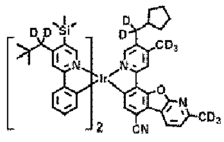
538
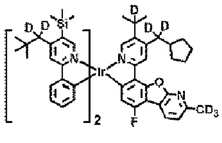
539
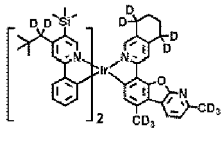
540

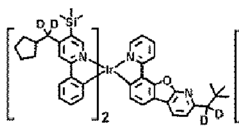
541
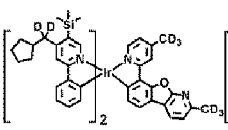
542
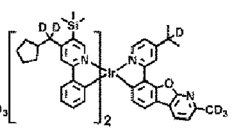
543
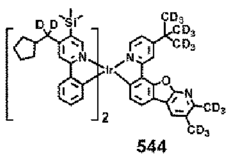
544
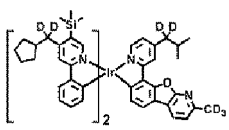
545

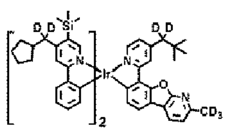
546
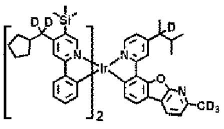
547
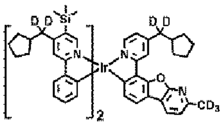
548
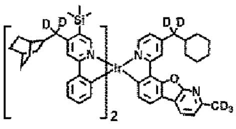
549
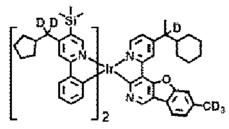
550

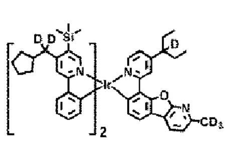
551
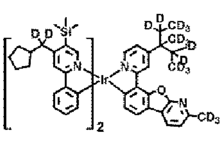
552
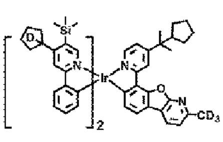
553
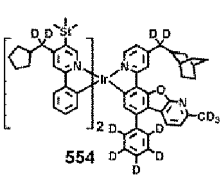
554
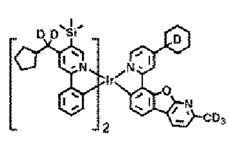
555

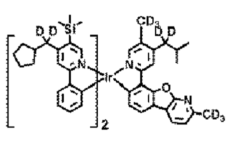
556
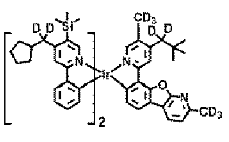
557
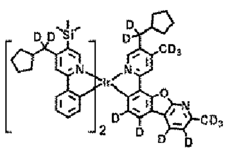
558
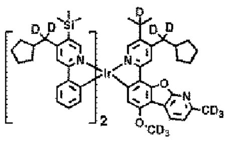
559
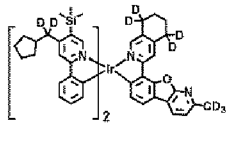
560

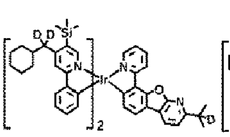
561
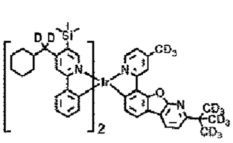
562
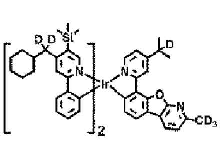
563
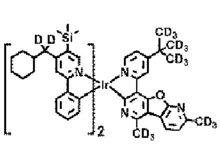
564
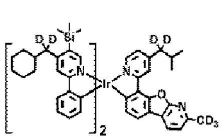
565

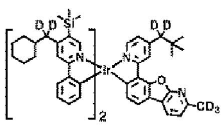
566
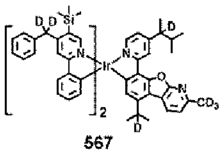
567
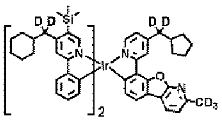
568
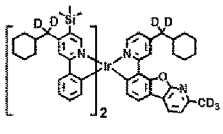
569
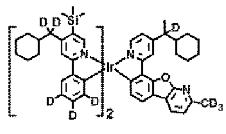
570

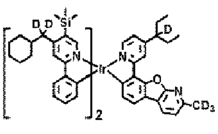
571
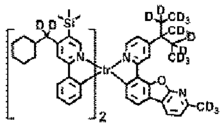
572
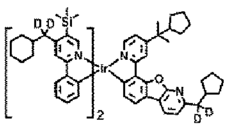
573
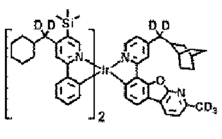
574
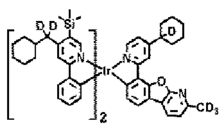
575

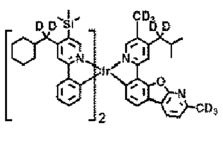
576
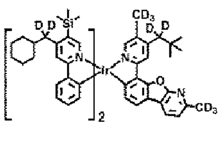
577
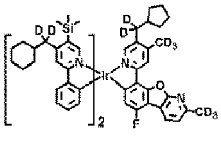
578
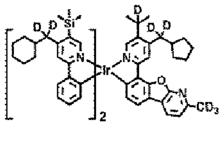
579
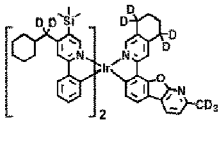
580

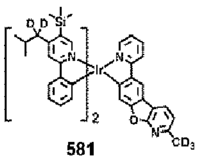
581
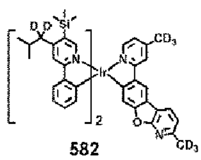
582
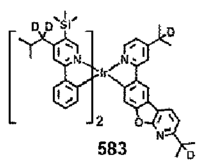
583
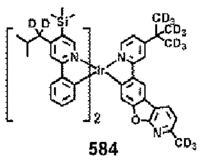
584
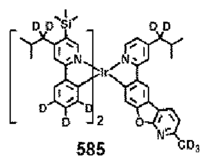
585

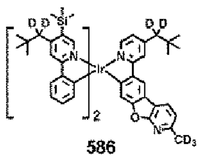
586
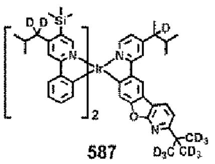
587
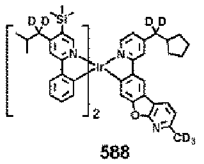
588
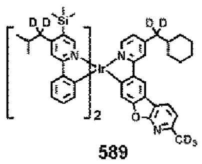
589
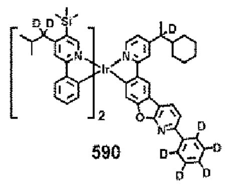
590

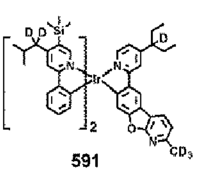
591
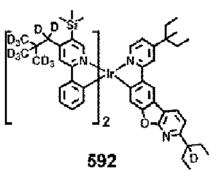
592
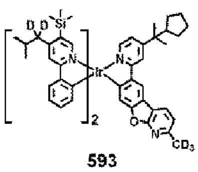
593
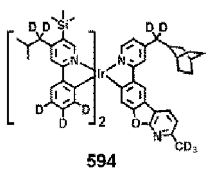
594
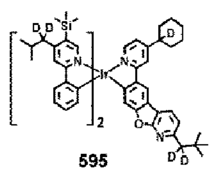
595

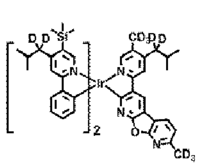
596
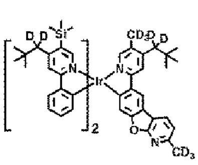
597
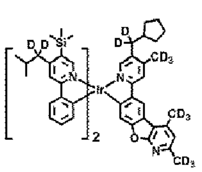
598
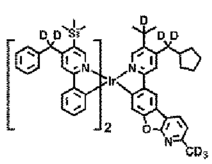
599
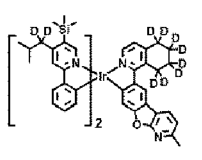
600

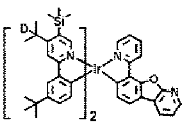
601
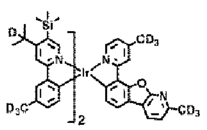
602
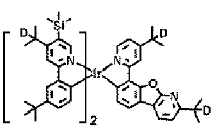
603
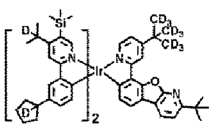
604
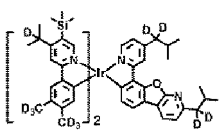
605

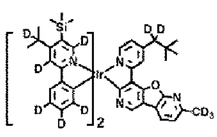
606
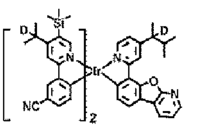
607
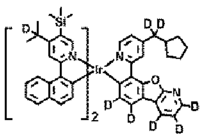
608
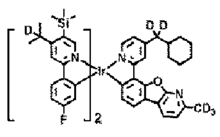
609
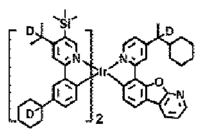
610

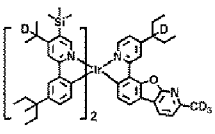
611
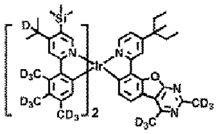
612
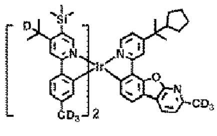
613
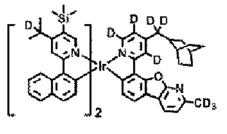
614
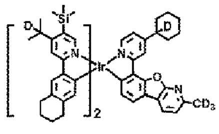
615

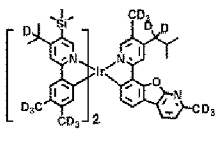
616
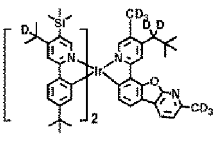
617
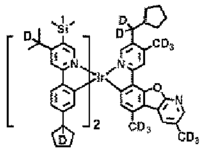
618
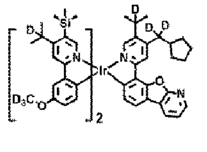
619
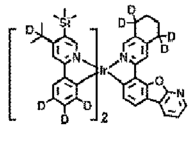
620

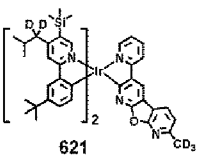
621
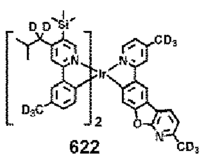
622
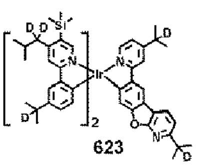
623
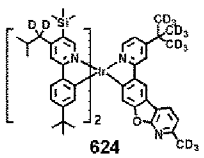
624
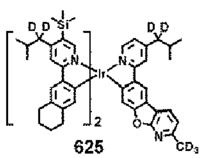
625

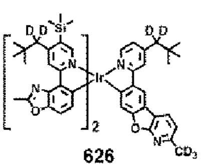
626
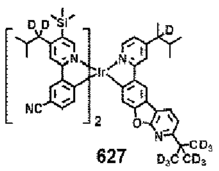
627
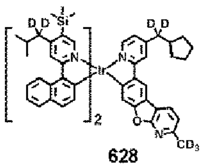
628
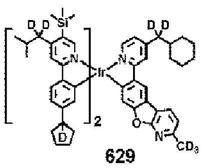
629
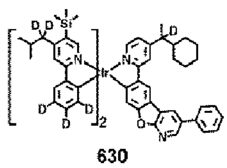
630

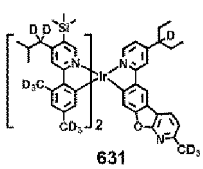
631
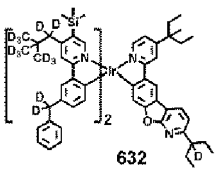
632
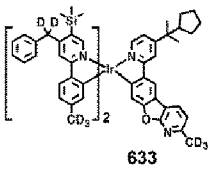
633
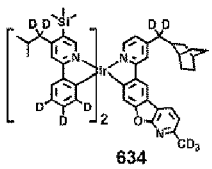
634
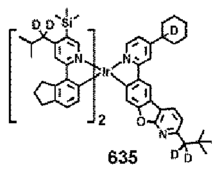
635

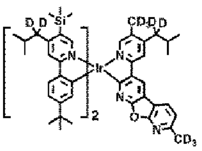
636
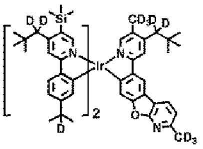
637
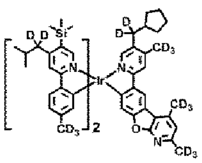
638
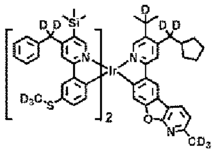
639
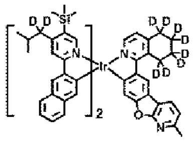
640

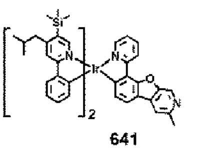
641
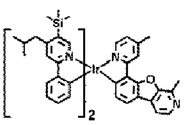
642
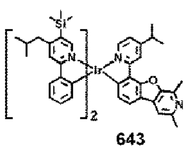
643
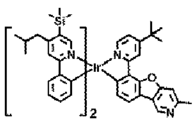
644
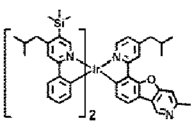
645

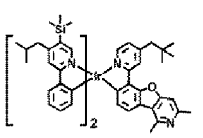 646 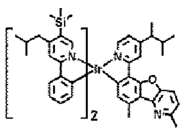 647 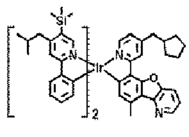 648 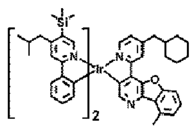 649 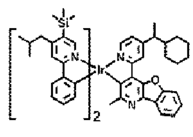 650

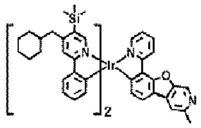 651 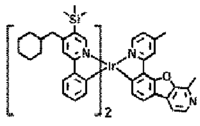 652 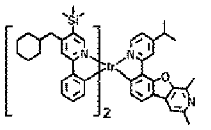 653 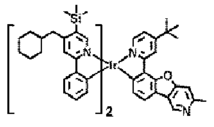 654 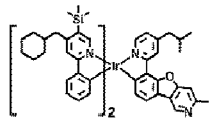 655

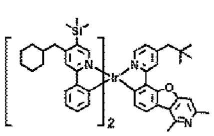 656 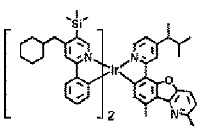 657 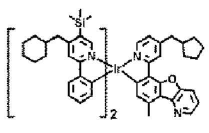 658 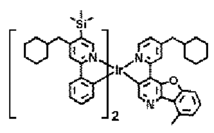 659 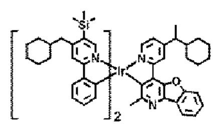 660

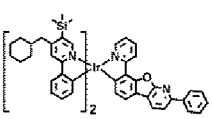 661 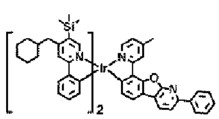 662 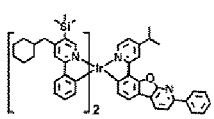 663 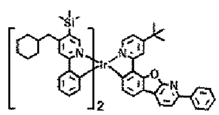 664 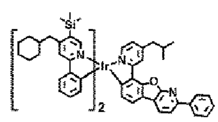 665

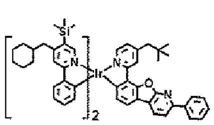 666 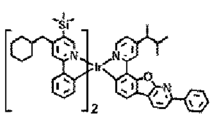 667 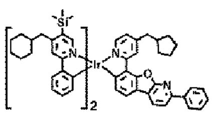 668 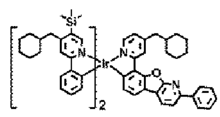 669 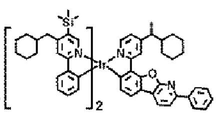 670

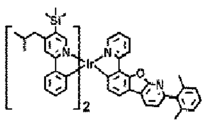 671 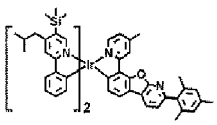 672 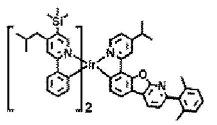 673 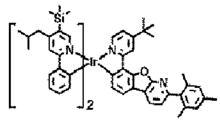 674 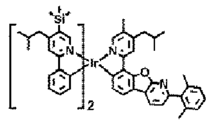 675

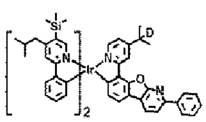 676 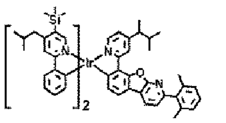 677 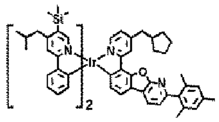 678 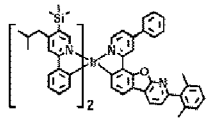 679 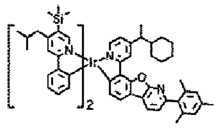 680

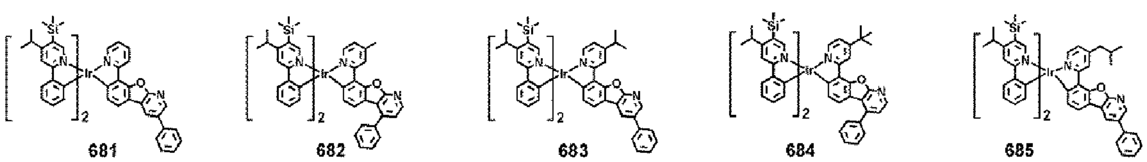

681 682 683 684 685

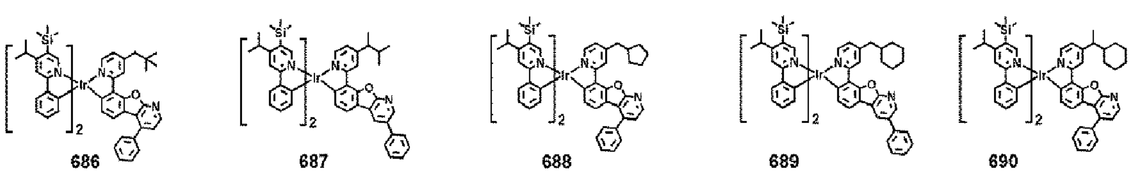

686 687 688 689 690

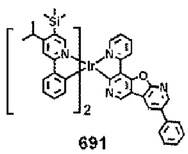
691
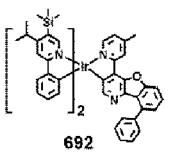
692
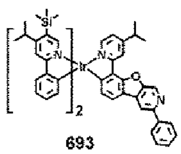
693
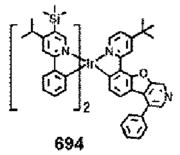
694
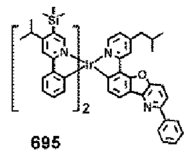
695

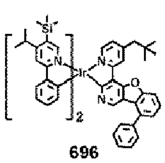
696
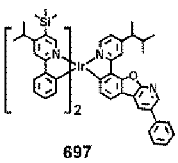
697
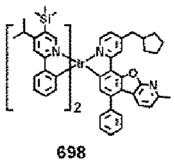
698
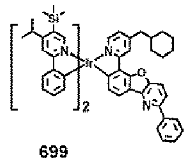
699
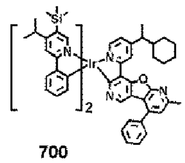
700

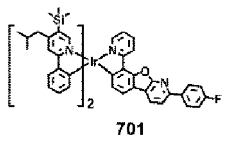
701
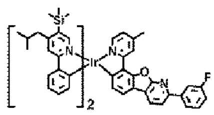
702
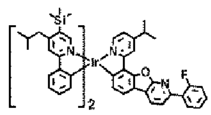
703
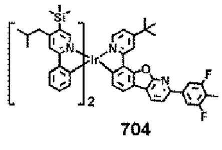
704
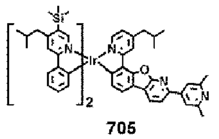
705

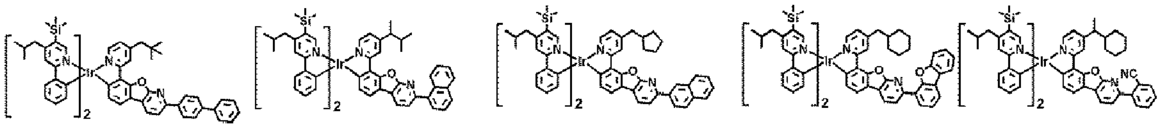
706 707 708 709 710

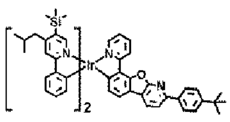
711
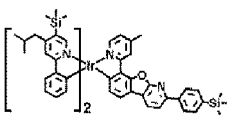
712
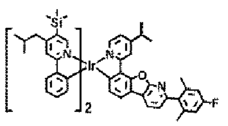
713
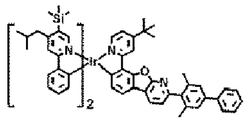
714
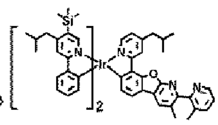
715

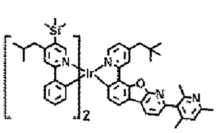
716
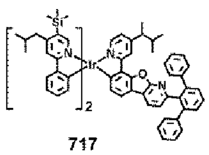
717
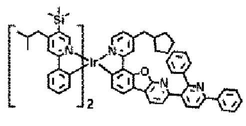
718
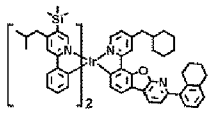
719
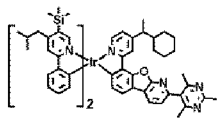
720

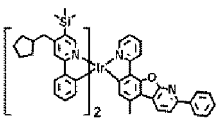
721
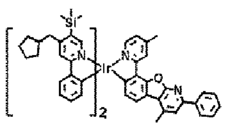
722
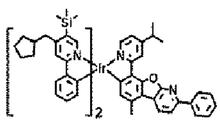
723
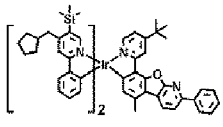
724
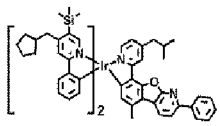
725

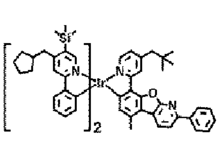
726
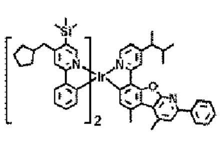
727
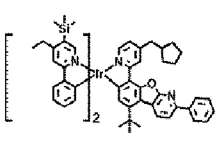
728
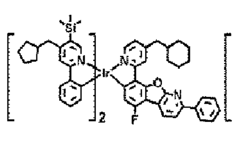
729
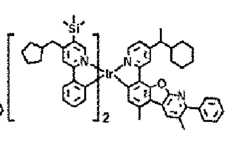
730

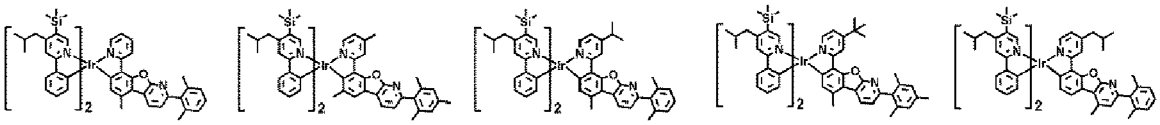
731 732 733 734 735

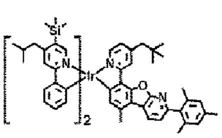
736
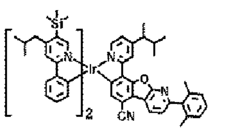
737
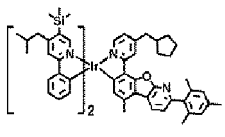
738
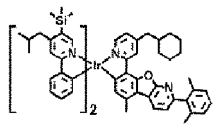
739
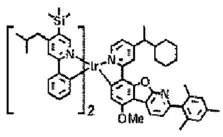
740

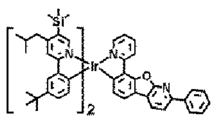
741
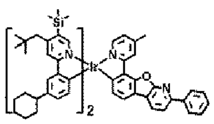
742
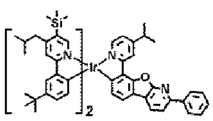
743
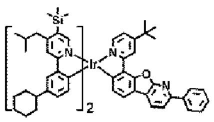
744
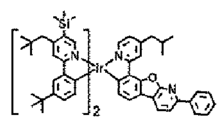
745

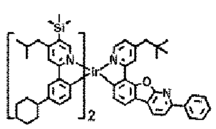
746
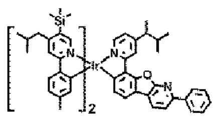
747
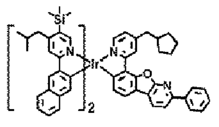
748
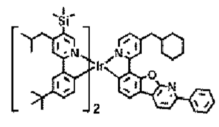
749
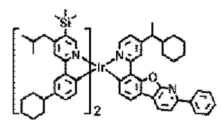
750

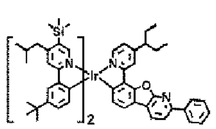
751
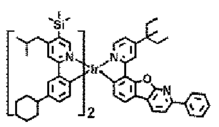
752
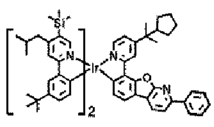
753
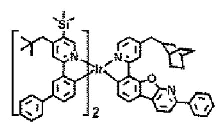
754
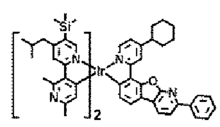
755

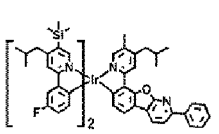
756
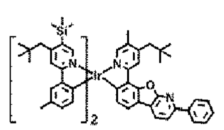
757
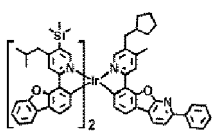
758
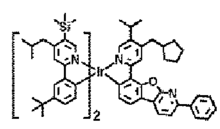
759
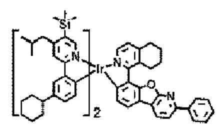
760

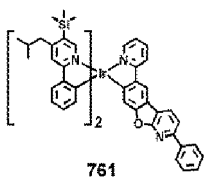
761
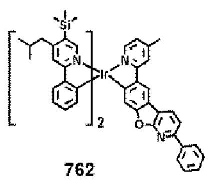
762
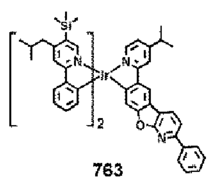
763
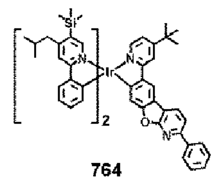
764
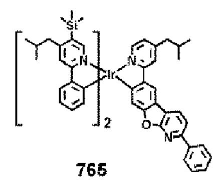
765

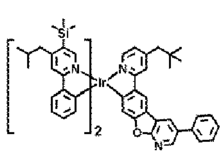
766
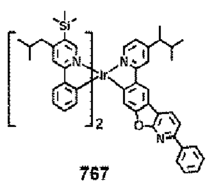
767
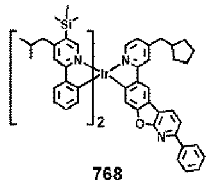
768
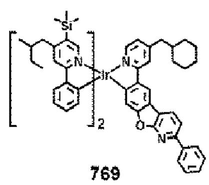
769
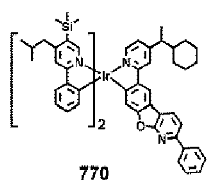
770

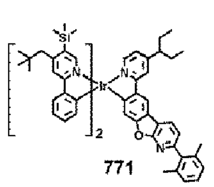
771
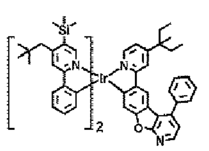
772
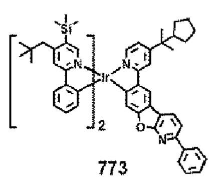
773
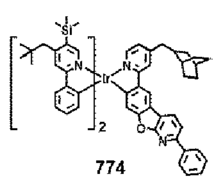
774
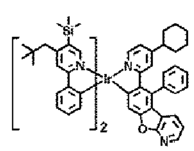
775

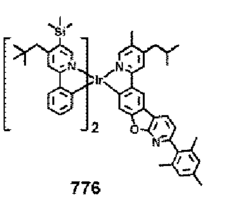
776
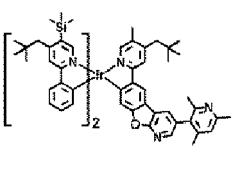
777
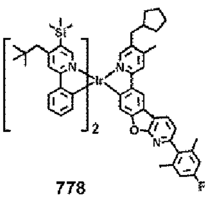
778
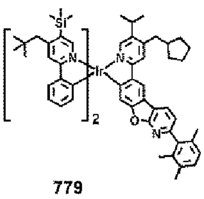
779
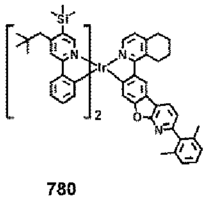
780

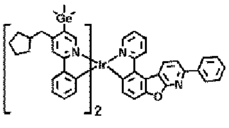
781
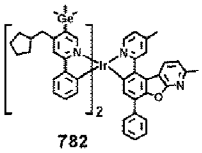
782
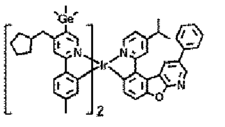
783
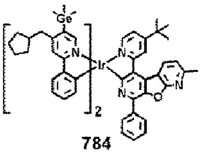
784
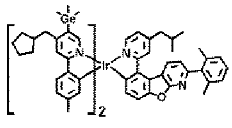
785

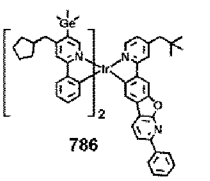
786
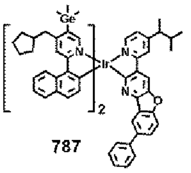
787
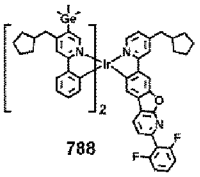
788
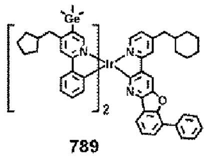
789
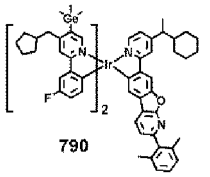
790

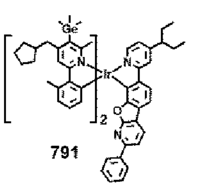
791
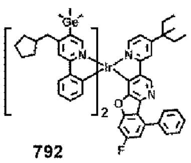
792
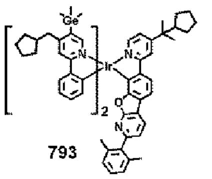
793
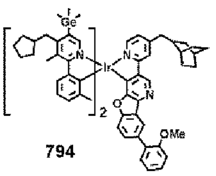
794
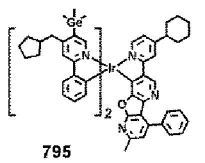
795

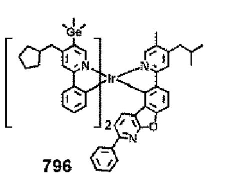
796
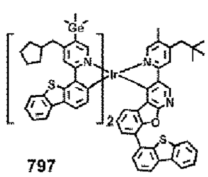
797
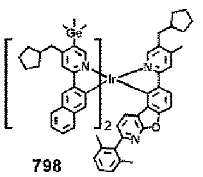
798
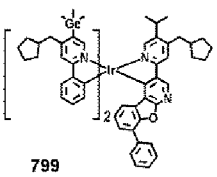
799
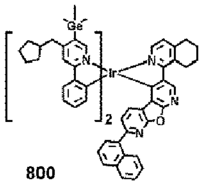
800

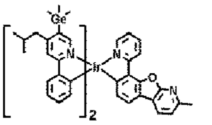
801
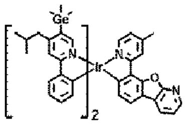
802
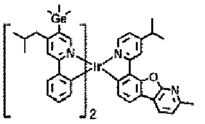
803
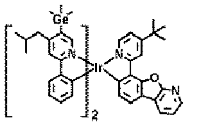
804
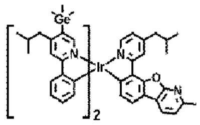
805

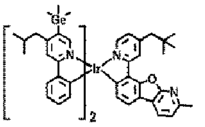
806
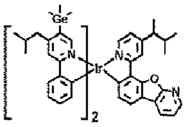
807
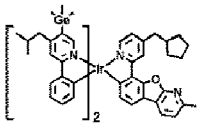
808
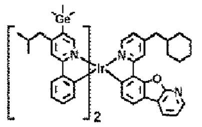
809
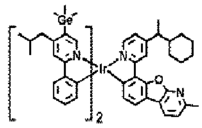
810

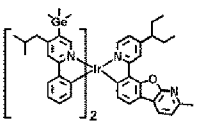
811
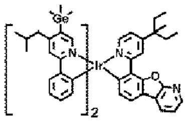
812
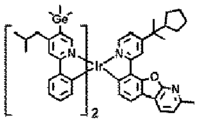
813
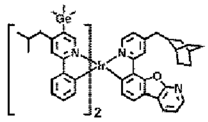
814
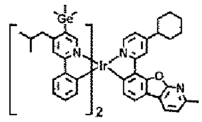
815

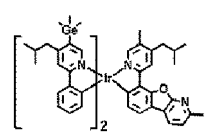
816
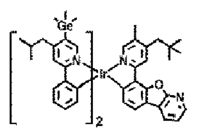
817
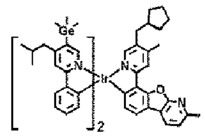
818
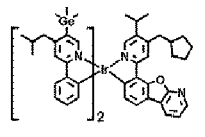
819
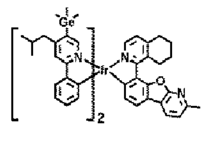
820

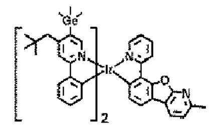
821
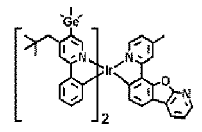
822
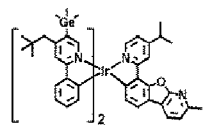
823
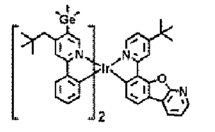
824
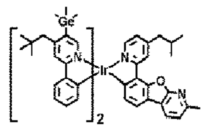
825

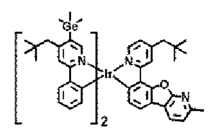
826
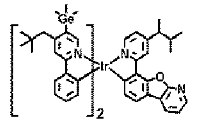
827
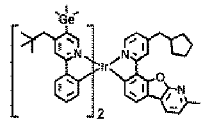
828
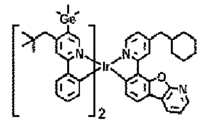
829
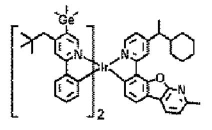
830

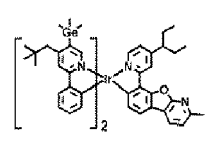
831
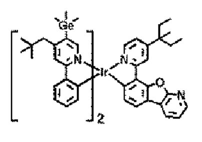
832
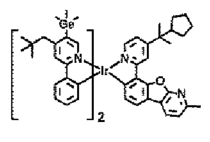
833
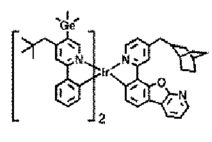
834
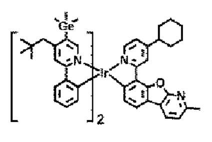
835

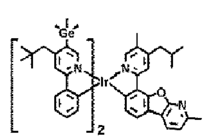
836
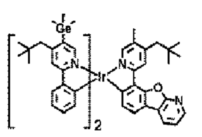
837
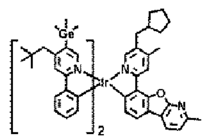
838
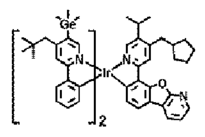
839
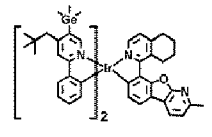
840

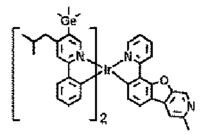
841
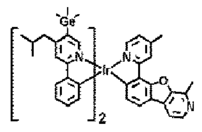
842
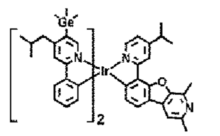
843
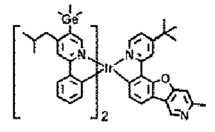
844
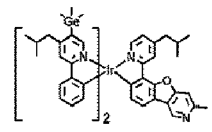
845

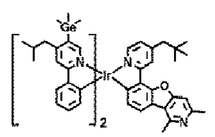
846
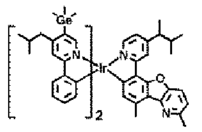
847
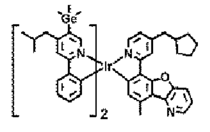
848
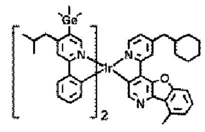
849
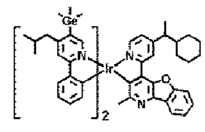
850

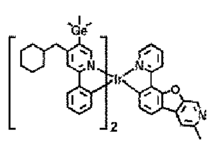
851
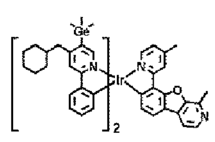
852
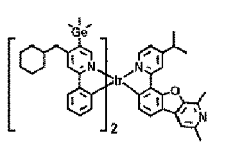
853
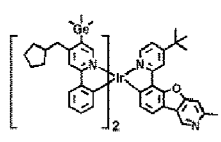
854
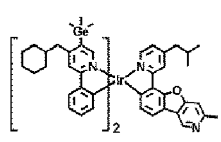
855

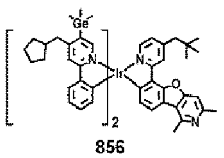
856
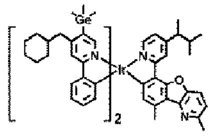
857
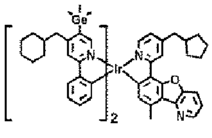
858
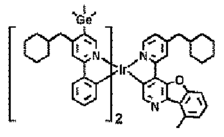
859
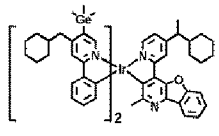
860

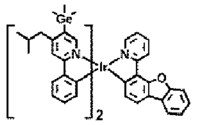
861
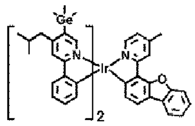
862
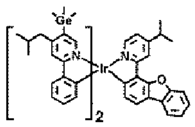
863
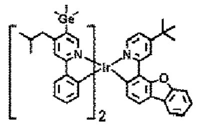
864
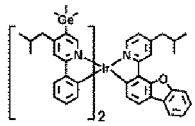
865

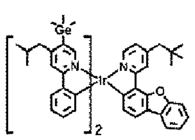
866
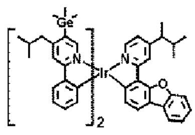
867
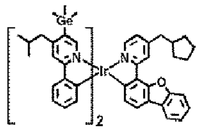
868
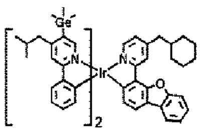
869
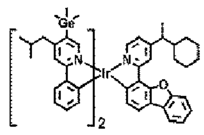
870

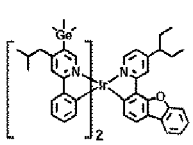
871
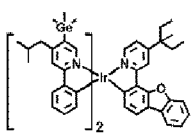
872
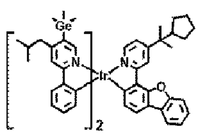
873
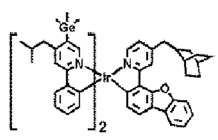
874
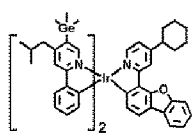
875

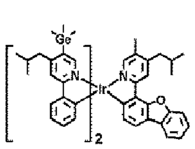
876
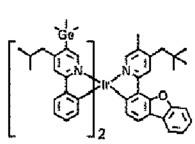
877
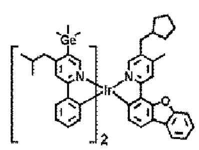
878
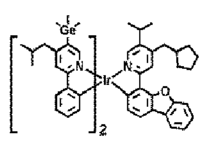
879
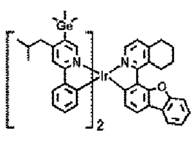
880

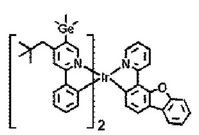
881
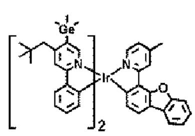
882
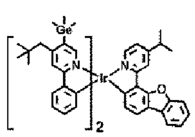
883
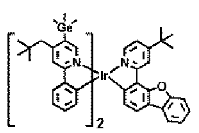
884
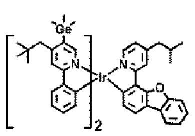
885

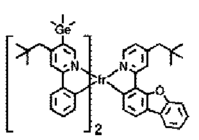
886
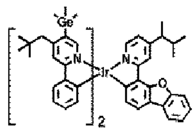
887
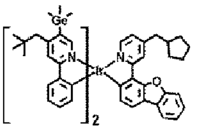
888
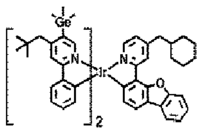
889
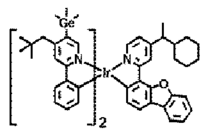
890

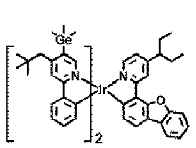
891
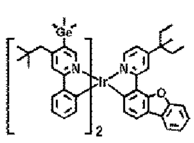
892
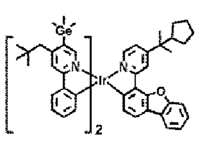
893
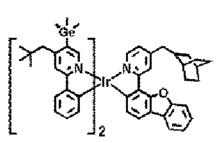
894
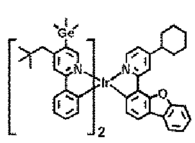
895

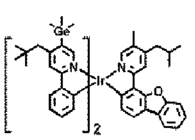
896

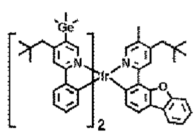
897

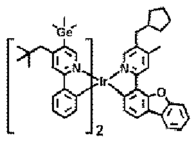
898

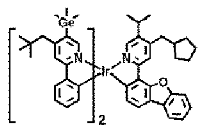
899

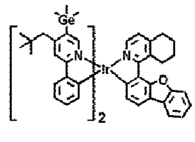
900

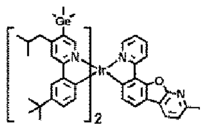
901

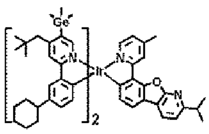
902

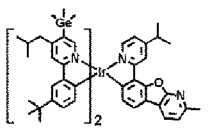
903

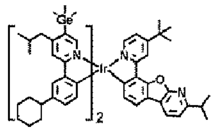
904

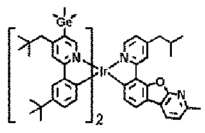
905

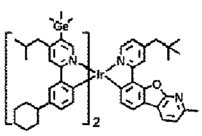
906

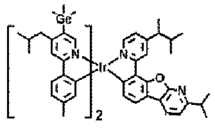
907

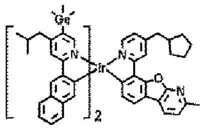
908

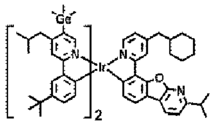
909

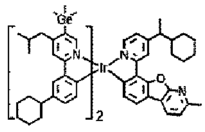
910

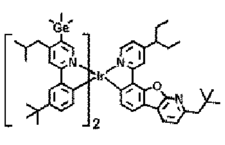
911

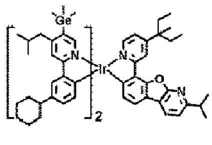
912

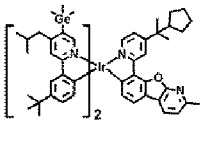
913

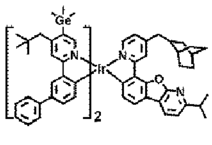
914

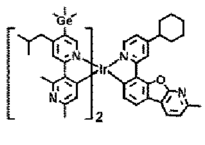
915

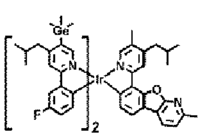
916

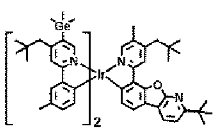
917

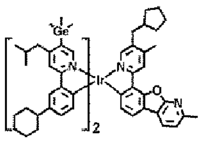
918

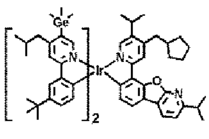
919

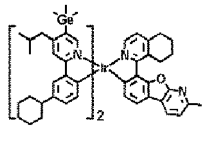
920

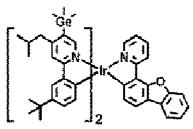
921

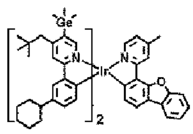
922

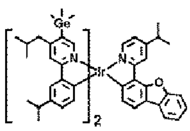
923

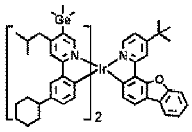
924

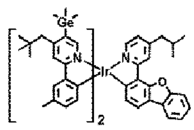
925

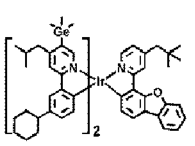
926

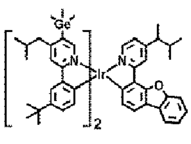
927

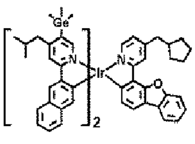
928

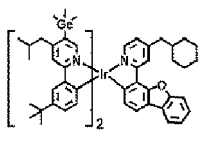
929

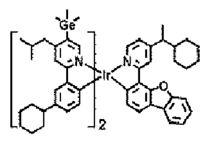
930

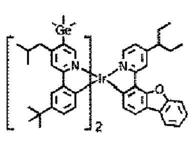
931

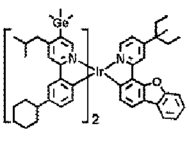
932

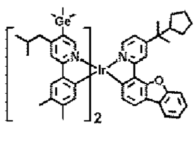
933

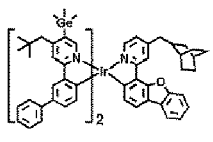
934

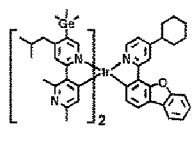
935

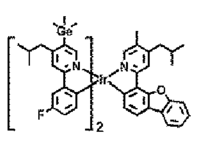
936

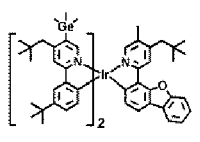
937

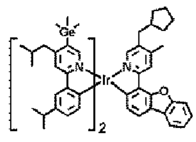
938

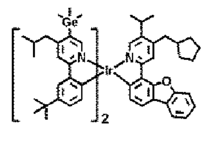
939

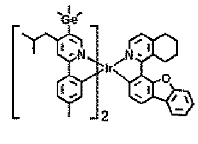
940

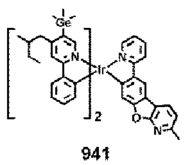
941

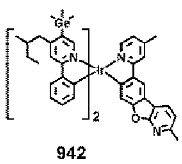
942

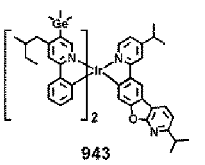
943

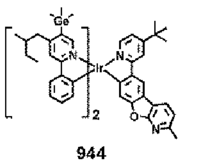
944

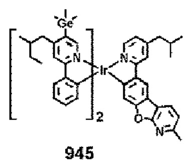
945

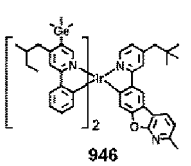
946

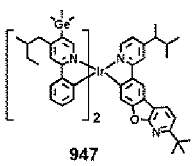
947

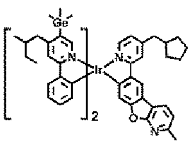
948

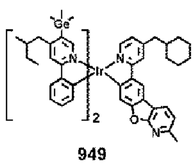
949

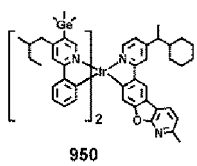
950

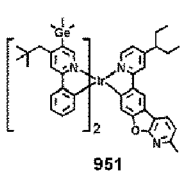
951

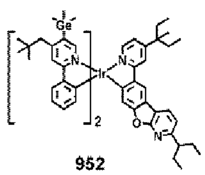
952

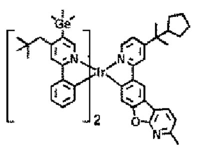
953

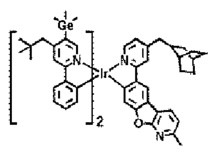
954

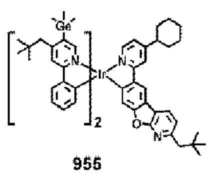
955

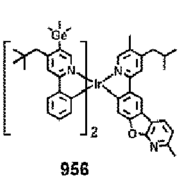
956

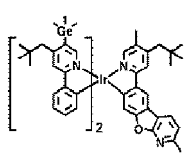
957

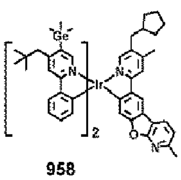
958

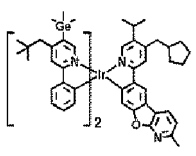
959

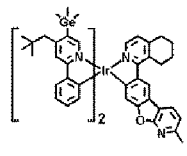
960

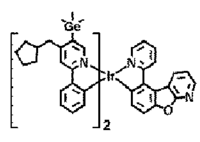
961

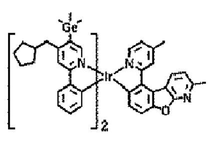
962

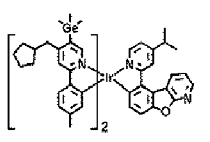
963

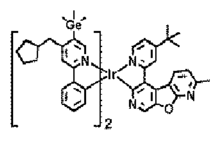
964

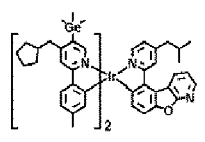
965

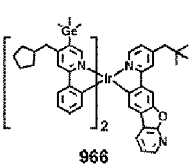
966

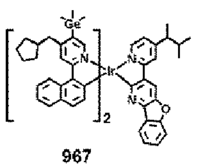
967

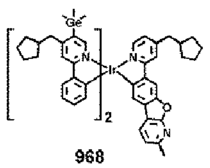
968

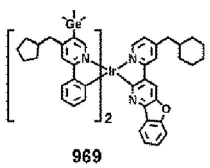
969

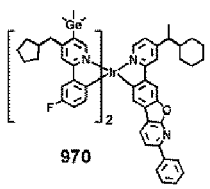
970

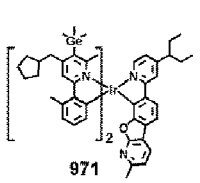
971

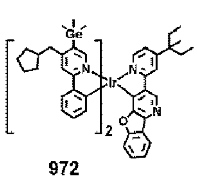
972

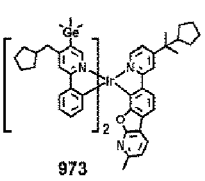
973

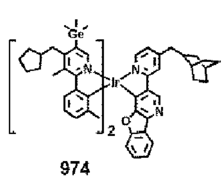
974

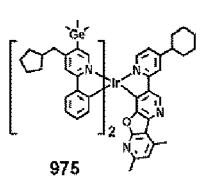
975

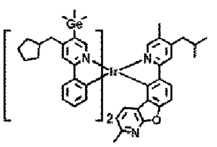
976
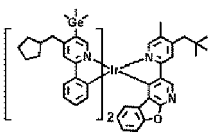
977
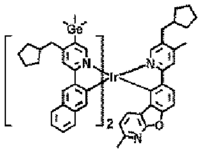
978
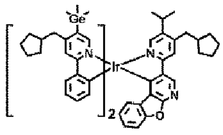
979
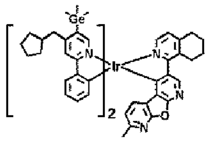
980

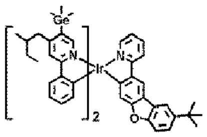
981
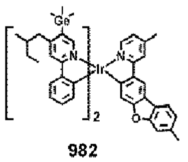
982
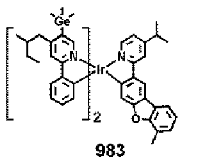
983
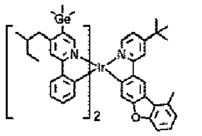
984
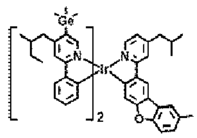
985

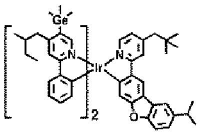
986
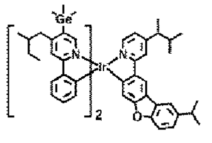
987
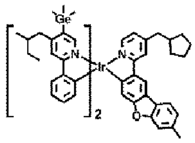
988
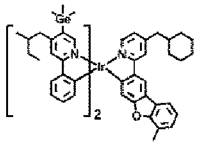
989
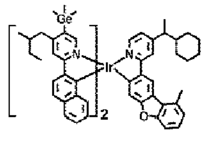
990

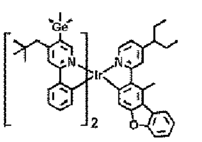
991
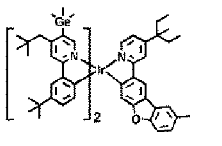
992
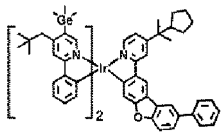
993
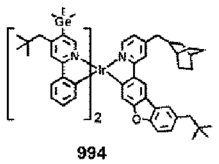
994
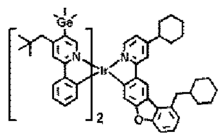
995

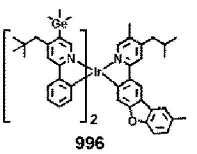
996
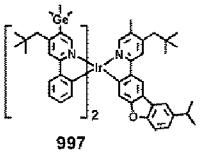
997
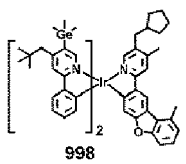
998
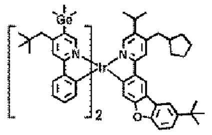
999
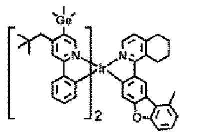
1000

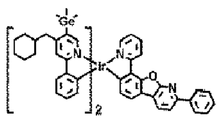
1001
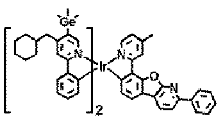
1002
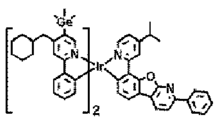
1003
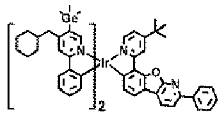
1004
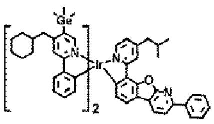
1005

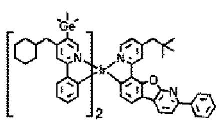
1006
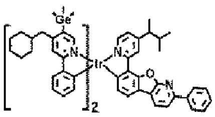
1007
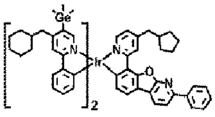
1008
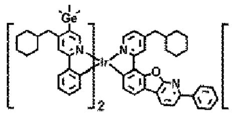
1009
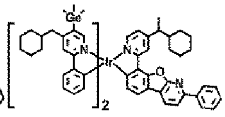
1010

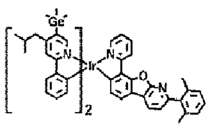
1011
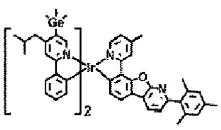
1012
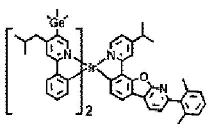
1013
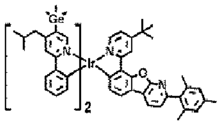
1014
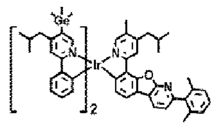
1015

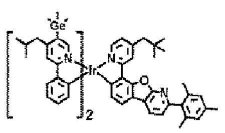
1016
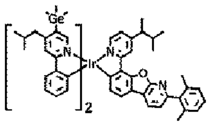
1017
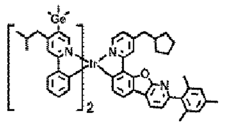
1018
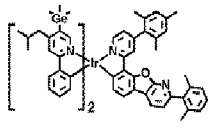
1019
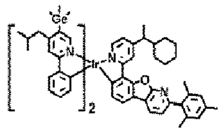
1020

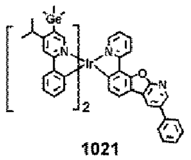
1021
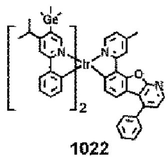
1022
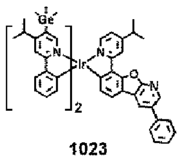
1023
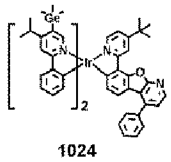
1024
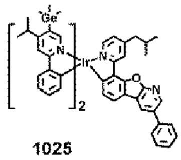
1025

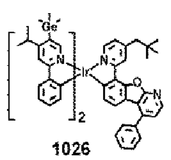
1026
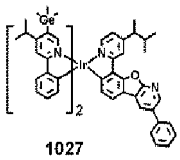
1027
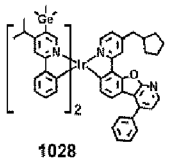
1028
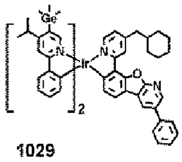
1029
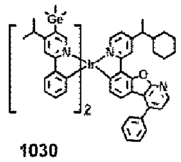
1030

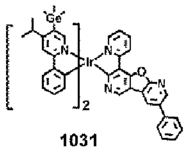
1031
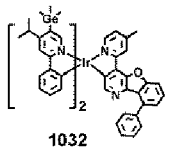
1032
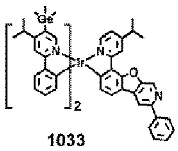
1033
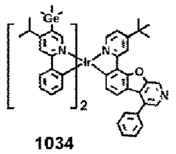
1034
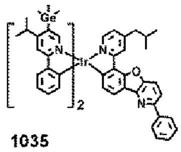
1035

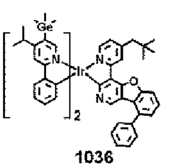
1036
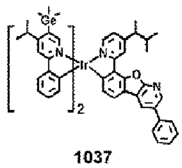
1037
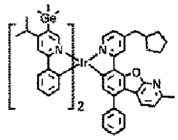
1038
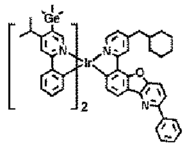
1039
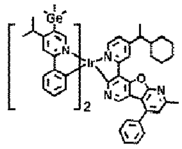
1040

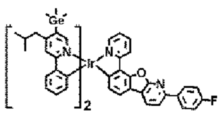
1041
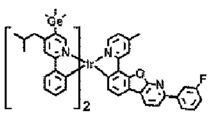
1042
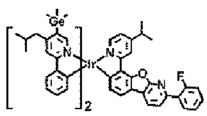
1043
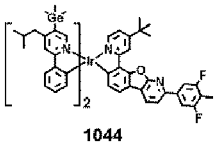
1044
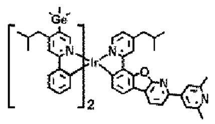
1045

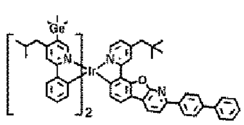
1046
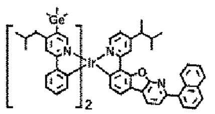
1047
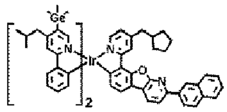
1048
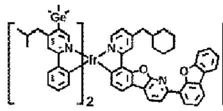
1049
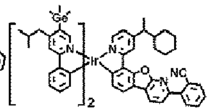
1050

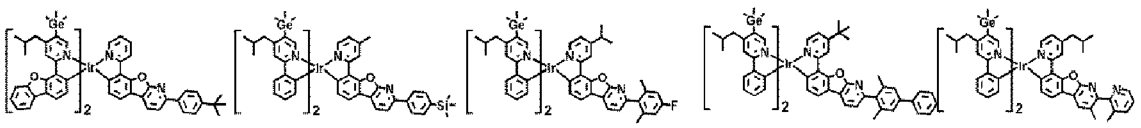
1051
1052
1053
1054
1055

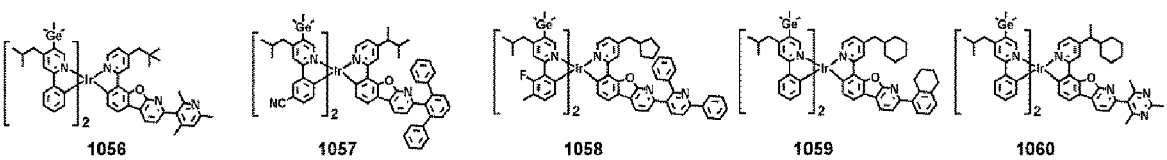
1056
1057
1058
1059
1060

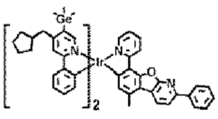
1061
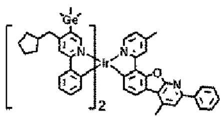
1062
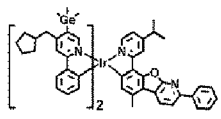
1063
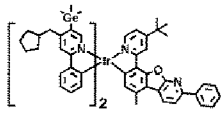
1064
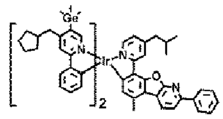
1065

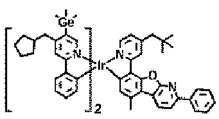
1066
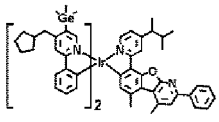
1067
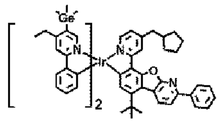
1068
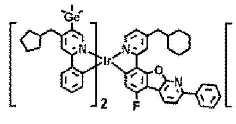
1069
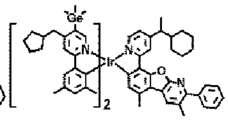
1070

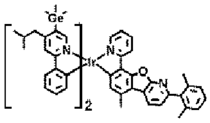
1071
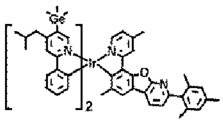
1072
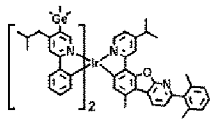
1073
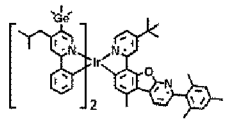
1074
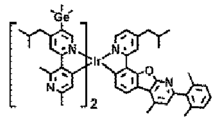
1075

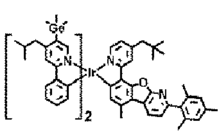
1076
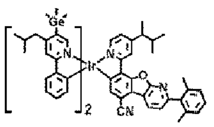
1077
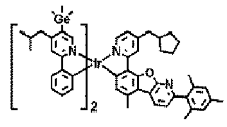
1078
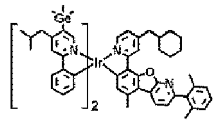
1079
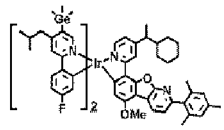
1080

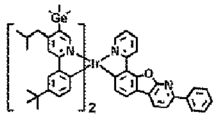
1081
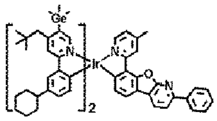
1082
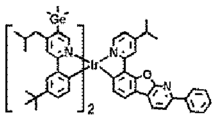
1083
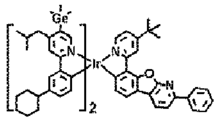
1084
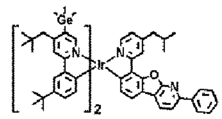
1085

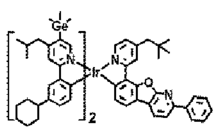
1086
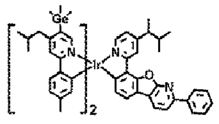
1087
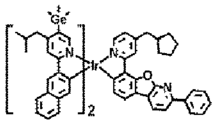
1088
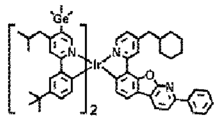
1089
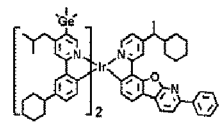
1090

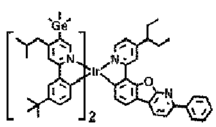
1091
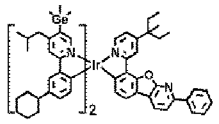
1092
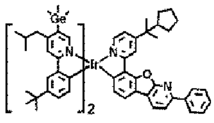
1093
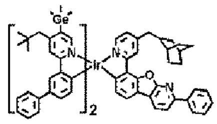
1094
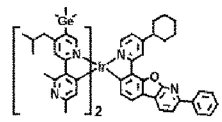
1095

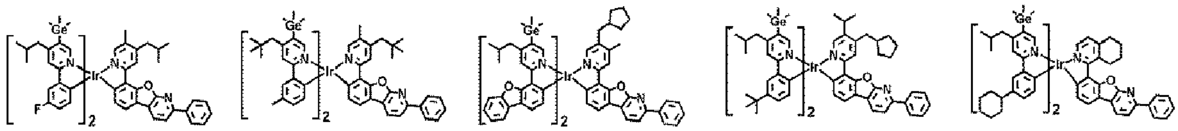
1096
1097
1098
1099
1100

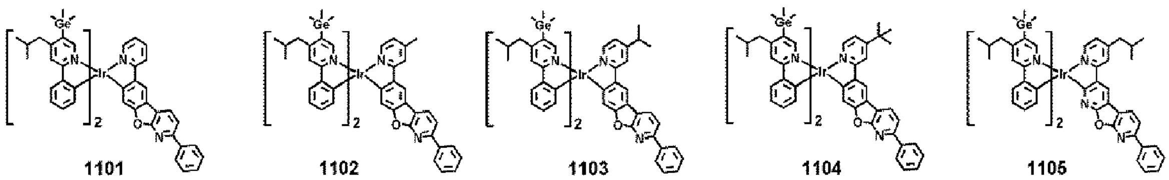
1101
1102
1103
1104
1105

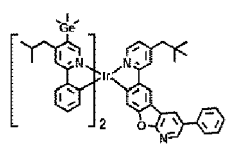
1106
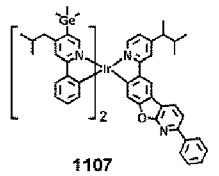
1107
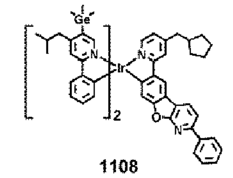
1108
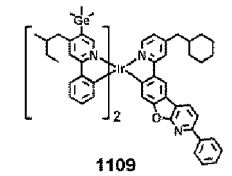
1109
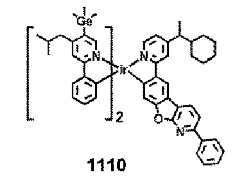
1110

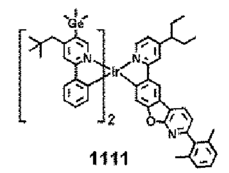
1111
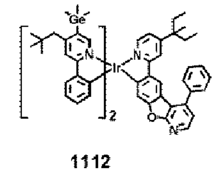
1112
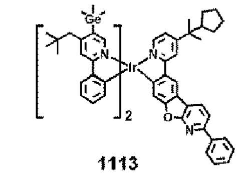
1113
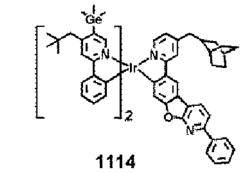
1114
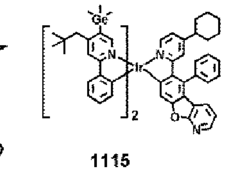
1115

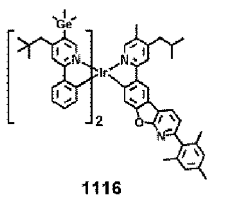
1116
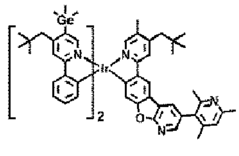
1117
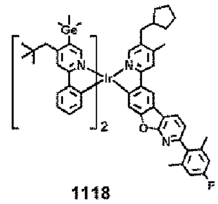
1118
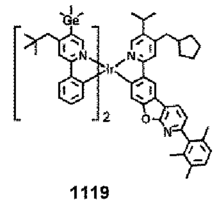
1119
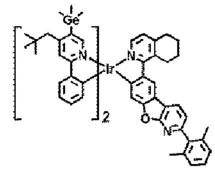
1120

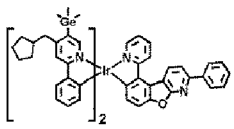
1121
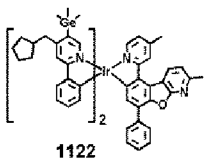
1122
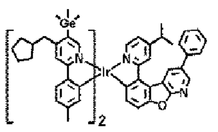
1123
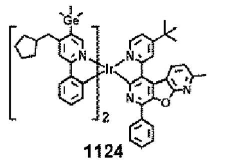
1124
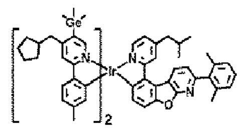
1125

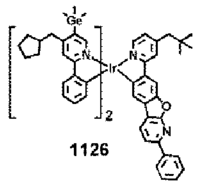
1126
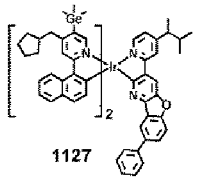
1127
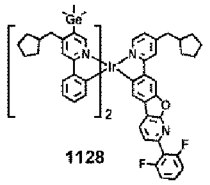
1128
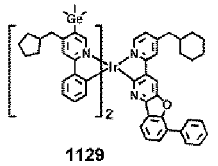
1129
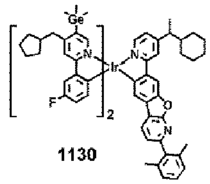
1130

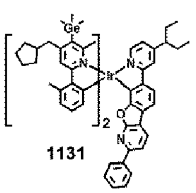
1131
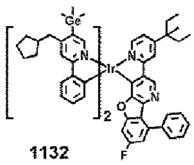
1132
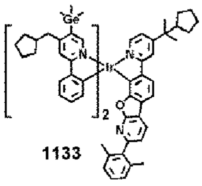
1133
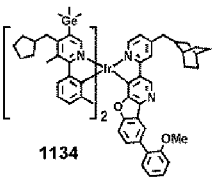
1134
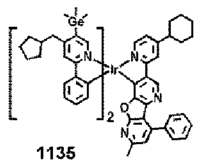
1135

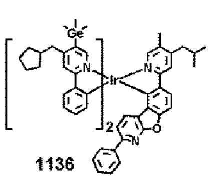
1136
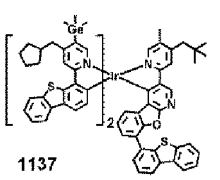
1137
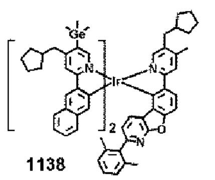
1138
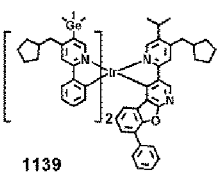
1139
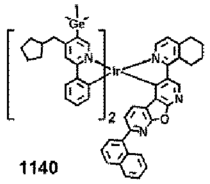
1140

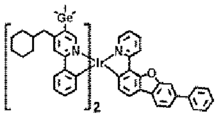
1141
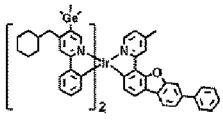
1142
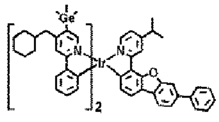
1143
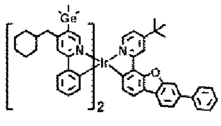
1144
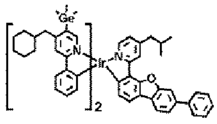
1145

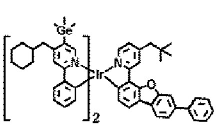
1146

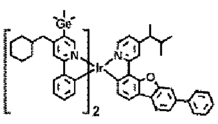
1147

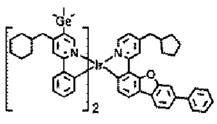
1148

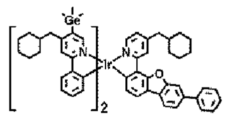
1149

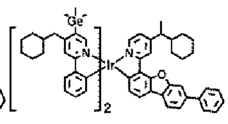
1150

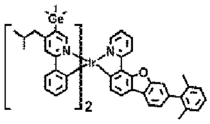
1151

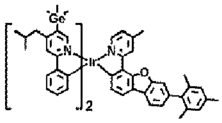
1152

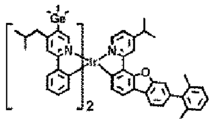
1153

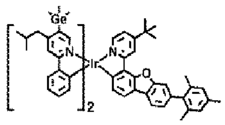
1154

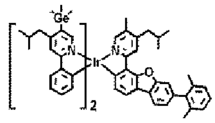
1155

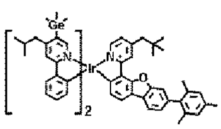
1156

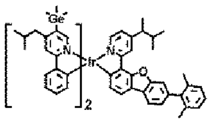
1157

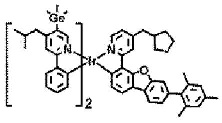
1158

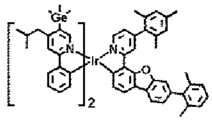
1159

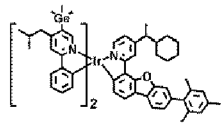
1160

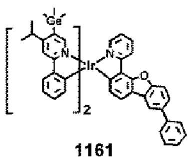
1161

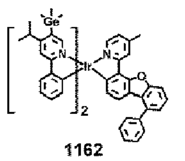
1162

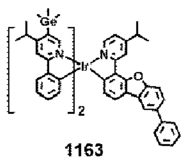
1163

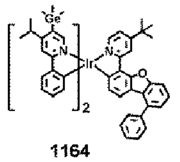
1164

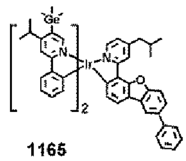
1165

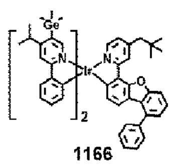
1166

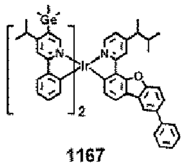
1167

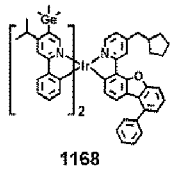
1168

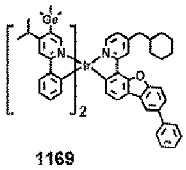
1169

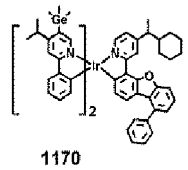
1170

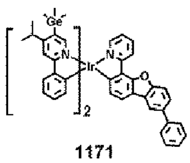
1171

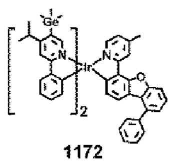
1172

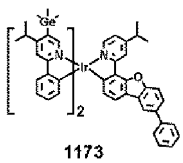
1173

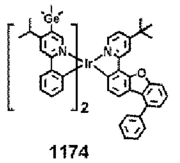
1174

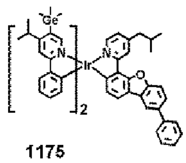
1175

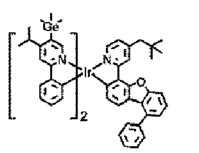
1176

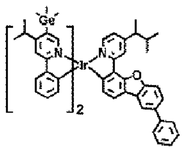
1177

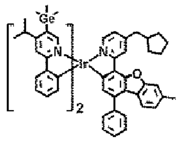
1178

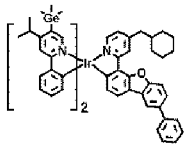
1179

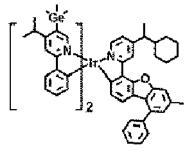
1180

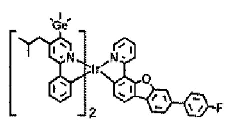
1181

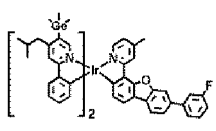
1182

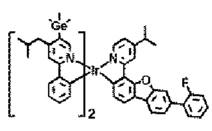
1183

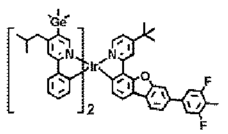
1184

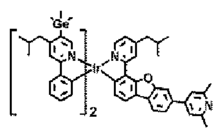
1185

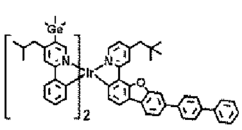
1186

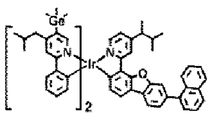
1187

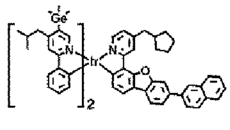
1188

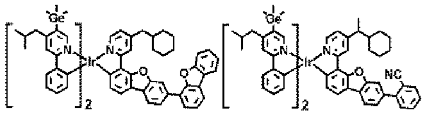
1189

1190

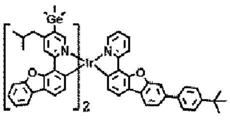
1191

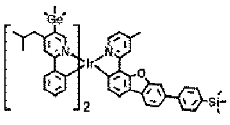
1192

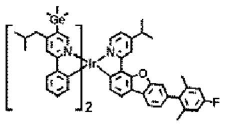
1193

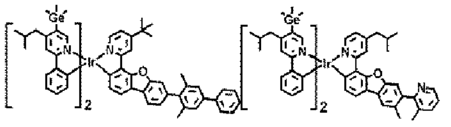
1194

1195

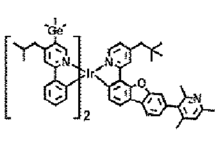
1196

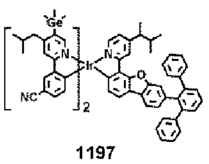
1197

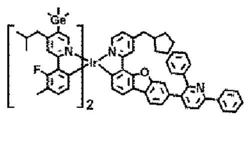
1198

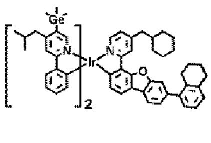
1199

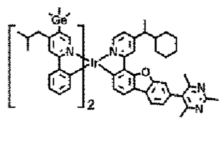
1200

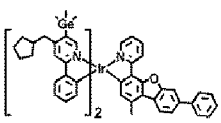
1201

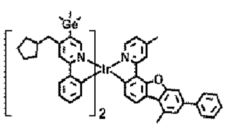
1202

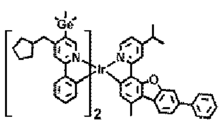
1203

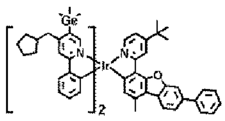
1204

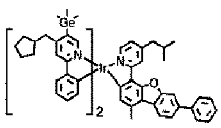
1205

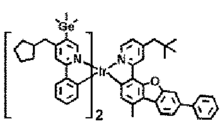
1206

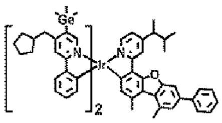
1207

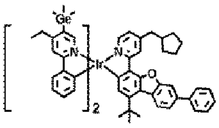
1208

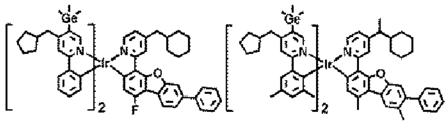
1209

1210

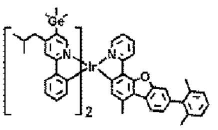
1211

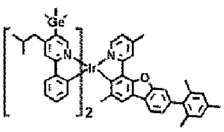
1212

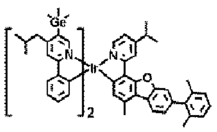
1213

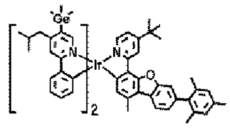
1214

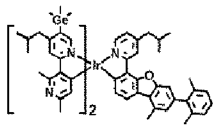
1215

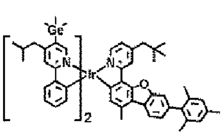
1216

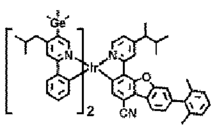
1217

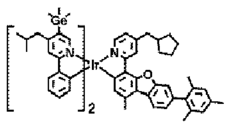
1218

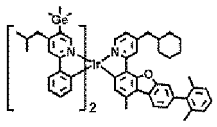
1219

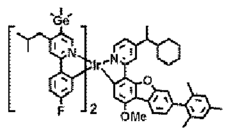
1220

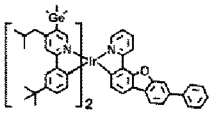
1221

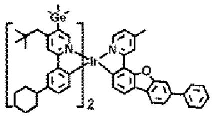
1222

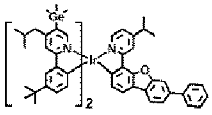
1223

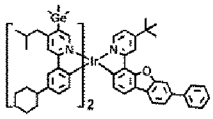
1224

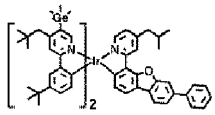
1225

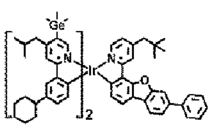
1226

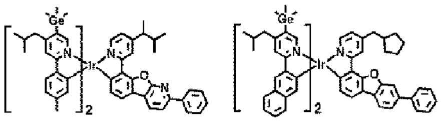
1227

1228

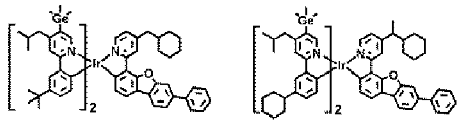

1229

1230

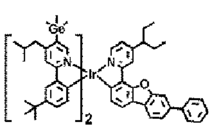
1231
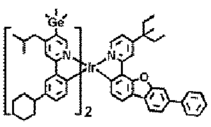
1232
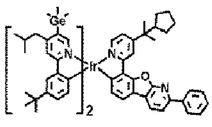
1233
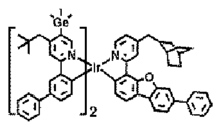
1234
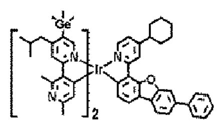
1235

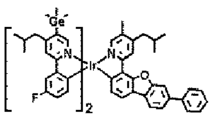
1236
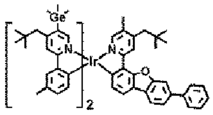
1237
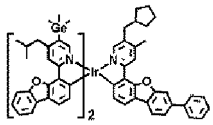
1238
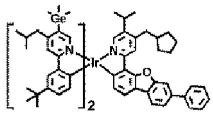
1239
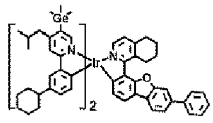
1240

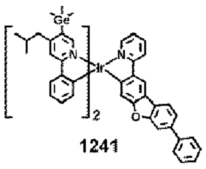
1241
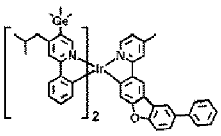
1242
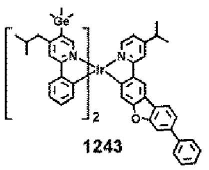
1243
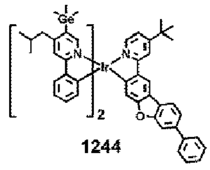
1244
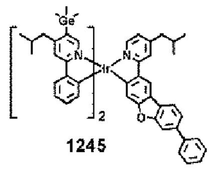
1245

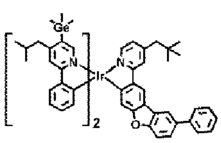
1246
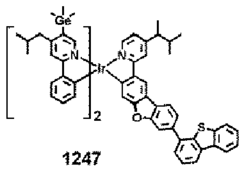
1247
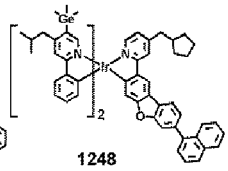
1248
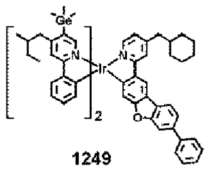
1249
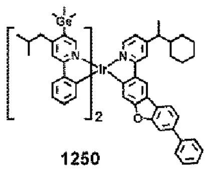
1250

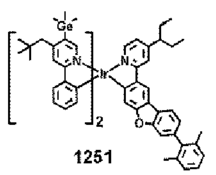
1251
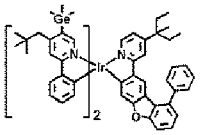
1252
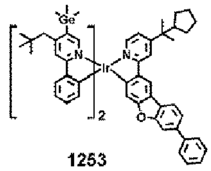
1253
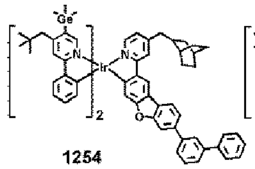
1254
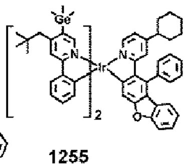
1255

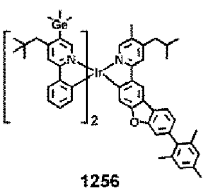
1256
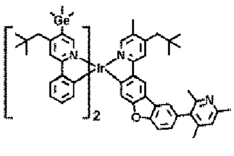
1257
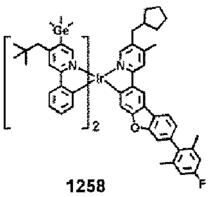
1258
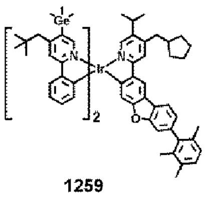
1259
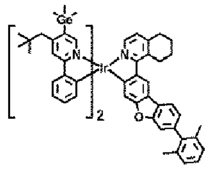
1260

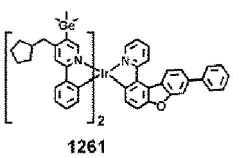
1261
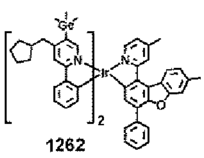
1262
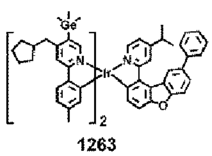
1263
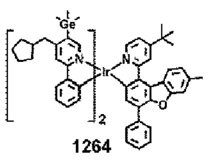
1264
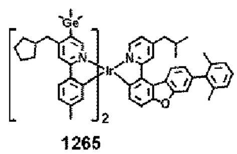
1265

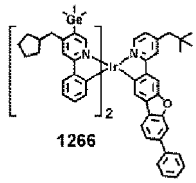
1266
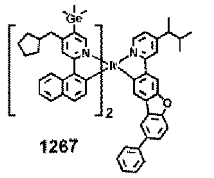
1267
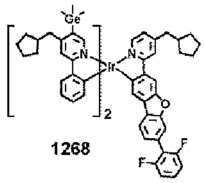
1268
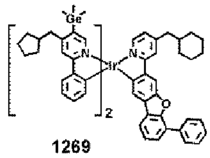
1269
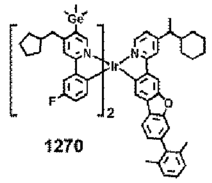
1270

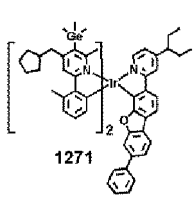
1271

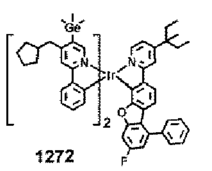
1272

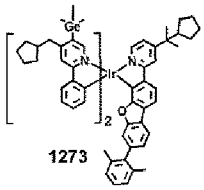
1273

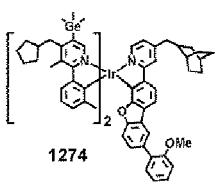
1274

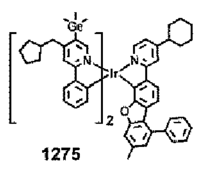
1275

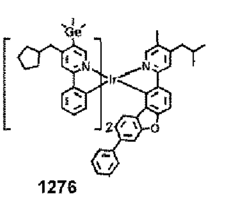
1276

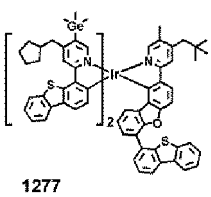
1277

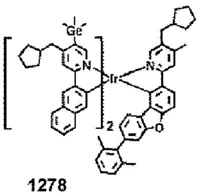
1278

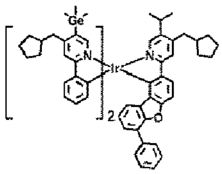
1279

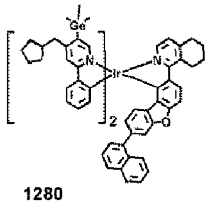
1280

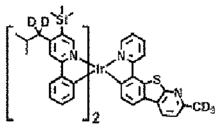
1281

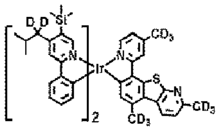
1282

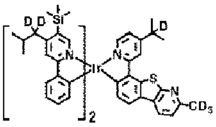
1283

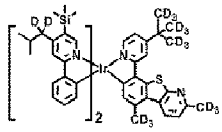
1284

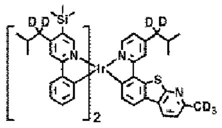
1285

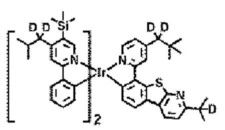
1286

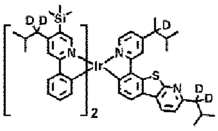
1287

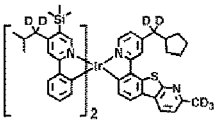
1288

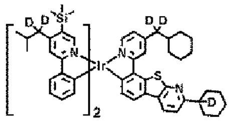
1289

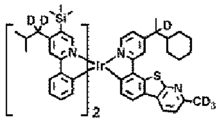
1290

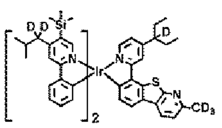
1291

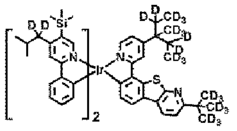
1292

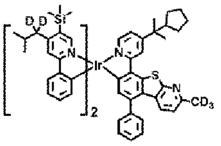
1293

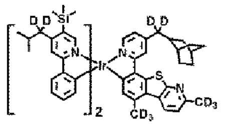
1294

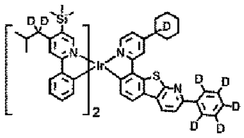
1295

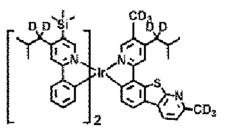
1296

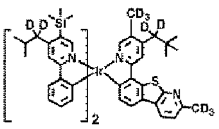
1297

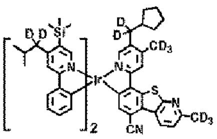
1298

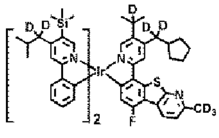
1299

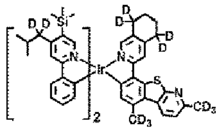
1300

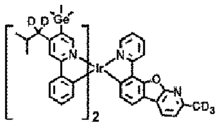
1301

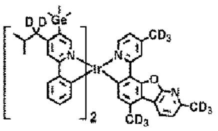
1302

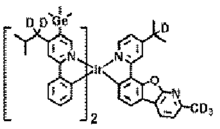
1303

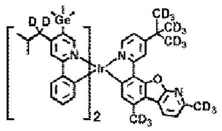
1304

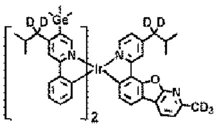
1305

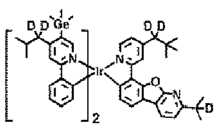
1306

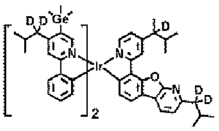
1307

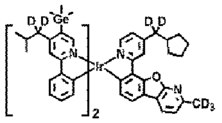
1308

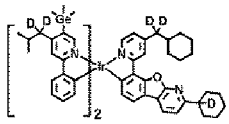
1309

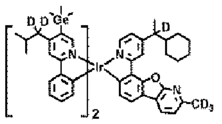
1310

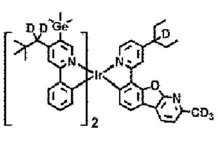 1311
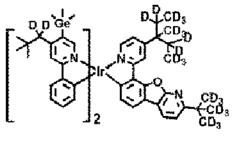 1312
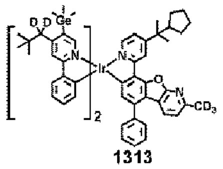 1313
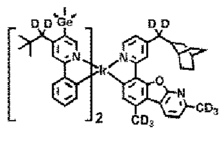 1314
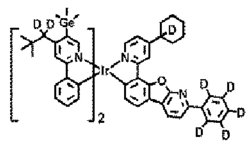 1315

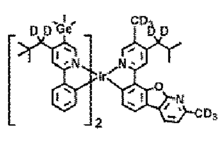 1316
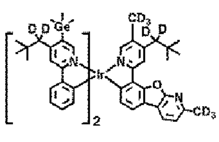 1317
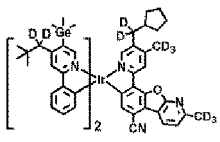 1318
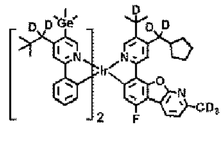 1319
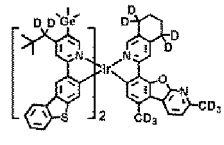 1320

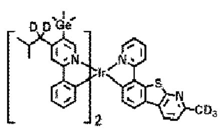 1321
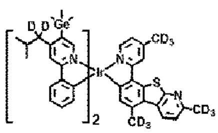 1322
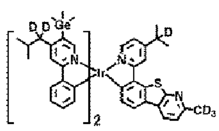 1323
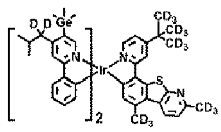 1324
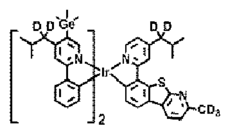 1325

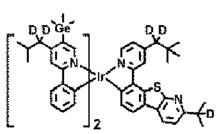 1326
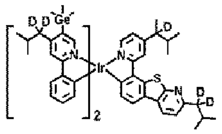 1327
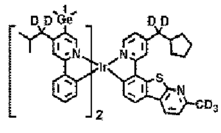 1328
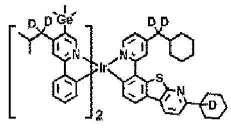 1329
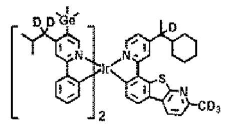 1330

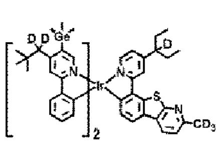 1331
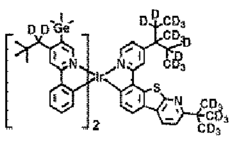 1332
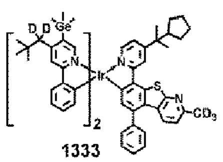 1333
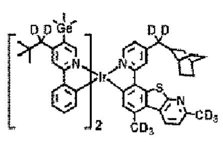 1334
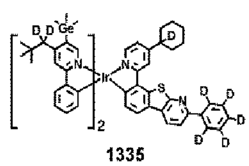 1335

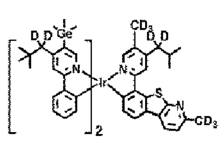 1336
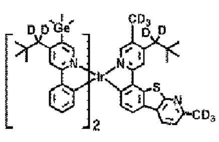 1337
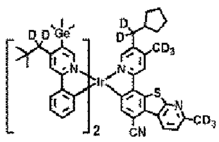 1338
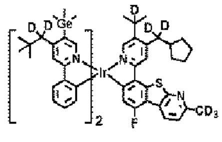 1339
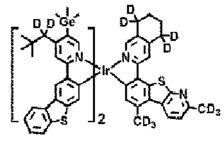 1340

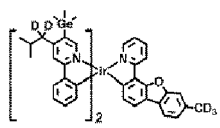 1341
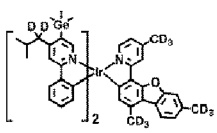 1342
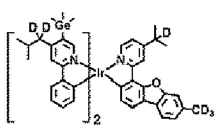 1343
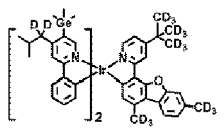 1344
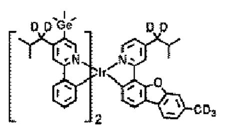 1345

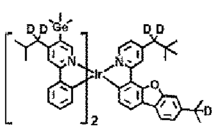 1346
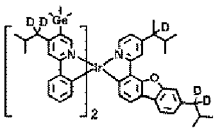 1347
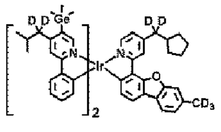 1348
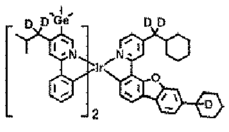 1349
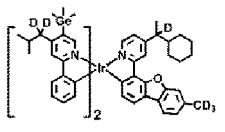 1350

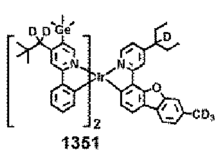
1351

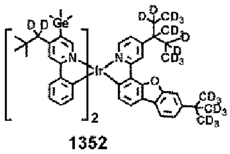
1352

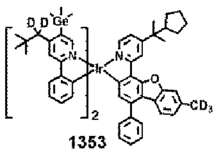
1353

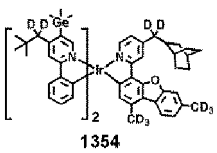
1354

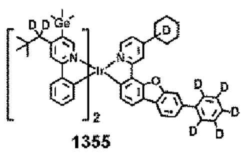
1355

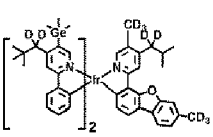
1356

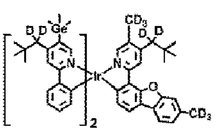
1357

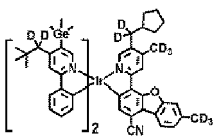
1358

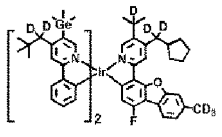
1359

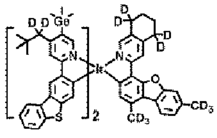
1360

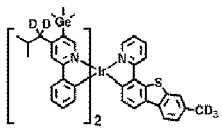
1361

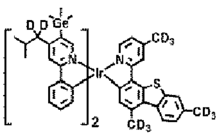
1362

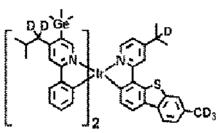
1363

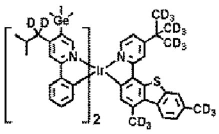
1364

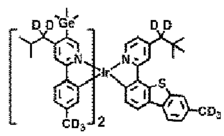
1365

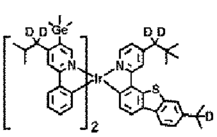
1366

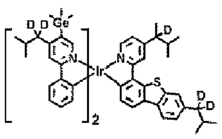
1367

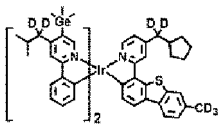
1368

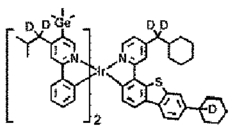
1369

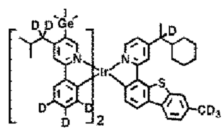
1370

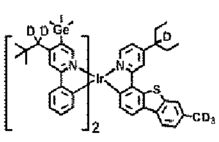
1371

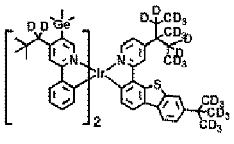
1372

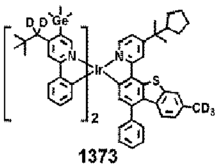
1373

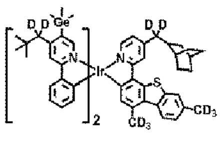
1374

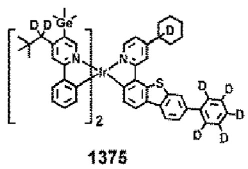
1375

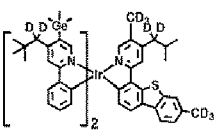
1376

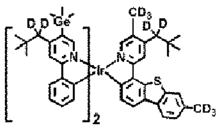
1377

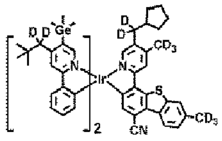
1378

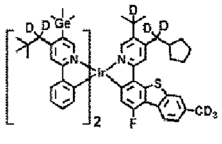
1379

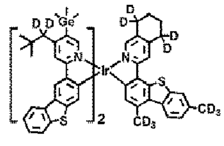
1380

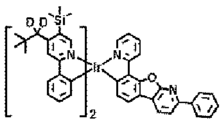
1381

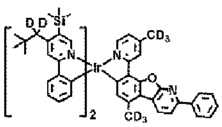
1382

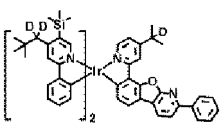
1383

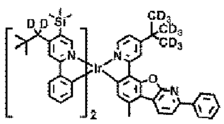
1384

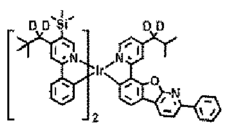
1385

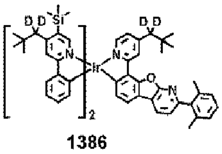
1386

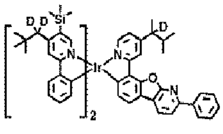
1387

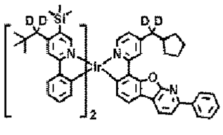
1388

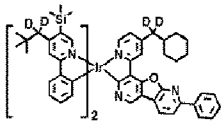
1389

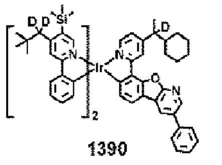
1390

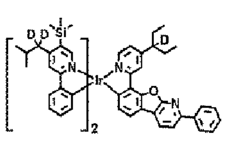
1391
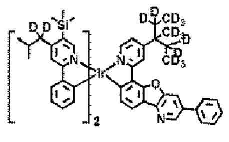
1392
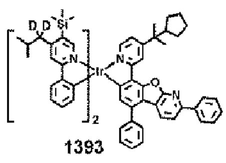
1393
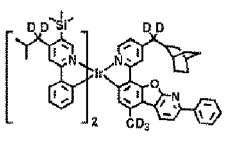
1394
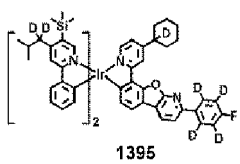
1395

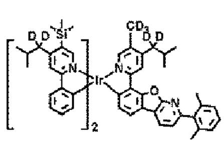
1396
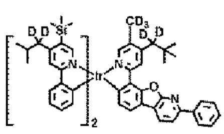
1397
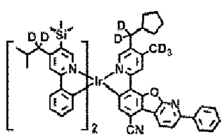
1398
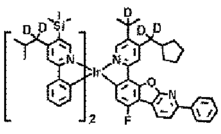
1399
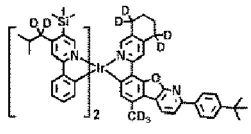
1400

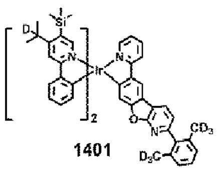
1401
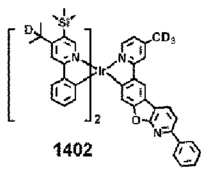
1402
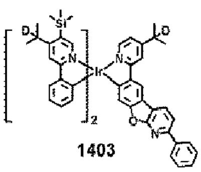
1403
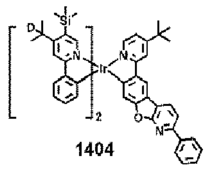
1404
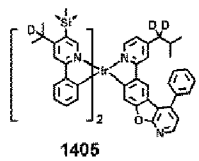
1405

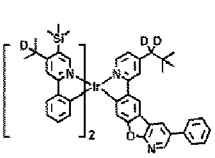
1406
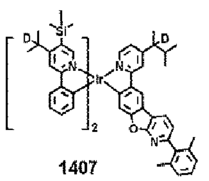
1407
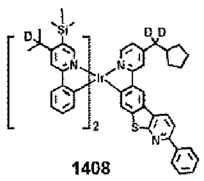
1408
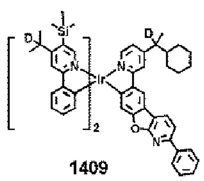
1409
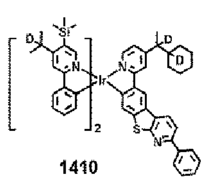
1410

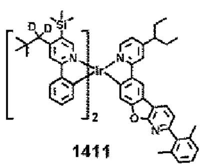
1411
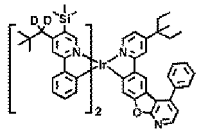
1412
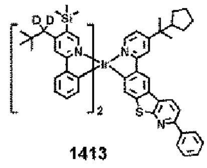
1413
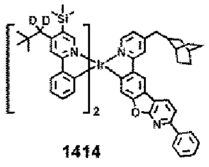
1414
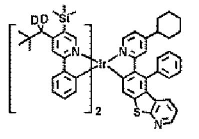
1415

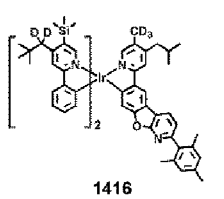
1416
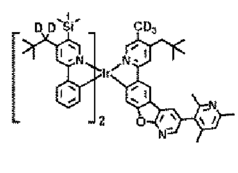
1417
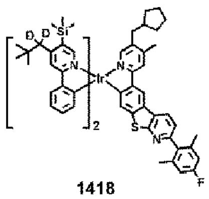
1418
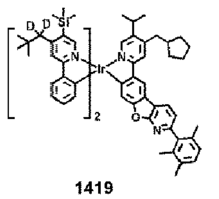
1419
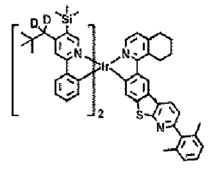
1420

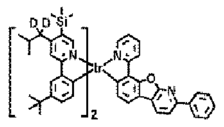
1421
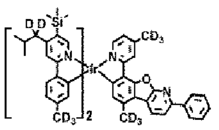
1422
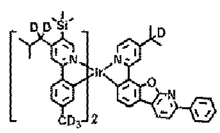
1423
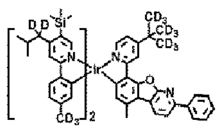
1424
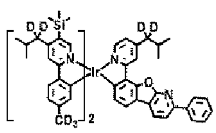
1425

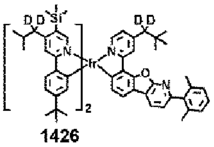
1426
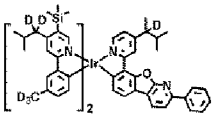
1427
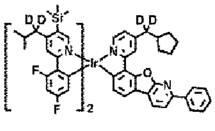
1428
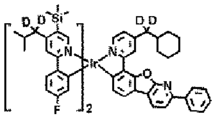
1429
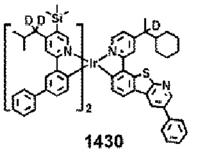
1430

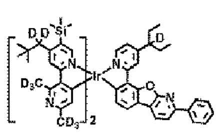
1431
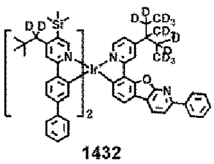
1432
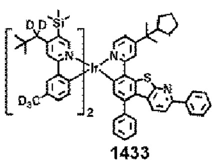
1433
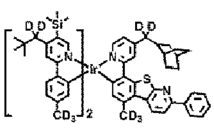
1434
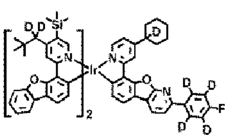
1435

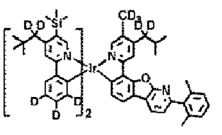
1436
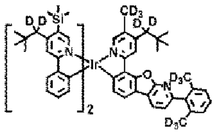
1437
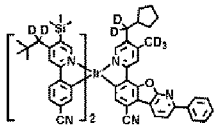
1438
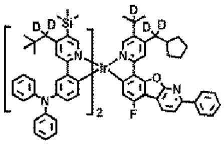
1439
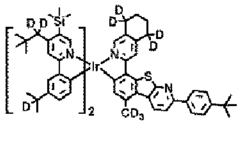
1440

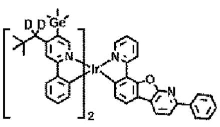
1441
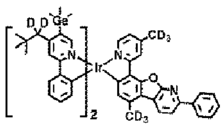
1442
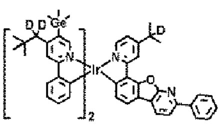
1443
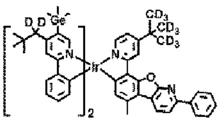
1444
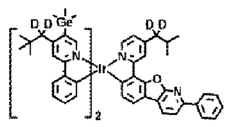
1445

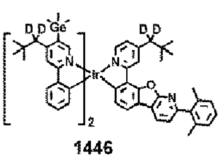
1446
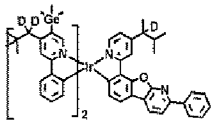
1447
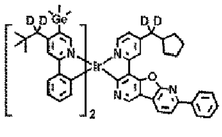
1448
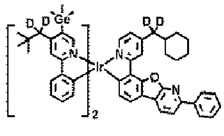
1449
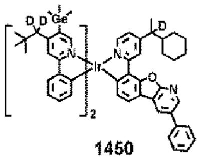
1450

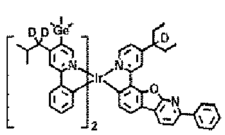
1451
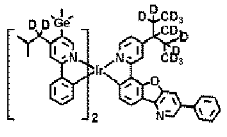
1452
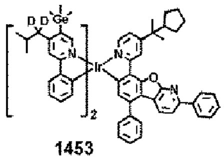
1453
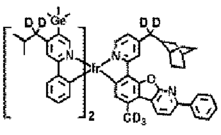
1454
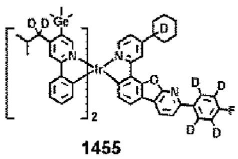
1455

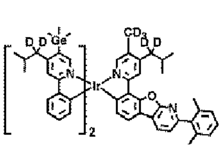
1456
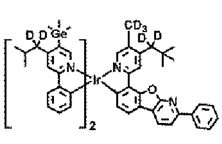
1457
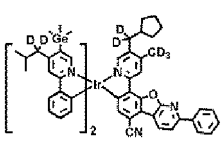
1458
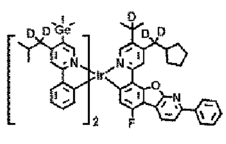
1459
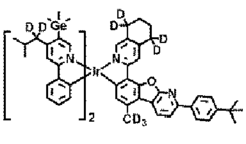
1460

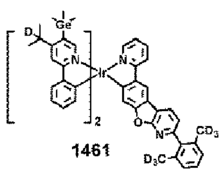
1461
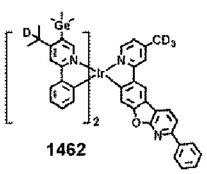
1462
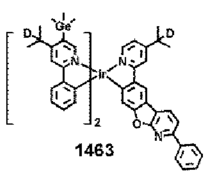
1463
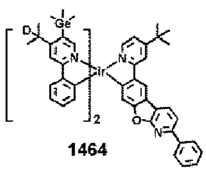
1464
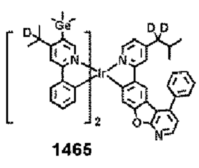
1465

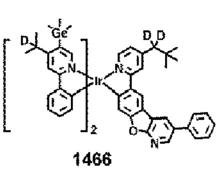
1466
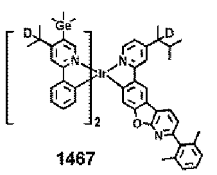
1467
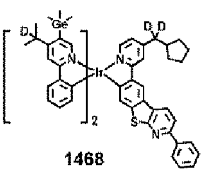
1468
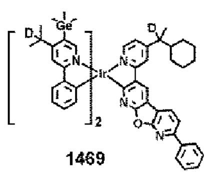
1469
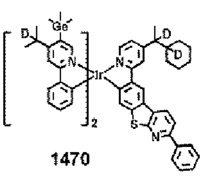
1470

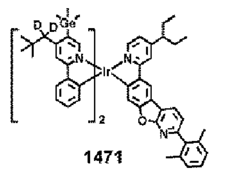
1471
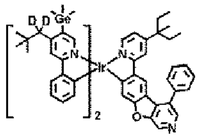
1472
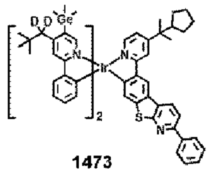
1473
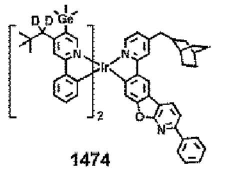
1474
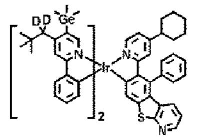
1475

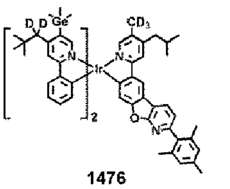
1476
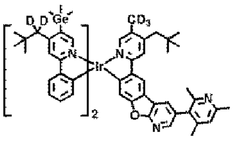
1477
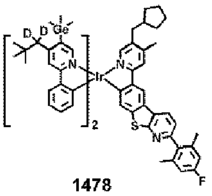
1478
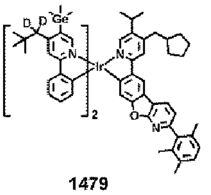
1479
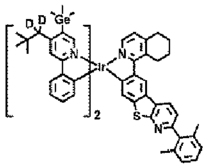
1480

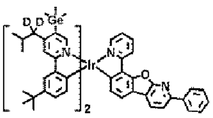
1481
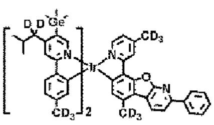
1482
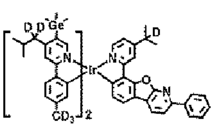
1483
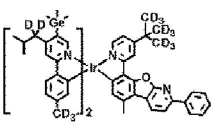
1484
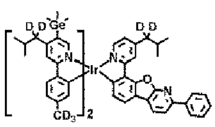
1485

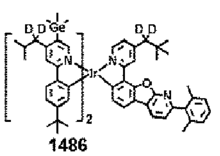
1486
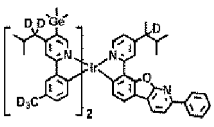
1487
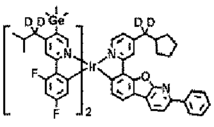
1488
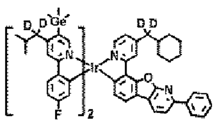
1489
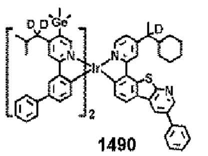
1490

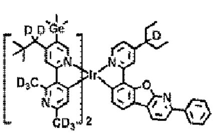
1491
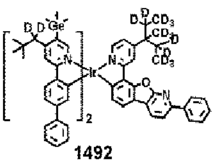
1492
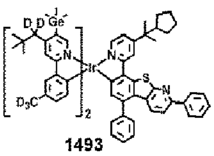
1493
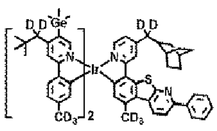
1494
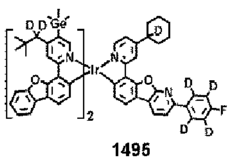
1495

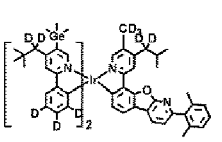
1496
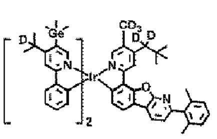
1497
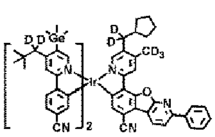
1498
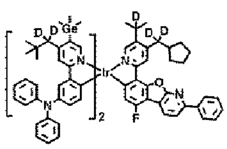
1499
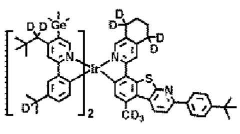
1500

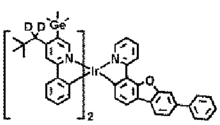
1501
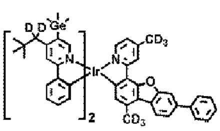
1502
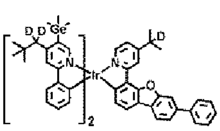
1503
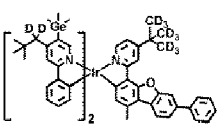
1504
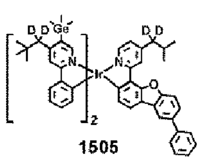
1505

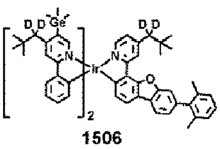
1506
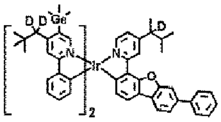
1507
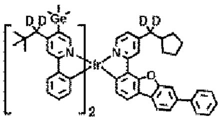
1508
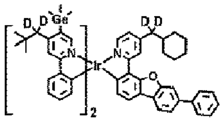
1509
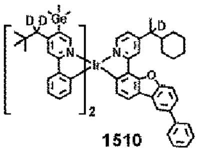
1510

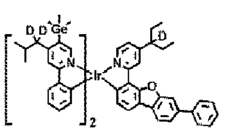
1511
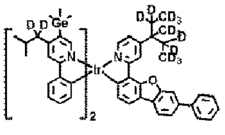
1512
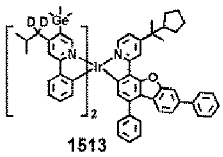
1513
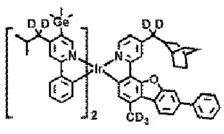
1514
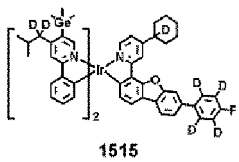
1515

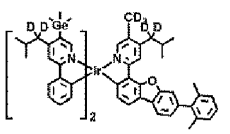
1516
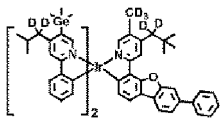
1517
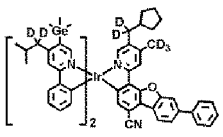
1518
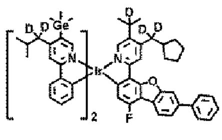
1519
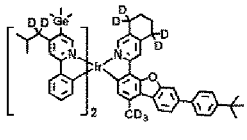
1520

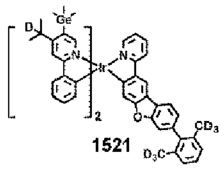
1521
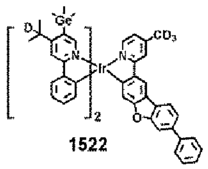
1522
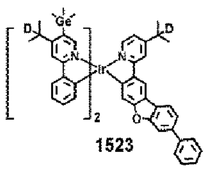
1523
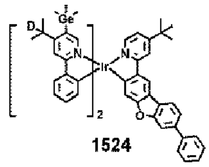
1524
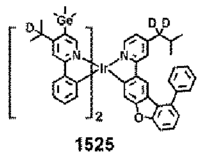
1525

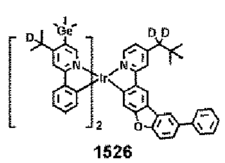
1526
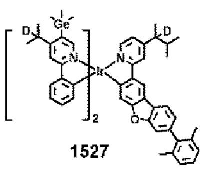
1527
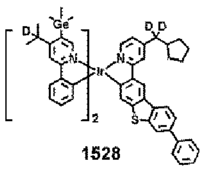
1528
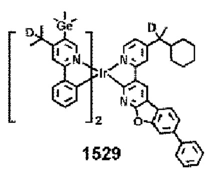
1529
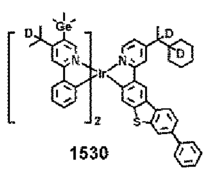
1530

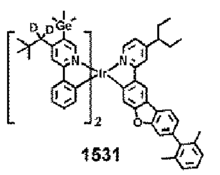
1531
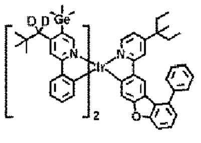
1532
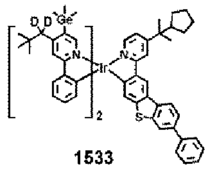
1533
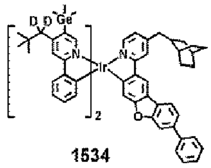
1534
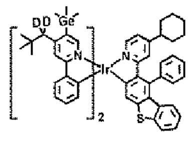
1535

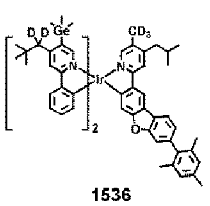
1536
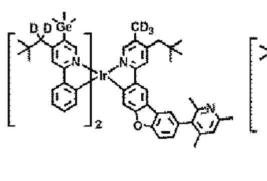
1537
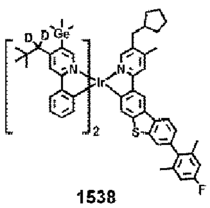
1538
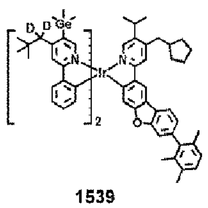
1539
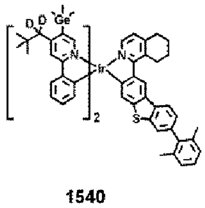
1540

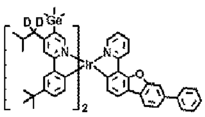
1541
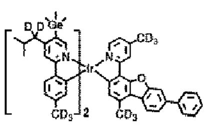
1542
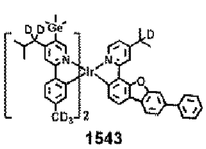
1543
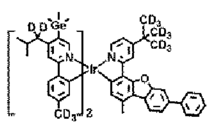
1544
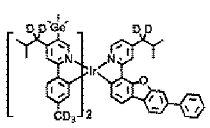
1545

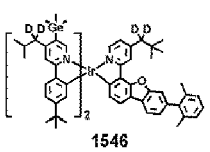
1546
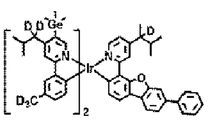
1547
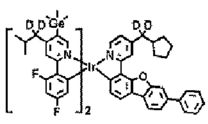
1548
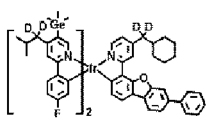
1549
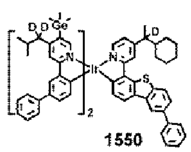
1550

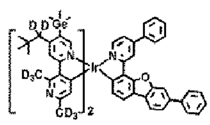
1551

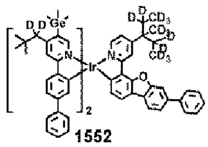
1552

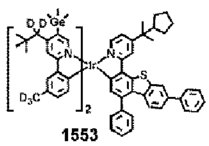
1553

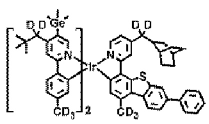
1554

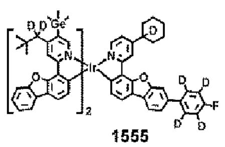
1555

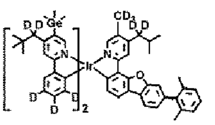
1556

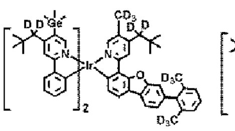
1557

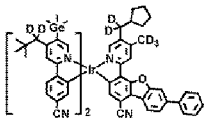
1558

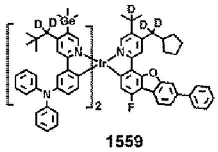
1559

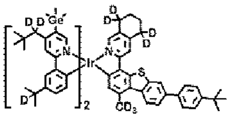
1560

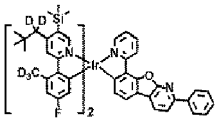
1561

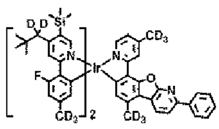
1562

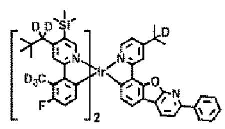
1563

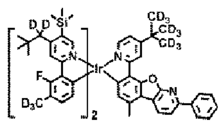
1564

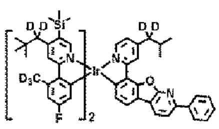
1565

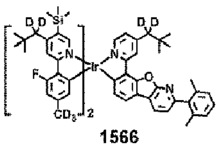
1566

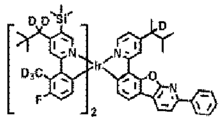
1567

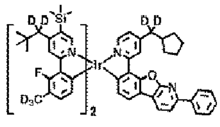
1568

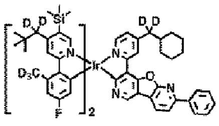
1569

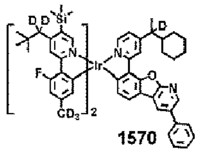
1570

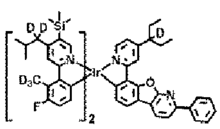
1571

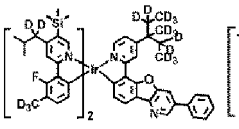
1572

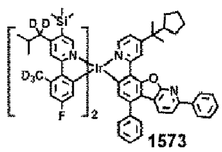
1573

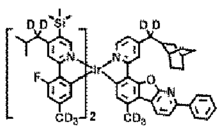
1574

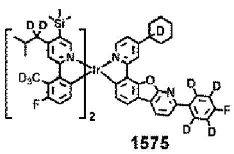
1575

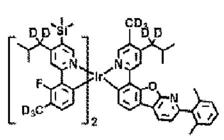
1576

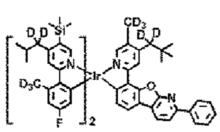
1577

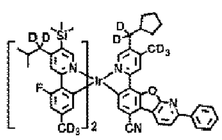
1578

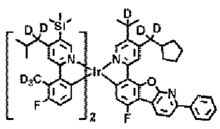
1579

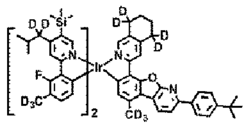
1580

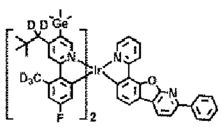
1581

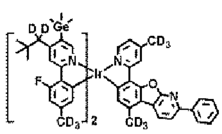
1582

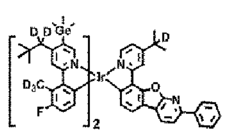
1583

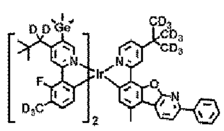
1584

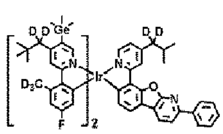
1585

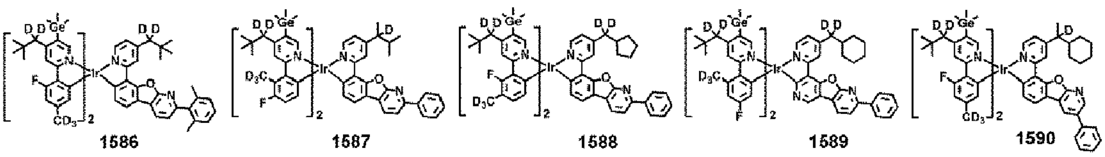
1586 1587 1588 1589 1590

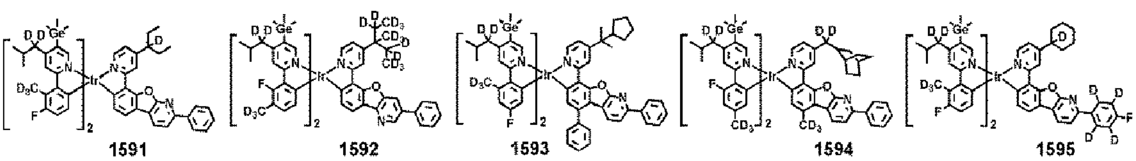
1591 1592 1593 1594 1595

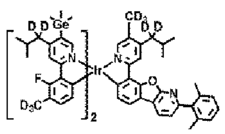 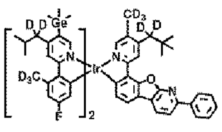 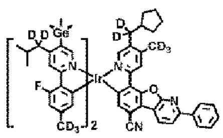 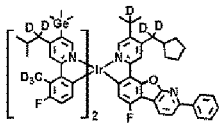 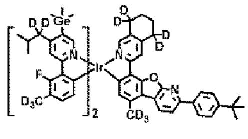

1596 1597 1598 1599 1600

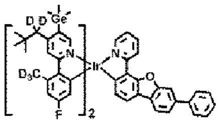 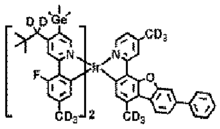 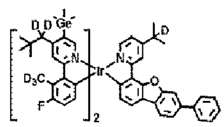 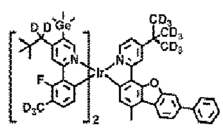 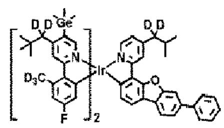

1601 1602 1603 1604 1605

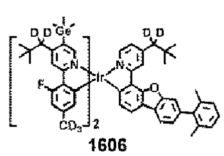 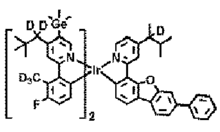 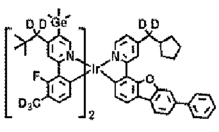 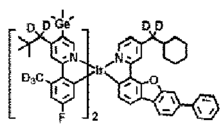 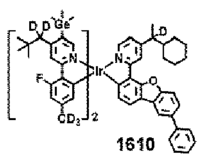

1606 1607 1608 1609 1610

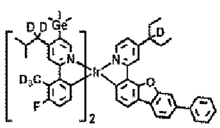 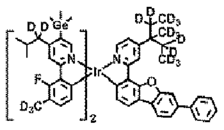 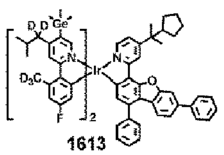 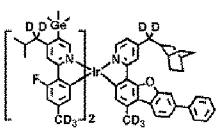 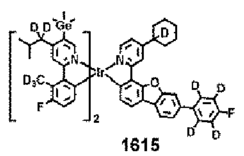

1611 1612 1613 1614 1615

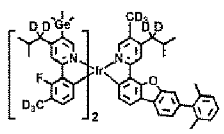 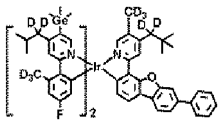 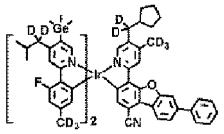 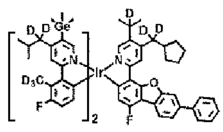 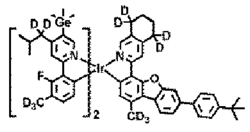

1616 1617 1618 1619 1620

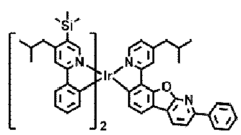

1621

In compounds 1 to 1621 of [Group 1-1], OMe represents a methoxy group. Group 1-2

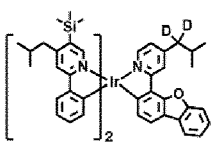 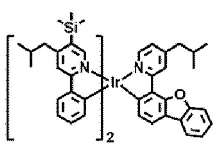 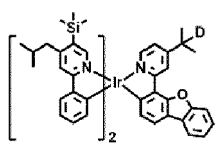 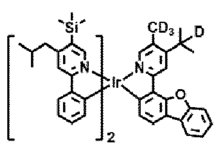

1 2 3 4

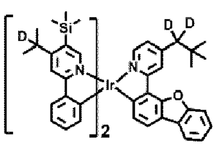 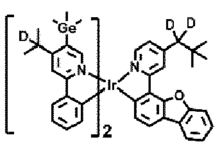 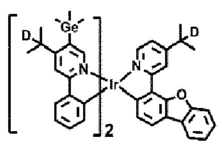 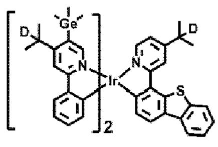

5 6 7 8

Group 1-3

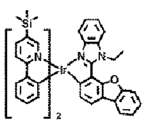
1
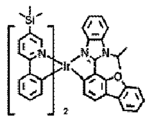
2
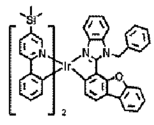
3
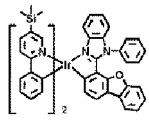
4
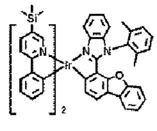
5

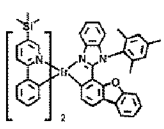
6
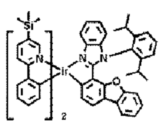
7
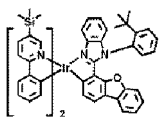
8
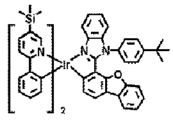
9
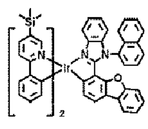
10

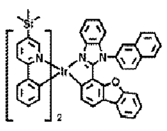
11
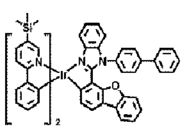
12
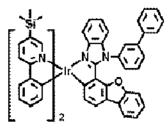
13
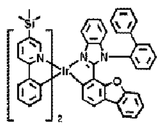
14
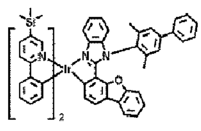
15

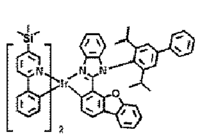
16
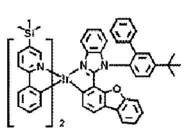
17
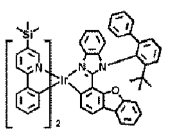
18
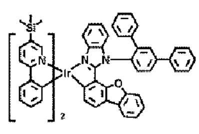
19
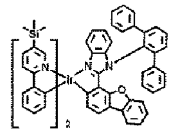
20

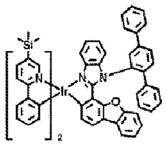
21
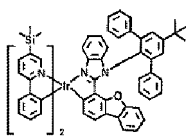
22
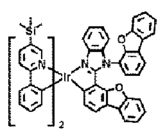
23
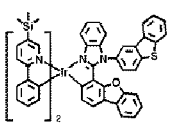
24
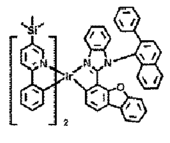
25

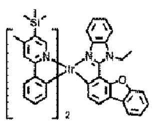
26
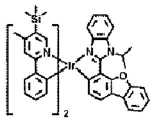
27
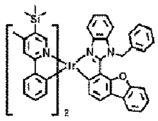
28
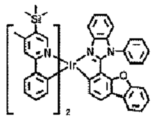
29
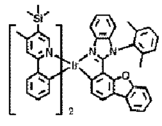
30

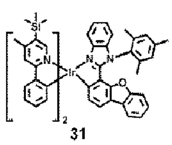
31
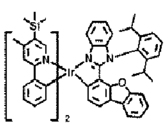
32
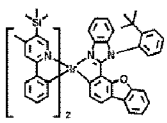
33
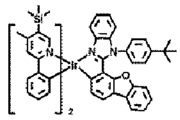
34
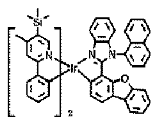
35

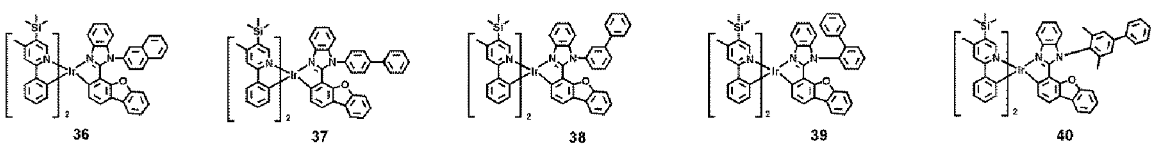
36 37 38 39 40

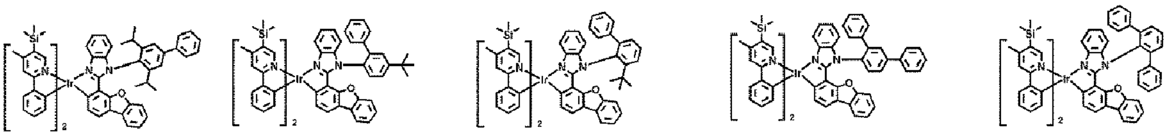
41 42 43 44 45

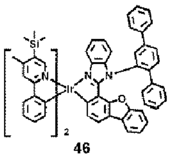
46
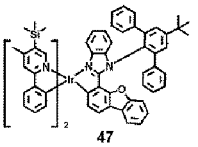
47
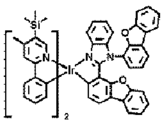
48
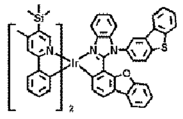
49
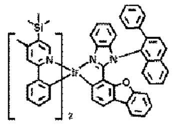
50
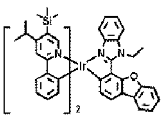
51
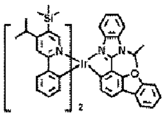
52
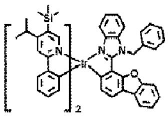
53
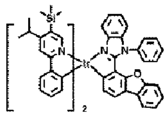
54
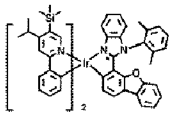
55
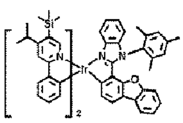
56
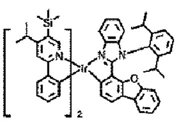
57
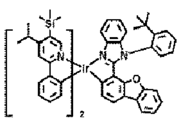
58
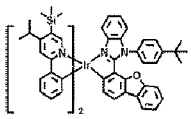
59
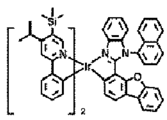
60
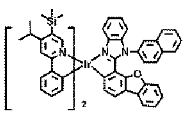
61
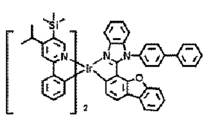
62
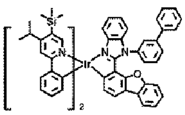
63
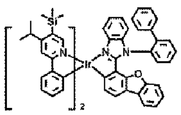
64
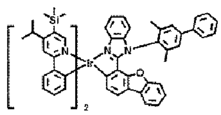
65
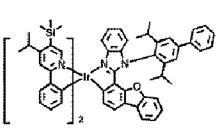
66
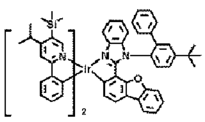
67
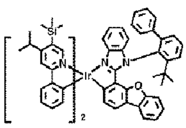
68
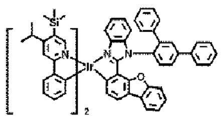
69
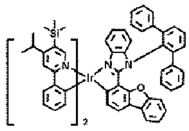
70
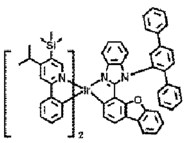
71
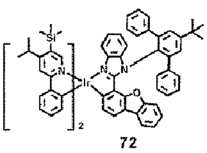
72
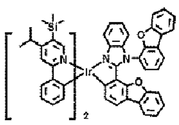
73
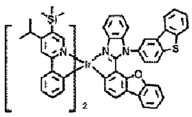
74
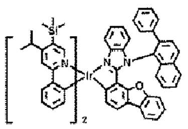
75
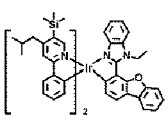
76
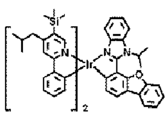
77
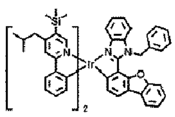
78
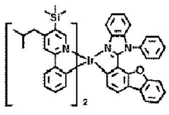
79
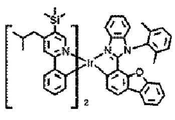
80
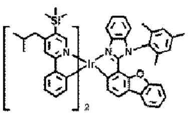
81
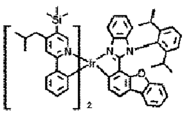
82
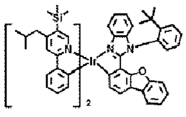
83
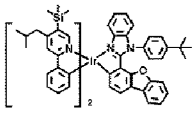
84
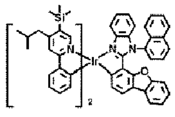
85
86
87
88
89
90

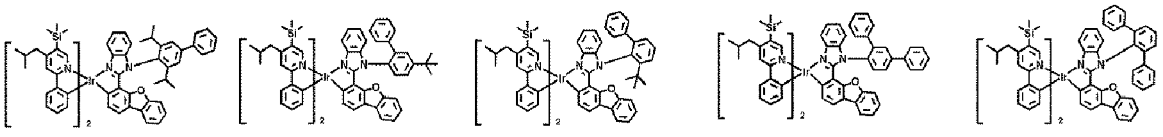

91 92 93 94 95

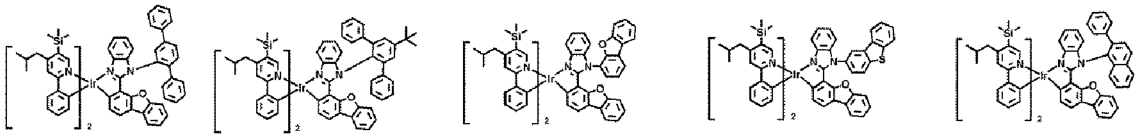

96 97 98 99 100

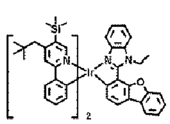

101

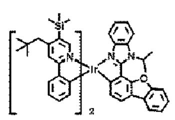

102

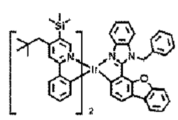

103

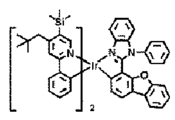

104

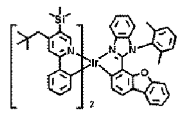

105

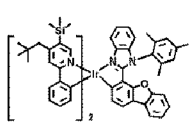

106

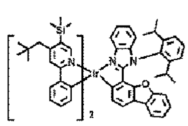

107

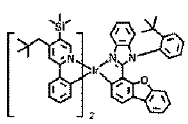

108

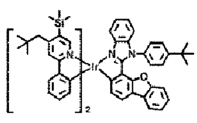

109

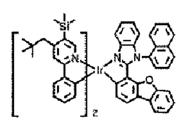

110

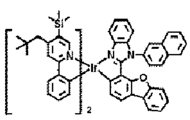

111

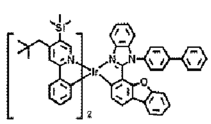

112

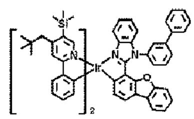

113

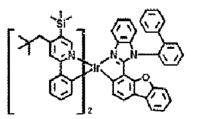

114

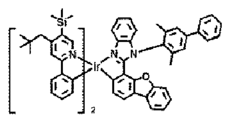

115

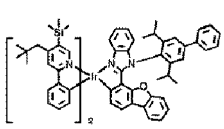

116

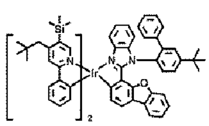

117

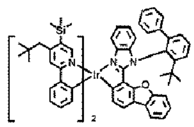

118

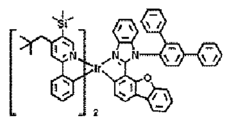

119

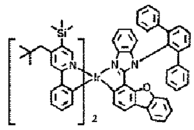

120

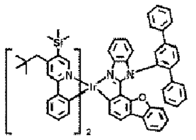

121

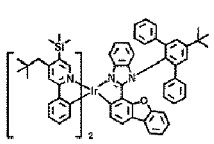

122

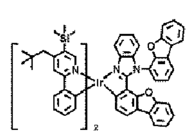

123

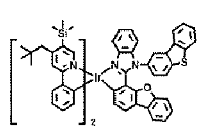

124

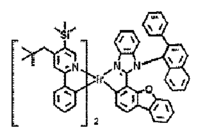

125

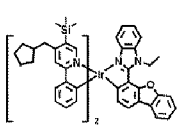

126

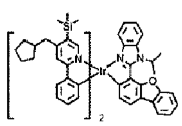

127

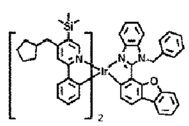

128

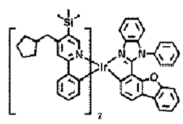

129

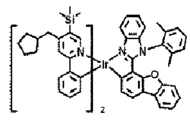

130

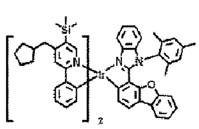

131

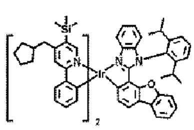

132

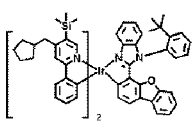

133

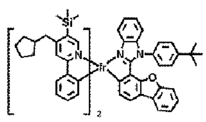

134

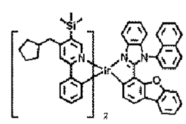

135

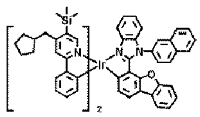
136
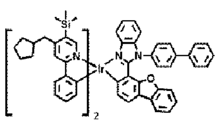
137
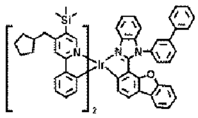
138
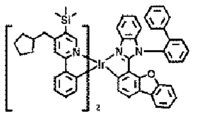
139
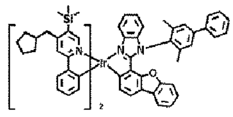
140

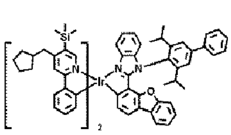
141
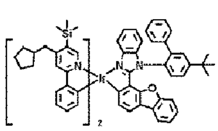
142
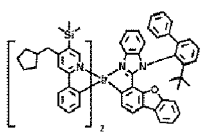
143
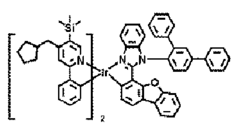
144
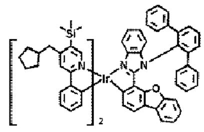
145

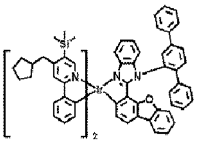
146
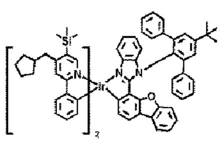
147
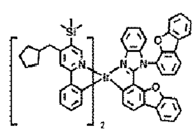
148
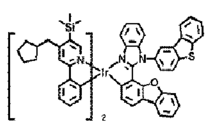
149
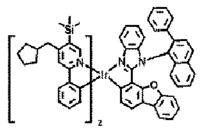
150

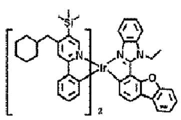
151
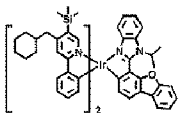
152
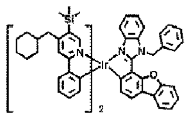
153
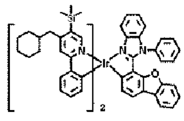
154
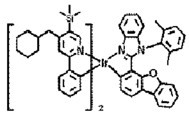
155

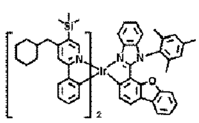
156
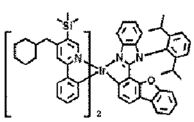
157
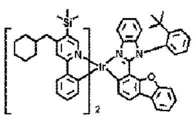
158
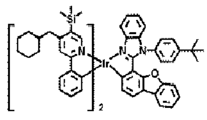
159
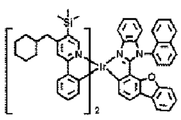
160

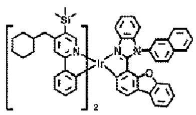
161
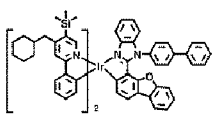
162
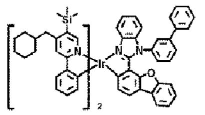
163
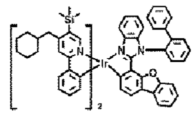
164
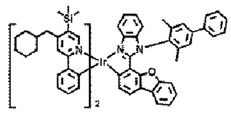
165

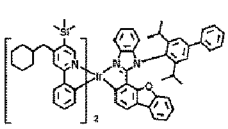
166
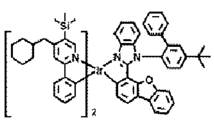
167
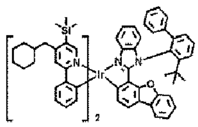
168
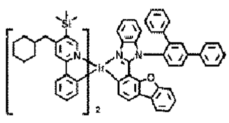
169
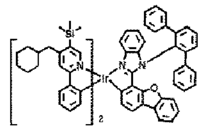
170

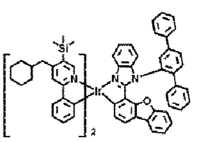
171
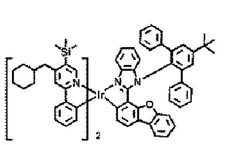
172
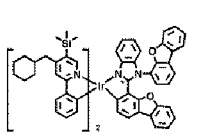
173
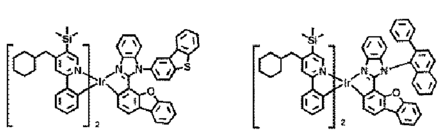
174
175

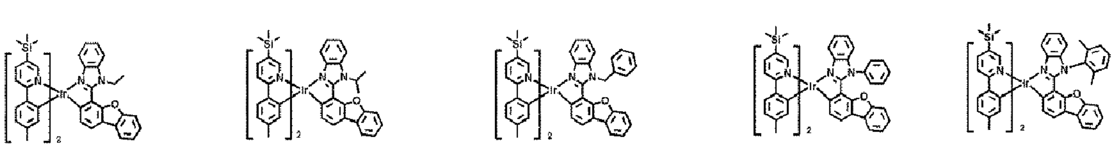
176
177
178
179
180

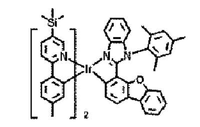
181
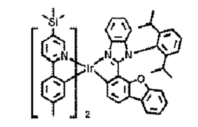
182
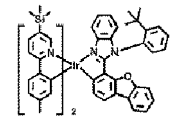
183
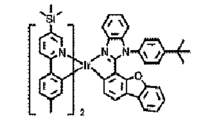
184
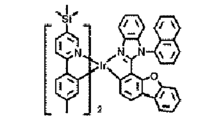
185

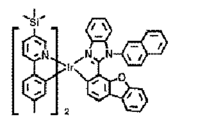
186
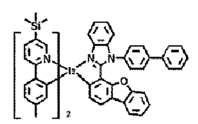
187
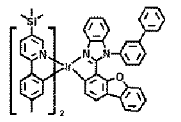
188
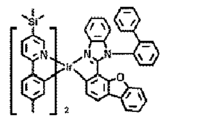
189
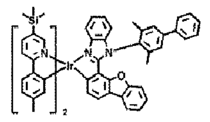
190

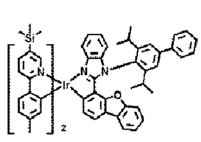
191
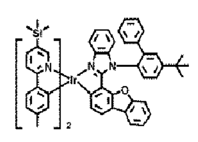
192
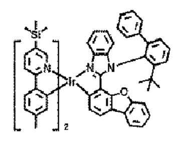
193
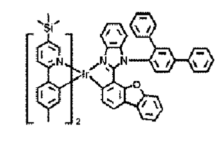
194
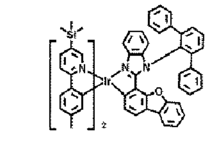
195

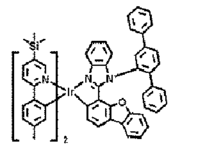
196
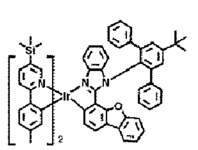
197
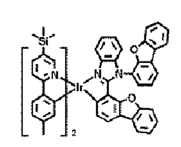
198
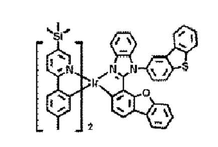
199
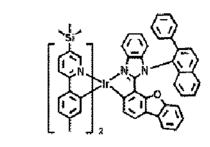
200

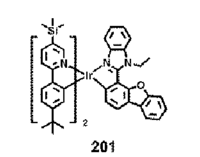
201
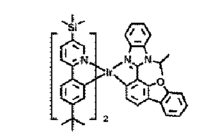
202
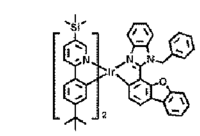
203
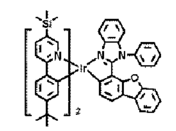
204
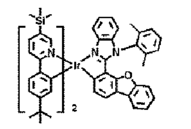
205

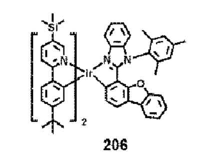
206
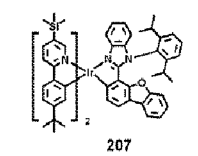
207
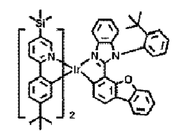
208
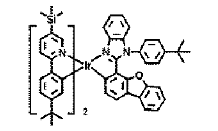
209
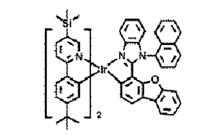
210

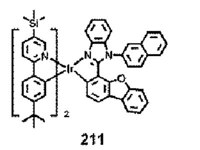
211
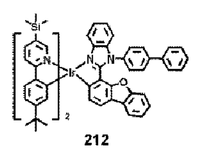
212
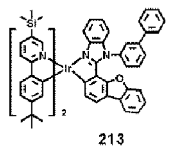
213
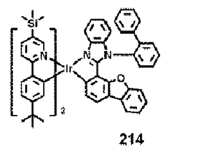
214
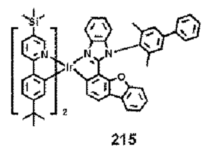
215

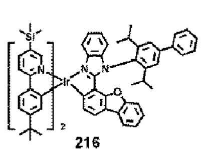
216
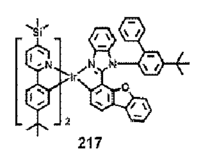
217
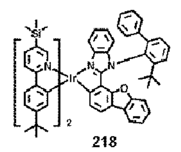
218
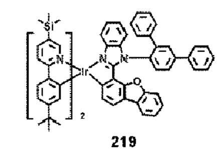
219
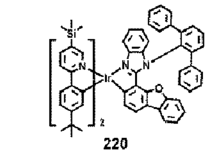
220

221
222
223
224
225

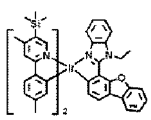
226
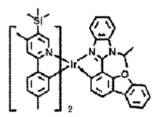
227
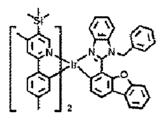
228
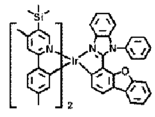
229
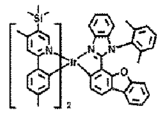
230

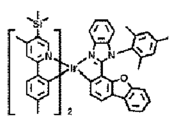
231
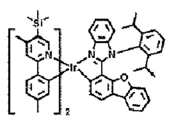
232
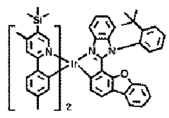
233
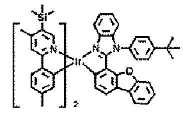
234
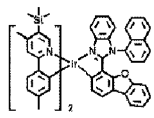
235

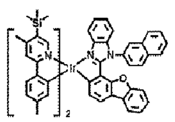
236
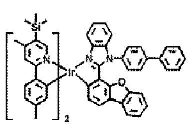
237
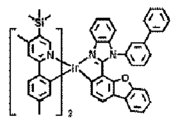
238
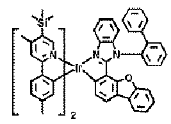
239
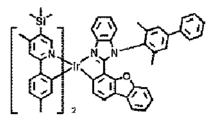
240

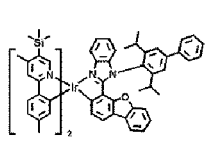
241
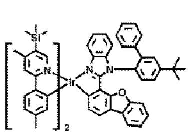
242
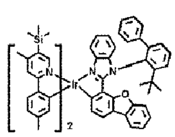
243
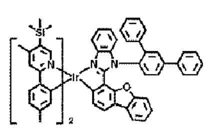
244
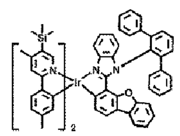
245

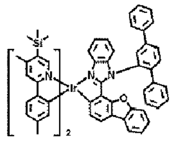
246
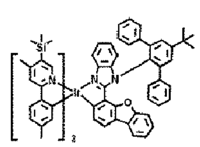
247
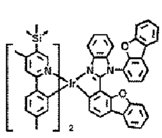
248
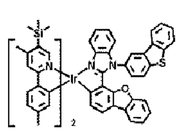
249
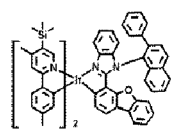
250

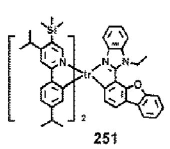
251
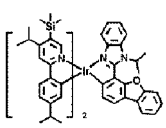
252
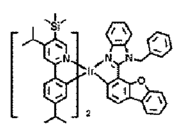
253
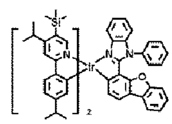
254
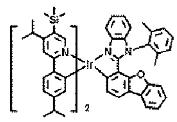
255

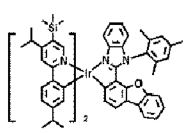
256
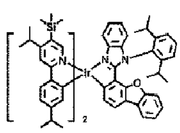
257
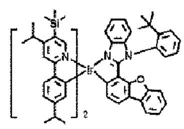
258
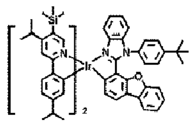
259
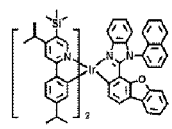
260

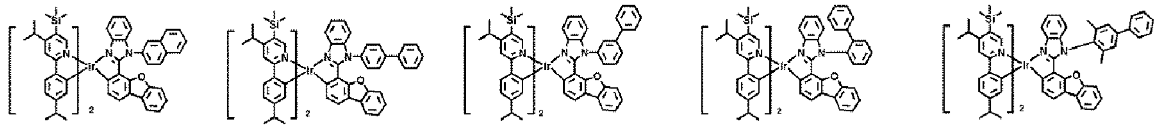
261
262
263
264
265

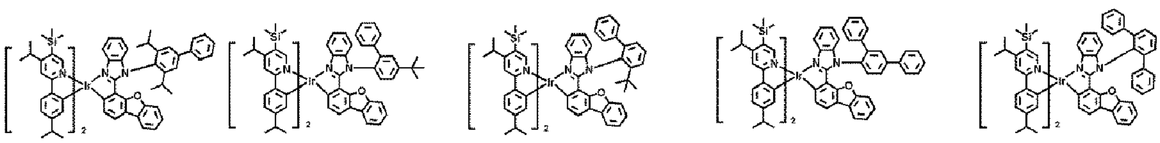
266
267
268
269
270

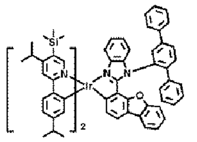
271

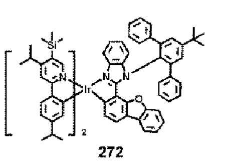
272

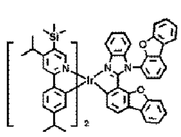
273

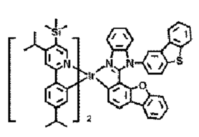
274

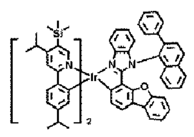
275

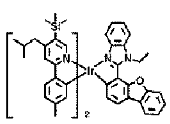
276

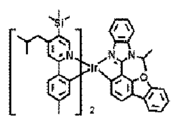
277

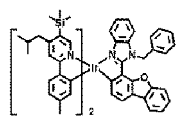
278

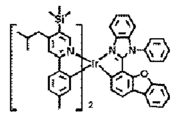
279

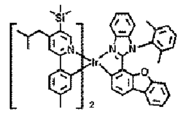
280

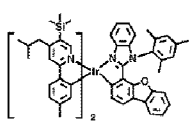
281

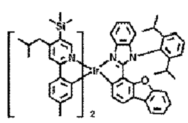
282

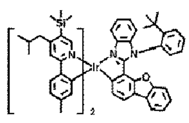
283

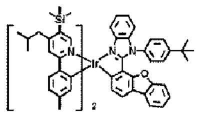
284

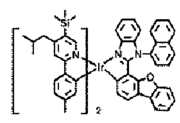
285

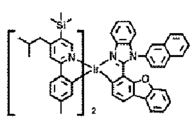
286

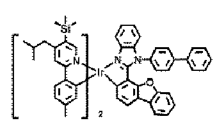
287

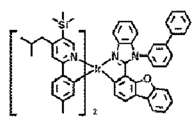
288

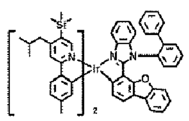
289

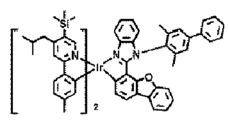
290

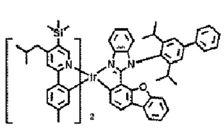
291

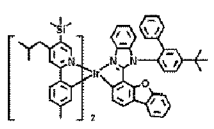
292

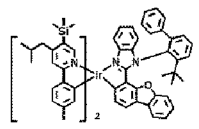
293

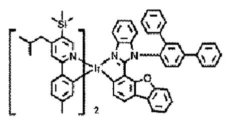
294

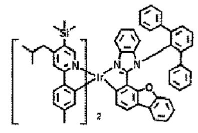
295

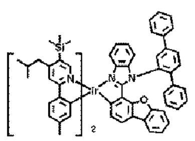
296

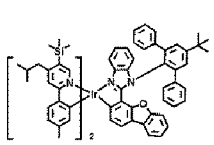
297

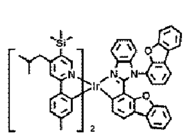
298

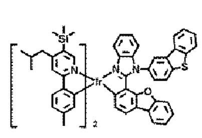
299

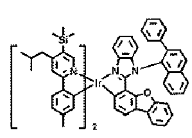
300

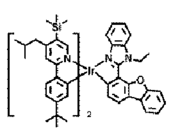
301

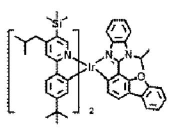
302

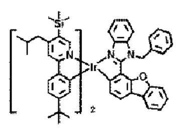
303

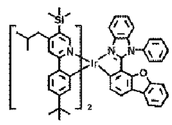
304

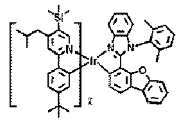
305

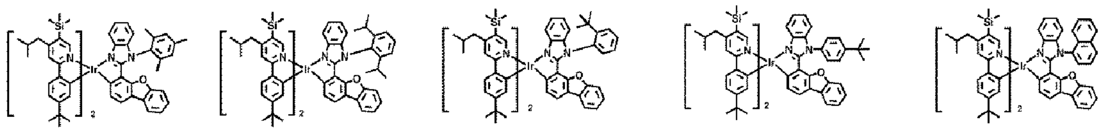
306 307 308 309 310

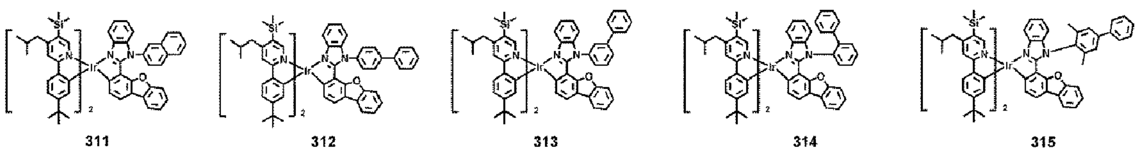
311 312 313 314 315

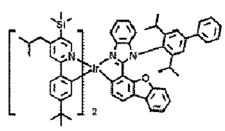
316
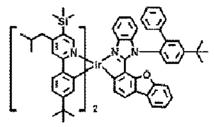
317
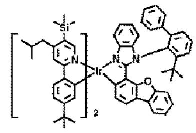
318
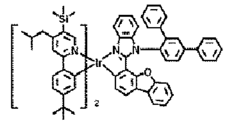
319
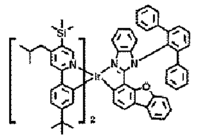
320

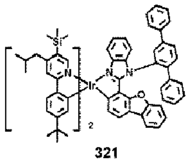
321
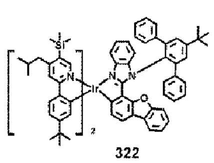
322
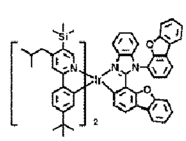
323
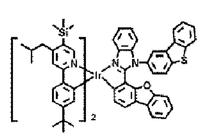
324
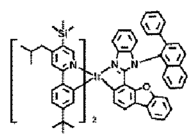
325

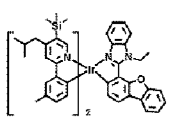
326
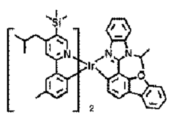
327
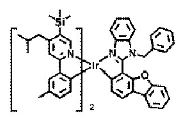
328
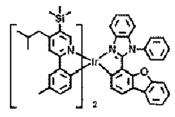
329
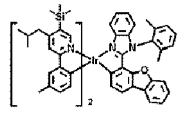
330

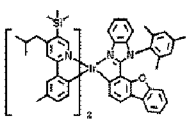
331
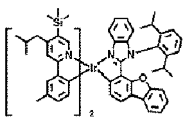
332
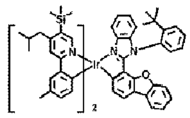
333
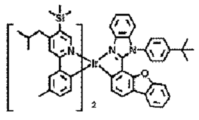
334
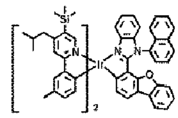
335

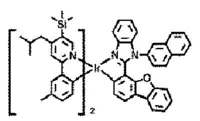
336
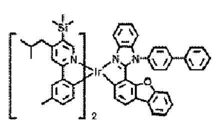
337
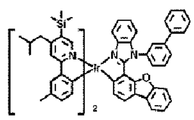
338
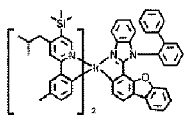
339
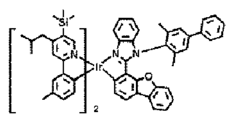
340

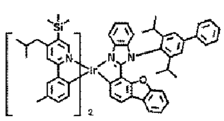
341
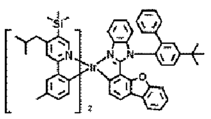
342
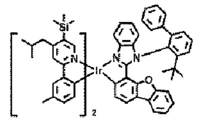
343
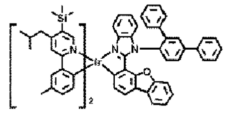
343
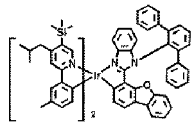
345

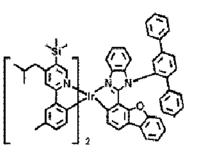
346
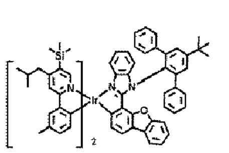
347
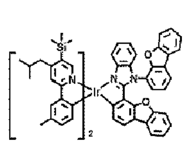
348
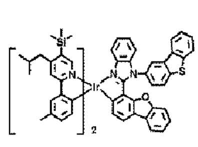
349
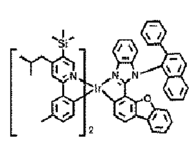
350

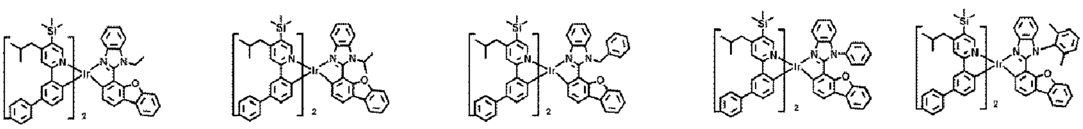
351 352 353 354 355

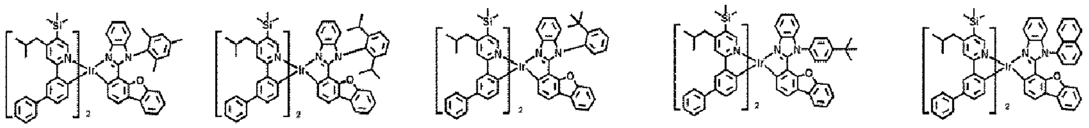
356 357 358 359 360

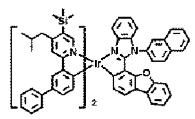
361

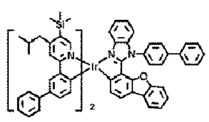
362

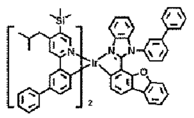
363

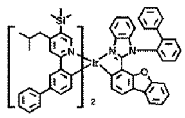
364

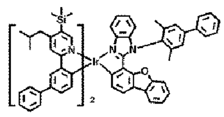
365

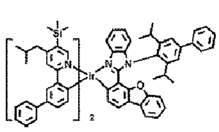
366

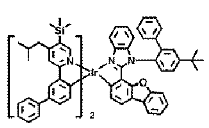
367

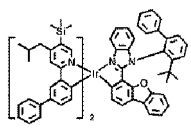
368

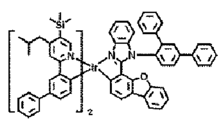
369

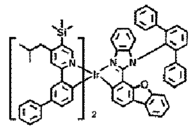
370

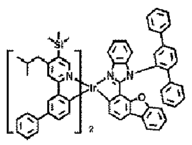
371

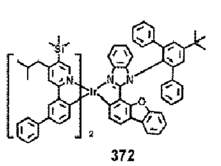
372

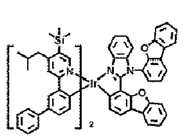
373

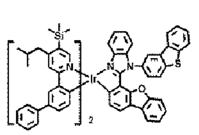
374

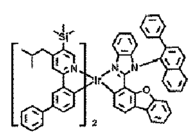
375

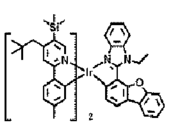
376

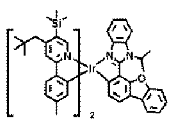
377

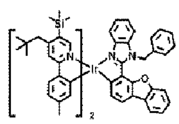
378

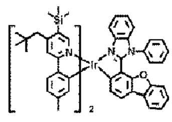
379

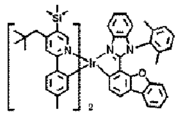
380

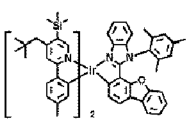
381

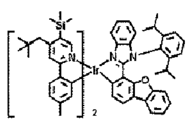
382

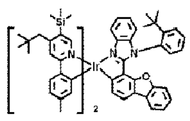
383

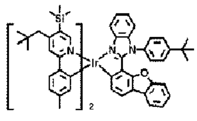
384

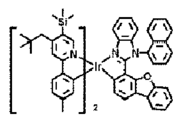
385

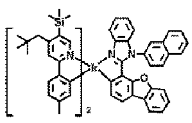
386

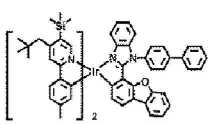
387

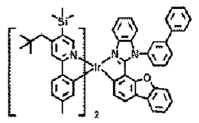
388

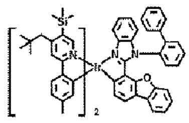
389

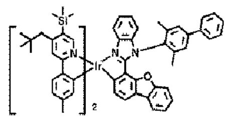
390

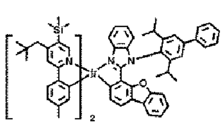
391

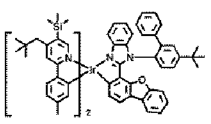
392

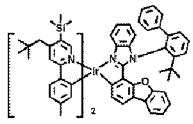
393

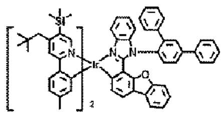
394

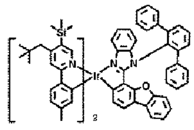
395

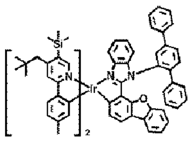
396

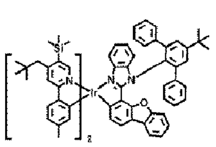
397

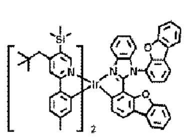
398

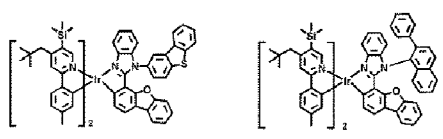
399

400

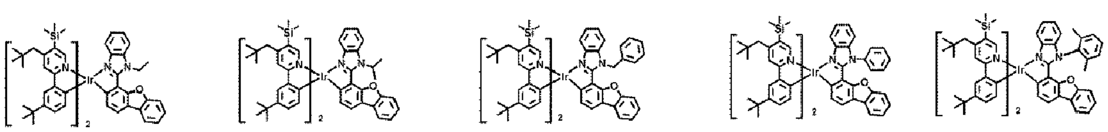
401

402

403

404

405

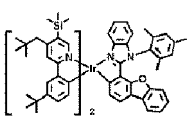
406
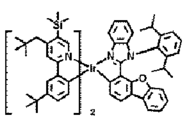
407
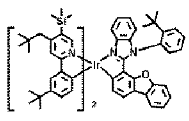
408
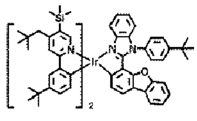
409
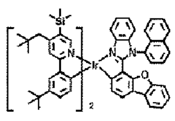
410

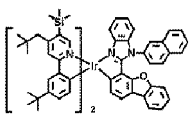
411
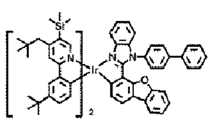
412
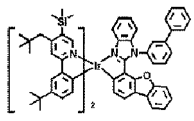
413
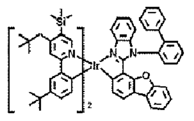
414
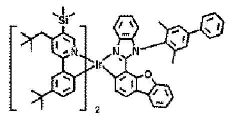
415

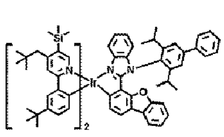
416
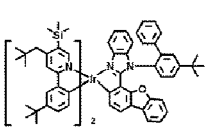
417
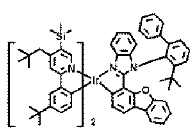
418
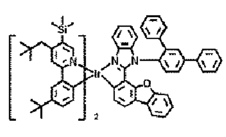
419
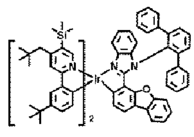
420

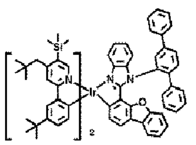
421
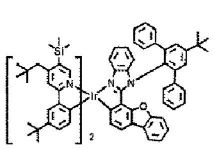
422
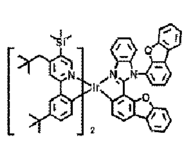
423
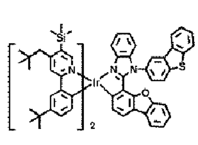
424
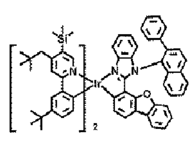
425

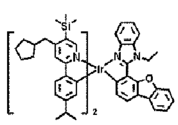
426
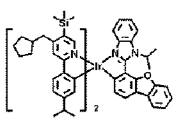
427
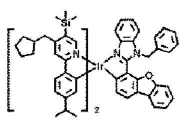
428
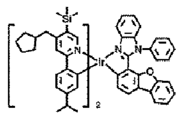
429
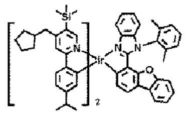
430

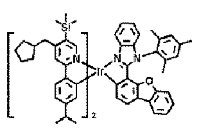
431
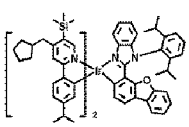
432
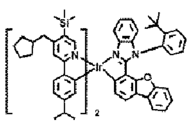
433
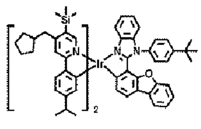
434
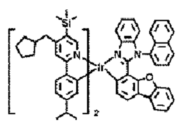
435

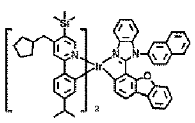
436
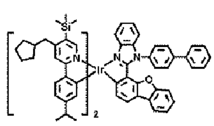
437
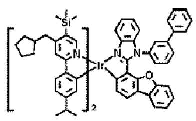
438
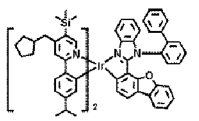
439
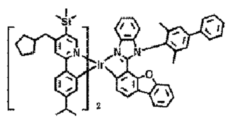
440

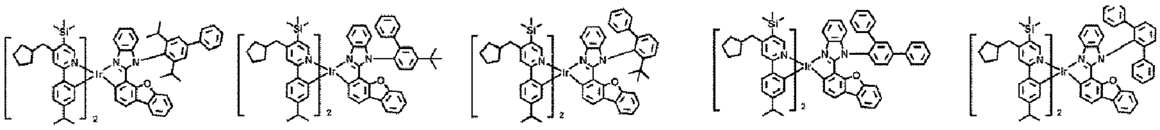
441
442
443
444
445

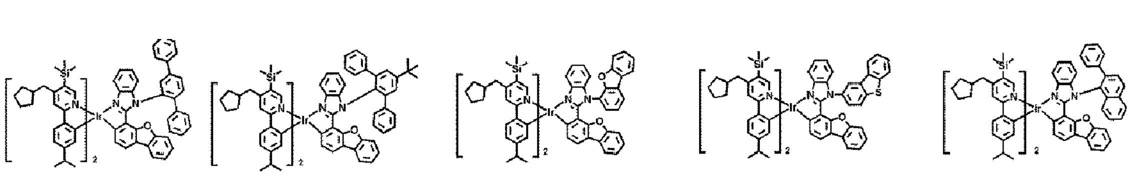
446
447
448
449
450

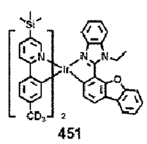
451

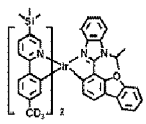
452

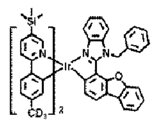
453

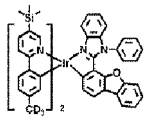
454

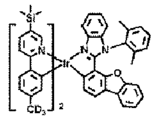
455

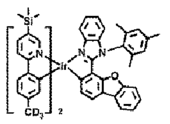
456

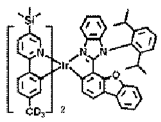
457

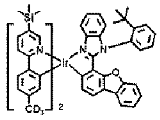
458

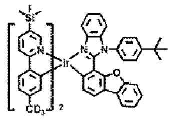
459

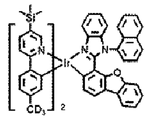
460

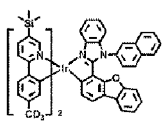
461

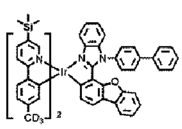
462

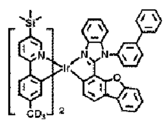
463

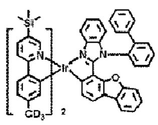
464

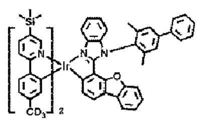
465

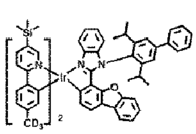
466

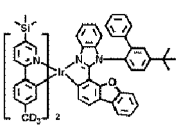
467

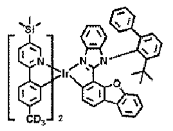
468

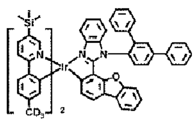
469

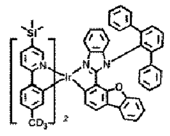
470

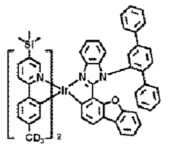
471

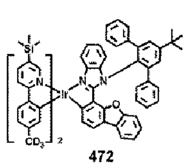
472

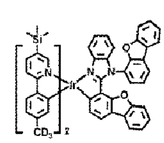
473

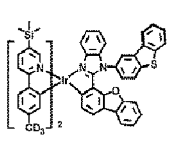
474

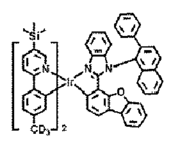
475

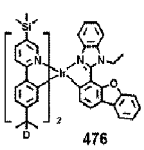
476

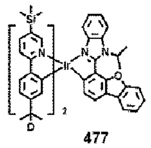
477

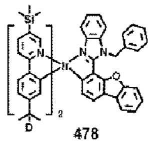
478

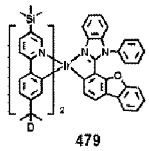
479

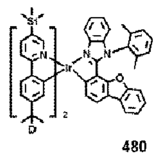
480

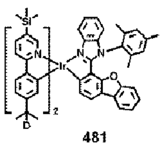
481

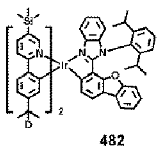
482

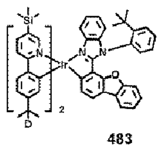
483

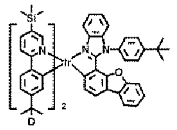
484

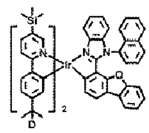
485

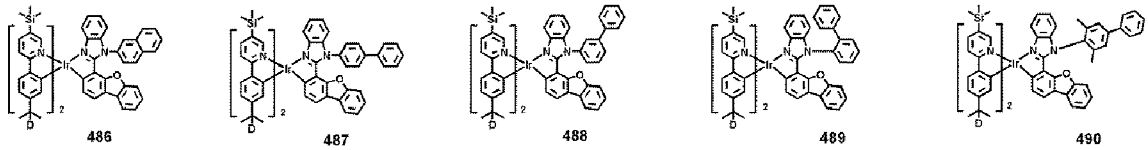
486 487 488 489 490

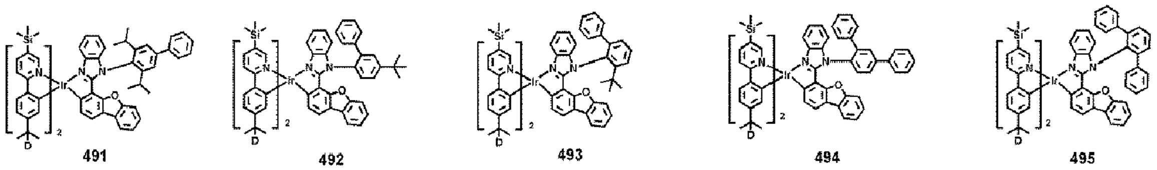
491 492 493 494 495

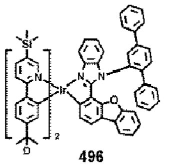
496
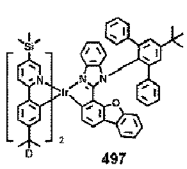
497
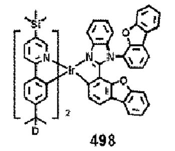
498
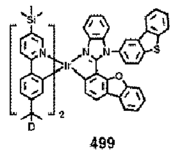
499
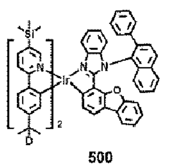
500

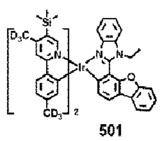
501
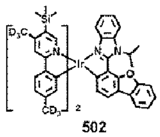
502
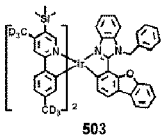
503
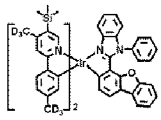
504
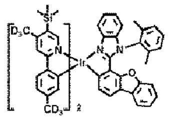
505

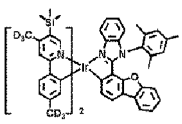
506
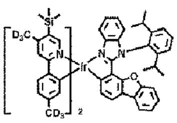
507
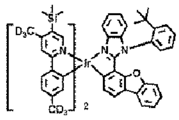
508
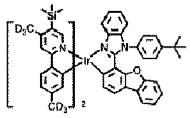
509
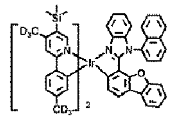
510

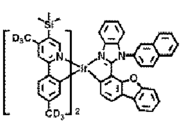
511
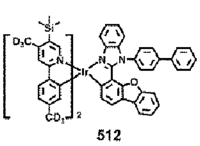
512
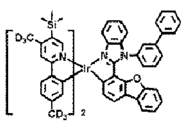
513
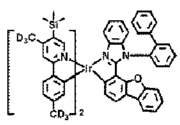
514
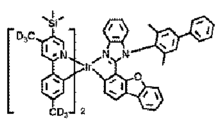
515

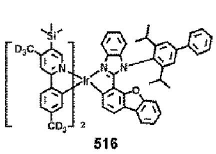
516
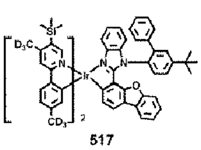
517
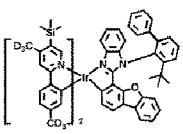
518
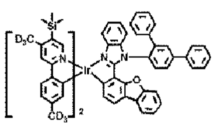
519
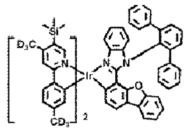
520

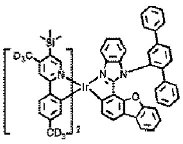
521
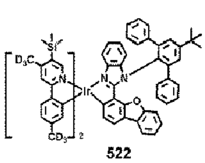
522
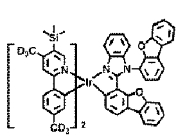
523
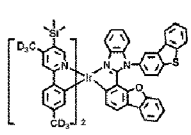
524
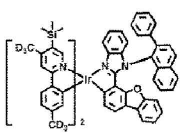
525

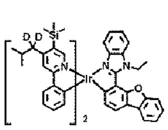
526
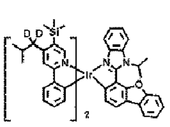
527
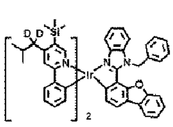
528
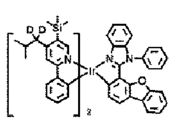
529
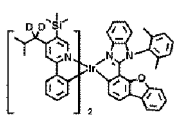
530

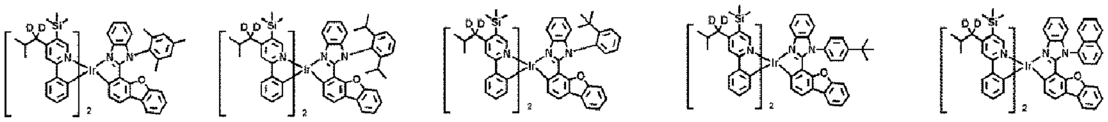
531
532
533
534
535

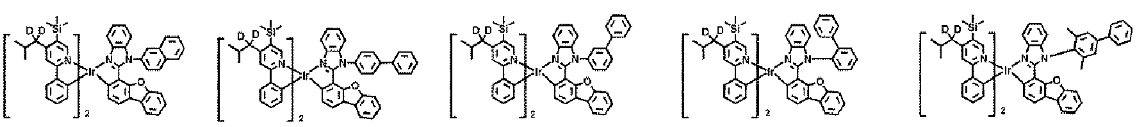
536
537
538
539
540

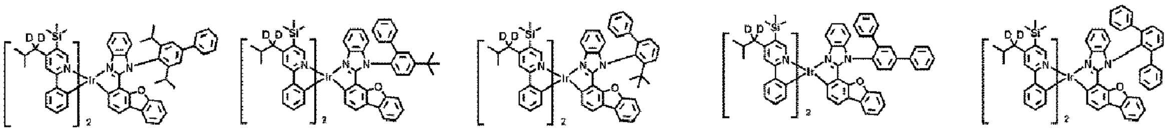
541 542 543 544 545

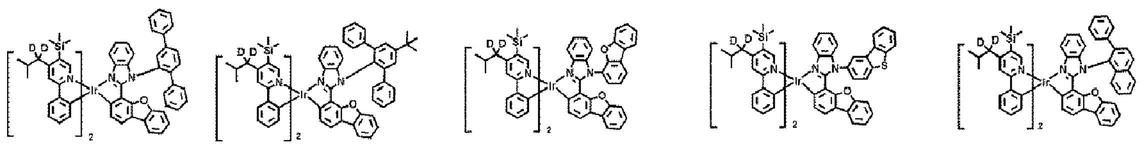
546 547 548 549 550

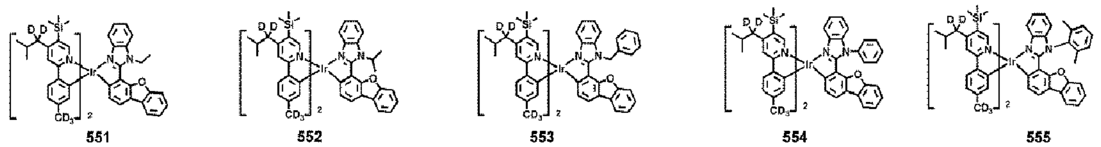
551 552 553 554 555

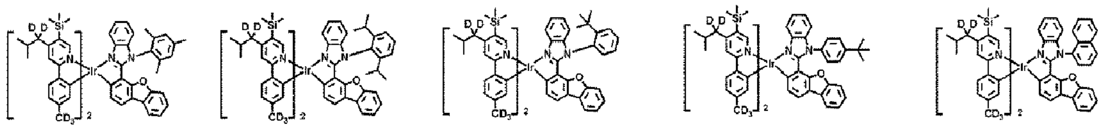
556 557 558 559 560

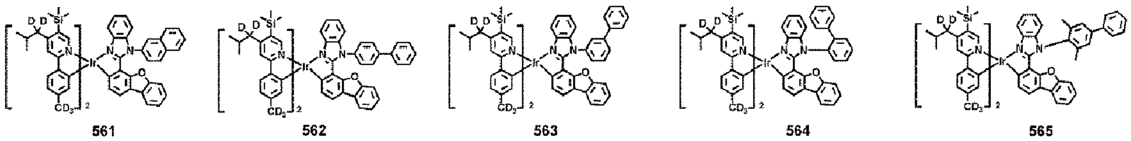
561 562 563 564 565

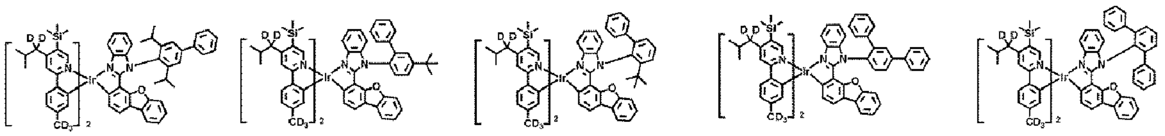
566 567 568 569 570

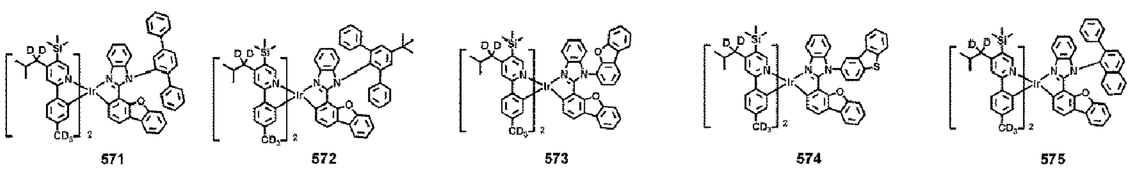
571 572 573 574 575

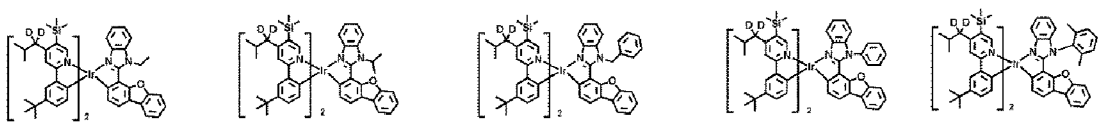
576 577 578 579 580

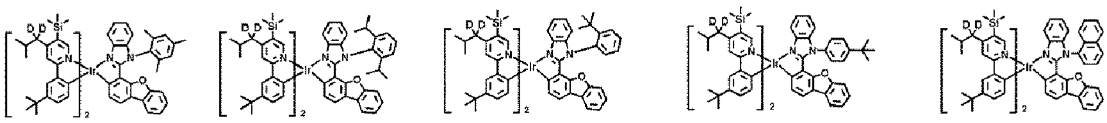
581 582 583 584 585

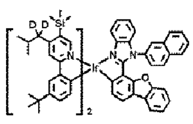
586
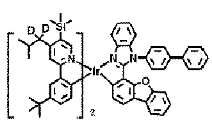
587
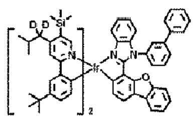
588
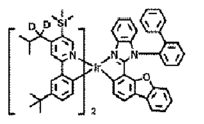
589
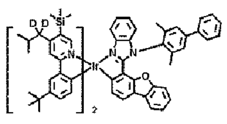
590

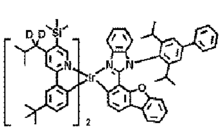
591
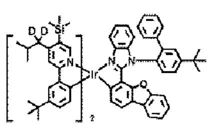
592
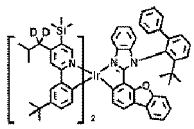
593
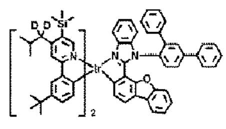
594
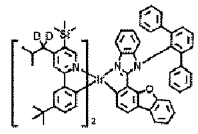
595

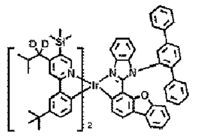
596
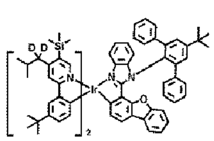
597
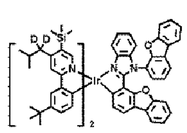
598
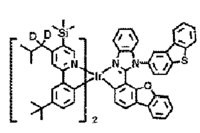
599
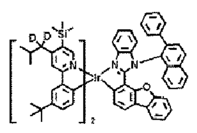
600

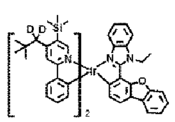
601
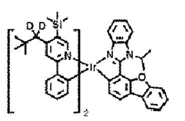
602
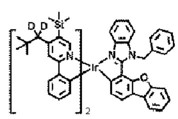
603
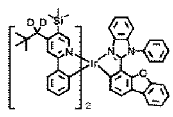
604
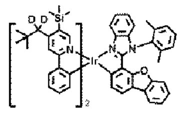
605

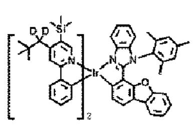
606
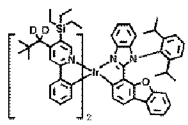
607
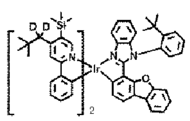
608
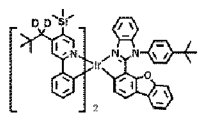
609
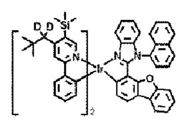
610

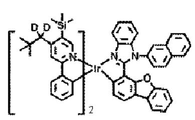
611
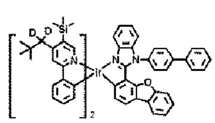
612
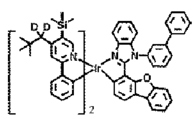
613
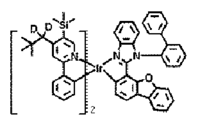
614
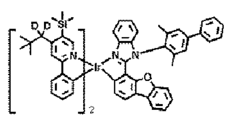
615

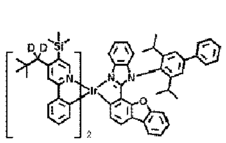
616
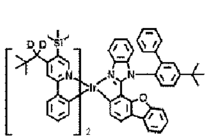
617
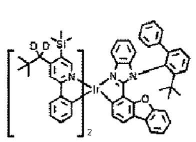
618
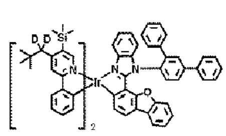
619
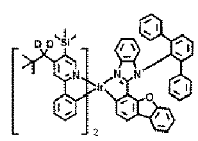
620

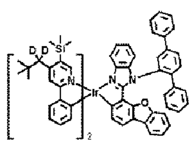
621
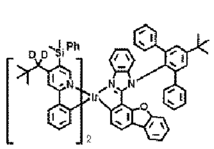
622
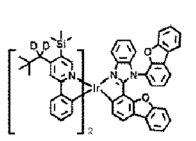
623
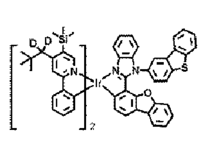
624
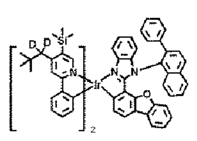
625

626
627
628
629
630

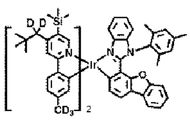
631
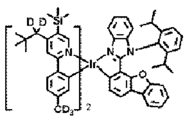
632
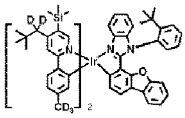
633
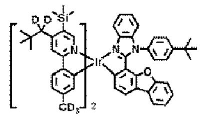
634
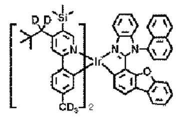
635
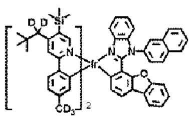
636
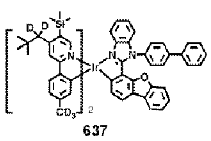
637
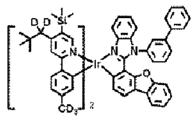
638
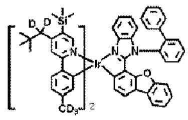
639
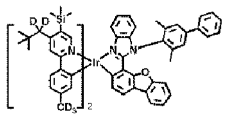
640
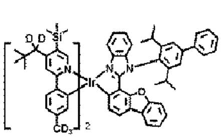
641
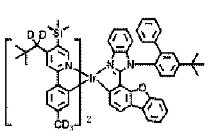
642
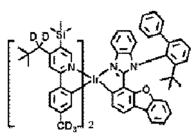
643
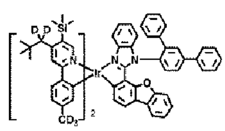
644
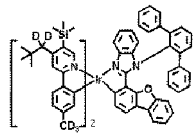
645
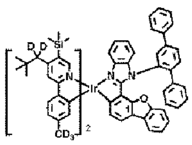
646
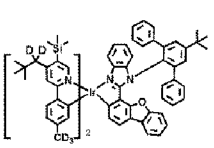
647
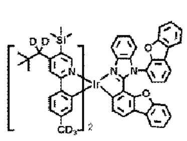
648
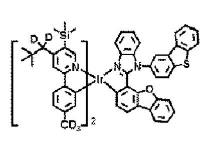
649
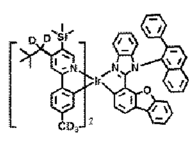
650
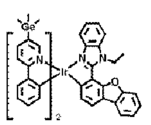
651
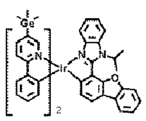
652
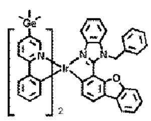
653
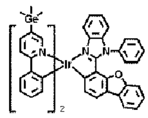
654
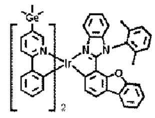
655
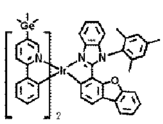
656
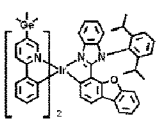
657
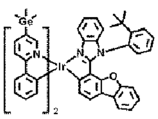
658
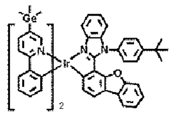
659
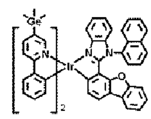
660
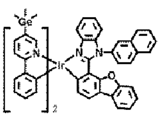
661
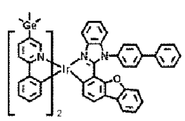
662
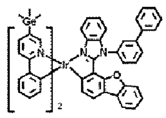
663
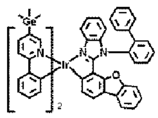
664
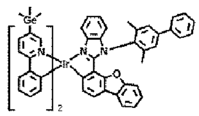
665
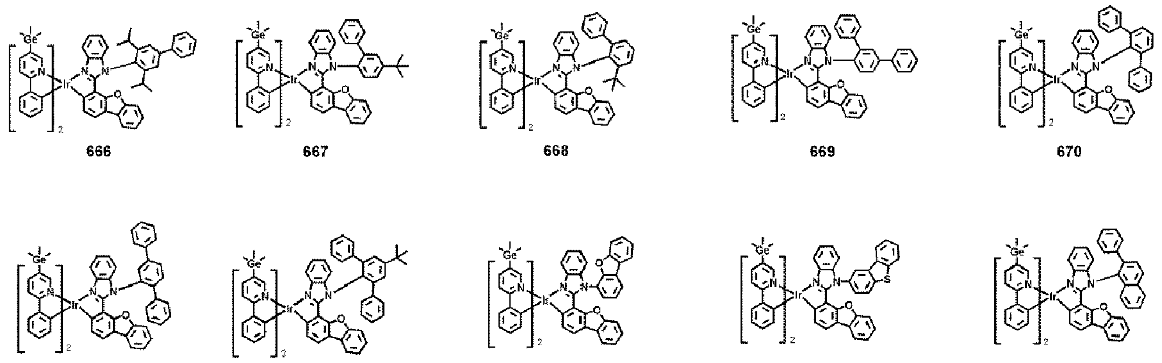
666
667
668
669
670
671
672
673
674
675

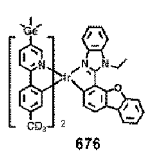
676
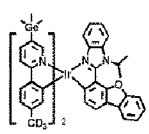
677
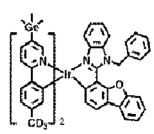
678
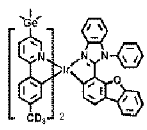
679
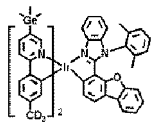
680

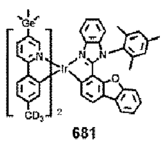
681
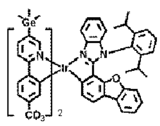
682
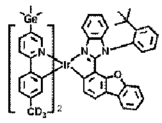
683
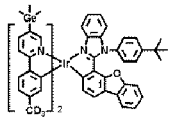
684
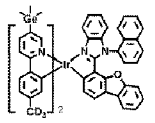
685

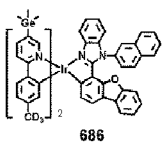
686
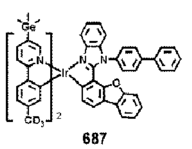
687
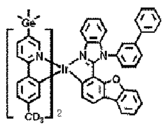
688
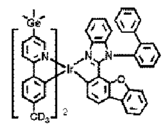
689
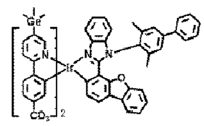
690

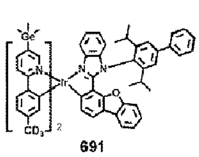
691
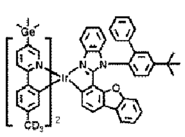
692
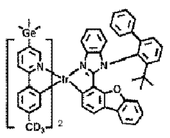
693
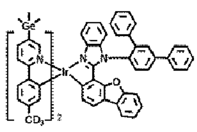
694
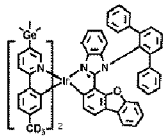
695

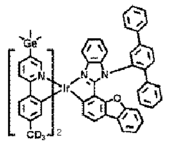
696
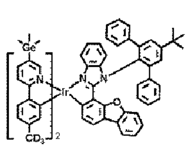
697
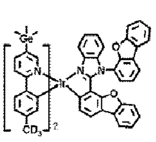
698
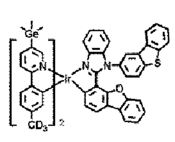
699
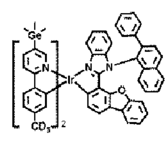
700

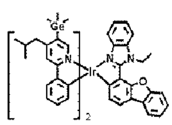
701
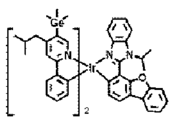
702
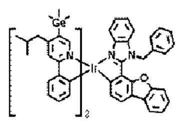
703
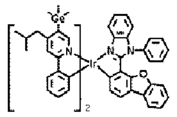
704
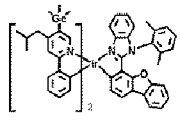
705

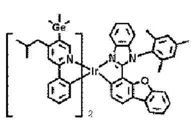
706
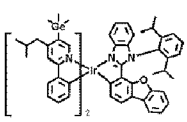
707
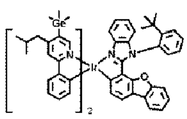
708
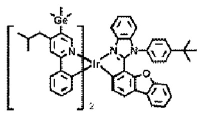
709
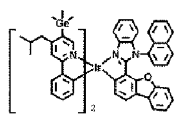
710

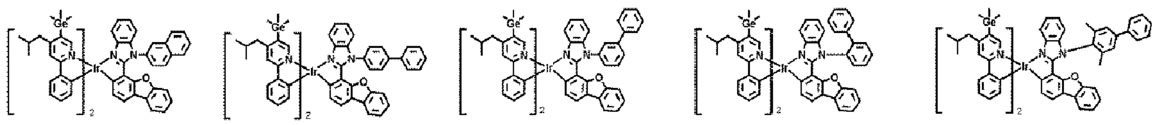
711 712 713 714 715

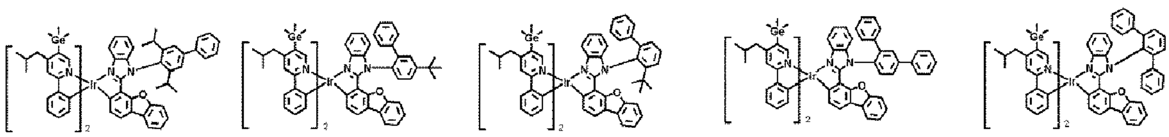
716 717 718 719 720

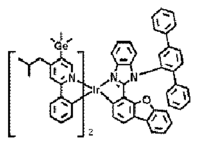
721
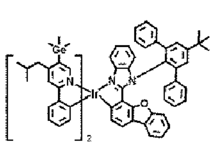
722
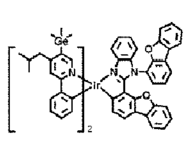
723
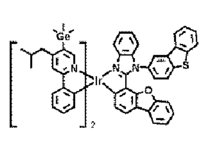
724
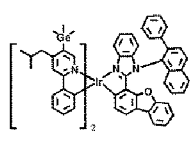
725

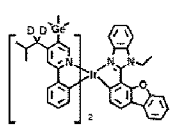
726
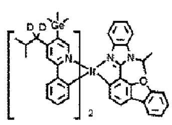
727
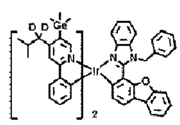
728
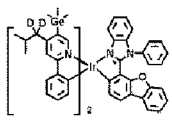
729
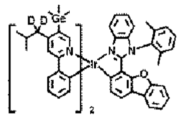
730

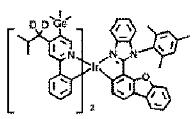
731
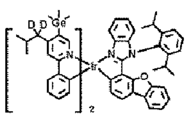
732
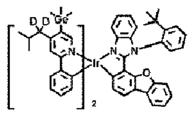
733
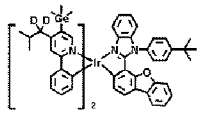
734
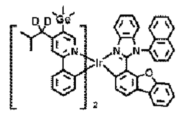
735

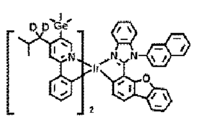
736
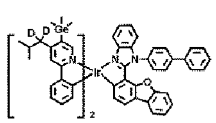
737
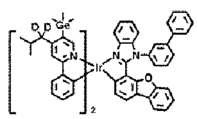
738
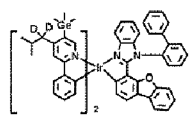
739
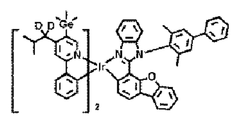
740

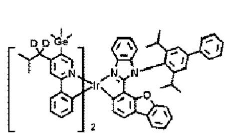
741
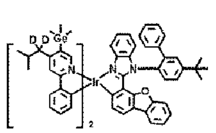
742
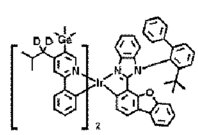
743
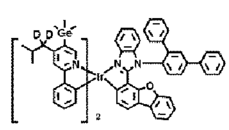
744
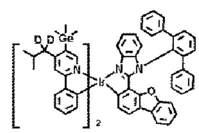
745

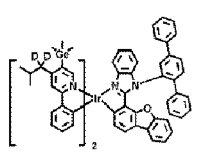
746
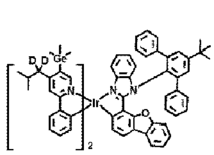
747
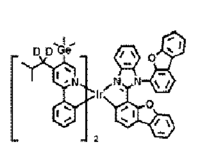
748
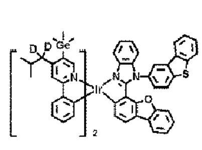
749
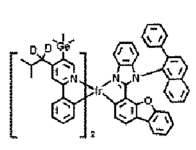
750

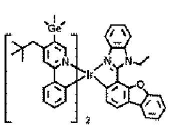
751
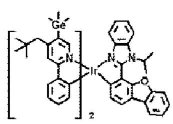
752
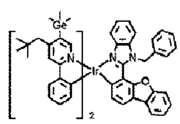
753
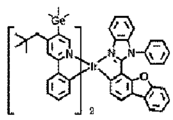
754
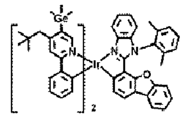
755

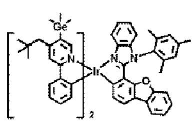
756
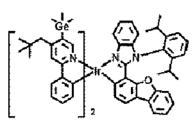
757
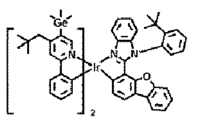
758
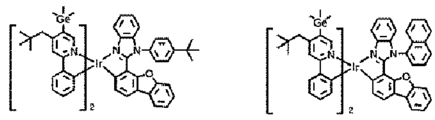
759
760

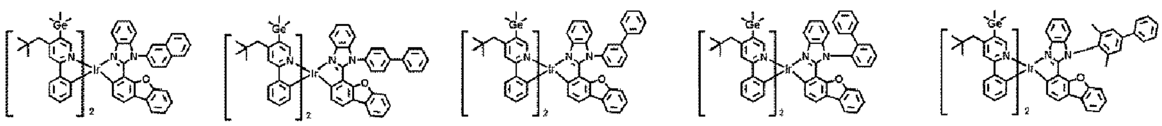
761
762
763
764
765

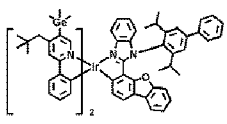
766
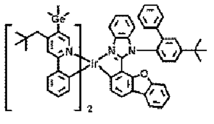
767
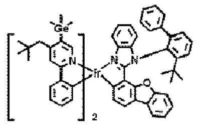
768
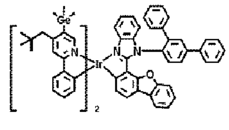
769
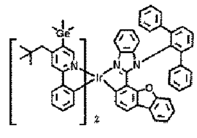
770

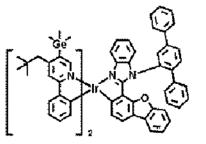
771
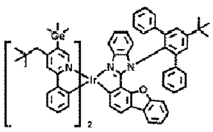
772
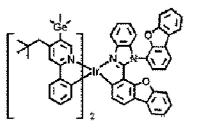
773
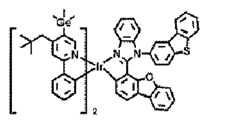
774
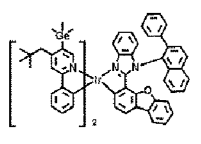
775

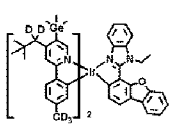
776
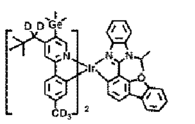
777
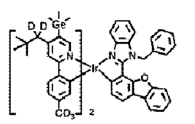
778
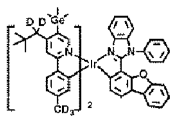
779
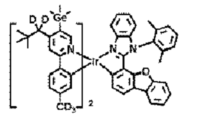
780

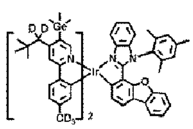
781
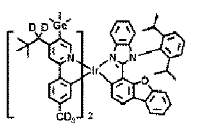
782
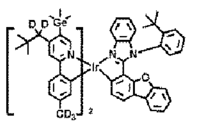
783
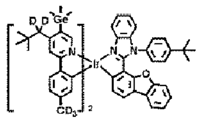
784
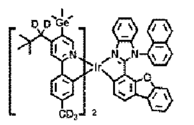
785

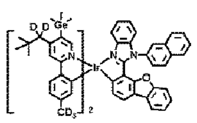
786
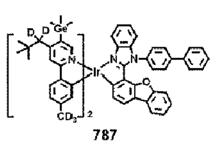
787
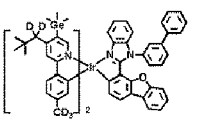
788
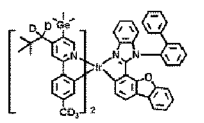
789
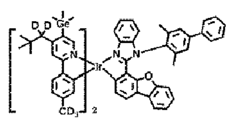
790

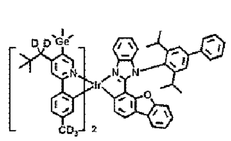
791
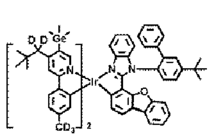
792
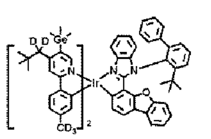
793
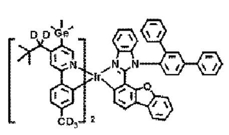
794
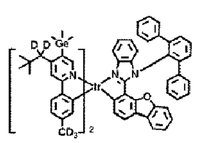
795

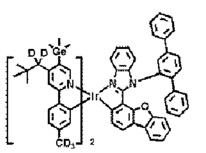
796
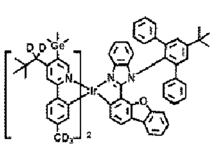
797
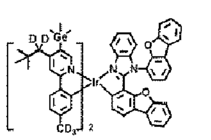
798
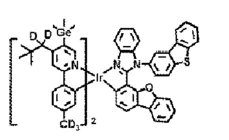
799
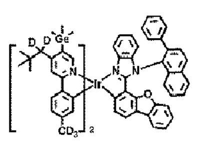
800

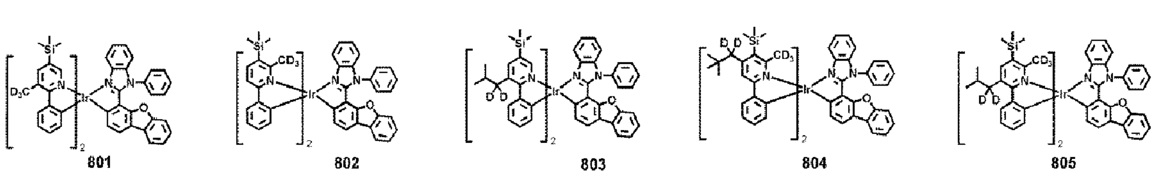
801
802
803
804
805

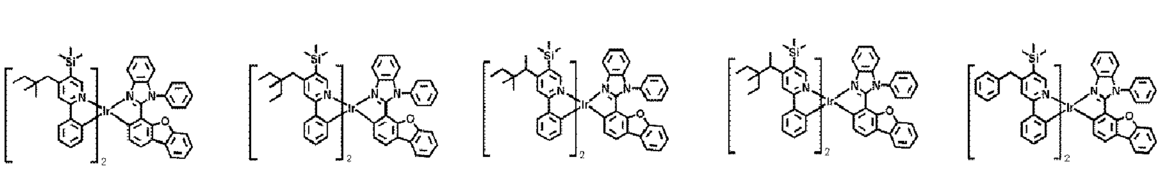
806
807
808
809
810

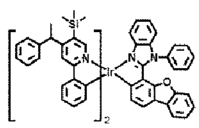
811
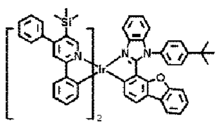
812
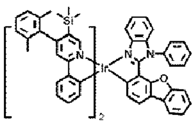
813
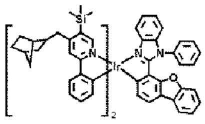
814
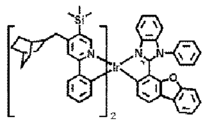
815

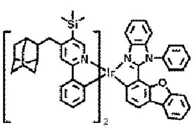
816
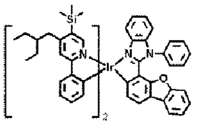
817
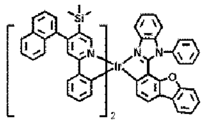
818
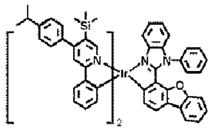
819
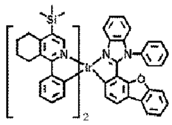
820

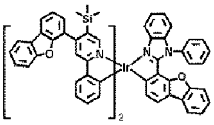
821
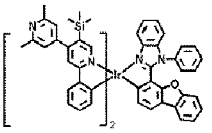
822
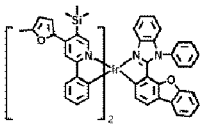
823
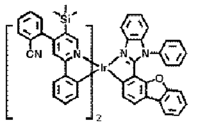
824
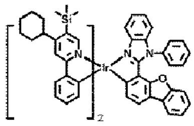
825

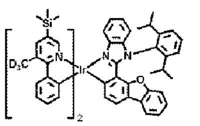
826
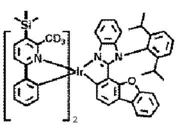
827
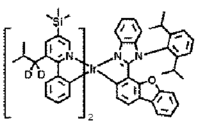
828
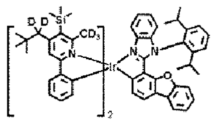
829
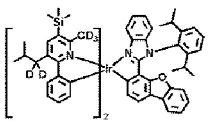
830

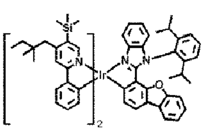
831
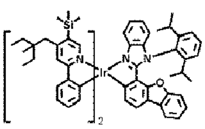
832
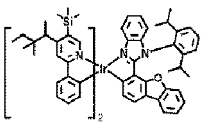
833
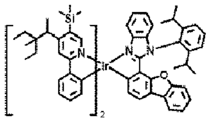
834
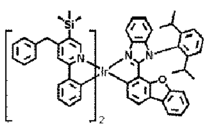
835

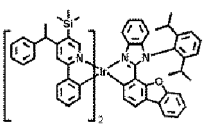
836
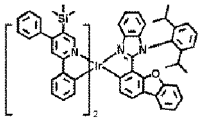
837
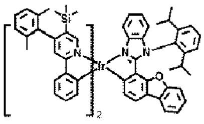
838
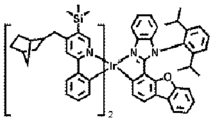
839
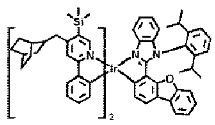
840

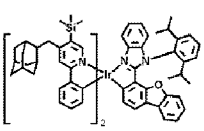
841
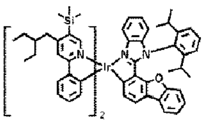
842
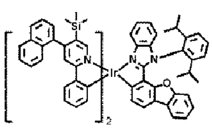
843
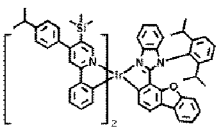
844
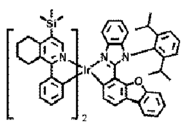
845

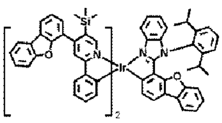
846
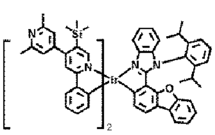
847
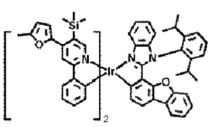
848
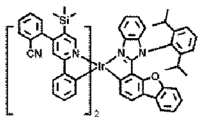
849
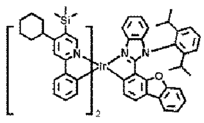
850

851
852
853
854
855

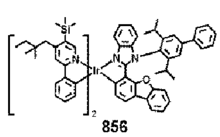
856

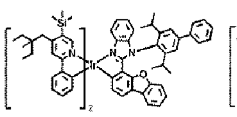
857

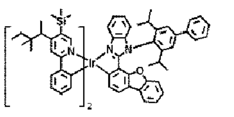
858

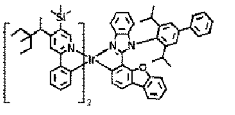
859

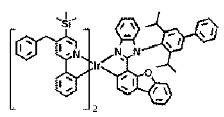
860

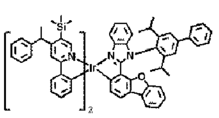
861

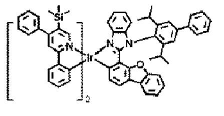
862

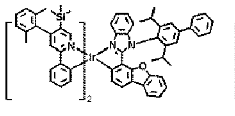
863

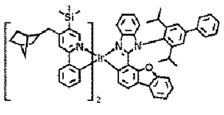
864

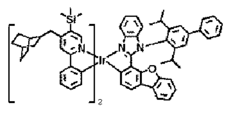
865

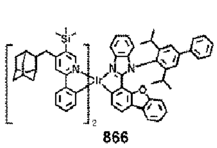
866

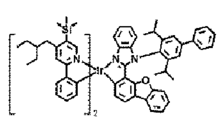
867

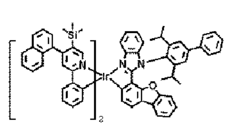
868

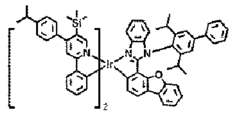
869

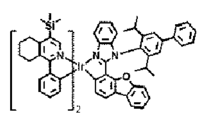
870

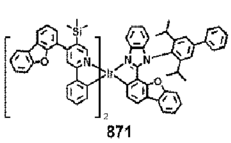
871

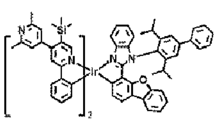
872

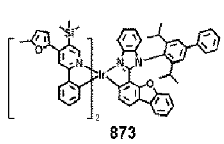
873

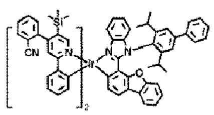
874

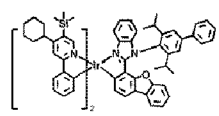
875

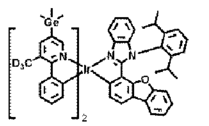
876

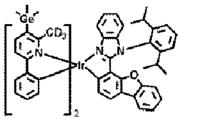
877

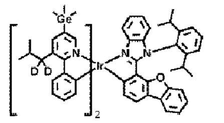
878

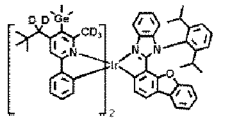
879

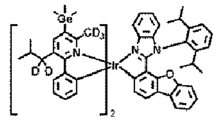
880

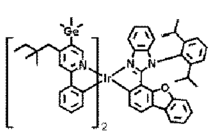
881

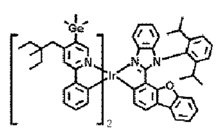
882

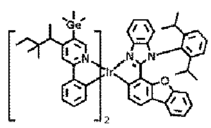
883

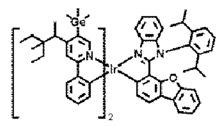
884

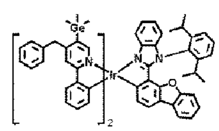
885

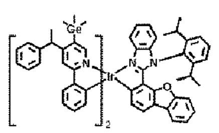
886

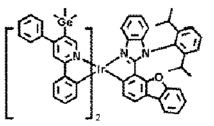
887

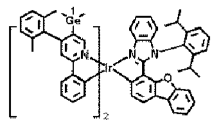
888

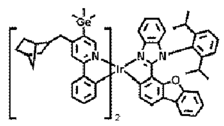
889

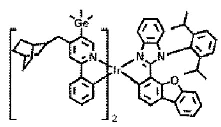
890

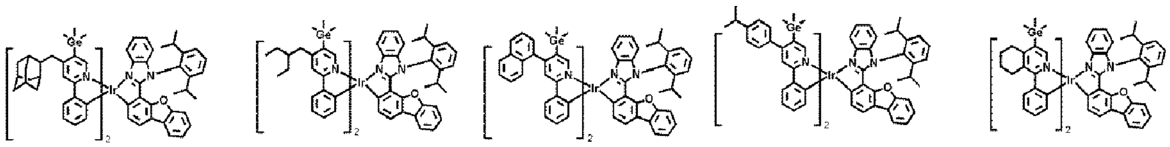
891 892 893 894 895

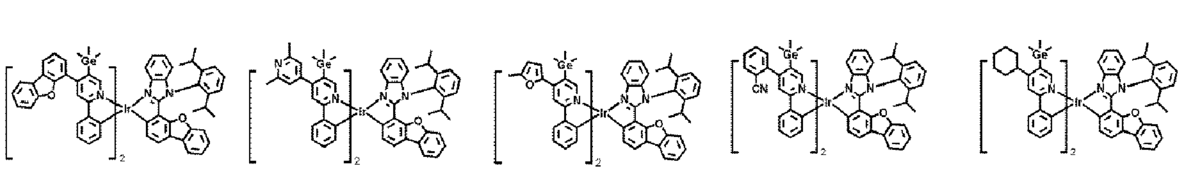
896 897 898 899 900

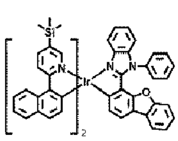
901
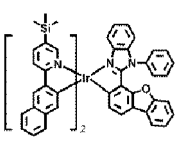
902
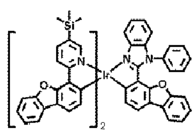
903
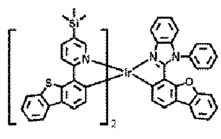
904
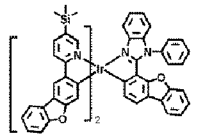
905
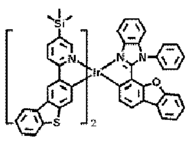
906
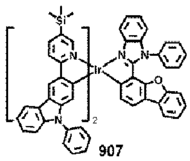
907
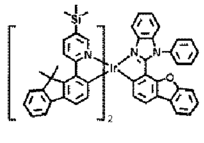
908
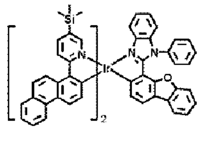
909
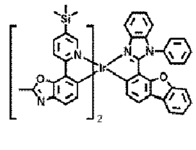
910
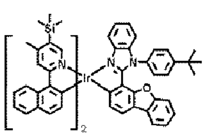
911
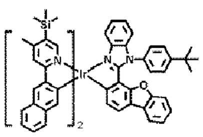
912
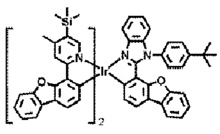
913
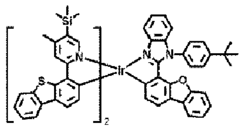
914
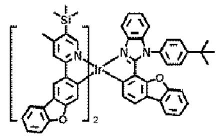
915
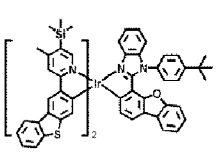
916
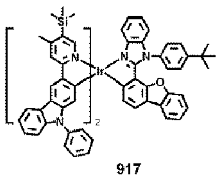
917
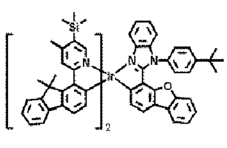
918
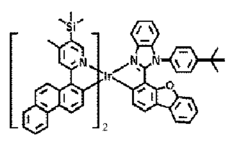
919
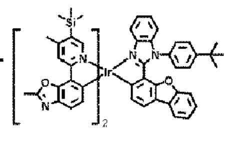
920
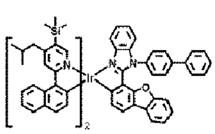
921
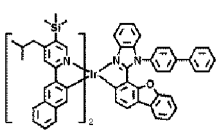
922
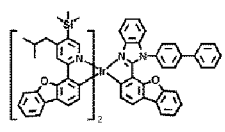
923
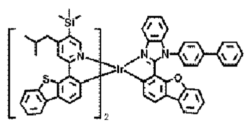
924
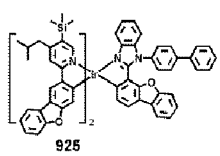
925
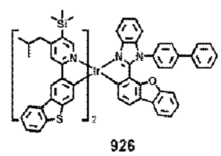
926
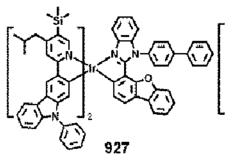
927
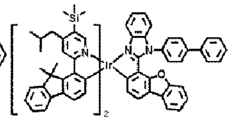
928
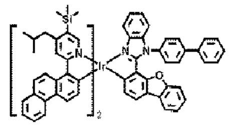
929
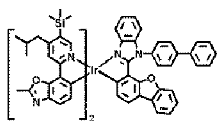
930
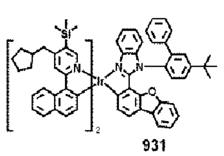
931
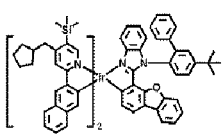
932
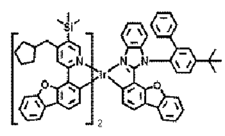
933
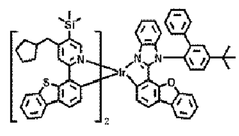
934
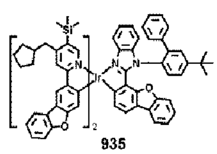
935
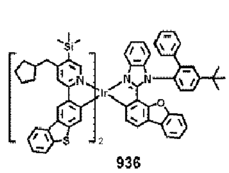
936
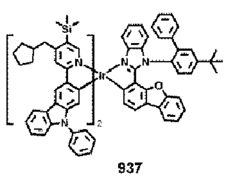
937
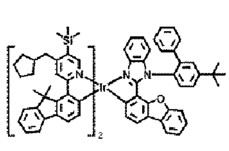
938
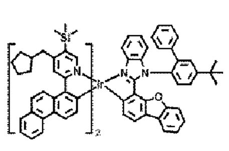
939
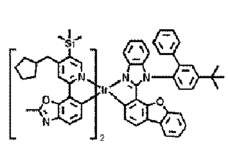
940

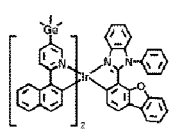
941
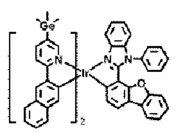
942
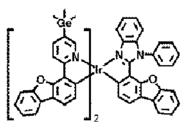
943
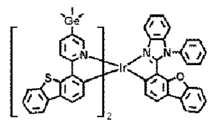
944
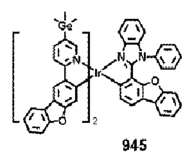
945

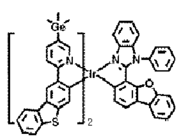
946
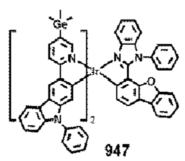
947
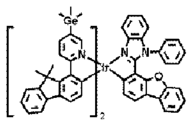
948
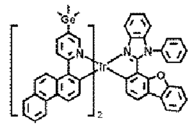
949
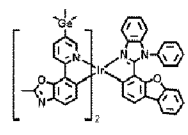
950

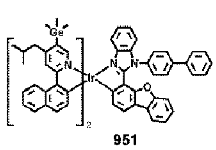
951
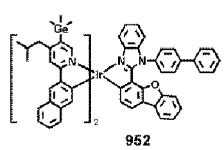
952
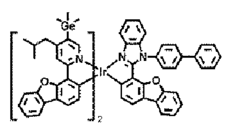
953
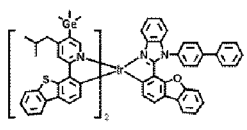
954
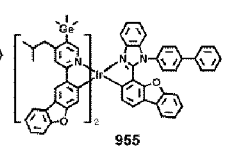
955

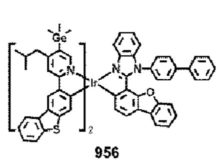
956
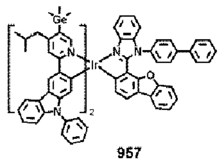
957
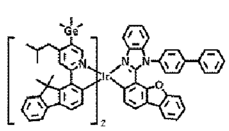
958
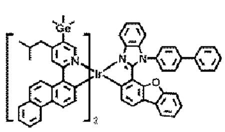
959
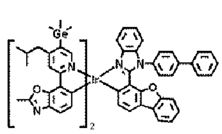
960

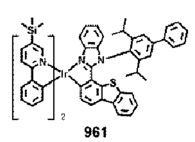
961
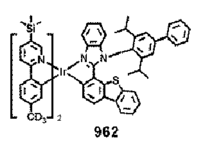
962
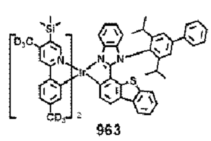
963
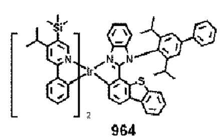
964
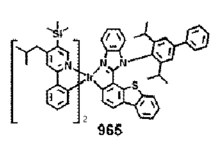
965

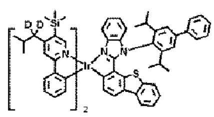
966
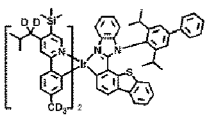
967
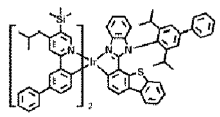
968
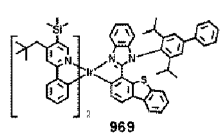
969
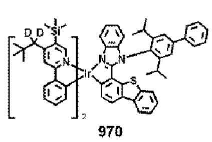
970

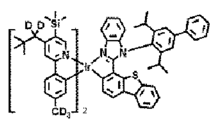
971
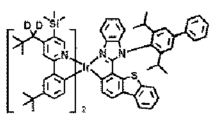
972
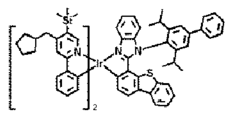
973
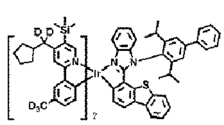
974
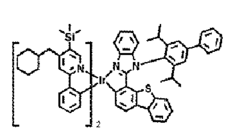
975

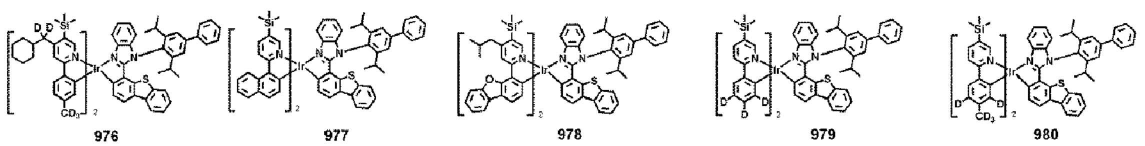
976
977
978
979
980

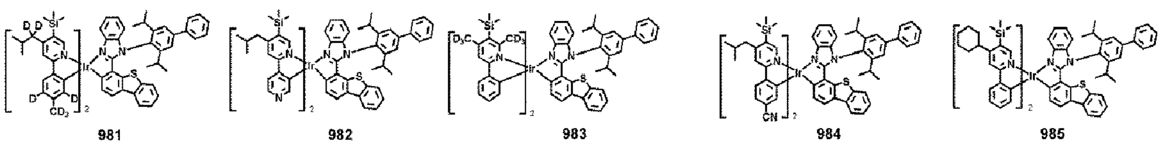
981
982
983
984
985

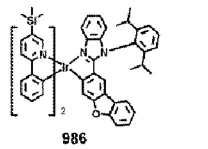
986
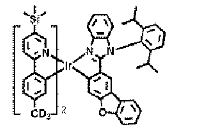
987
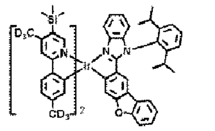
988
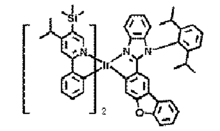
989
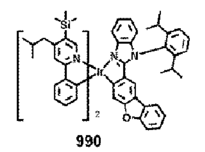
990
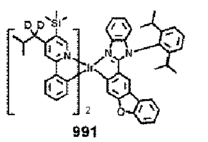
991
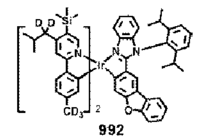
992
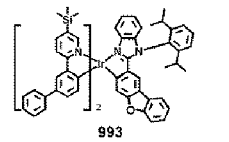
993
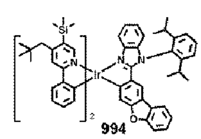
994
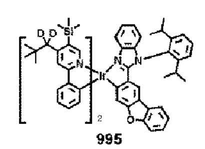
995
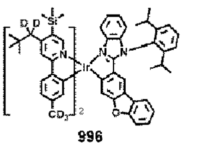
996
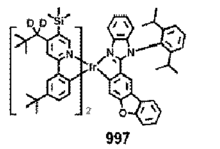
997
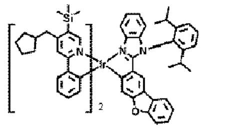
998
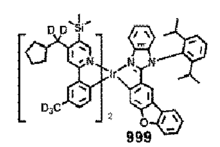
999
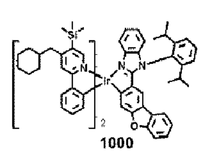
1000
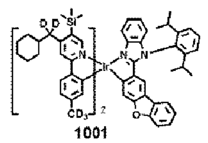
1001
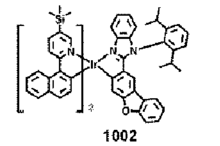
1002
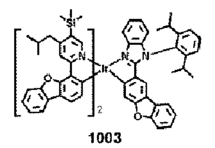
1003
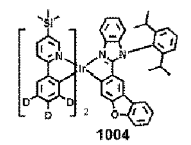
1004
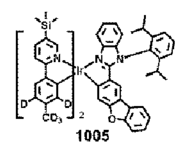
1005
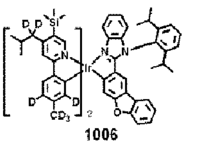
1006
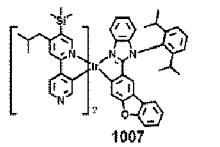
1007
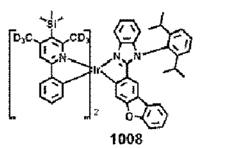
1008
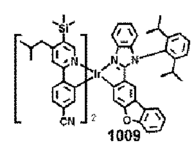
1009
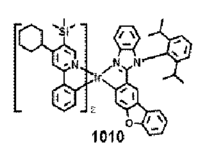
1010
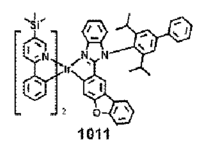
1011
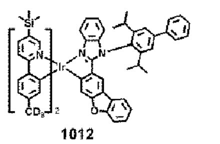
1012
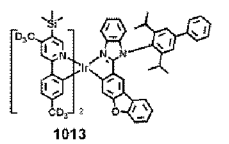
1013
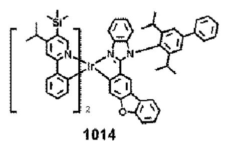
1014
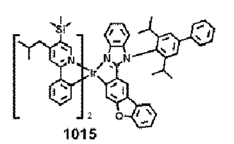
1015
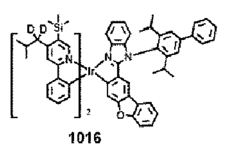
1016
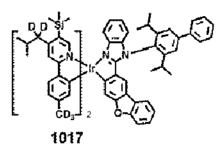
1017
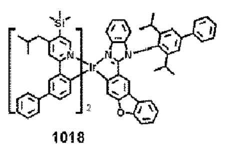
1018
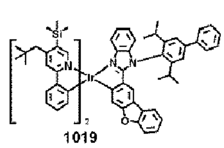
1019
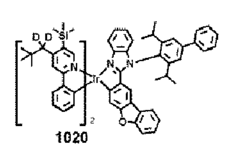
1020
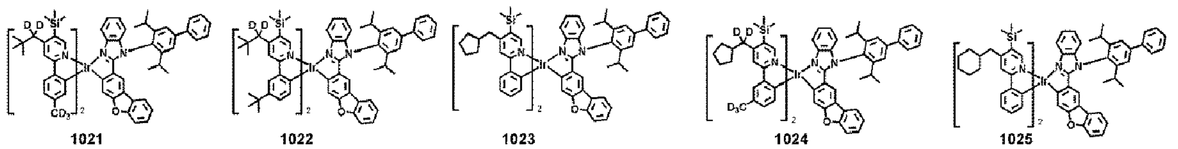
1021 1022 1023 1024 1025
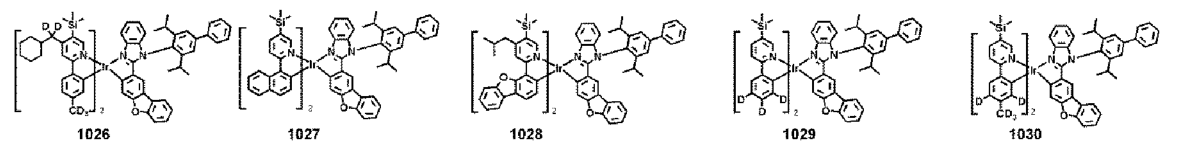
1026 1027 1028 1029 1030

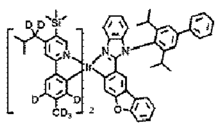
1031

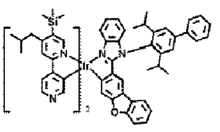
1032

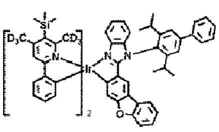
1033

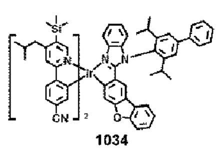
1034

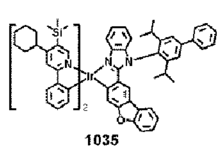
1035

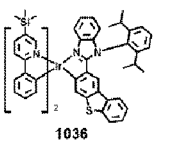
1036

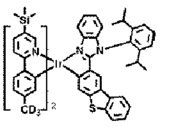
1037

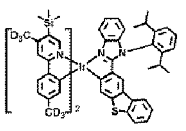
1038

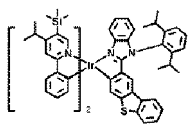
1039

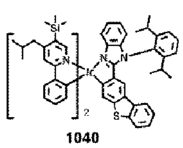
1040

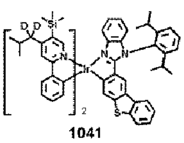
1041

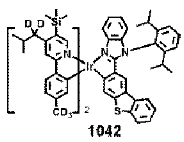
1042

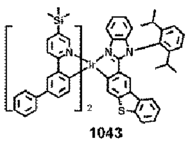
1043

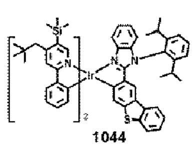
1044

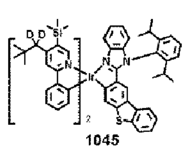
1045

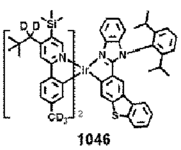
1046

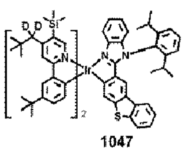
1047

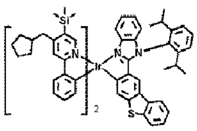
1048

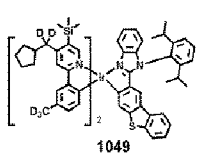
1049

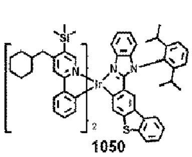
1050

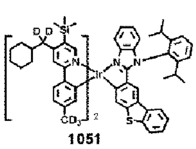
1051

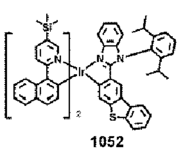
1052

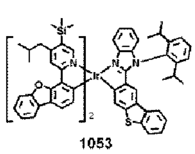
1053

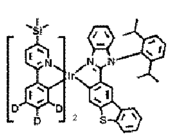
1054

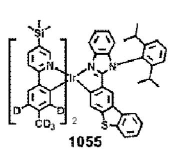
1055

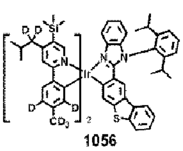
1056

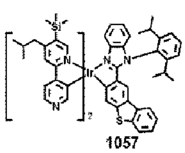
1057

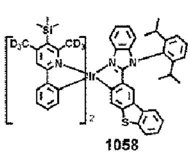
1058

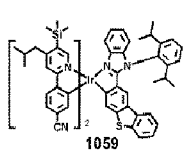
1059

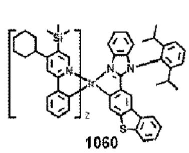
1060

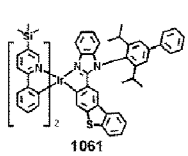
1061

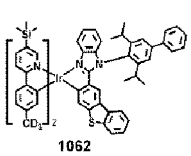
1062

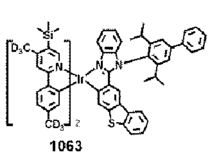
1063

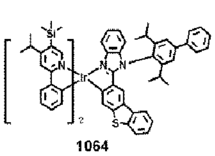
1064

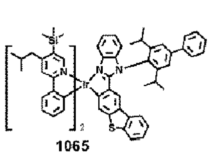
1065

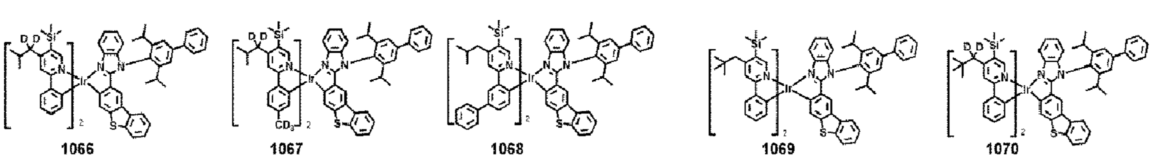
1066 1067 1068 1069 1070

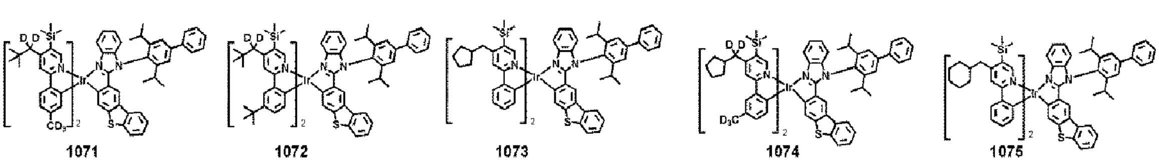
1071 1072 1073 1074 1075

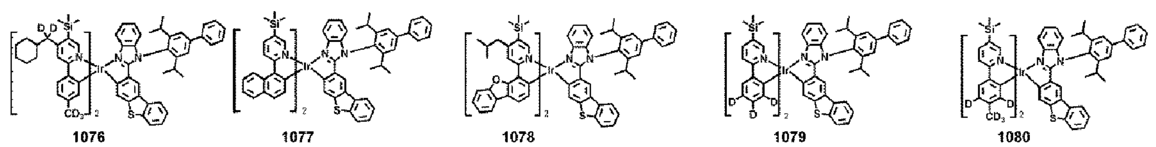

1076 1077 1078 1079 1080

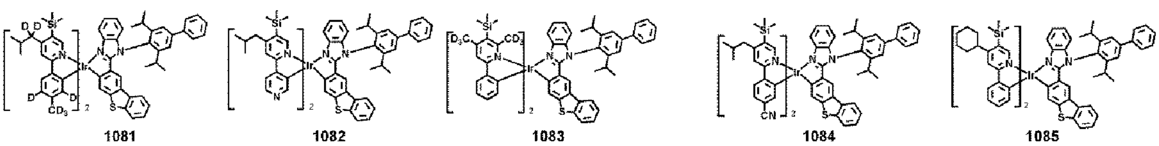

1081 1082 1083 1084 1085

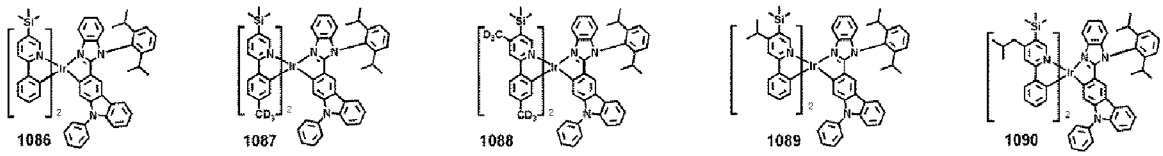

1086 1087 1088 1089 1090

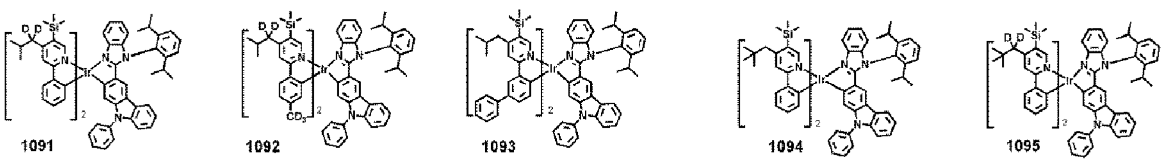

1091 1092 1093 1094 1095

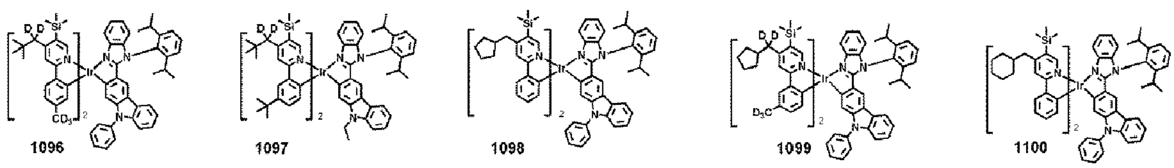

1096 1097 1098 1099 1100

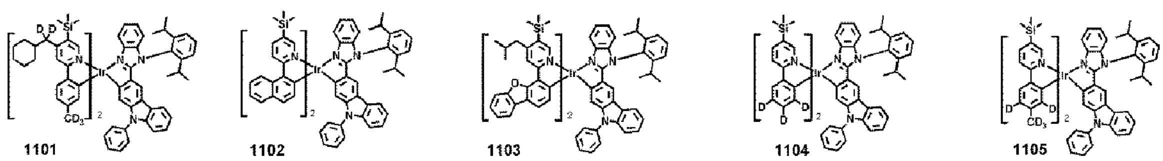

1101 1102 1103 1104 1105

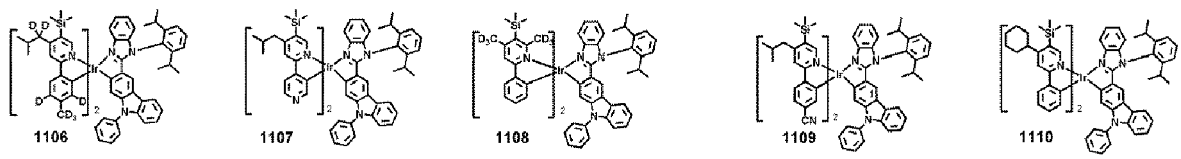

1106 1107 1108 1109 1110

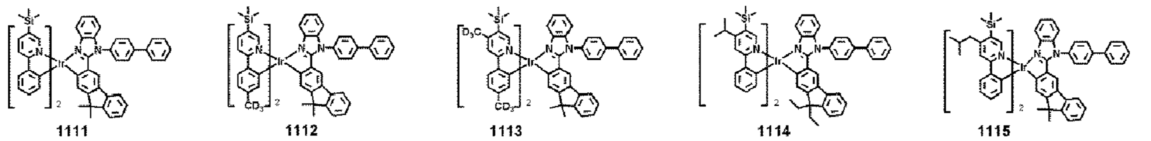

1111 1112 1113 1114 1115

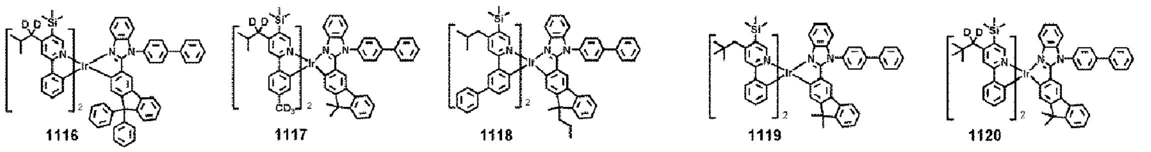

1116 1117 1118 1119 1120

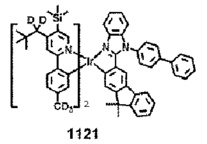
1121

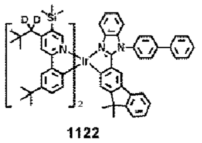
1122

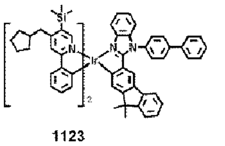
1123

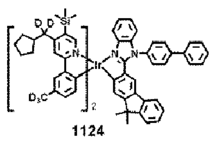
1124

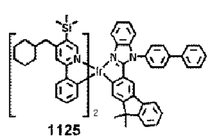
1125

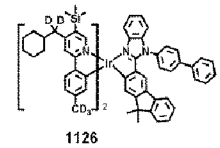
1126

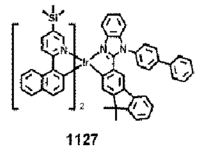
1127

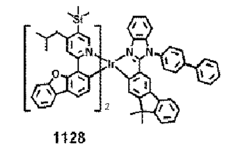
1128

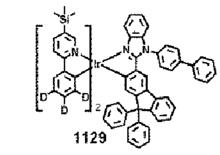
1129

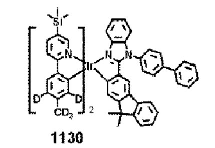
1130

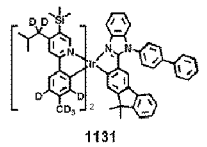
1131

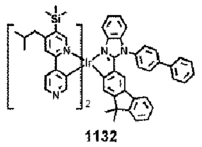
1132

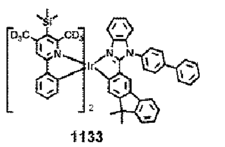
1133

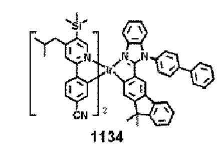
1134

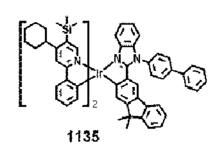
1135

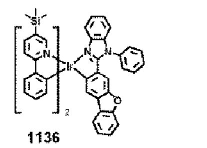
1136

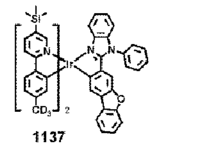
1137

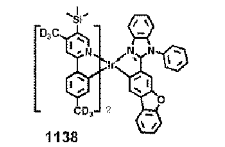
1138

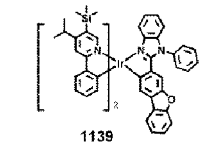
1139

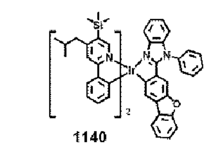
1140

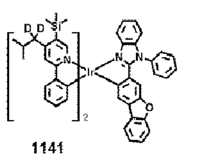
1141

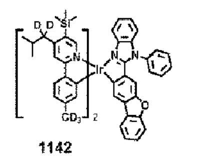
1142

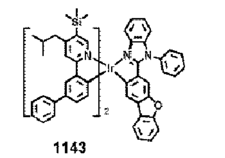
1143

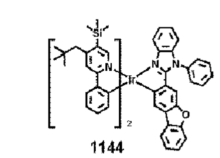
1144

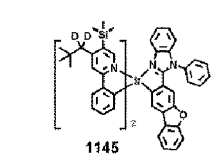
1145

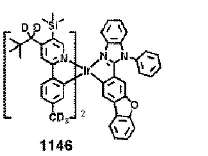
1146

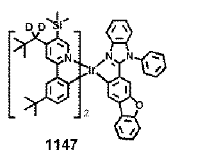
1147

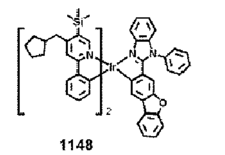
1148

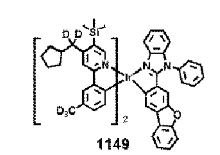
1149

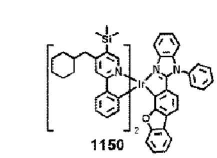
1150

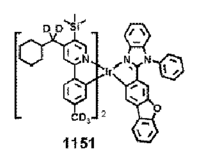
1151

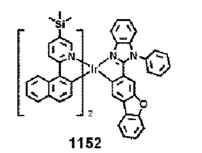
1152

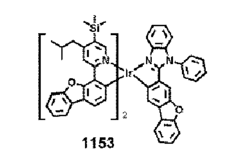
1153

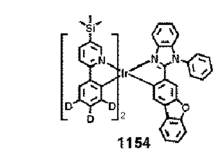
1154

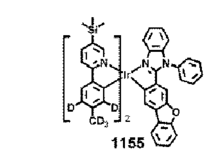
1155

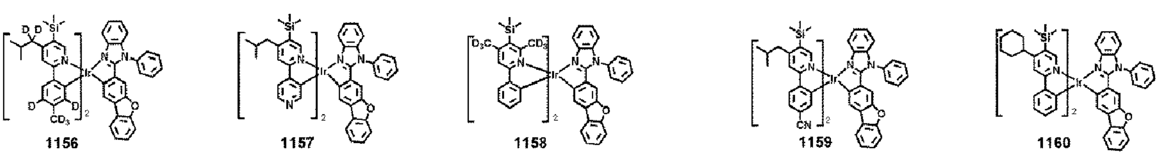
1156 1157 1158 1159 1160

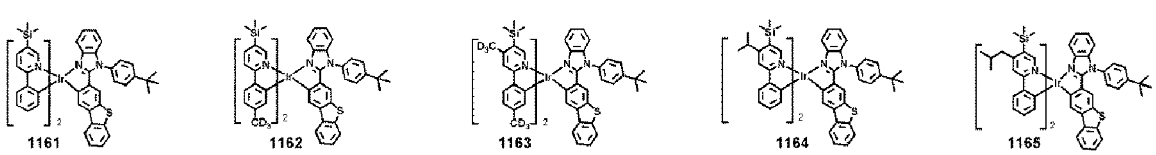
1161 1162 1163 1164 1165

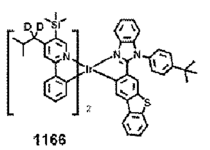
1166
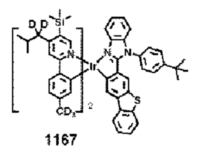
1167
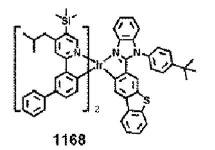
1168
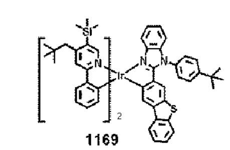
1169
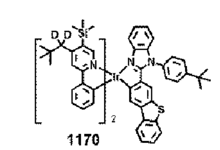
1170
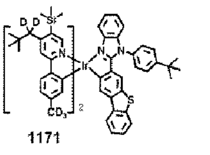
1171
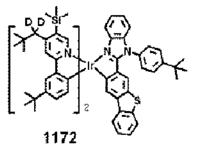
1172
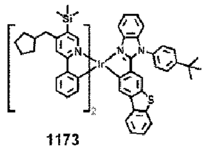
1173
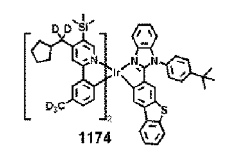
1174
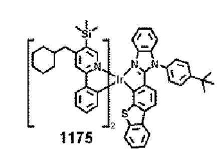
1175
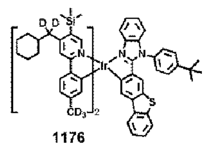
1176
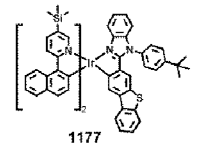
1177
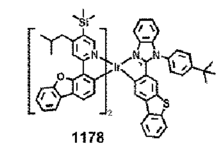
1178
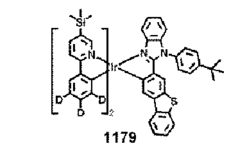
1179
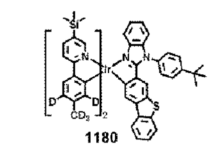
1180
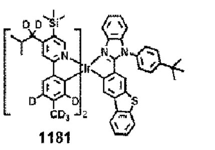
1181
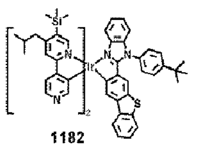
1182
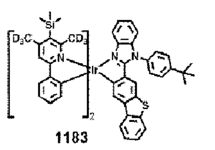
1183
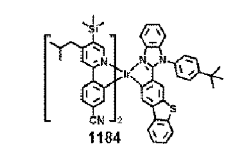
1184
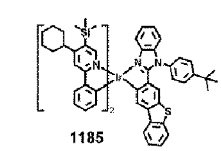
1185
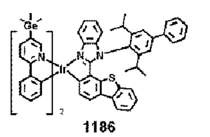
1186
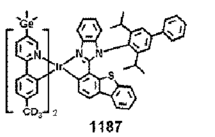
1187
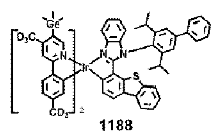
1188
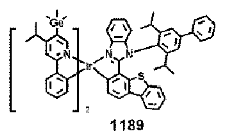
1189
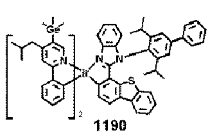
1190
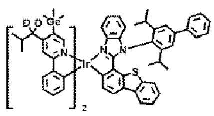
1191
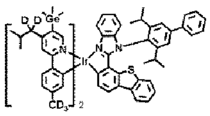
1192
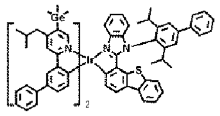
1193
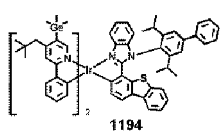
1194
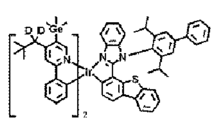
1195
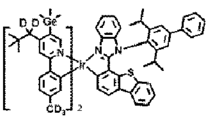
1196
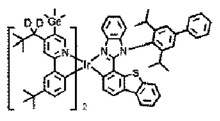
1197
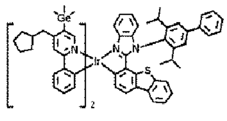
1198
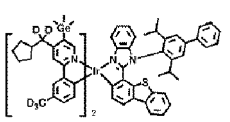
1199
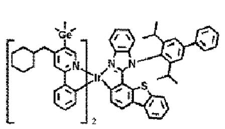
1200
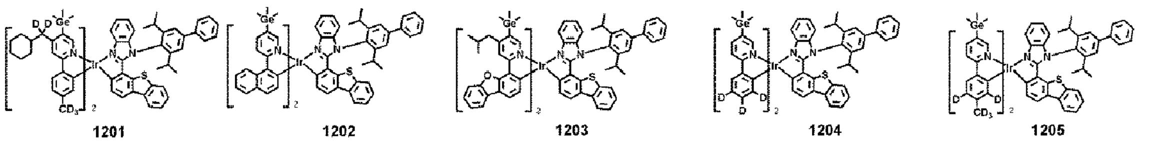
1201
1202
1203
1204
1205
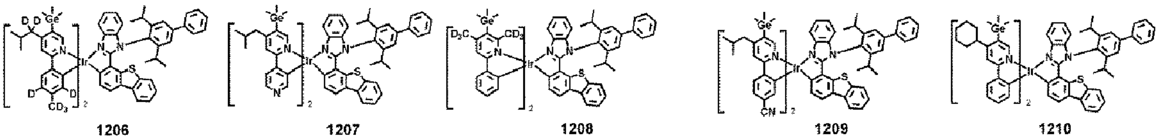
1206
1207
1208
1209
1210

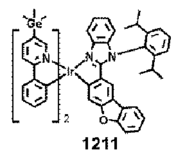
1211

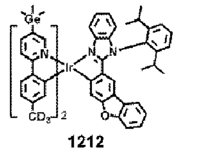
1212

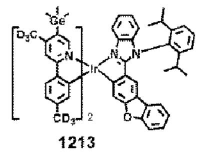
1213

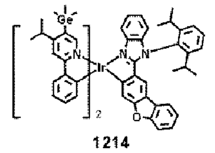
1214

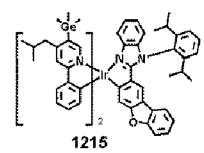
1215

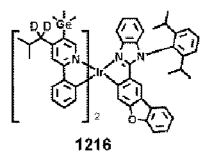
1216

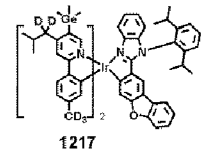
1217

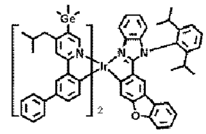
1218

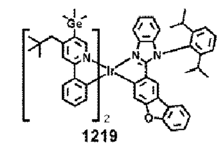
1219

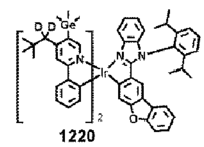
1220

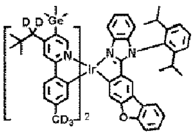
1221

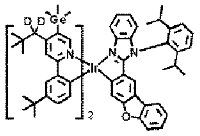
1222

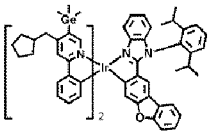
1223

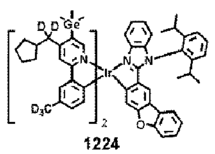
1224

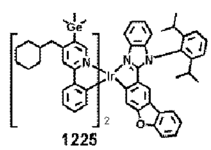
1225

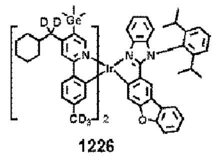
1226

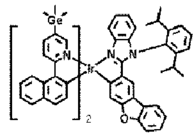
1227

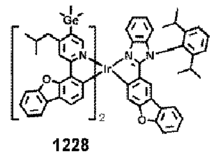
1228

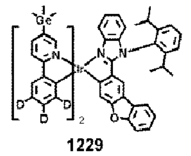
1229

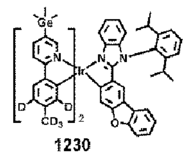
1230

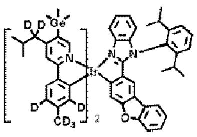
1231

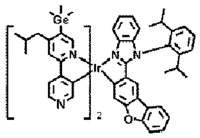
1232

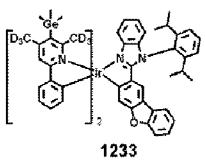
1233

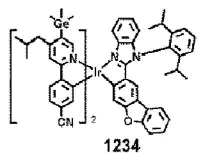
1234

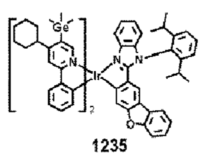
1235

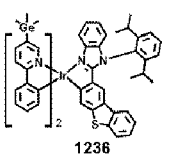
1236

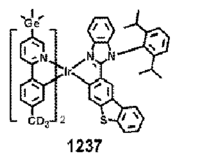
1237

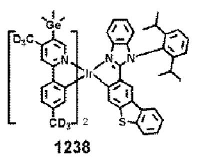
1238

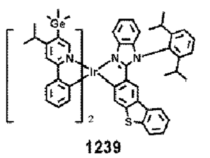
1239

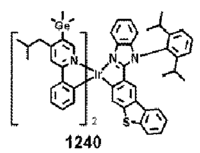
1240

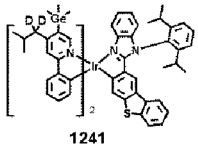
1241

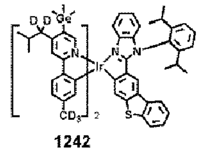
1242

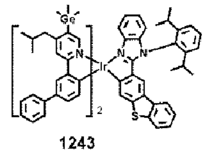
1243

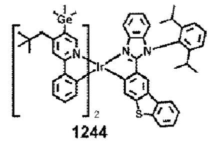
1244

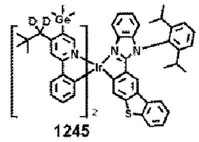
1245

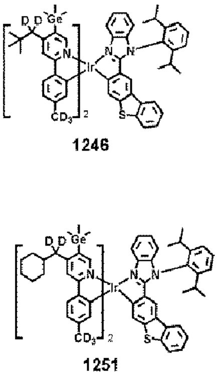
1246

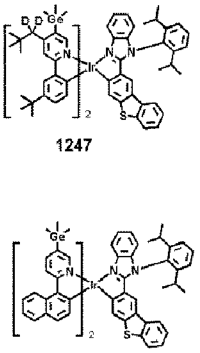
1247

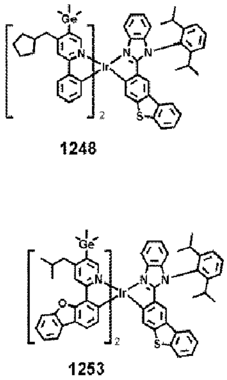
1248

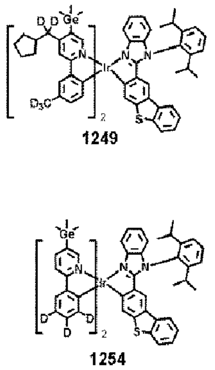
1249

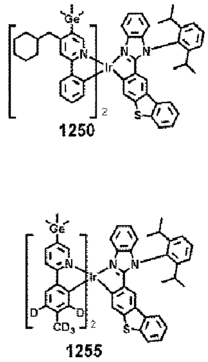
1250

1251

1252

1253

1254

1255

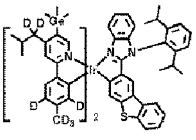
1256
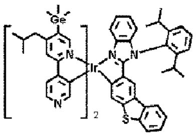
1257
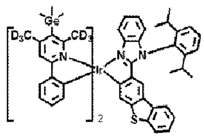
1258
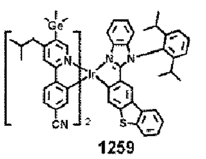
1259
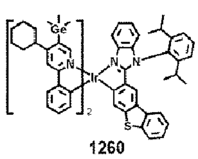
1260

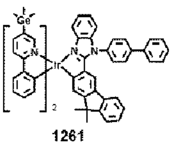
1261
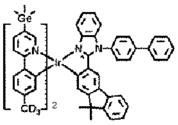
1262
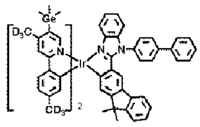
1263
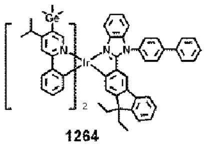
1264
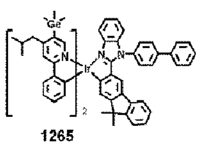
1265

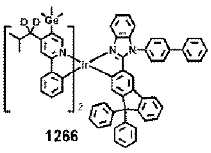
1266
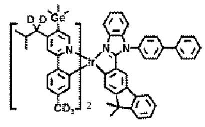
1267
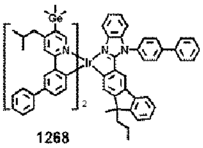
1268
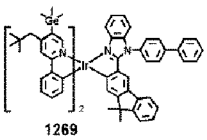
1269
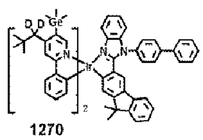
1270

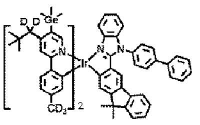
1271
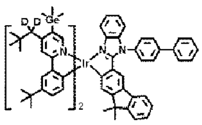
1272
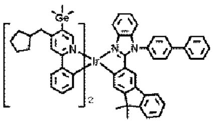
1273
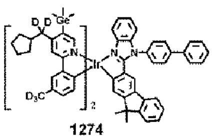
1274
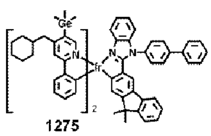
1275

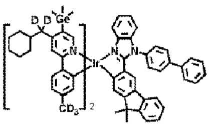
1276
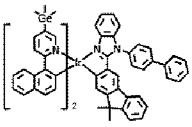
1277
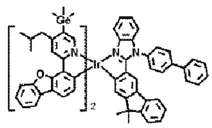
1278
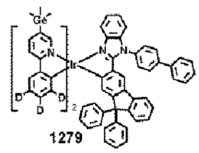
1279
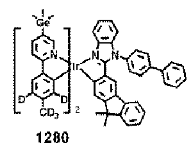
1280

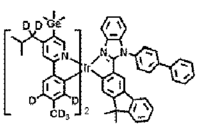
1281
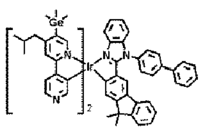
1282
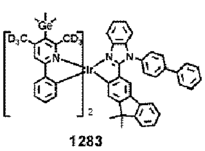
1283
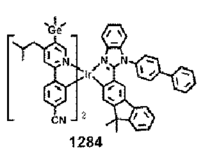
1284
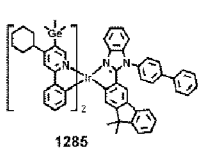
1285

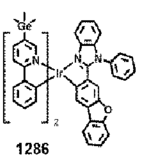
1286
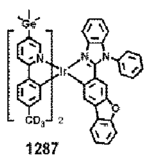
1287
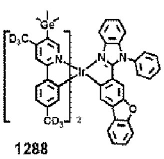
1288
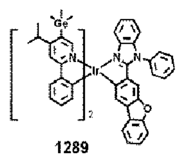
1289
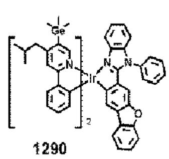
1290

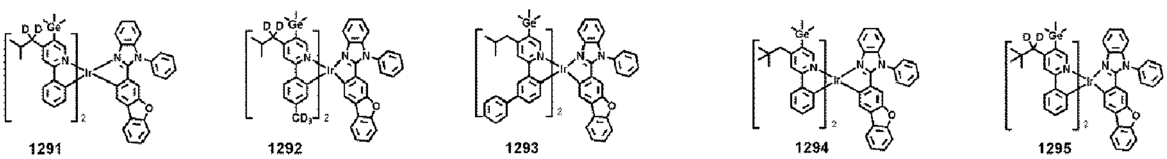
1291 1292 1293 1294 1295

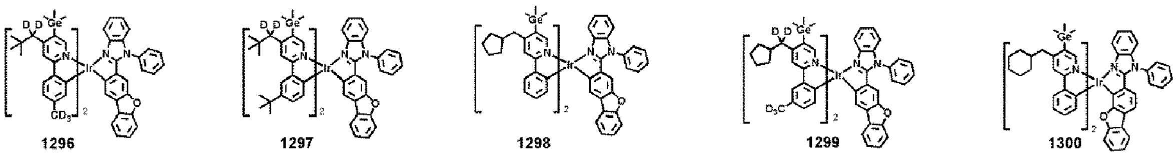
1296 1297 1298 1299 1300

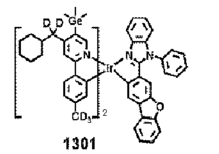
1301

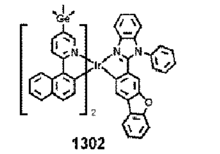
1302

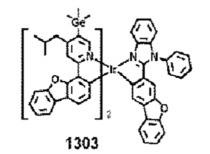
1303

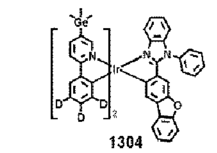
1304

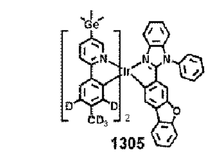
1305

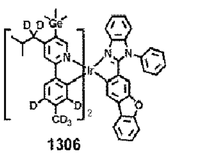
1306

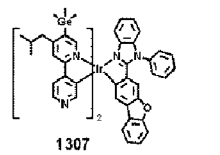
1307

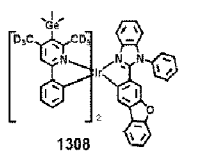
1308

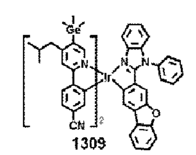
1309

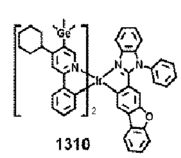
1310

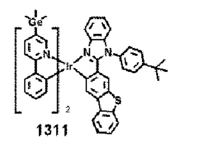
1311

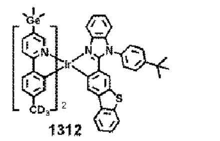
1312

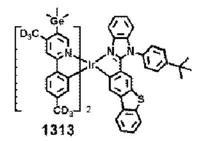
1313

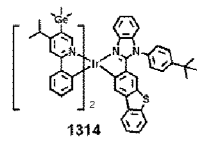
1314

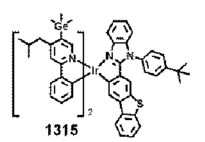
1315

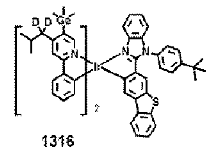
1316

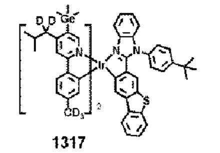
1317

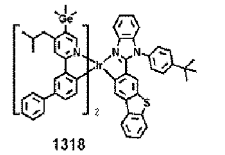
1318

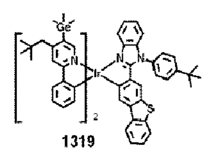
1319

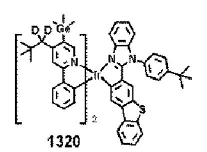
1320

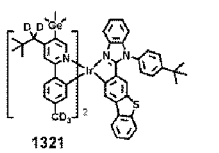
1321

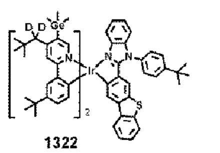
1322

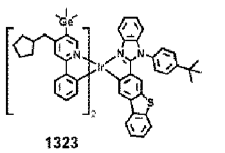
1323

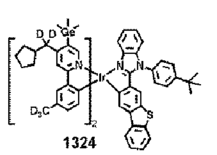
1324

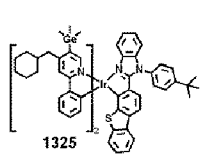
1325

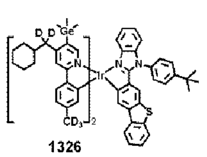
1326

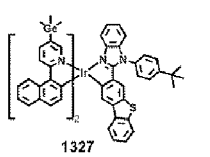
1327

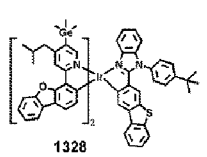
1328

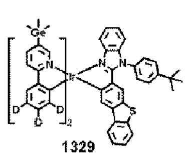
1329

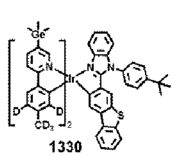
1330

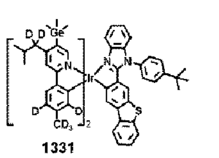
1331

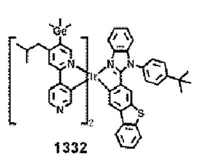
1332

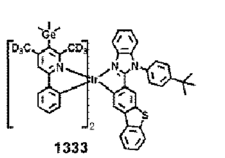
1333

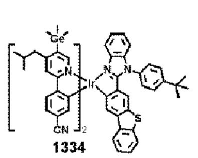
1334

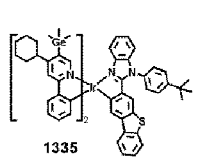
1335

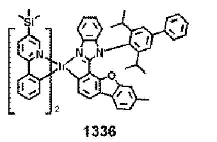
1336

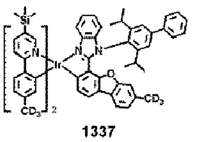
1337

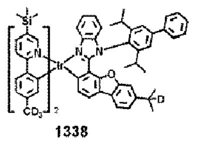
1338

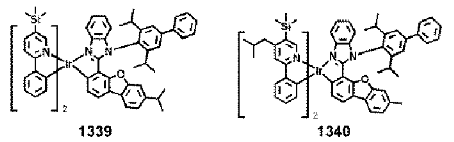
1339

1340

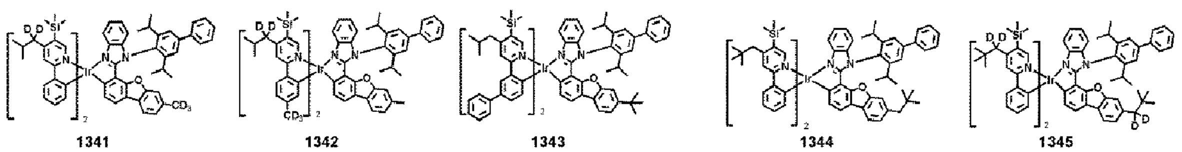
1341

1342

1343

1344

1345

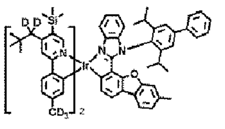
1346

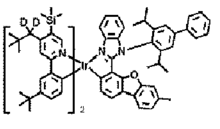
1347

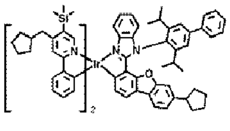
1348

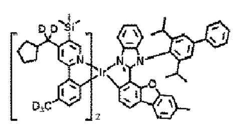
1349

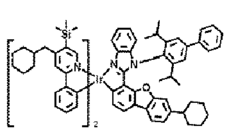
1350

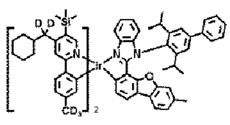
1351

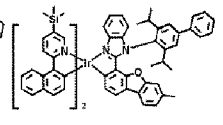
1352

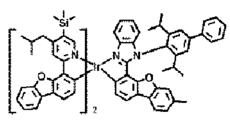
1353

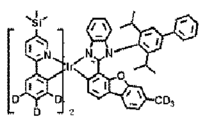
1354

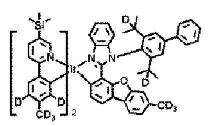
1355

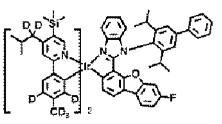
1356

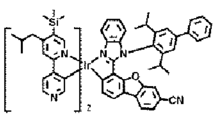
1357

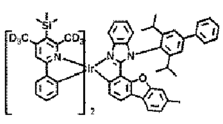
1358

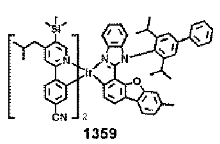
1359

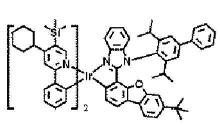
1360

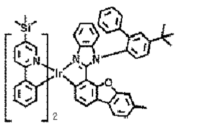
1361

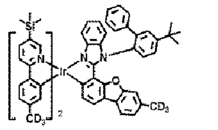
1362

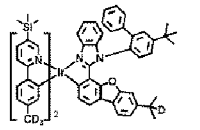
1363

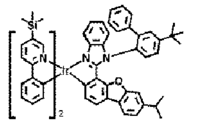
1364

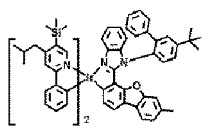
1365

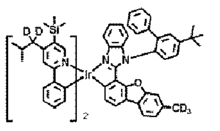
1366

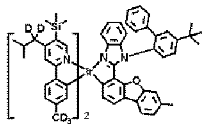
1367

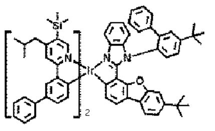
1368

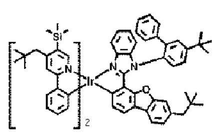
1369

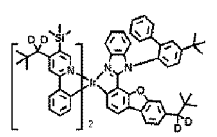
1370

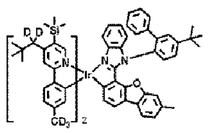
1371

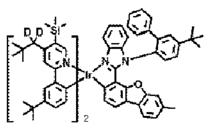
1372

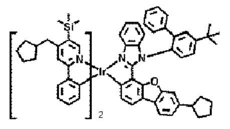
1373

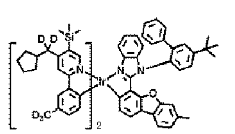
1374

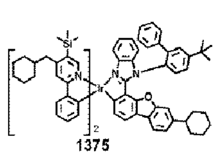
1375

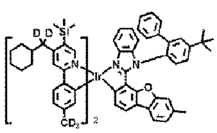
1376

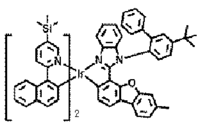
1377

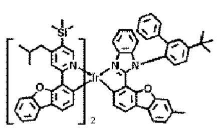
1378

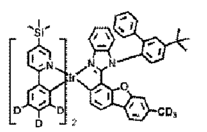
1379

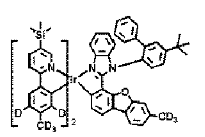
1380

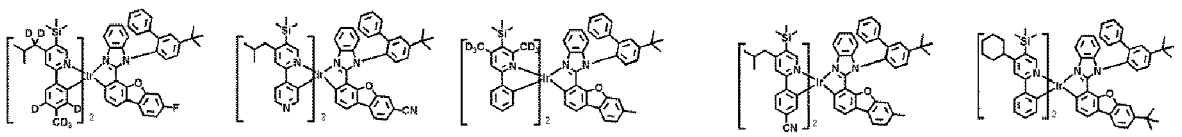
1381 1382 1383 1384 1385

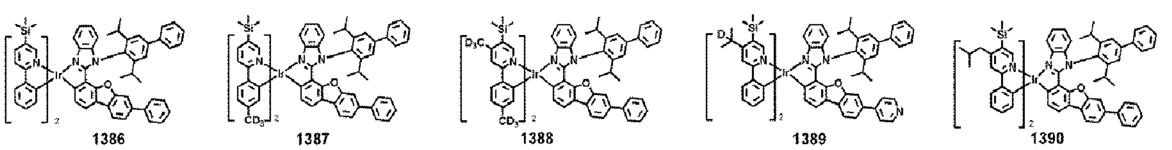
1386 1387 1388 1389 1390

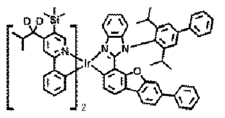
1391

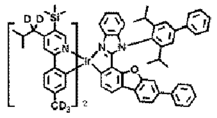
1392

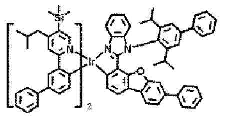
1393

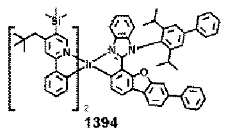
1394

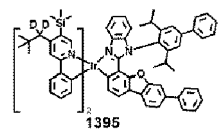
1395

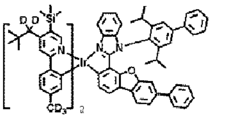
1396

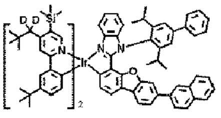
1397

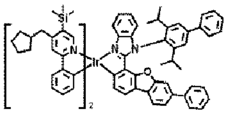
1398

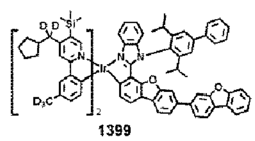
1399

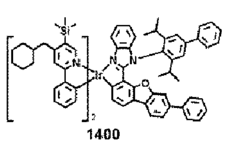
1400

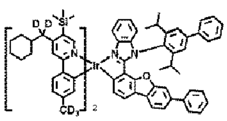
1401

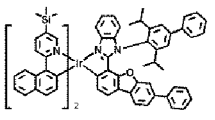
1402

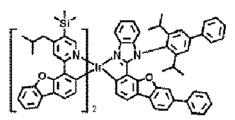
1403

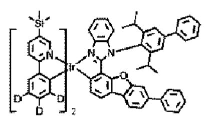
1404

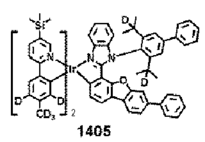
1405

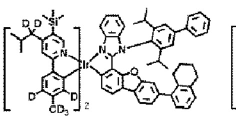
1406

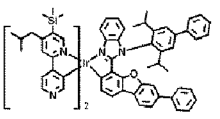
1407

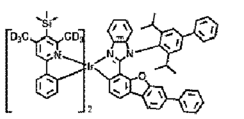
1408

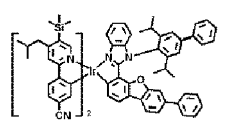
1409

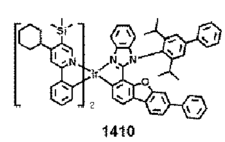
1410

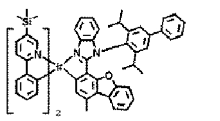
1411

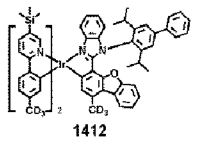
1412

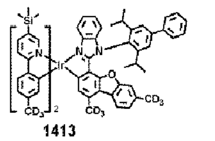
1413

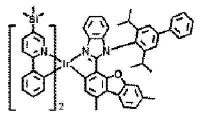
1414

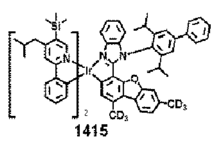
1415

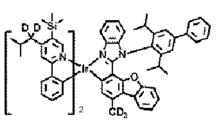
1416

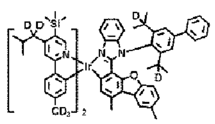
1417

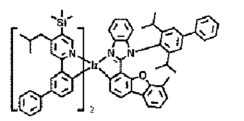
1418

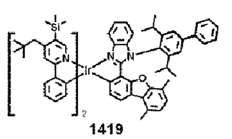
1419

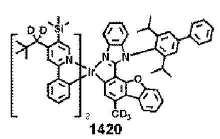
1420

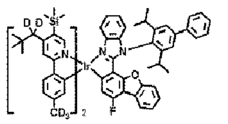
1421

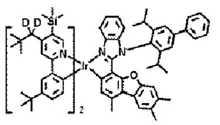
1422

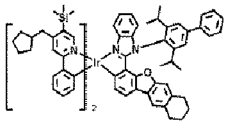
1423

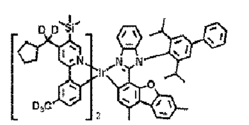
1424

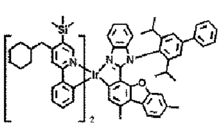
1425

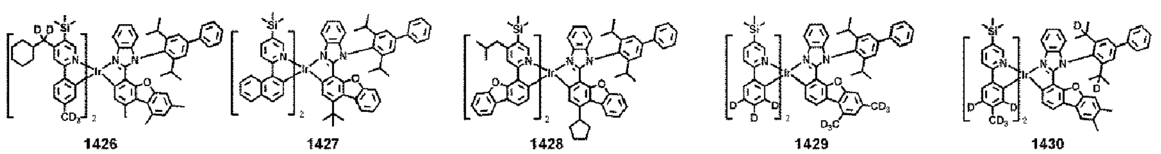
1426 1427 1428 1429 1430

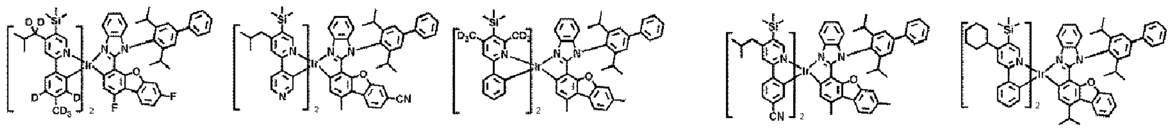
1431 1432 1433 1434 1435

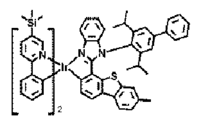
1436
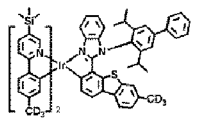
1437
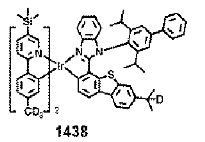
1438
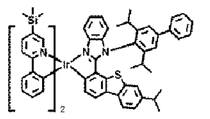
1439
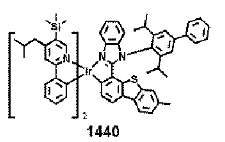
1440

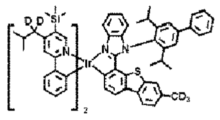
1441
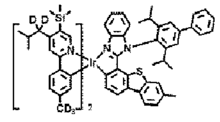
1442
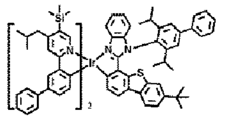
1443
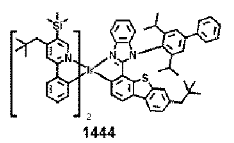
1444
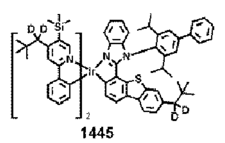
1445

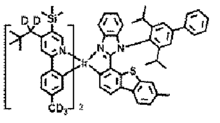
1446
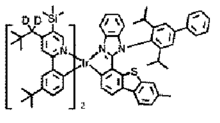
1447
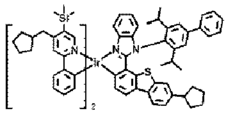
1448
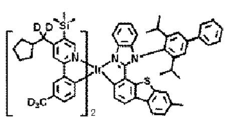
1449
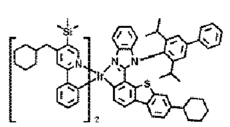
1450

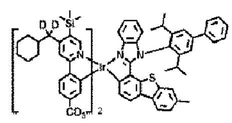
1451
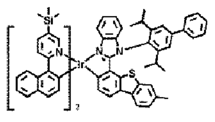
1452
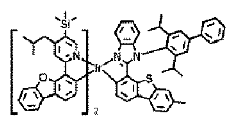
1453
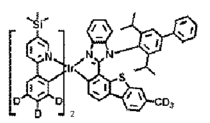
1454
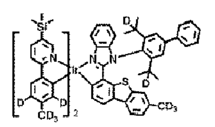
1455

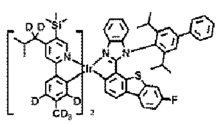
1456
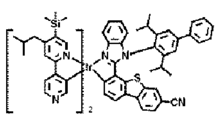
1457
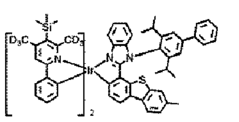
1458
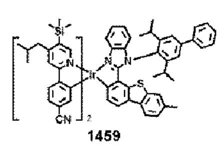
1459
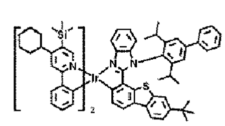
1460

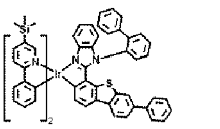
1461
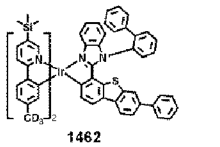
1462
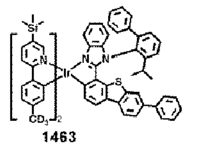
1463
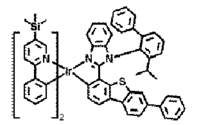
1464
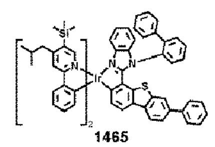
1465

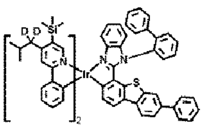
1466
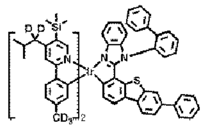
1467
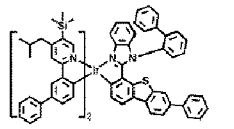
1468
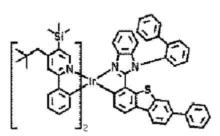
1469
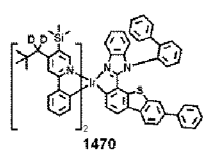
1470

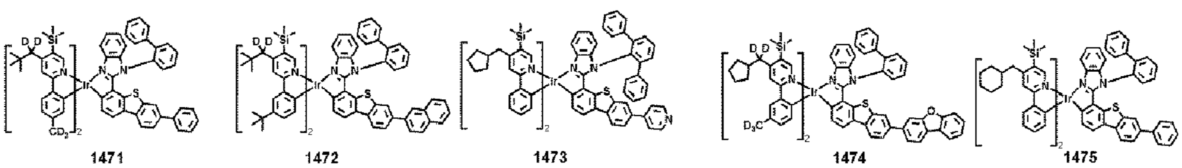
1471
1472
1473
1474
1475

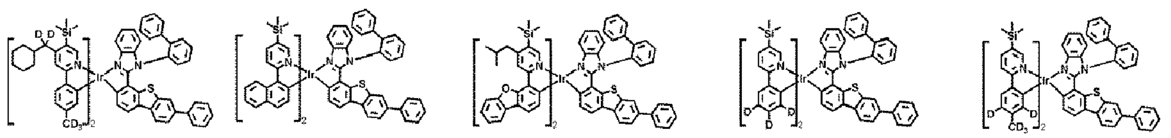
1476
1477
1478
1479
1480

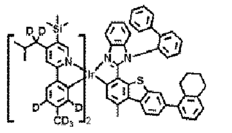
1481
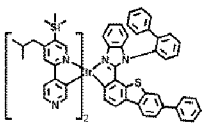
1482
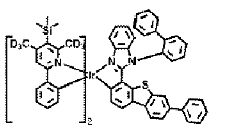
1483
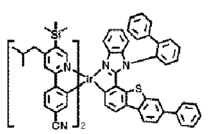
1484
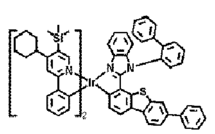
1485

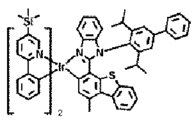
1486
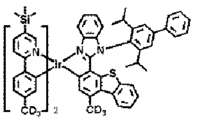
1487
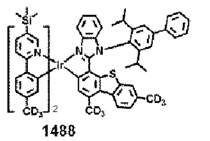
1488
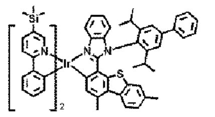
1489
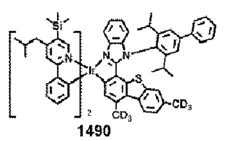
1490

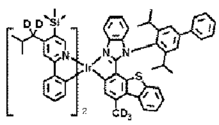
1491
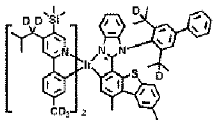
1492
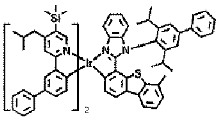
1493
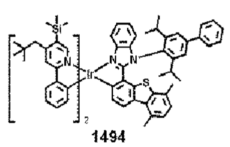
1494
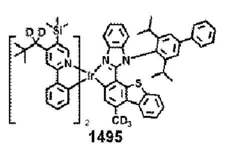
1495

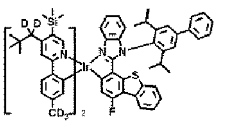
1496
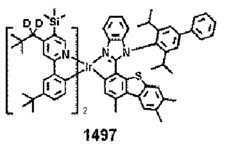
1497
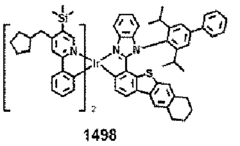
1498
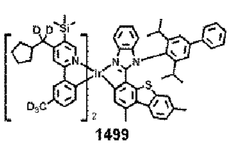
1499
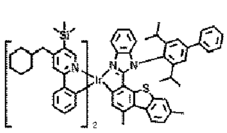
1500

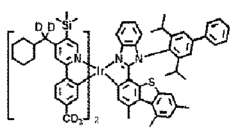
1501
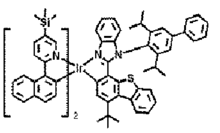
1502
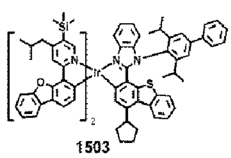
1503
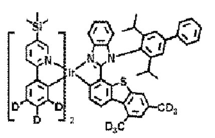
1504
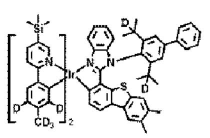
1505

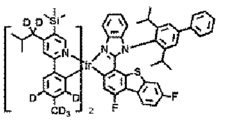
1506
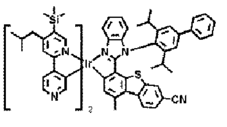
1507
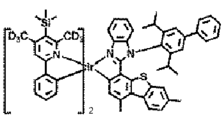
1508
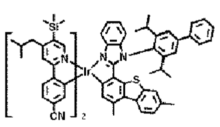
1509
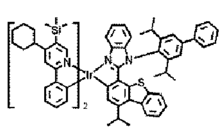
1510

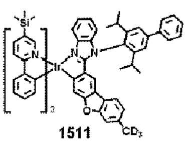
1511
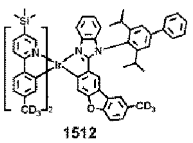
1512
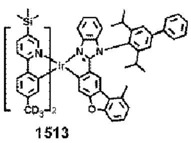
1513
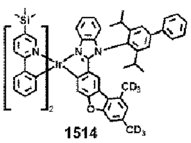
1514
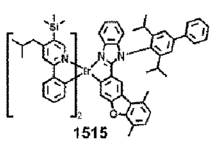
1515

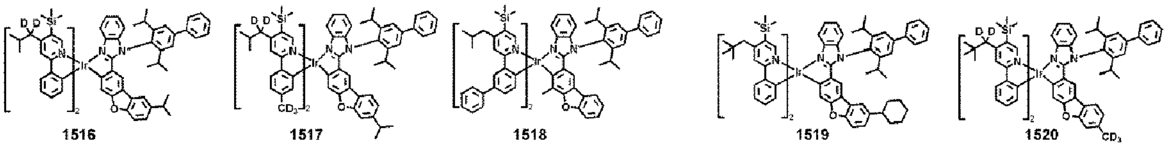
1516 1517 1518 1519 1520

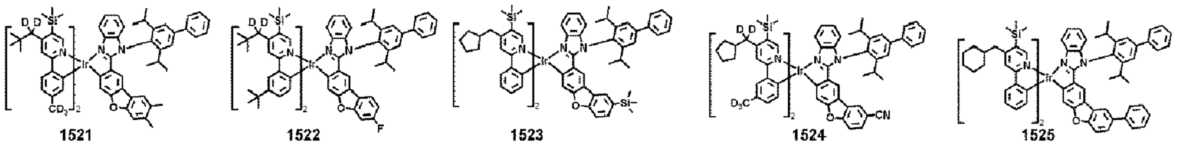
1521 1522 1523 1524 1525

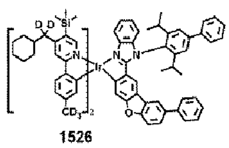
1526
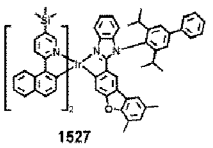
1527
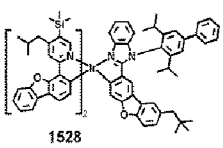
1528
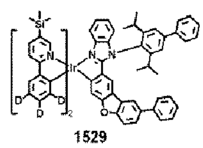
1529
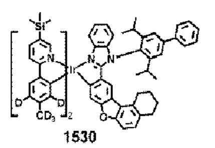
1530

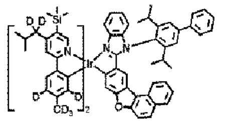
1531
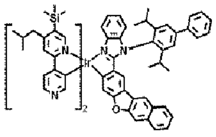
1532
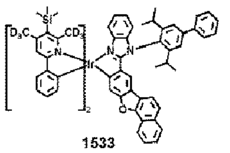
1533
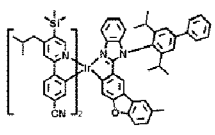
1534
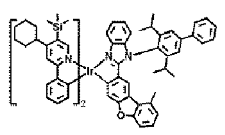
1535

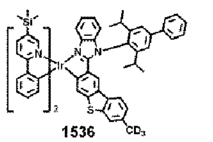
1536
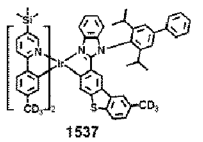
1537
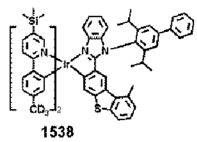
1538
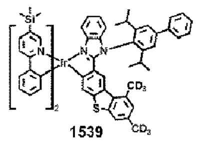
1539
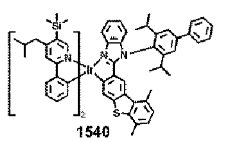
1540

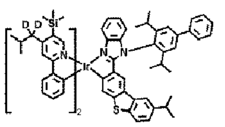
1541
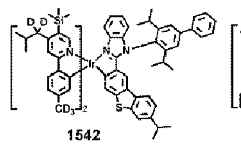
1542
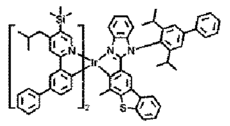
1543
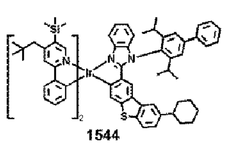
1544
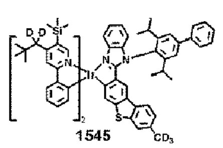
1545

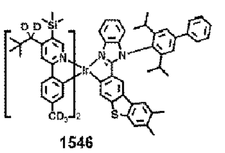
1546
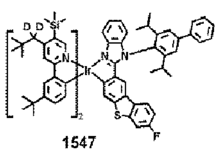
1547
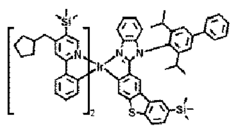
1548
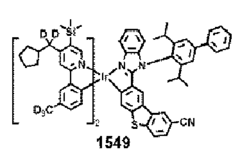
1549
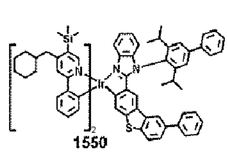
1550

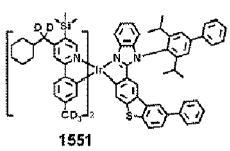
1551
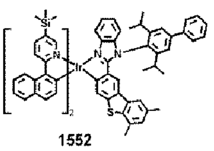
1552
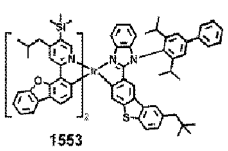
1553
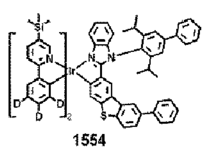
1554
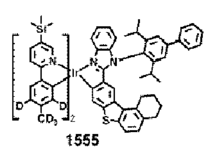
1555

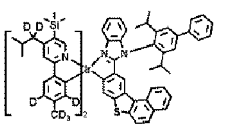
1556
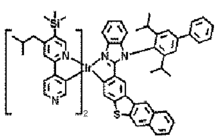
1557
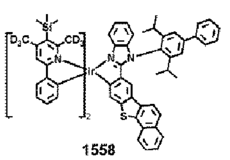
1558
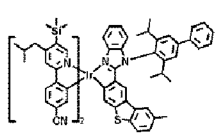
1559
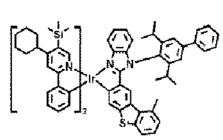
1560

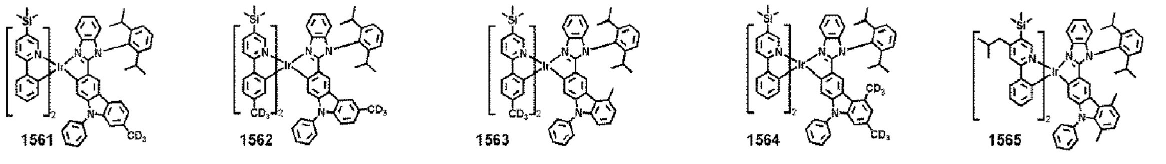
1561
1562
1563
1564
1565

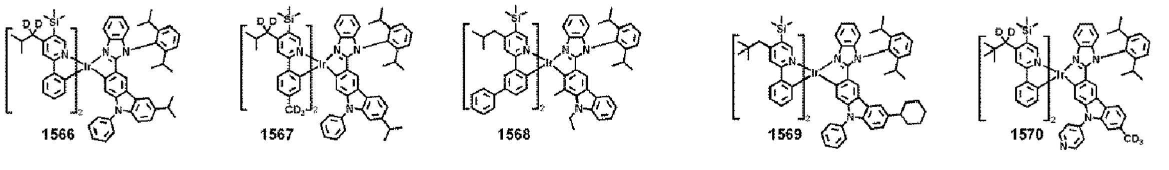
1566
1567
1568
1569
1570

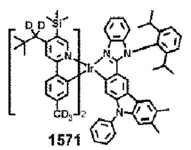
1571
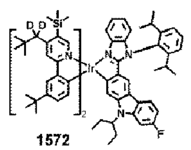
1572
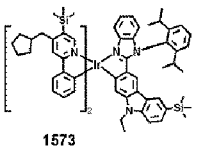
1573
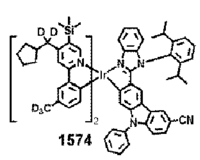
1574
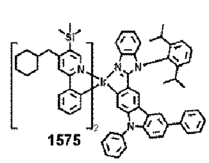
1575

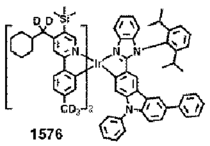
1576
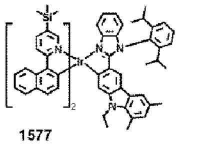
1577
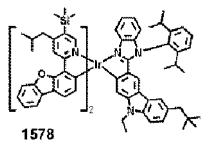
1578
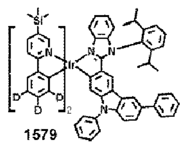
1579
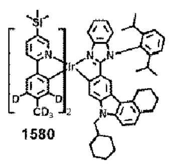
1580

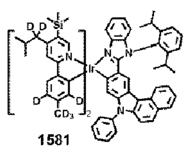
1581
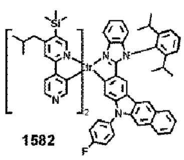
1582
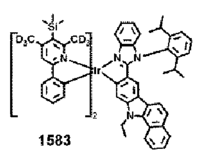
1583
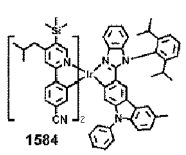
1584
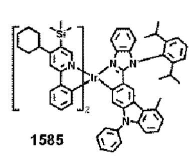
1585

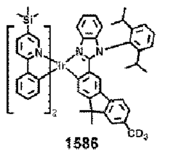
1586
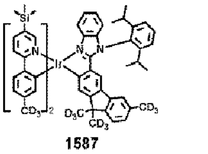
1587
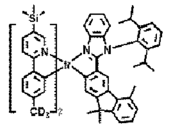
1588
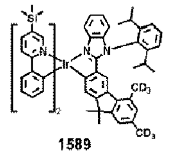
1589
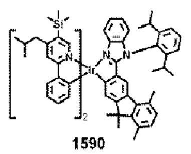
1590

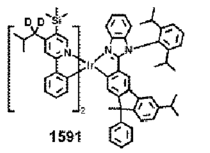
1591
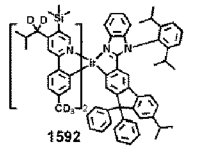
1592
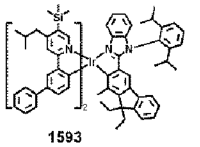
1593
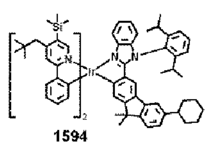
1594
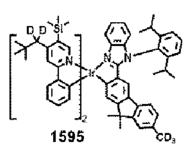
1595

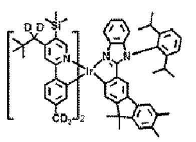
1596
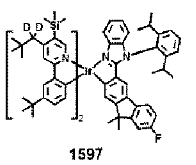
1597
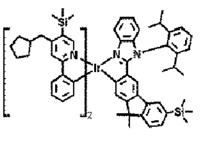
1598
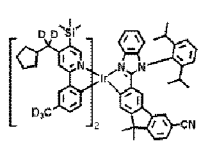
1599
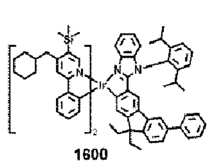
1600

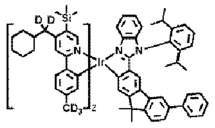
1601
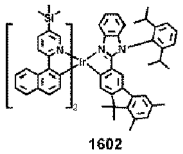
1602
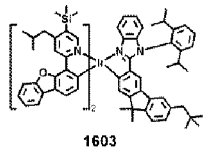
1603
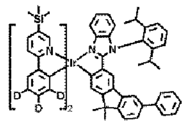
1604
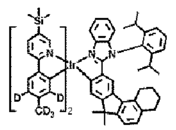
1605

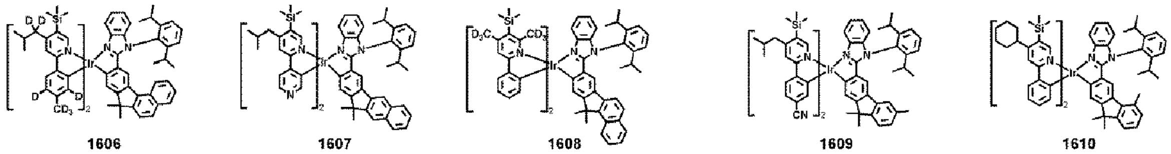
1606
1607
1608
1609
1610

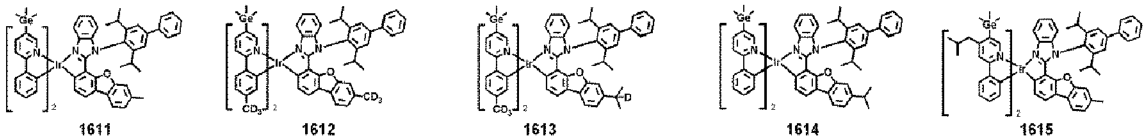
1611
1612
1613
1614
1615

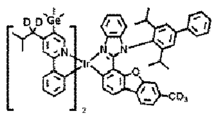
1616

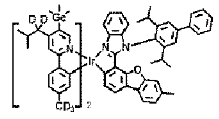
1617

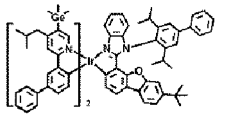
1618

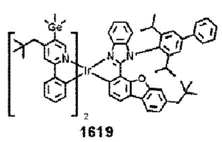
1619

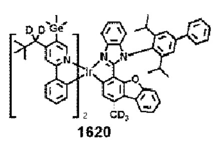
1620

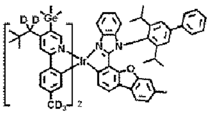
1621

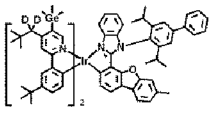
1622

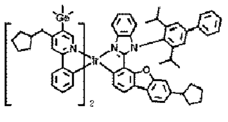
1623

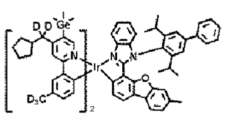
1624

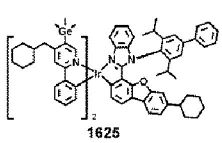
1625

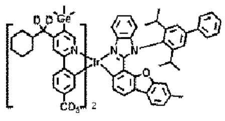
1626

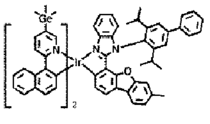
1627

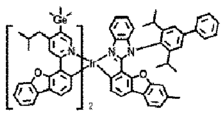
1628

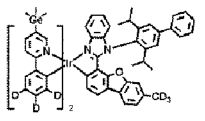
1629

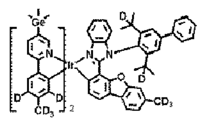
1630

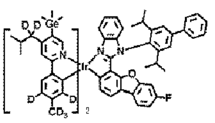
1631

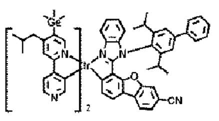
1632

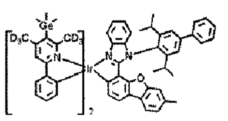
1633

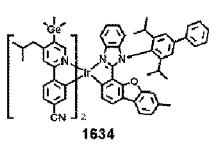
1634

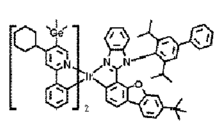
1635

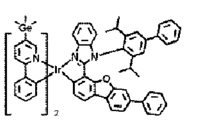
1636

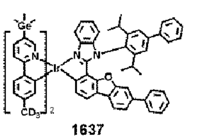
1637

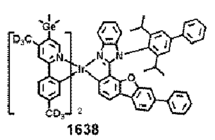
1638

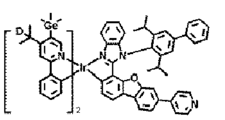
1639

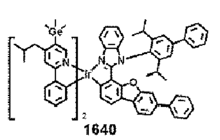
1640

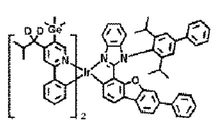
1641

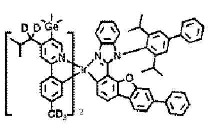
1642

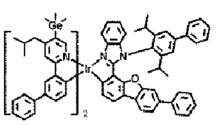
1643

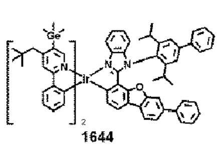
1644

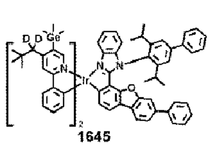
1645

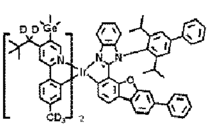
1646

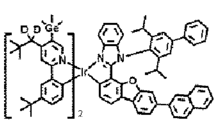
1647

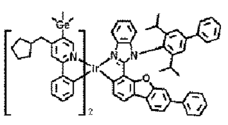
1648

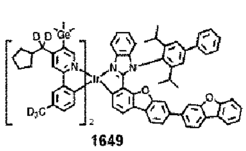
1649

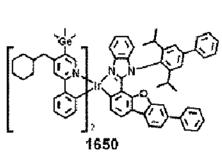
1650

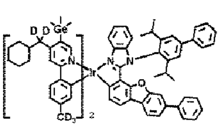
1651

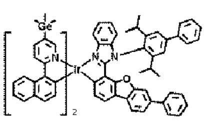
1652

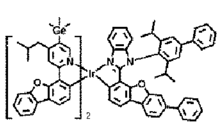
1653

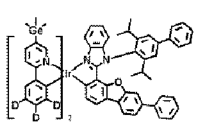
1654

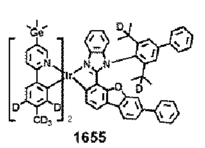
1655

1656

1657

1658

1659

1660

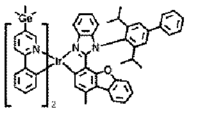
1661

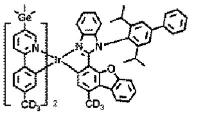
1662

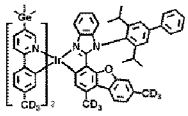
1663

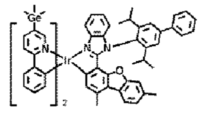
1664

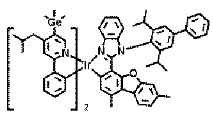
1665

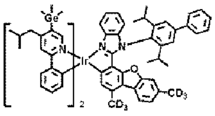
1666

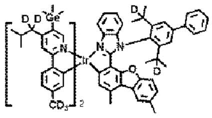
1667

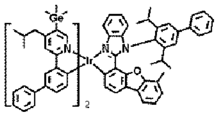
1668

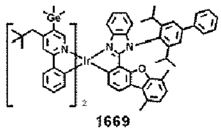
1669

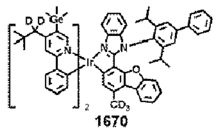
1670

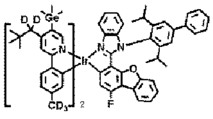
1671

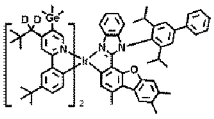
1672

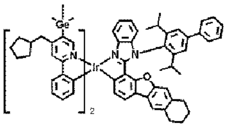
1673

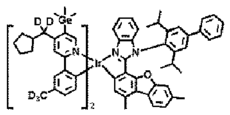
1674

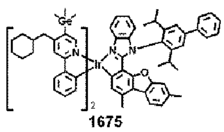
1675

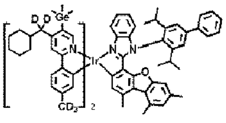
1676

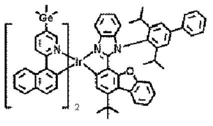
1677

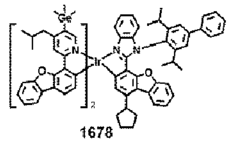
1678

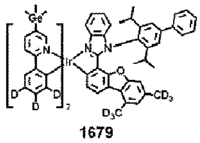
1679

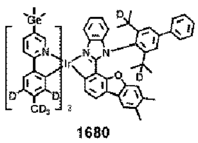
1680

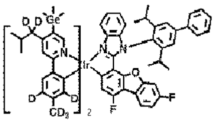
1681

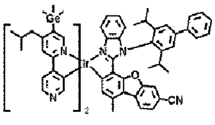
1682

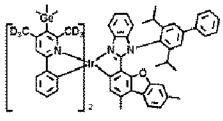
1683

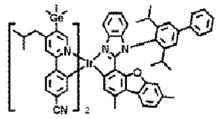
1684

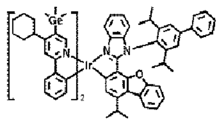
1685

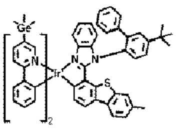
1686

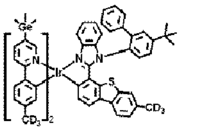
1687

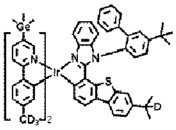
1688

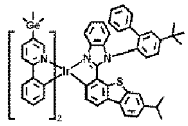
1689

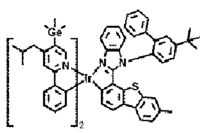
1690

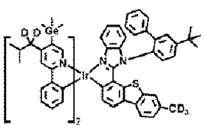
1691

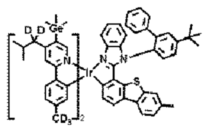
1692

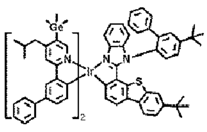
1693

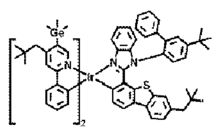
1694

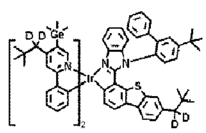
1695

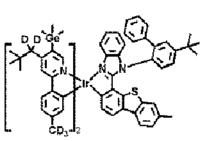
1696

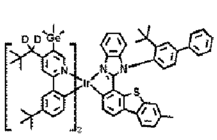
1697

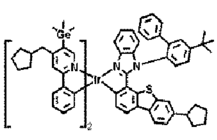
1698

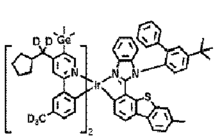
1699

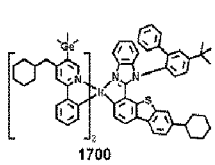
1700

1701

1702

1703

1704

1705

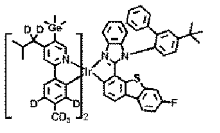 1706
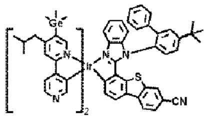 1707
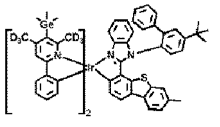 1708
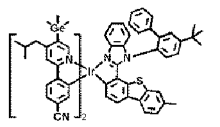 1709
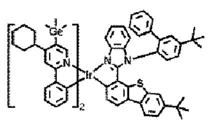 1710

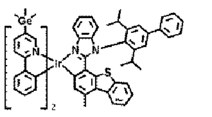 1711
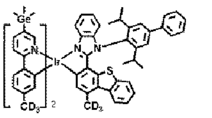 1712
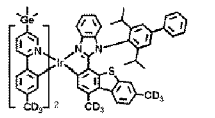 1713
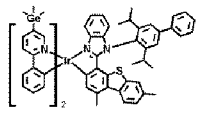 1714
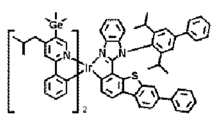 1715

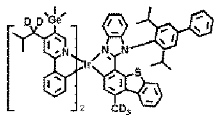 1716
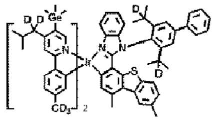 1717
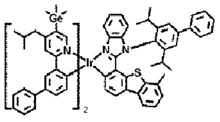 1718
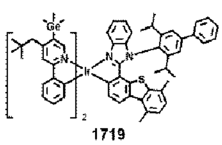 1719
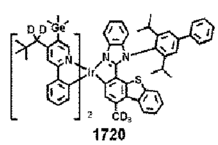 1720

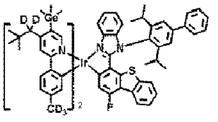 1721
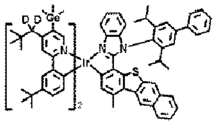 1722
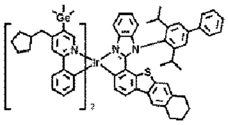 1723
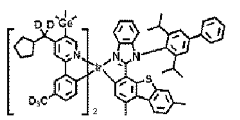 1724
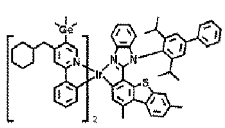 1725

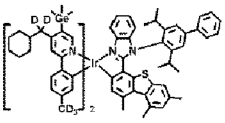 1726
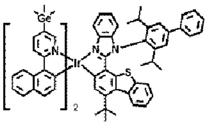 1727
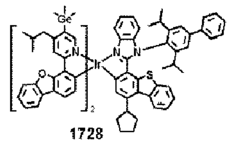 1728
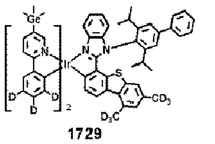 1729
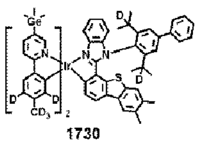 1730

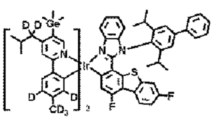 1731
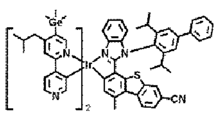 1732
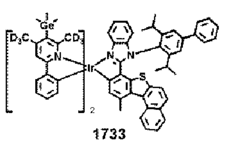 1733
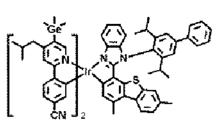 1734
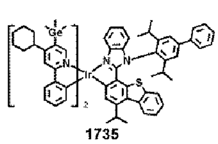 1735

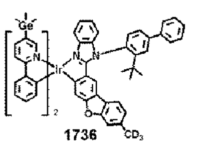 1736
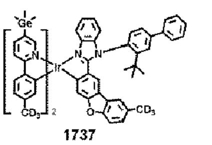 1737
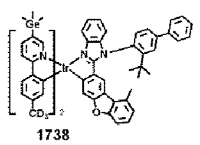 1738
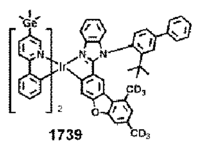 1739
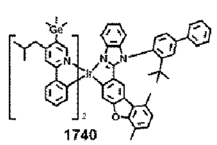 1740

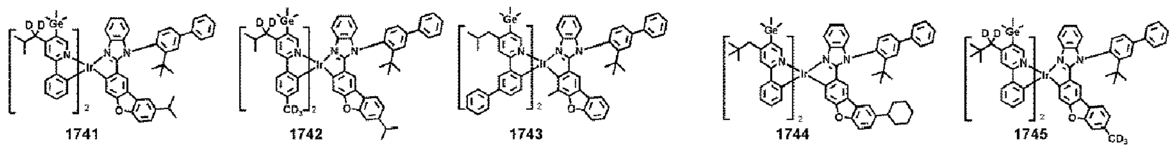
1741 1742 1743 1744 1745

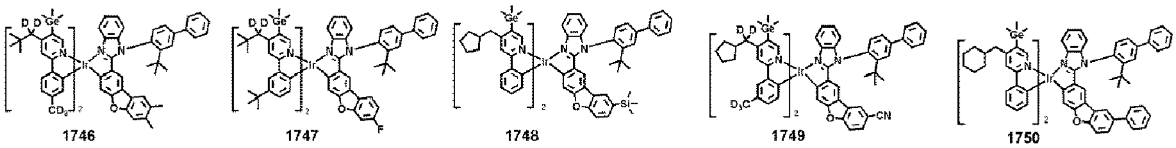
1746 1747 1748 1749 1750

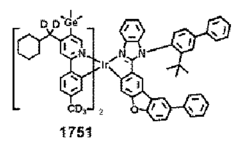
1751
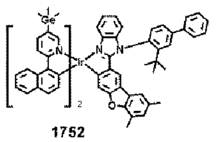
1752
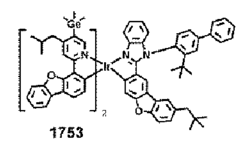
1753
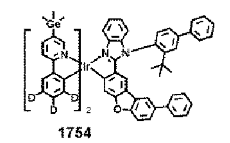
1754
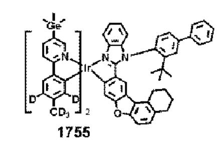
1755

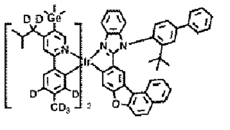
1756
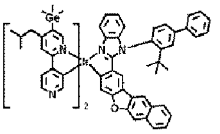
1757
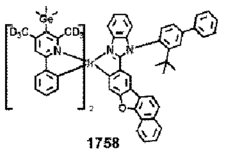
1758
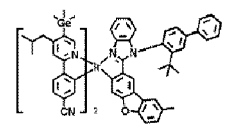
1759
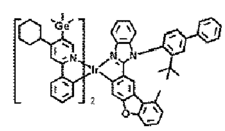
1760

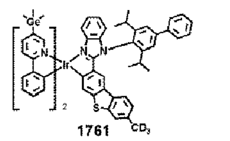
1761
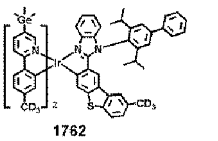
1762
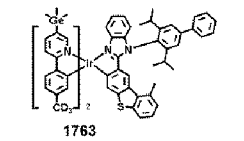
1763
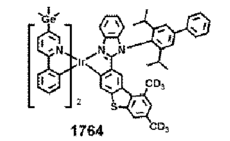
1764
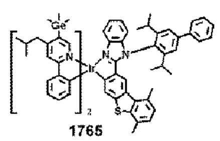
1765

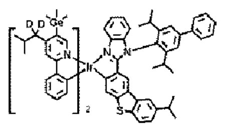
1766
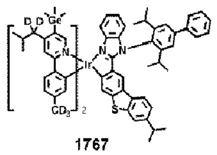
1767
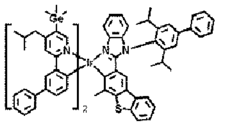
1768
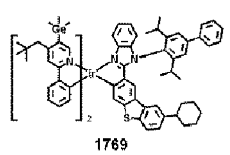
1769
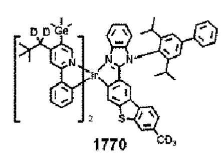
1770

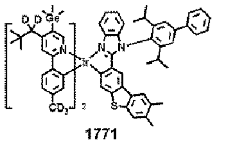
1771
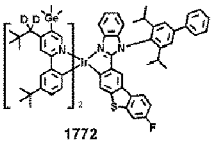
1772
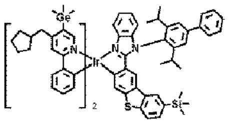
1773
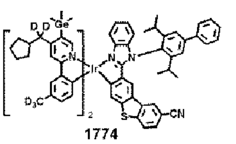
1774
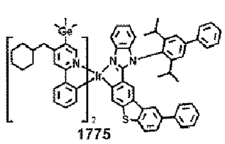
1775

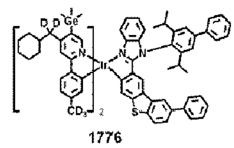
1776
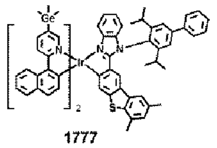
1777
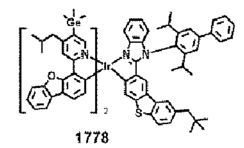
1778
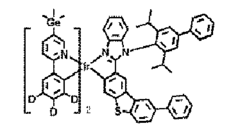
1779
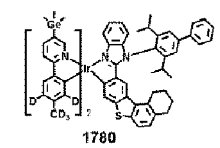
1780

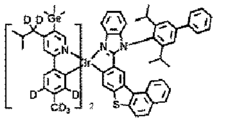
1781
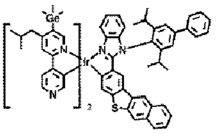
1782
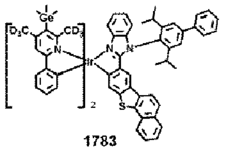
1783
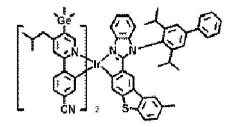
1784
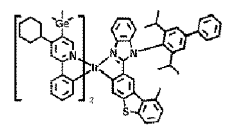
1785

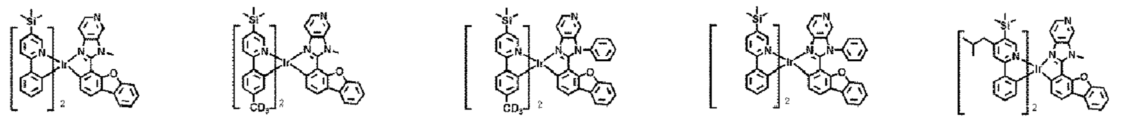
1786 1787 1788 1789 1790

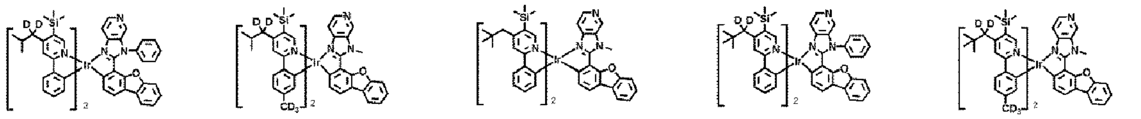
1791 1792 1793 1794 1795

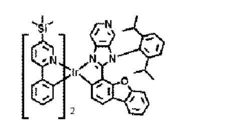
1796

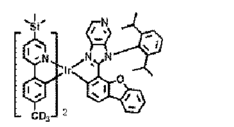
1797

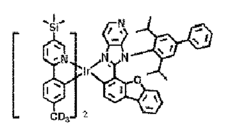
1798

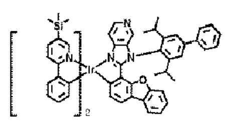
1799

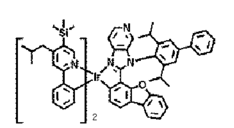
1800

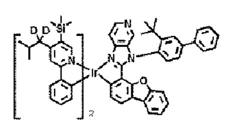
1801

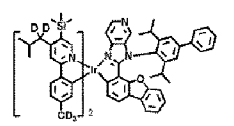
1802

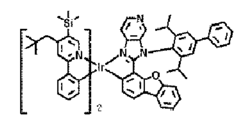
1803

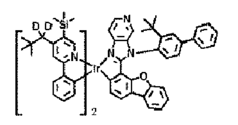
1804

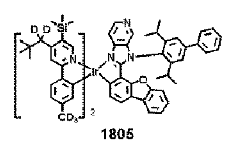
1805

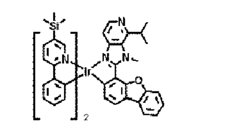
1806

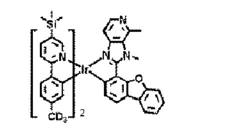
1807

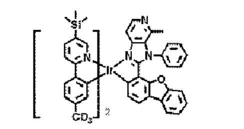
1808

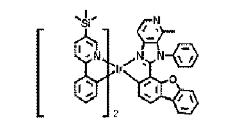
1809

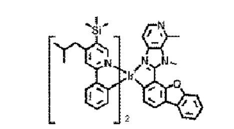
1810

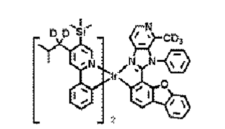
1811

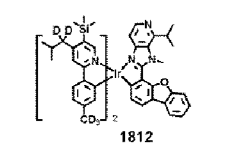
1812

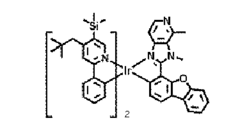
1813

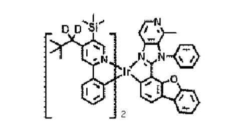
1814

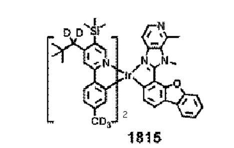
1815

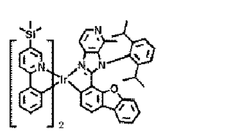
1816

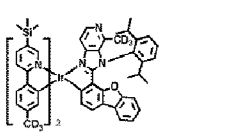
1817

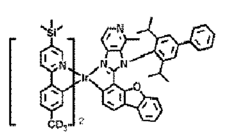
1818

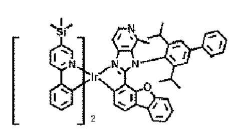
1819

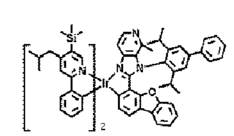
1820

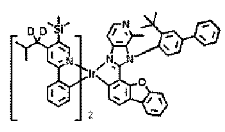
1821

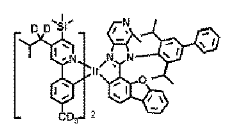
1822

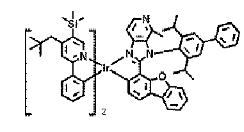
1823

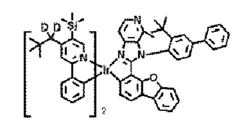
1824

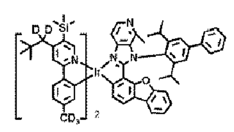
1825

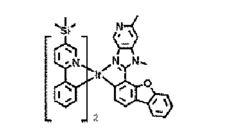
1826

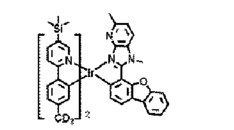
1827

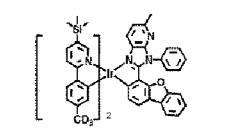
1828

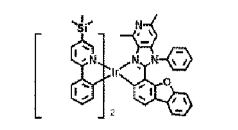
1829

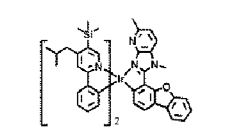
1830

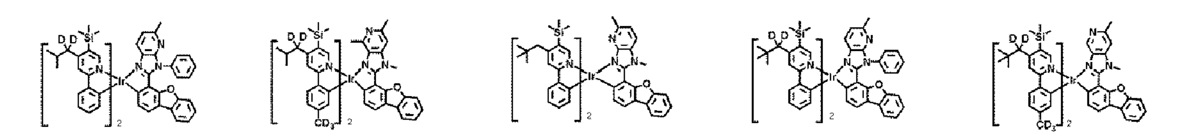
1831 1832 1833 1834 1835

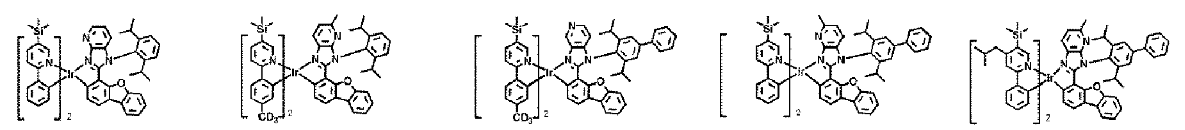
1836 1837 1838 1839 1840

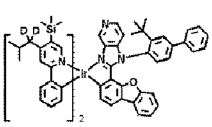
1841
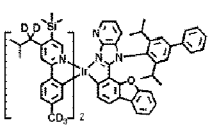
1842
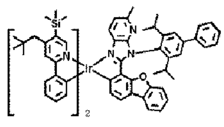
1843
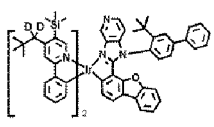
1844
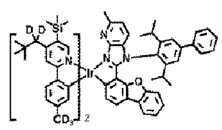
1845

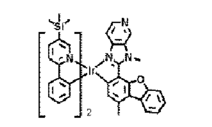
1846
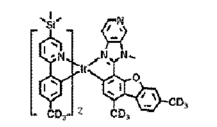
1847
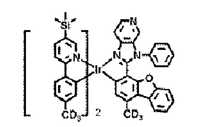
1848
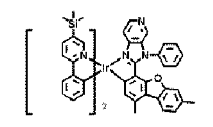
1849
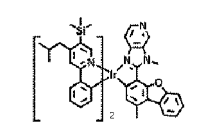
1850

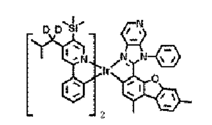
1851
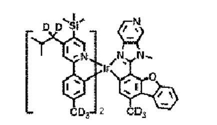
1852
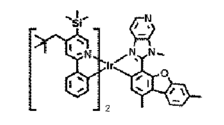
1853
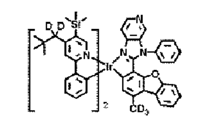
1854
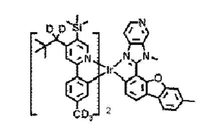
1855

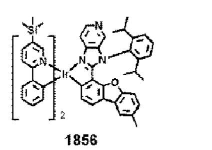
1856
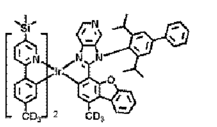
1857
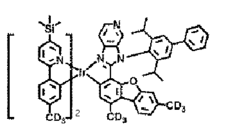
1858
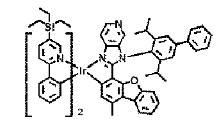
1859
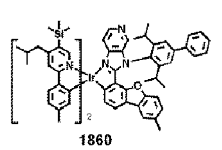
1860

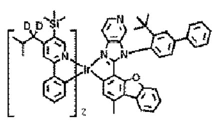
1861
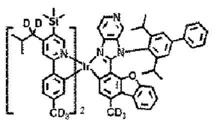
1862
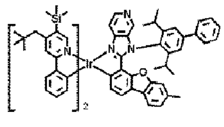
1863
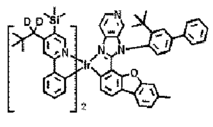
1864
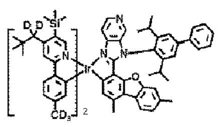
1865

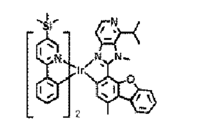
1866
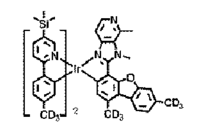
1867
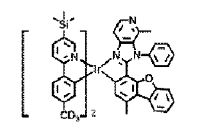
1868
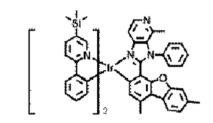
1869
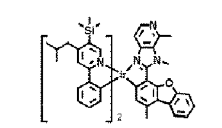
1870

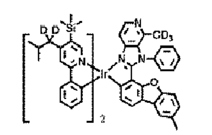
1871
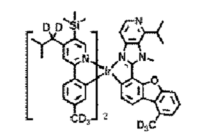
1872
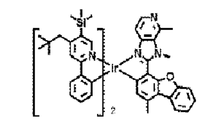
1873
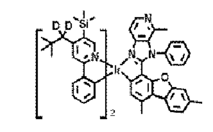
1874
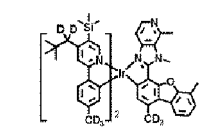
1875

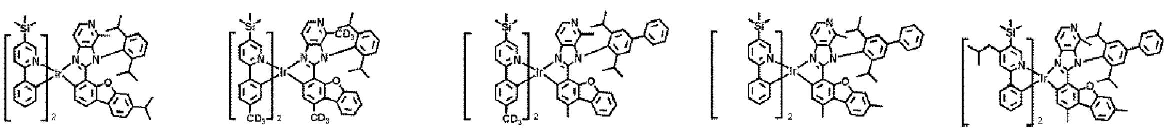
1876
1877
1878
1879
1880

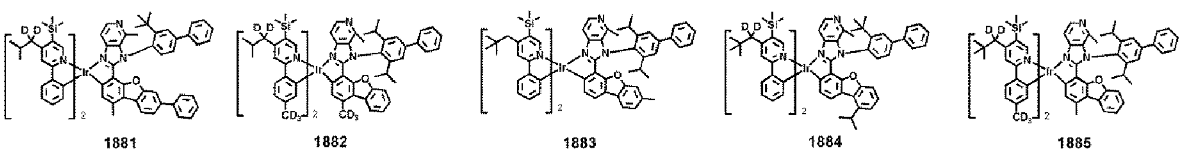
1881
1882
1883
1884
1885

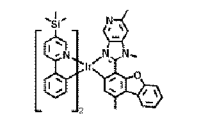
1886

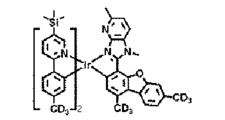
1887

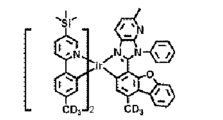
1888

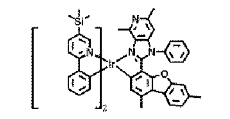
1889

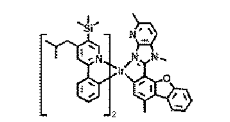
1890

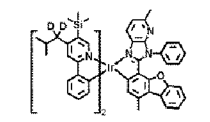
1891

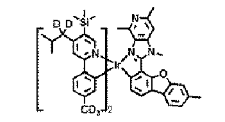
1892

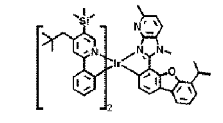
1893

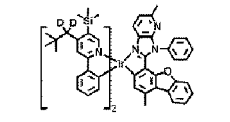
1894

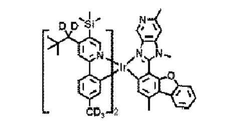
1895

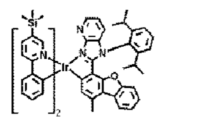
1896

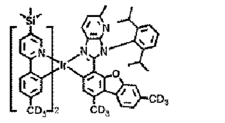
1897

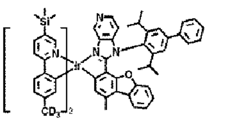
1898

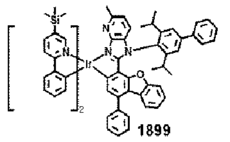
1899

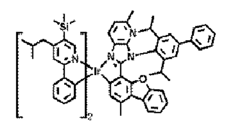
1900

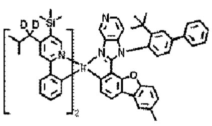
1901

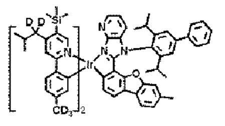
1902

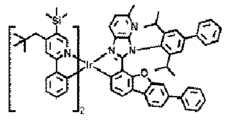
1903

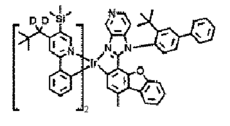
1904

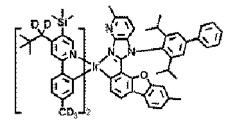
1905

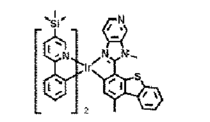
1906

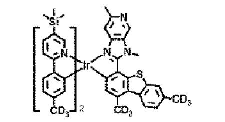
1907

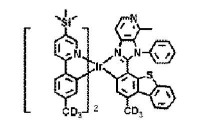
1908

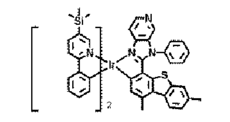
1909

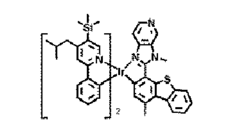
1910

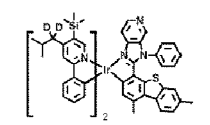
1911

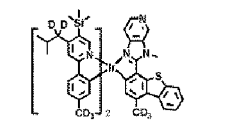
1912

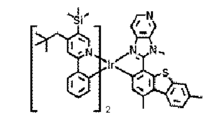
1913

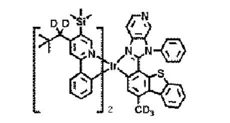
1914

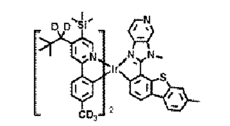
1915

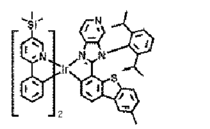
1916

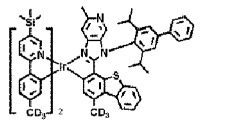
1917

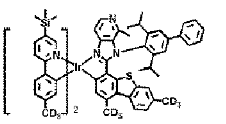
1918

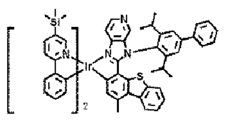
1919

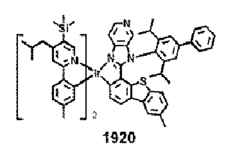
1920

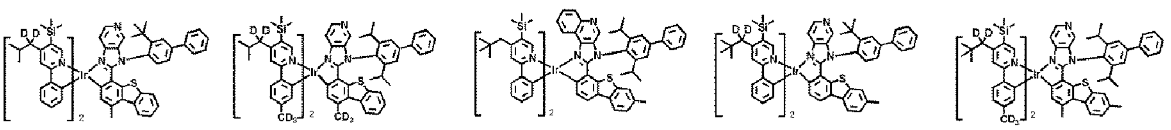
1921 1922 1923 1924 1925

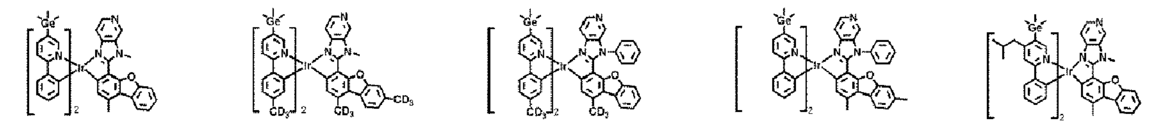
1926 1927 1928 1929 1930

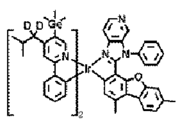
1931

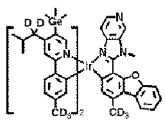
1932

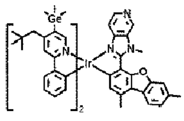
1933

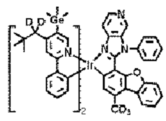
1934

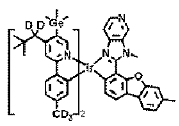
1935

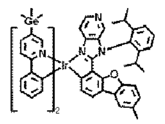
1936

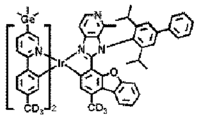
1937

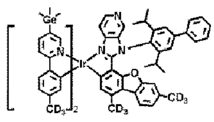
1938

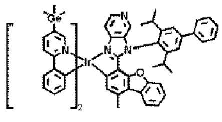
1939

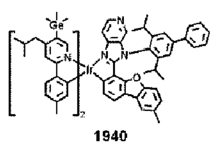
1940

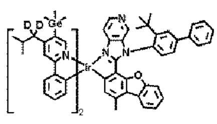
1941

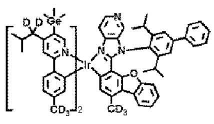
1942

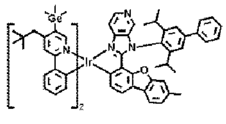
1943

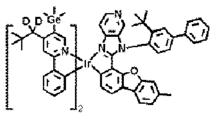
1944

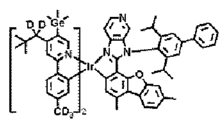
1945

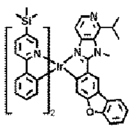
1946

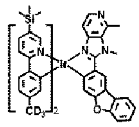
1947

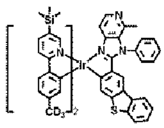
1948

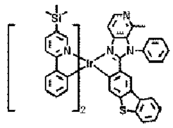
1949

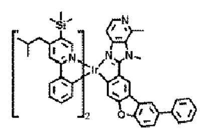
1950

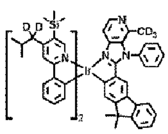
1951

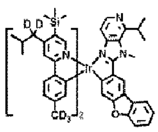
1952

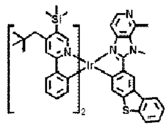
1953

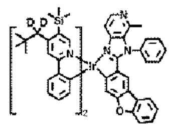
1954

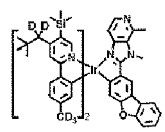
1955

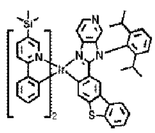
1956

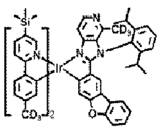
1957

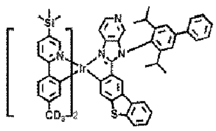
1958

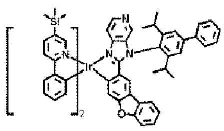
1959

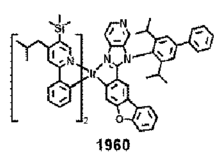
1960

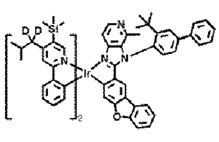
1961

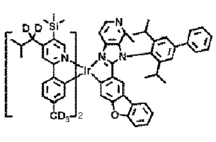
1962

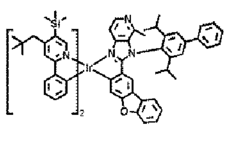
1963

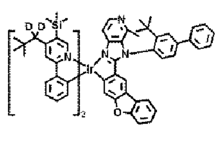
1964

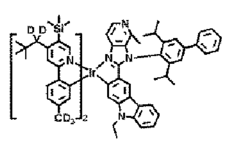
1965

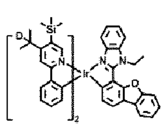
1966

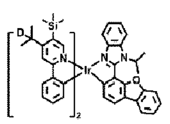
1967

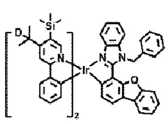
1968

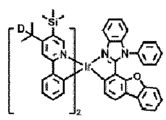
1969

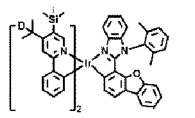
1970

1971

1972

1973

1974

1975

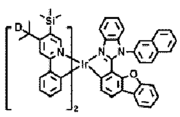
1976
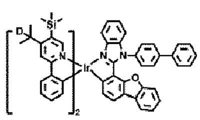
1977
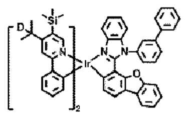
1978
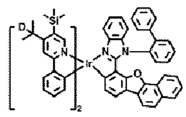
1979
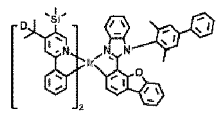
1980
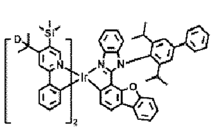
1981
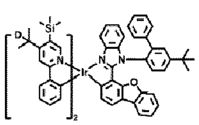
1982
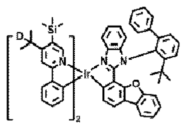
1983
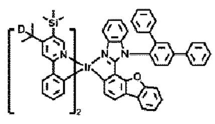
1984
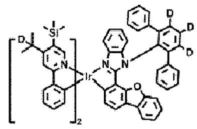
1985
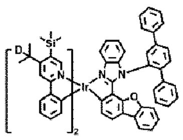
1986
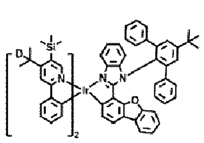
1987
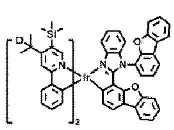
1988
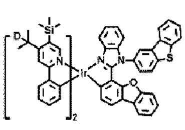
1989
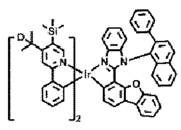
1990
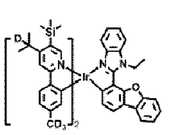
1991
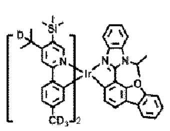
1992
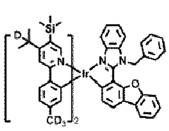
1993
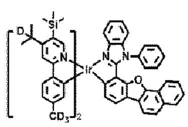
1994
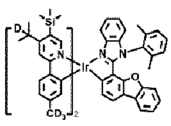
1995
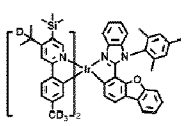
1996
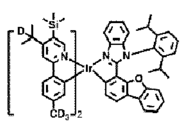
1997
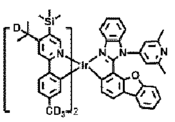
1998
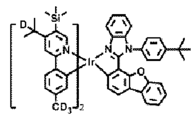
1999
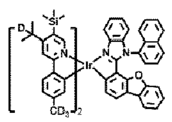
2000
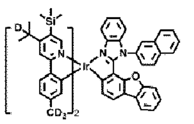
2001
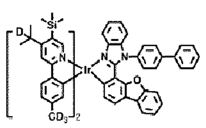
2002
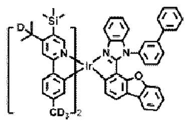
2003
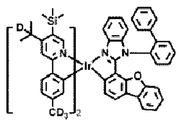
2004
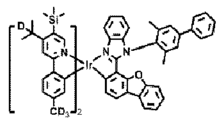
2005
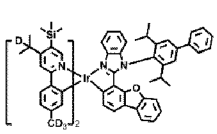
2006
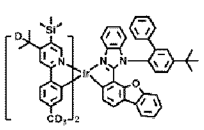
2007
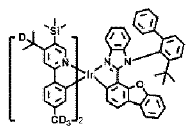
2008
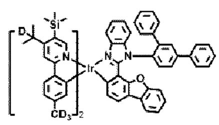
2009
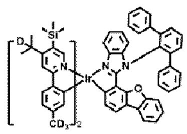
2010
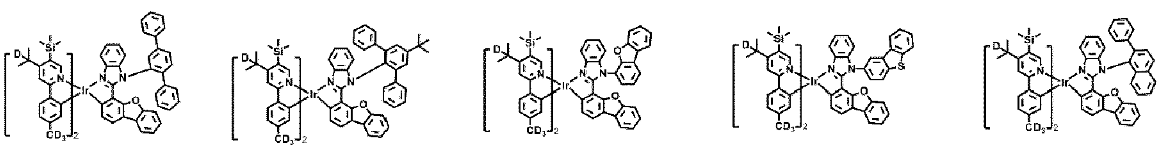
2011 2012 2013 2014 2015
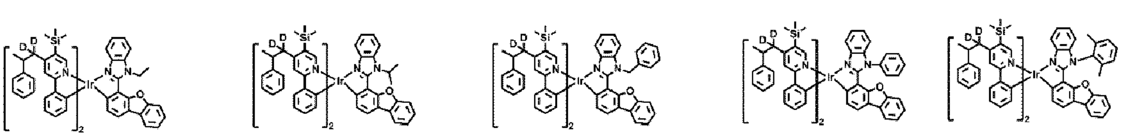
2016 2017 2018 2019 2020

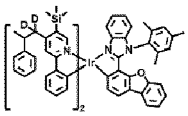
2021

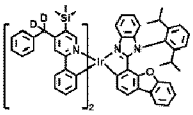
2022

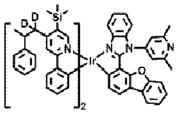
2023

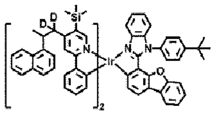
2024

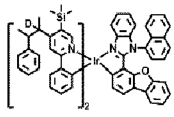
2025

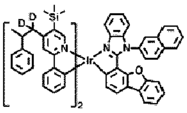
2026

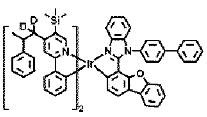
2027

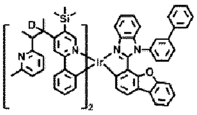
2028

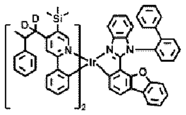
2029

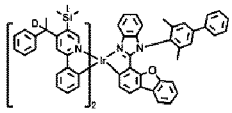
2030

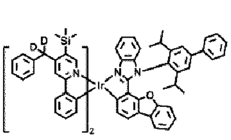
2031

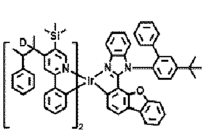
2032

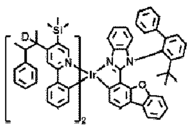
2033

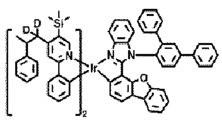
2034

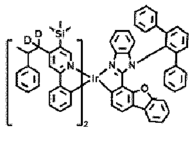
2035

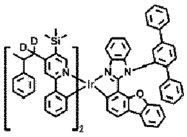
2036

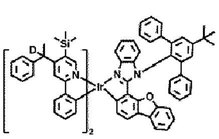
2037

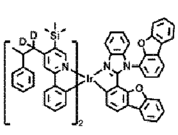
2038

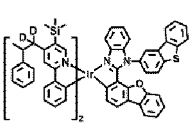
2039

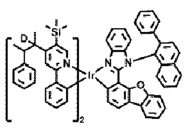
2040

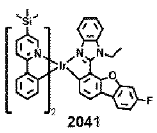
2041

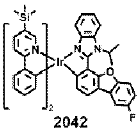
2042

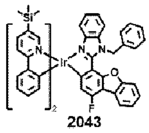
2043

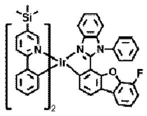
2044

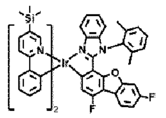
2045

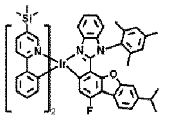
2046

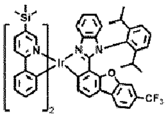
2047

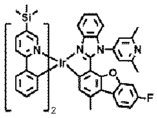
2048

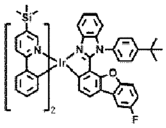
2049

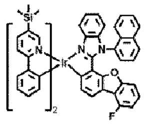
2050

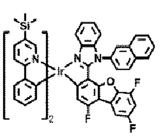
2051

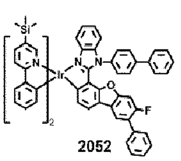
2052

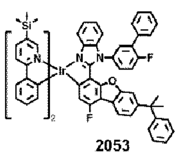
2053

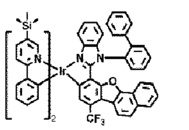
2054

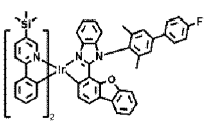
2055

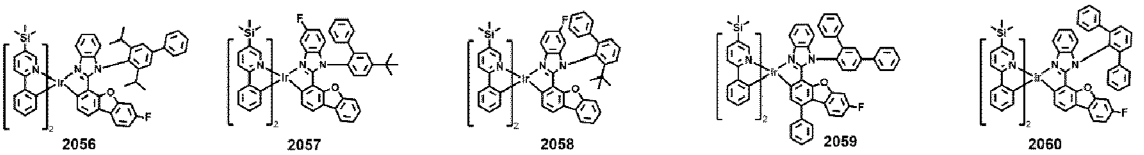
2056 2057 2058 2059 2060

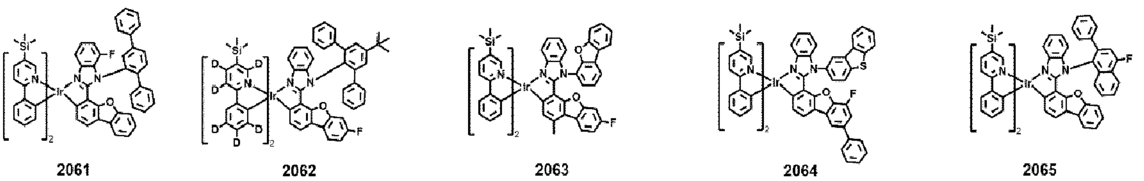
2061 2062 2063 2064 2065

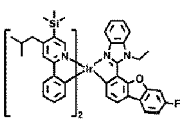
2066
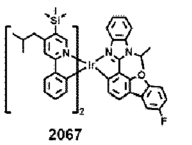
2067
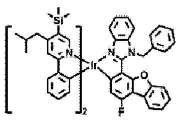
2068
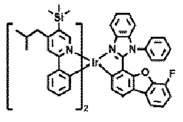
2069
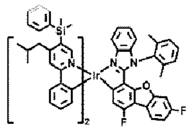
2070

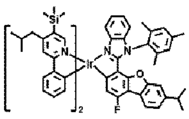
2071
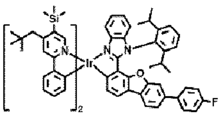
2072
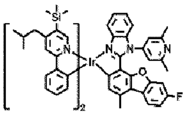
2073
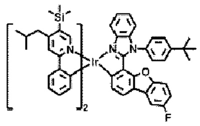
2074
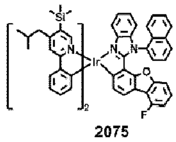
2075

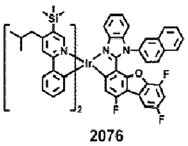
2076
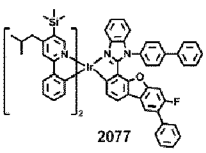
2077
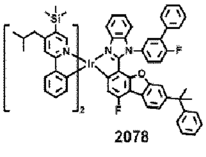
2078
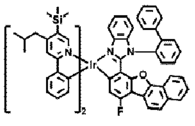
2079
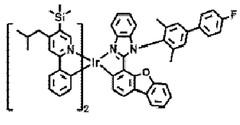
2080

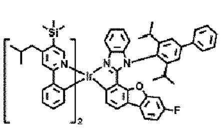
2081
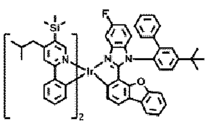
2082
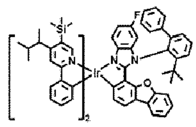
2083
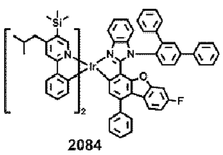
2084
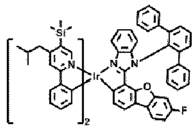
2085

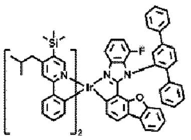
2086
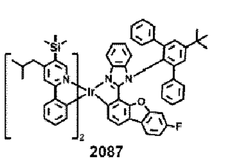
2087
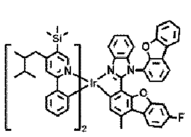
2088
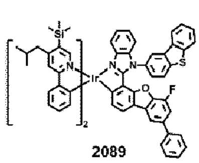
2089
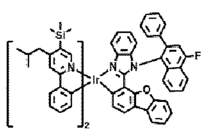
2090

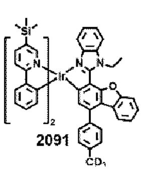
2091
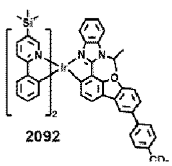
2092
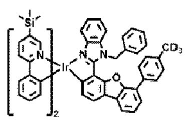
2093
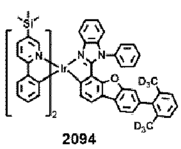
2094
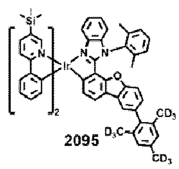
2095

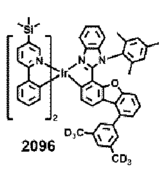
2096
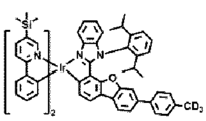
2097
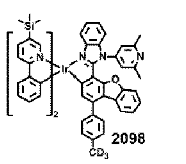
2098
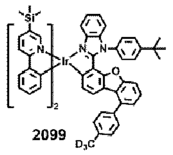
2099
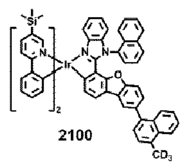
2100

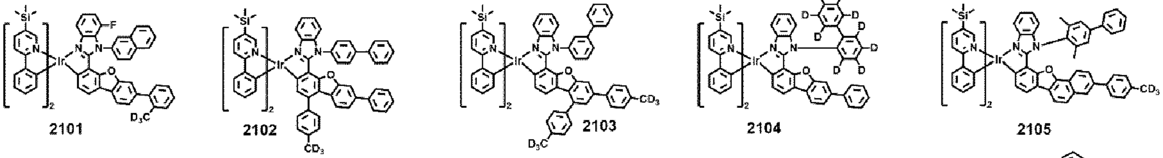
2101
2102
2103
2104
2105

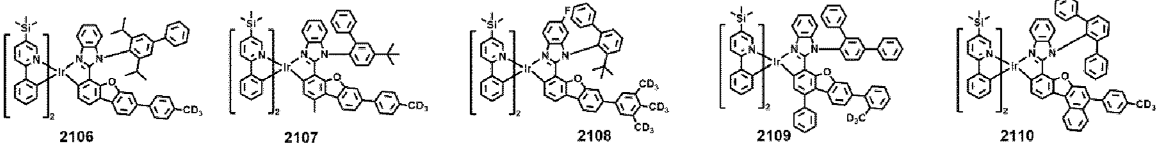
2106
2107
2108
2109
2110

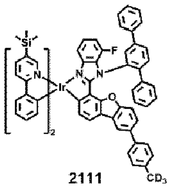
2111

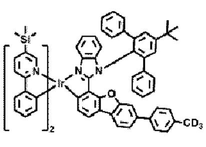
2112

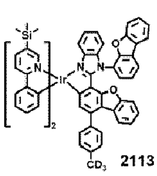
2113

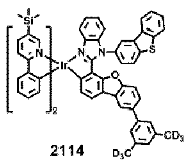
2114

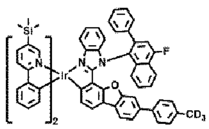
2115

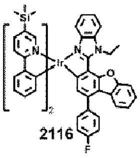
2116

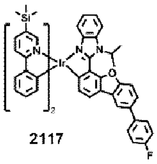
2117

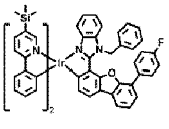
2118

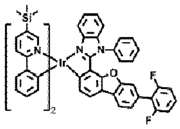
2119

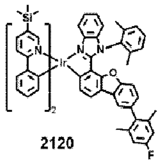
2120

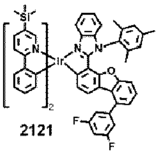
2121

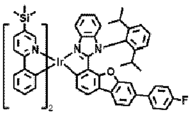
2122

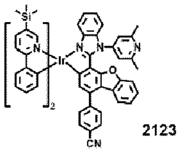
2123

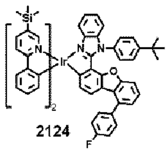
2124

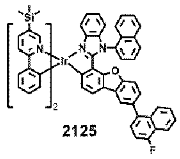
2125

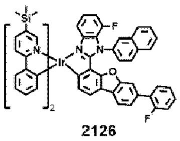
2126

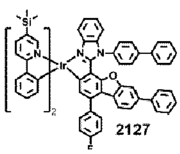
2127

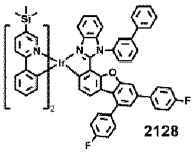
2128

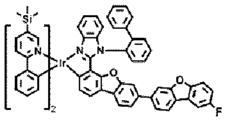
2129

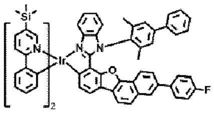
2130

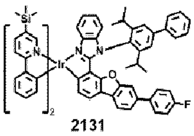
2131

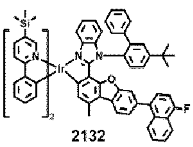
2132

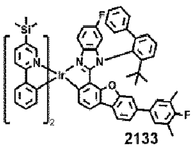
2133

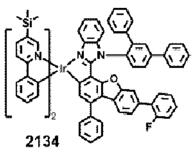
2134

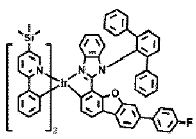
2135

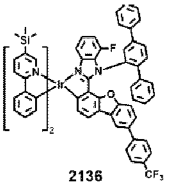
2136

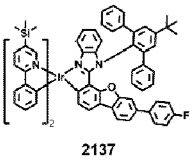
2137

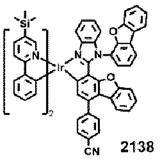
2138

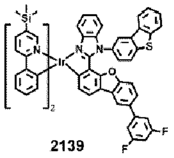
2139

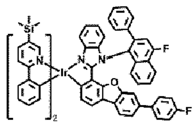
2140

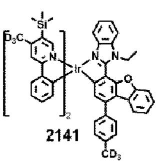
2141

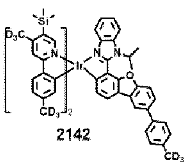
2142

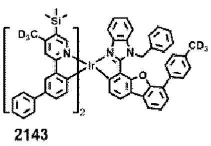
2143

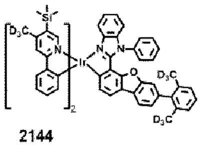
2144

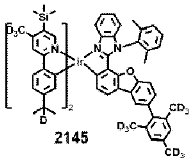
2145

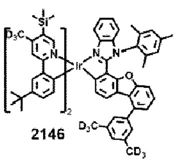
2146
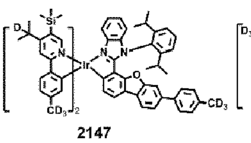
2147
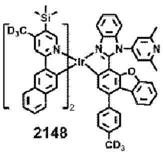
2148
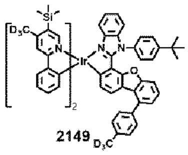
2149
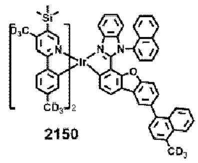
2150

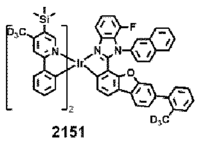
2151
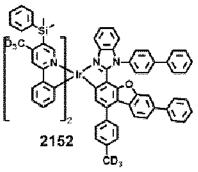
2152
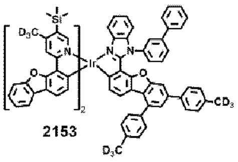
2153
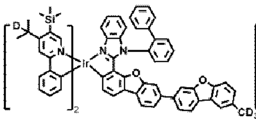
2154
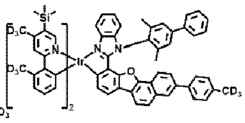
2155

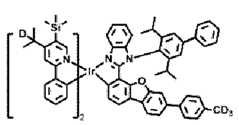
2156
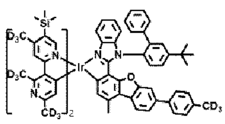
2157
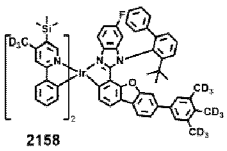
2158
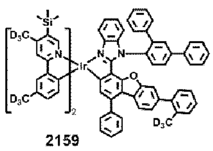
2159
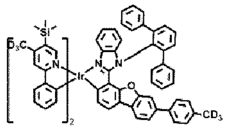
2160

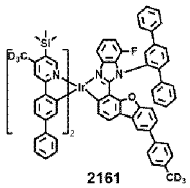
2161
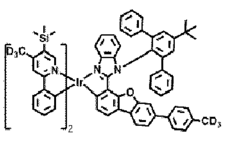
2162
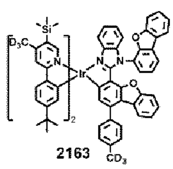
2163
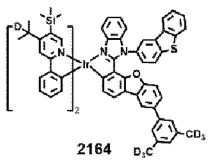
2164
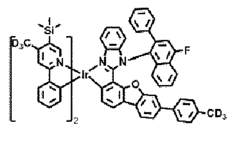
2165

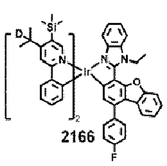
2166
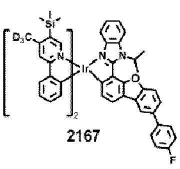
2167
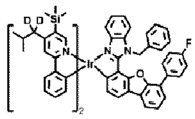
2168
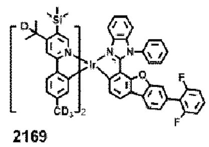
2169
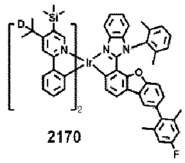
2170

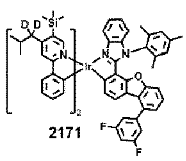
2171
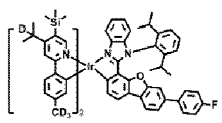
2172
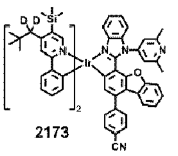
2173
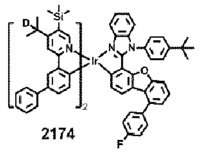
2174
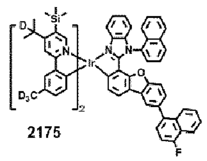
2175

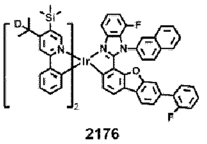
2176
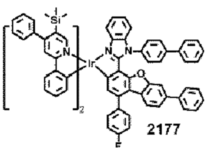
2177
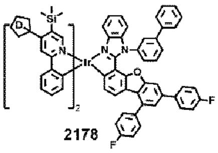
2178
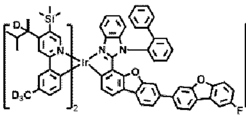
2179
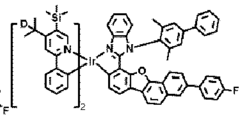
2180

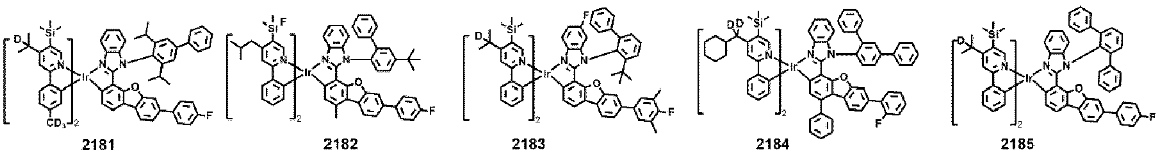
2181
2182
2183
2184
2185

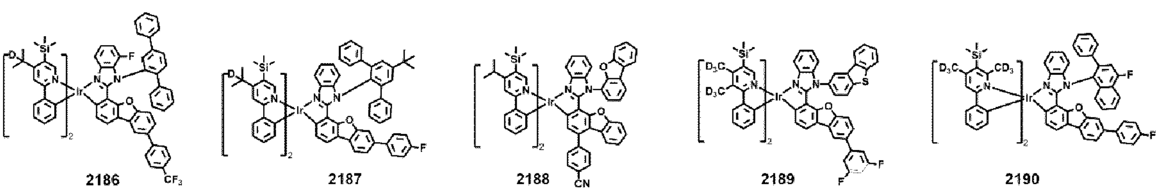
2186
2187
2188
2189
2190

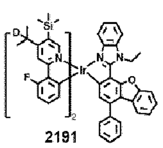
2191

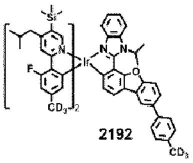
2192

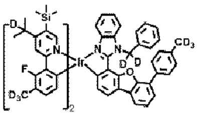
2193

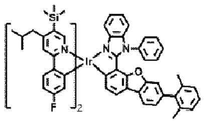
2194

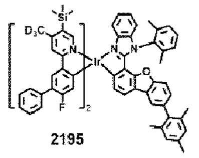
2195

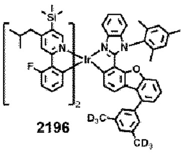
2196

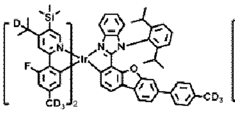
2197

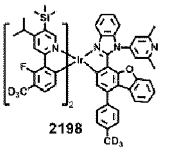
2198

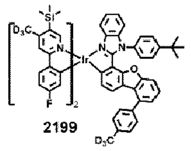
2199

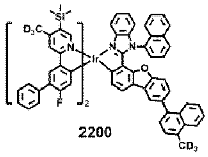
2200

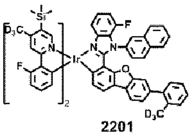
2201

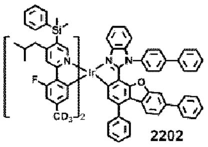
2202

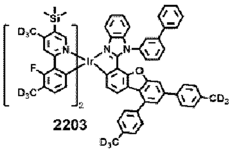
2203

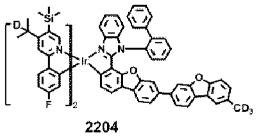
2204

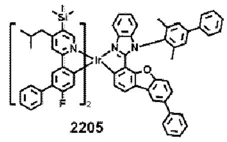
2205

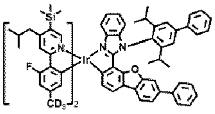
2206

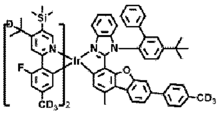
2207

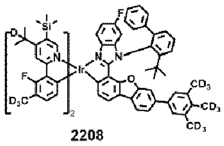
2208

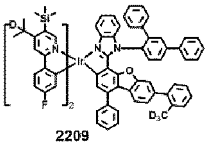
2209

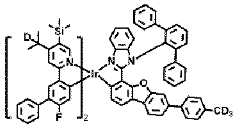
2210

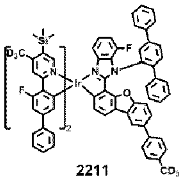
2211

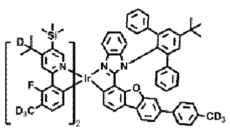
2212

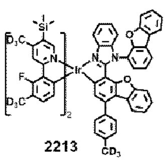
2213

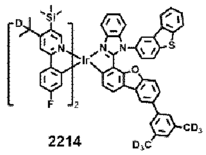
2214

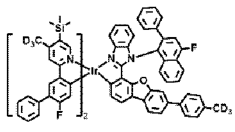
2215

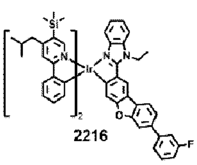
2216

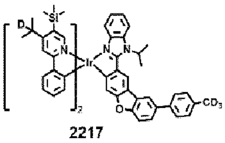
2217

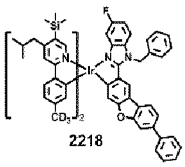
2218

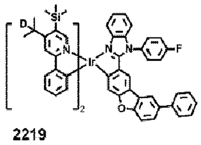
2219

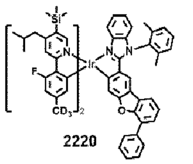
2220

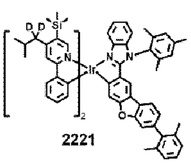
2221

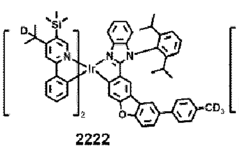
2222

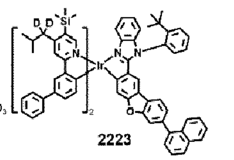
2223

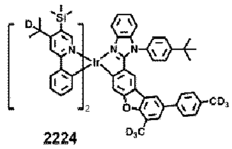
2224

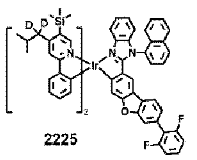
2225

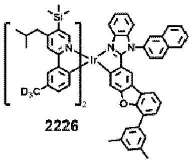
2226
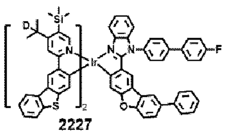
2227
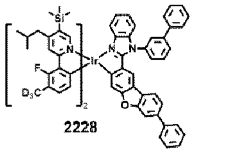
2228
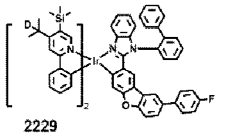
2229
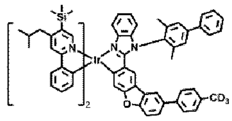
2230

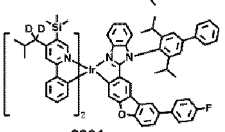
2231
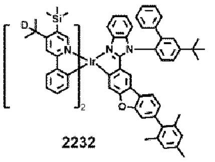
2232
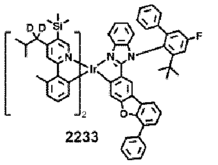
2233
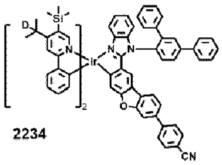
2234
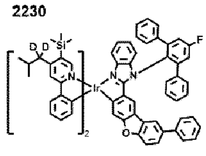
2235

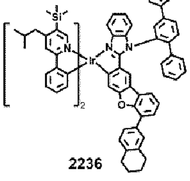
2236
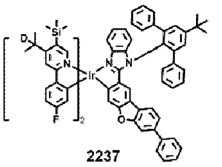
2237
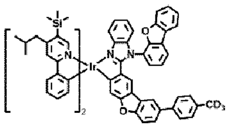
2238
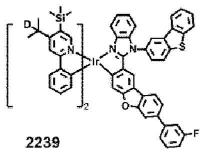
2239
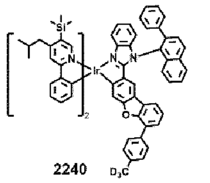
2240

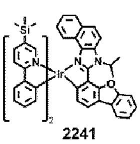
2241
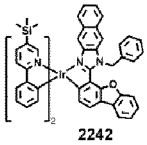
2242
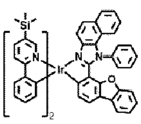
2243
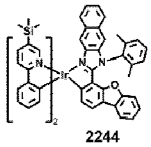
2244
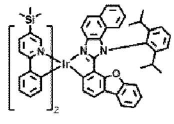
2245

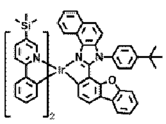
2246
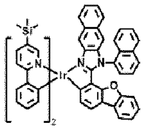
2247
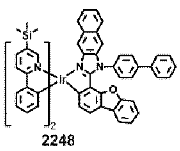
2248
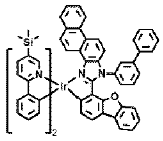
2249
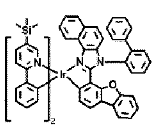
2250

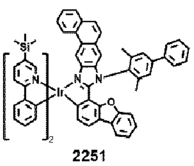
2251
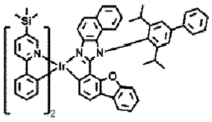
2252
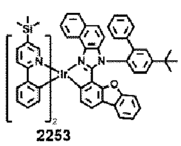
2253
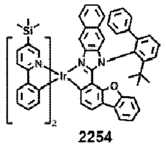
2254
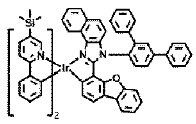
2255

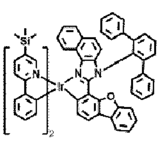
2256
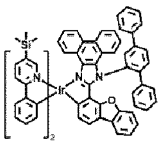
2257
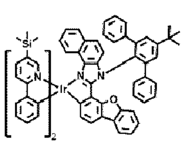
2258
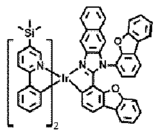
2259
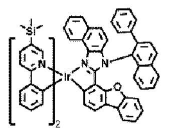
2260

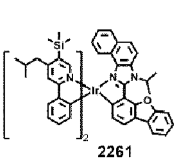
2261
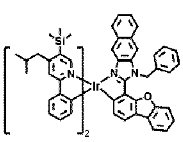
2262
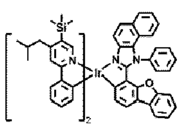
2263
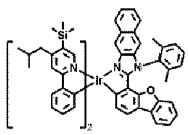
2264
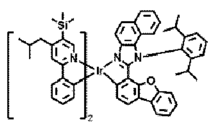
2265

2266
2267
2268
2269
2270

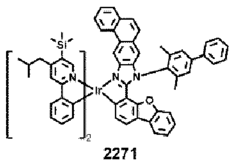
2271
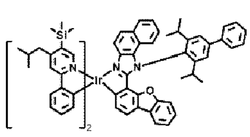
2272
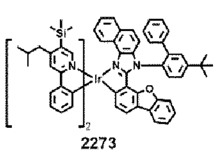
2273
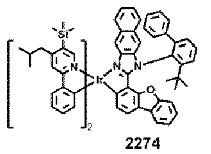
2274
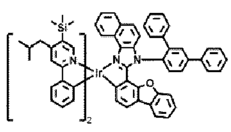
2275

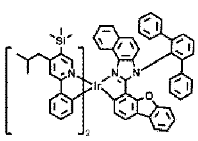
2276
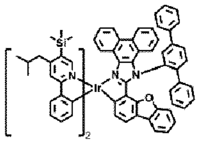
2277
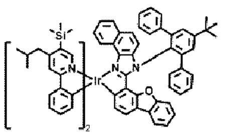
2278
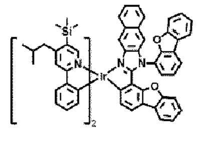
2279
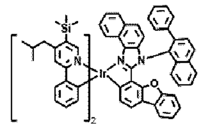
2280

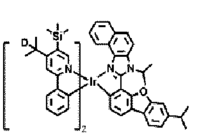
2281
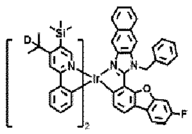
2282
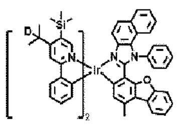
2283
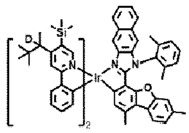
2284
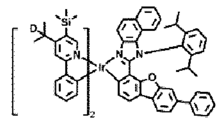
2285

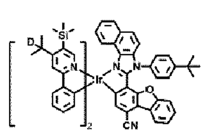
2286
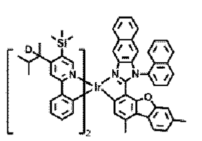
2287
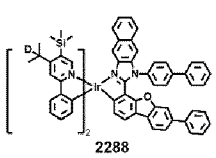
2288
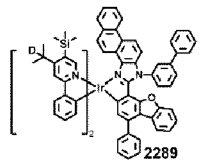
2289
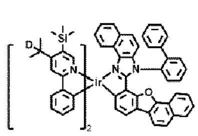
2290

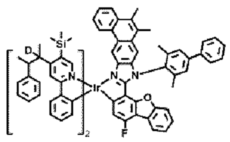
2291
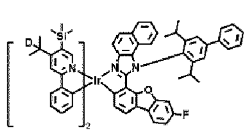
2292
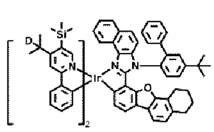
2293
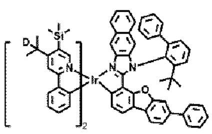
2294
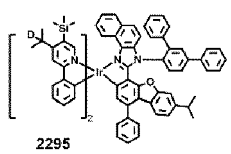
2295

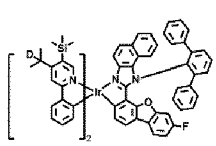
2296
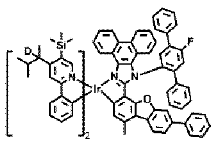
2297
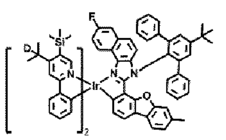
2298
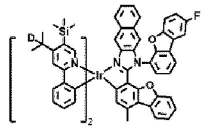
2299
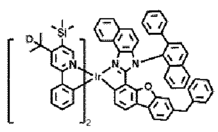
2300

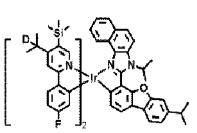
2301
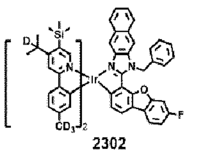
2302
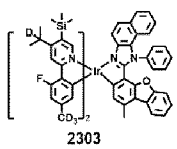
2303
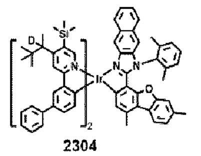
2304
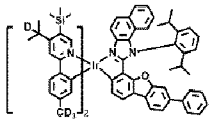
2305

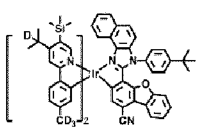
2306
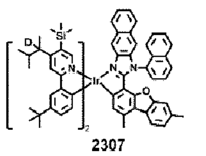
2307
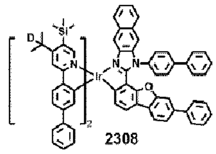
2308
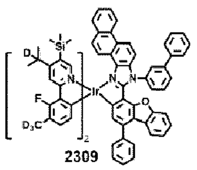
2309
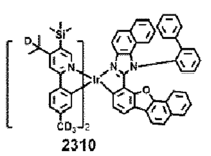
2310

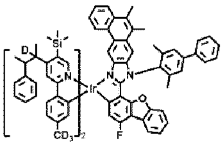
2311
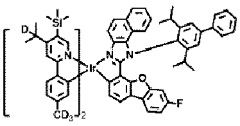
2312
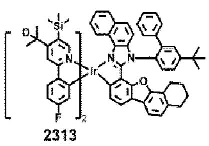
2313
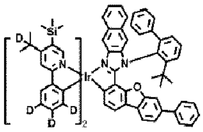
2314
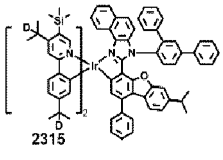
2315

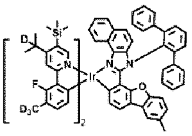
2316
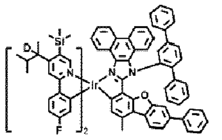
2317
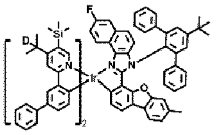
2318
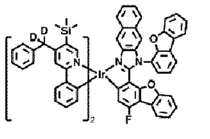
2319
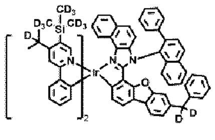
2320

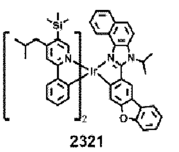
2321
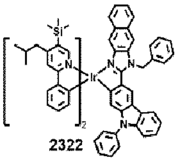
2322
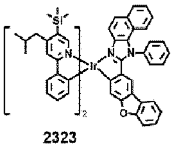
2323
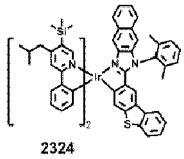
2324
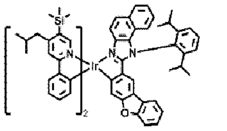
2325

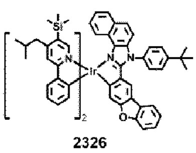
2326
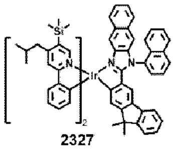
2327
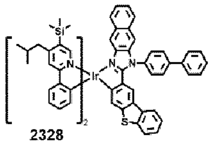
2328
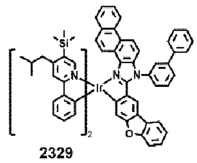
2329
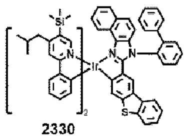
2330

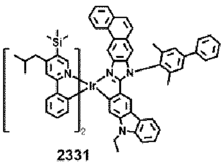
2331
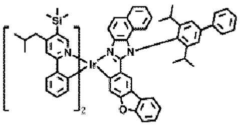
2332
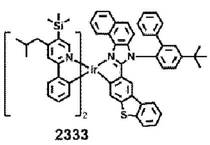
2333
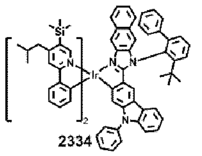
2334
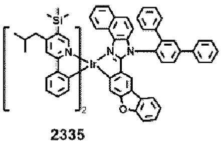
2335

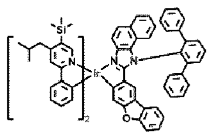
2336
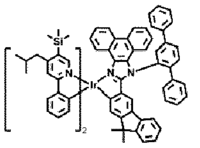
2337
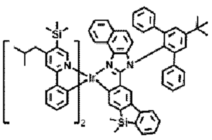
2338
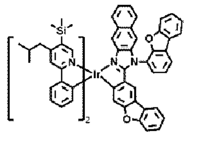
2339
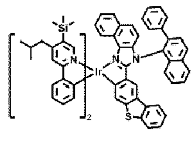
2340

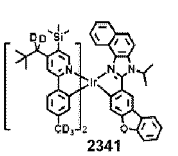
2341
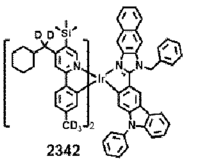
2342
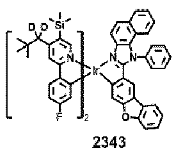
2343
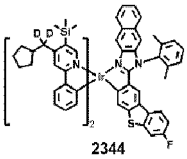
2344
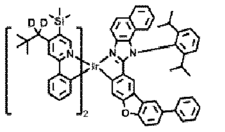
2345

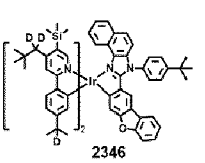
2346
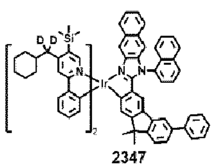
2347
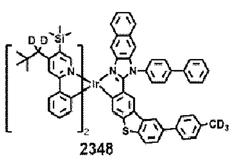
2348
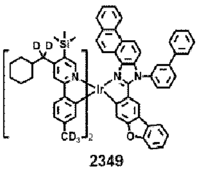
2349
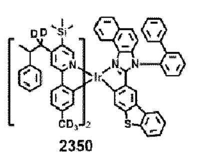
2350

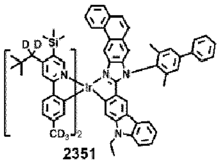
2351
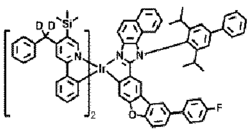
2352
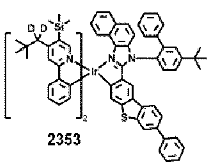
2353
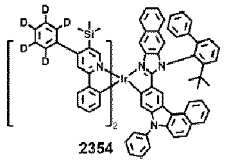
2354
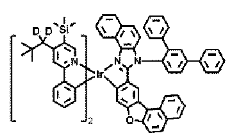
2355

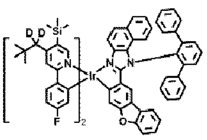
2356
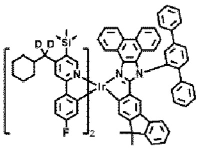
2357
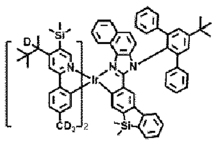
2358
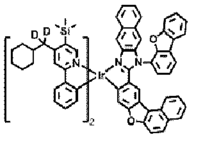
2359
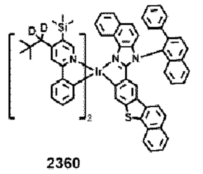
2360

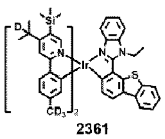
2361
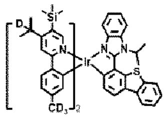
2362
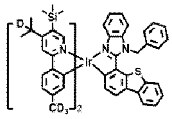
2363
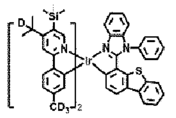
2364
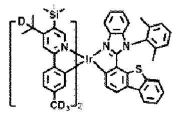
2365

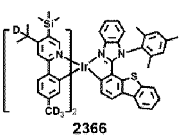
2366
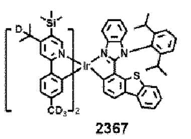
2367
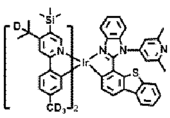
2368
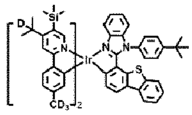
2369
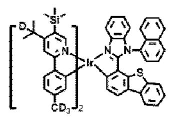
2370

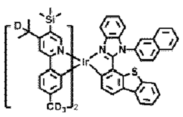
2371
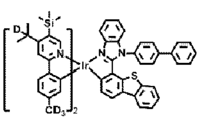
2372
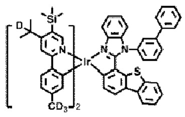
2373
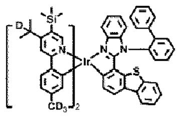
2374
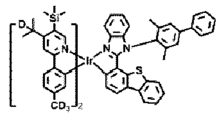
2375

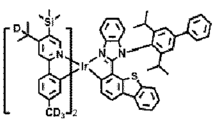
2376
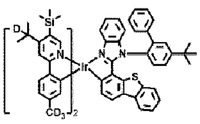
2377
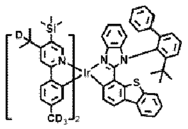
2378
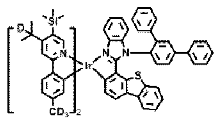
2379
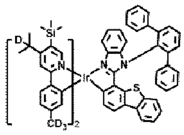
2380

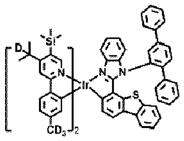
2381
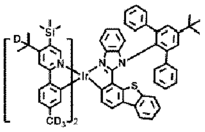
2382
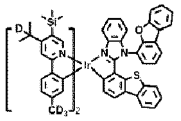
2383
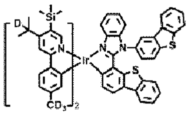
2384
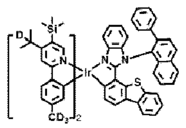
2385

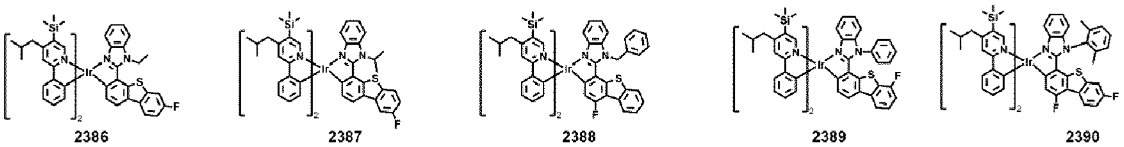
2386
2387
2388
2389
2390

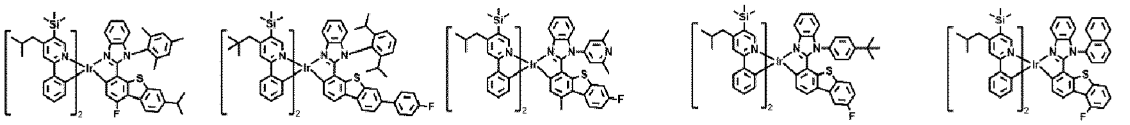
2391
2392
2393
2394
2395

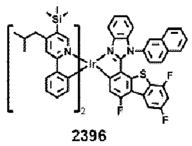
2396
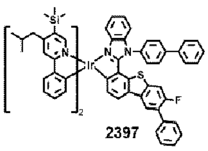
2397
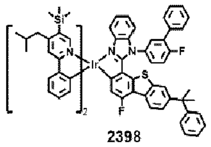
2398
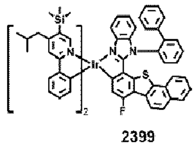
2399
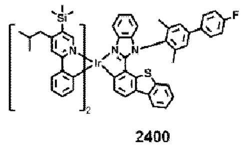
2400

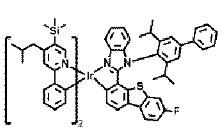
2401
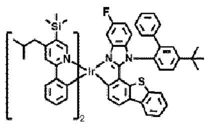
2402
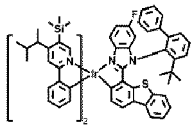
2403
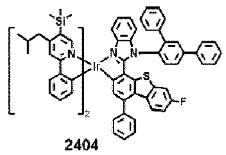
2404
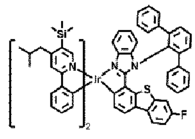
2405

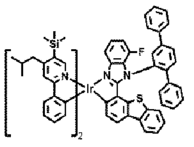
2406
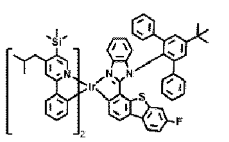
2407
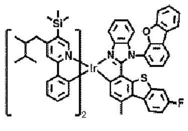
2408
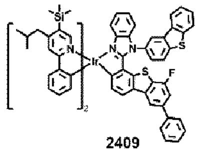
2409
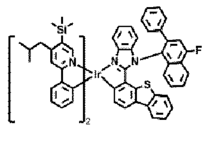
2410

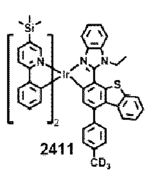
2411
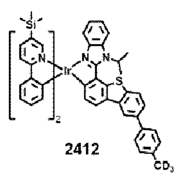
2412
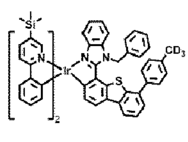
2413
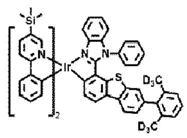
2414
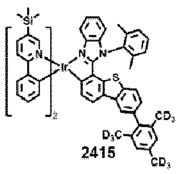
2415

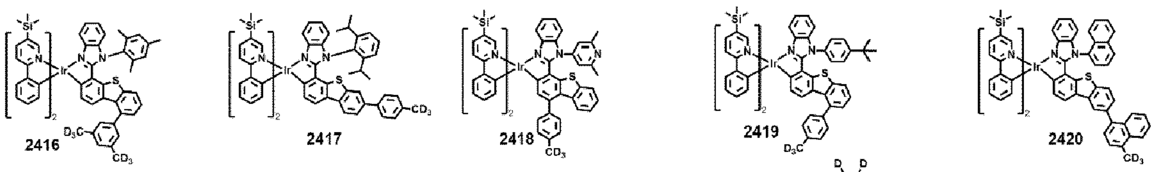
2416 2417 2418 2419 2420

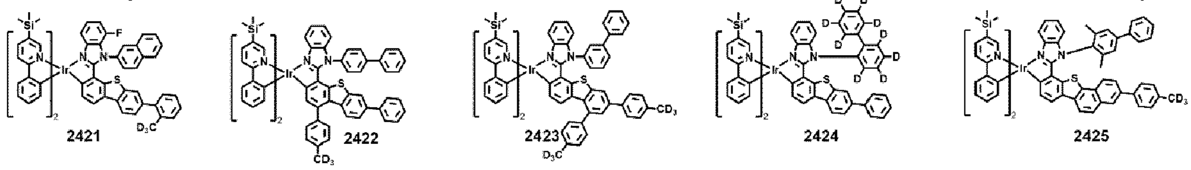
2421 2422 2423 2424 2425

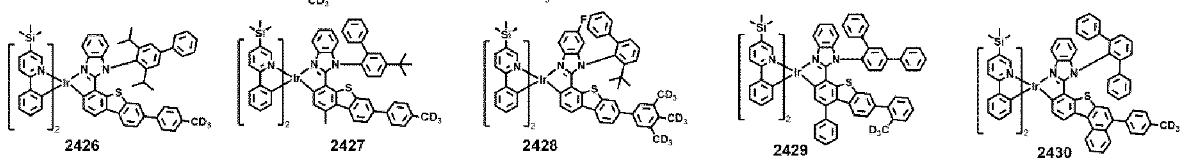
2426 2427 2428 2429 2430

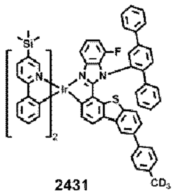
2431
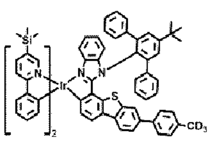
2432
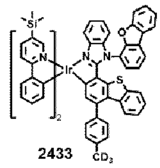
2433
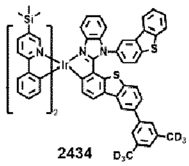
2434
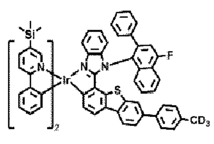
2435

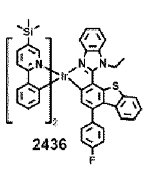
2436
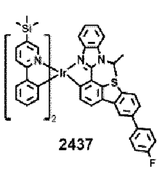
2437
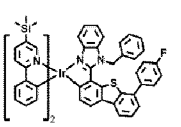
2438
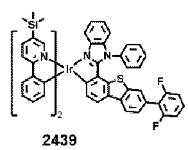
2439
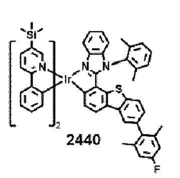
2440

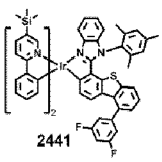
2441
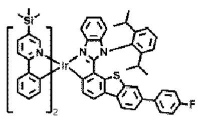
2442
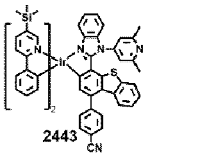
2443
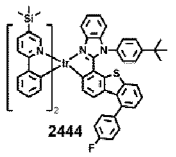
2444
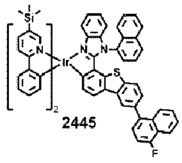
2445
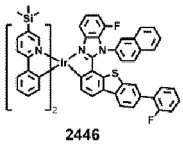
2446
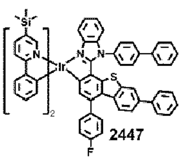
2447
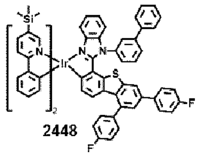
2448
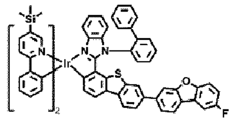
2449
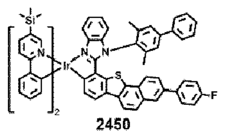
2450
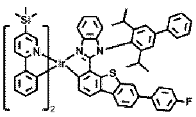
2451
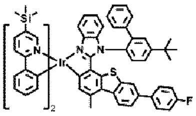
2452
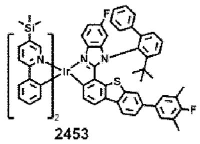
2453
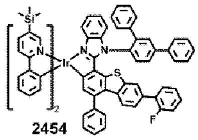
2454
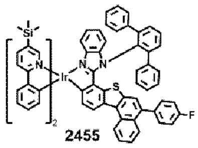
2455
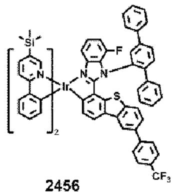
2456
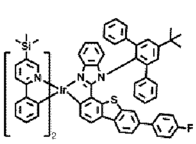
2457
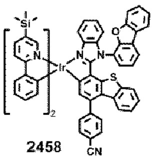
2458
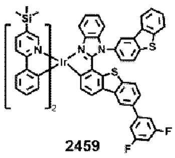
2459
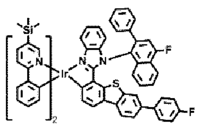
2460
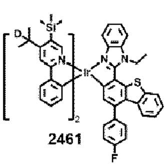
2461
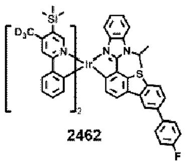
2462
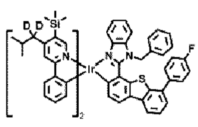
2463
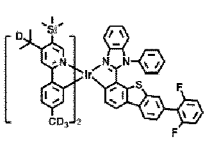
2464
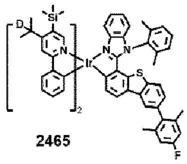
2465
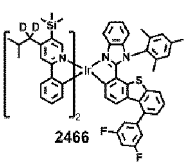
2466
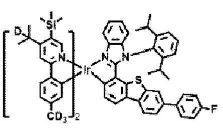
2467
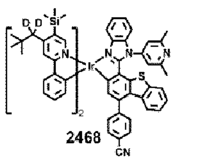
2468
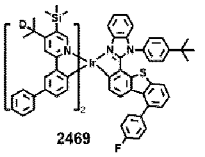
2469
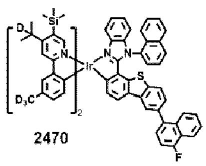
2470
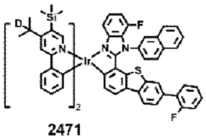
2471
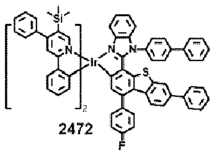
2472
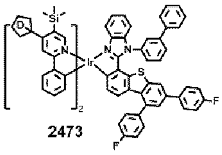
2473
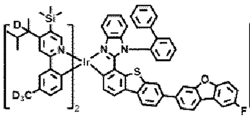
2474
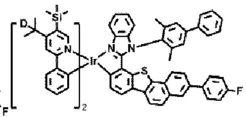
2475
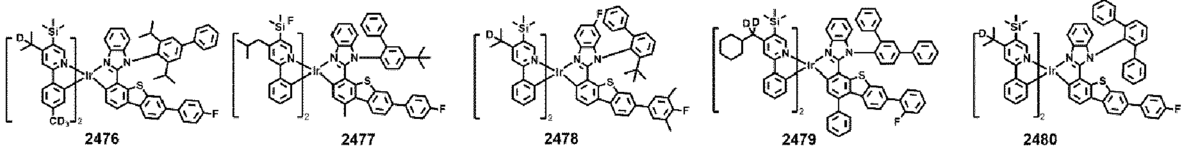
2476
2477
2478
2479
2480
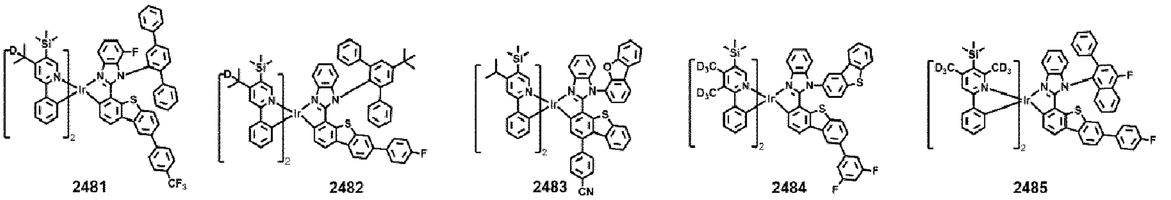
2481
2482
2483
2484
2485

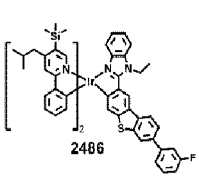
2486

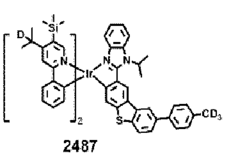
2487

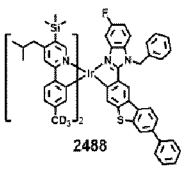
2488

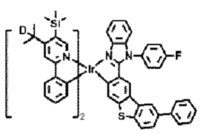
2489

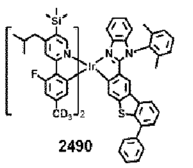
2490

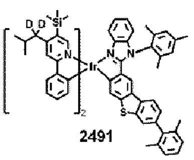
2491

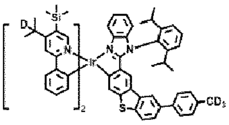
2492

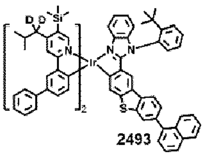
2493

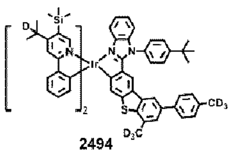
2494

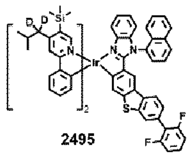
2495

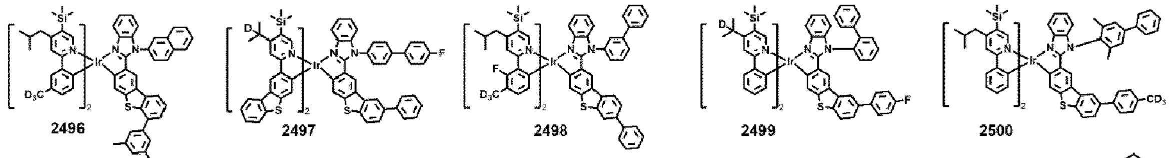
2496 2497 2498 2499 2500

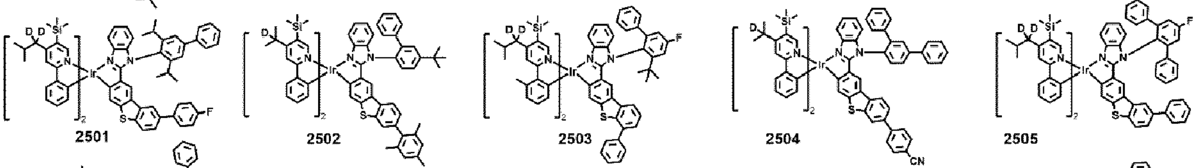
2501 2502 2503 2504 2505

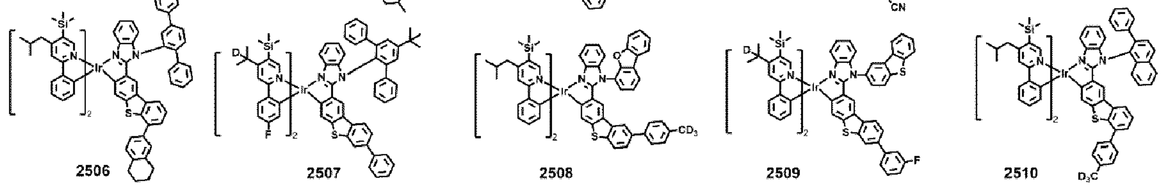
2506 2507 2508 2509 2510

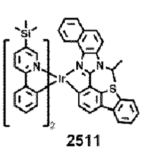
2511

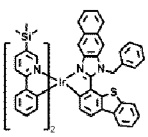
2512

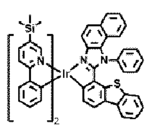
2513

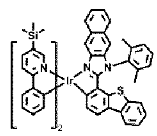
2514

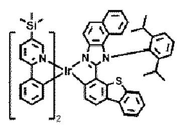
2515

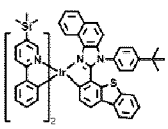
2516

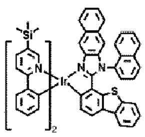
2517

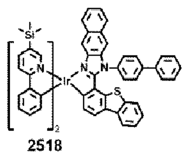
2518

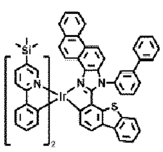
2519

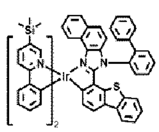
2520

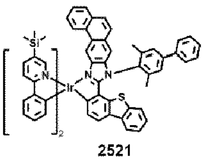
2521

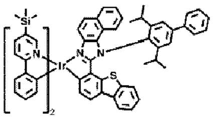
2522

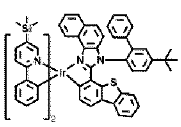
2523

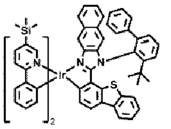
2524

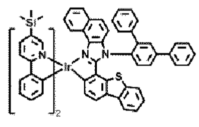
2525

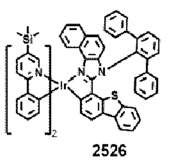
2526

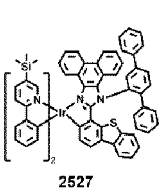
2527

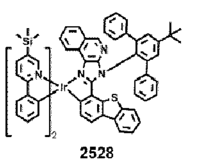
2528

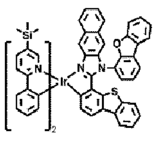
2529

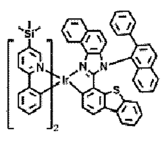
2530

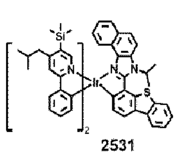
2531

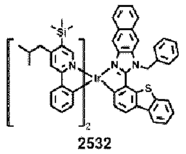
2532

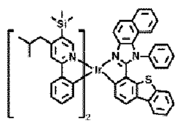
2533

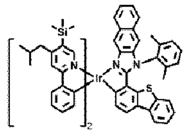
2534

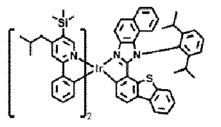
2535

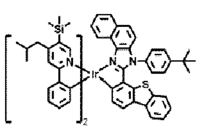
2536

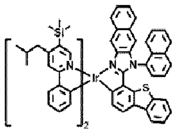
2537

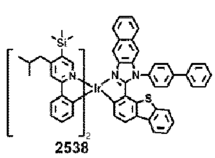
2538

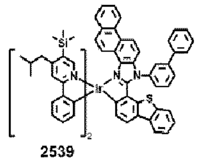
2539

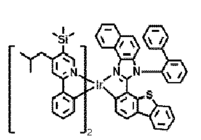
2540

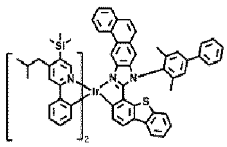
2541

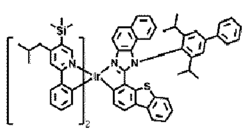
2542

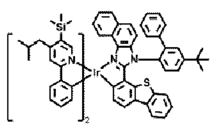
2543

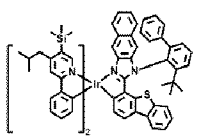
2544

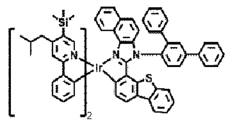
2545

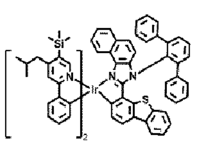
2546

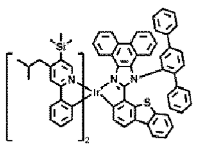
2547

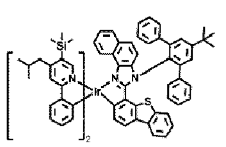
2548

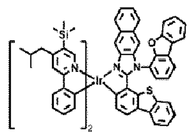
2549

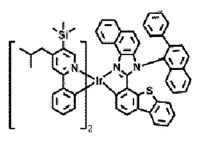
2550

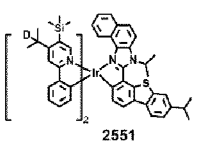
2551

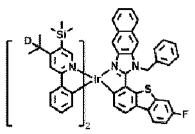
2552

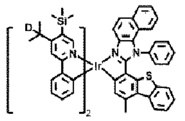
2553

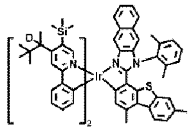
2554

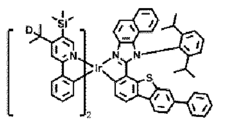
2555

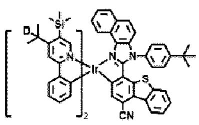
2556

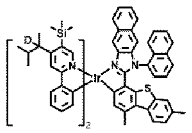
2557

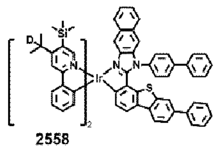
2558

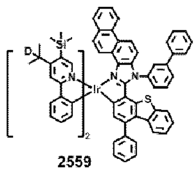
2559

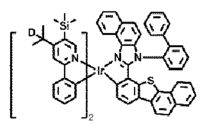
2560

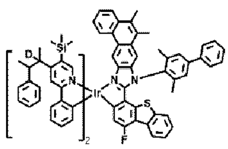
2561

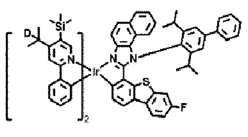
2562

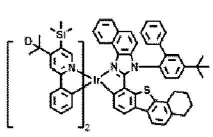
2563

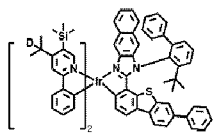
2564

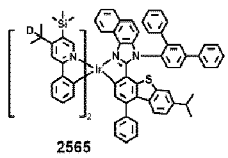
2565

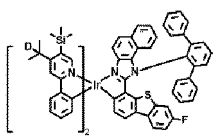
2566

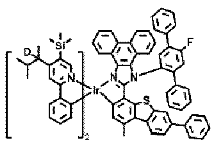
2567

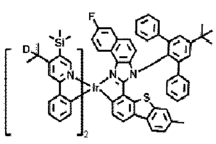
2568

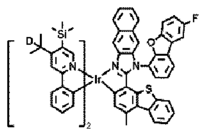
2569

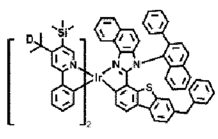
2570

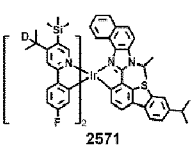
2571
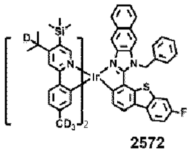
2572
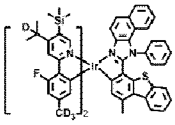
2573
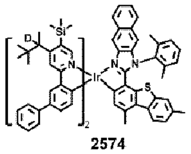
2574
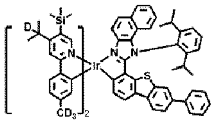
2575

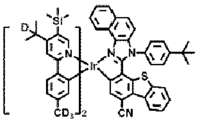
2576
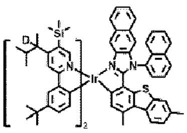
2577
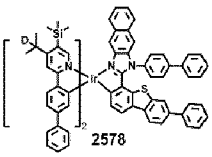
2578
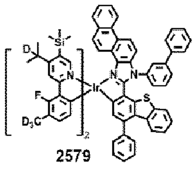
2579
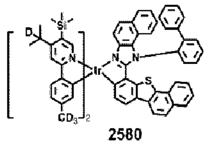
2580

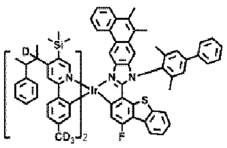
2581
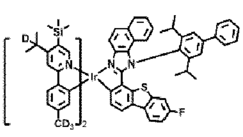
2582
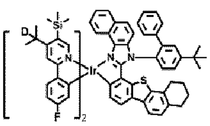
2583
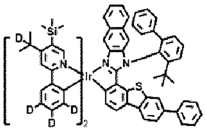
2584
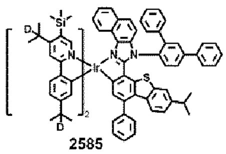
2585

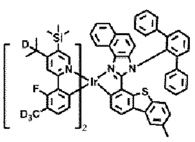
2586
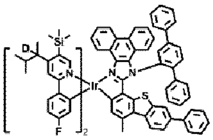
2587
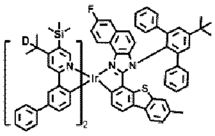
2588
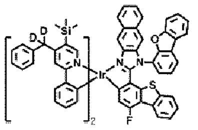
2589
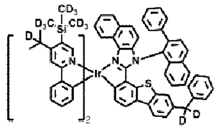
2590

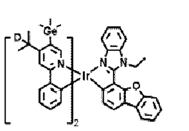
2591
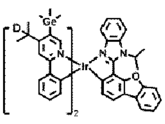
2592
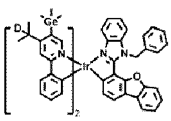
2593
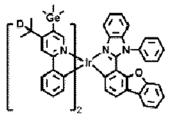
2594
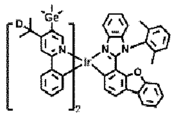
2595

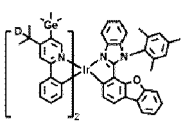
2596
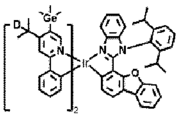
2597
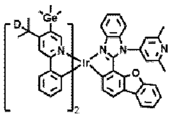
2598
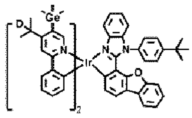
2599
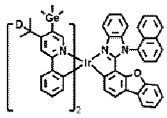
2600

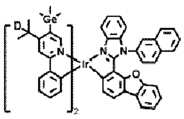
2601
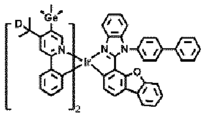
2602
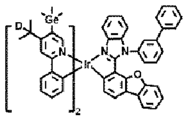
2603
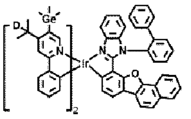
2604
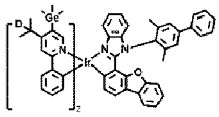
2605

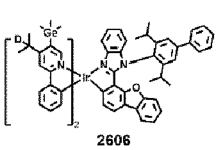
2606
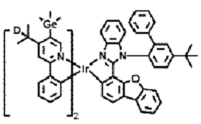
2607
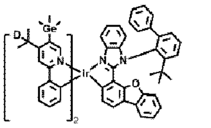
2608
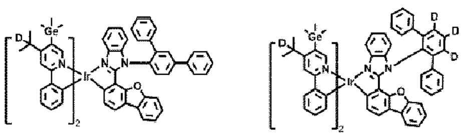
2609
2610

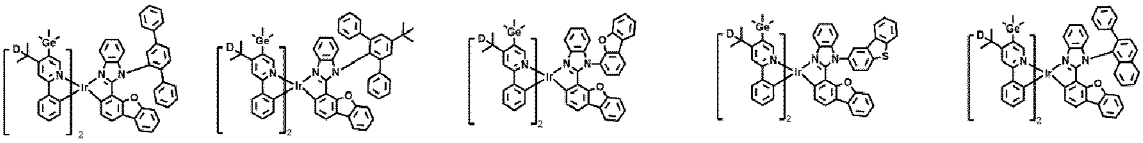
2611
2612
2613
2614
2615

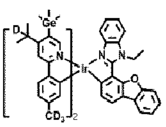
2616

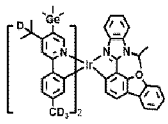
2617

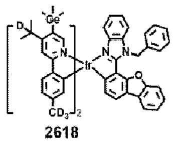
2618

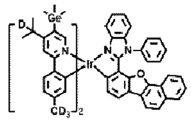
2619

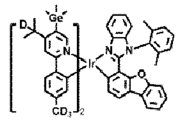
2620

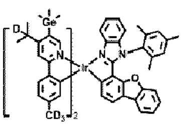
2621

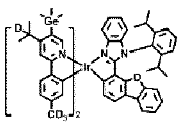
2622

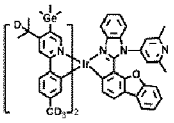
2623

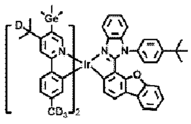
2624

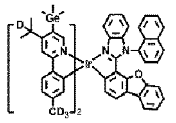
2625

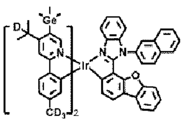
2626

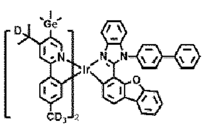
2627

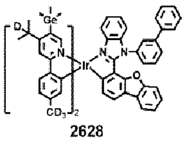
2628

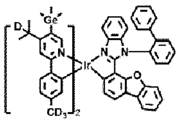
2629

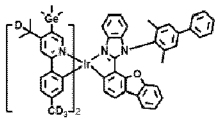
2630

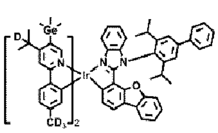
2631

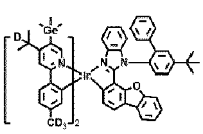
2632

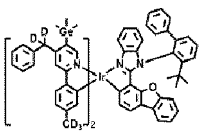
2633

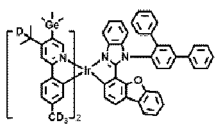
2634

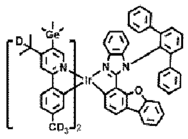
2635

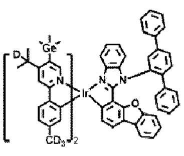
2636

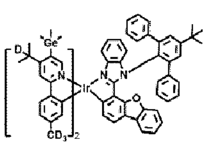
2637

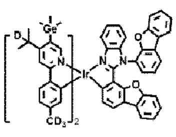
2638

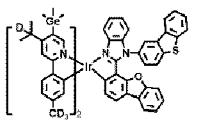
2639

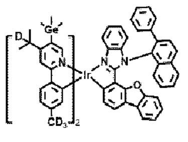
2640

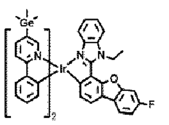
2641

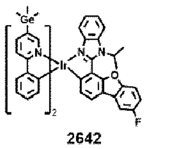
2642

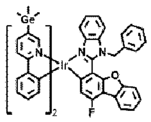
2643

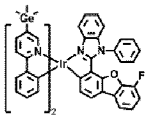
2644

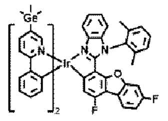
2645

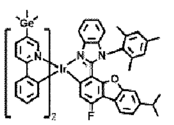
2646

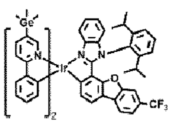
2647

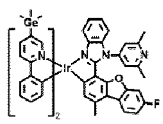
2648

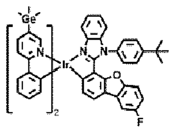
2649

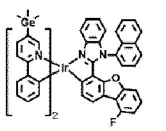
2650

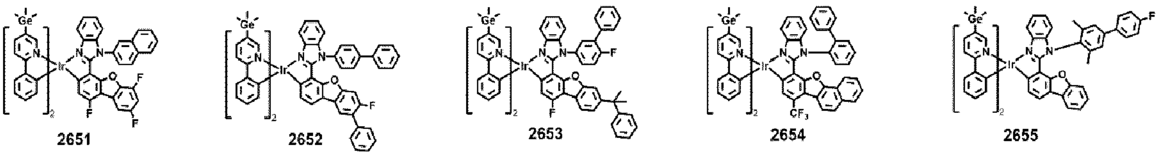
2651

2652

2653

2654

2655

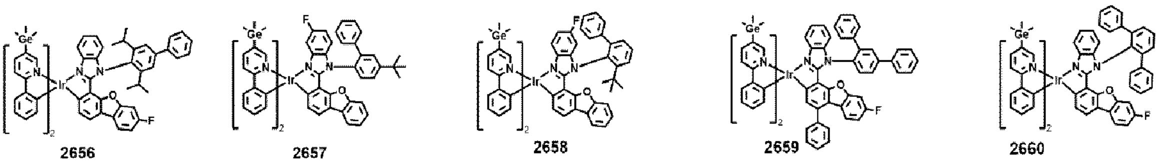
2656

2657

2658

2659

2660

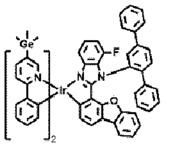
2661

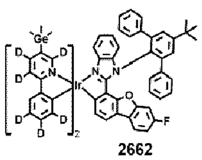
2662

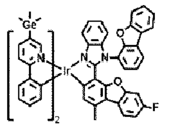
2663

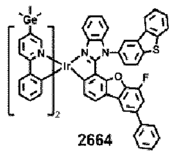
2664

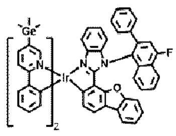
2665

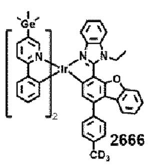
2666

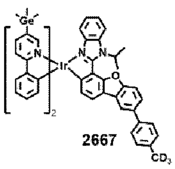
2667

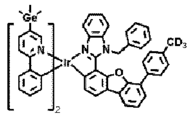
2668

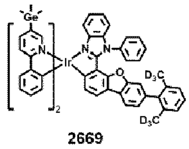
2669

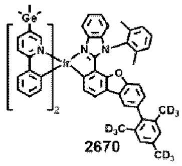
2670

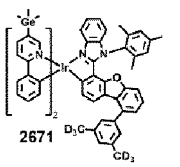
2671

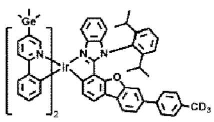
2672

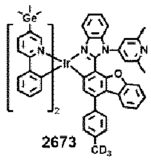
2673

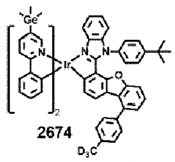
2674

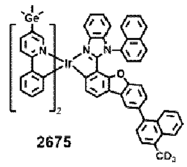
2675

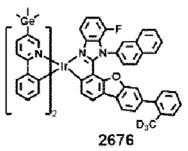
2676

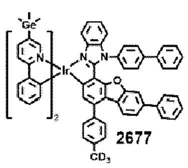
2677

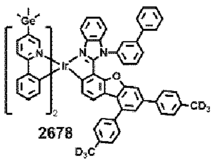
2678

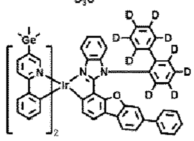
2679

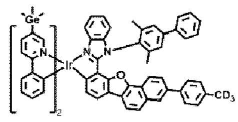
2680

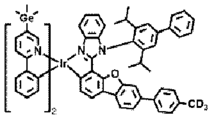
2681

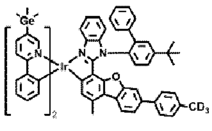
2682

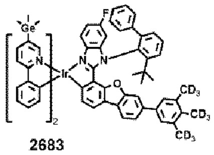
2683

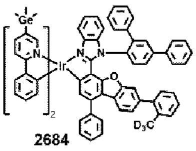
2684

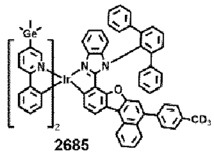
2685

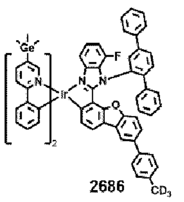
2686

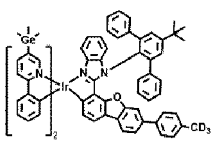
2687

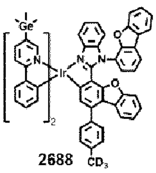
2688

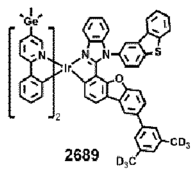
2689

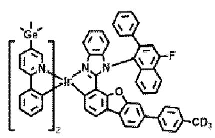
2690

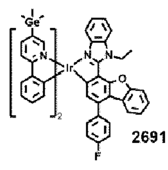
2691

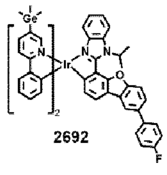
2692

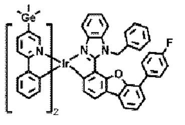
2693

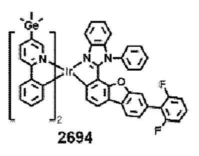
2694

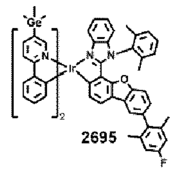
2695

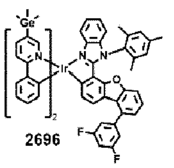
2696

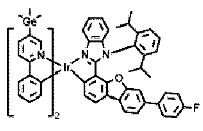
2697

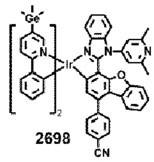
2698

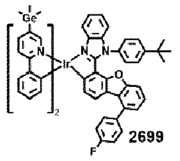
2699

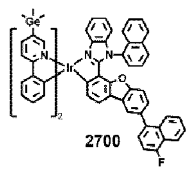
2700

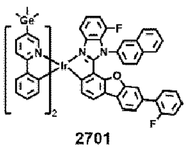
2701
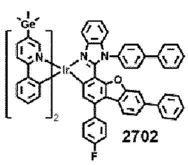
2702
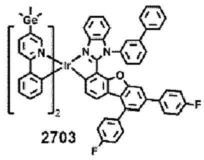
2703
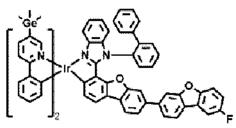
2704
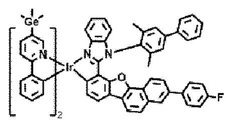
2705

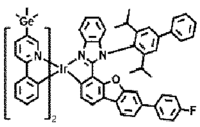
2706
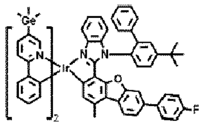
2707
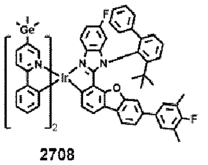
2708
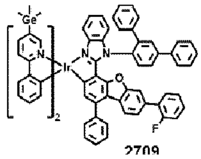
2709
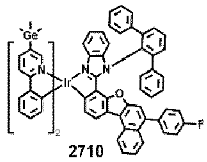
2710

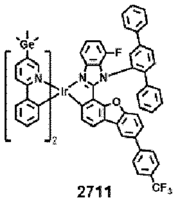
2711
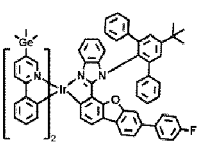
2712
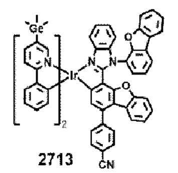
2713
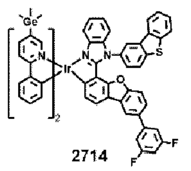
2714
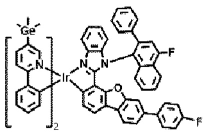
2715

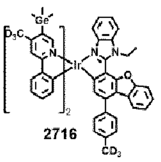
2716
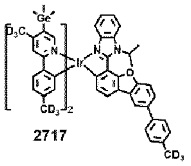
2717
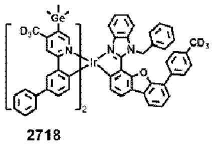
2718
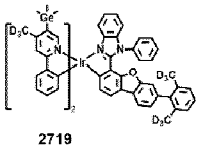
2719
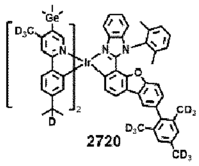
2720

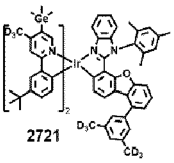
2721
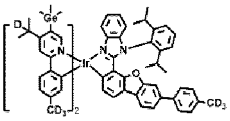
2722
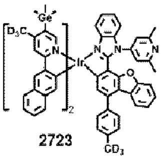
2723
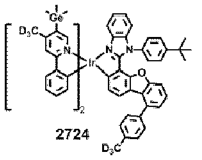
2724
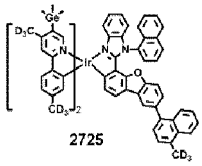
2725

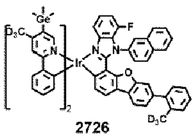
2726
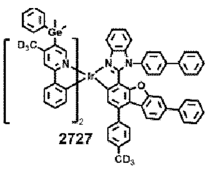
2727
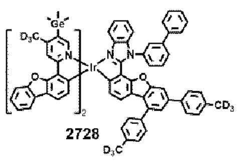
2728
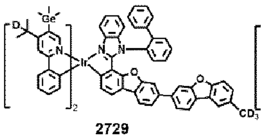
2729
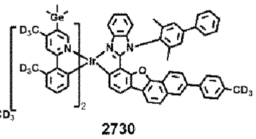
2730

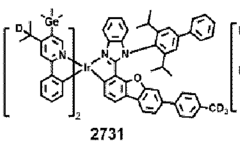
2731
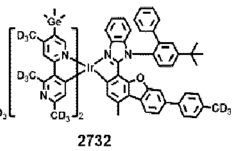
2732
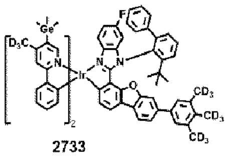
2733
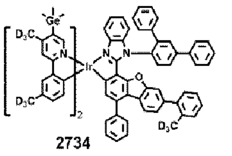
2734
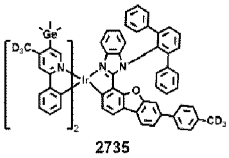
2735

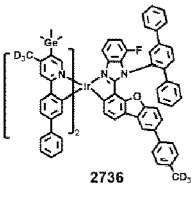
2736
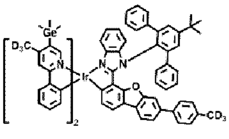
2737
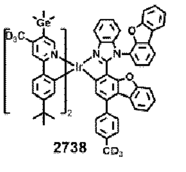
2738
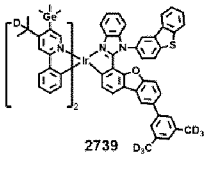
2739
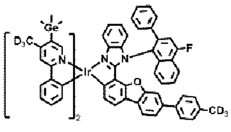
2740

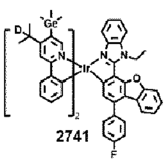
2741

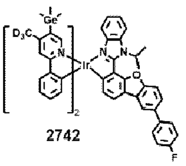
2742

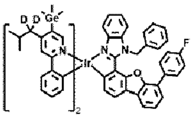
2743

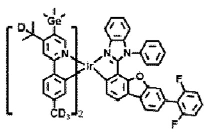
2744

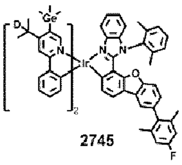
2745

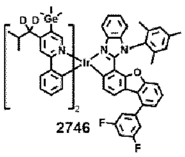
2746

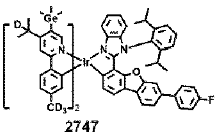
2747

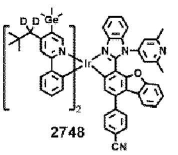
2748

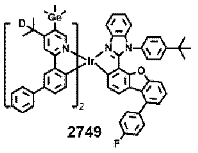
2749

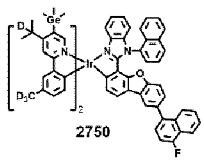
2750

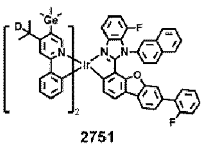
2751

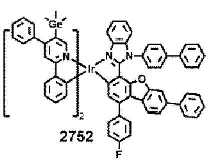
2752

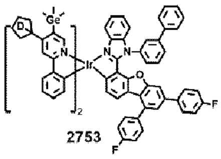
2753

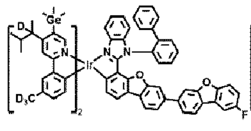
2754

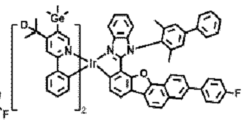
2755

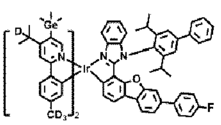
2756

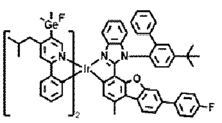
2757

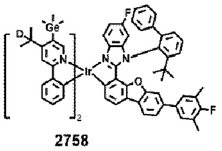
2758

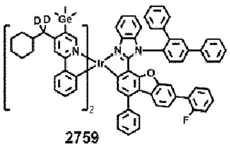
2759

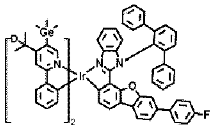
2760

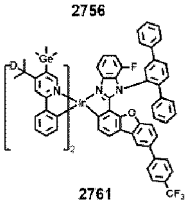
2761

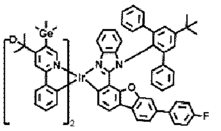
2762

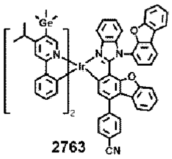
2763

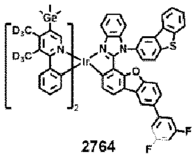
2764

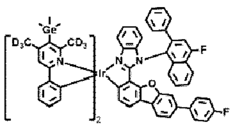
2765

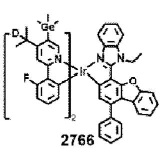
2766

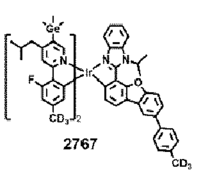
2767

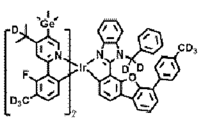
2768

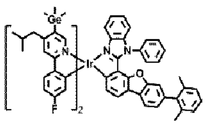
2769

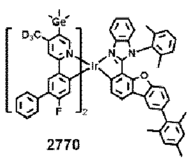
2770

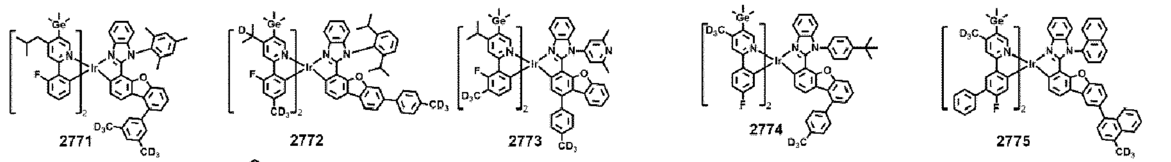

2771 2772 2773 2774 2775

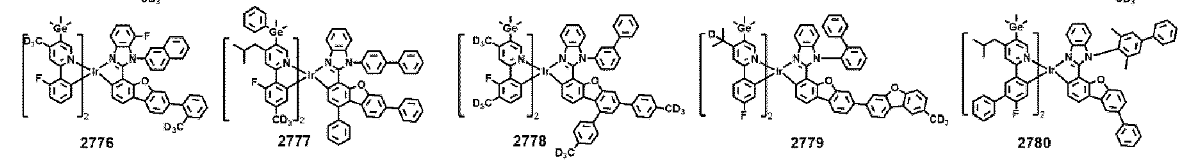

2776 2777 2778 2779 2780

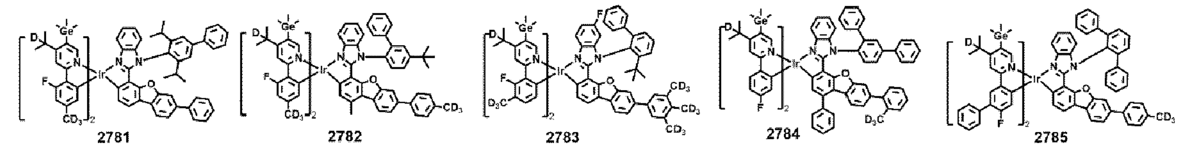

2781 2782 2783 2784 2785

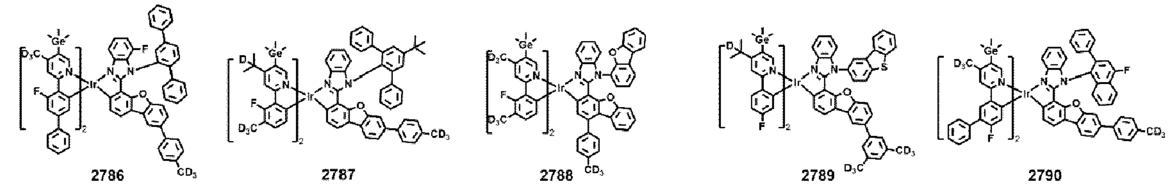

2786 2787 2788 2789 2790

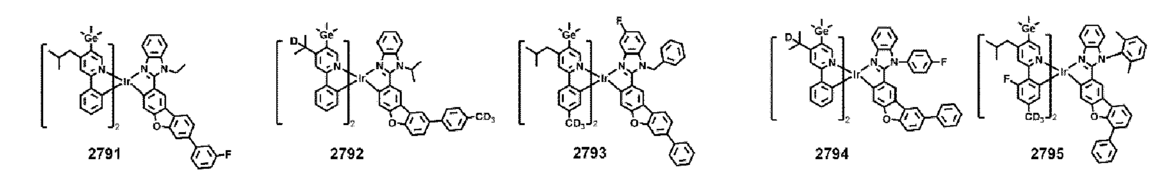

2791 2792 2793 2794 2795

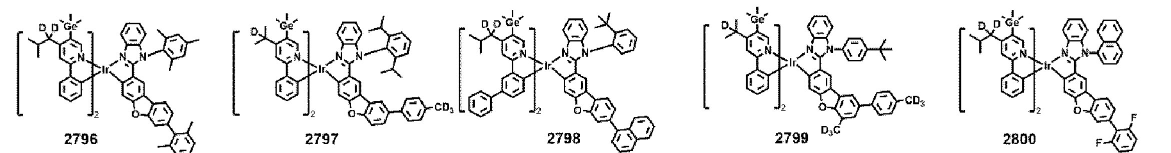

2796 2797 2798 2799 2800

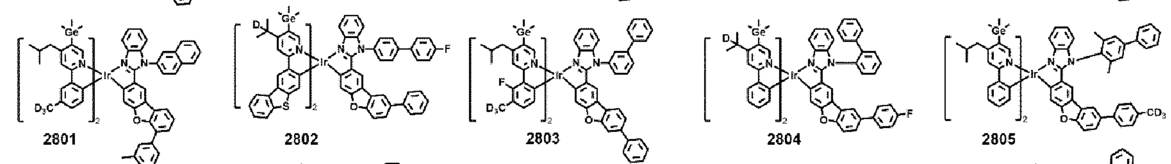

2801 2802 2803 2804 2805

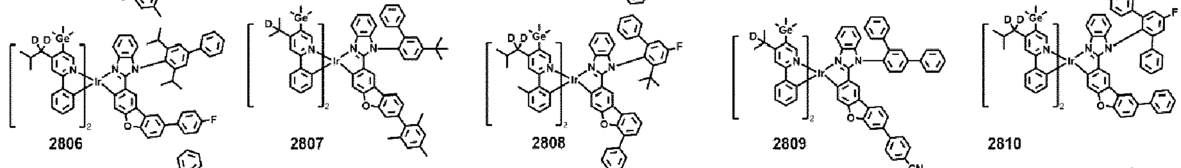

2806 2807 2808 2809 2810

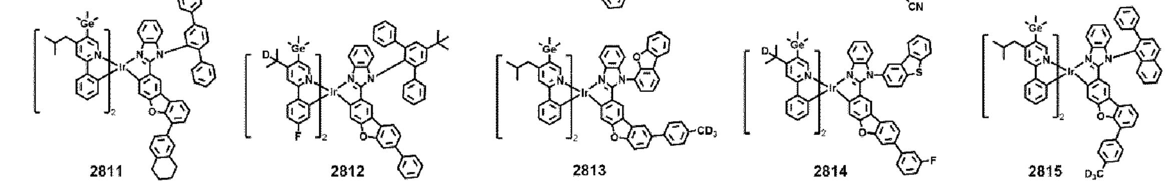

2811 2812 2813 2814 2815

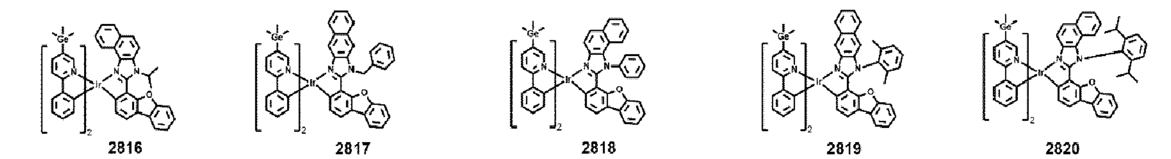

2816 2817 2818 2819 2820

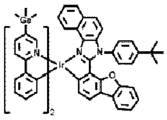
2821

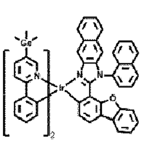
2822

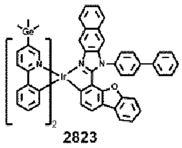
2823

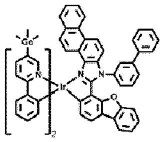
2824

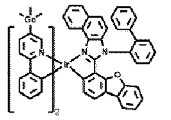
2825

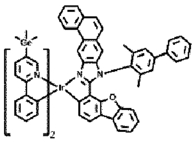
2826

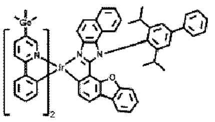
2827

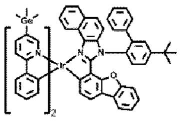
2828

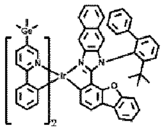
2829

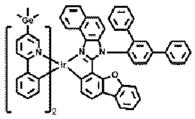
2830

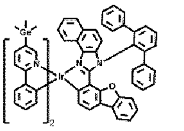
2831

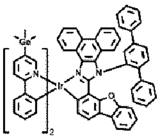
2832

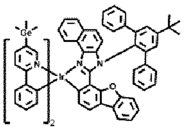
2833

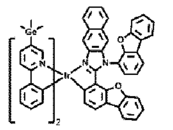
2834

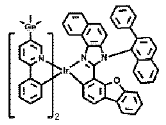
2835

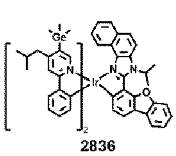
2836

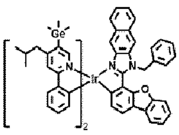
2837

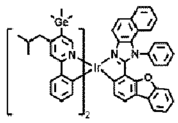
2838

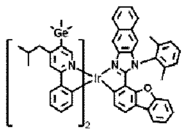
2839

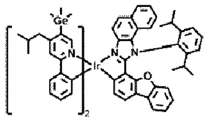
2840

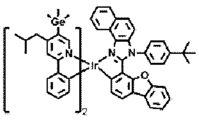
2841

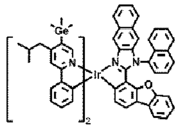
2842

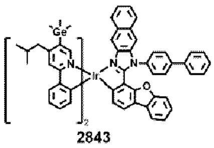
2843

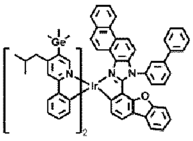
2844

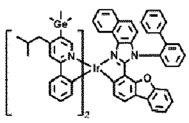
2845

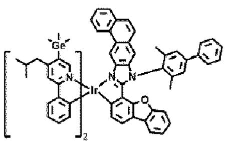
2846

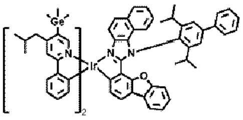
2847

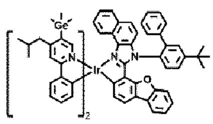
2848

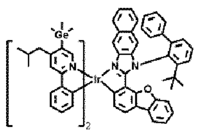
2849

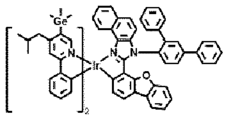
2850

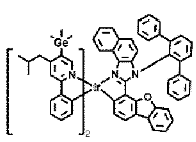
2851

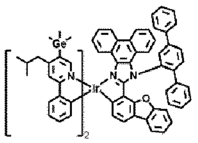
2852

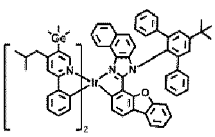
2853

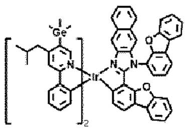
2854

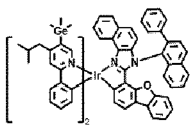
2855

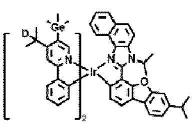
2856

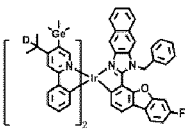
2857

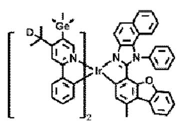
2858

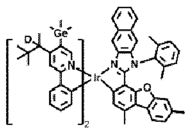
2859

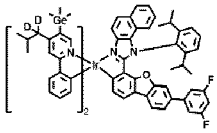
2860

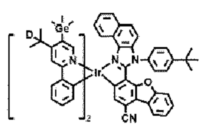
2861
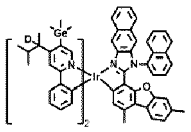
2862
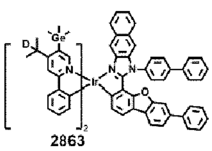
2863
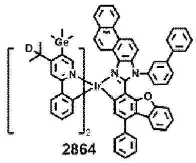
2864
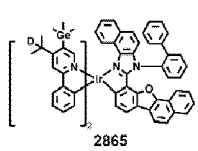
2865

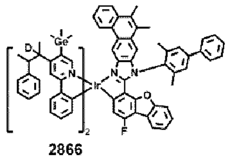
2866
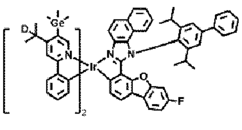
2867
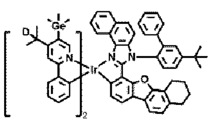
2868
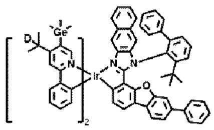
2869
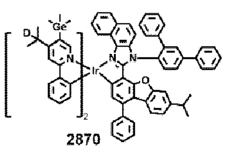
2870

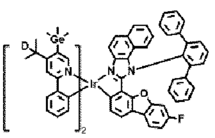
2871
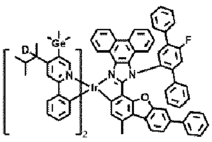
2872
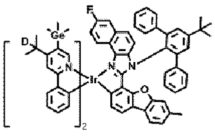
2873
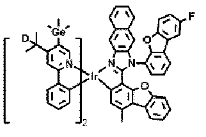
2874
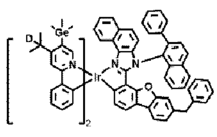
2875

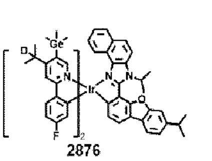
2876
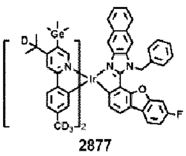
2877
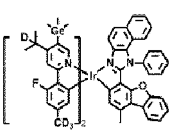
2878
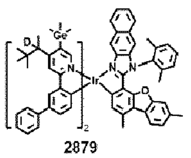
2879
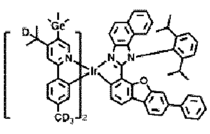
2880

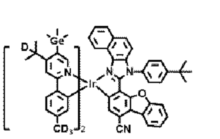
2881
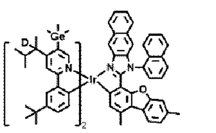
2882
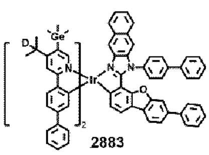
2883
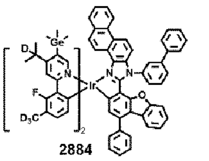
2884
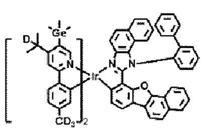
2885

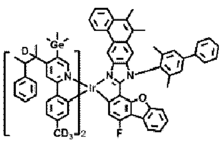
2886
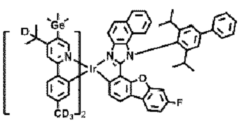
2887
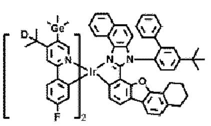
2888
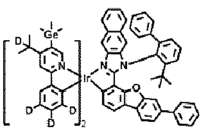
2889
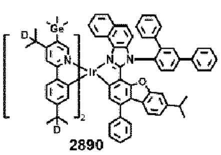
2890

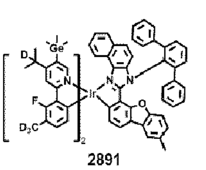
2891
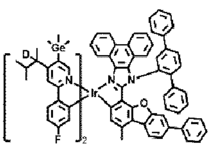
2892
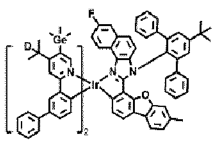
2893
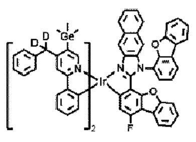
2894
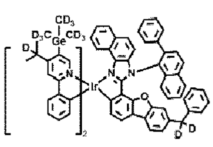
2895

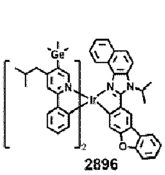
2896
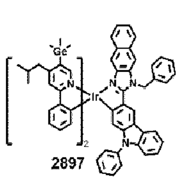
2897
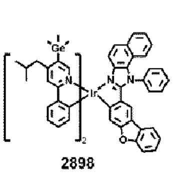
2898
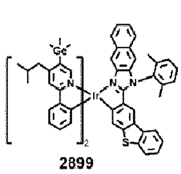
2899
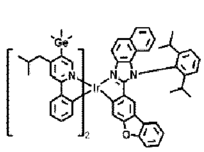
2900

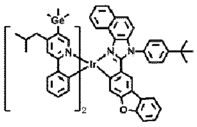
2901
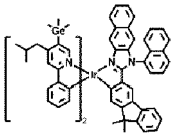
2902
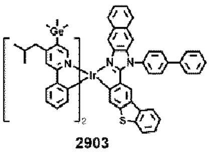
2903
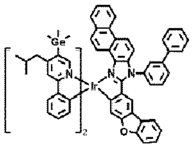
2904
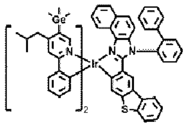
2905

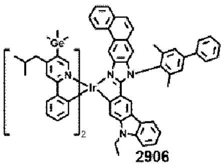
2906
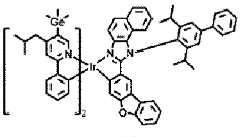
2907
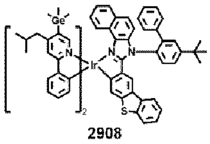
2908
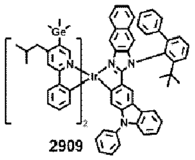
2909
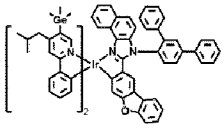
2910

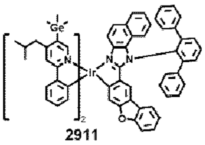
2911
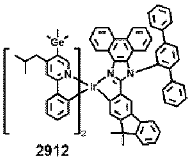
2912
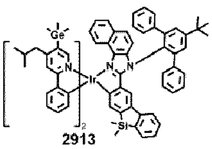
2913
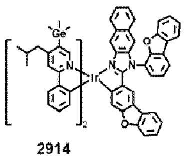
2914
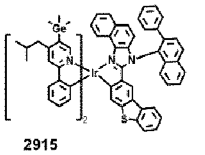
2915

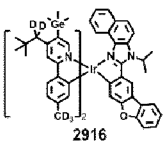
2916
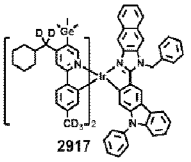
2917
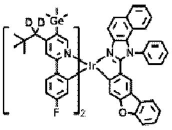
2918
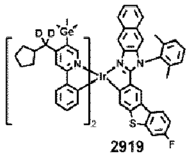
2919
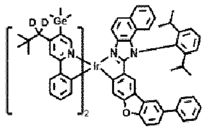
2920

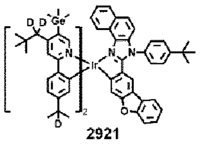
2921
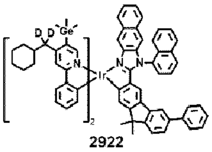
2922
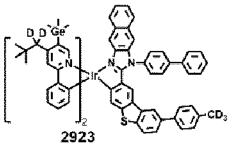
2923
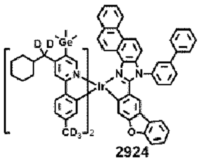
2924
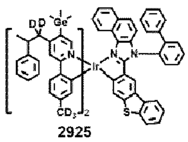
2925

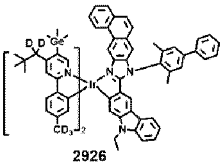
2926
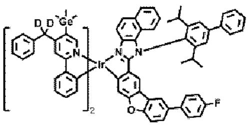
2927
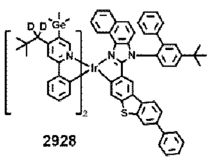
2928
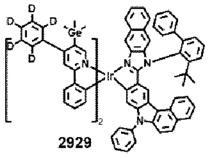
2929
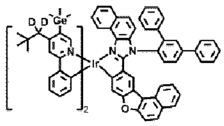
2930

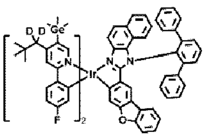
2931
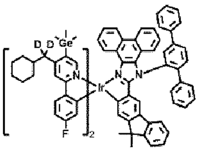
2932
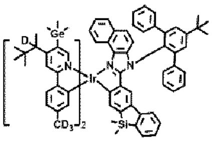
2933
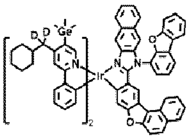
2934
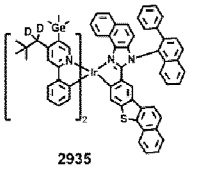
2935

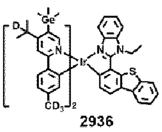
2936
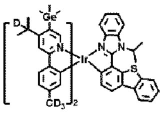
2937
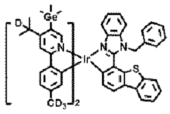
2938
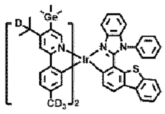
2939
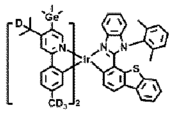
2940

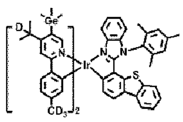
2941

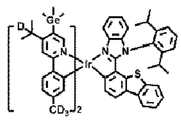
2942

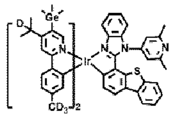
2943

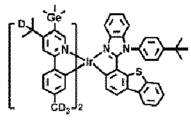
2944

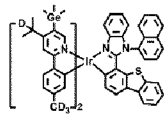
2945

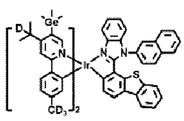
2946

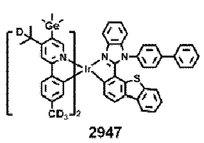
2947

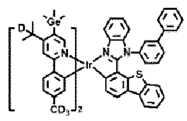
2948

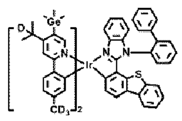
2949

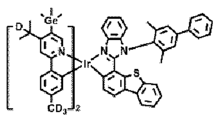
2950

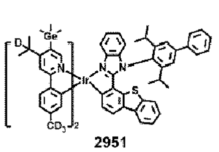
2951

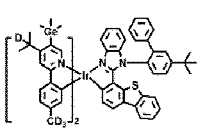
2952

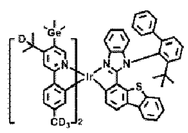
2953

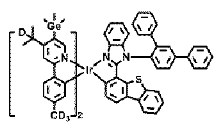
2954

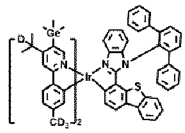
2955

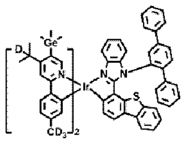
2956

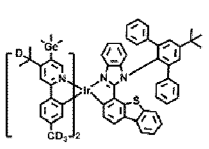
2957

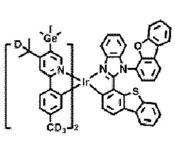
2958

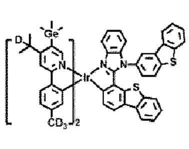
2959

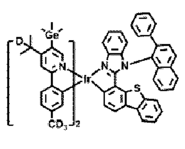
2960

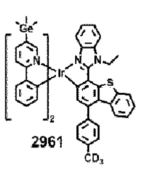
2961

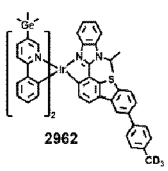
2962

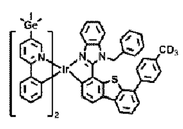
2963

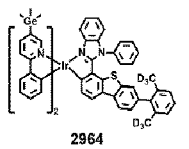
2964

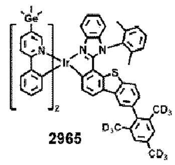
2965

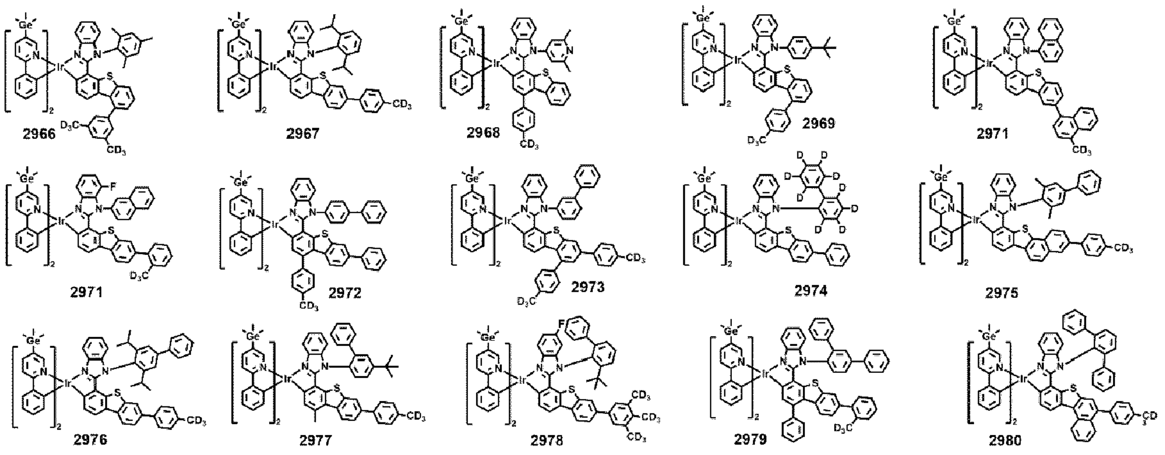
2966 2967 2968 2969 2971

2971 2972 2973 2974 2975

2976 2977 2978 2979 2980

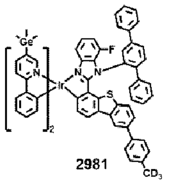
2981

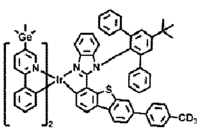
2982

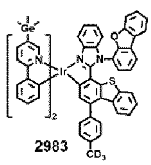
2983

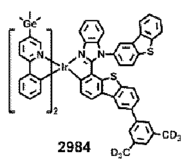
2984

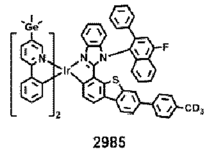
2985

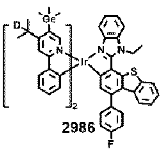
2986

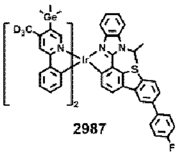
2987

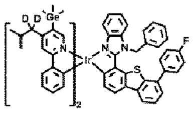
2988

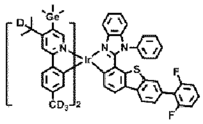
2989

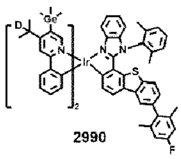
2990

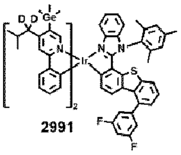
2991

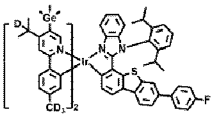
2992

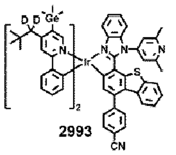
2993

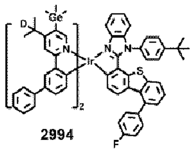
2994

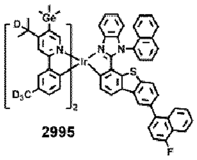
2995

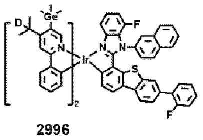
2996

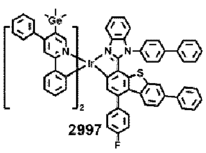
2997

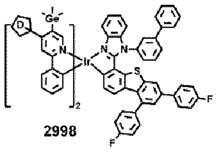
2998

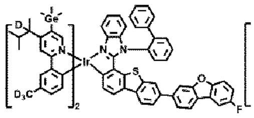
2999

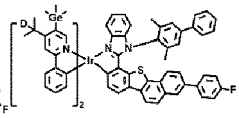
3000

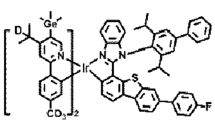
3001

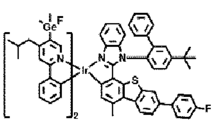
3002

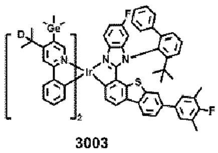
3003

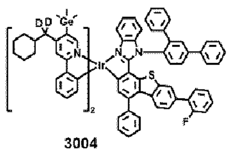
3004

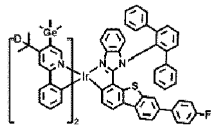
3005

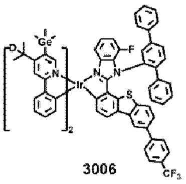
3006

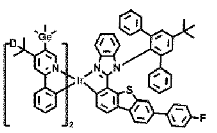
3007

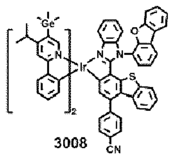
3008

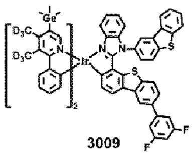
3009

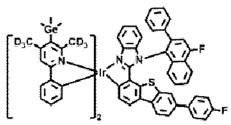
3010

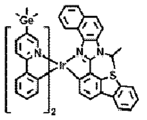
3011

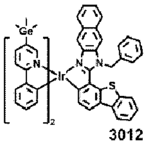
3012

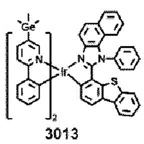
3013

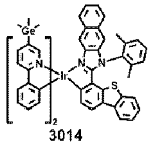
3014

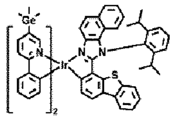
3015

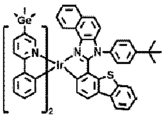
3016

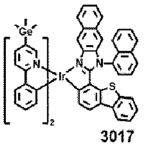
3017

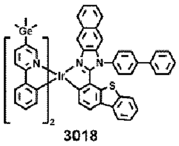
3018

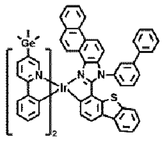
3019

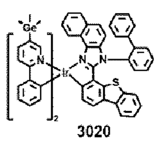
3020

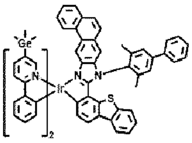
3021

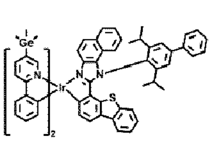
3022

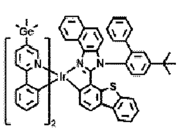
3023

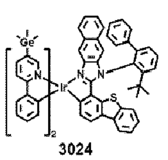
3024

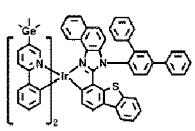
3025

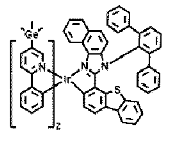
3026

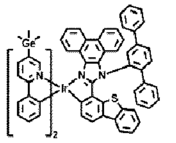
3027

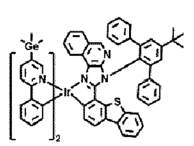
3028

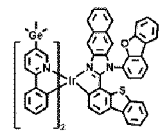
3029

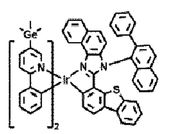
3030

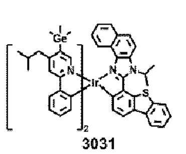
3031

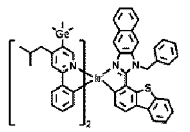
3032

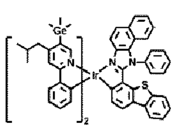
3033

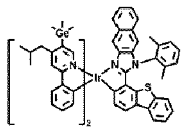
3034

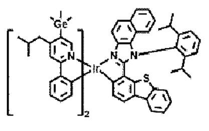
3035

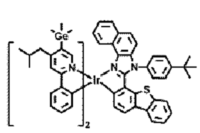
3036

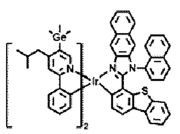
3037

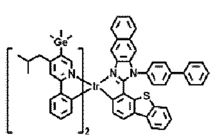
3038

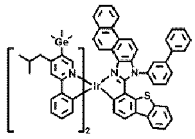
3039

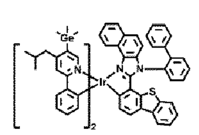
3040

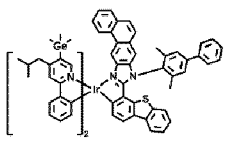
3041

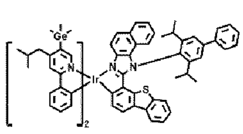
3042

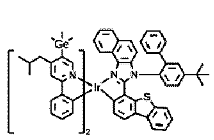
3043

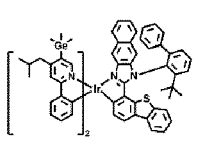
3044

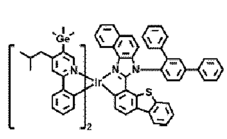
3045

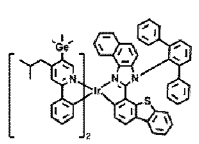
3046

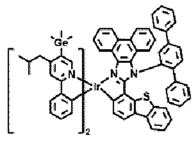
3047

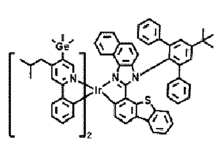
3048

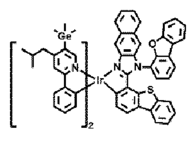
3049

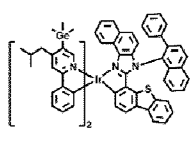
3050

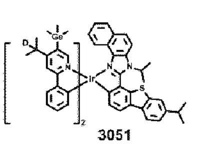
3051

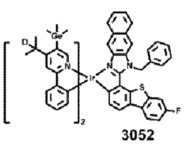
3052

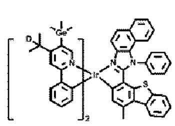
3053

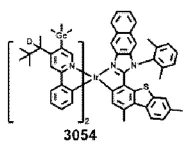
3054

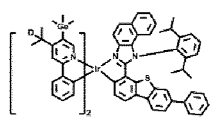
3055

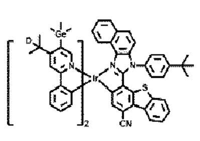
3056

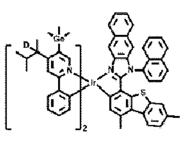
3057

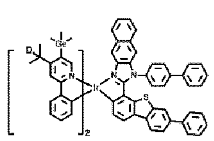
3058

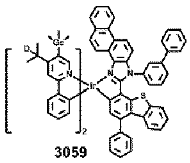
3059

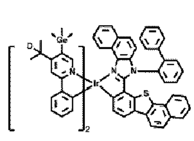
3060

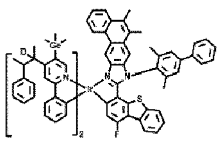
3061

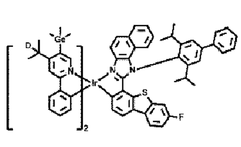
3062

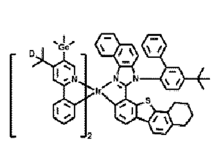
3063

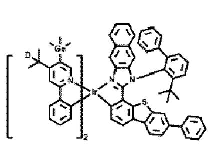
3064

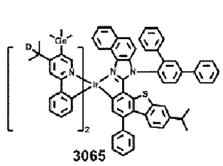
3065

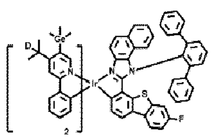
3066

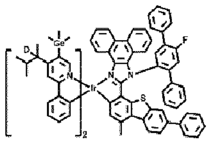
3067

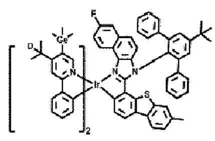
3068

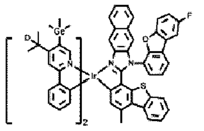
3069

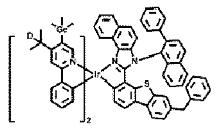
3070

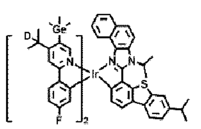
3071

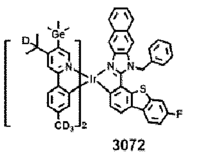
3072

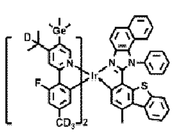
3073

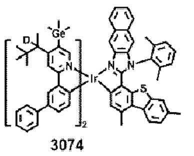
3074

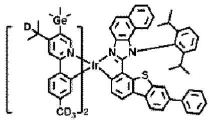
3075

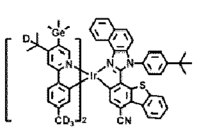
3076

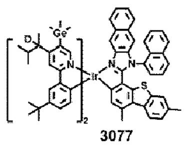
3077

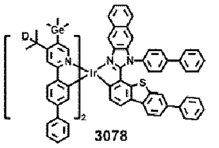
3078

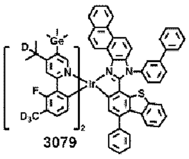
3079

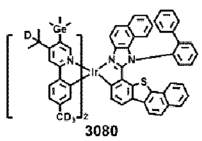
3080

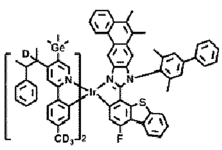
3081

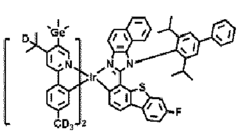
3082

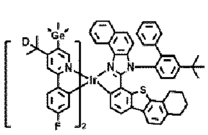
3083

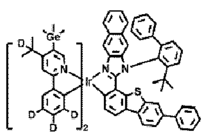
3084

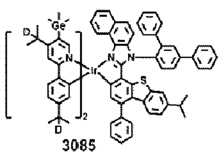
3085

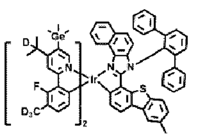
3086

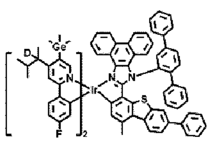
3087

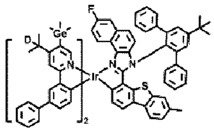
3088

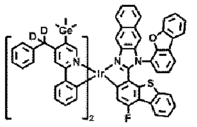
3089

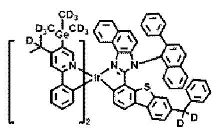
3090

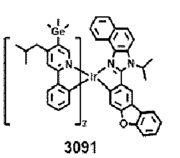
3091

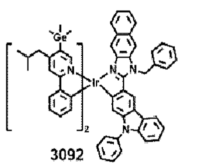
3092

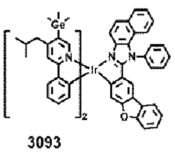
3093

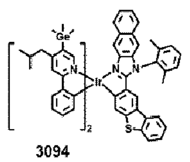
3094

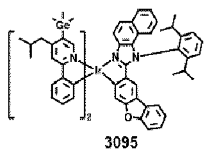
3095

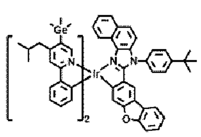
3096

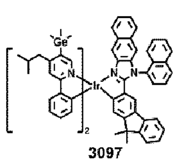
3097

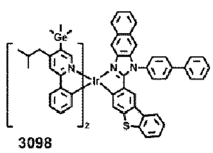
3098

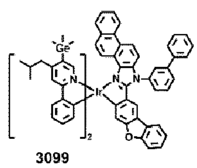
3099

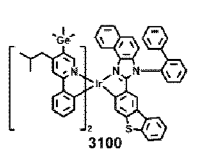
3100

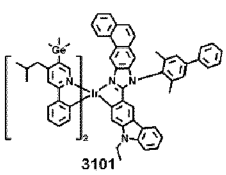
3101

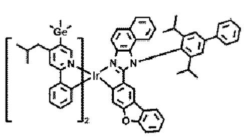
3102

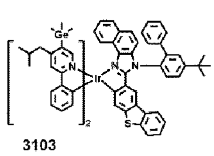
3103

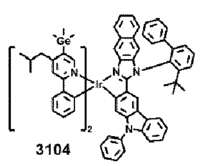
3104

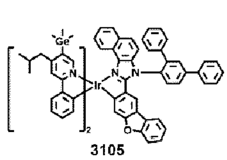
3105

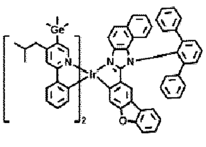
3106

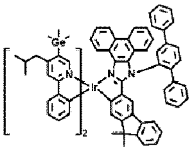
3107

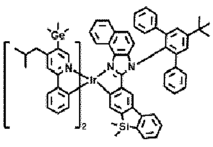
3108

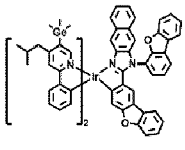
3109

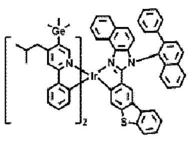
3110

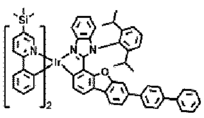
3111

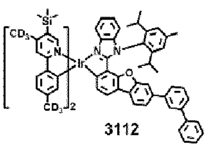
3112

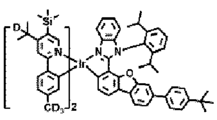
3113

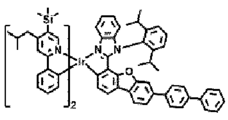
3114

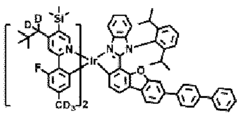
3115

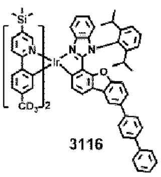
3116

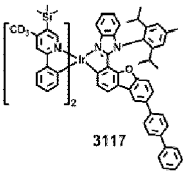
3117

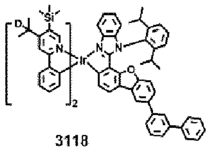
3118

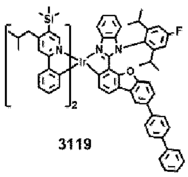
3119

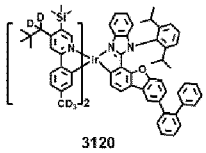
3120

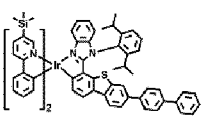
3121

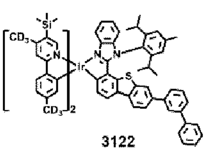
3122

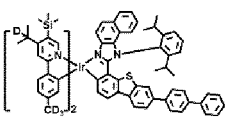
3123

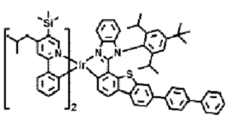
3124

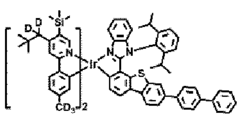
3125

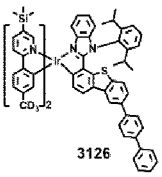
3126

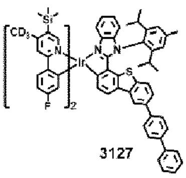
3127

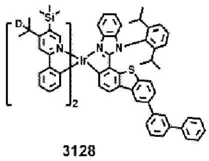
3128

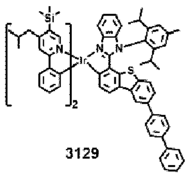
3129

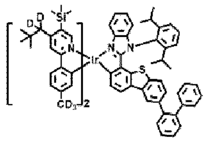
3130

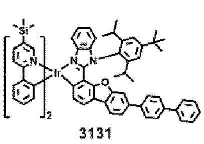
3131

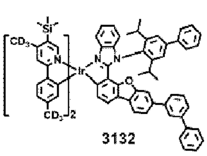
3132

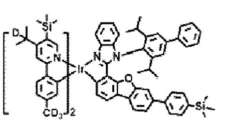
3133

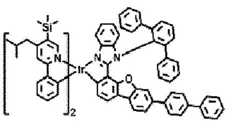
3134

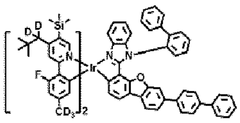
3135

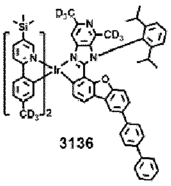
3136

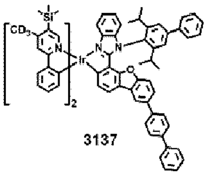
3137

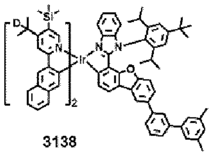
3138

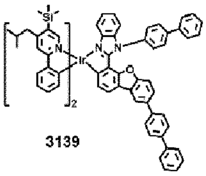
3139

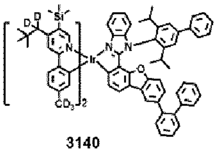
3140

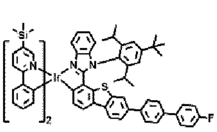
3141

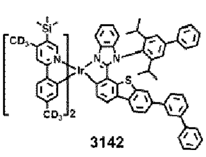
3142

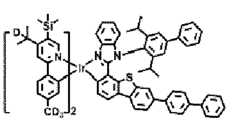
3143

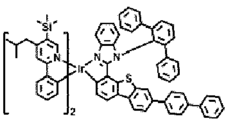
3144

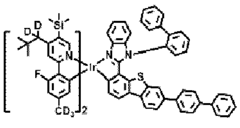
3145

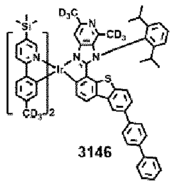
3146

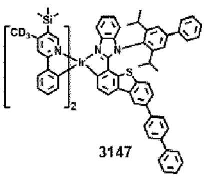
3147

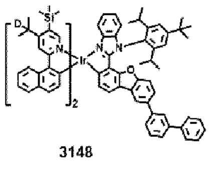
3148

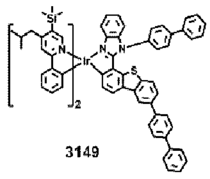
3149

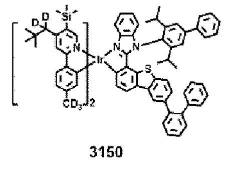
3150

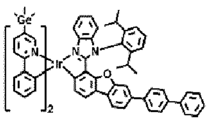
3151

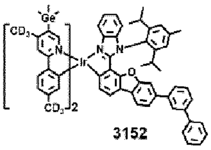
3152

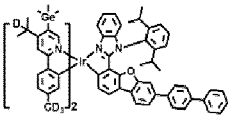
3153

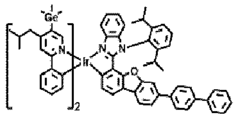
3154

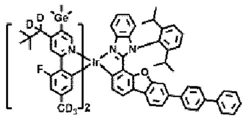
3155

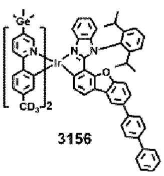
3156

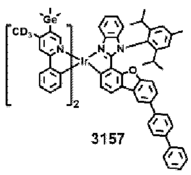
3157

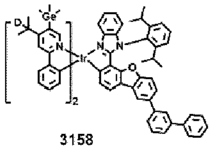
3158

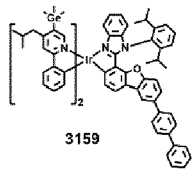
3159

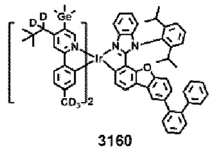
3160

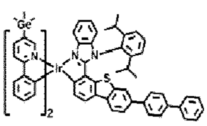
3161

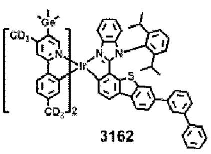
3162

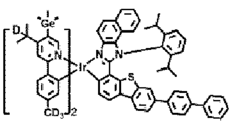
3163

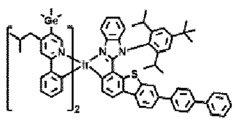
3164

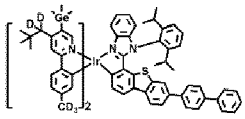
3165

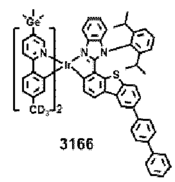
3166

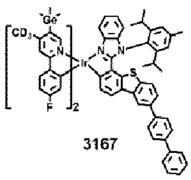
3167

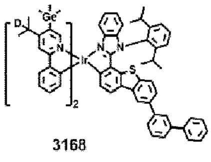
3168

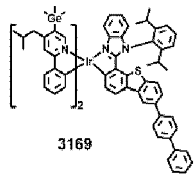
3169

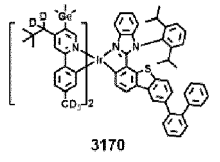
3170

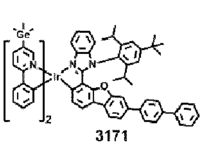
3171

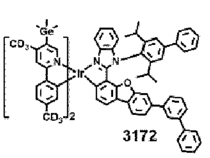
3172

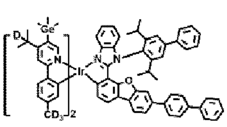
3173

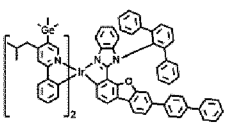
3174

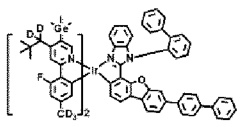
3175

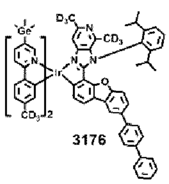
3176

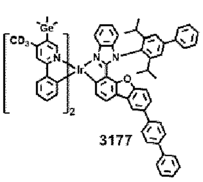
3177

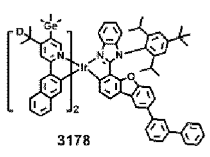
3178

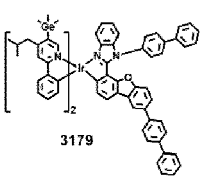
3179

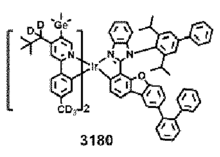
3180

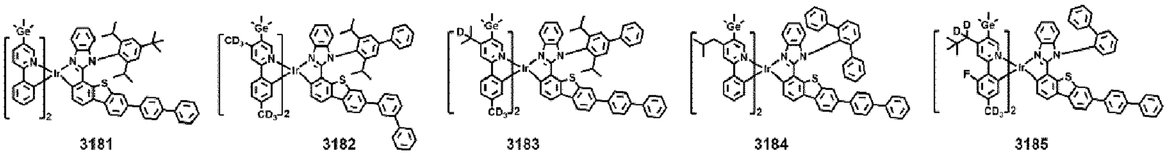
3181 3182 3183 3184 3185

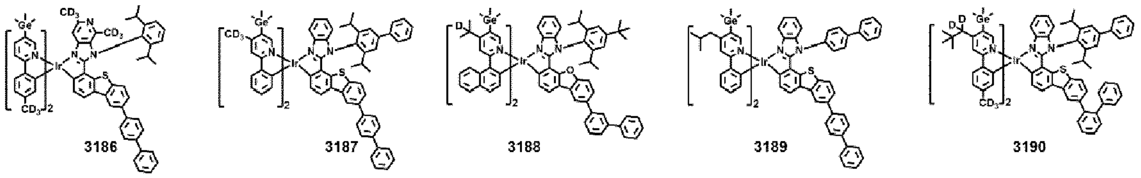
3186 3187 3188 3189 3190

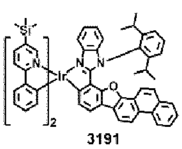
3191

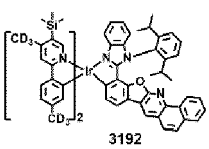
3192

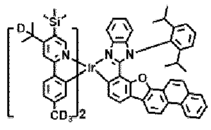
3193

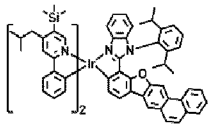
3194

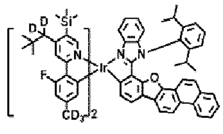
3195

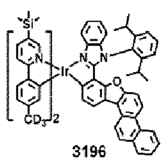
3196

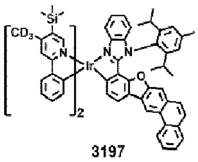
3197

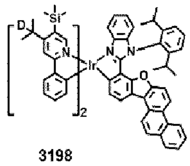
3198

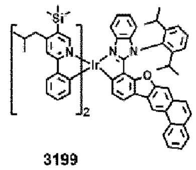
3199

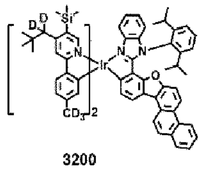
3200

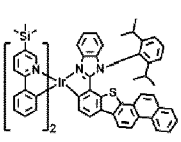
3201

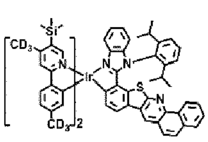
3202

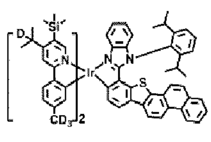
3203

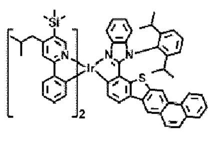
3204

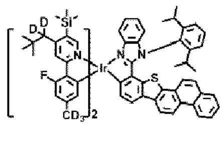
3205

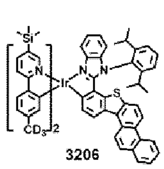
3206

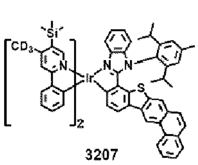
3207

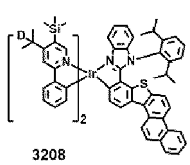
3208

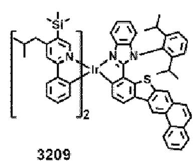
3209

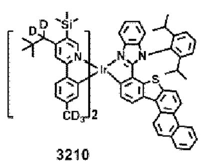
3210

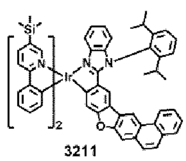
3211

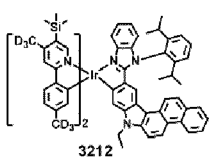
3212

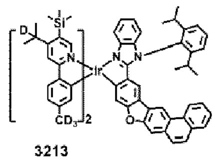
3213

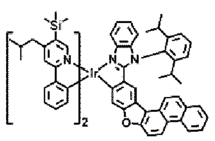
3214

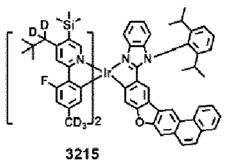
3215

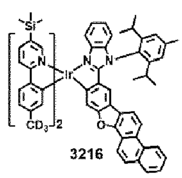
3216

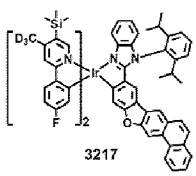
3217

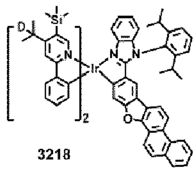
3218

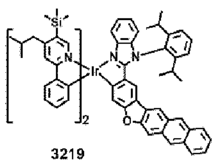
3219

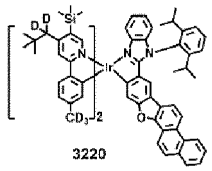
3220

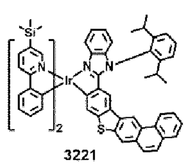
3221

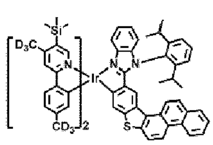
3222

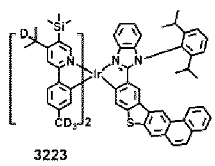
3223

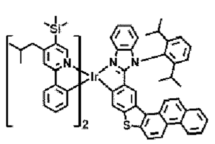
3224

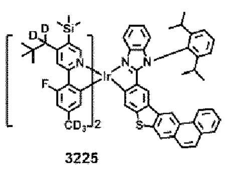
3225

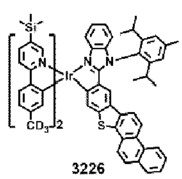
3226

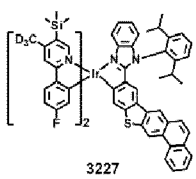
3227

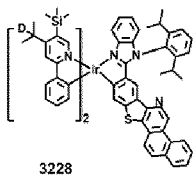
3228

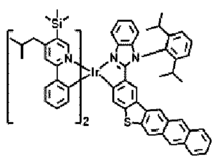
3229

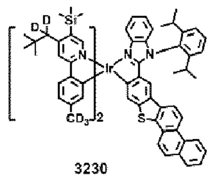
3230

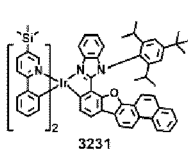
3231
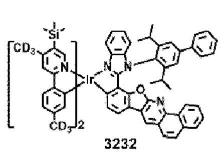
3232
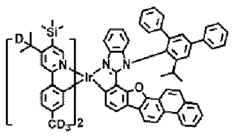
3233
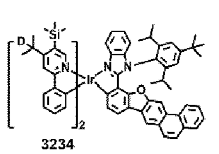
3234
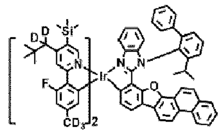
3235

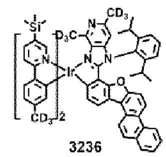
3236
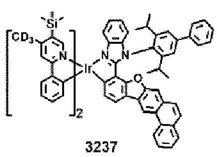
3237
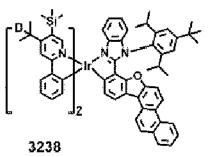
3238
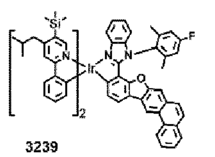
3239
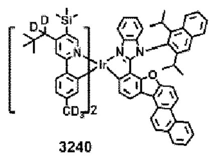
3240

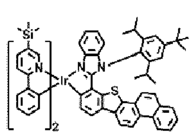
3241
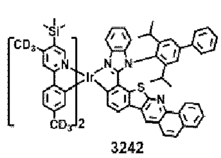
3242
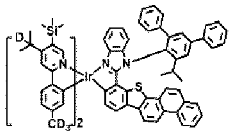
3243
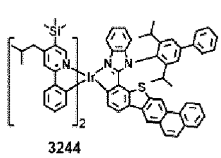
3244
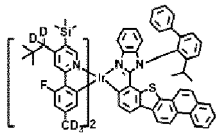
3245

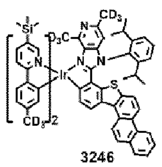
3246
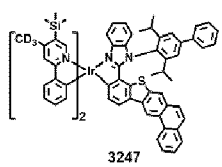
3247
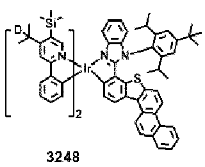
3248
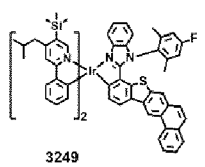
3249
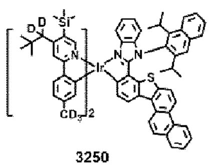
3250

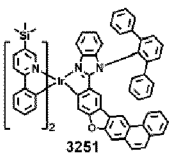
3251
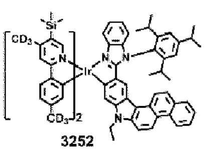
3252
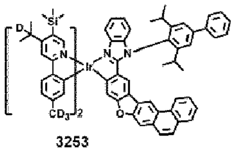
3253
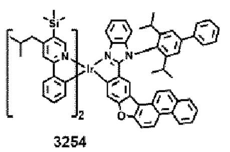
3254
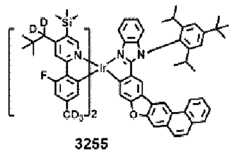
3255

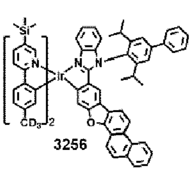
3256
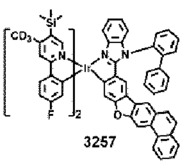
3257
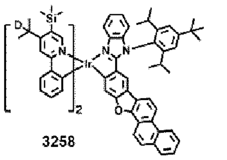
3258
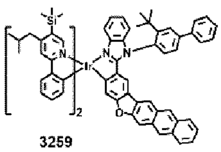
3259
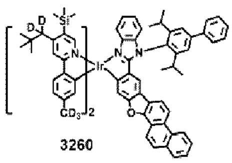
3260

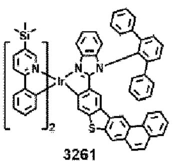
3261
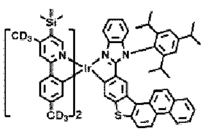
3262
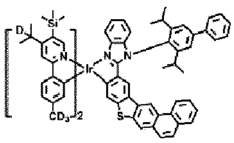
3263
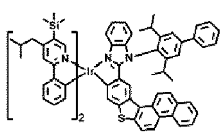
3264
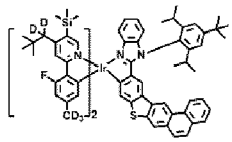
3265

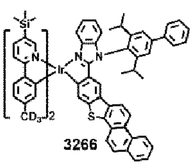
3266
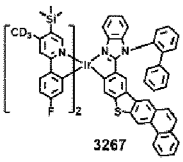
3267
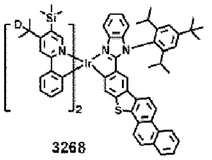
3268
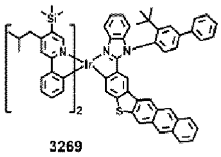
3269
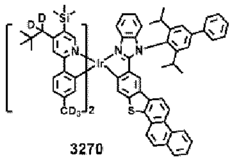
3270

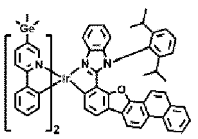
3271
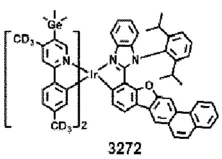
3272
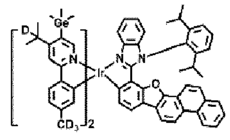
3273
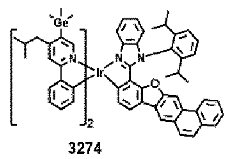
3274
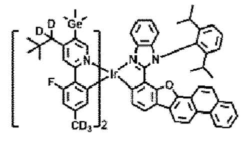
3275

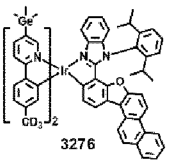
3276
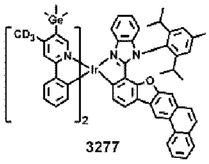
3277
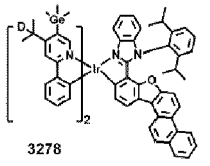
3278
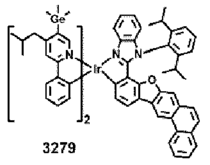
3279
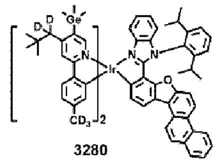
3280

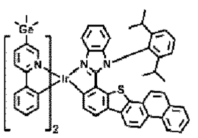
3281
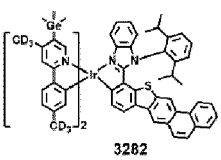
3282
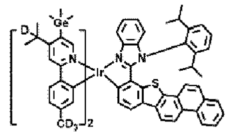
3283
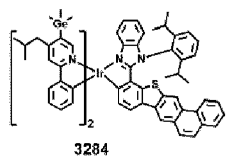
3284
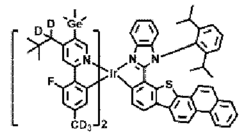
3285

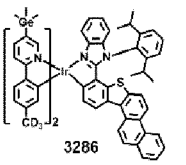
3286
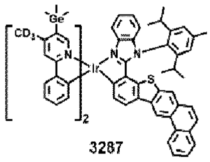
3287
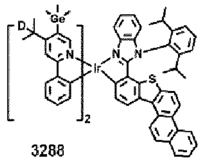
3288
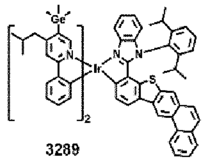
3289
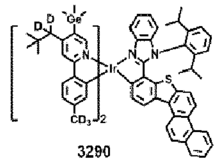
3290

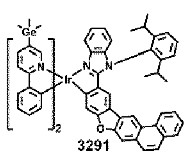
3291
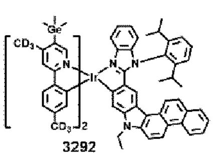
3292
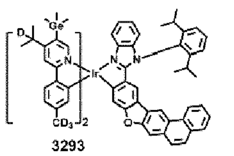
3293
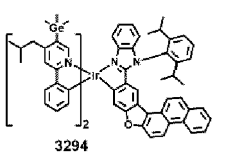
3294
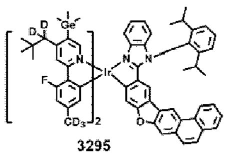
3295

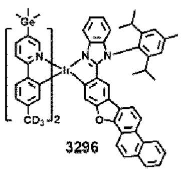
3296
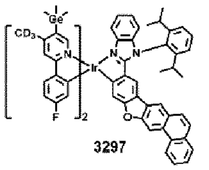
3297
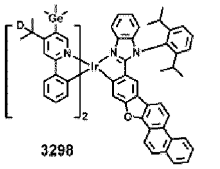
3298
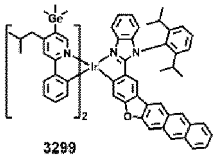
3299
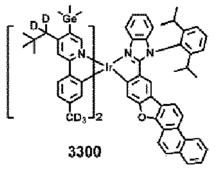
3300

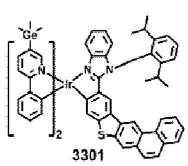
3301
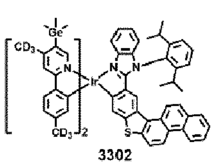
3302
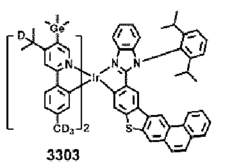
3303
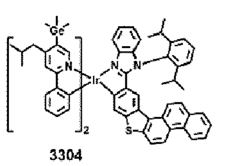
3304
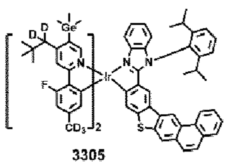
3305

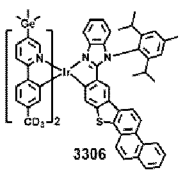
3306
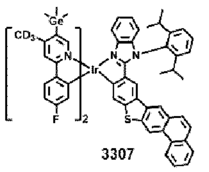
3307
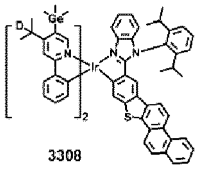
3308
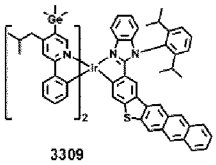
3309
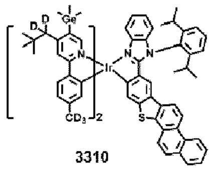
3310

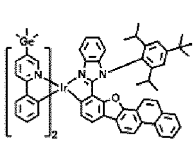
3311
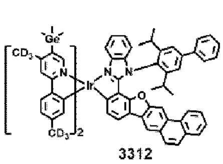
3312
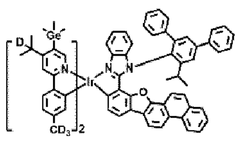
3313
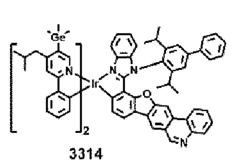
3314
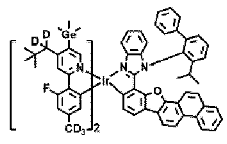
3315

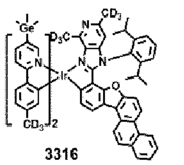
3316
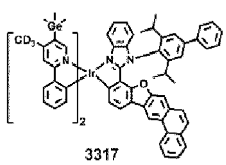
3317
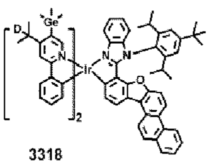
3318
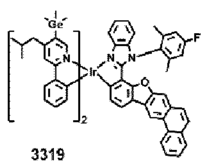
3319
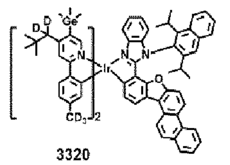
3320

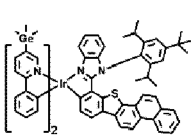
3321
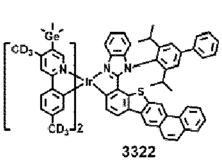
3322
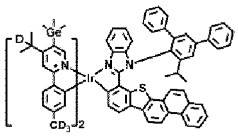
3323
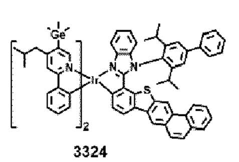
3324
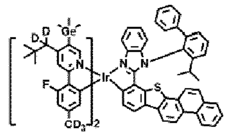
3325

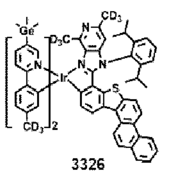
3326
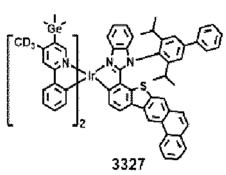
3327
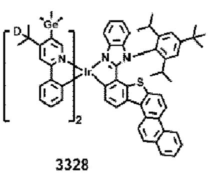
3328
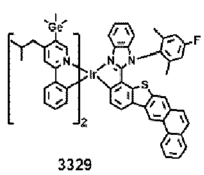
3329
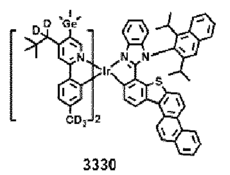
3330

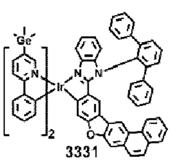
3331
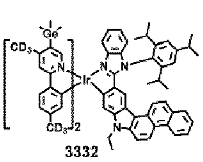
3332
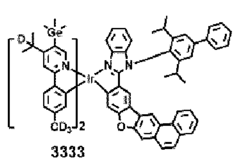
3333
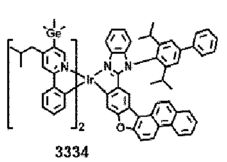
3334
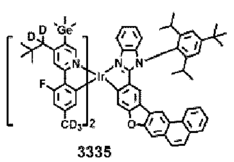
3335

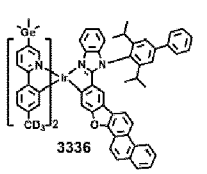
3336
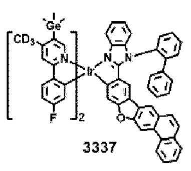
3337
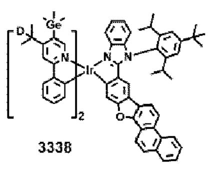
3338
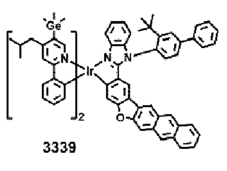
3339
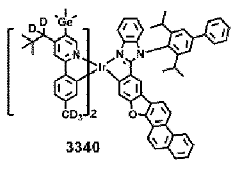
3340

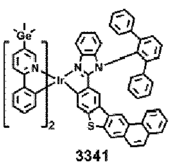
3341
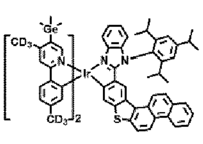
3342
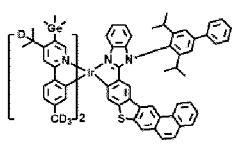
3343
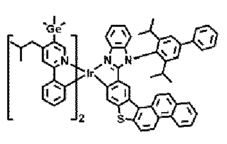
3344
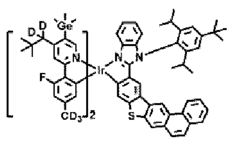
3345

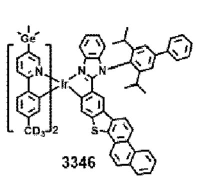
3346
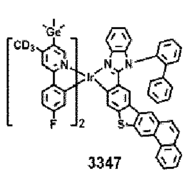
3347
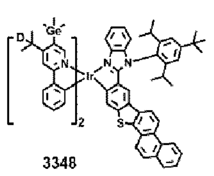
3348
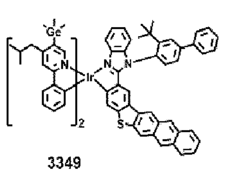
3349
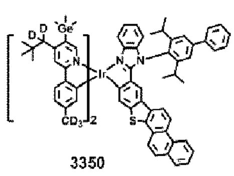
3350

Group 1-4

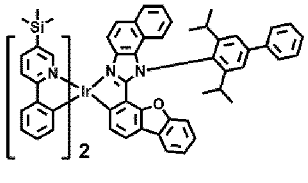

1

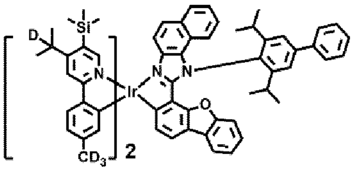

2

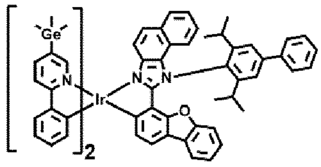

3

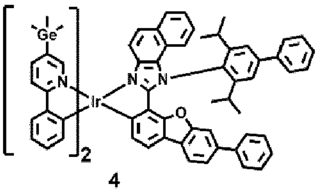

4

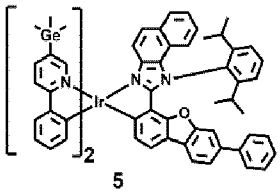

5

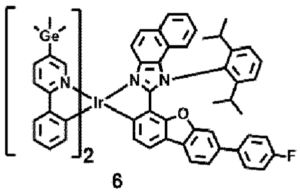

6

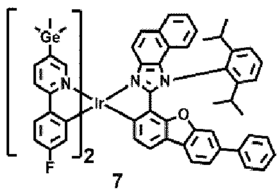

7

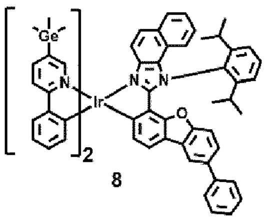

8

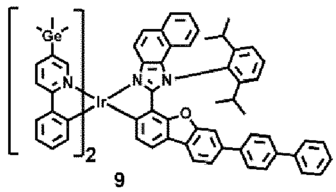

9

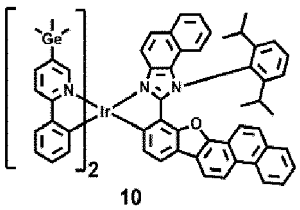

10

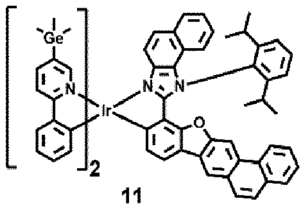

11

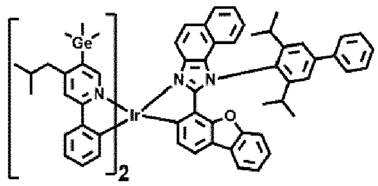

12

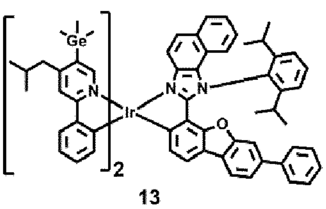

13

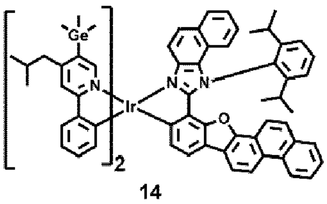

14

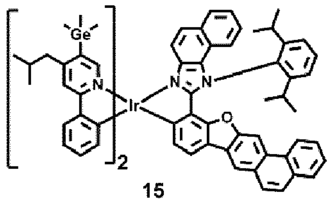

15

Group 1-5

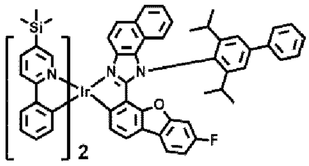

1

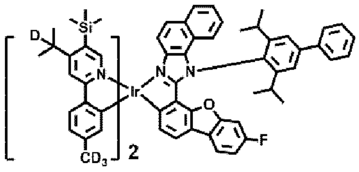

2

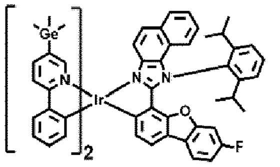

3

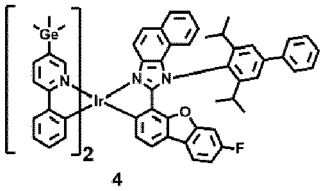

4

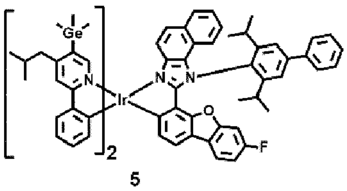

5

Group 1-6

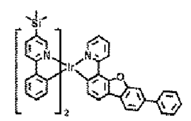
1

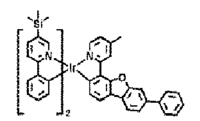
2

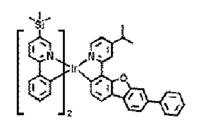
3

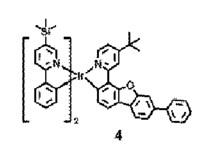
4

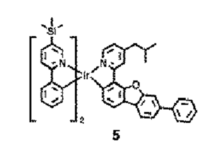
5

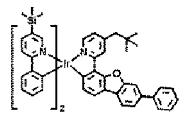
6

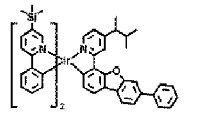
7

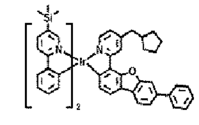
8

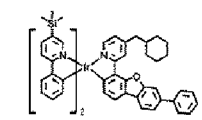
9

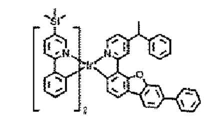
10

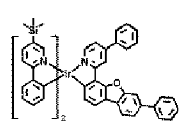
11

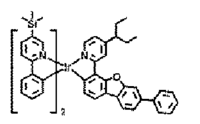
12

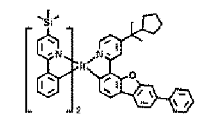
13

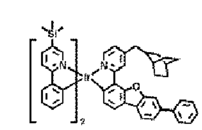
14

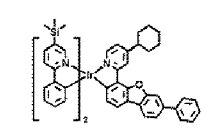
15

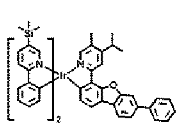
16

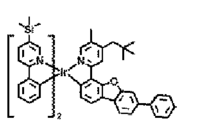
17

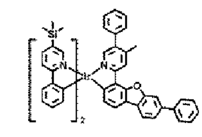
18

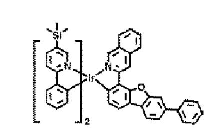
19

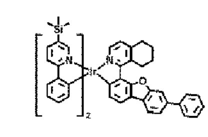
20

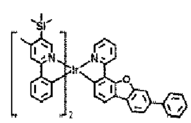
21

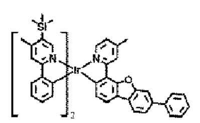
22

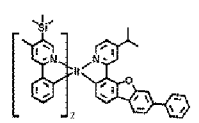
23

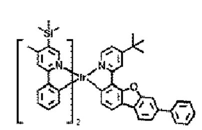
24

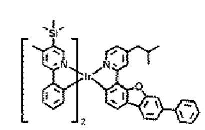
25

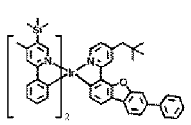
26

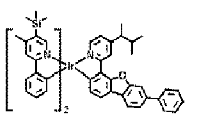
27

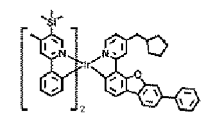
28

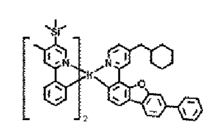
29

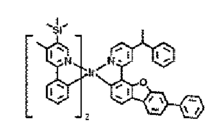
30

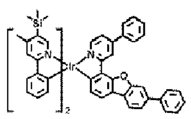
31

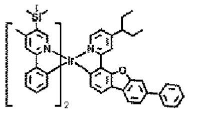
32

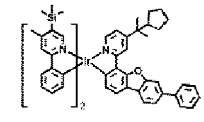
33

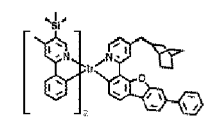
34

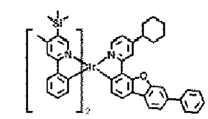
35

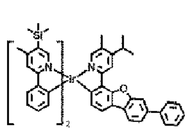
36

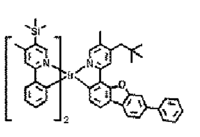
37

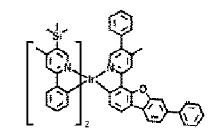
38

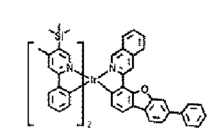
39

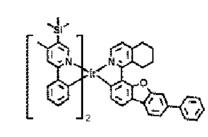
40

41

42

43

44

45

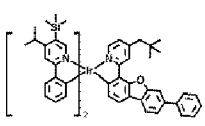
46
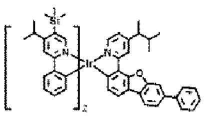
47
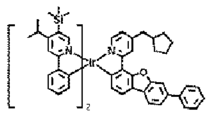
48
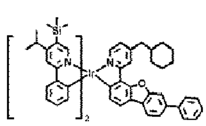
49
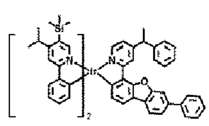
50

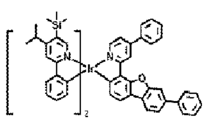
51
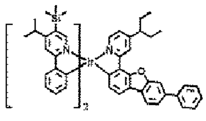
52
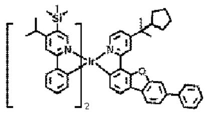
53
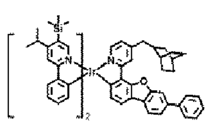
54
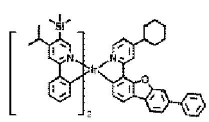
55

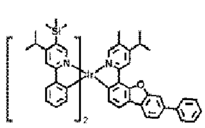
56
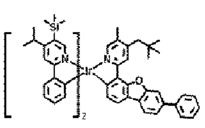
57
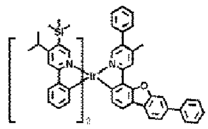
58
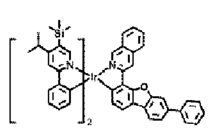
59
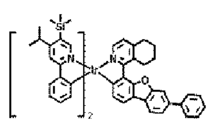
60

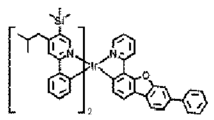
61
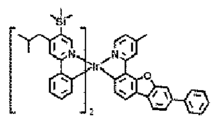
62
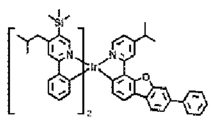
63
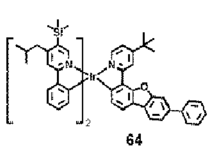
64
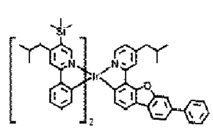
65

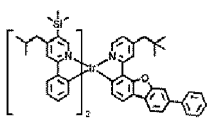
66
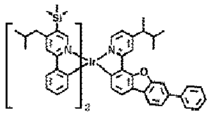
67
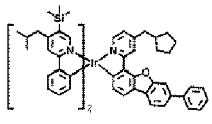
68
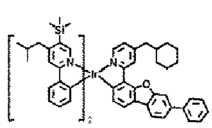
69
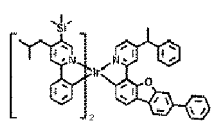
70

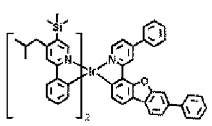
71
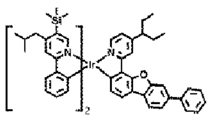
72
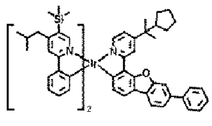
73
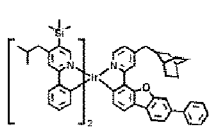
74
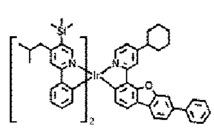
75

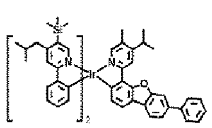
76
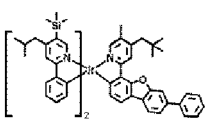
77
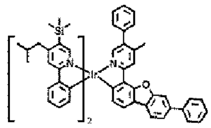
78
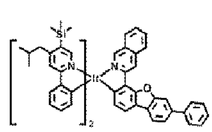
79
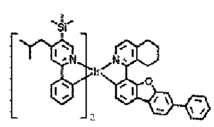
80

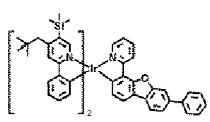
81
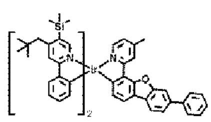
82
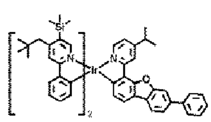
83
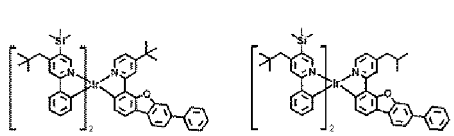
84
85

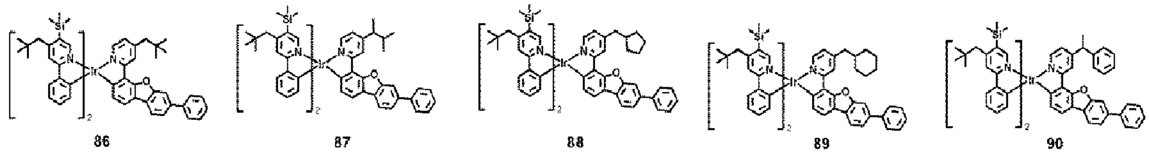
86
87
88
89
90

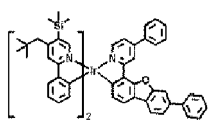
91
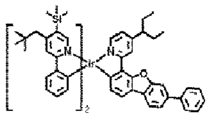
92
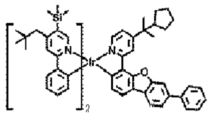
93
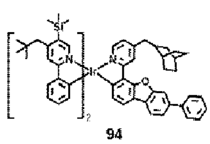
94
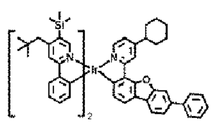
95

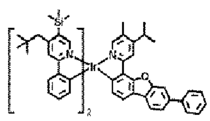
96
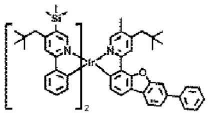
97
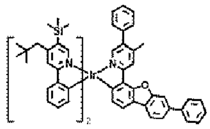
98
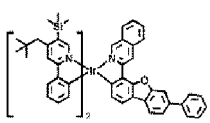
99
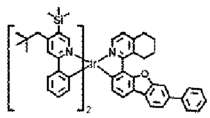
100

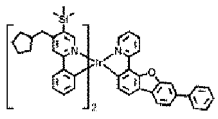
101
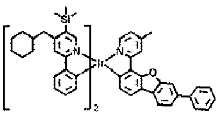
102
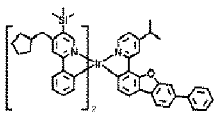
103
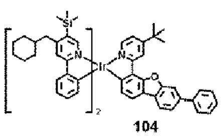
104
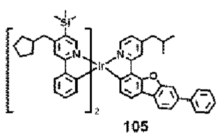
105

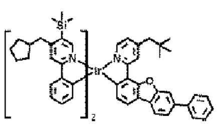
106
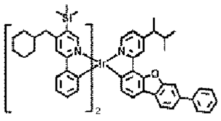
107
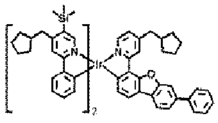
108
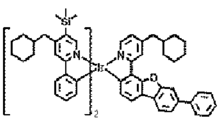
109
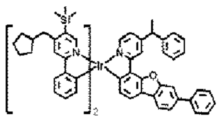
110

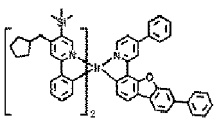
111
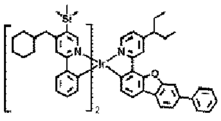
112
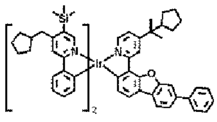
113
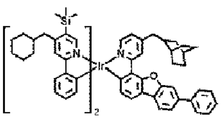
114
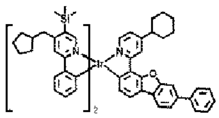
115

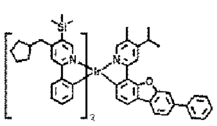
116
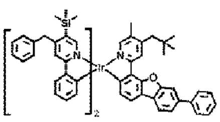
117
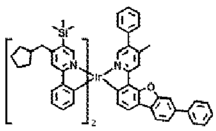
118
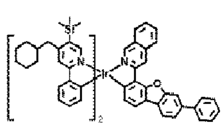
119
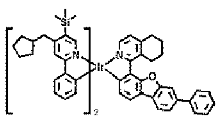
120

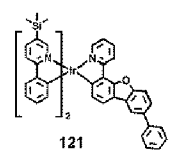
121
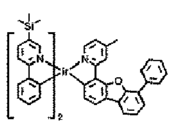
122
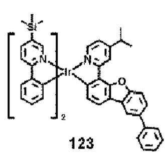
123
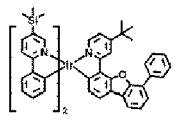
124
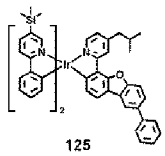
125

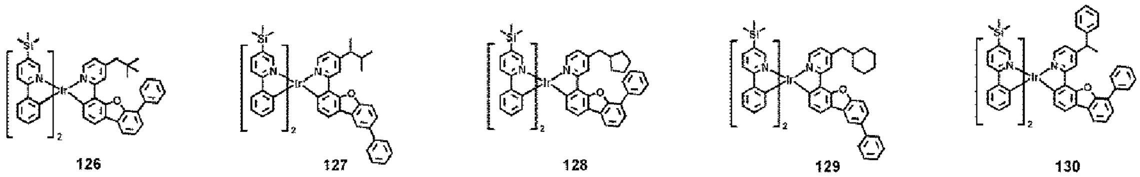
126 127 128 129 130

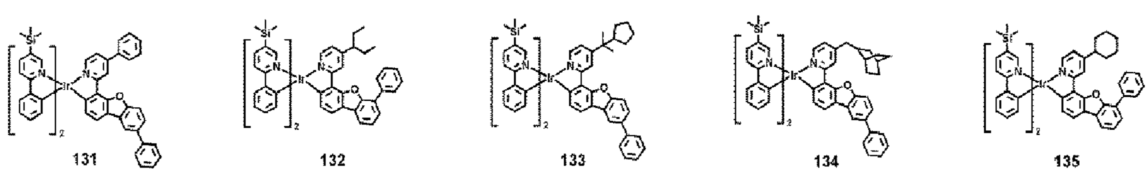
131 132 133 134 135

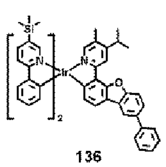
136
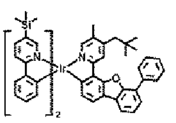
137
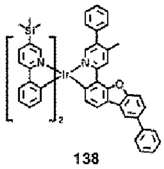
138
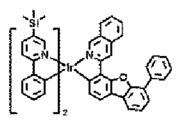
139
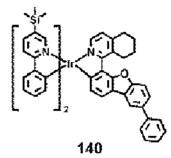
140
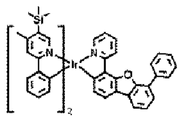
141
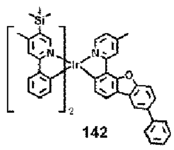
142
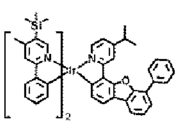
143
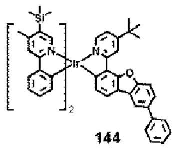
144
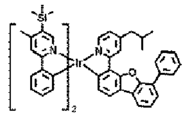
145
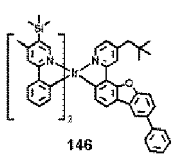
146
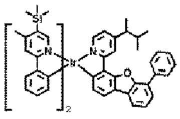
147
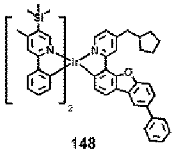
148
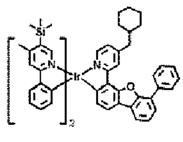
148
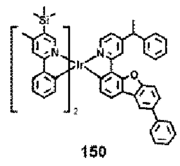
150
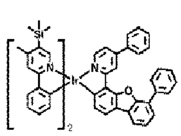
151
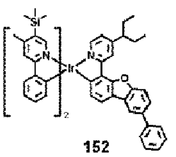
152
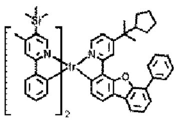
153
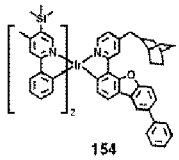
154
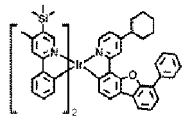
155
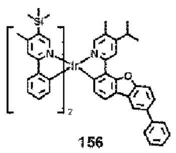
156
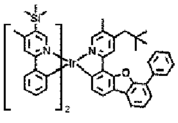
157
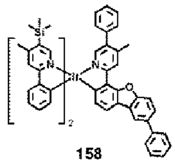
158
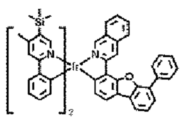
159
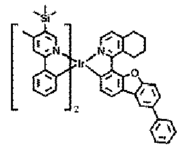
160
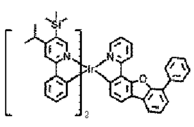
161
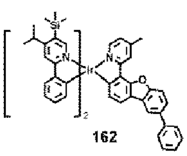
162
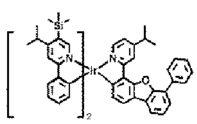
163
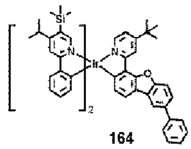
164
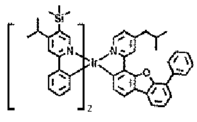
165
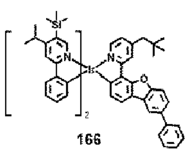
166
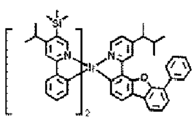
167
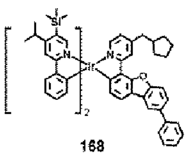
168
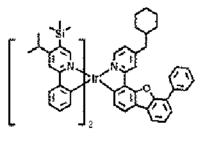
169
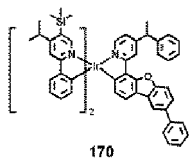
170
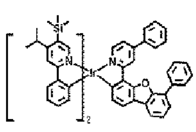
171
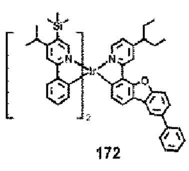
172
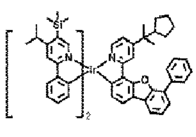
173
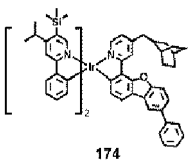
174
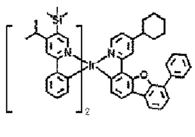
175

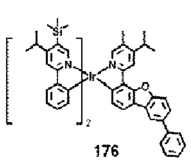
176

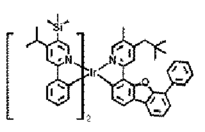
177

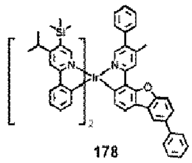
178

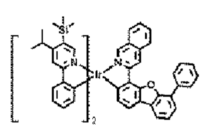
179

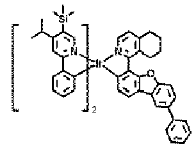
180

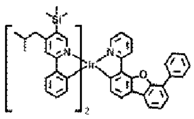
181

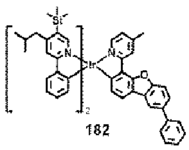
182

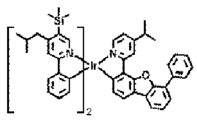
183

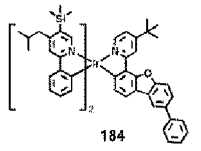
184

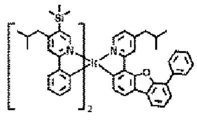
185

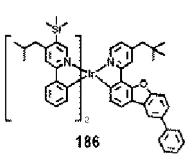
186

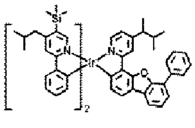
187

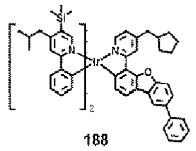
188

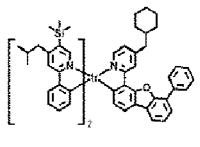
189

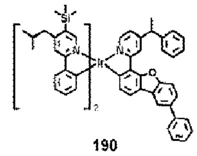
190

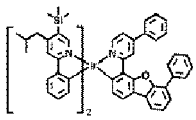
191

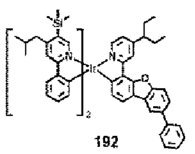
192

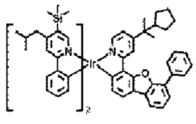
193

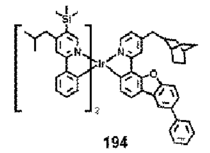
194

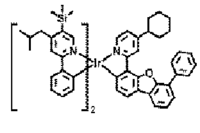
195

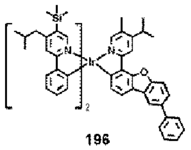
196

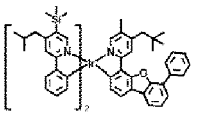
197

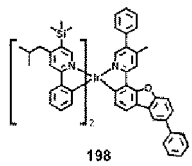
198

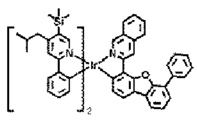
199

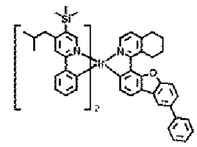
200

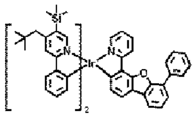
201

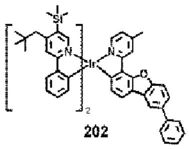
202

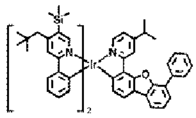
203

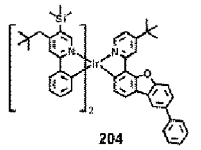
204

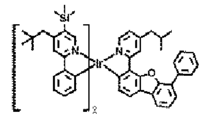
205

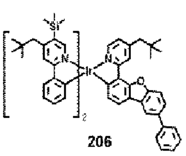
206

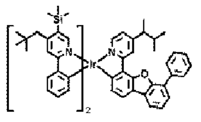
207

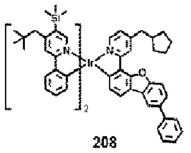
208

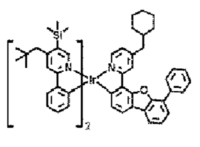
209

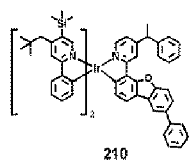
210

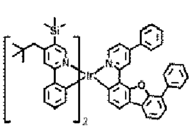
211

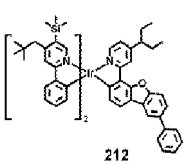
212

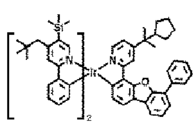
213

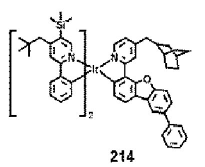
214

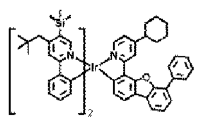
215

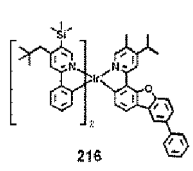
216
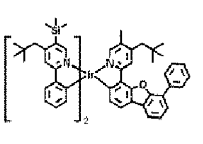
217
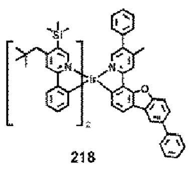
218
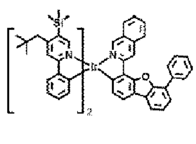
219
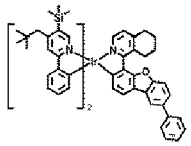
220

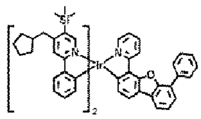
221
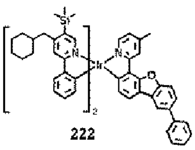
222
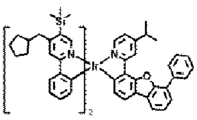
223
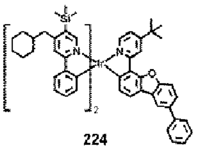
224
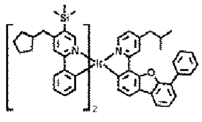
225

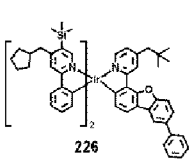
226
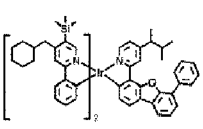
227
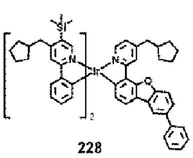
228
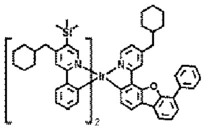
229
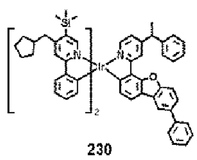
230

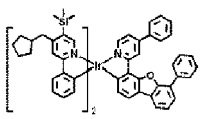
231
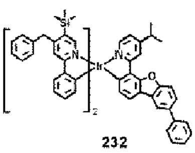
232
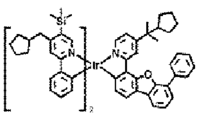
233
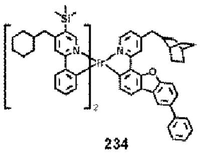
234
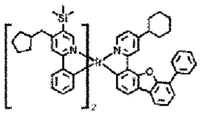
235

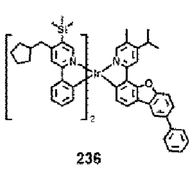
236
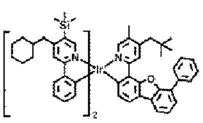
237
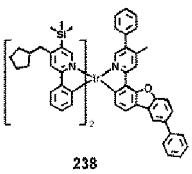
238
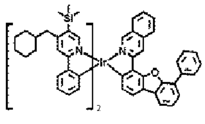
239
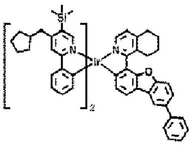
240

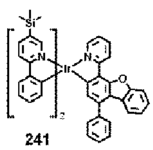
241
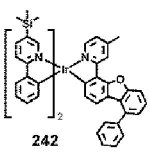
242
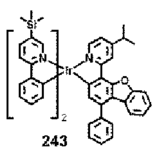
243
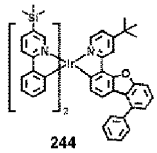
244
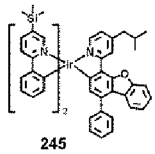
245

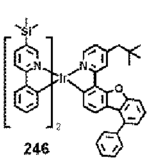
246
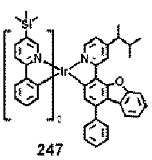
247
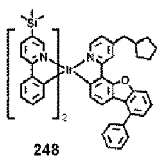
248
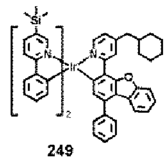
249
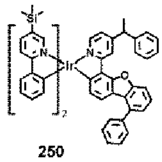
250

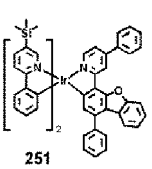
251
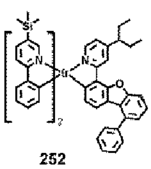
252
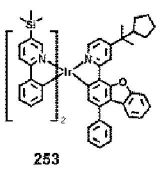
253
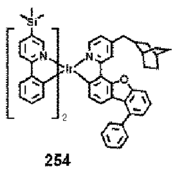
254
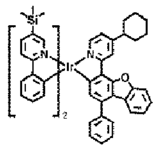
255

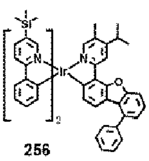
256

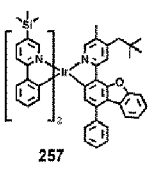
257

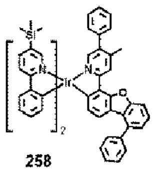
258

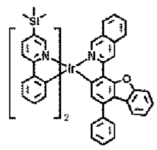
259

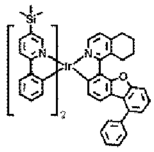
260

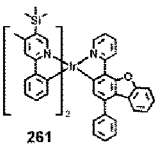
261

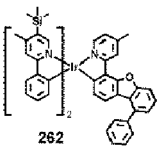
262

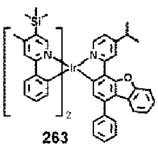
263

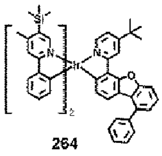
264

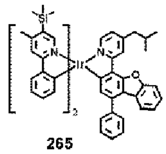
265

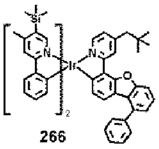
266

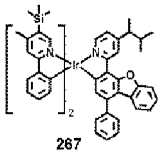
267

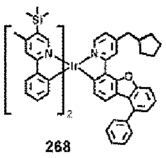
268

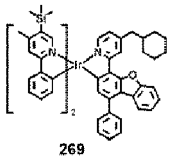
269

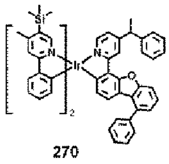
270

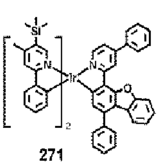
271

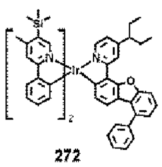
272

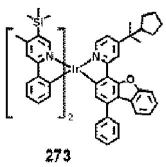
273

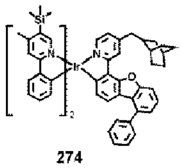
274

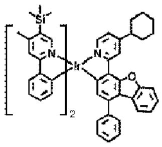
275

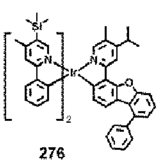
276

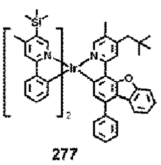
277

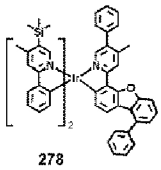
278

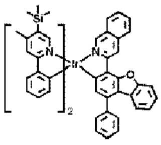
279

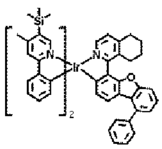
280

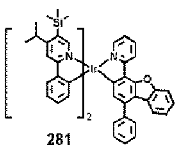
281

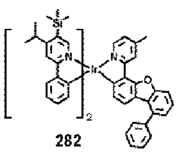
282

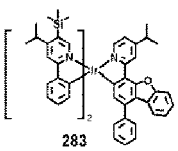
283

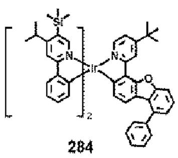
284

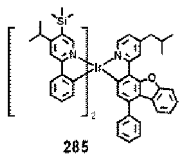
285

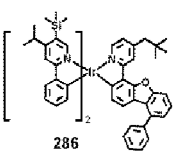
286

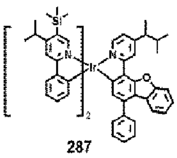
287

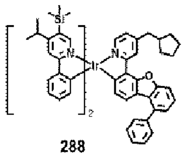
288

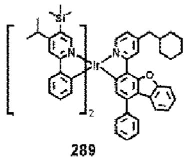
289

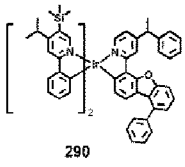
290

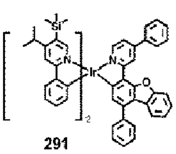
291

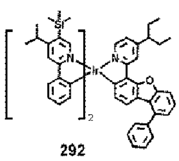
292

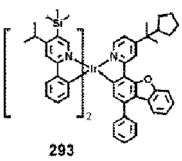
293

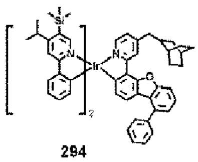
294

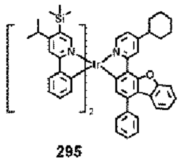
295

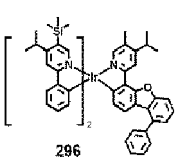
296
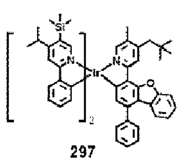
297
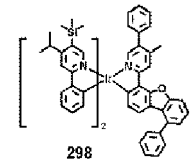
298
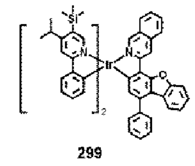
299
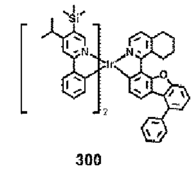
300
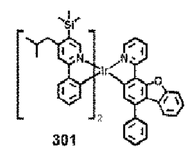
301
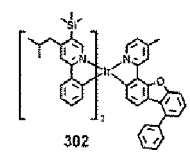
302
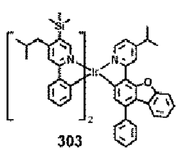
303
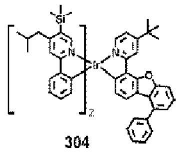
304
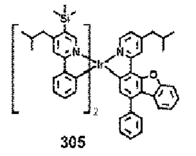
305
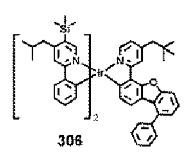
306
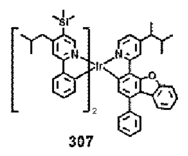
307
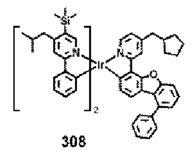
308
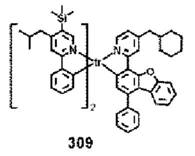
309
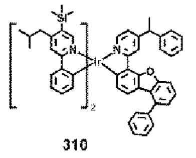
310
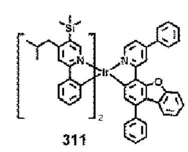
311
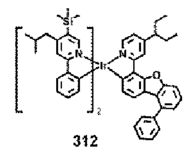
312
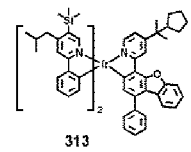
313
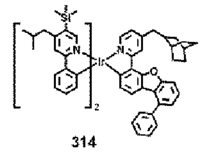
314
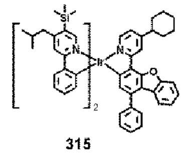
315
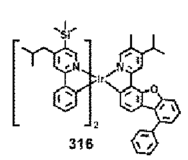
316
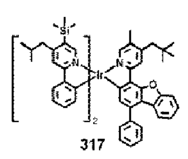
317
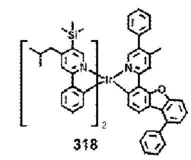
318
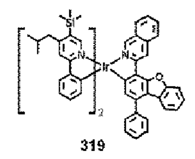
319
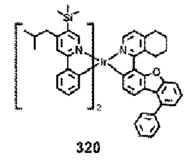
320
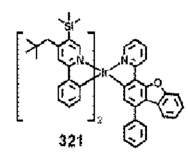
321
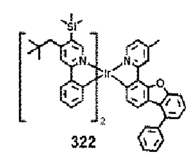
322
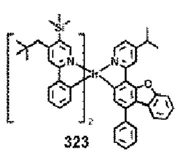
323
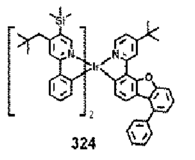
324
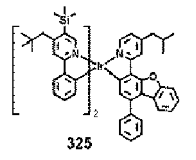
325
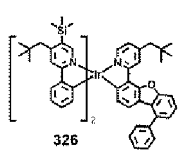
326
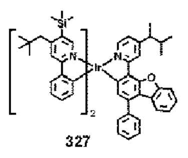
327
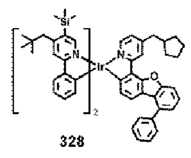
328
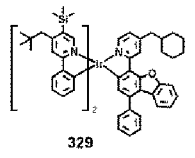
329
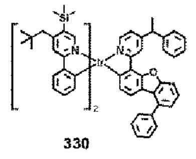
330
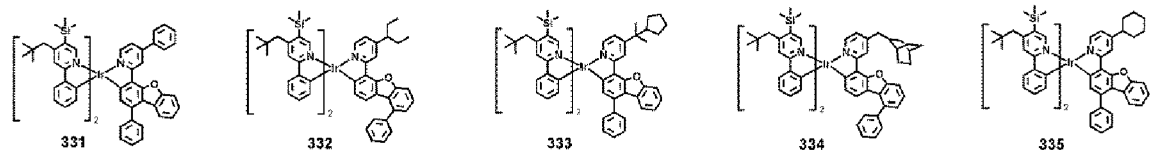
331
332
333
334
335
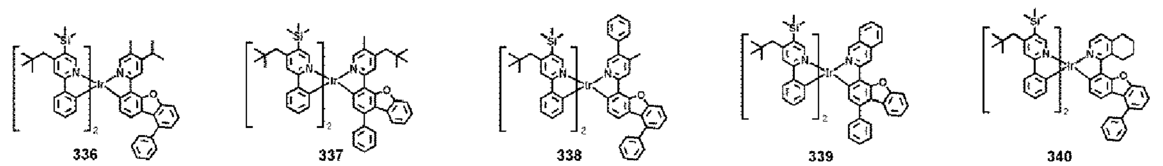
336
337
338
339
340

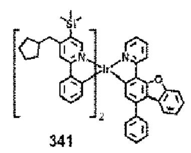
341
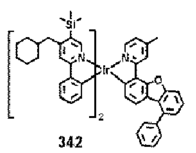
342
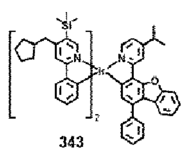
343
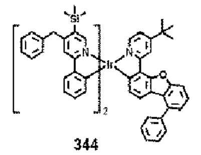
344
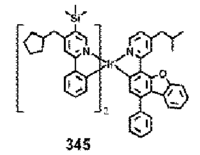
345

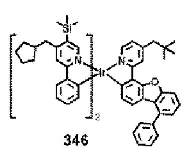
346
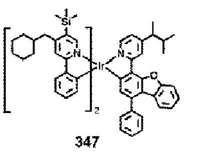
347
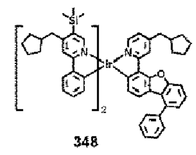
348
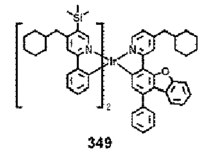
349
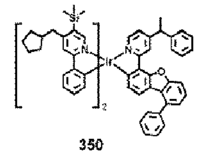
350

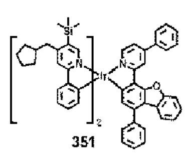
351
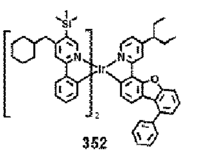
352
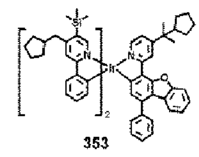
353
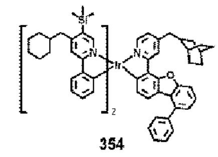
354
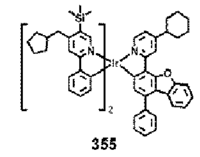
355

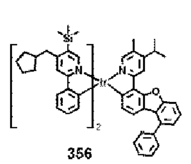
356
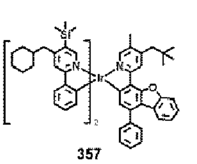
357
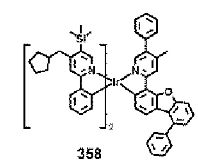
358
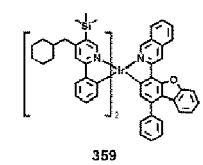
359
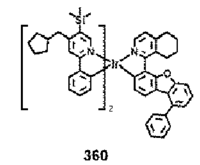
360

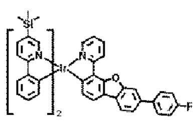
361
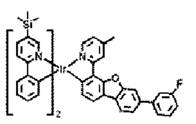
362
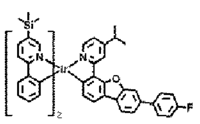
363
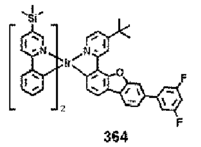
364
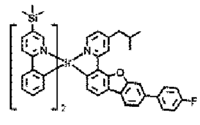
365

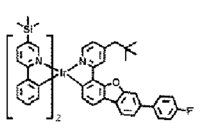
366
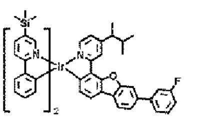
367
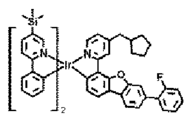
368
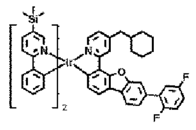
369
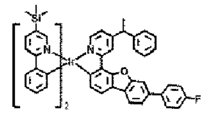
370

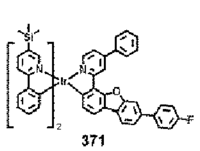
371
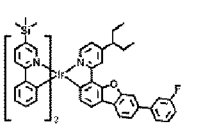
372
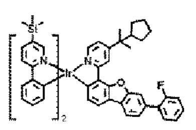
373
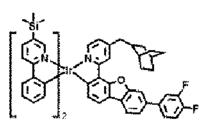
374
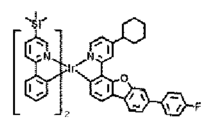
375

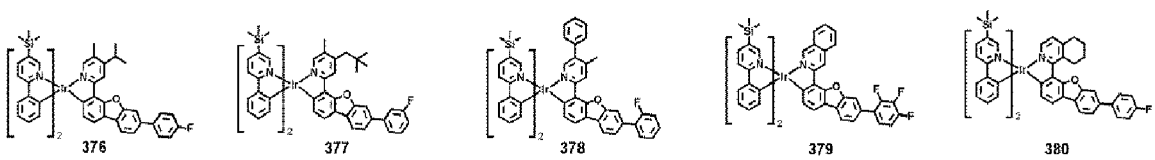
376
377
378
379
380

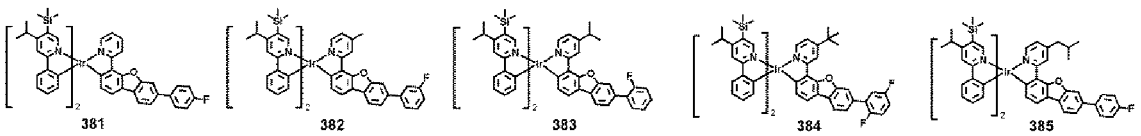
381
382
383
384
385

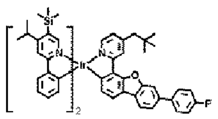
386
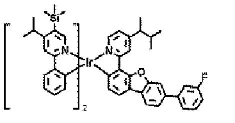
387
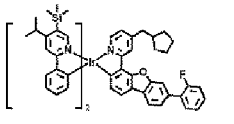
388
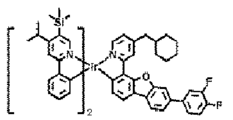
389
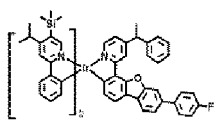
390

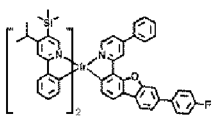
391
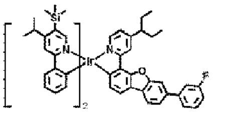
392
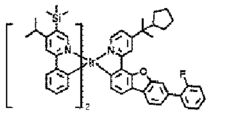
393
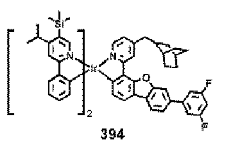
394
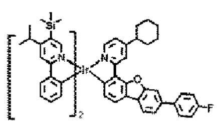
395

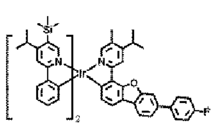
396
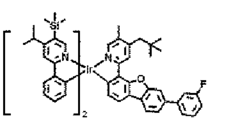
397
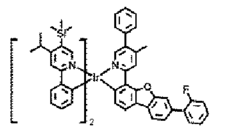
398
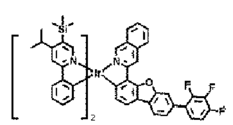
399
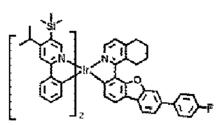
400

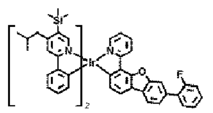
401
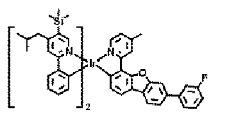
402
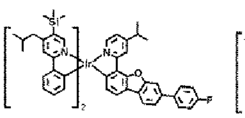
403
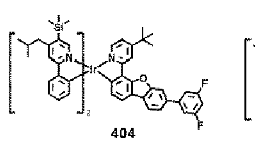
404
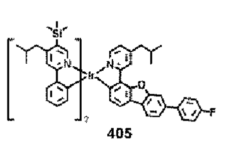
405

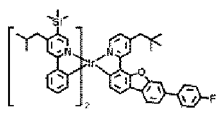
406
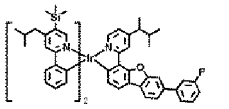
407
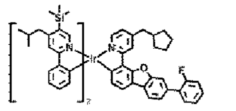
408
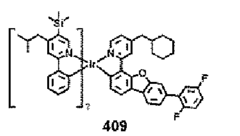
409
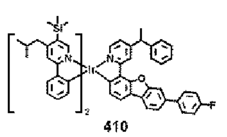
410

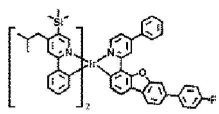
411
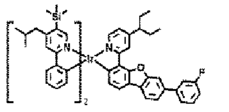
412
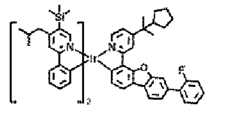
413
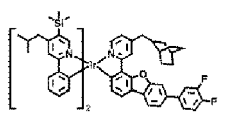
414
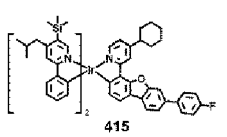
415

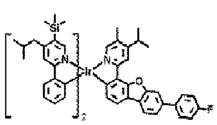
416
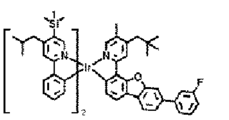
417
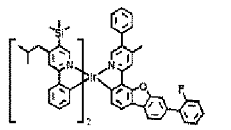
418
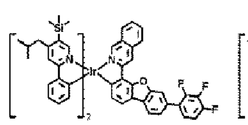
419
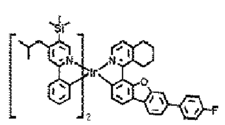
420

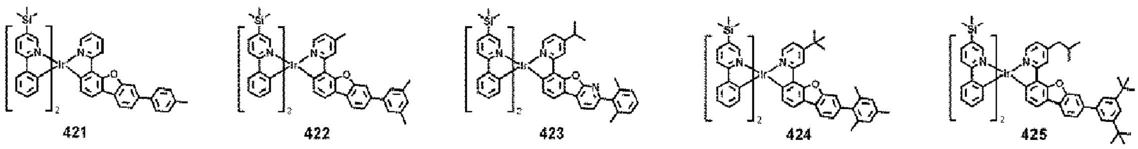
421
422
423
424
425

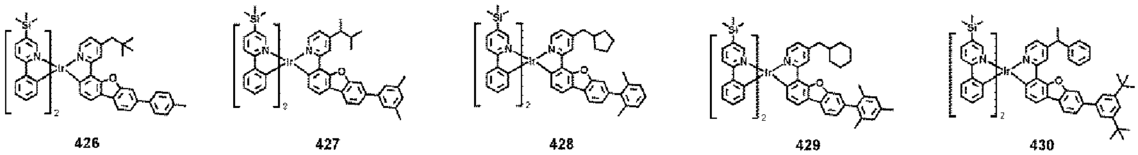
426
427
428
429
430

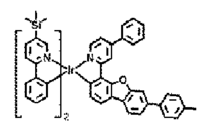
431
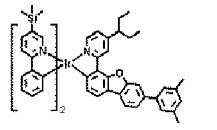
432
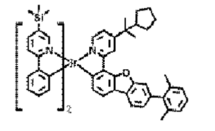
433
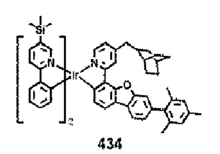
434
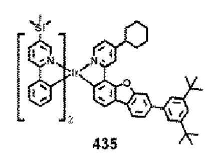
435
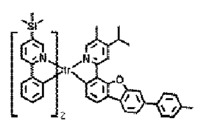
436
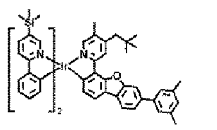
437
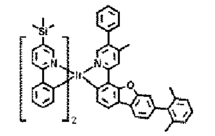
438
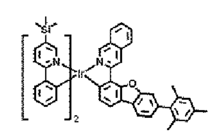
439
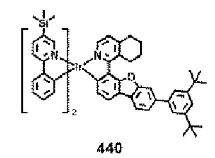
440
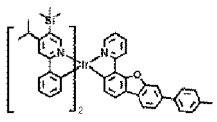
441
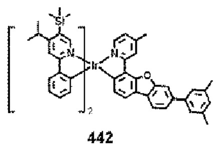
442
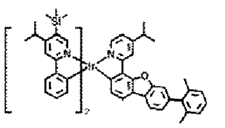
443
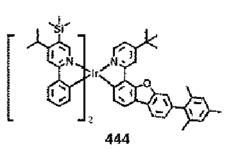
444
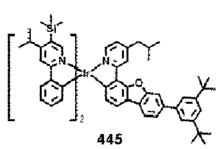
445
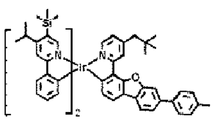
446
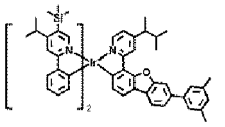
447
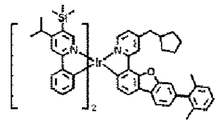
448
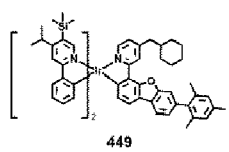
449
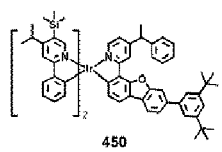
450
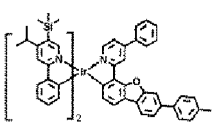
451
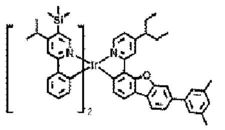
452
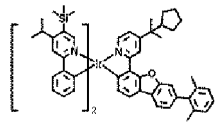
453
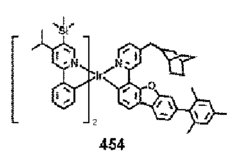
454
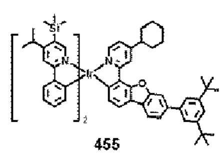
455
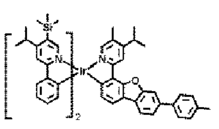
456
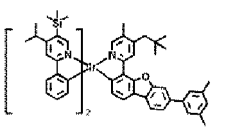
457
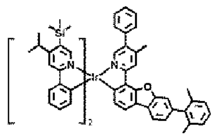
458
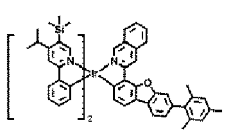
459
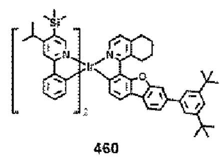
460
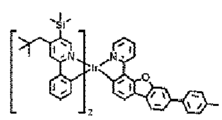
461
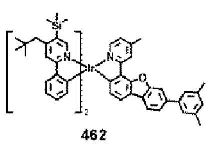
462
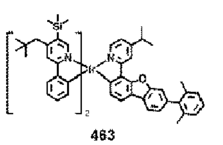
463
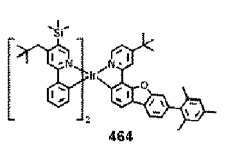
464
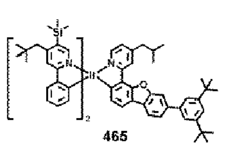
465
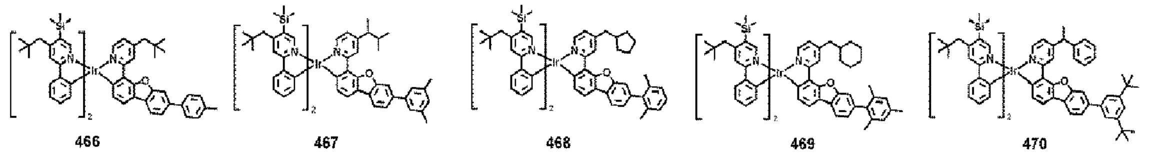
466 467 468 469 470
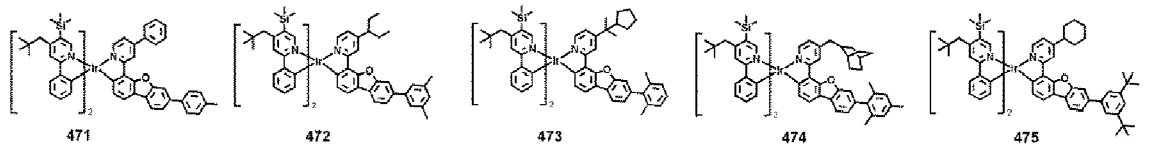
471 472 473 474 475

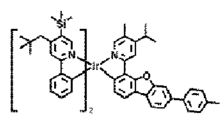
476

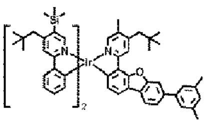
477

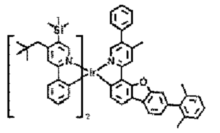
478

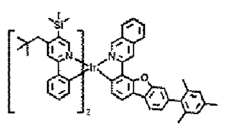
479

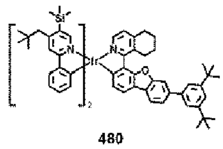
480

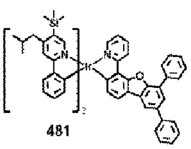
481

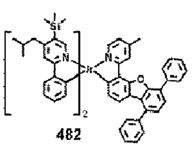
482

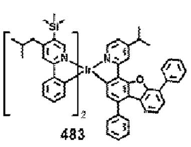
483

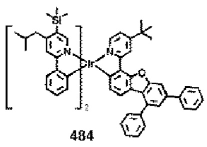
484

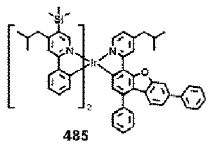
485

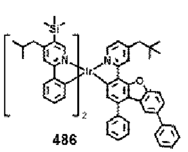
486

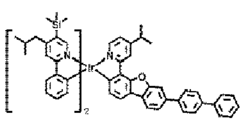
487

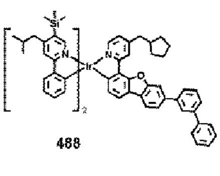
488

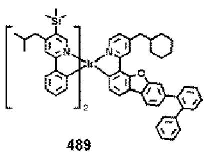
489

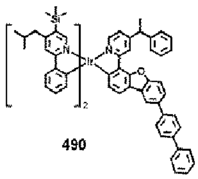
490

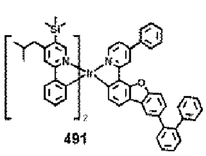
491

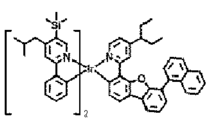
492

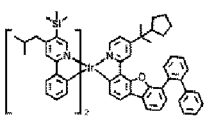
493

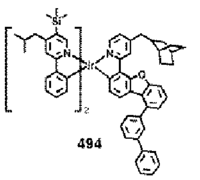
494

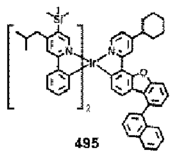
495

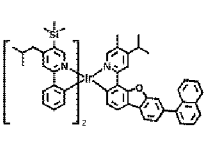
496

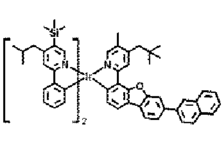
497

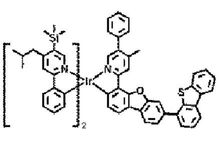
498

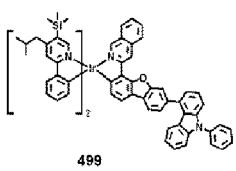
499

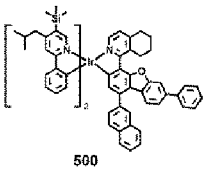
500

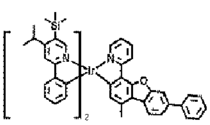
501

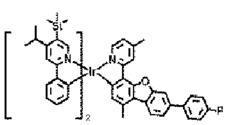
502

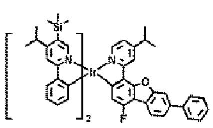
503

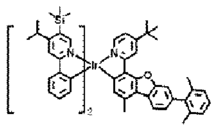
504

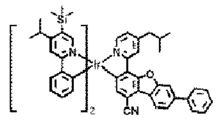
505

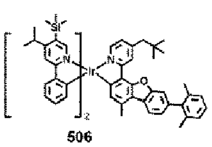
506

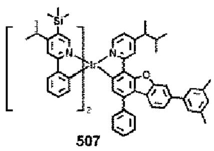
507

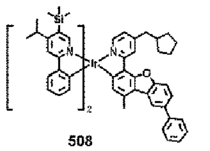
508

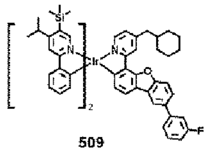
509

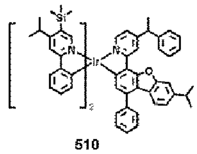
510

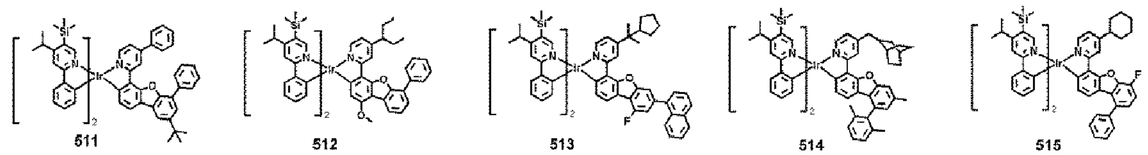
511

512

513

514

515

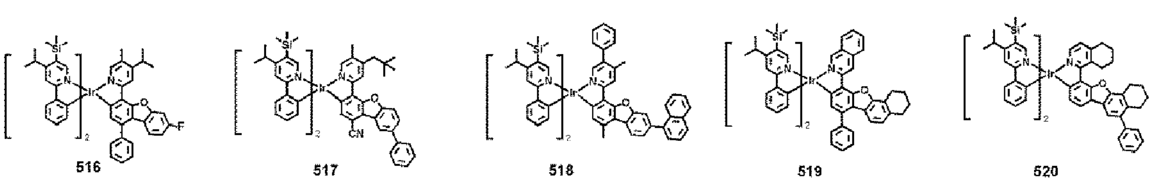
516

517

518

519

520

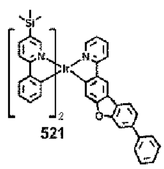
521
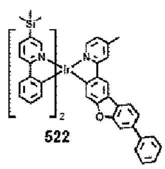
522
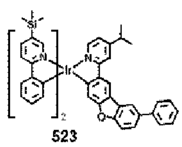
523
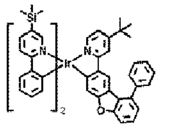
524
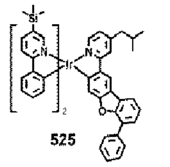
525
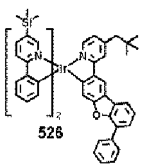
526
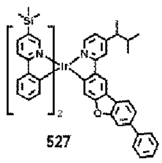
527
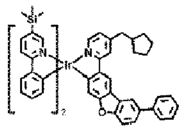
528
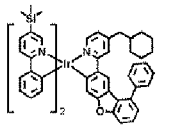
529
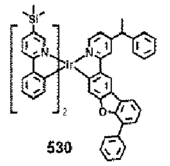
530
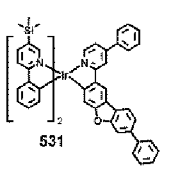
531
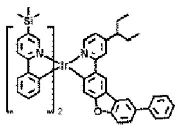
532
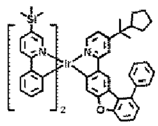
533
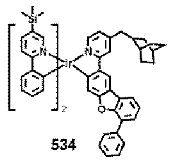
534
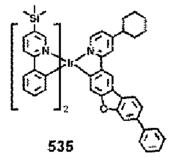
535
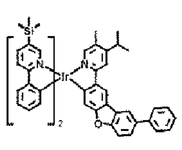
536
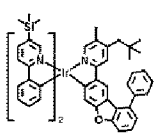
537
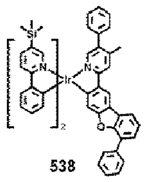
538
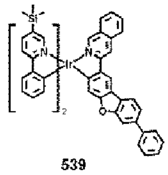
539
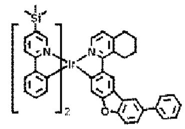
540
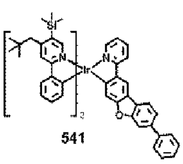
541
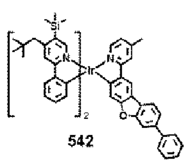
542
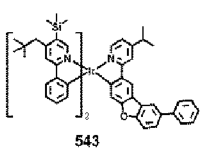
543
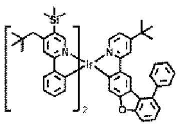
544
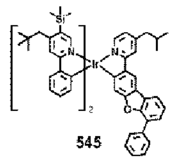
545
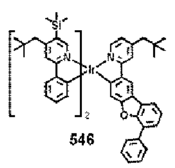
546
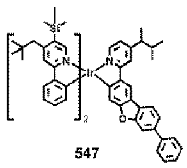
547
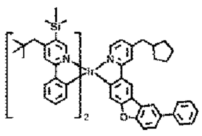
548
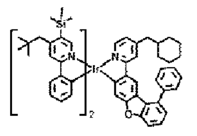
549
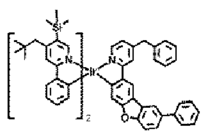
550
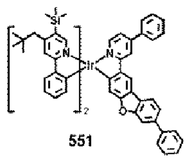
551
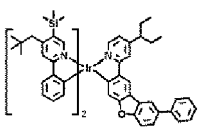
552
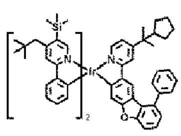
553
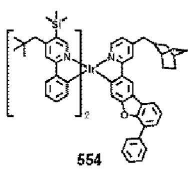
554
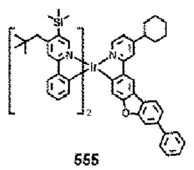
555
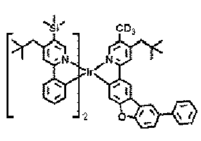
556
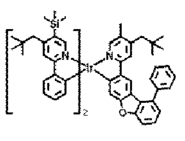
557
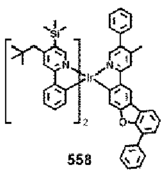
558
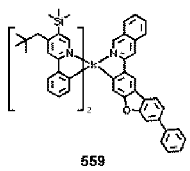
559
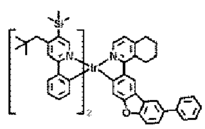
560

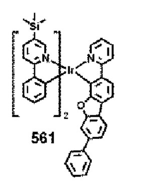
561
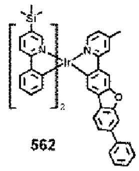
562
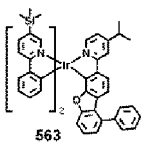
563
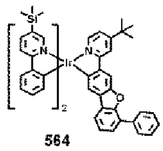
564
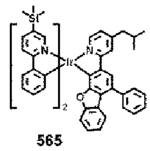
565
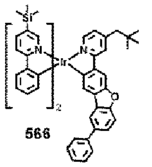
566
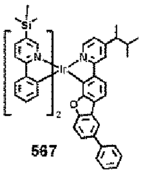
567
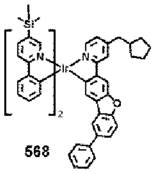
568
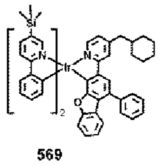
569
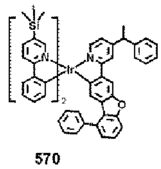
570
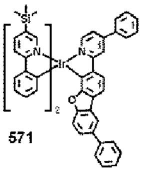
571
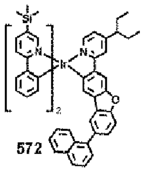
572
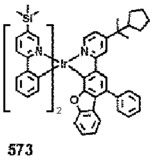
573
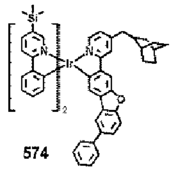
574
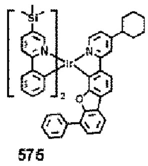
575
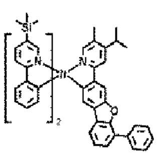
576
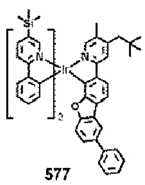
577
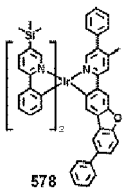
578
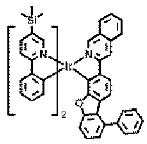
579
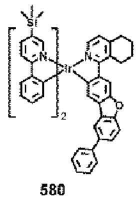
580
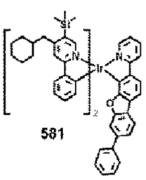
581
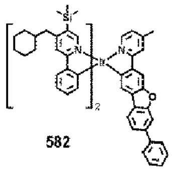
582
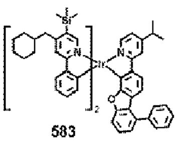
583
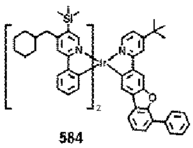
584
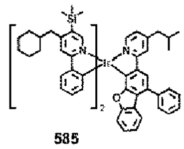
585
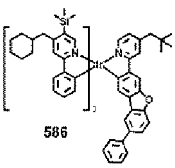
586
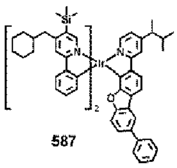
587
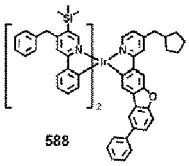
588
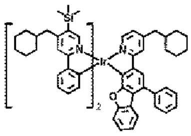
589
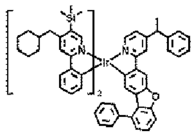
590
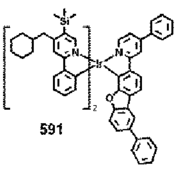
591
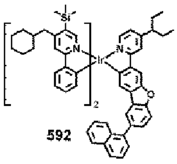
592
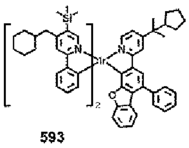
593
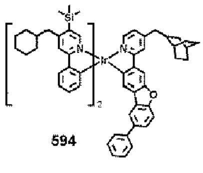
594
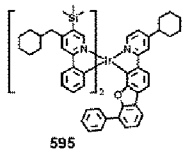
595
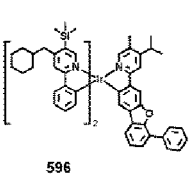
596
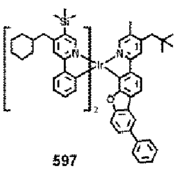
597
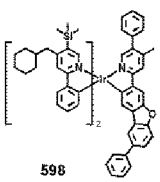
598
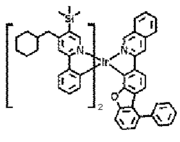
599
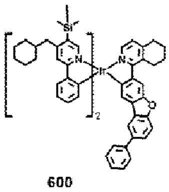
600

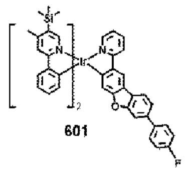
601
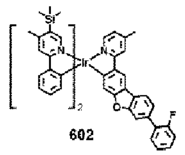
602
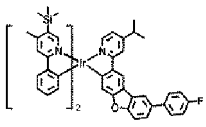
603
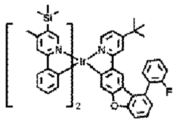
604
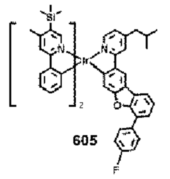
605
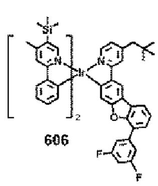
606
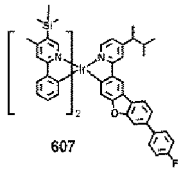
607
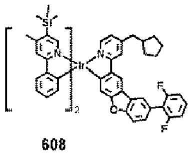
608
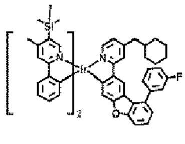
609
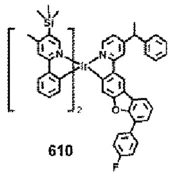
610
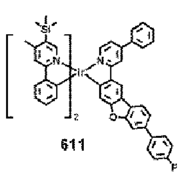
611
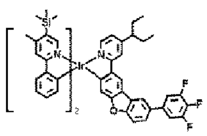
612
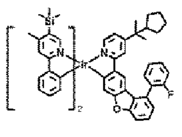
613
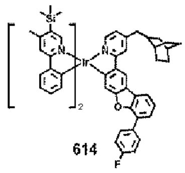
614
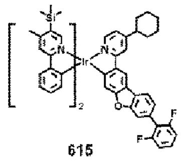
615
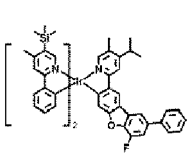
616
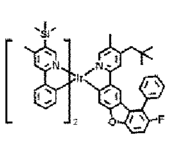
617
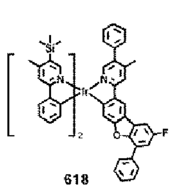
618
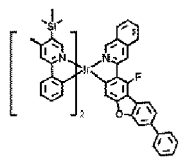
619
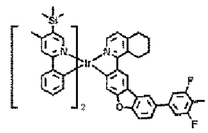
620
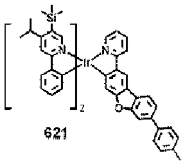
621
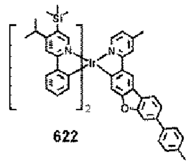
622
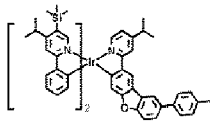
623
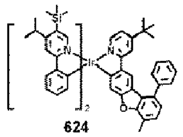
624
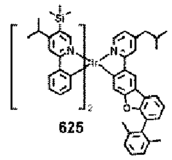
625
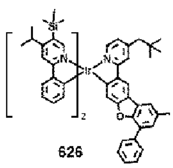
626
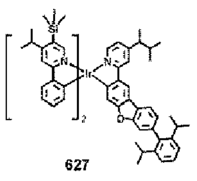
627
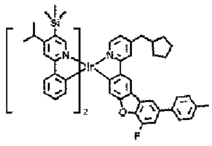
628
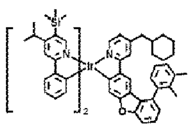
629
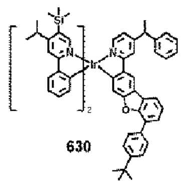
630
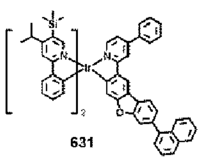
631
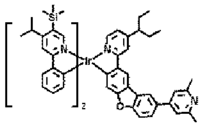
632
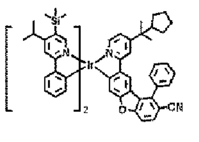
633
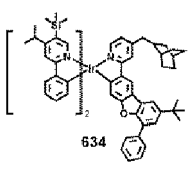
634
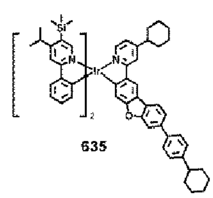
635
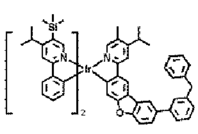
636
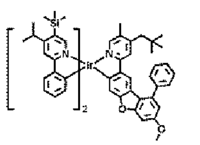
637
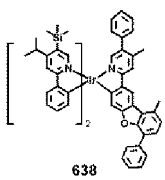
638
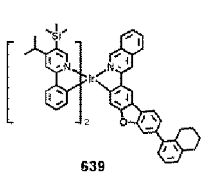
639
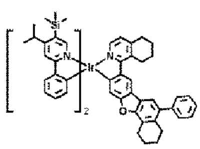
640

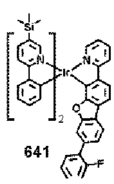
641

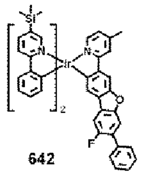
642

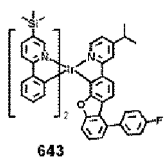
643

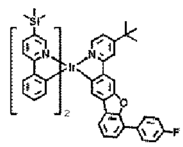
644

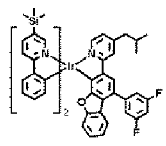
645

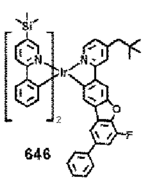
646

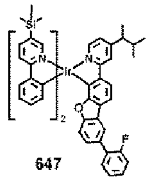
647

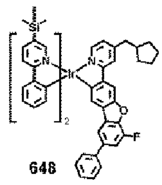
648

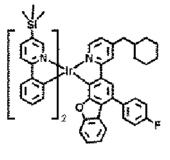
649

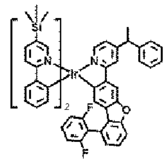
650

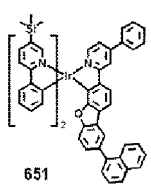
651

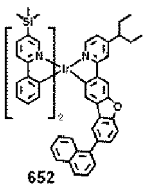
652

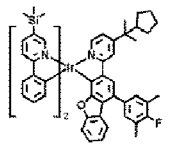
653

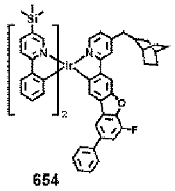
654

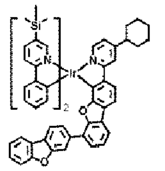
655

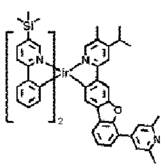
656

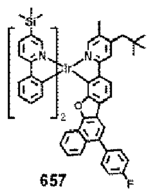
657

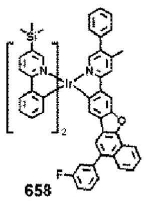
658

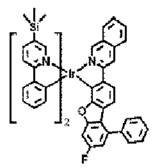
659

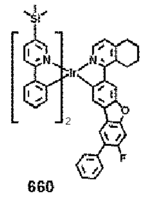
660

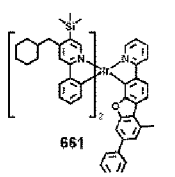
661

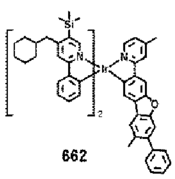
662

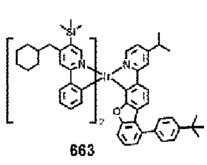
663

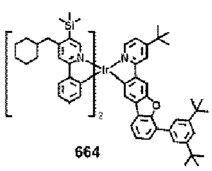
664

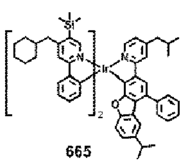
665

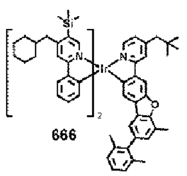
666

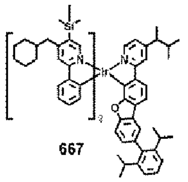
667

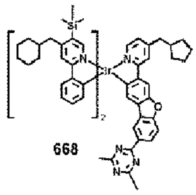
668

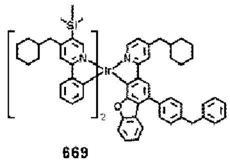
669

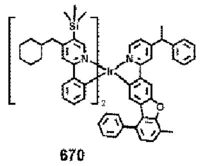
670

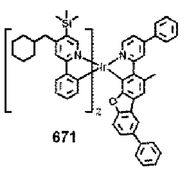
671

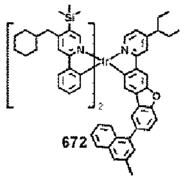
672

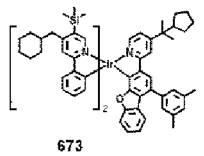
673

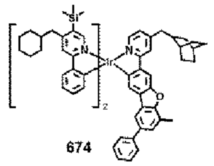
674

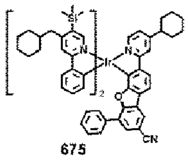
675

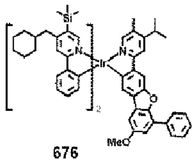
676
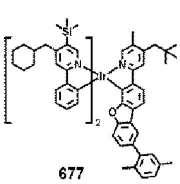
677
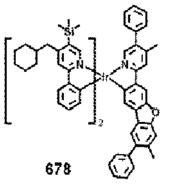
678
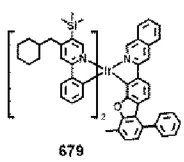
679
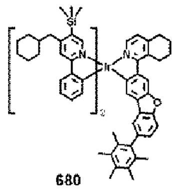
680

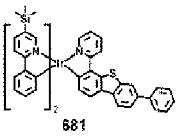
681
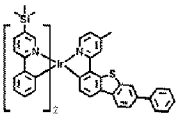
682
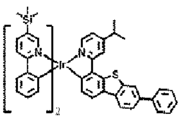
683
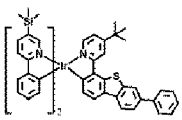
684
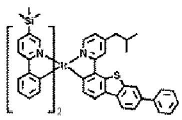
685

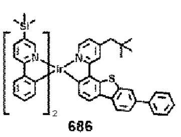
686
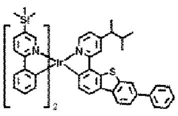
687
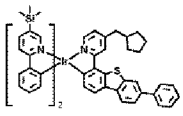
688
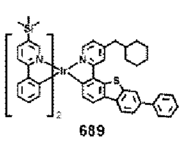
689
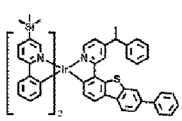
690

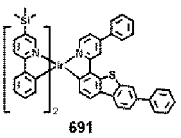
691
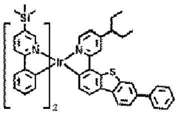
692
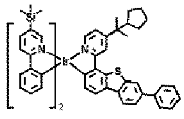
693
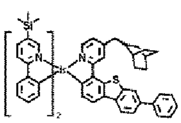
694
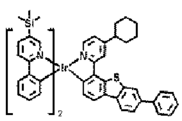
695

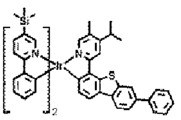
696
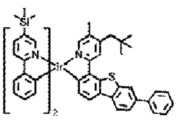
697
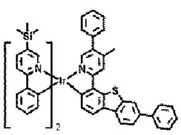
698
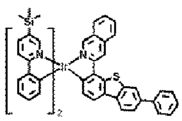
699
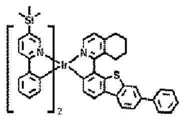
700

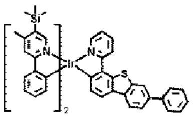
701
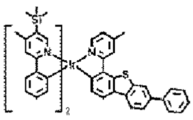
702
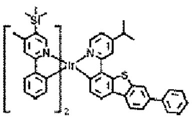
703
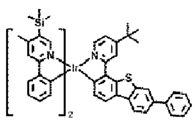
704
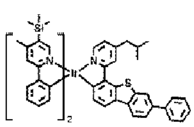
705

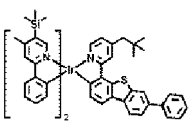
706
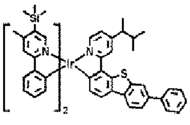
707
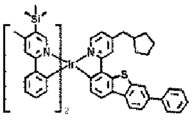
708
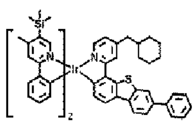
709
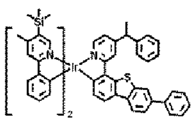
710

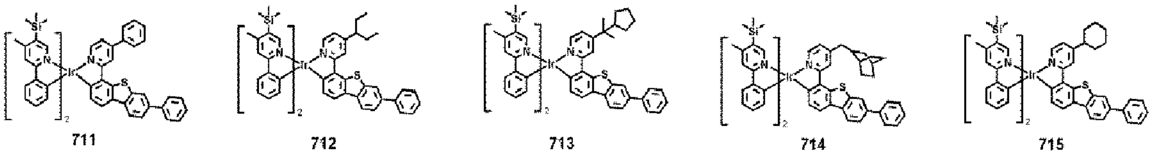
711
712
713
714
715

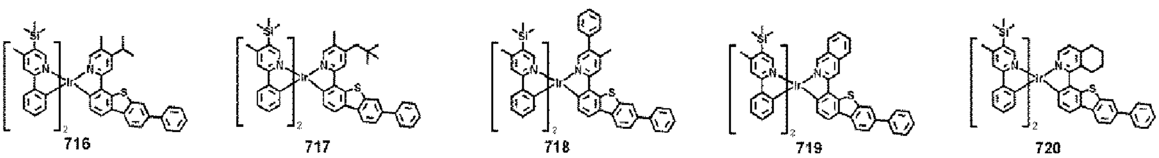
716
717
718
719
720

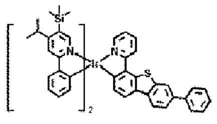
721
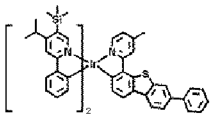
722
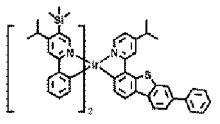
723
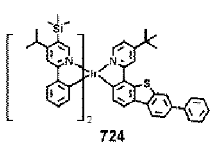
724
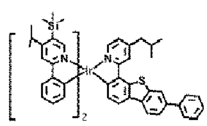
725

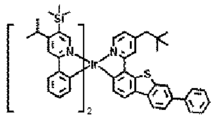
726
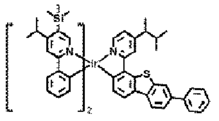
727
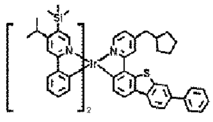
728
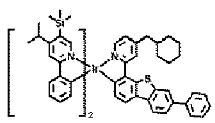
729
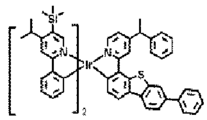
730

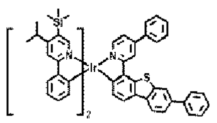
731
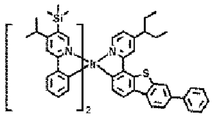
732
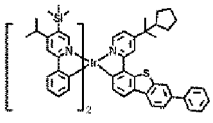
733
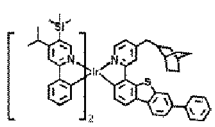
734
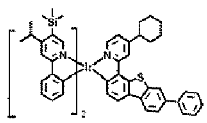
735

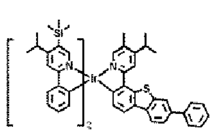
736
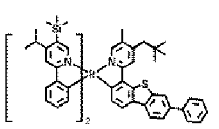
737
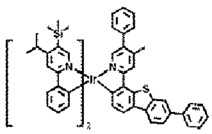
738
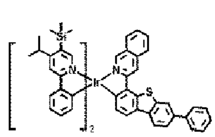
739
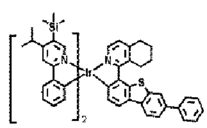
740

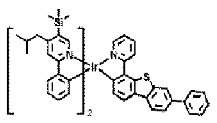
741
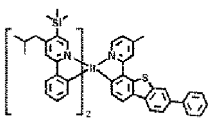
742
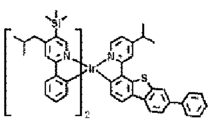
743
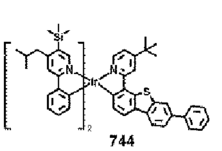
744
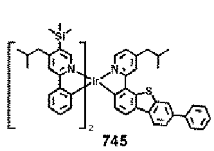
745

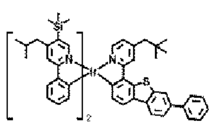
746
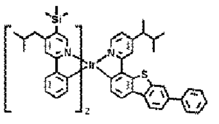
747
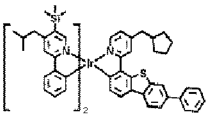
748
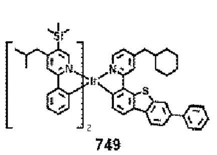
749
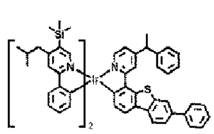
750

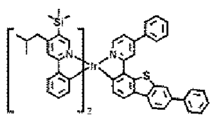
751
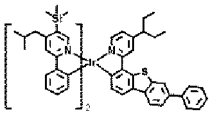
752
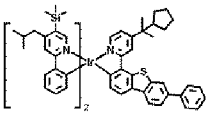
753
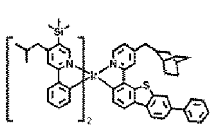
754
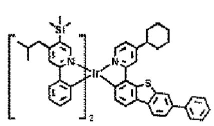
755

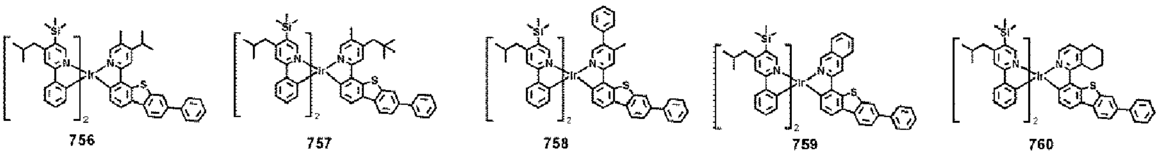
756 757 758 759 760

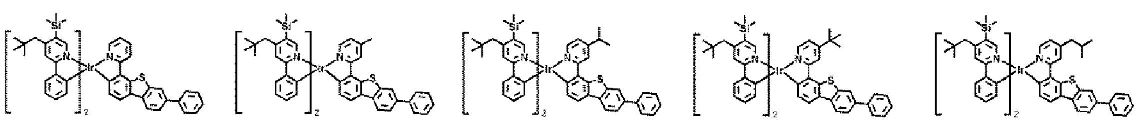
761 762 763 764 765

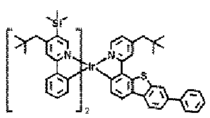
766
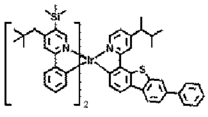
767
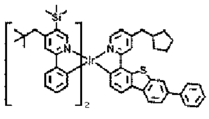
768
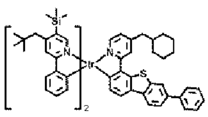
769
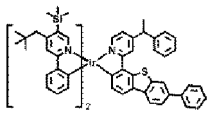
770
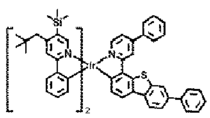
771
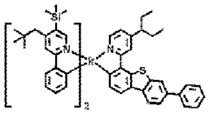
772
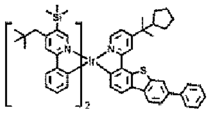
773
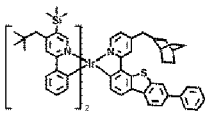
774
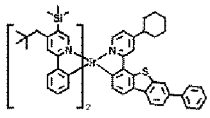
775
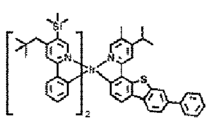
776
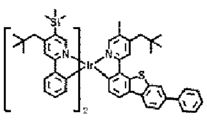
777
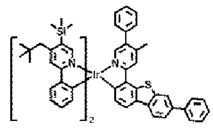
778
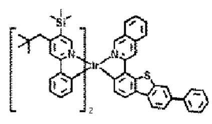
779
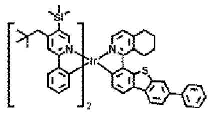
780
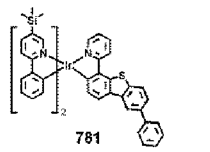
781
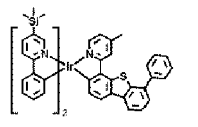
782
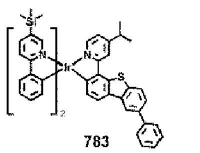
783
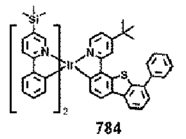
784
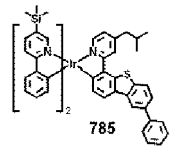
785
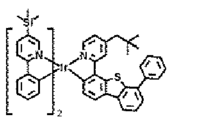
786
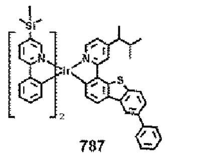
787
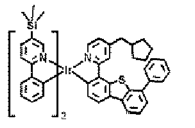
788
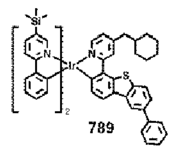
789
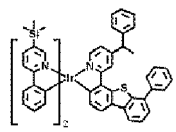
790
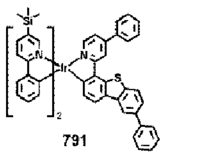
791
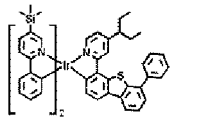
792
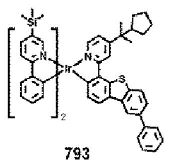
793
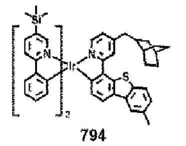
794
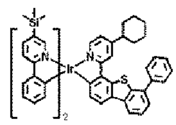
795
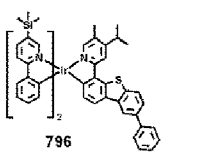
796
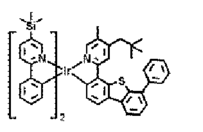
797
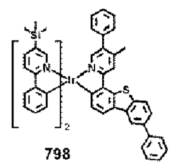
798
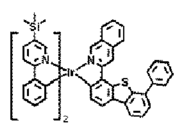
799
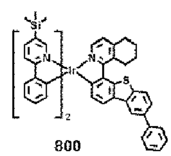
800
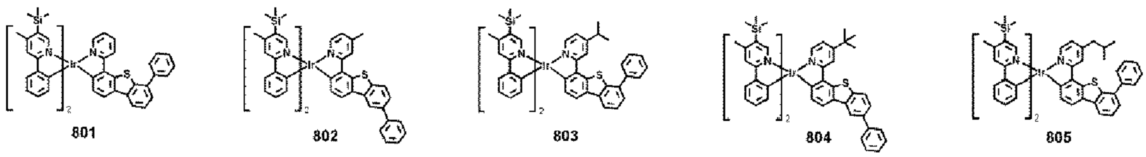
801
802
803
804
805
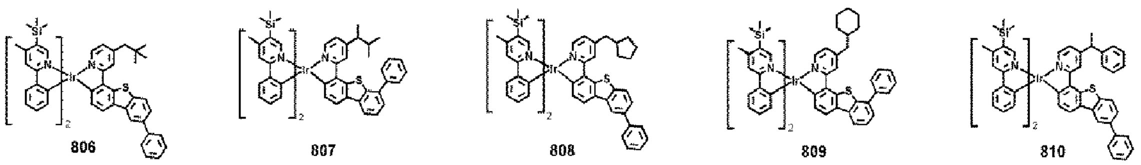
806
807
808
809
810

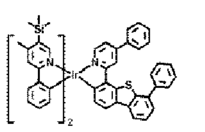
811
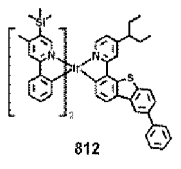
812
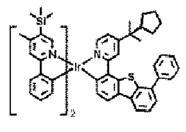
813
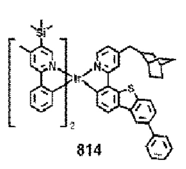
814
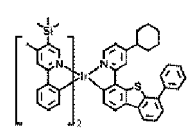
815

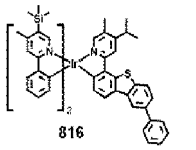
816
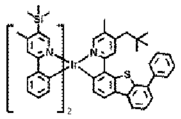
817
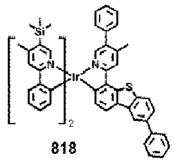
818
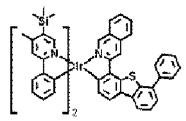
819
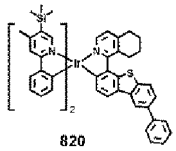
820

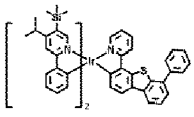
821
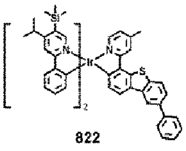
822
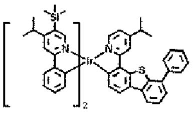
823
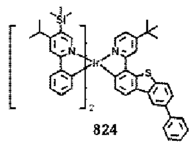
824
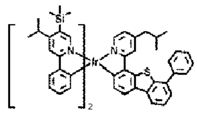
825

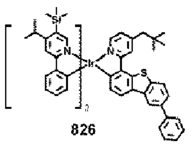
826
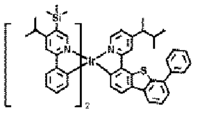
827
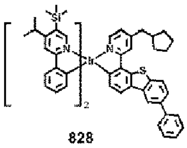
828
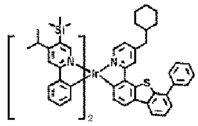
829
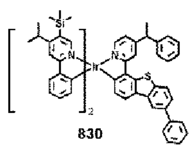
830

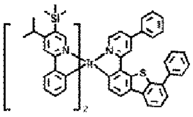
831
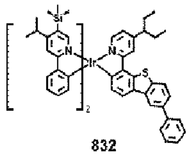
832
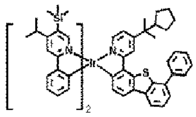
833
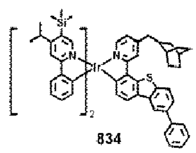
834
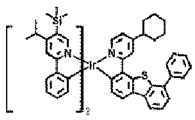
835

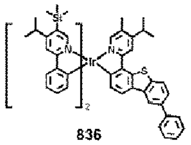
836
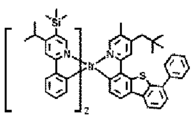
837
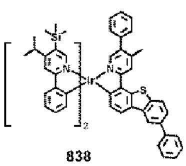
838
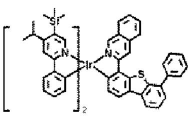
839
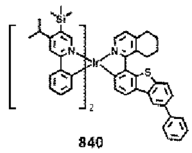
840

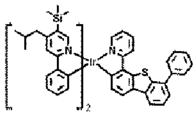
841
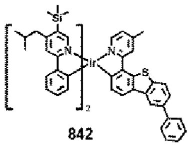
842
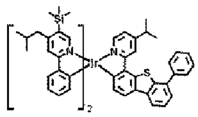
843
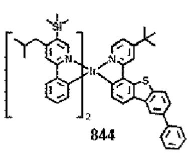
844
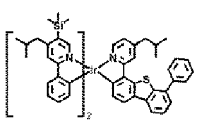
845

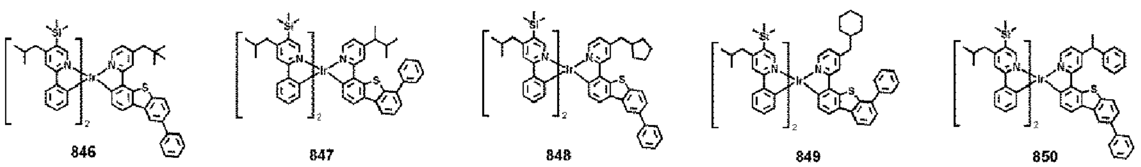
846
847
848
849
850

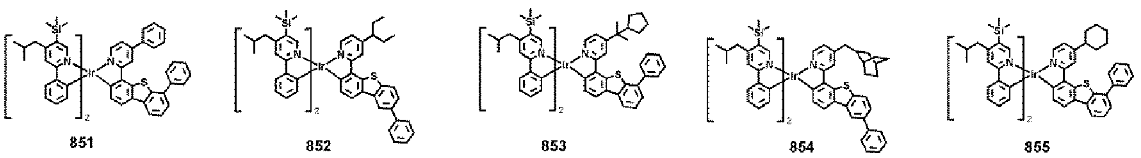
851
852
853
854
855

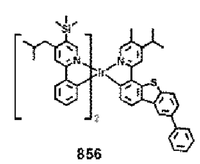
856
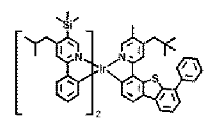
857
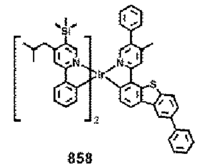
858
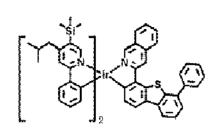
859
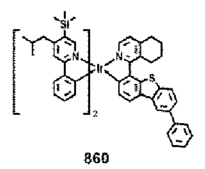
860

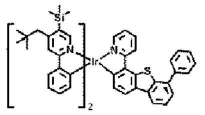
861
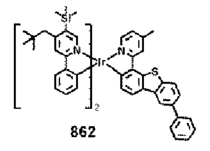
862
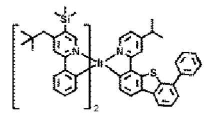
863
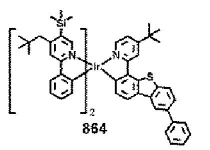
864
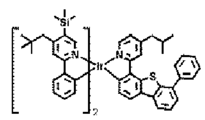
865

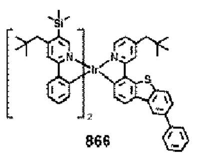
866
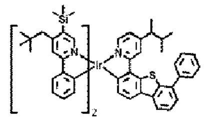
867
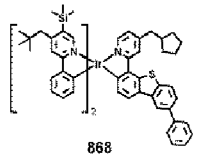
868
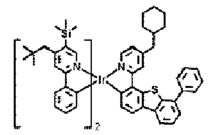
869
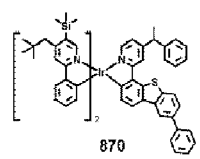
870

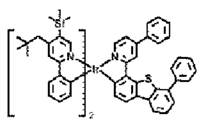
871
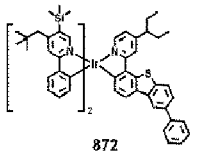
872
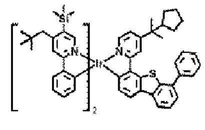
873
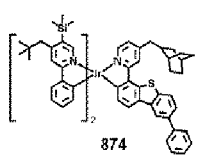
874
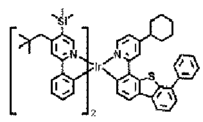
875

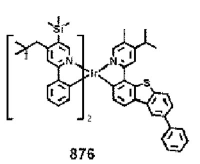
876
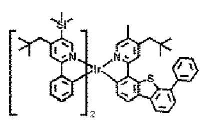
877
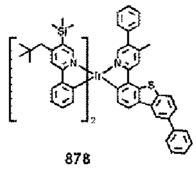
878
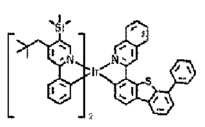
879
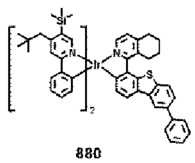
880

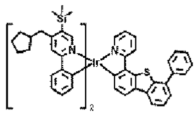
881
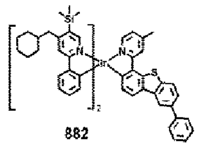
882
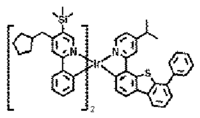
883
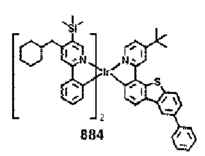
884
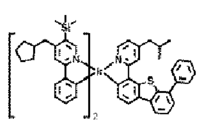
885

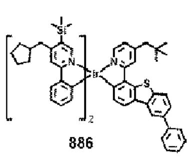
886
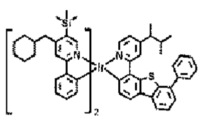
887
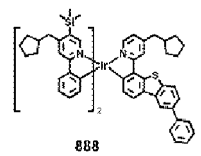
888
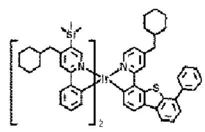
889
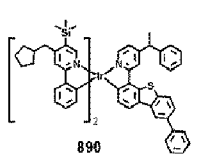
890

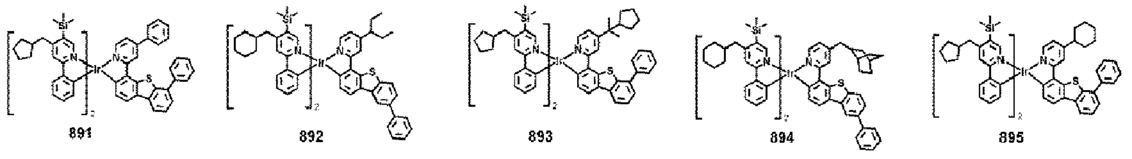
891 892 893 894 895

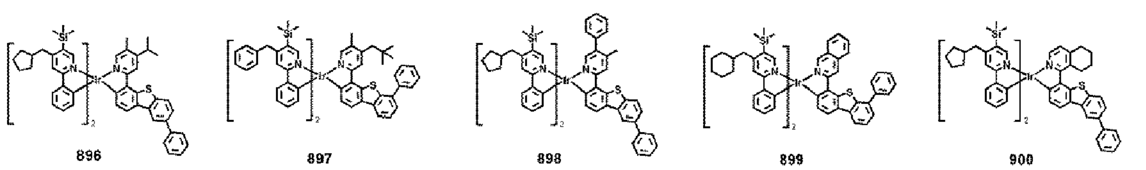
896 897 898 899 900

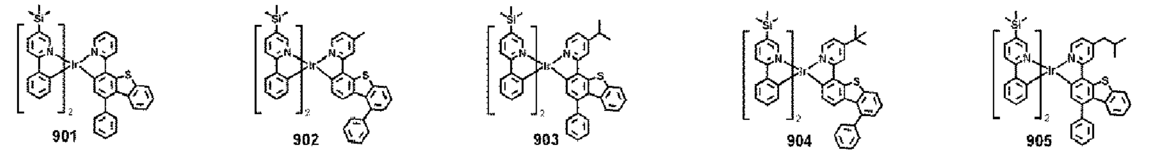
901 902 903 904 905

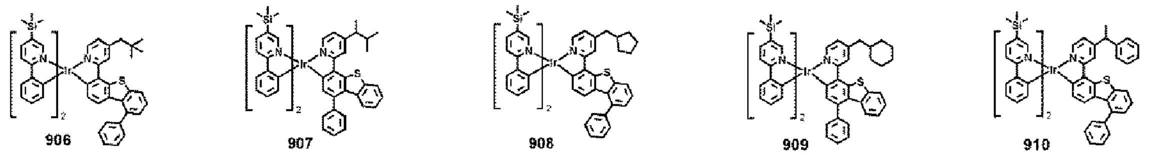
906 907 908 909 910

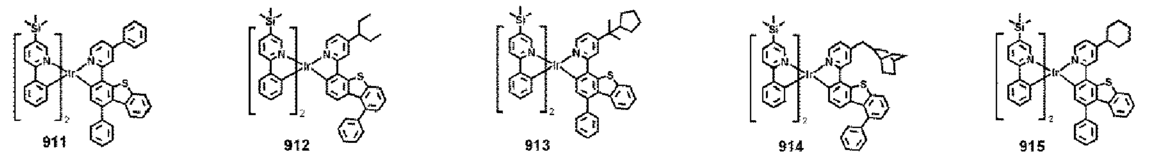
911 912 913 914 915

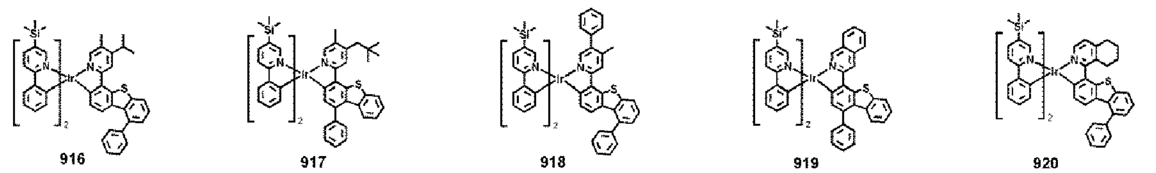
916 917 918 919 920

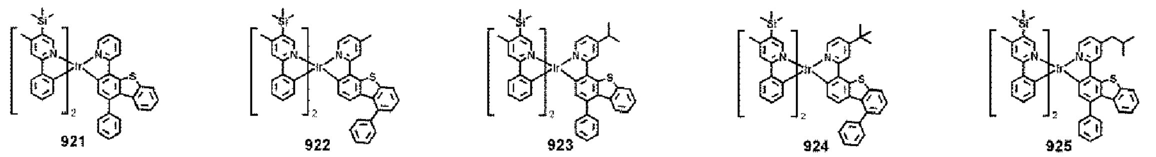
921 922 923 924 925

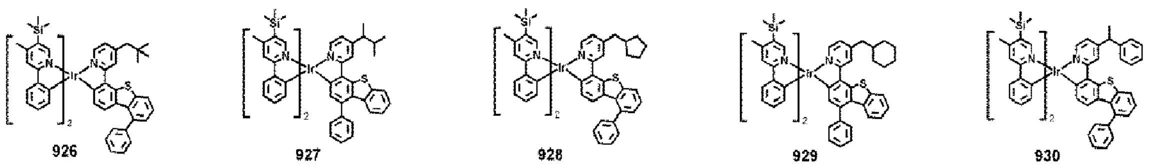
926 927 928 929 930

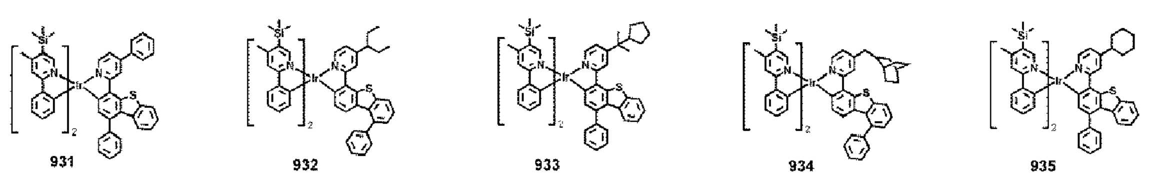
931 932 933 934 935

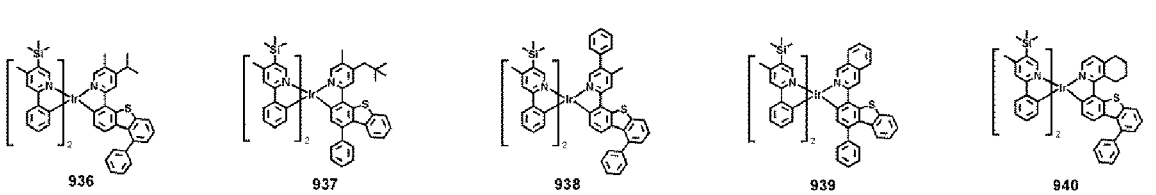
936 937 938 939 940

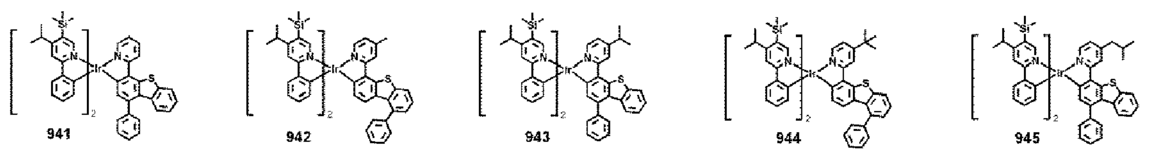
941 942 943 944 945

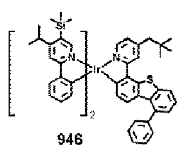
946
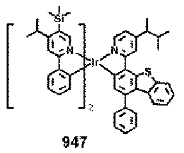
947
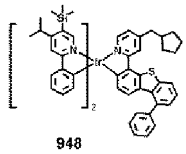
948
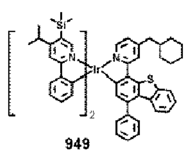
949
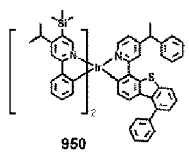
950

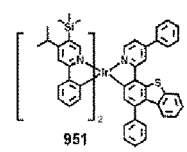
951
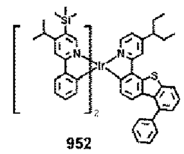
952
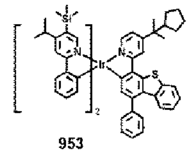
953
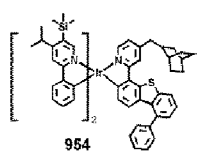
954
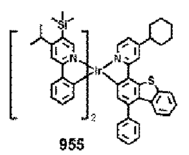
955

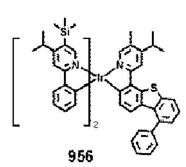
956
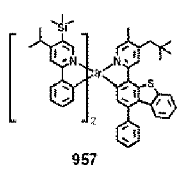
957
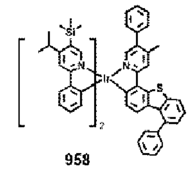
958
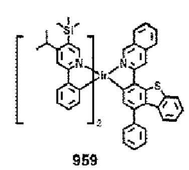
959
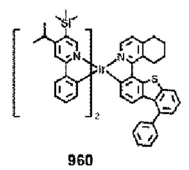
960

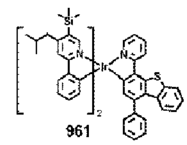
961
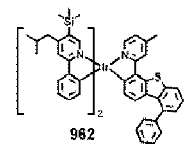
962
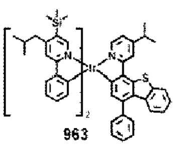
963
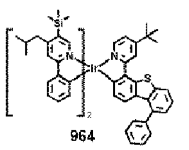
964
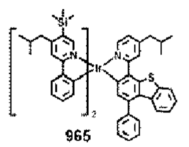
965

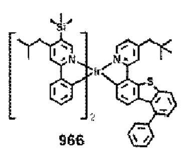
966
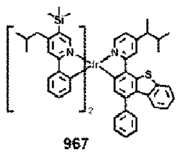
967
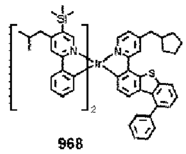
968
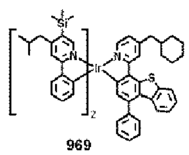
969
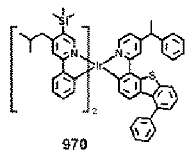
970

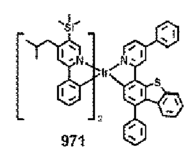
971
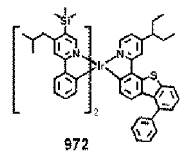
972
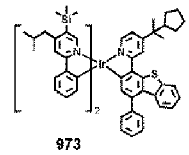
973
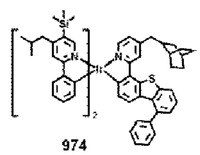
974
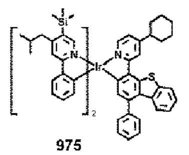
975

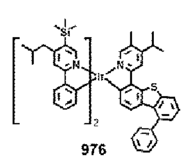
976
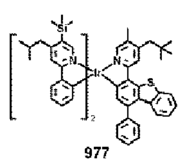
977
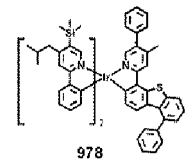
978
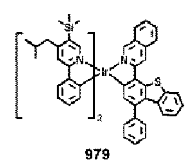
979
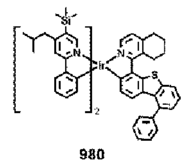
980

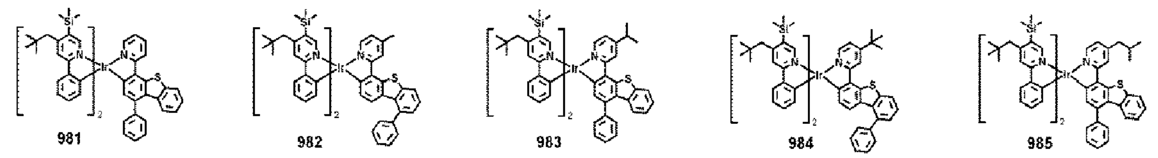
981
982
983
984
985

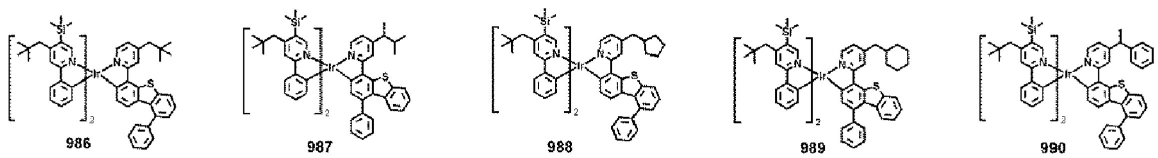
986
987
988
989
990

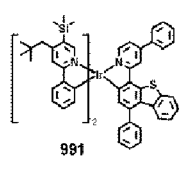
991

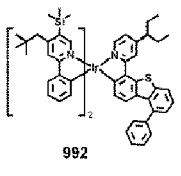
992

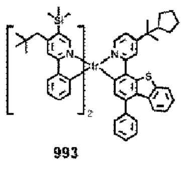
993

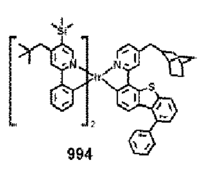
994

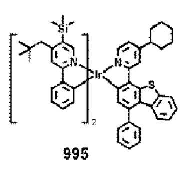
995

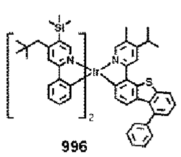
996

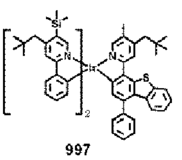
997

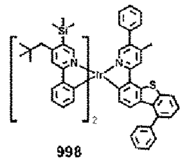
998

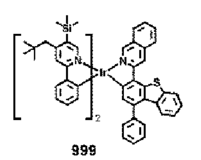
999

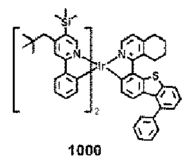
1000

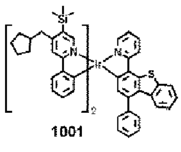
1001

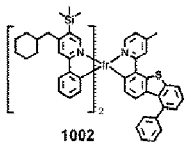
1002

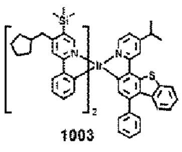
1003

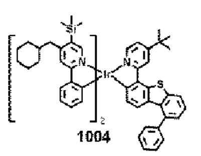
1004

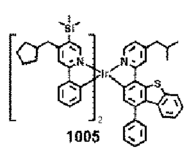
1005

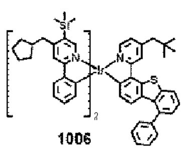
1006

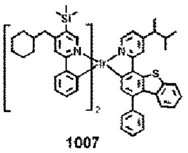
1007

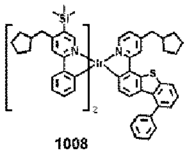
1008

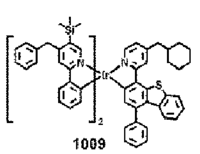
1009

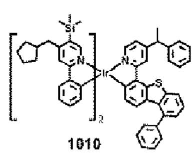
1010

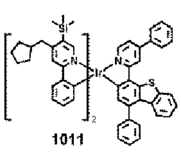
1011

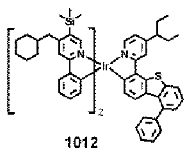
1012

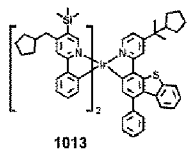
1013

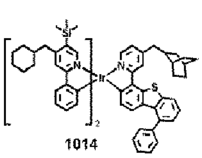
1014

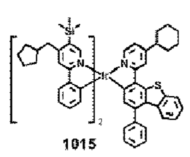
1015

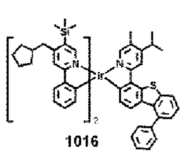
1016

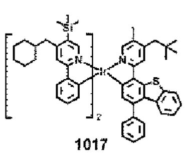
1017

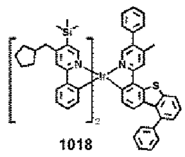
1018

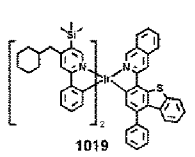
1019

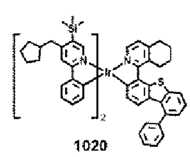
1020

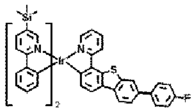
1021

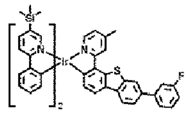
1022

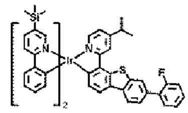
1023

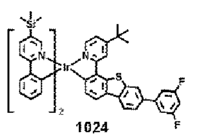
1024

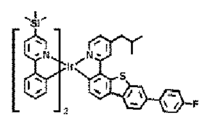
1025

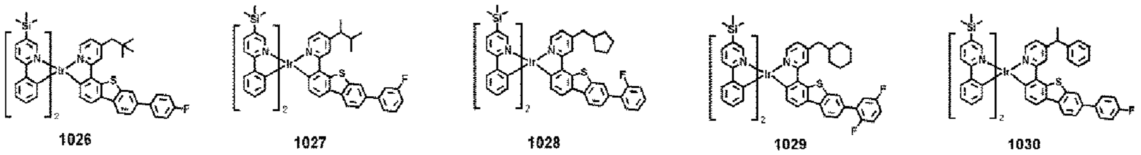
1026 1027 1028 1029 1030

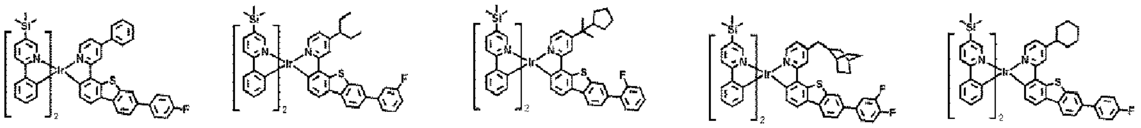
1031 1032 1033 1034 1035

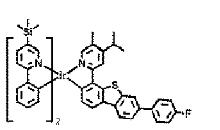
1036
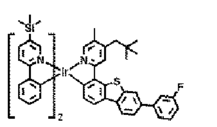
1037
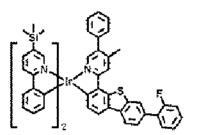
1038
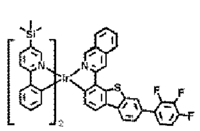
1039
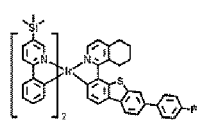
1040

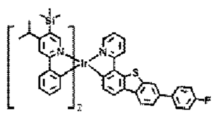
1041
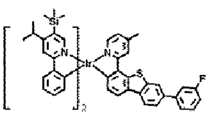
1042
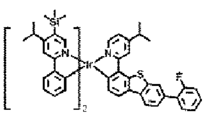
1043
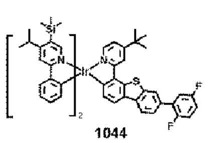
1044
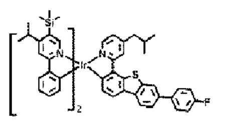
1045

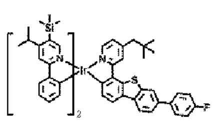
1046
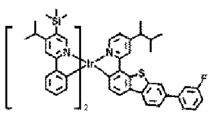
1047
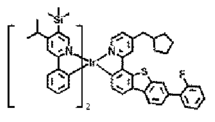
1048
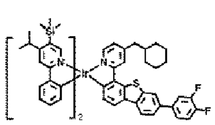
1049
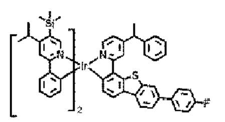
1050

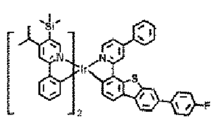
1051
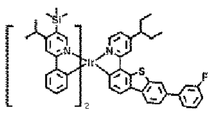
1052
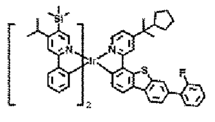
1053
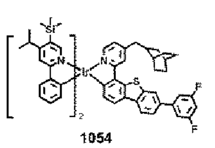
1054
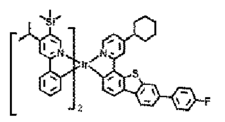
1055

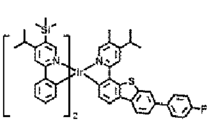
1056
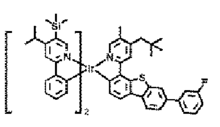
1057
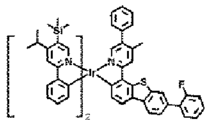
1058
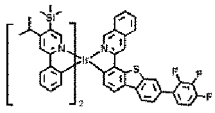
1059
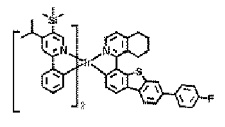
1060

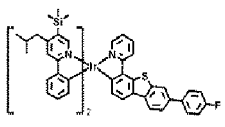
1061
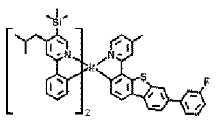
1062
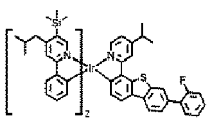
1063
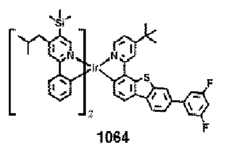
1064
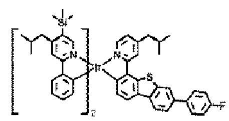
1065

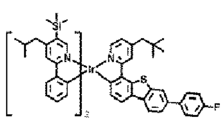
1066
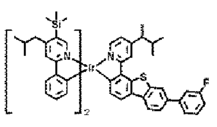
1067
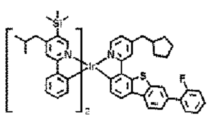
1068
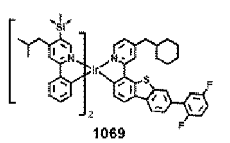
1069
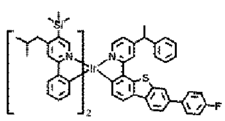
1070

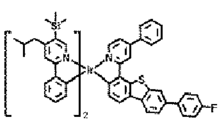
1071
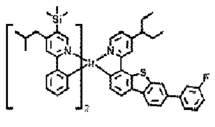
1072
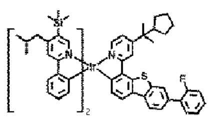
1073
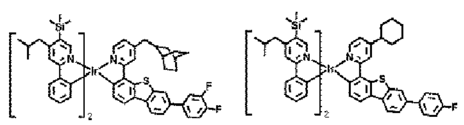
1074
1075

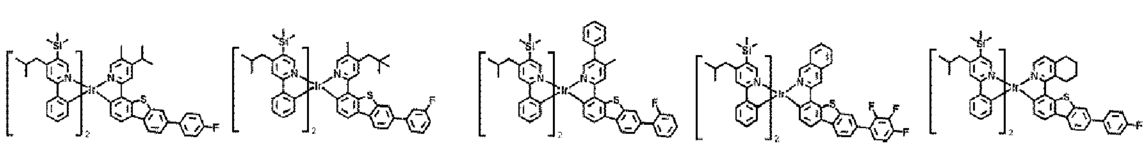
1076
1077
1078
1079
1080

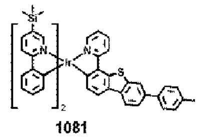
1081

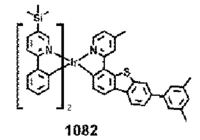
1082

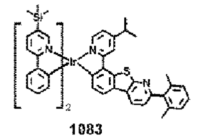
1083

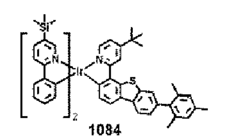
1084

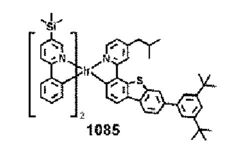
1085

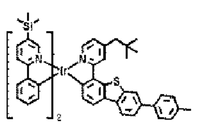
1086

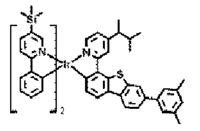
1087

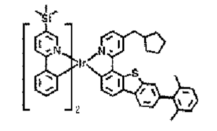
1088

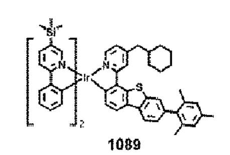
1089

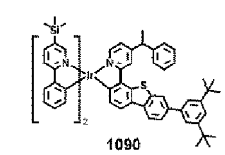
1090

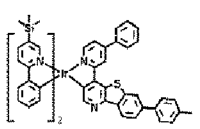
1091

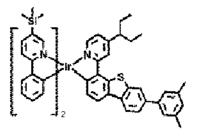
1092

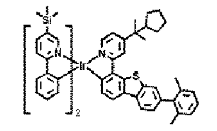
1093

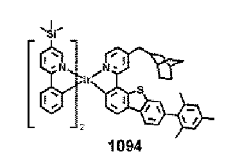
1094

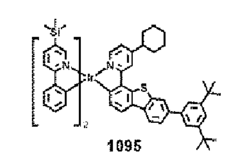
1095

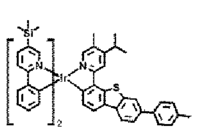
1096

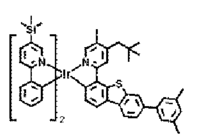
1097

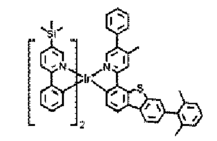
1098

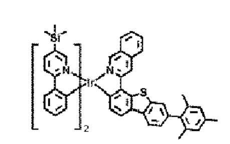
1099

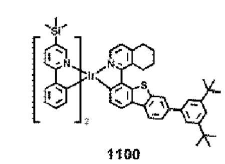
1100

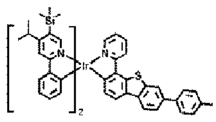
1101

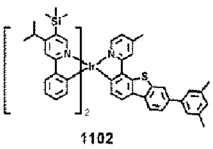
1102

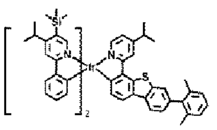
1103

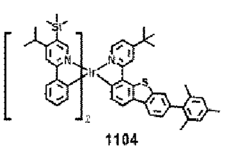
1104

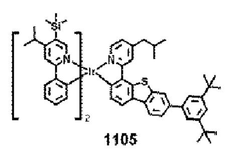
1105

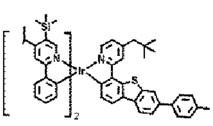
1106

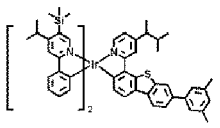
1107

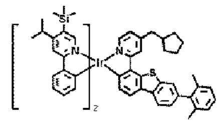
1108

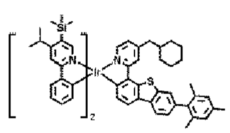
1109

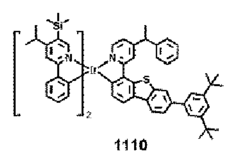
1110

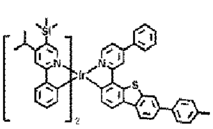
1111

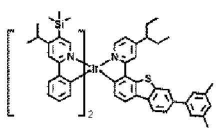
1112

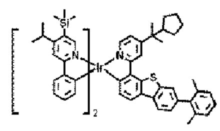
1113

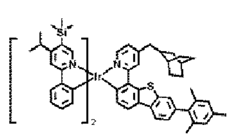
1114

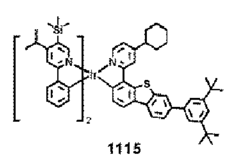
1115

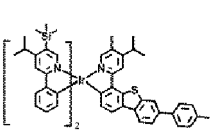
1116

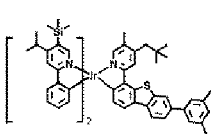
1117

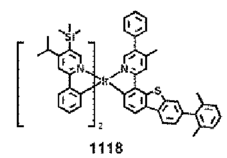
1118

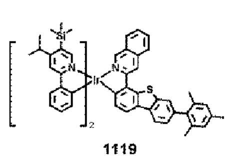
1119

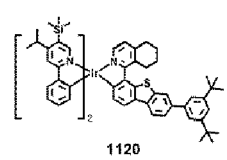
1120

1121

1122

1123

1124

1125

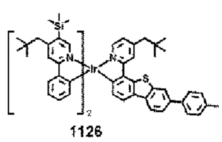
1126
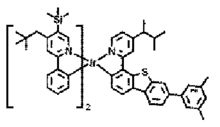
1127
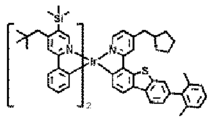
1128
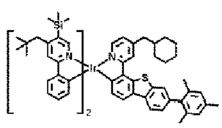
1129
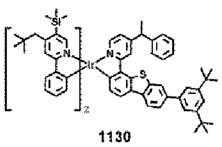
1130

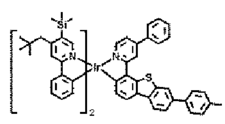
1131
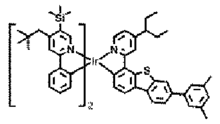
1132
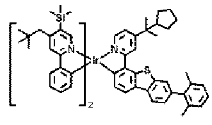
1133
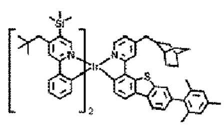
1134
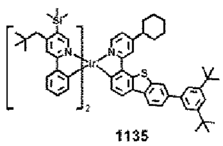
1135

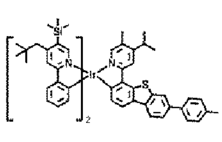
1136
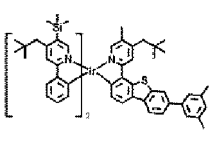
1137
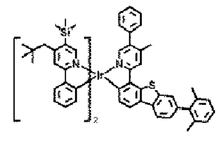
1138
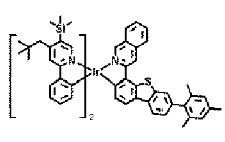
1139
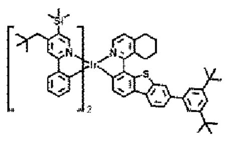
1140

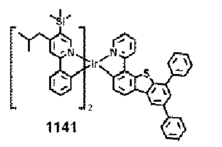
1141
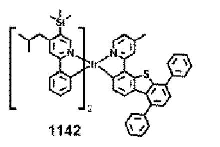
1142
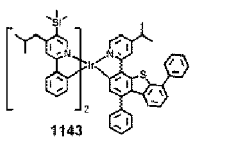
1143
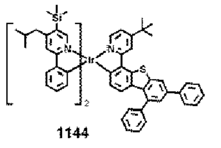
1144
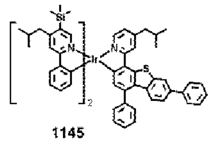
1145

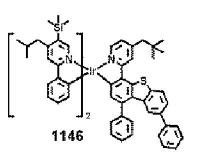
1146
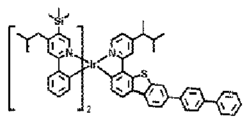
1147
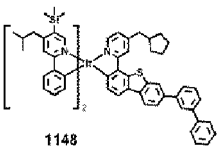
1148
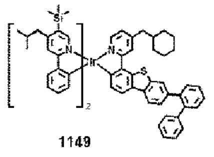
1149
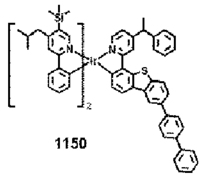
1150

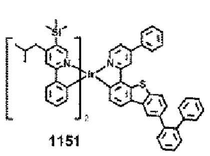
1151
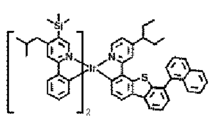
1152
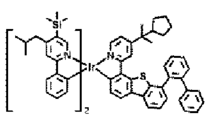
1153
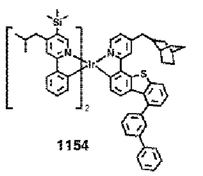
1154
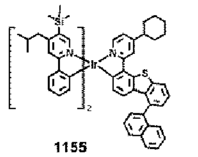
1155

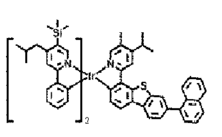
1156
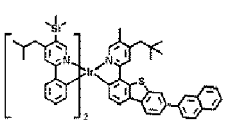
1157
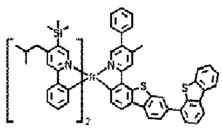
1158
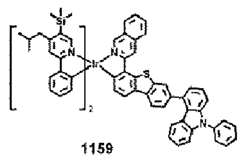
1159
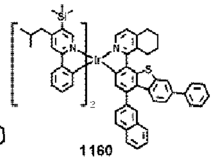
1160

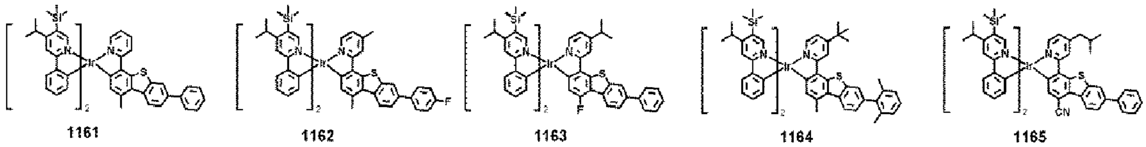
1161
1162
1163
1164
1165

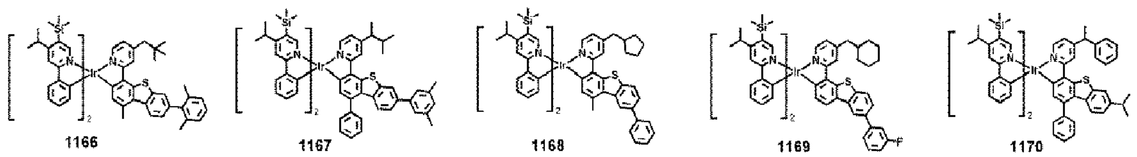
1166
1167
1168
1169
1170

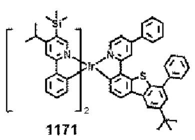
1171
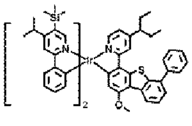
1172
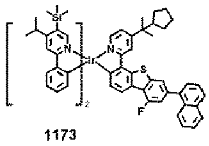
1173
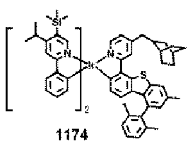
1174
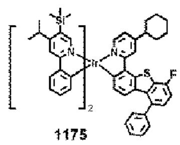
1175

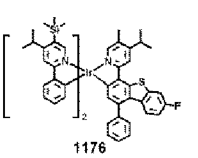
1176
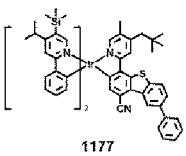
1177
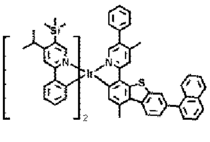
1178
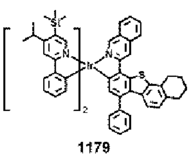
1179
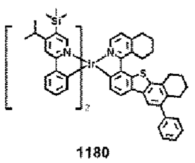
1180

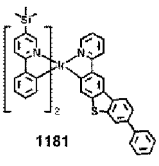
1181
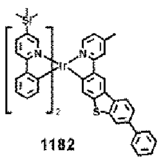
1182
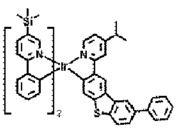
1183
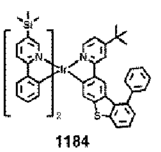
1184
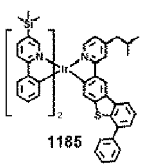
1185

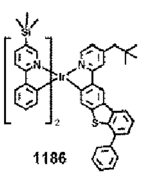
1186
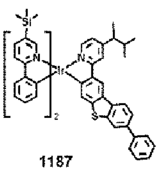
1187
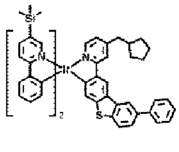
1188
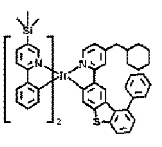
1189
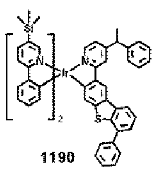
1190

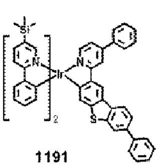
1191
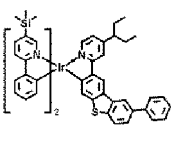
1192
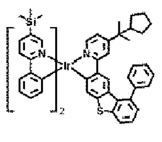
1193
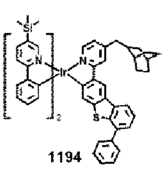
1194
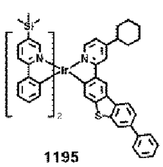
1195

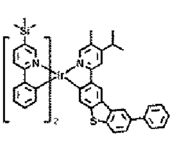
1196
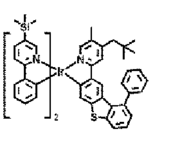
1197
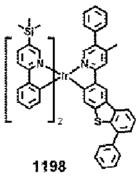
1198
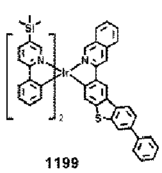
1199
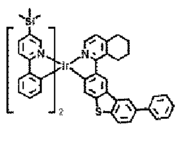
1200

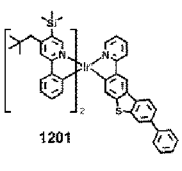
1201
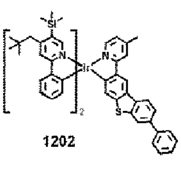
1202
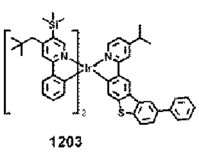
1203
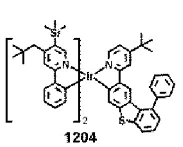
1204
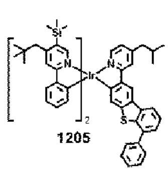
1205

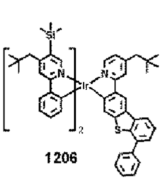
1206
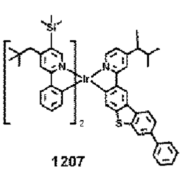
1207
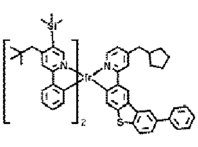
1208
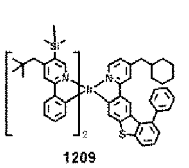
1209
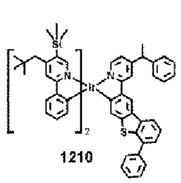
1210

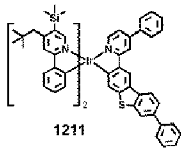
1211

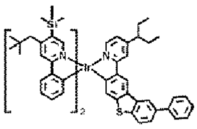
1212

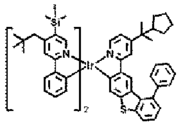
1213

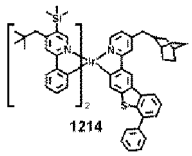
1214

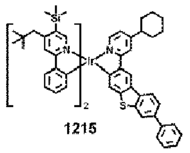
1215

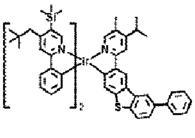
1216

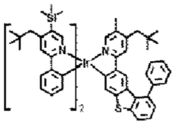
1217

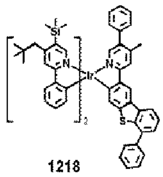
1218

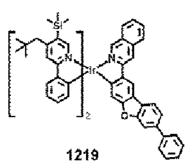
1219

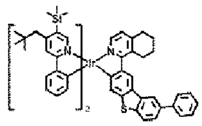
1220

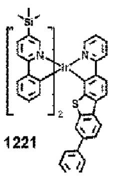
1221

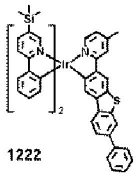
1222

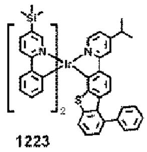
1223

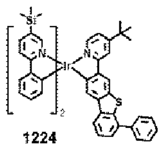
1224

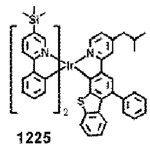
1225

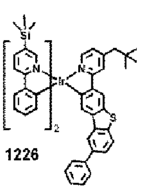
1226

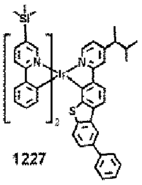
1227

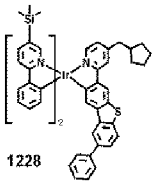
1228

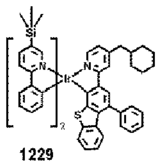
1229

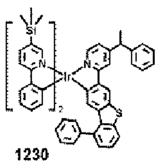
1230

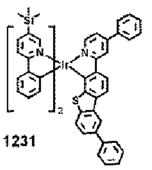
1231

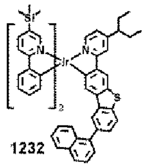
1232

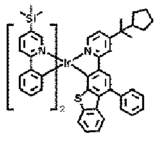
1233

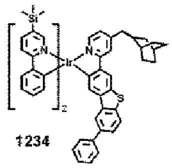
1234

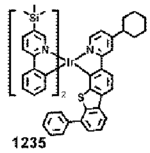
1235

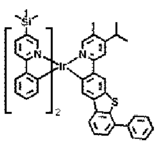
1236

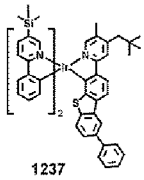
1237

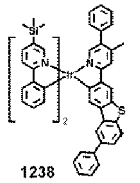
1238

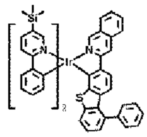
1239

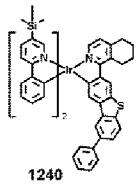
1240

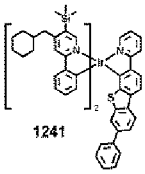
1241

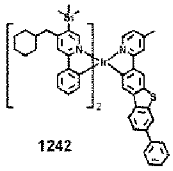
1242

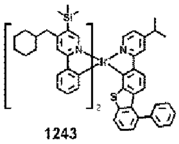
1243

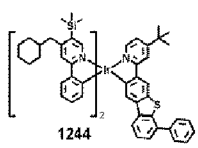
1244

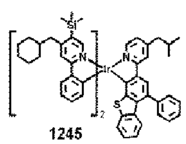
1245

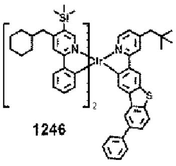
1246

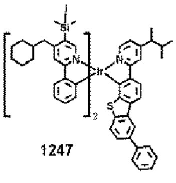
1247

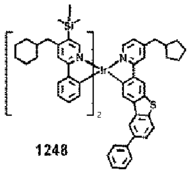
1248

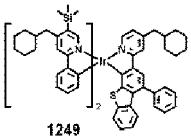
1249

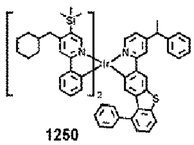
1250

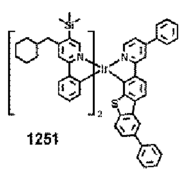
1251
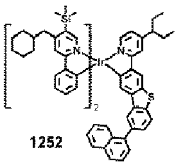
1252
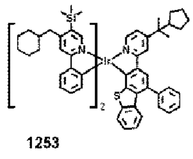
1253
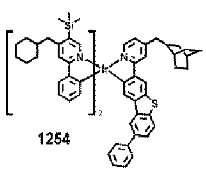
1254
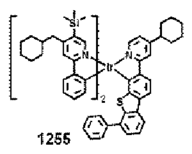
1255

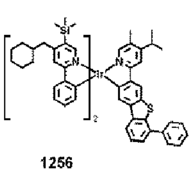
1256
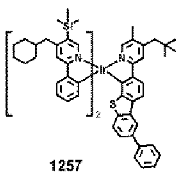
1257
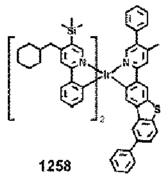
1258
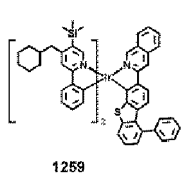
1259
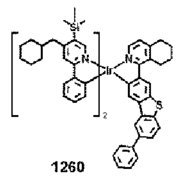
1260

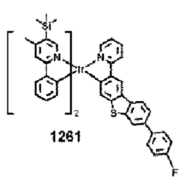
1261
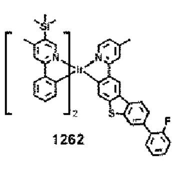
1262
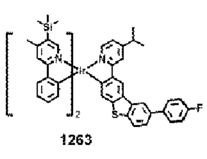
1263
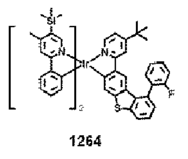
1264
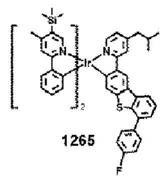
1265

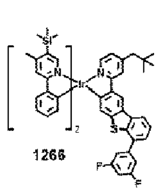
1266
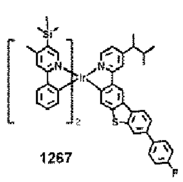
1267
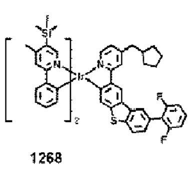
1268
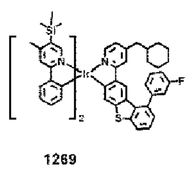
1269
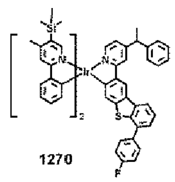
1270

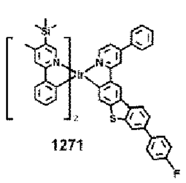
1271
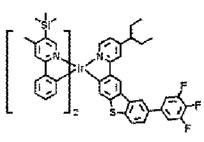
1272
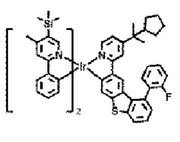
1273
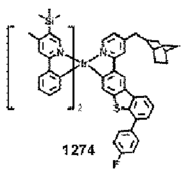
1274
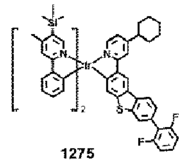
1275

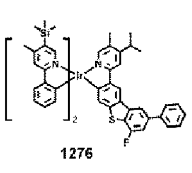
1276
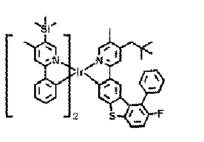
1277
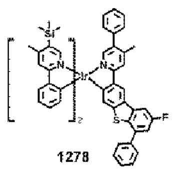
1278
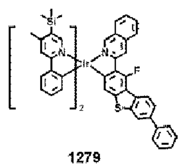
1279
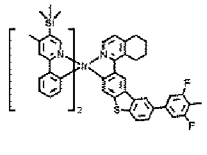
1280

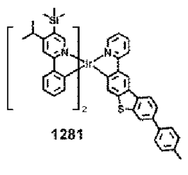
1281
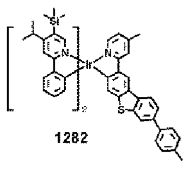
1282
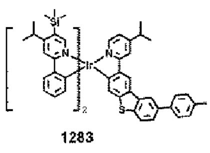
1283
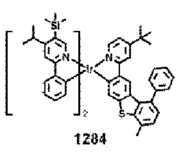
1284
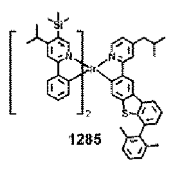
1285

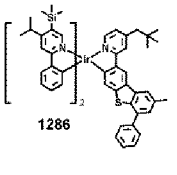
1286
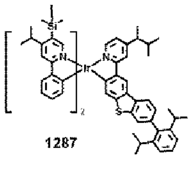
1287
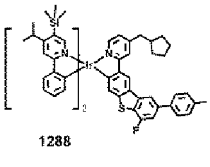
1288
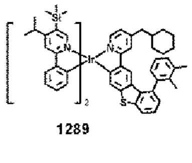
1289
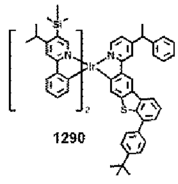
1290

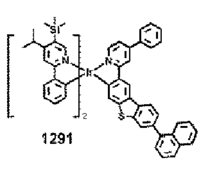
1291

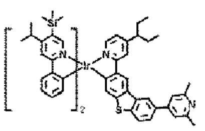
1292

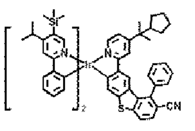
1293

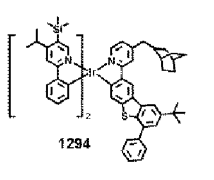
1294

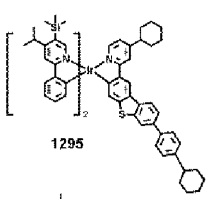
1295

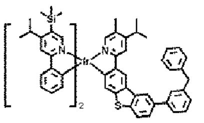
1296

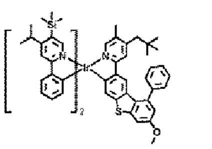
1297

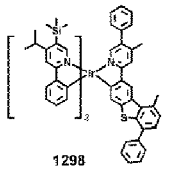
1298

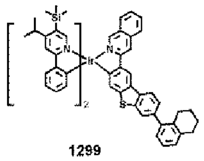
1299

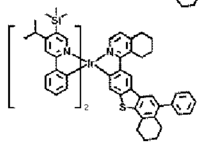
1300

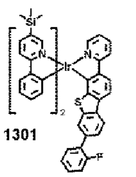
1301

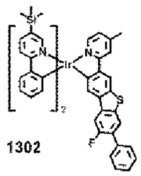
1302

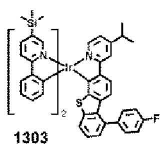
1303

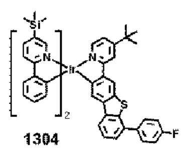
1304

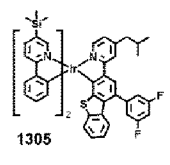
1305

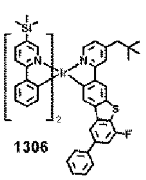
1306

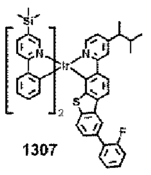
1307

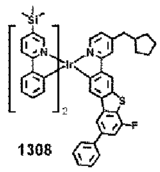
1308

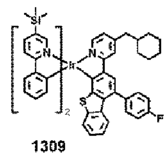
1309

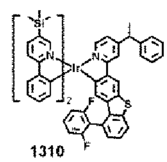
1310

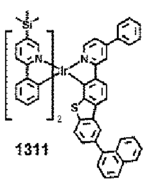
1311

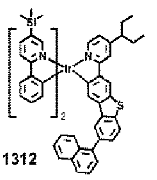
1312

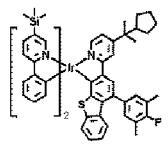
1313

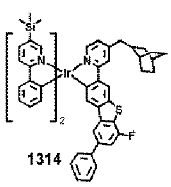
1314

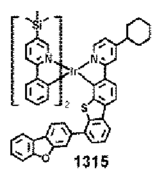
1315

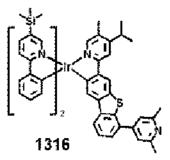
1316

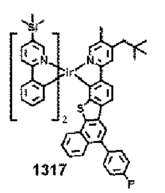
1317

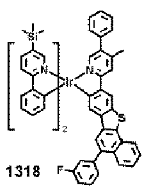
1318

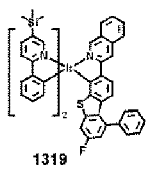
1319

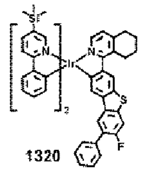
1320

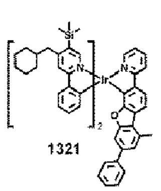
1321

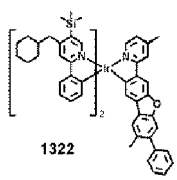
1322

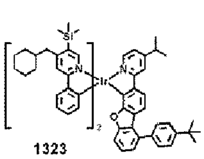
1323

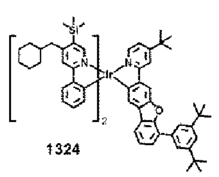
1324

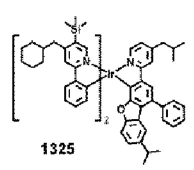
1325

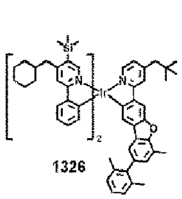
1326

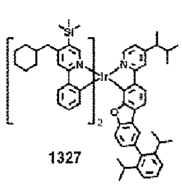
1327

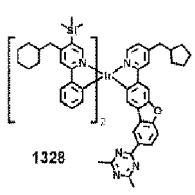
1328

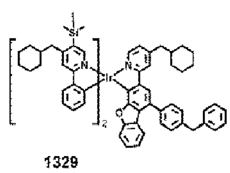
1329

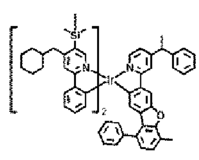
1330

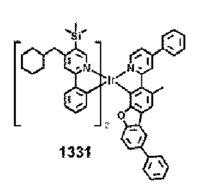
1331
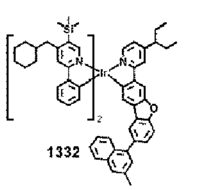
1332
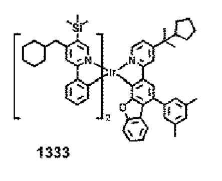
1333
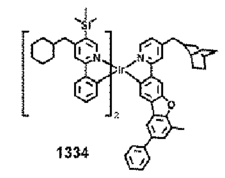
1334
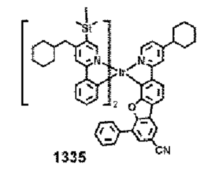
1335

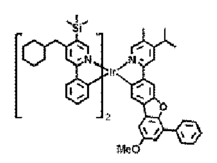
1336
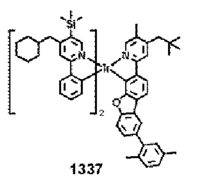
1337
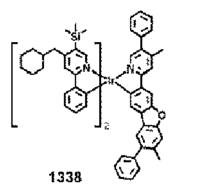
1338
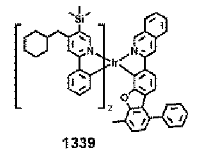
1339
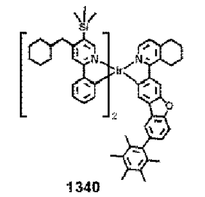
1340

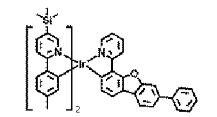
1341
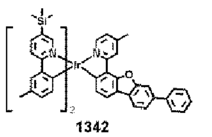
1342
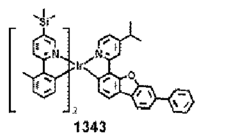
1343
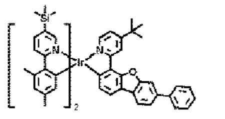
1344
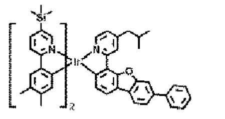
1345

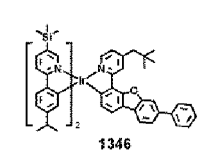
1346
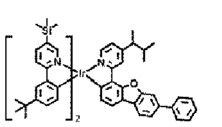
1347
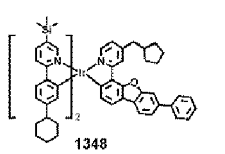
1348
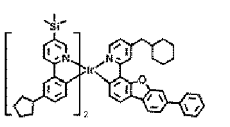
1349
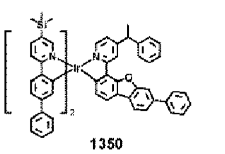
1350

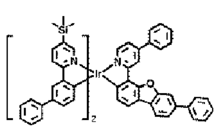
1351
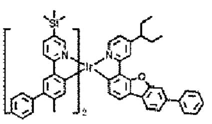
1352
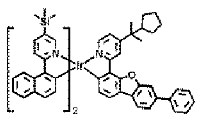
1353
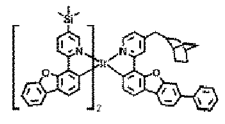
1354
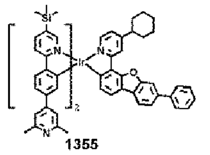
1355

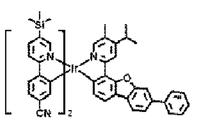
1356
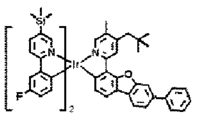
1357
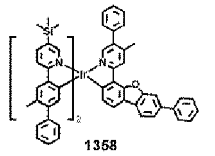
1358
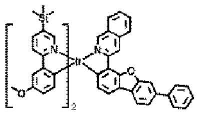
1359
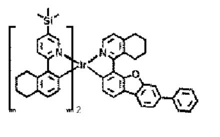
1360

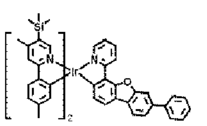
1361
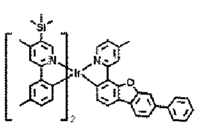
1362
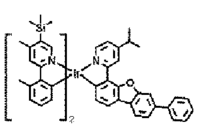
1363
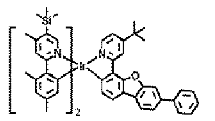
1364
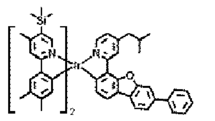
1365

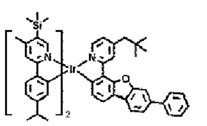
1366
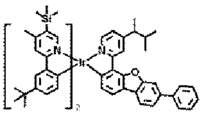
1367
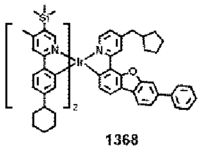
1368
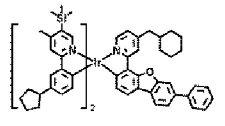
1369
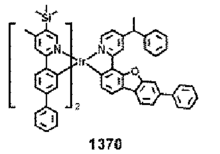
1370

1371
1372
1373
1374
1375

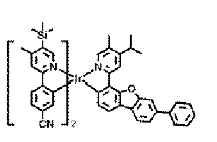
1376
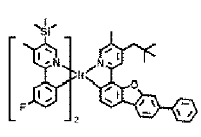
1377
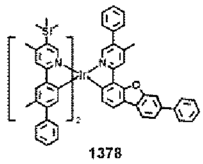
1378
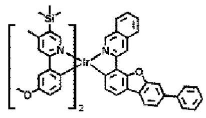
1379
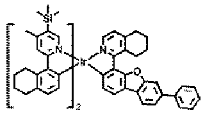
1380

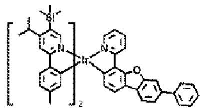
1381
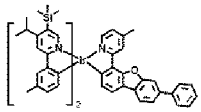
1382
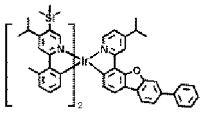
1383
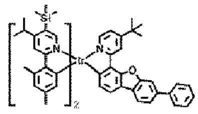
1384
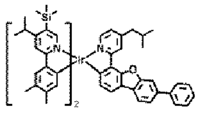
1385

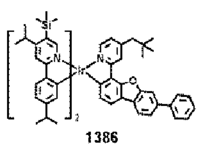
1386
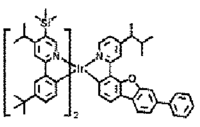
1387
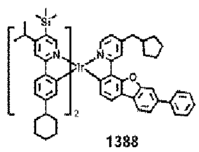
1388
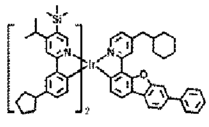
1389
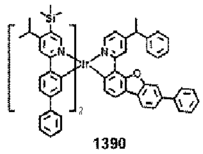
1390

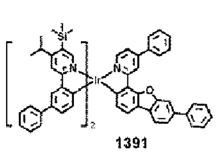
1391
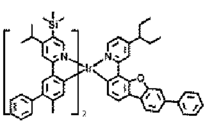
1392
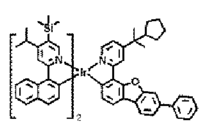
1393
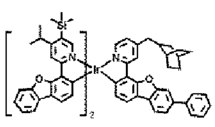
1394
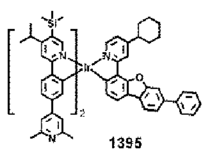
1395

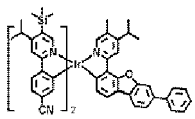
1396
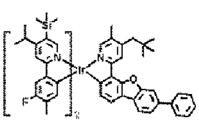
1397
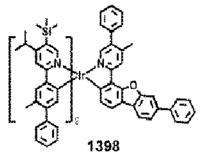
1398
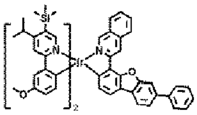
1399
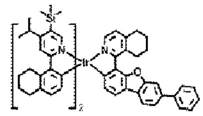
1400

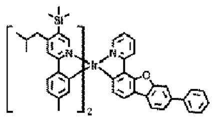
1401
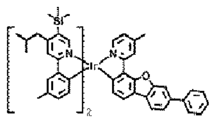
1402
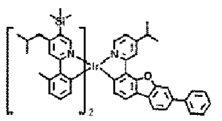
1403
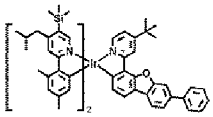
1404
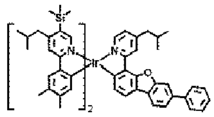
1405

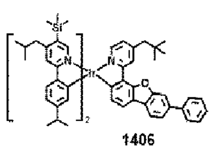
1406
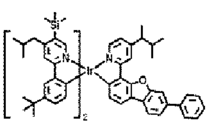
1407
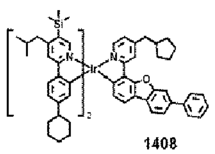
1408
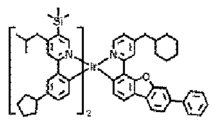
1409
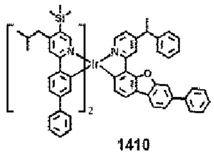
1410

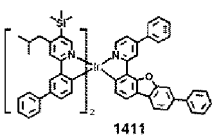
1411
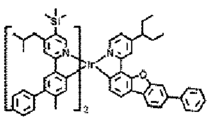
1412
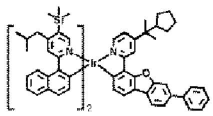
1413
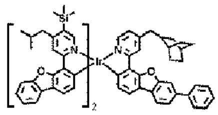
1414
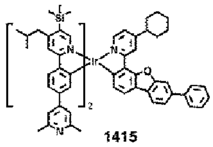
1415

1416
1417
1418
1419
1420

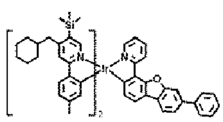
1421
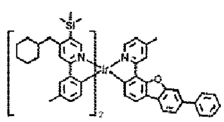
1422
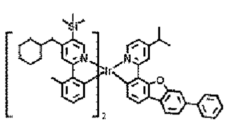
1423
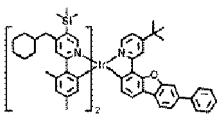
1424
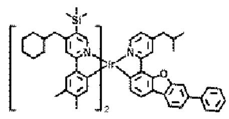
1425

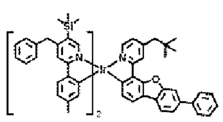
1426
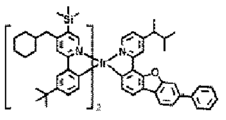
1427
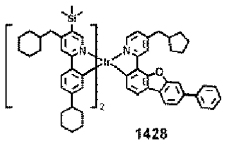
1428
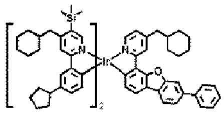
1429
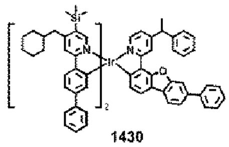
1430

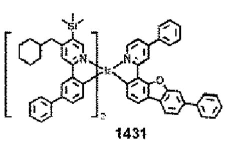
1431
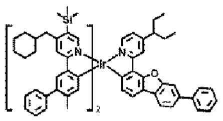
1432
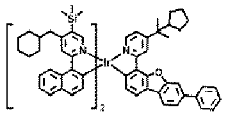
1433
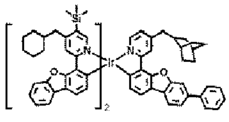
1434
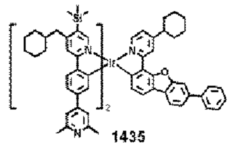
1435

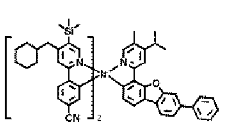
1436
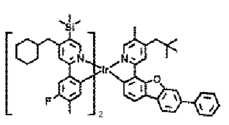
1437
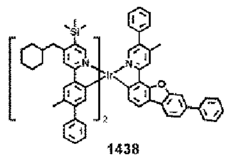
1438
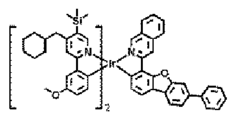
1439
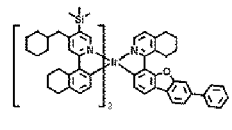
1440

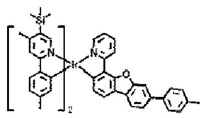
1441
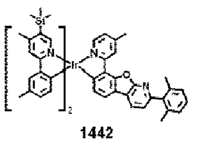
1442
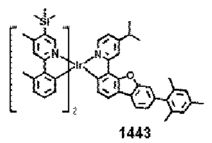
1443
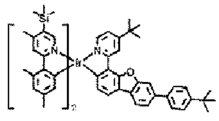
1444
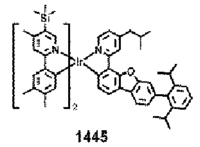
1445

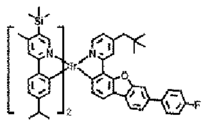
1446
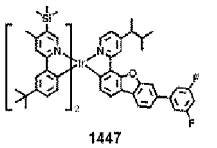
1447
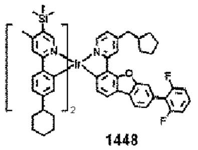
1448
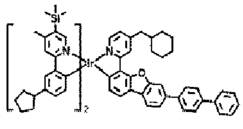
1449
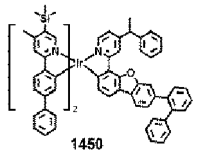
1450

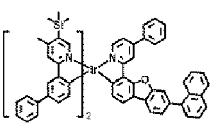
1451
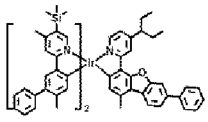
1452
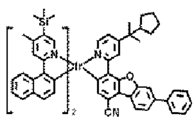
1453
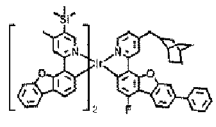
1454
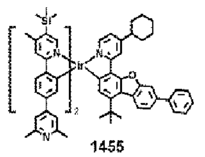
1455

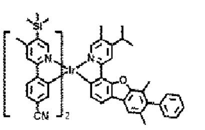
1456
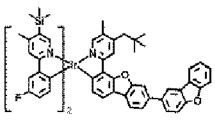
1457
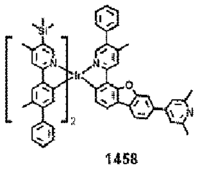
1458
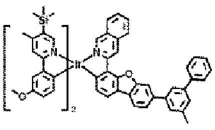
1459
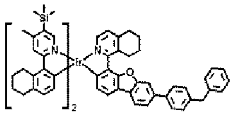
1460

1461
1462
1463
1464
1465

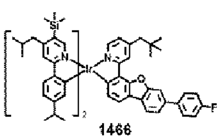
1466

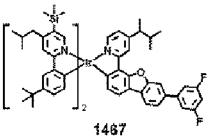
1467

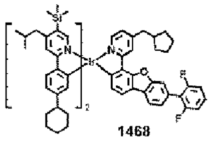
1468

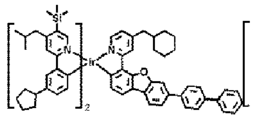
1469

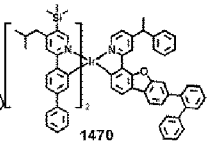
1470

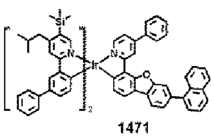
1471

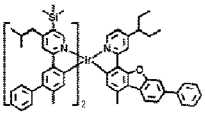
1472

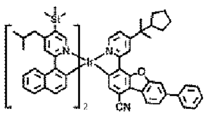
1473

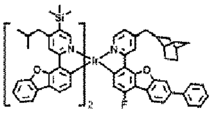
1474

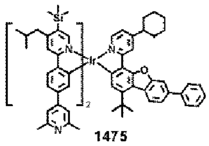
1475

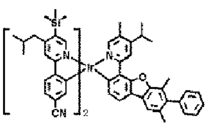
1476

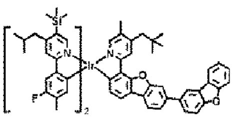
1477

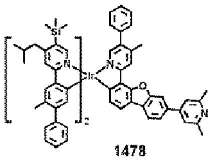
1478

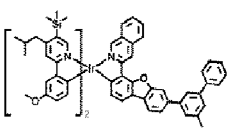
1479

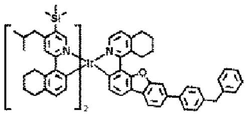
1480

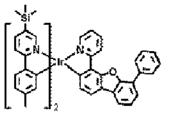
1481

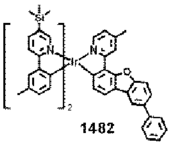
1482

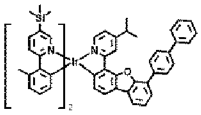
1483

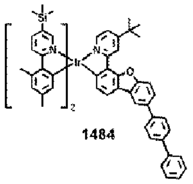
1484

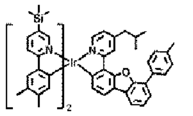
1485

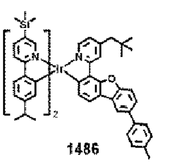
1486

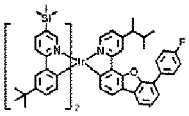
1487

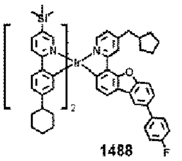
1488

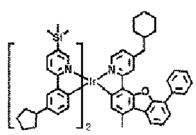
1489

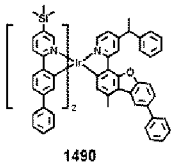
1490

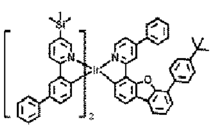
1491

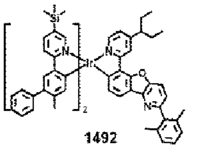
1492

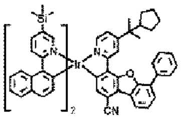
1493

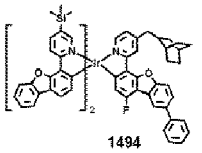
1494

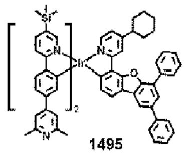
1495

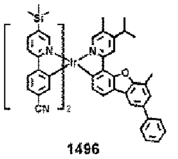
1496

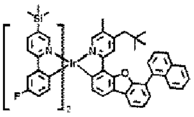
1497

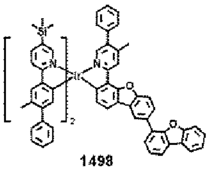
1498

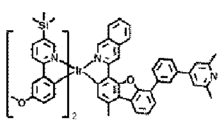
1499

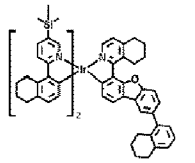
1500

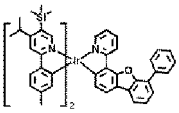
1501

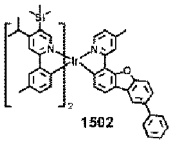
1502

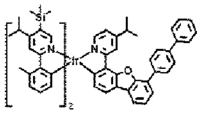
1503

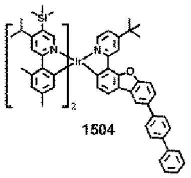
1504

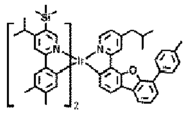
1505

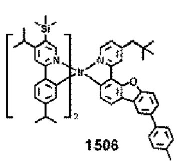
1506
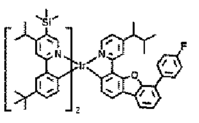
1507
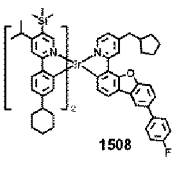
1508
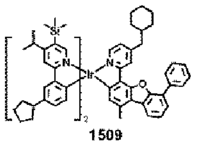
1509
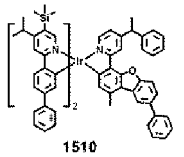
1510

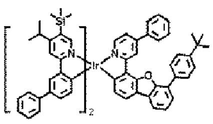
1511
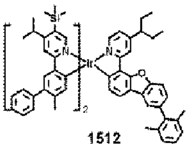
1512
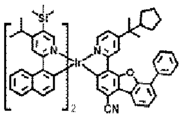
1513
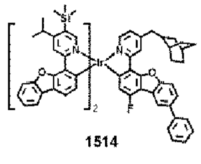
1514
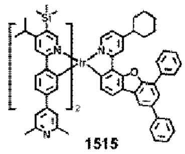
1515

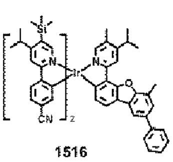
1516
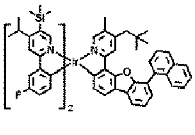
1517
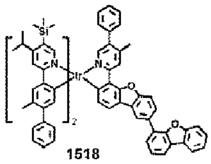
1518
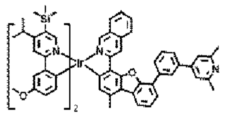
1519
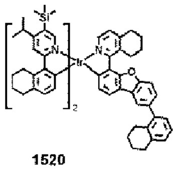
1520

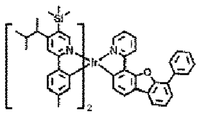
1521
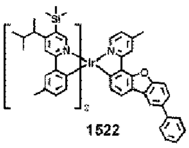
1522
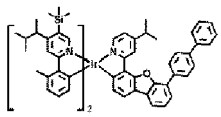
1523
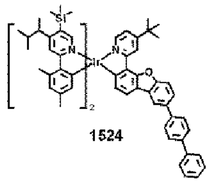
1524
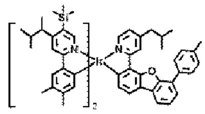
1525

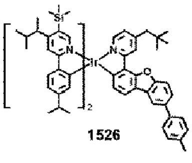
1526
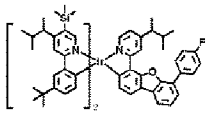
1527
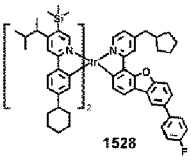
1528
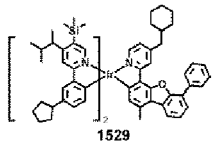
1529
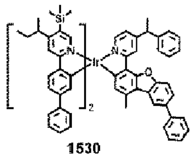
1530

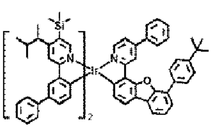
1531
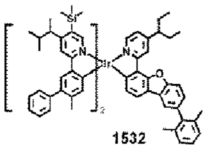
1532
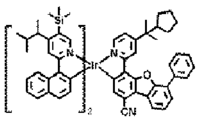
1533
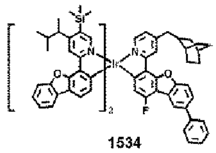
1534
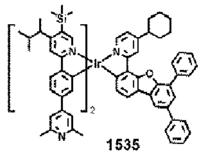
1535

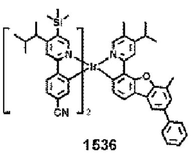
1536
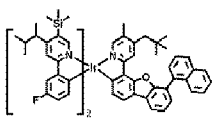
1537
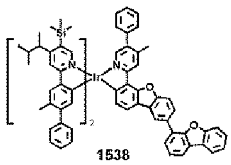
1538
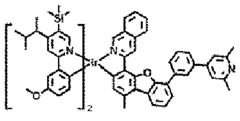
1539
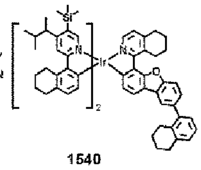
1540

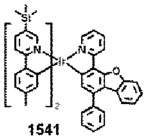
1541
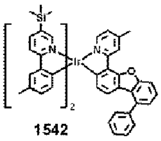
1542
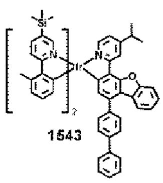
1543
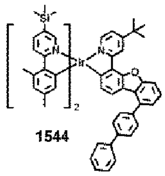
1544
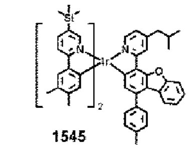
1545

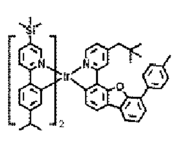
1546
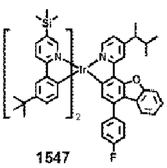
1547
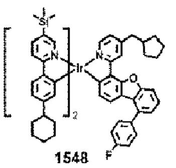
1548
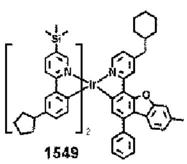
1549
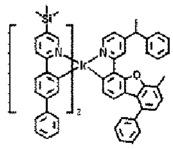
1550

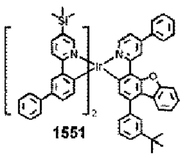
1551
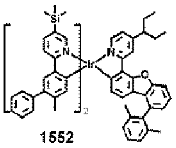
1552
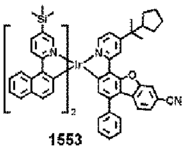
1553
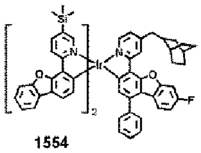
1554
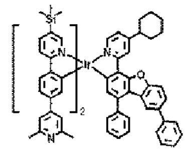
1555

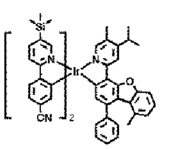
1556
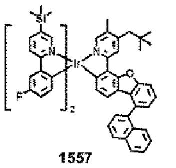
1557
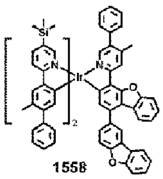
1558
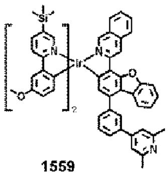
1559
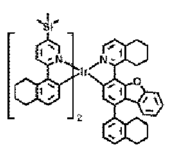
1560

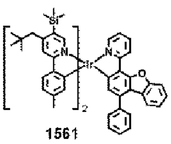
1561
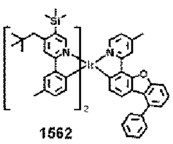
1562
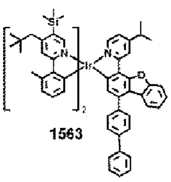
1563
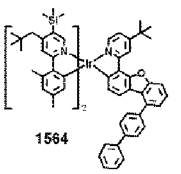
1564
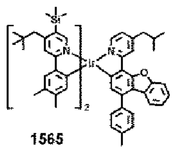
1565

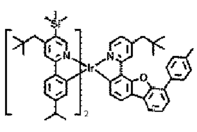
1566
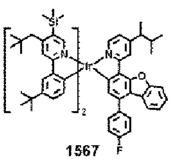
1567
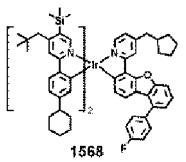
1568
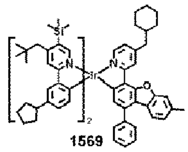
1569
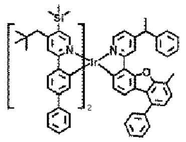
1570

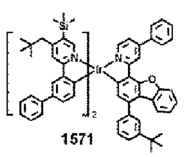
1571
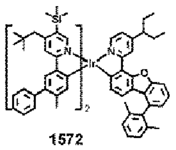
1572
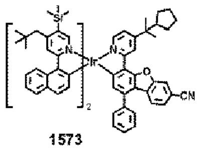
1573
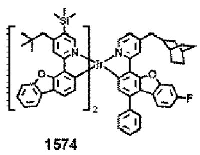
1574
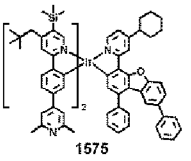
1575

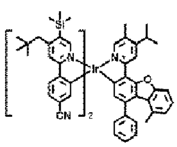
1576
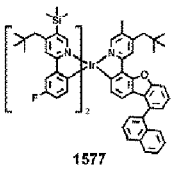
1577
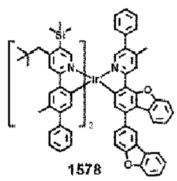
1578
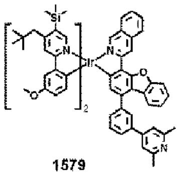
1579
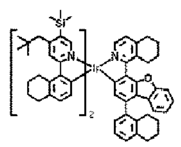
1580

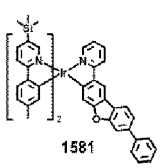
1581
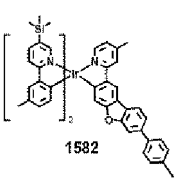
1582
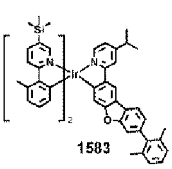
1583
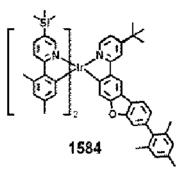
1584
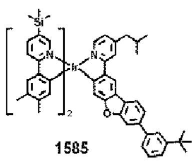
1585

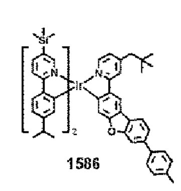
1586
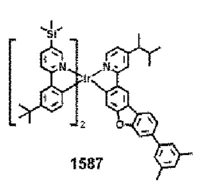
1587
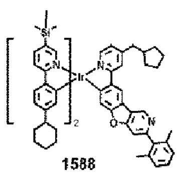
1588
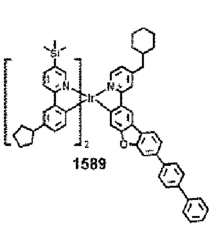
1589
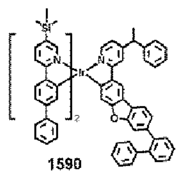
1590

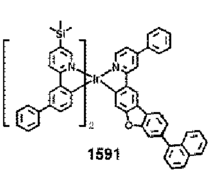
1591
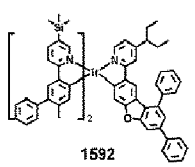
1592
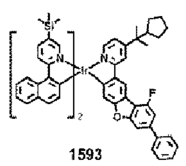
1593
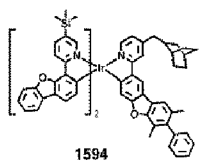
1594
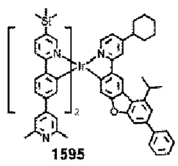
1595

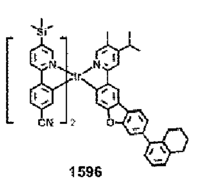
1596
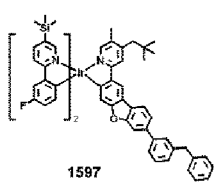
1597
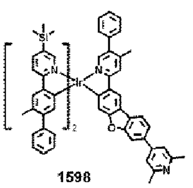
1598
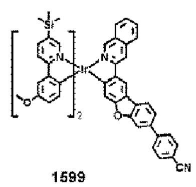
1599
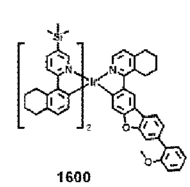
1600

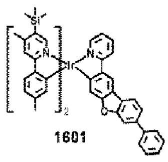
1601
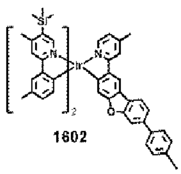
1602
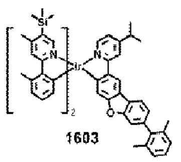
1603
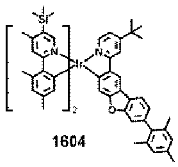
1604
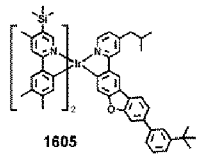
1605

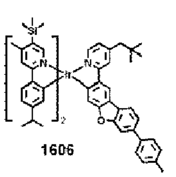
1606
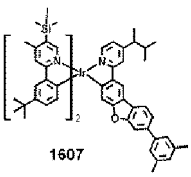
1607
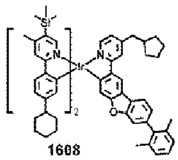
1608
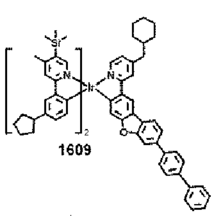
1609
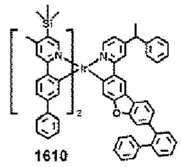
1610

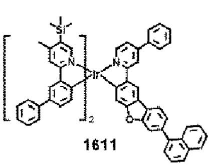
1611
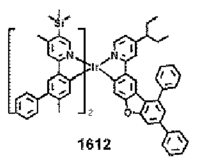
1612
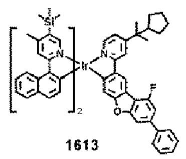
1613
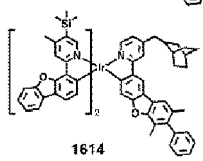
1614
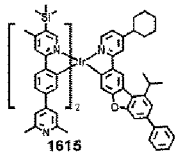
1615

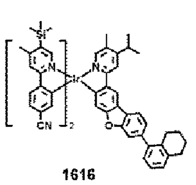
1616
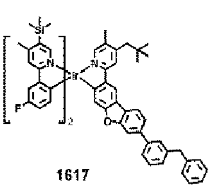
1617
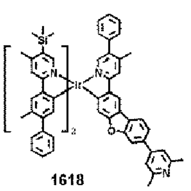
1618
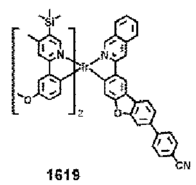
1619
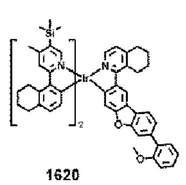
1620

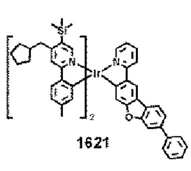
1621
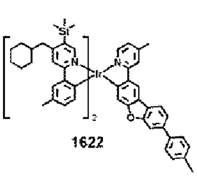
1622
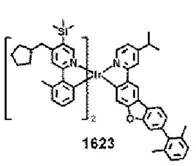
1623
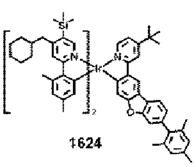
1624
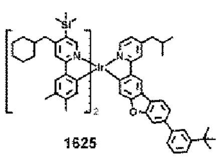
1625

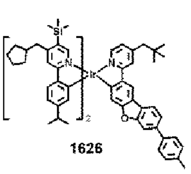
1626
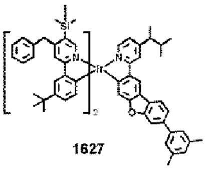
1627
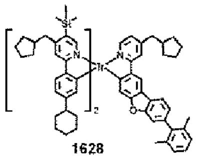
1628
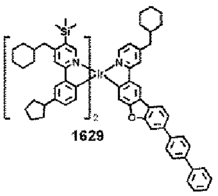
1629
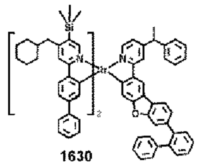
1630
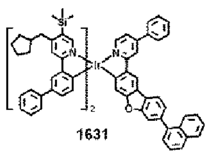
1631
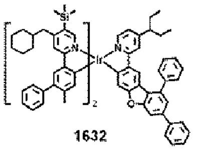
1632
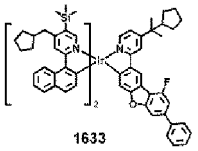
1633
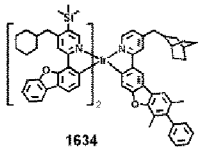
1634
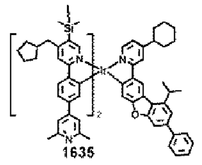
1635
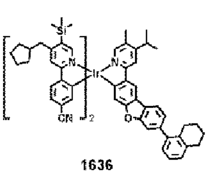
1636
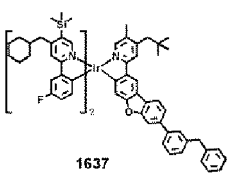
1637
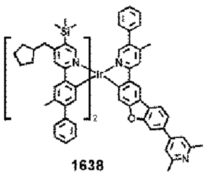
1638
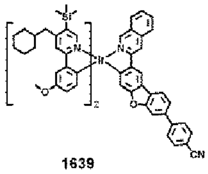
1639
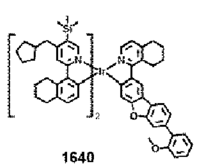
1640
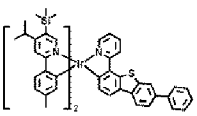
1641
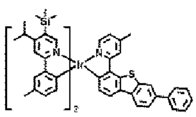
1642
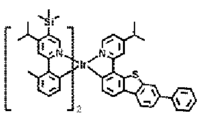
1643
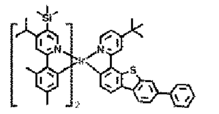
1644
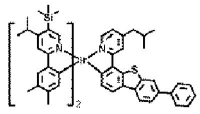
1645
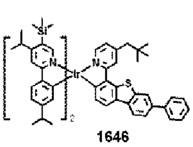
1646
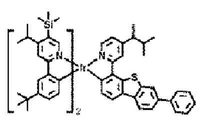
1647
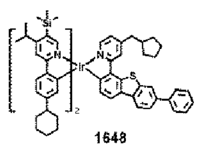
1648
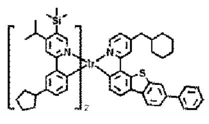
1649
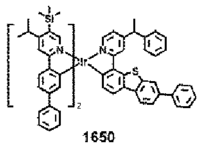
1650
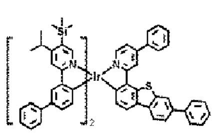
1651
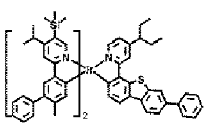
1652
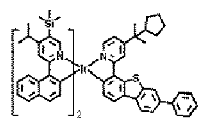
1653
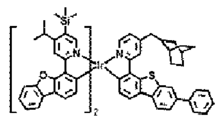
1654
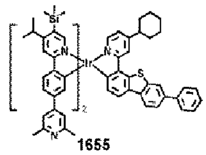
1655
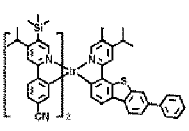
1656
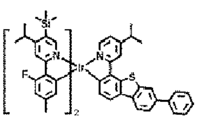
1657
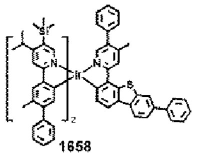
1658
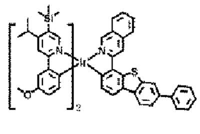
1659
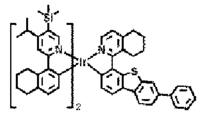
1660
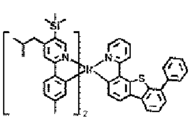
1661
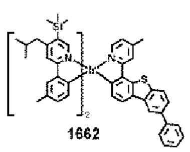
1662
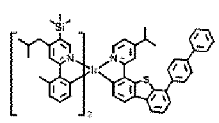
1663
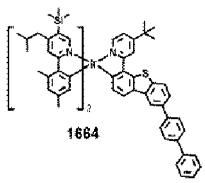
1664
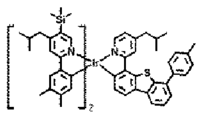
1665

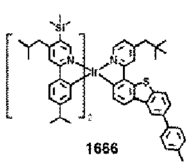
1666

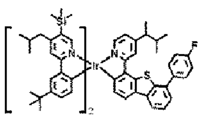
1667

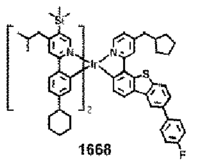
1668

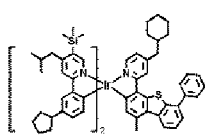
1669

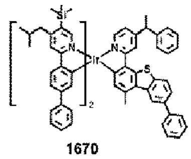
1670

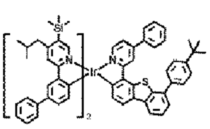
1671

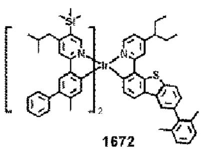
1672

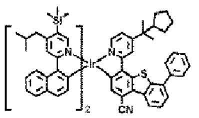
1673

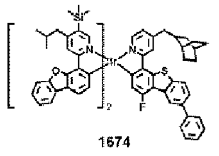
1674

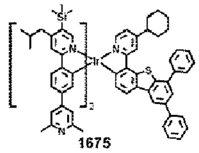
1675

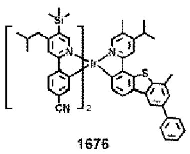
1676

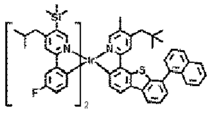
1677

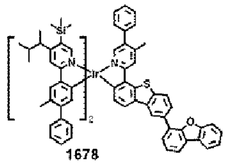
1678

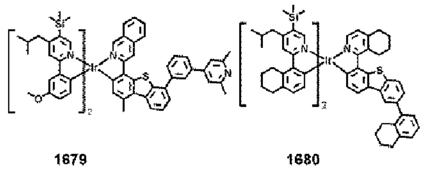
1679

1680

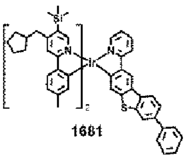
1681

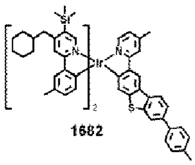
1682

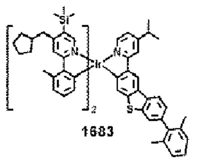
1683

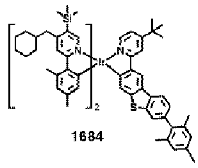
1684

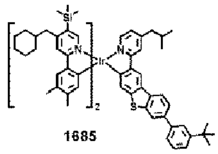
1685

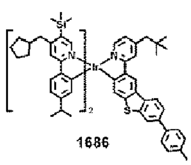
1686

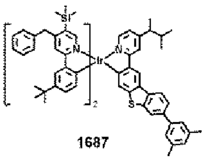
1687

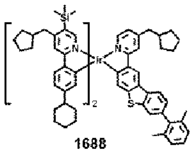
1688

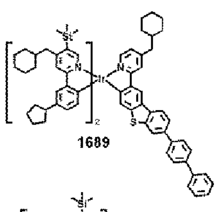
1689

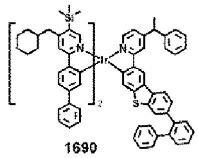
1690

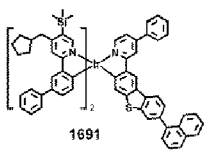
1691

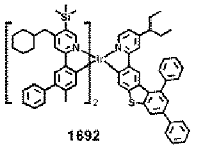
1692

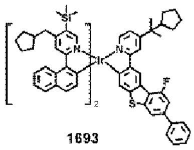
1693

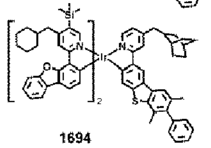
1694

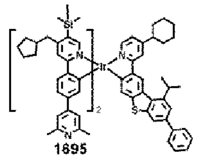
1695

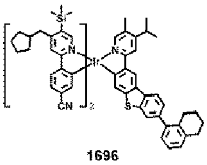
1696

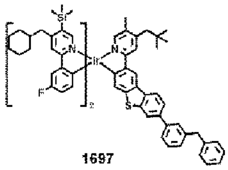
1697

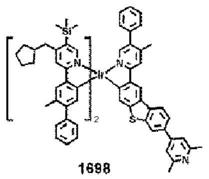
1698

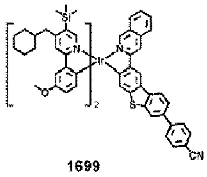
1699

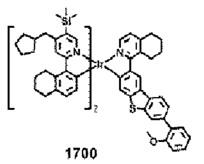
1700

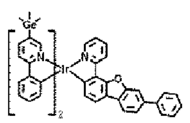
1701

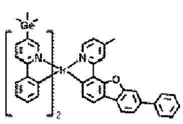
1702

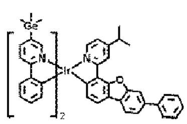
1703

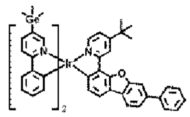
1704

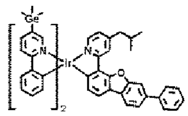
1705

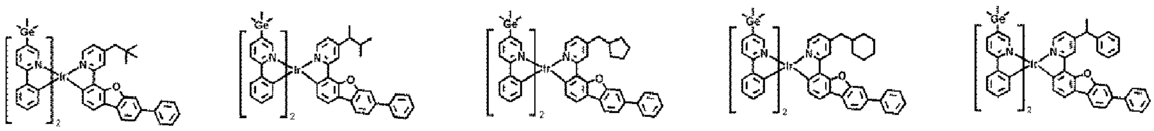
1706

1707

1708

1709

1710

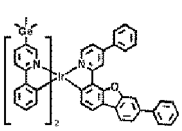
1711
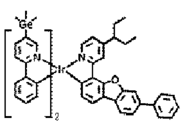
1712
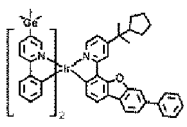
1713
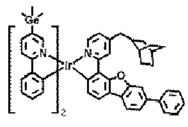
1714
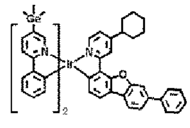
1715

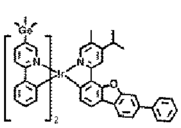
1716
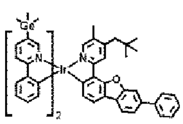
1717
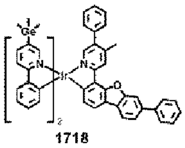
1718
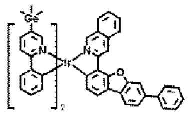
1719
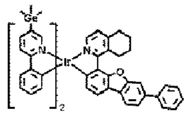
1720

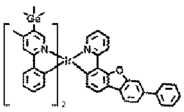
1721
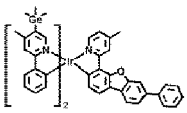
1722
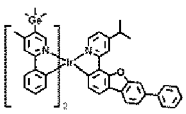
1723
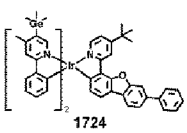
1724
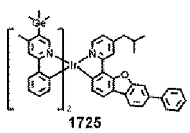
1725

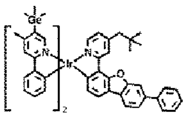
1726
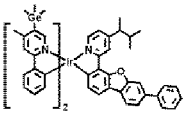
1727
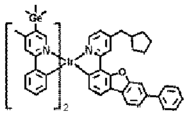
1728
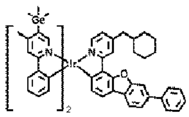
1729
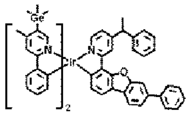
1730

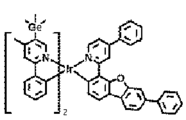
1731
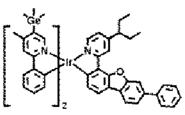
1732
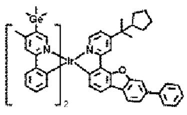
1733
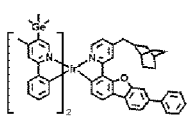
1734
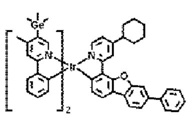
1735

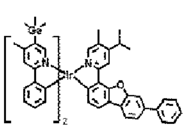
1736
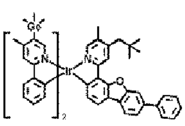
1737
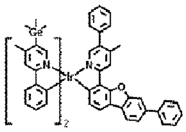
1738
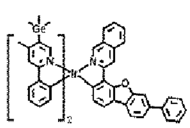
1739
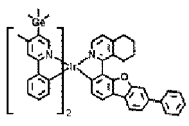
1740

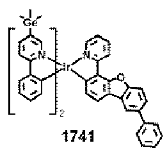
1741
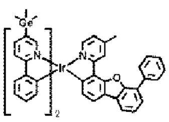
1742
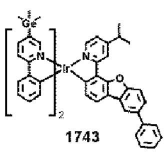
1743
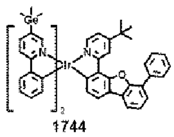
1744
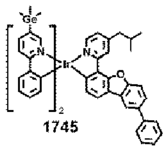
1745

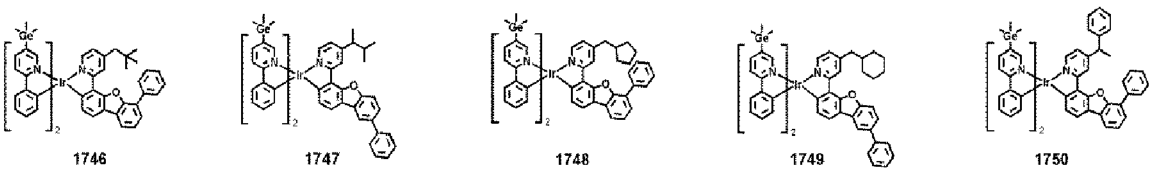
1746
1747
1748
1749
1750

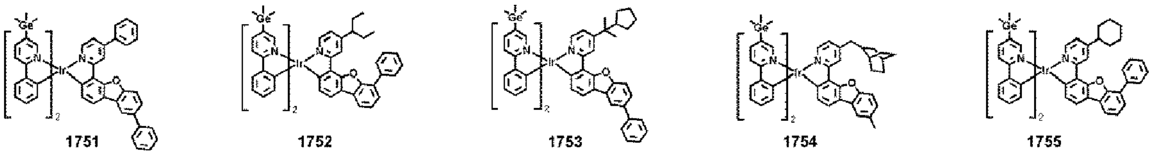
1751
1752
1753
1754
1755

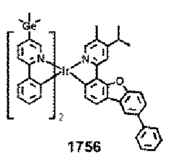
1756

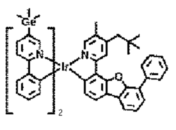
1757

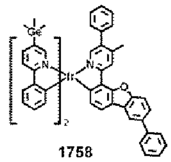
1758

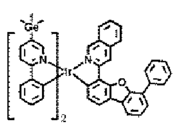
1759

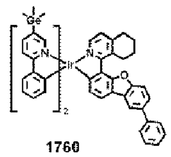
1760

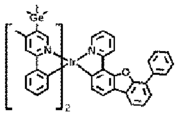
1761

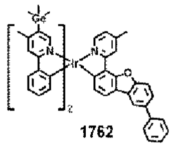
1762

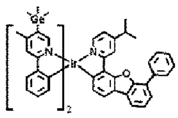
1763

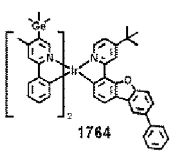
1764

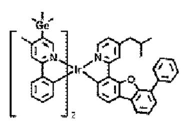
1765

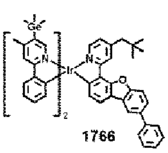
1766

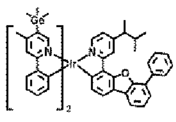
1767

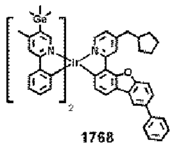
1768

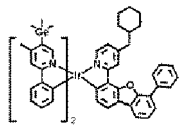
1769

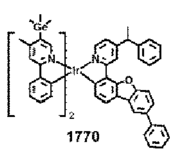
1770

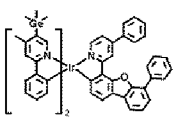
1771

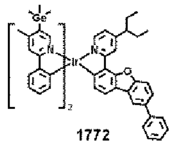
1772

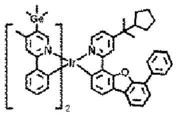
1773

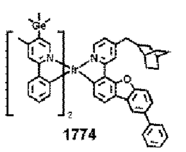
1774

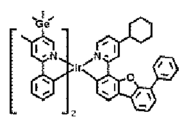
1775

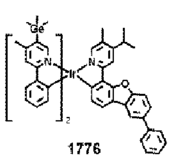
1776

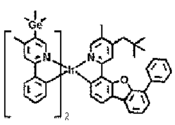
1777

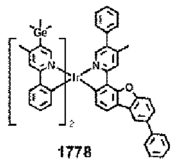
1778

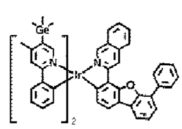
1779

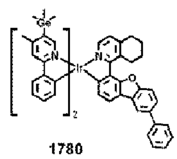
1780

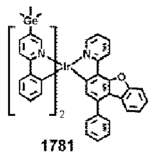
1781

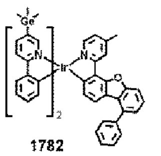
1782

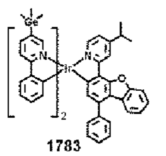
1783

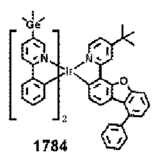
1784

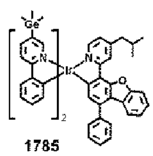
1785

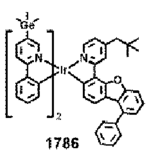
1786

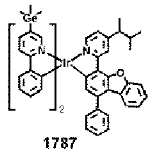
1787

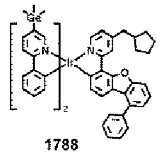
1788

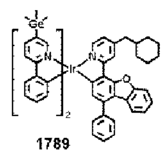
1789

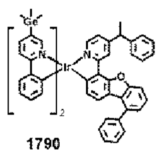
1790

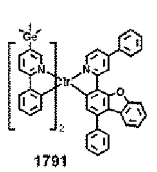
1791

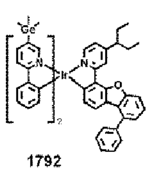
1792

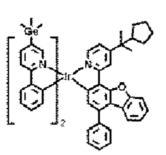
1793

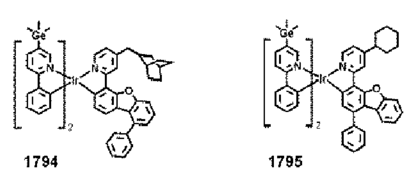
1794

1795

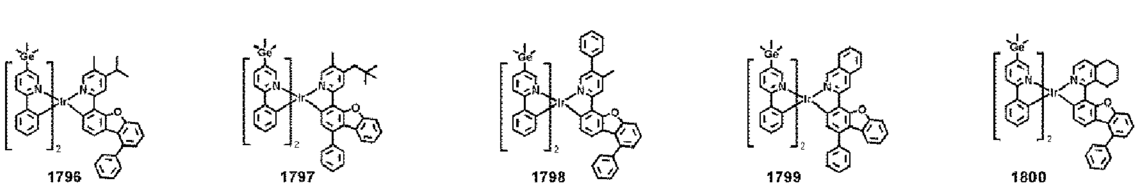
1796

1797

1798

1799

1800

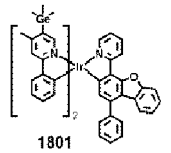
1801

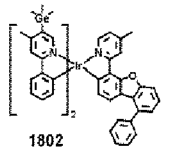
1802

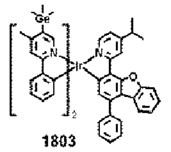
1803

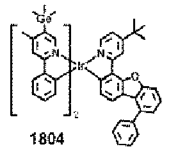
1804

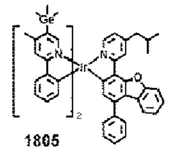
1805

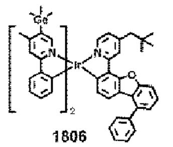
1806

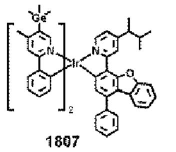
1807

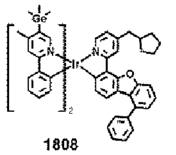
1808

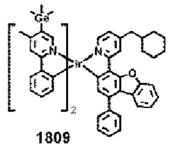
1809

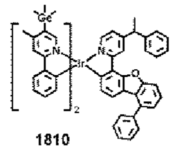
1810

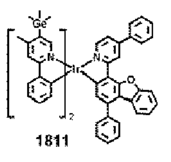
1811

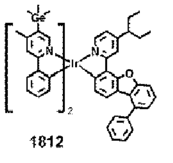
1812

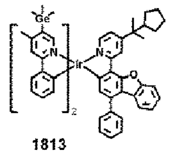
1813

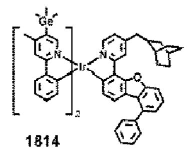
1814

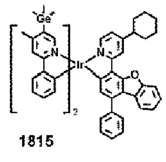
1815

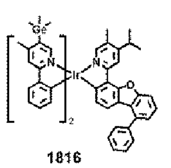
1816

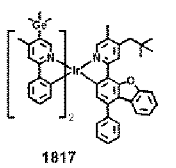
1817

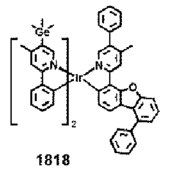
1818

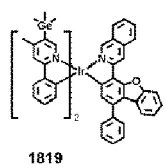
1819

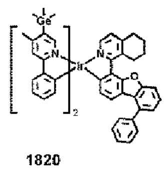
1820

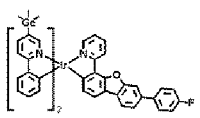
1821

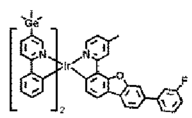
1822

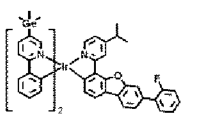
1823

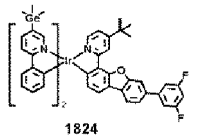
1824

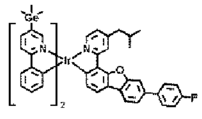
1825

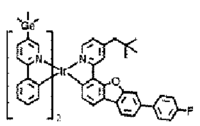
1826

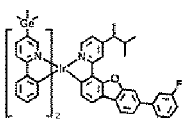
1827

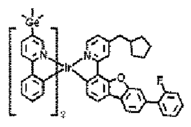
1828

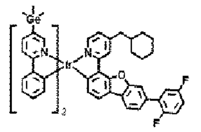
1829

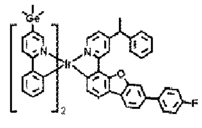
1830

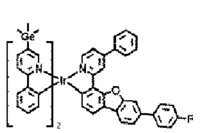
1831

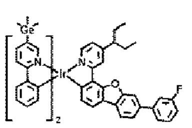
1832

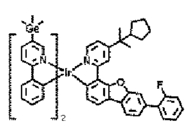
1833

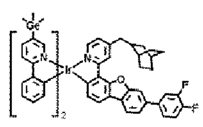
1834

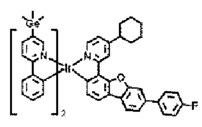
1835

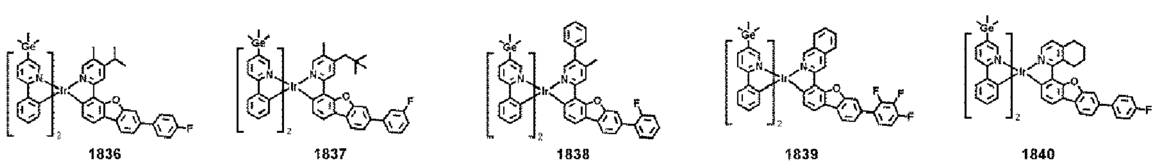
1836 1837 1838 1839 1840

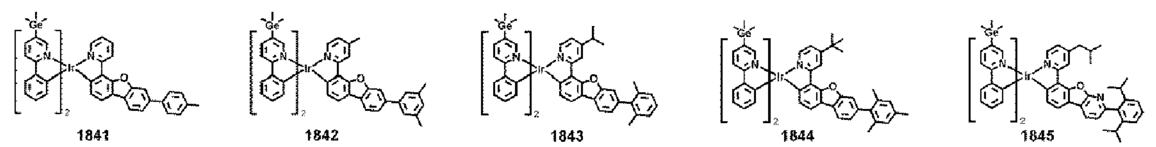
1841 1842 1843 1844 1845

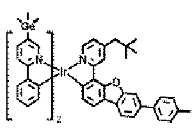
1846

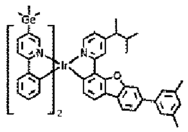
1847

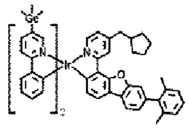
1848

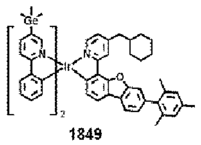
1849

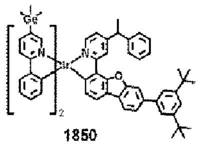
1850

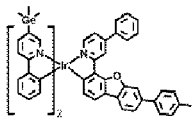
1851

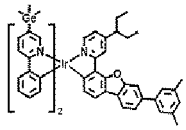
1852

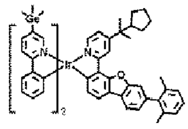
1853

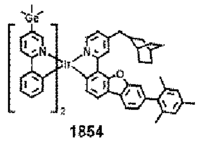
1854

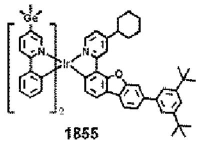
1855

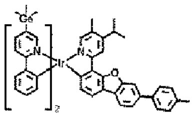
1856

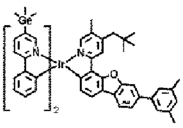
1857

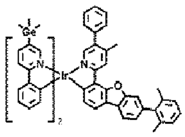
1858

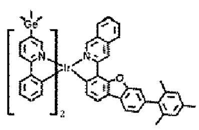
1859

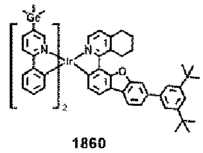
1860

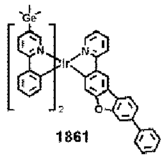
1861

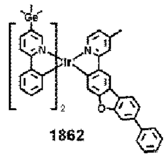
1862

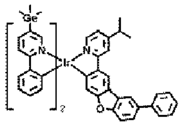
1863

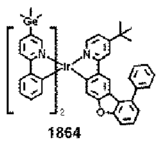
1864

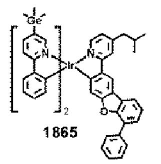
1865

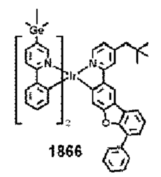
1866

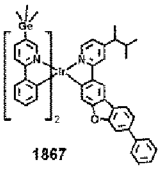
1867

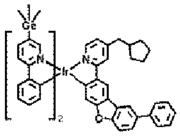
1868

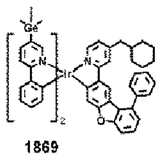
1869

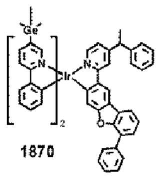
1870

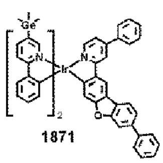
1871

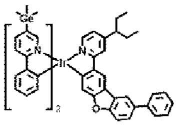
1872

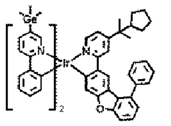
1873

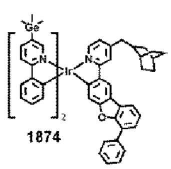
1874

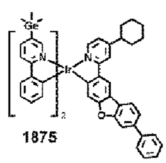
1875

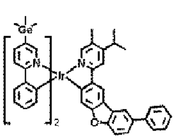
1876

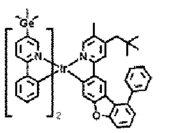
1877

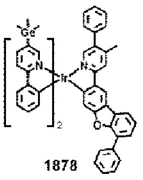
1878

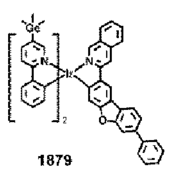
1879

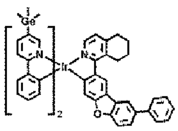
1880

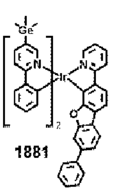
1881

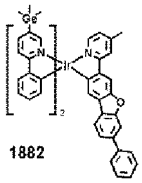
1882

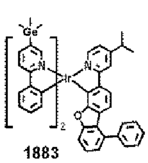
1883

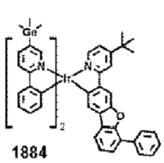
1884

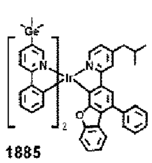
1885

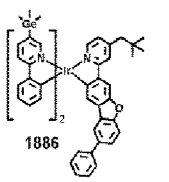
1886
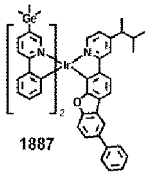
1887
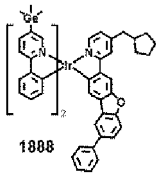
1888
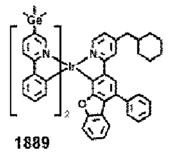
1889
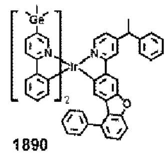
1890
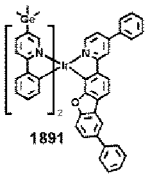
1891
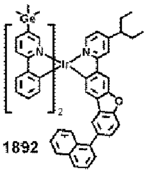
1892
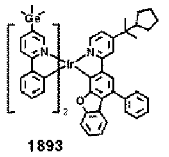
1893
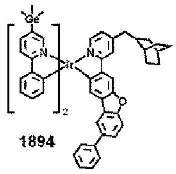
1894
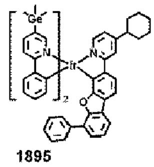
1895
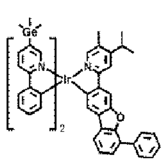
1896
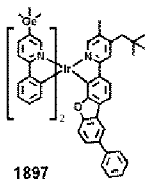
1897
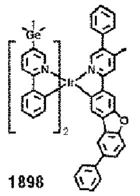
1898
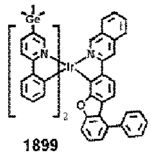
1899
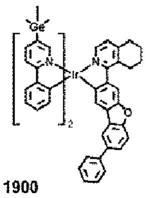
1900
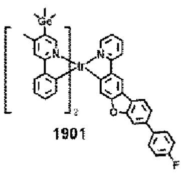
1901
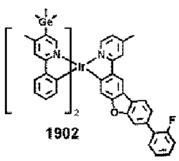
1902
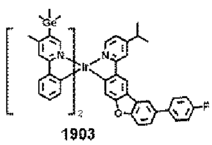
1903
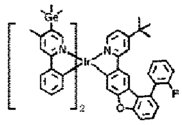
1904
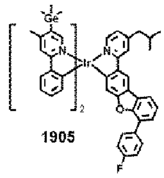
1905
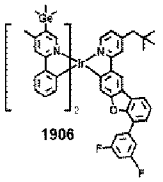
1906
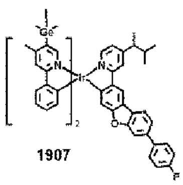
1907
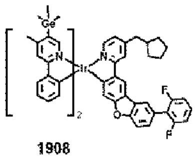
1908
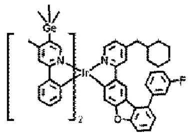
1909
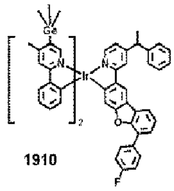
1910
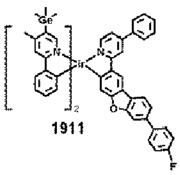
1911
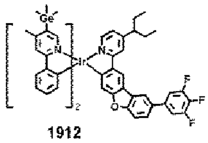
1912
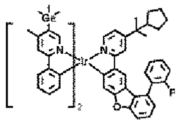
1913
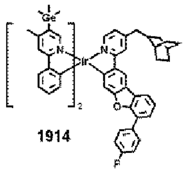
1914
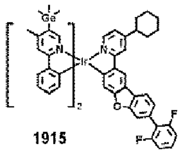
1915
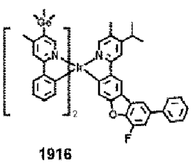
1916
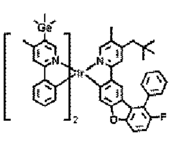
1917
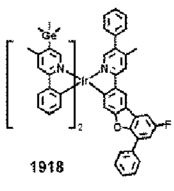
1918
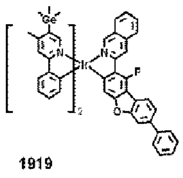
1919
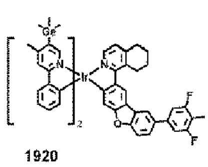
1920
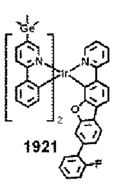
1921
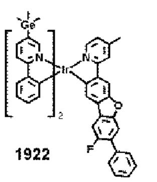
1922
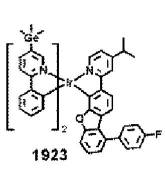
1923
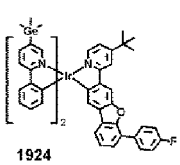
1924
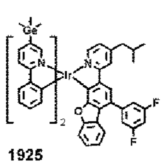
1925

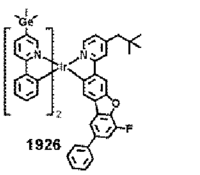
1926
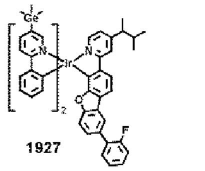
1927
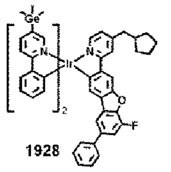
1928
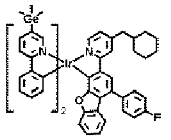
1929
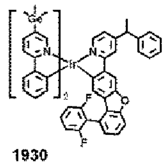
1930
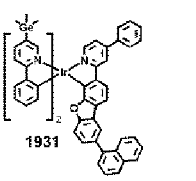
1931
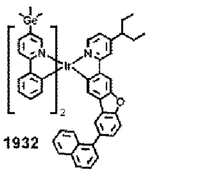
1932
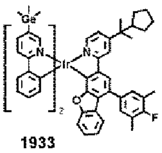
1933
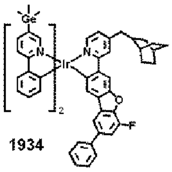
1934
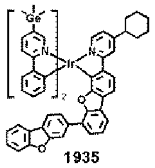
1935
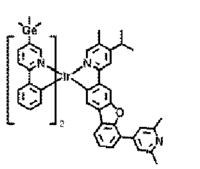
1936
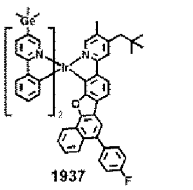
1937
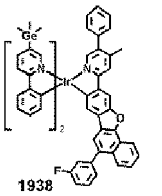
1938
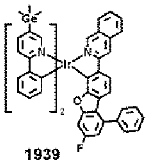
1939
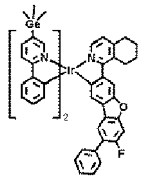
1940
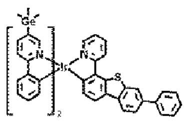
1941
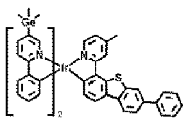
1942
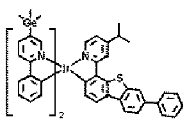
1943
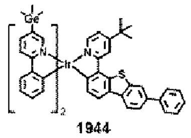
1944
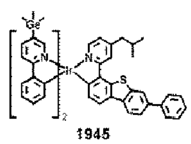
1945
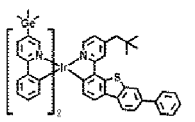
1946
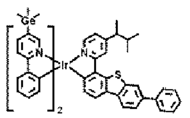
1947
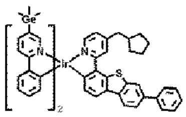
1948
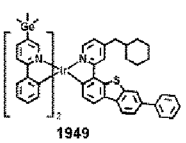
1949
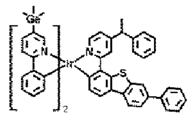
1950
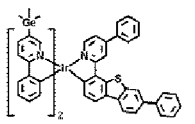
1951
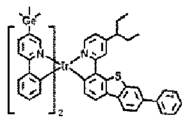
1952
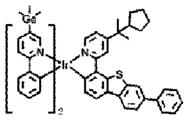
1953
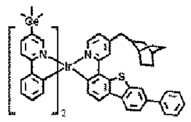
1954
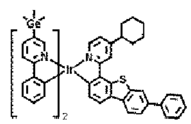
1955
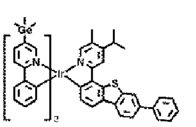
1956
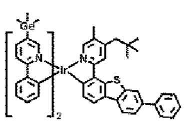
1957
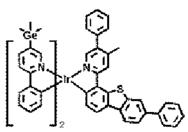
1958
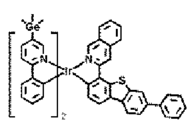
1959
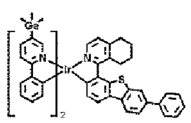
1960
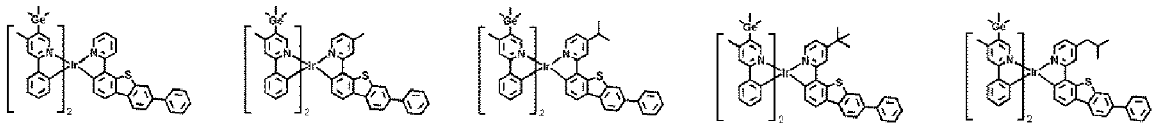
1961 1962 1963 1964 1965
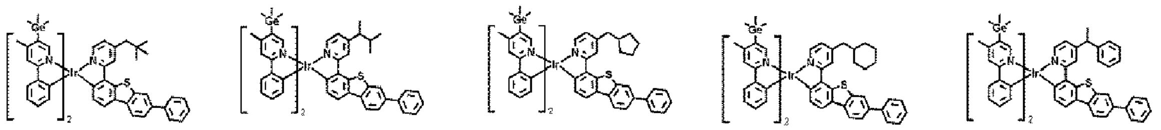
1966 1967 1968 1969 1970

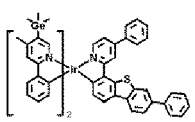
1971

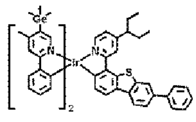
1972

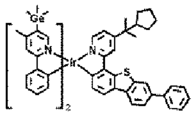
1973

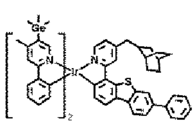
1974

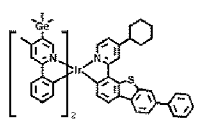
1975

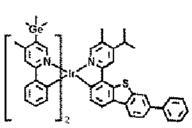
1976

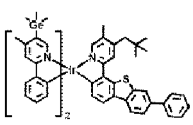
1977

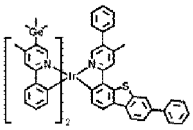
1978

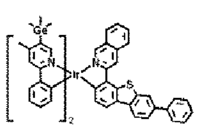
1979

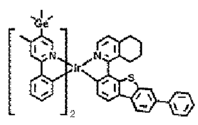
1980

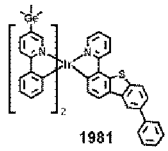
1981

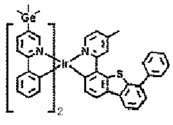
1982

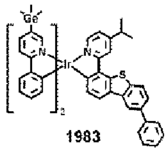
1983

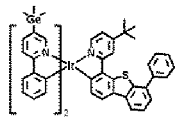
1984

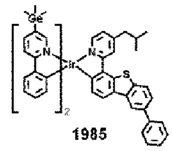
1985

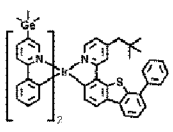
1986

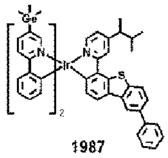
1987

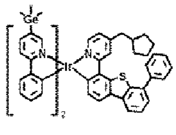
1988

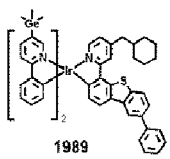
1989

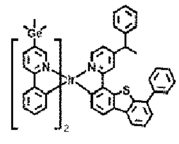
1990

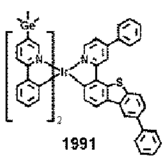
1991

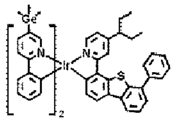
1992

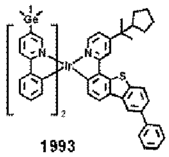
1993

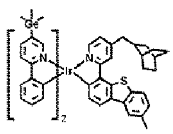
1994

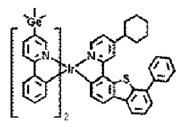
1995

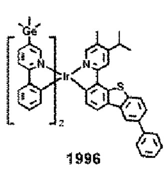
1996

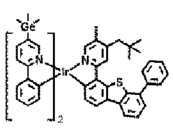
1997

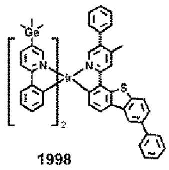
1998

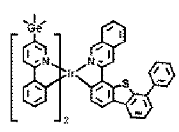
1999

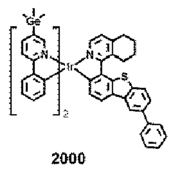
2000

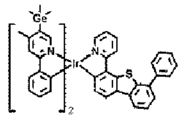
2001

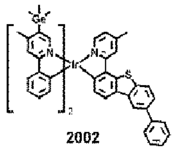
2002

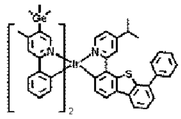
2003

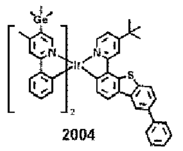
2004

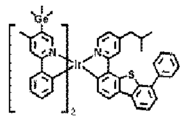
2005

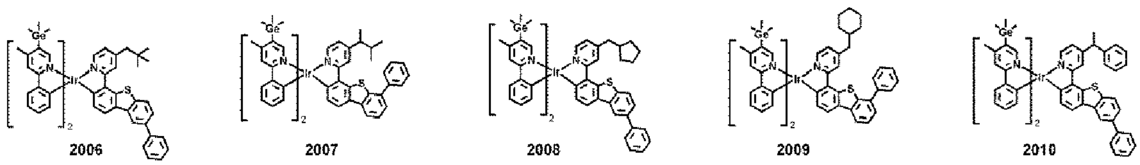
2006 2007 2008 2009 2010

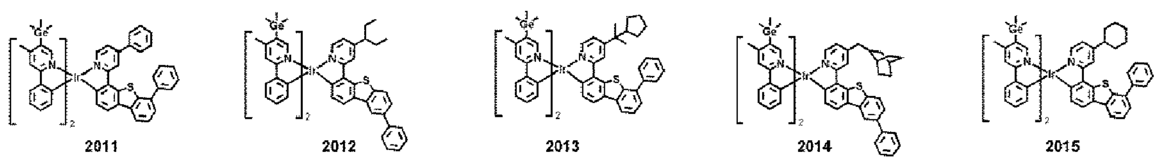
2011 2012 2013 2014 2015

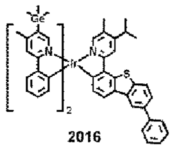
2016
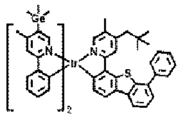
2017
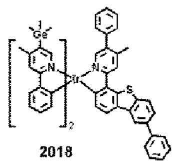
2018
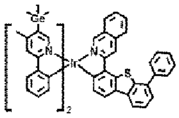
2019
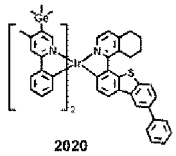
2020
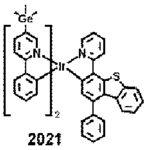
2021
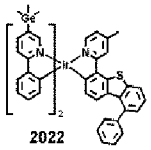
2022
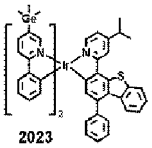
2023
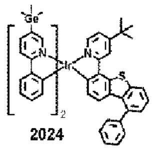
2024
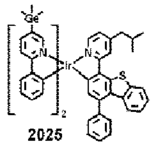
2025
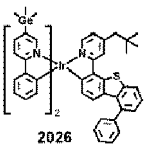
2026
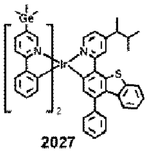
2027
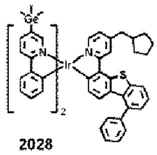
2028
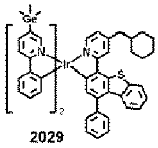
2029
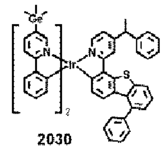
2030
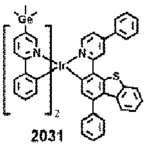
2031
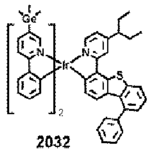
2032
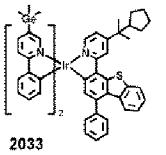
2033
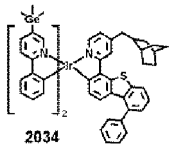
2034
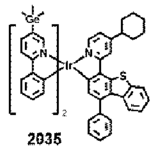
2035
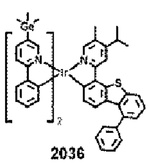
2036
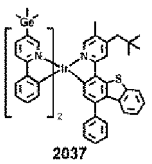
2037
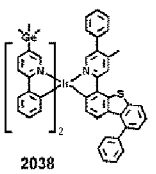
2038
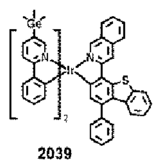
2039
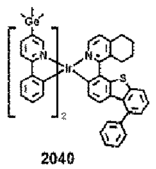
2040
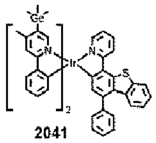
2041
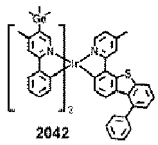
2042
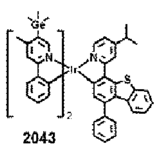
2043
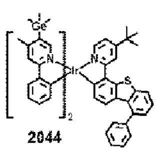
2044
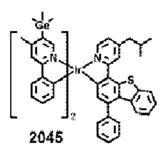
2045
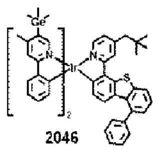
2046
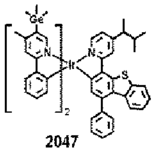
2047
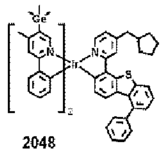
2048
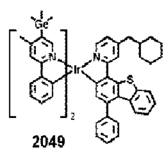
2049
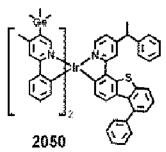
2050
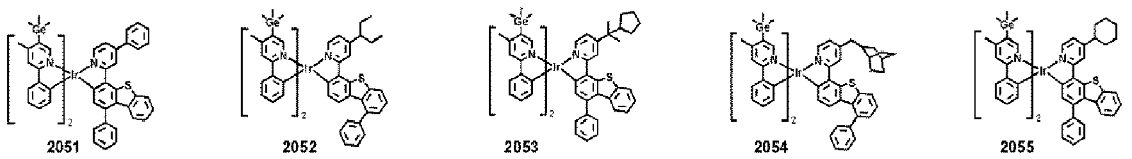
2051 2052 2053 2054 2055
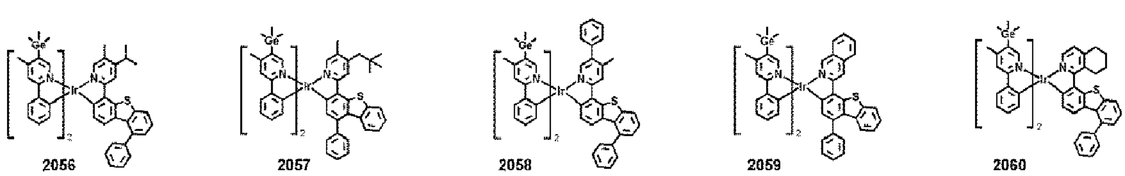
2056 2057 2058 2059 2060

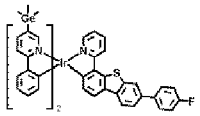
2061
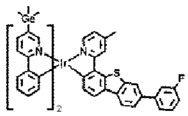
2062
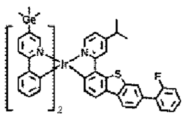
2063
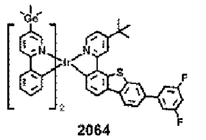
2064
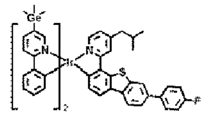
2065

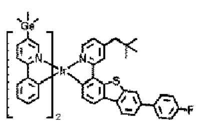
2066
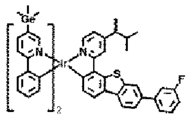
2067
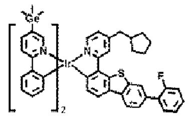
2068
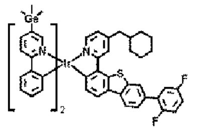
2069
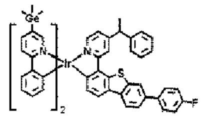
2070

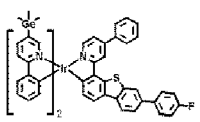
2071
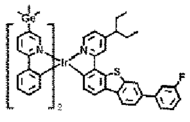
2072
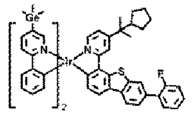
2073
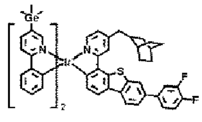
2074
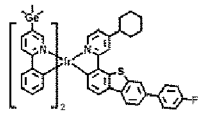
2075

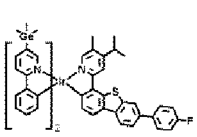
2076
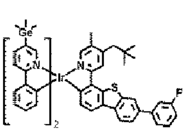
2077
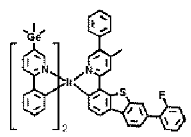
2078
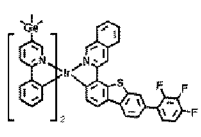
2079
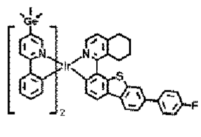
2080

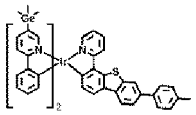
2081
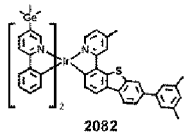
2082
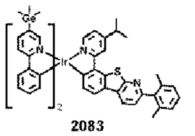
2083
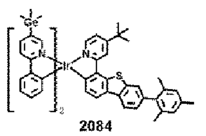
2084
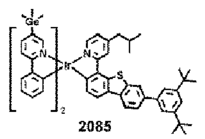
2085

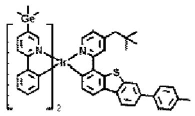
2086
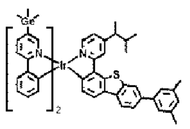
2087
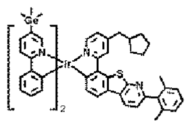
2088
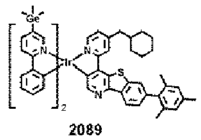
2089
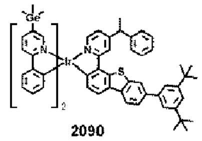
2090

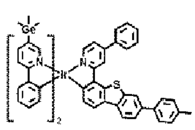
2091
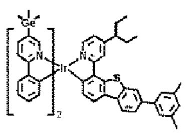
2092
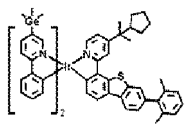
2093
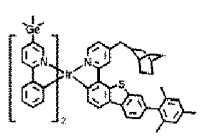
2094
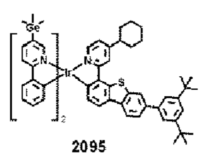
2095

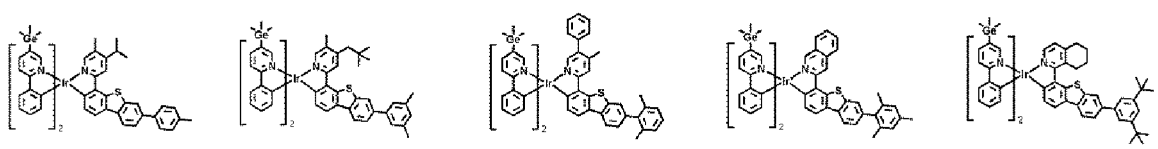
2096
2097
2098
2099
2100

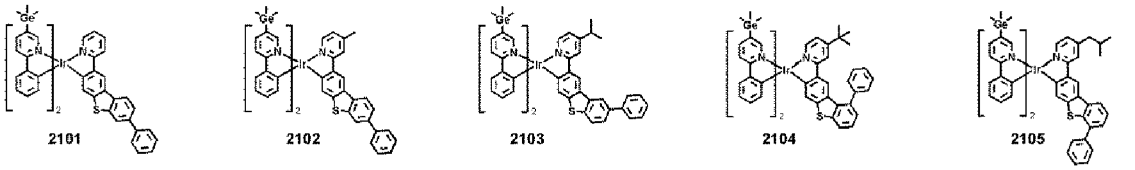
2101
2102
2103
2104
2105

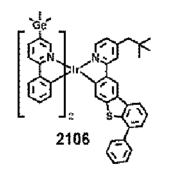
2106

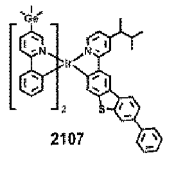
2107

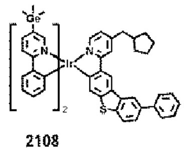
2108

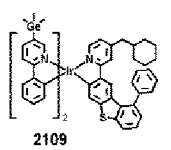
2109

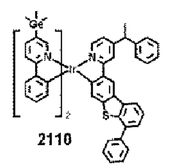
2110

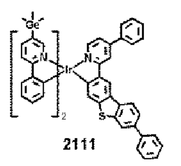
2111

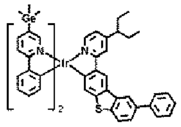
2112

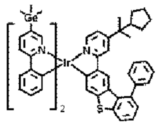
2113

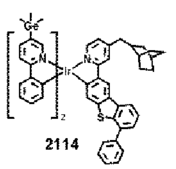
2114

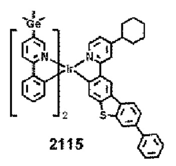
2115

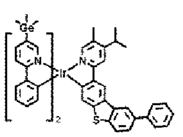
2116

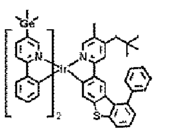
2117

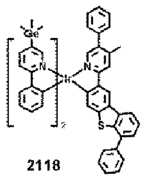
2118

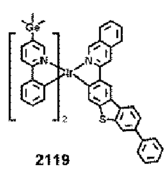
2119

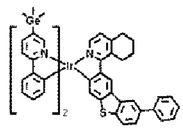
2120

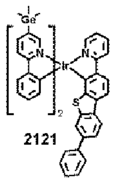
2121

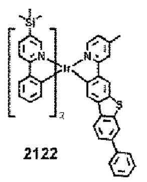
2122

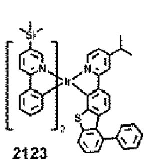
2123

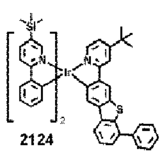
2124

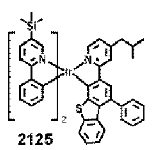
2125

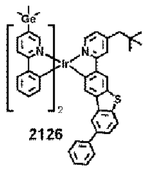
2126

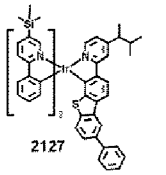
2127

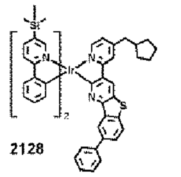
2128

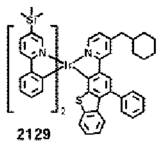
2129

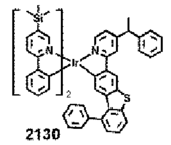
2130

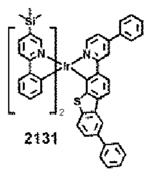
2131

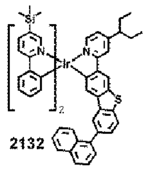
2132

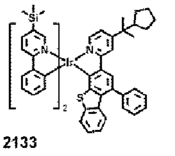
2133

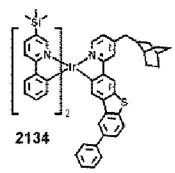
2134

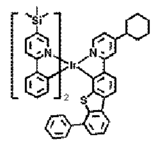
2135

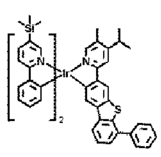
2136

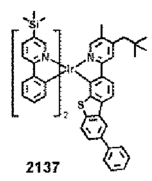
2137

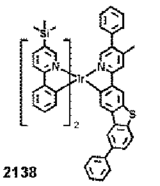
2138

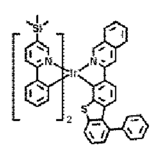
2139

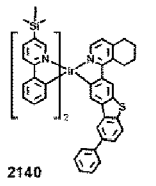
2140

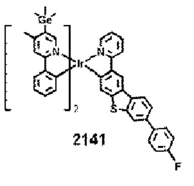
2141

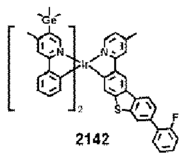
2142

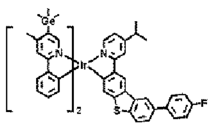
2143

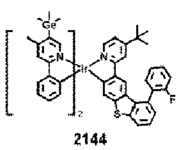
2144

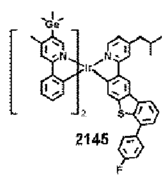
2145

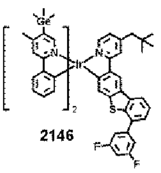
2146

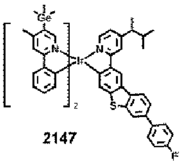
2147

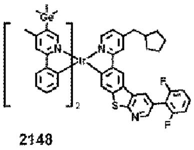
2148

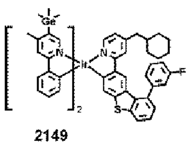
2149

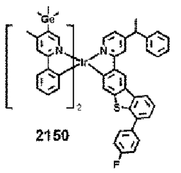
2150

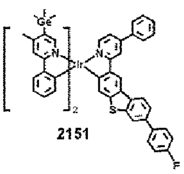
2151

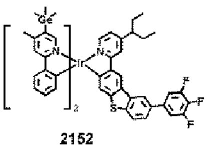
2152

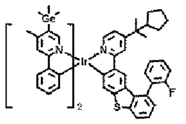
2153

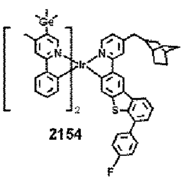
2154

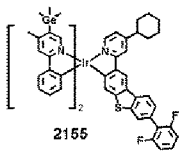
2155

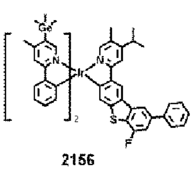
2156

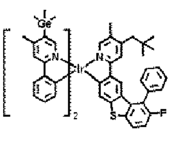
2157

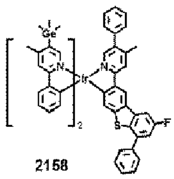
2158

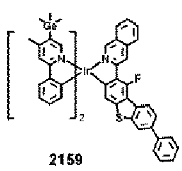
2159

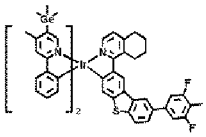
2160

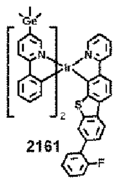
2161

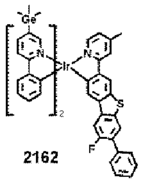
2162

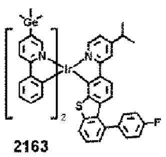
2163

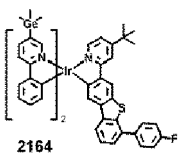
2164

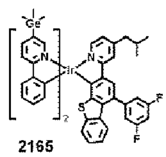
2165

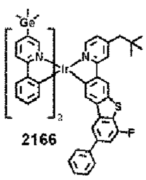
2166

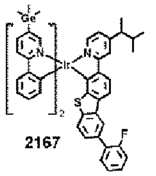
2167

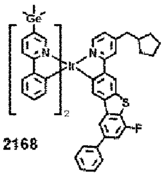
2168

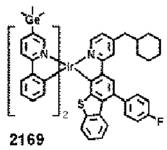
2169

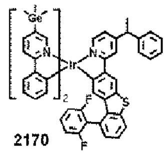
2170

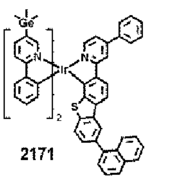
2171

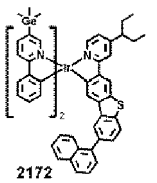
2172

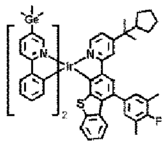
2173

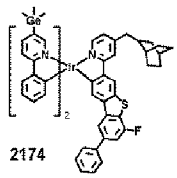
2174

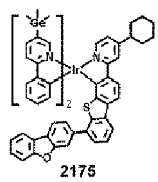
2175

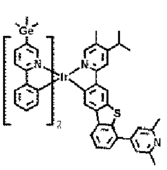
2176

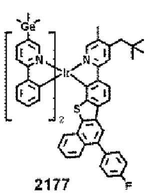
2177

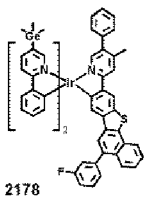
2178

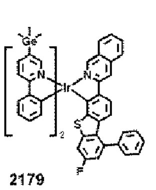
2179

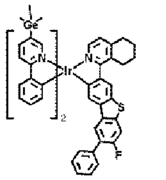
2180

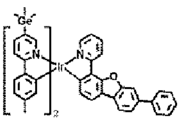
2181

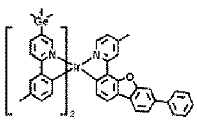
2182

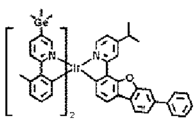
2183

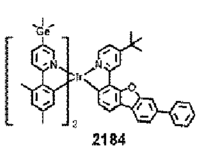
2184

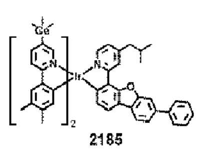
2185

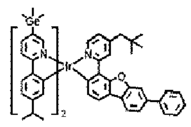
2186

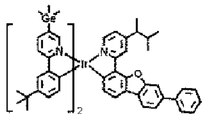
2187

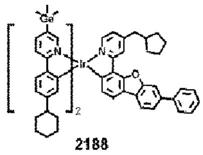
2188

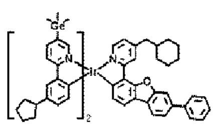
2189

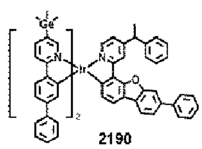
2190

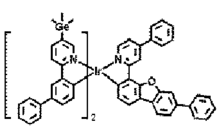
2191

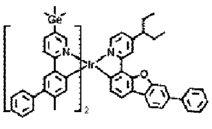
2192

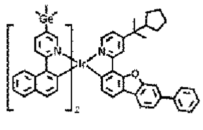
2193

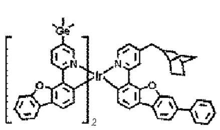
2194

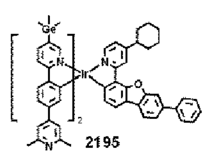
2195

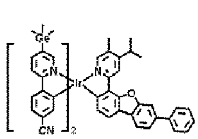
2196

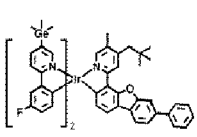
2197

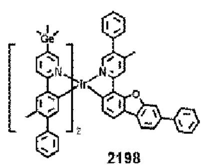
2198

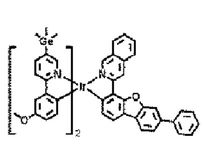
2199

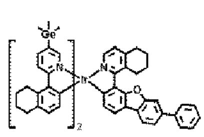
2200

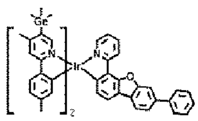
2201

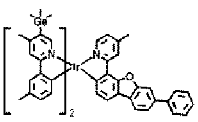
2202

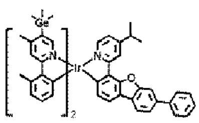
2203

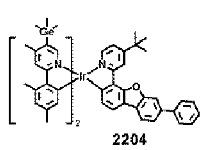
2204

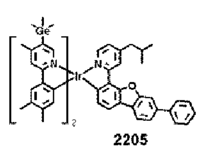
2205

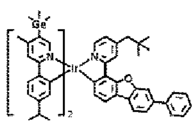
2206

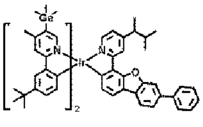
2207

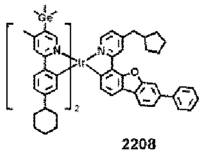
2208

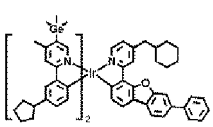
2209

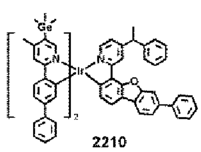
2210

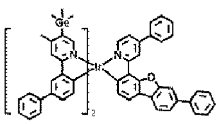
2211

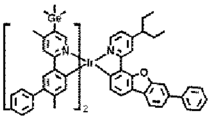
2212

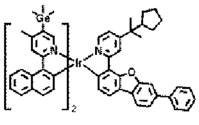
2213

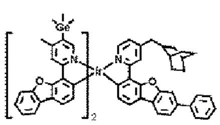
2214

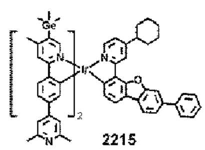
2215

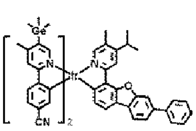
2216

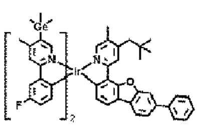
2217

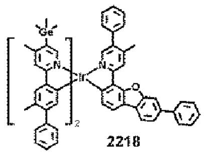
2218

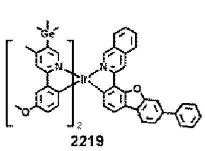
2219

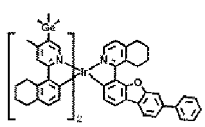
2220

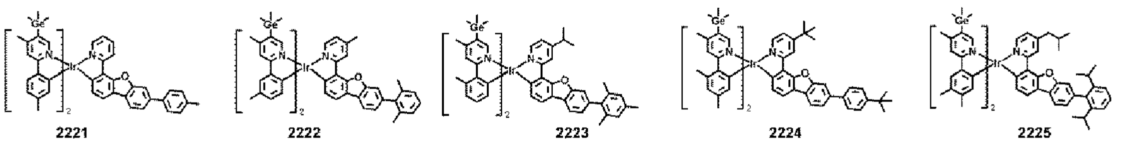
2221 2222 2223 2224 2225

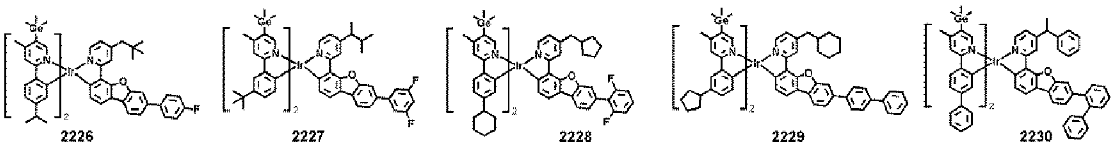
2226 2227 2228 2229 2230

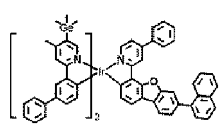
2231
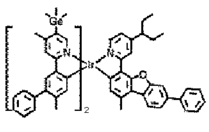
2232
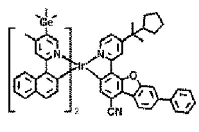
2233
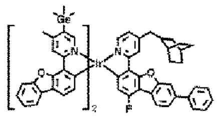
2234
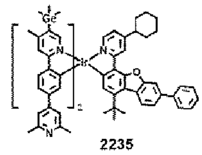
2235

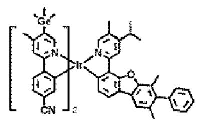
2236
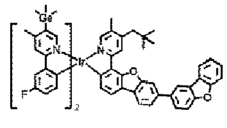
2237
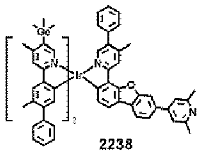
2238
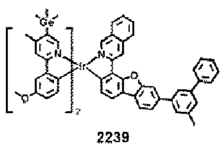
2239
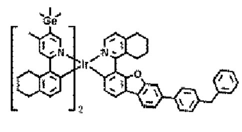
2240

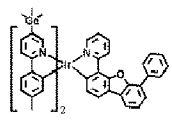
2241
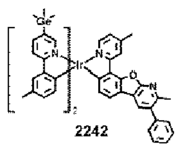
2242
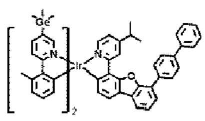
2243
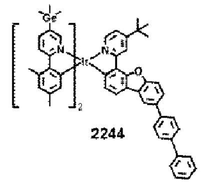
2244
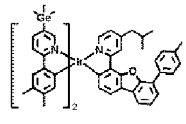
2245

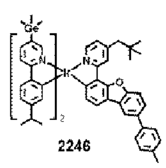
2246
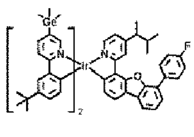
2247
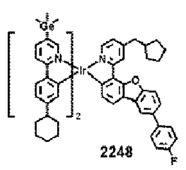
2248
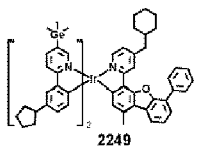
2249
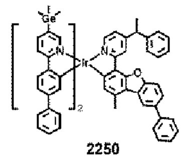
2250

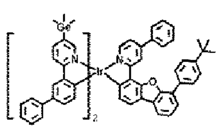
2251
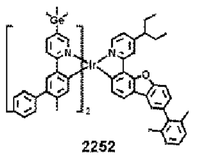
2252
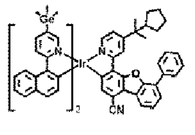
2253
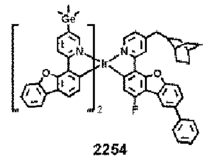
2254
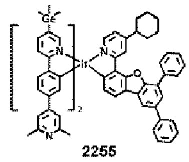
2255

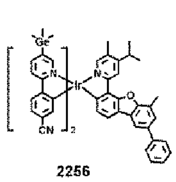
2256
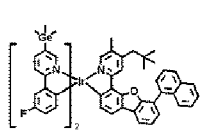
2257
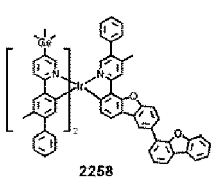
2258
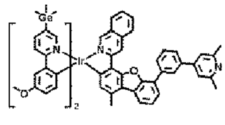
2259
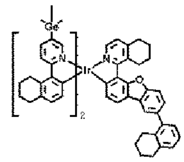
2260

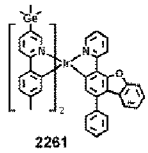
2261
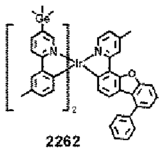
2262
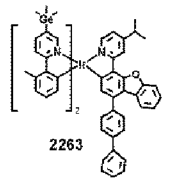
2263
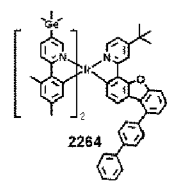
2264
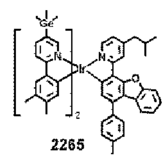
2265

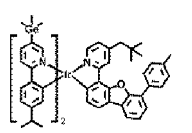
2266
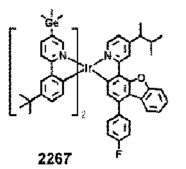
2267
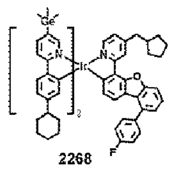
2268
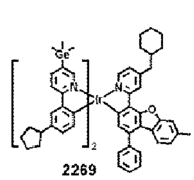
2269
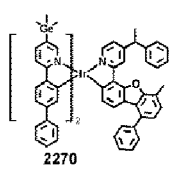
2270

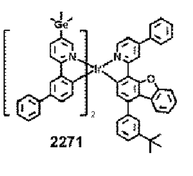
2271

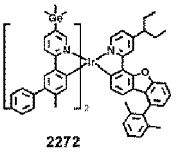
2272

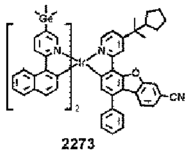
2273

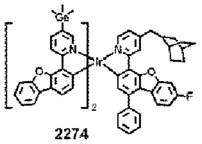
2274

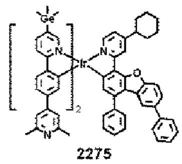
2275

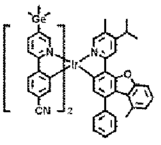
2276

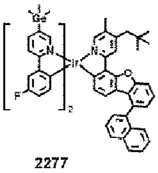
2277

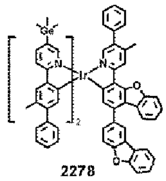
2278

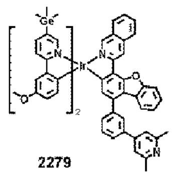
2279

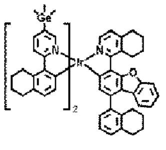
2280

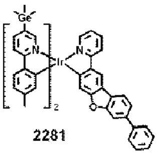
2281

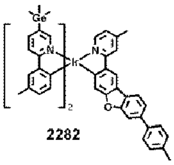
2282

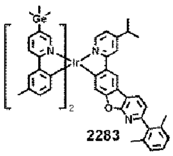
2283

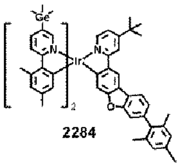
2284

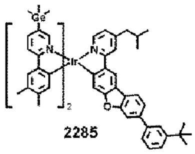
2285

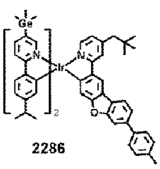
2286

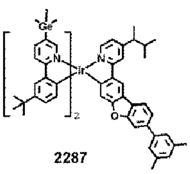
2287

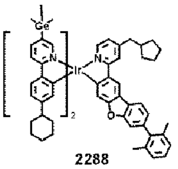
2288

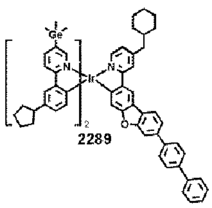
2289

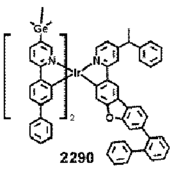
2290

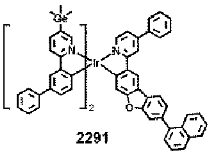
2291

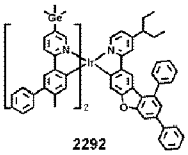
2292

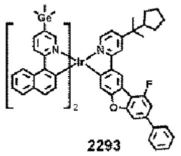
2293

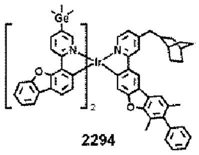
2294

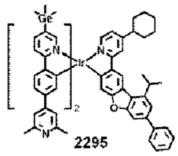
2295

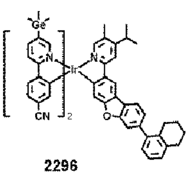
2296

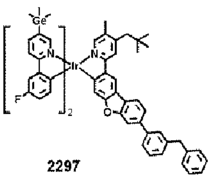
2297

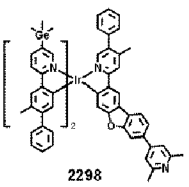
2298

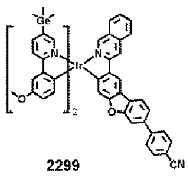
2299

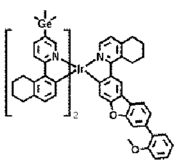
2300

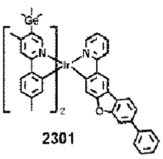
2301

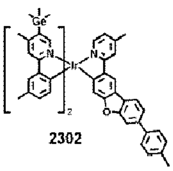
2302

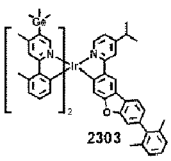
2303

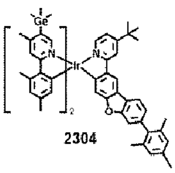
2304

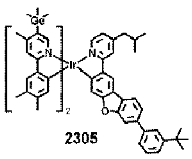
2305

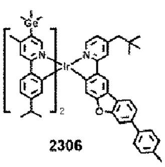
2306

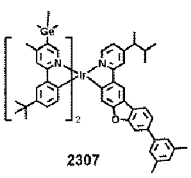
2307

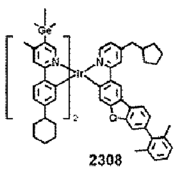
2308

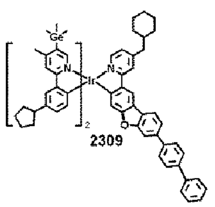
2309

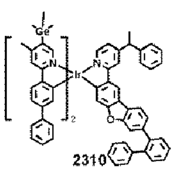
2310

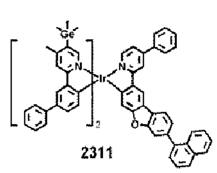

2311

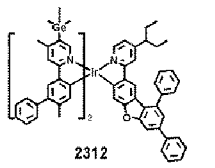

2312

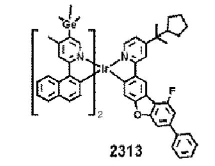

2313

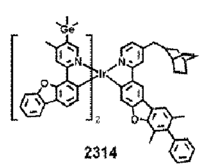

2314

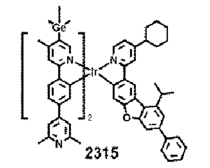

2315

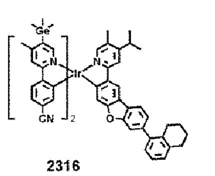

2316

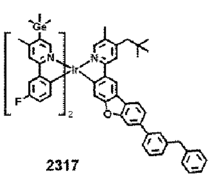

2317

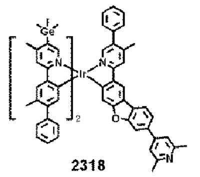

2318

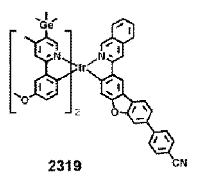

2319

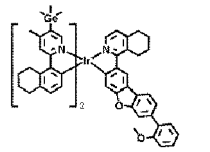

2320

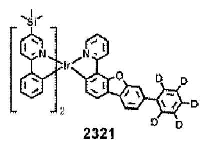

2321

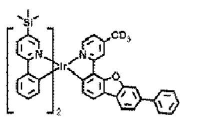

2322

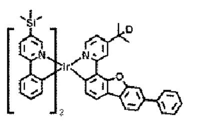

2323

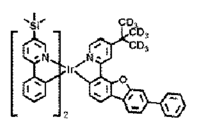

2324

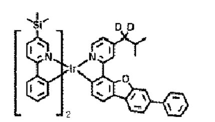

2325

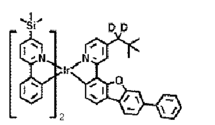

2326

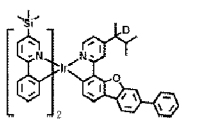

2327

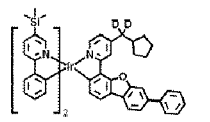

2328

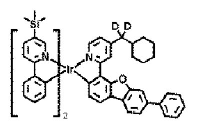

2329

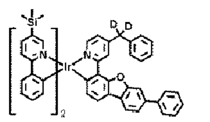

2330

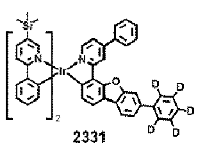

2331

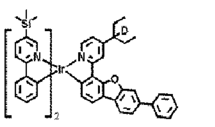

2332

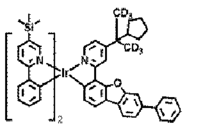

2333

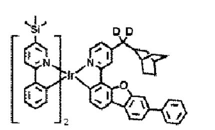

2334

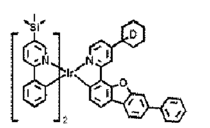

2335

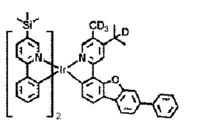

2336

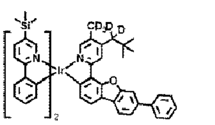

2337

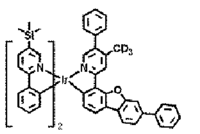

2338

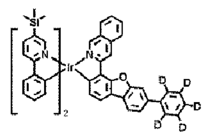

2339

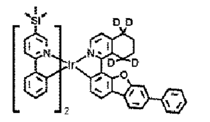

2340

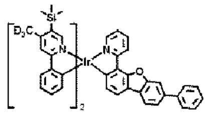

2341

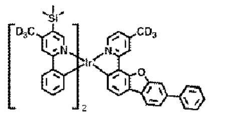

2342

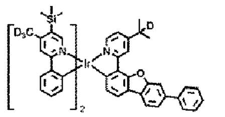

2343

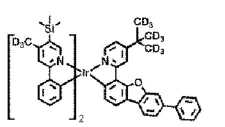

2344

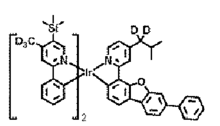

2345

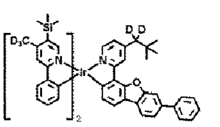

2346

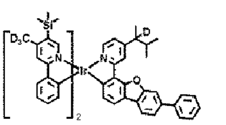

2347

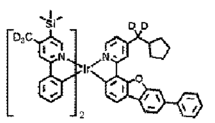

2348

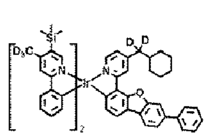

2349

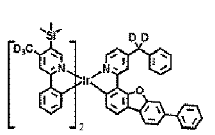

2350

2351

2352

2353

2354

2355

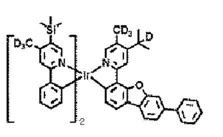
2356
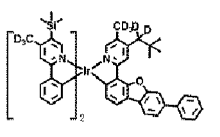
2357
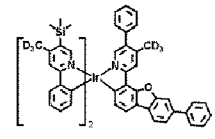
2358
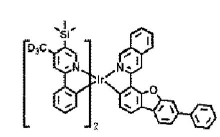
2359
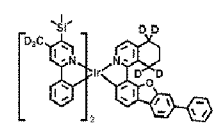
2360

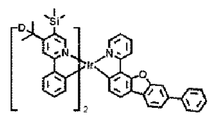
2361
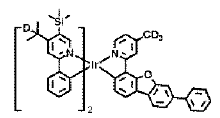
2362
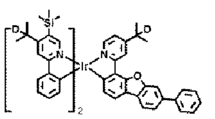
2363
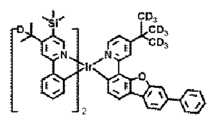
2364
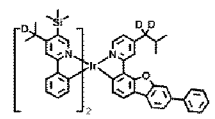
2365

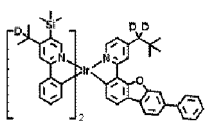
2366
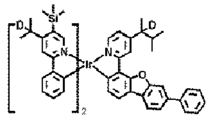
2367
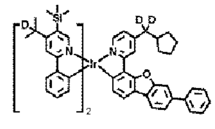
2368
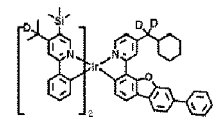
2369
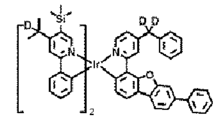
2370

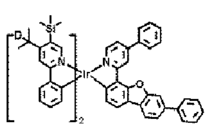
2371
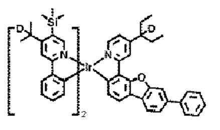
2372
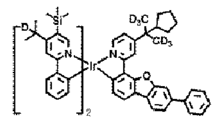
2373
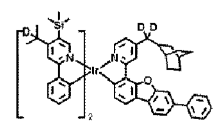
2374
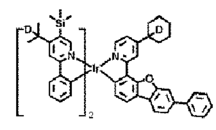
2375

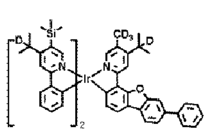
2376
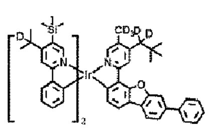
2377
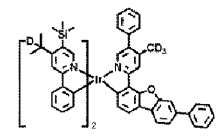
2378
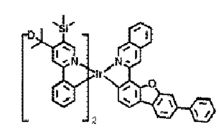
2379
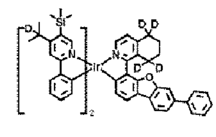
2380

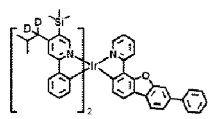
2381
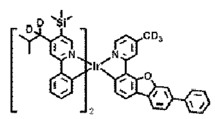
2382
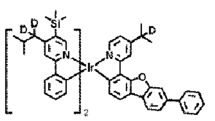
2383
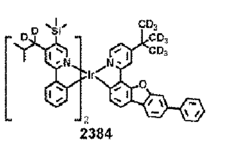
2384
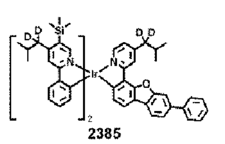
2385

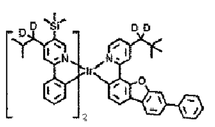
2386
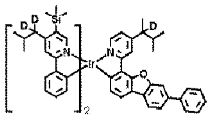
2387
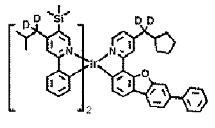
2388
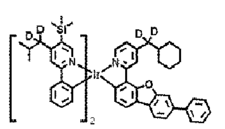
2389
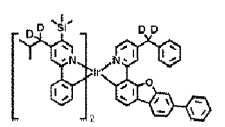
2390

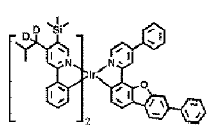
2391
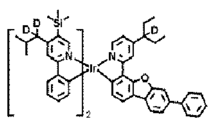
2392
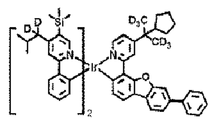
2393
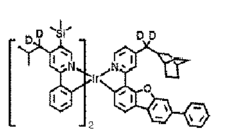
2394
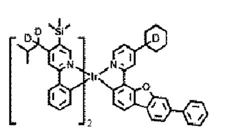
2395

2396
2397
2398
2399
2400

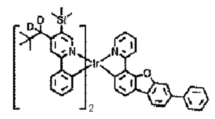
2401
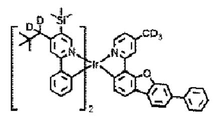
2402
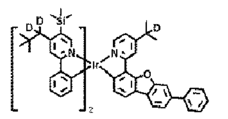
2403
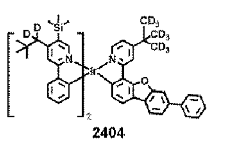
2404
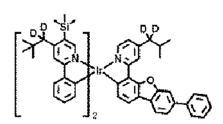
2405
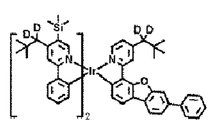
2406
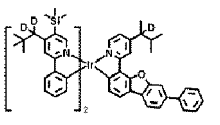
2407
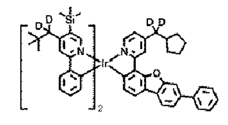
2408
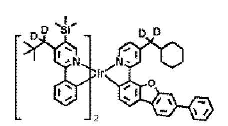
2409
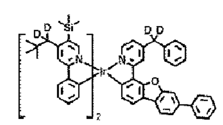
2410
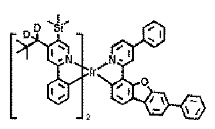
2411
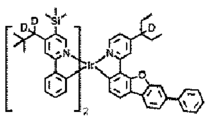
2412
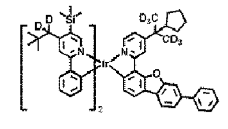
2413
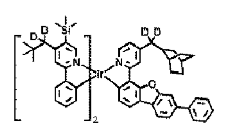
2414
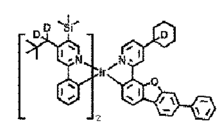
2415
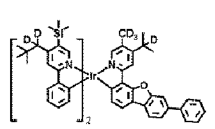
2416
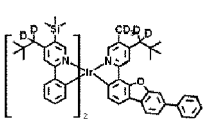
2417
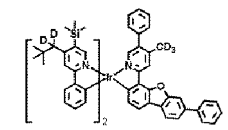
2418
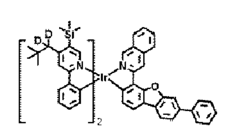
2419
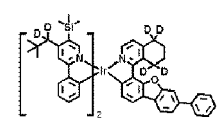
2420
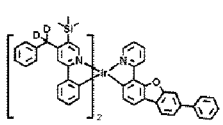
2421
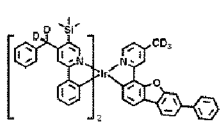
2422
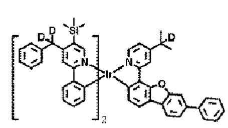
2423
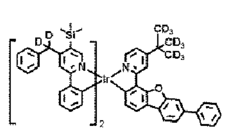
2424
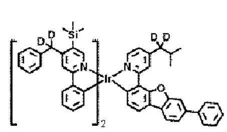
2425
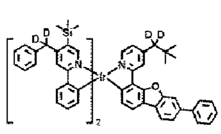
2426
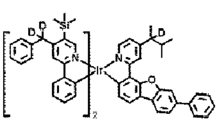
2427
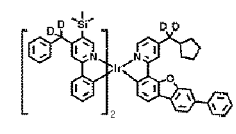
2428
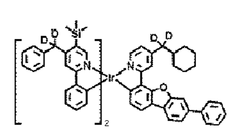
2429
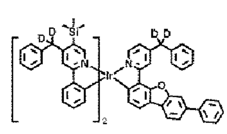
2430
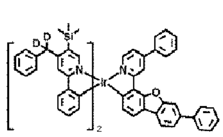
2431
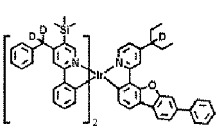
2432
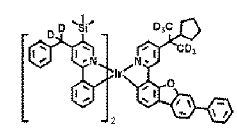
2433
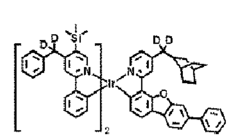
2434
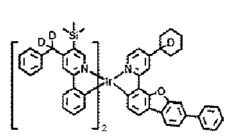
2435
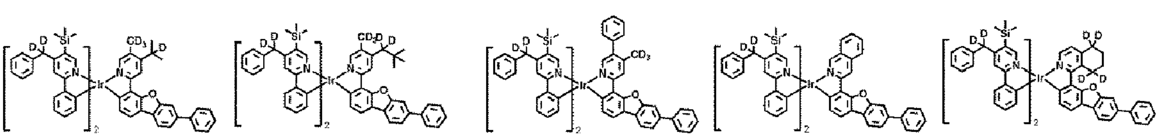
2436
2437
2438
2439
2440
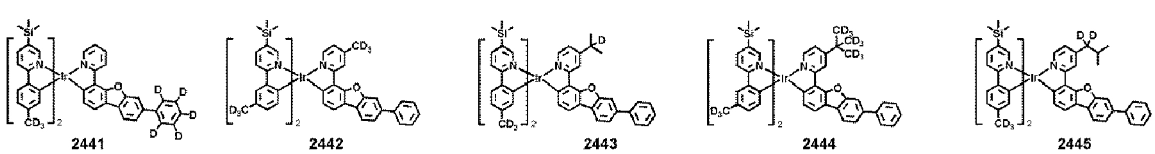
2441
2442
2443
2444
2445

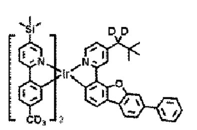
2446
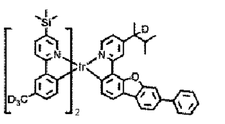
2447
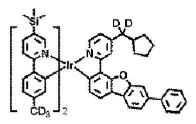
2448
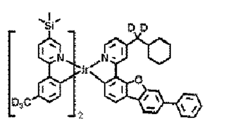
2449
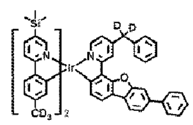
2450

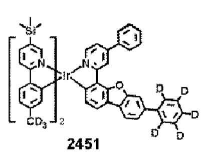
2451
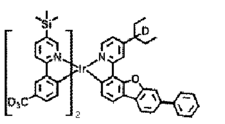
2452
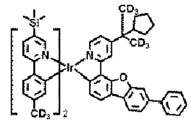
2453
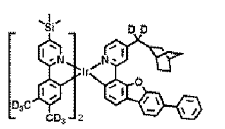
2454
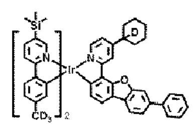
2455

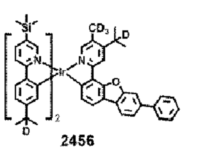
2456
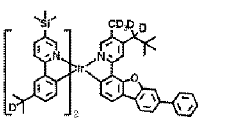
2457
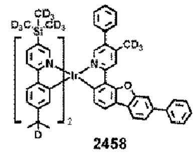
2458
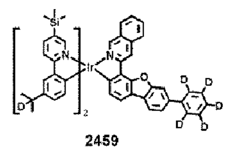
2459
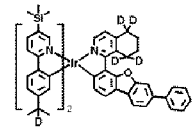
2460

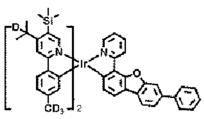
2461
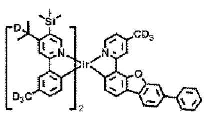
2462
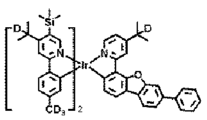
2463
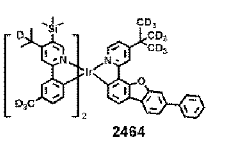
2464
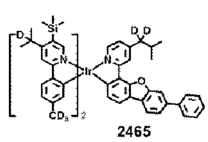
2465

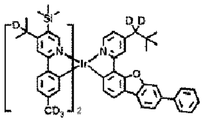
2466
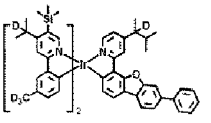
2467
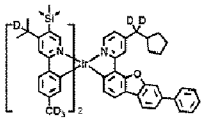
2468
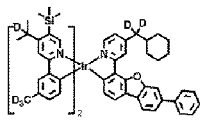
2469
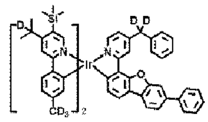
2470

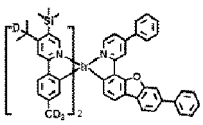
2471
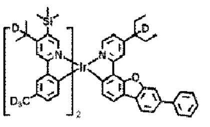
2472
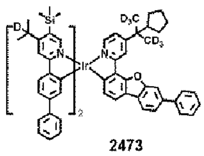
2473
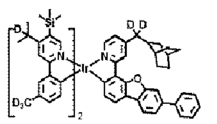
2474
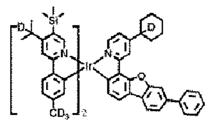
2475

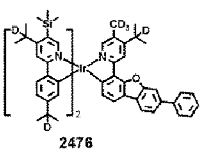
2476
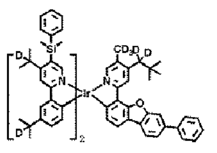
2477
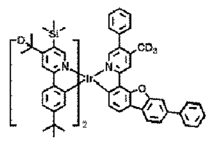
2478
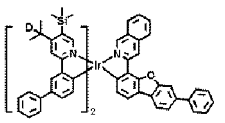
2479
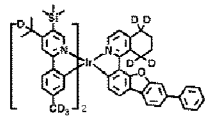
2480

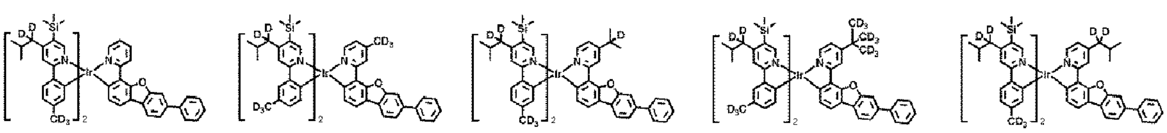
2481 2482 2483 2484 2485

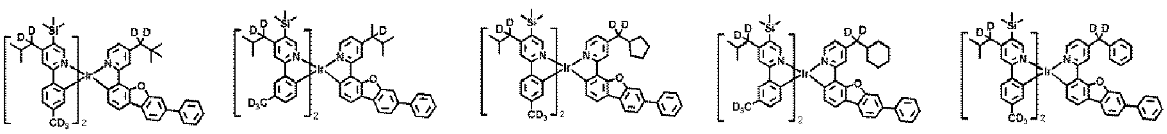
2486 2487 2488 2489 2490

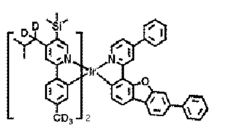
2491
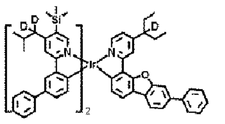
2492
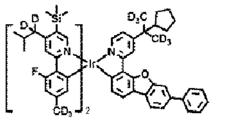
2493
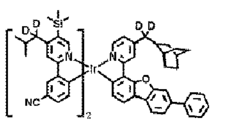
2494
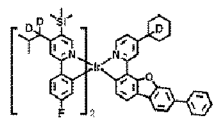
2495

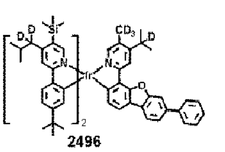
2496
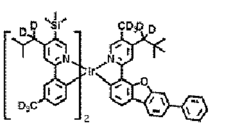
2497
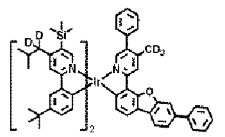
2498
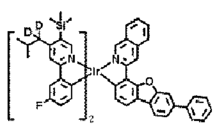
2499
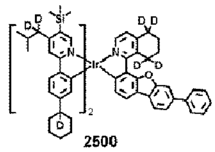
2500

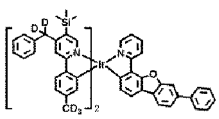
2501
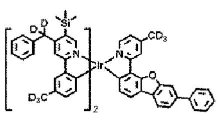
2502
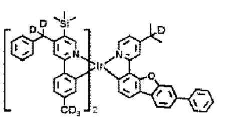
2503
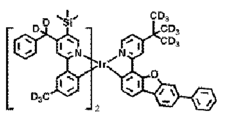
2504
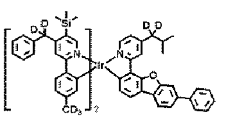
2505

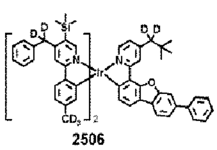
2506
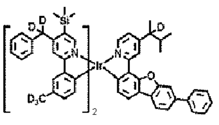
2507
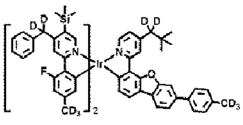
2508
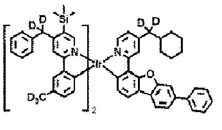
2509
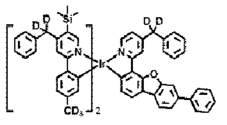
2510

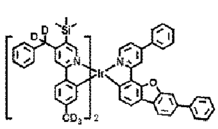
2511
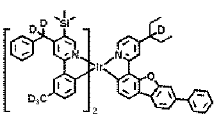
2512
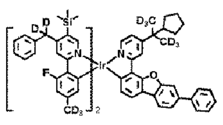
2513
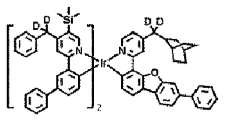
2514
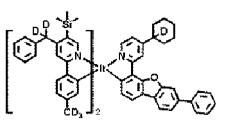
2515

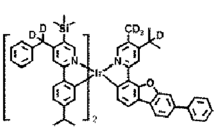
2516
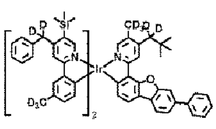
2517
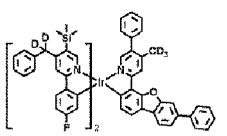
2518
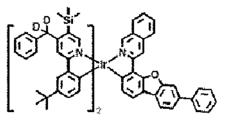
2519
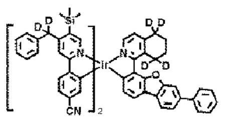
2520

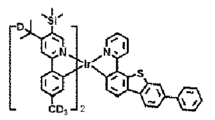
2521
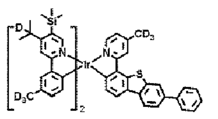
2522
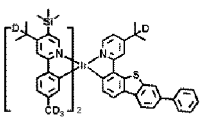
2523
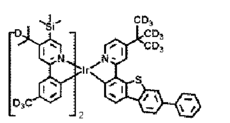
2524
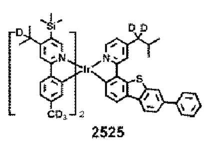
2525

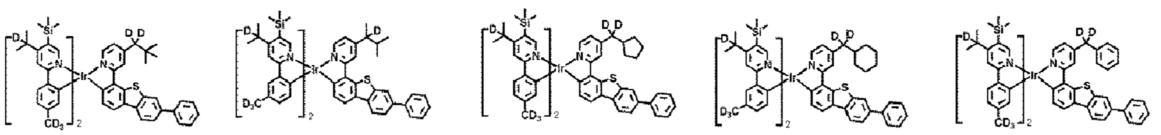
2526
2527
2528
2529
2530

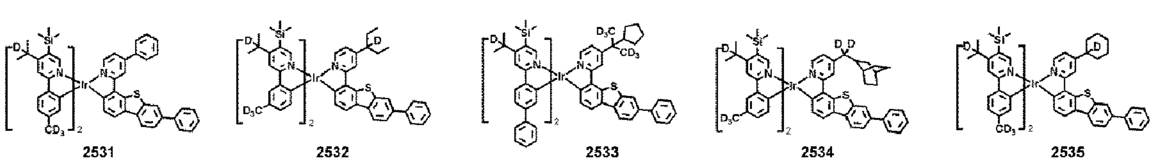
2531
2532
2533
2534
2535

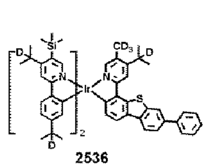
2536
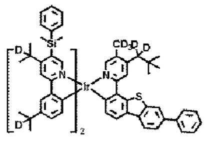
2537
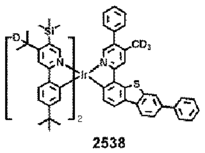
2538
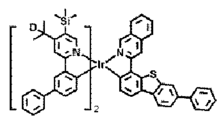
2539
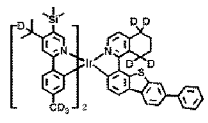
2540

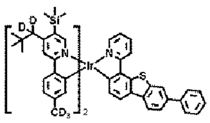
2541
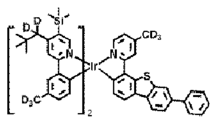
2542
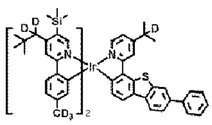
2543
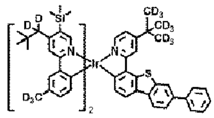
2544
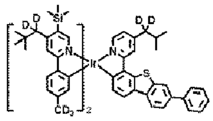
2545

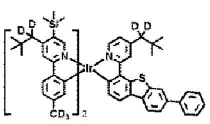
2546
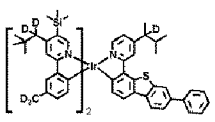
2547
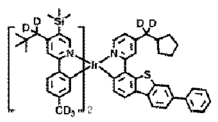
2548
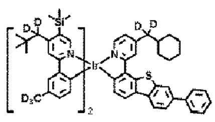
2549
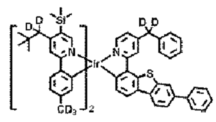
2550

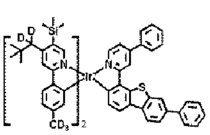
2551
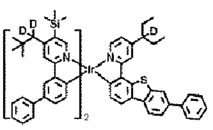
2552
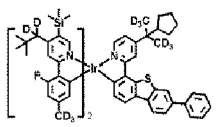
2553
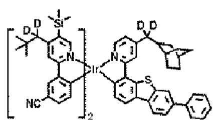
2554
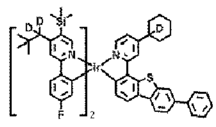
2555

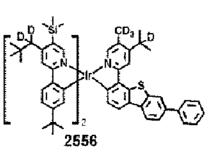
2556
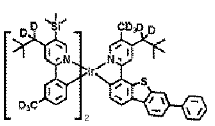
2557
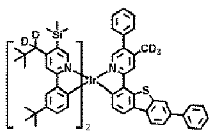
2558
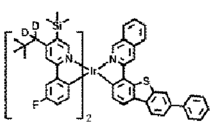
2559
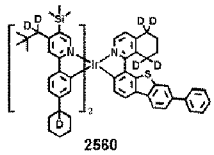
2560

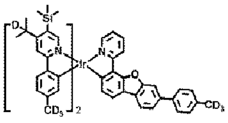
2561
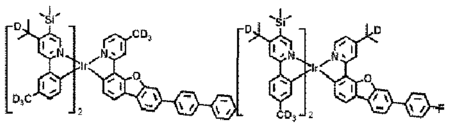
2562
2563
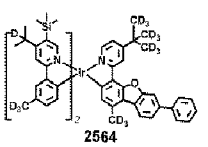
2564
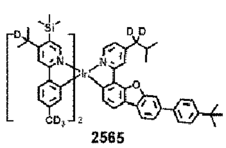
2565

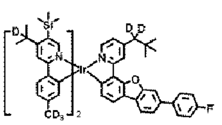
2566
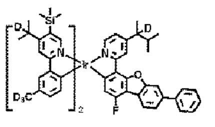
2567
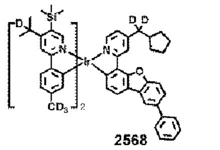
2568
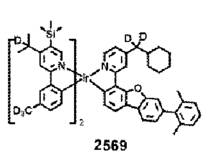
2569
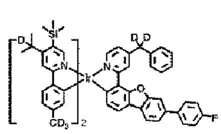
2570

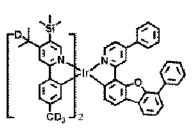
2571
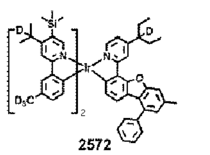
2572
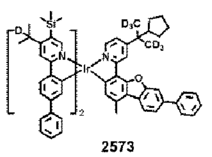
2573
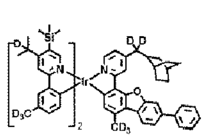
2574
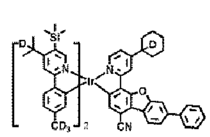
2575

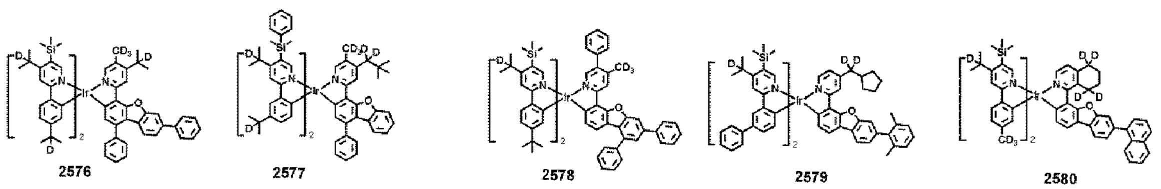
2576
2577
2578
2579
2580

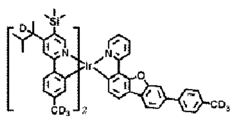
2581
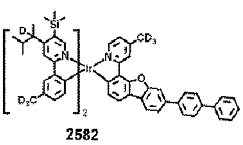
2582
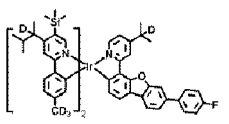
2583
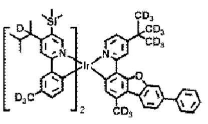
2584
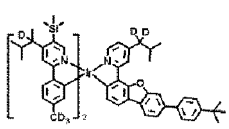
2585

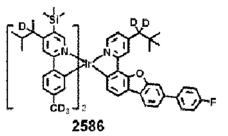
2586
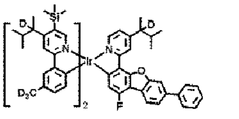
2587
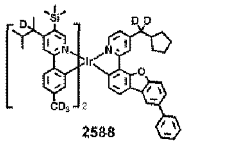
2588
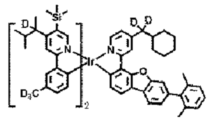
2589
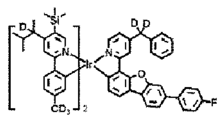
2590

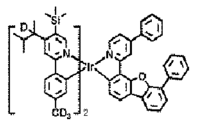
2591
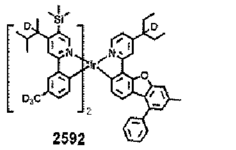
2592
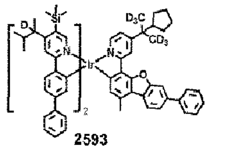
2593
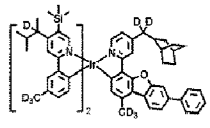
2594
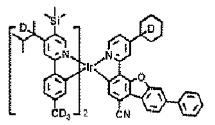
2595

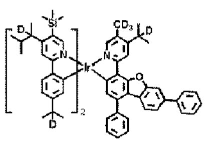
2596
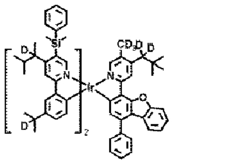
2597
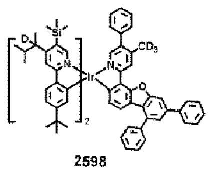
2598
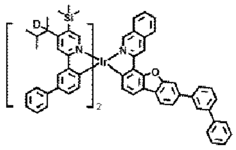
2599
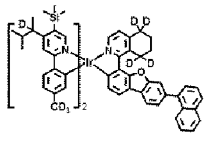
2600

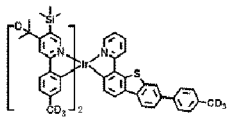
2601
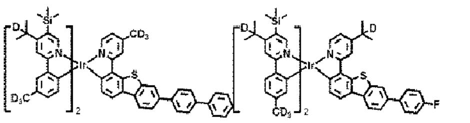
2602
2603
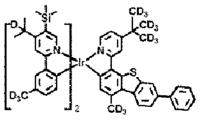
2604
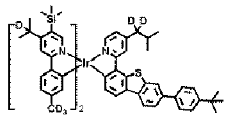
2605

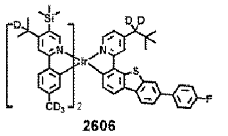
2606
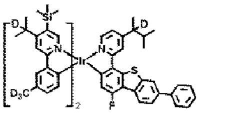
2607
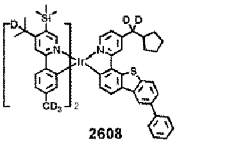
2608
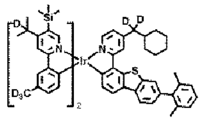
2609
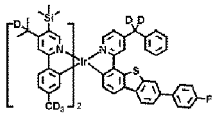
2610

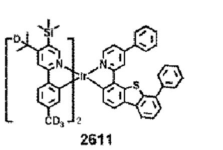
2611
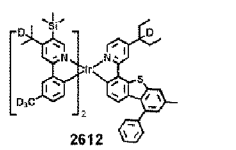
2612
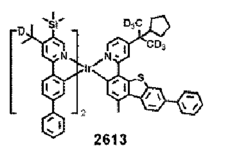
2613
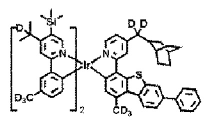
2614
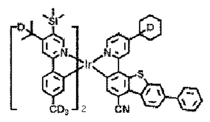
2615

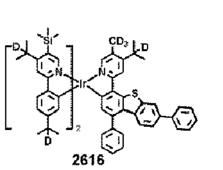
2616
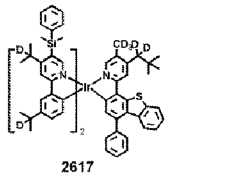
2617
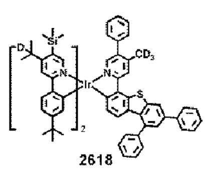
2618
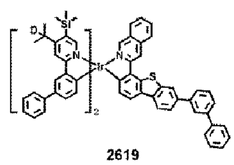
2619
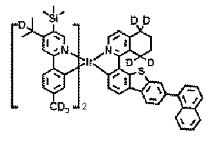
2620

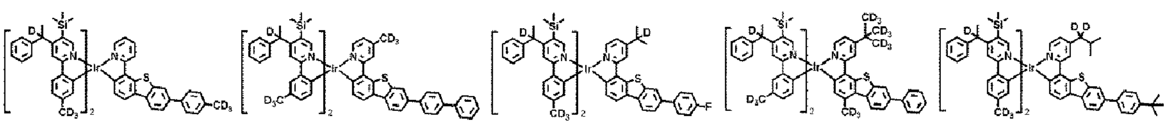
2621
2622
2623
2624
2625

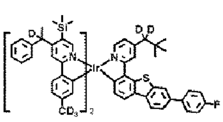
2626

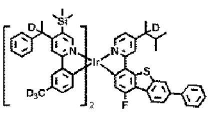
2627

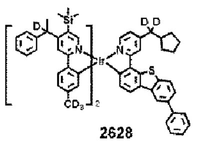
2628

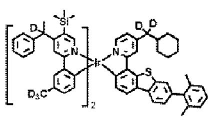
2629

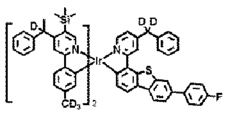
2630

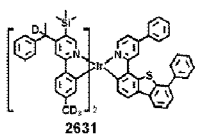
2631

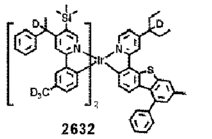
2632

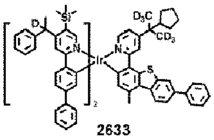
2633

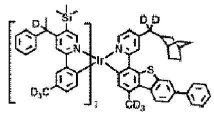
2634

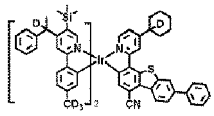
2635

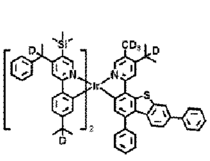
2636

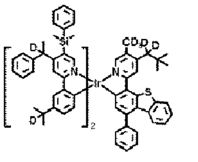
2637

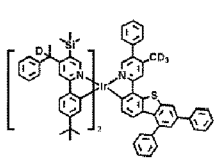
2638

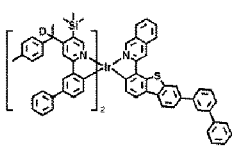
2639

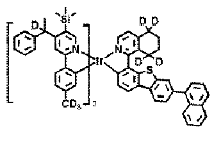
2640

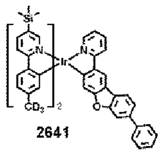
2641

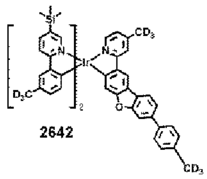
2642

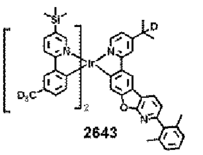
2643

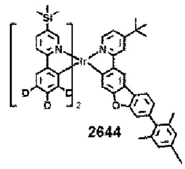
2644

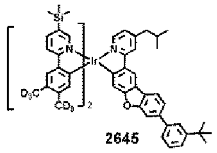
2645

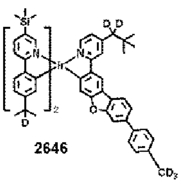
2646

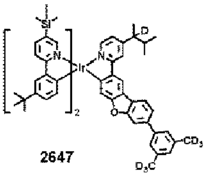
2647

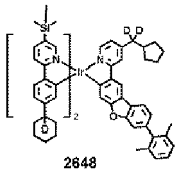
2648

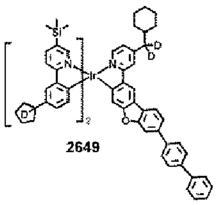
2649

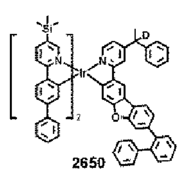
2650

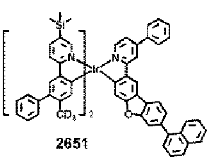
2651

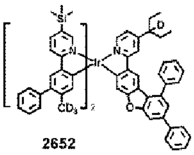
2652

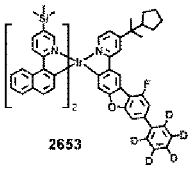
2653

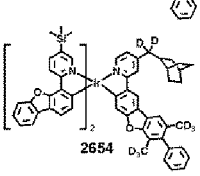
2654

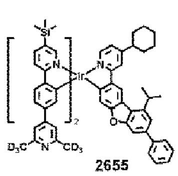
2655

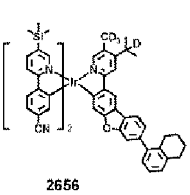
2656

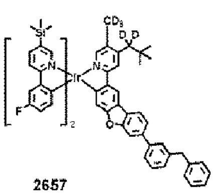
2657

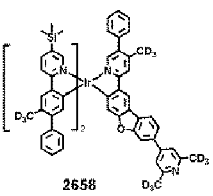
2658

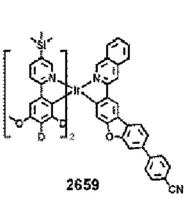
2659

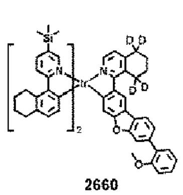
2660

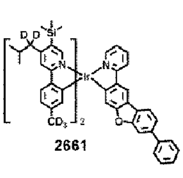
2661

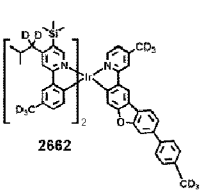
2662

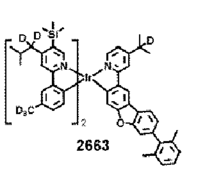
2663

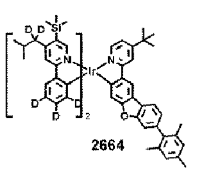
2664

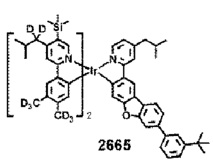
2665

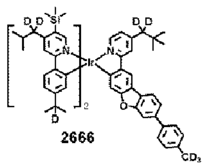
2666

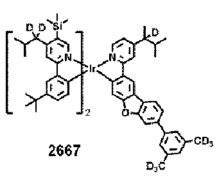
2667

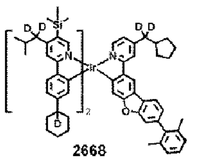
2668

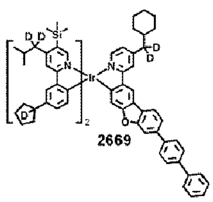
2669

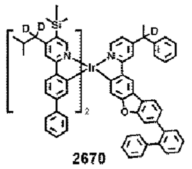
2670

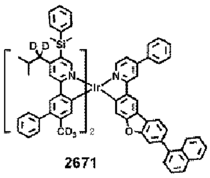
2671

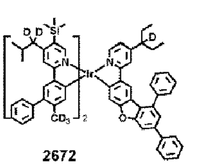
2672

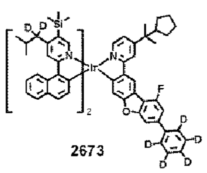
2673

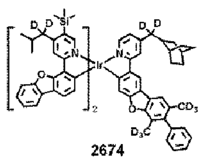
2674

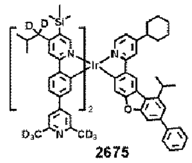
2675

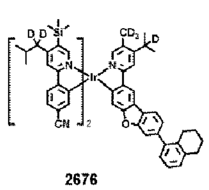
2676

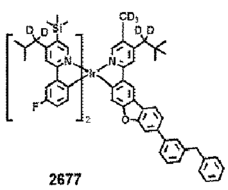
2677

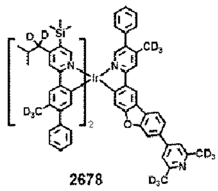
2678

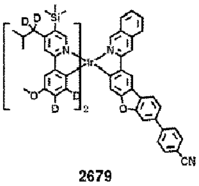
2679

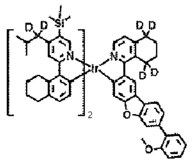
2680

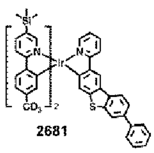
2681

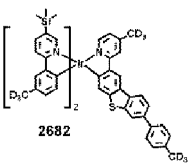
2682

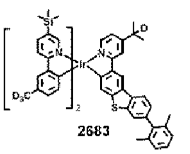
2683

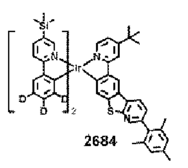
2684

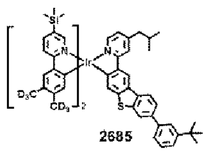
2685

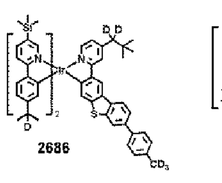
2686

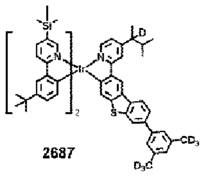
2687

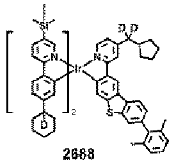
2688

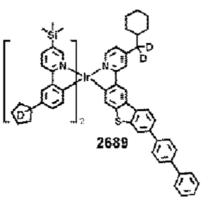
2689

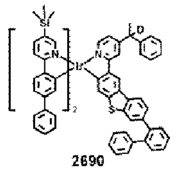
2690

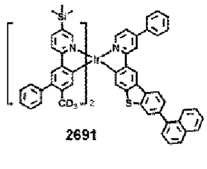
2691

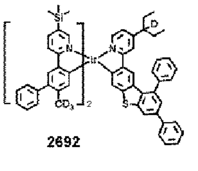
2692

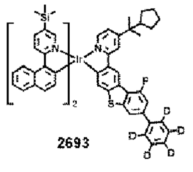
2693

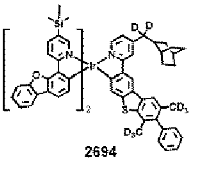
2694

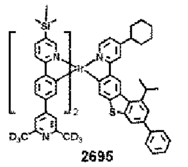
2695

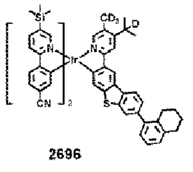
2696

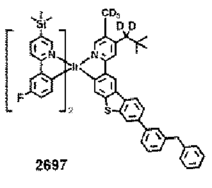
2697

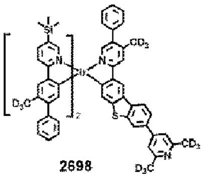
2698

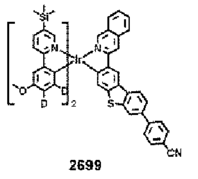
2699

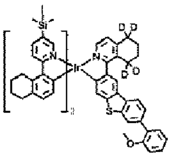
2700

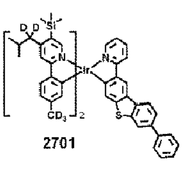
2701

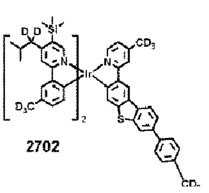
2702

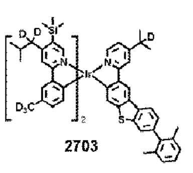
2703

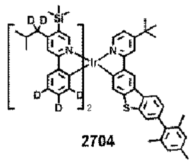
2704

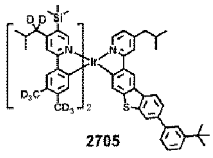
2705

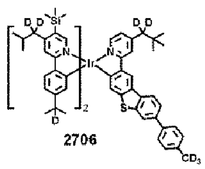
2706
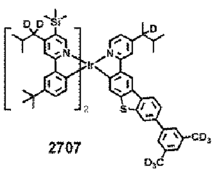
2707
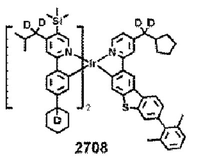
2708
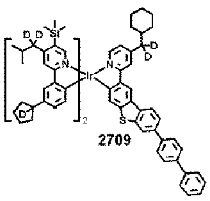
2709
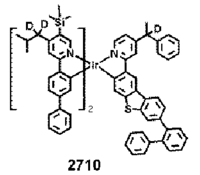
2710

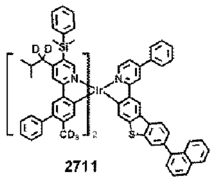
2711
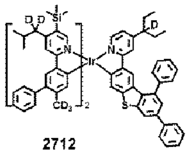
2712
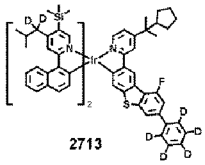
2713
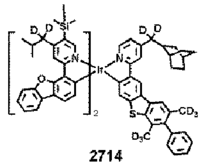
2714
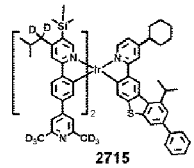
2715

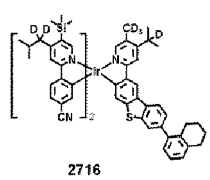
2716
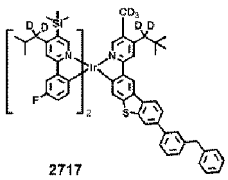
2717
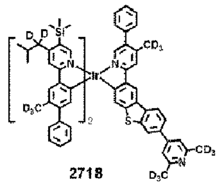
2718
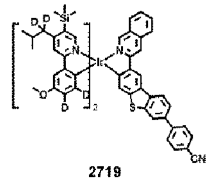
2719
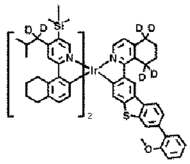
2720

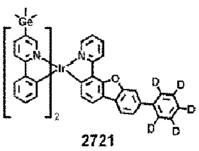
2721
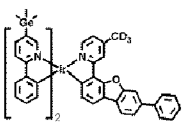
2722
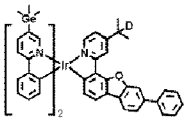
2723
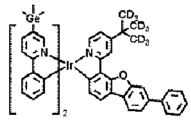
2724
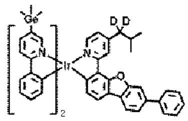
2725

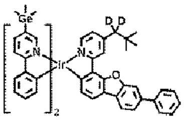
2726
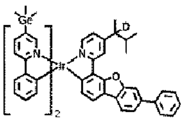
2727
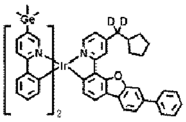
2728
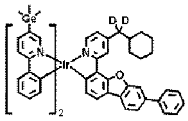
2729
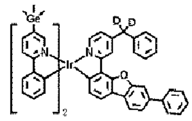
2730

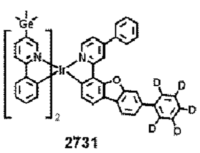
2731
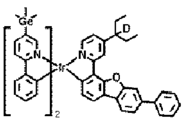
2732
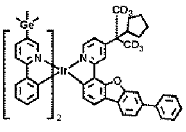
2733
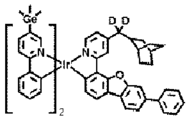
2734
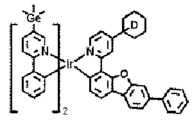
2735

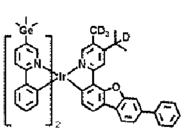
2736
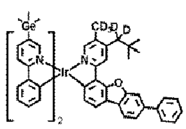
2737
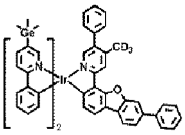
2738
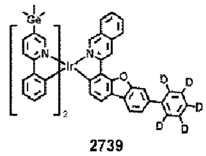
2739
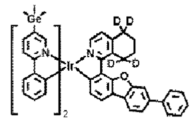
2740

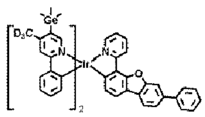
2741
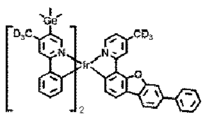
2742
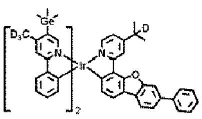
2743
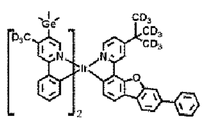
2744
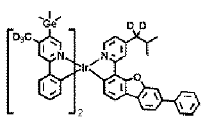
2745

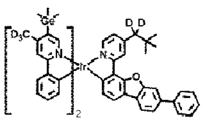
2746

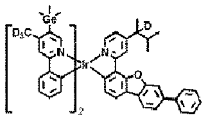
2747

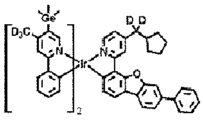
2748

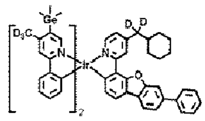
2749

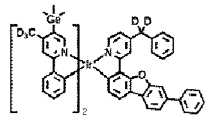
2750

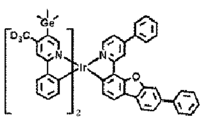
2751

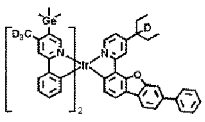
2752

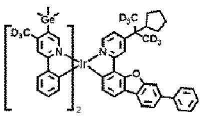
2753

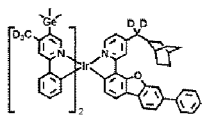
2754

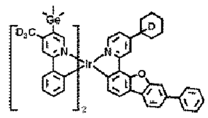
2755

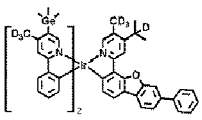
2756

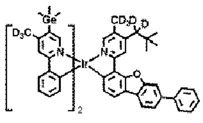
2757

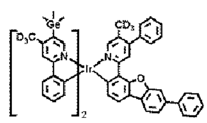
2758

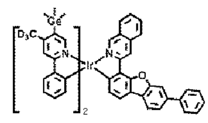
2759

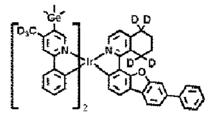
2760

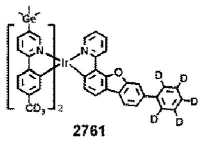
2761

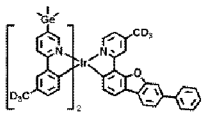
2762

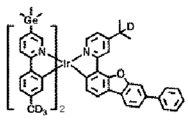
2763

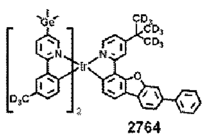
2764

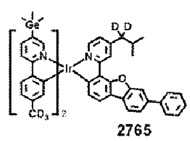
2765

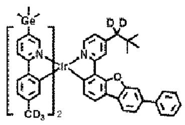
2766

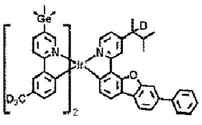
2767

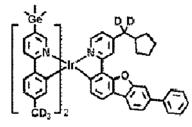
2768

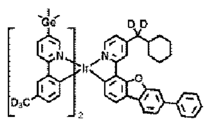
2769

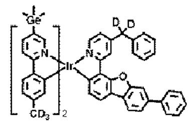
2770

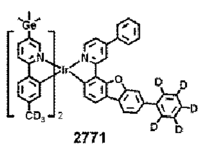
2771

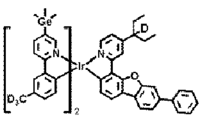
2772

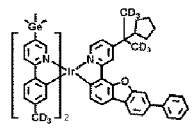
2773

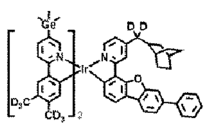
2774

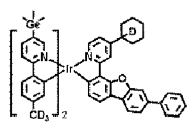
2775

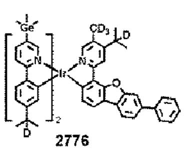
2776

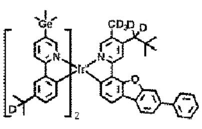
2777

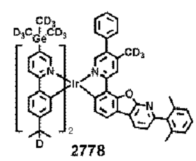
2778

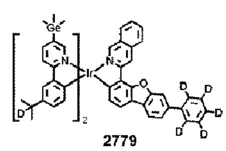
2779

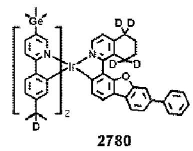
2780

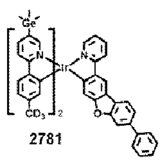
2781

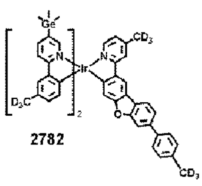
2782

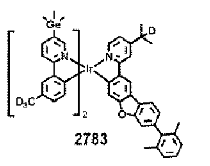
2783

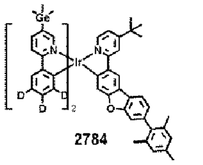
2784

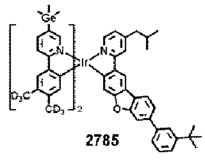
2785

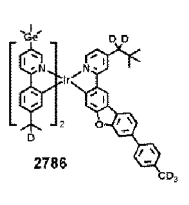
2786
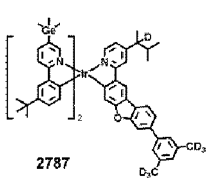
2787
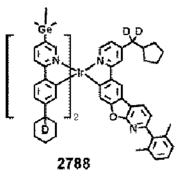
2788
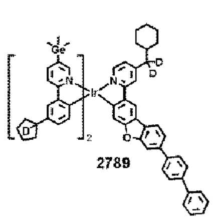
2789
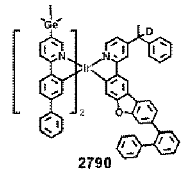
2790
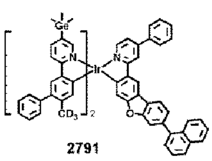
2791
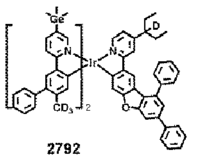
2792
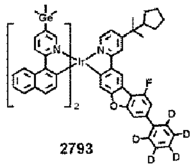
2793
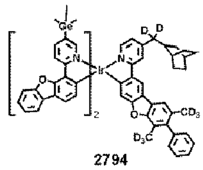
2794
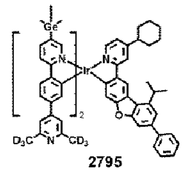
2795
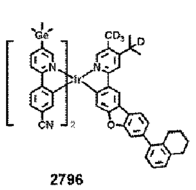
2796
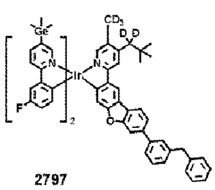
2797
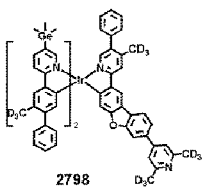
2798
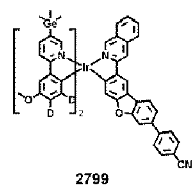
2799
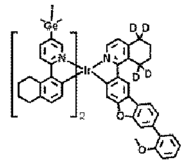
2800
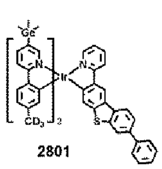
2801
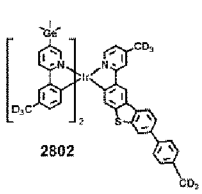
2802
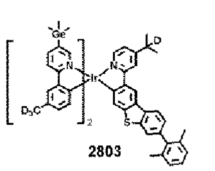
2803
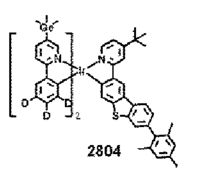
2804
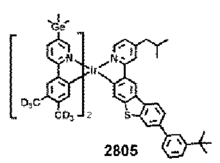
2805
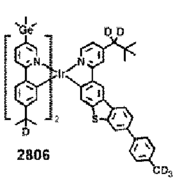
2806
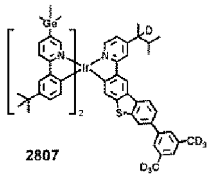
2807
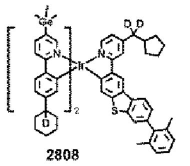
2808
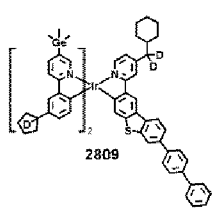
2809
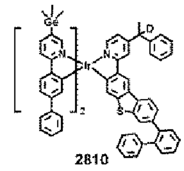
2810
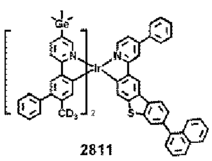
2811
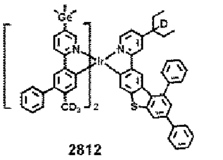
2812
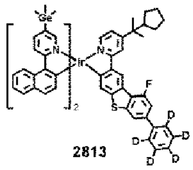
2813
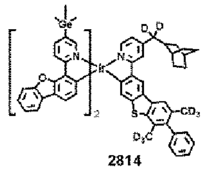
2814
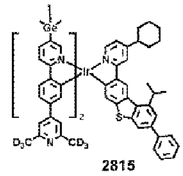
2815
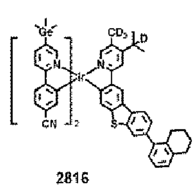
2816
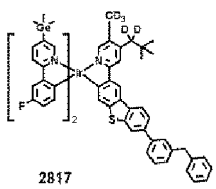
2817
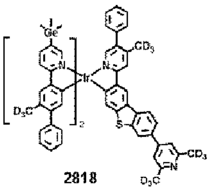
2818
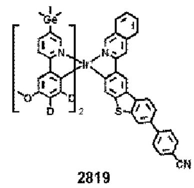
2819
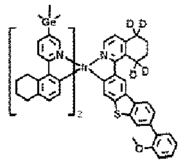
2820

Group 1-7

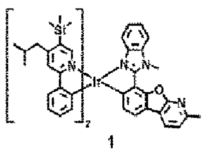
1
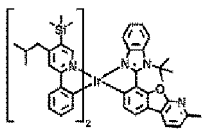
2
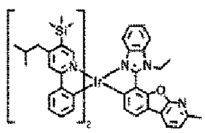
3
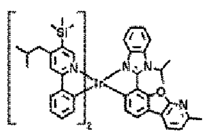
4
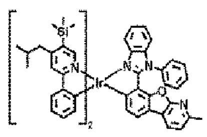
5

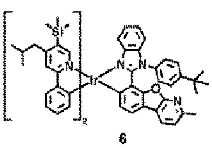
6
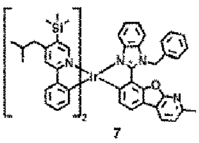
7
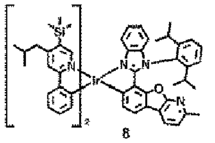
8
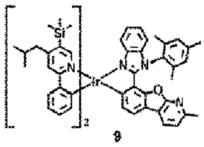
9
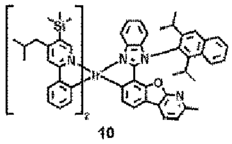
10

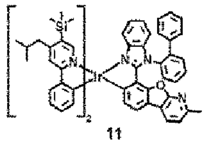
11
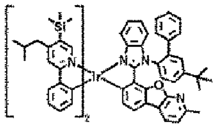
12
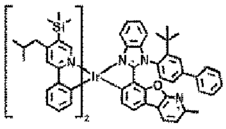
13
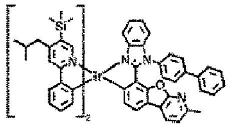
14
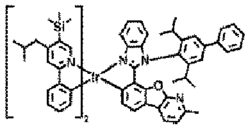
15

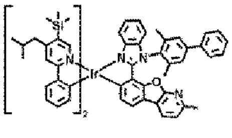
16
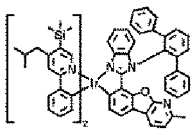
17
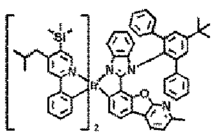
18
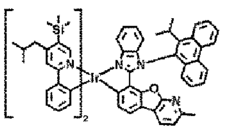
19
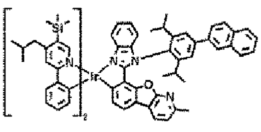
20

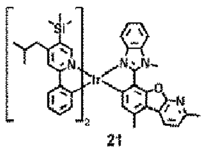
21
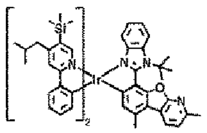
22
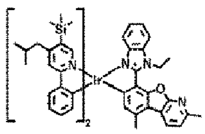
23
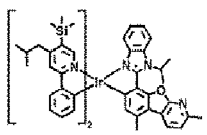
24
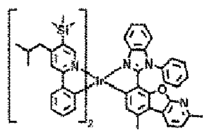
25

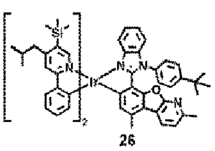
26
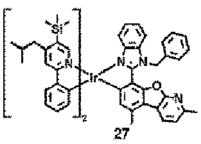
27
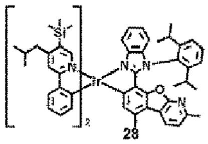
28
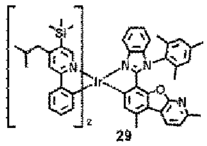
29
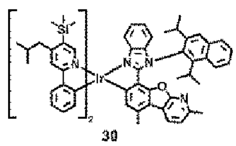
30

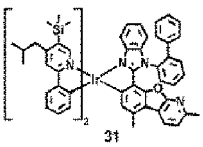
31
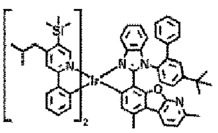
32
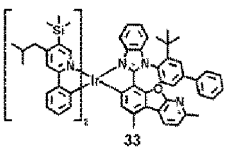
33
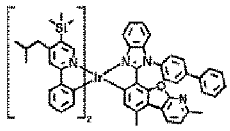
34
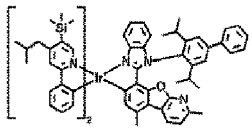
35

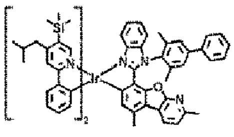
36
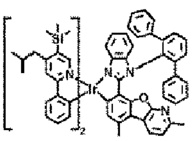
37
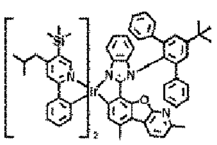
38
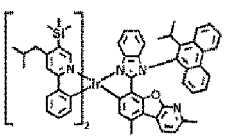
39
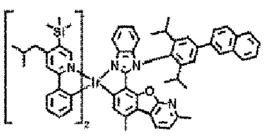
40

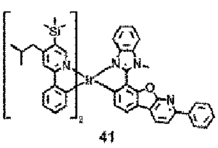
41
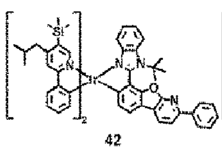
42
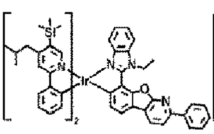
43
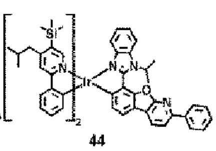
44
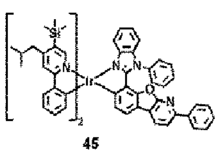
45

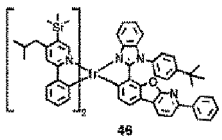
46
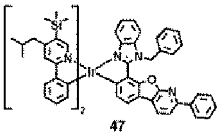
47
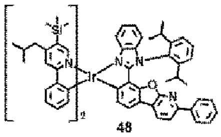
48
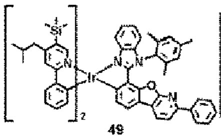
49
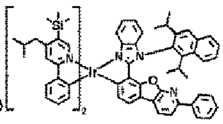
50

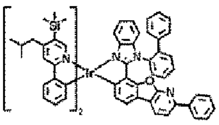
51
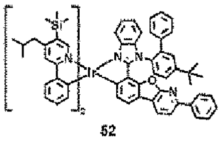
52
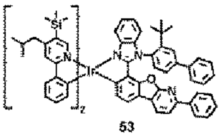
53
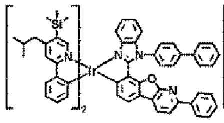
54
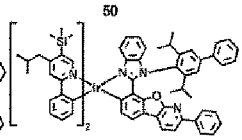
55

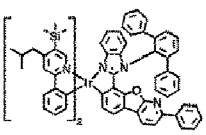
56
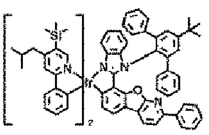
57
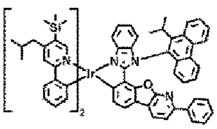
58
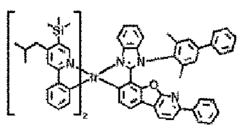
59
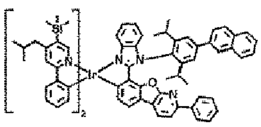
60

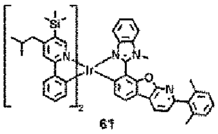
61
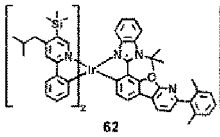
62
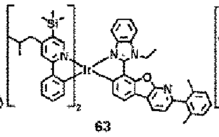
63
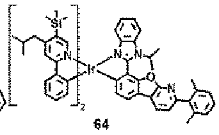
64
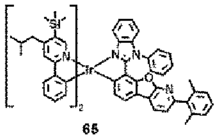
65

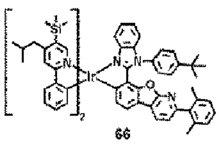
66
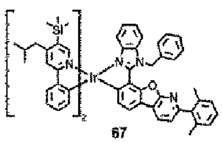
67
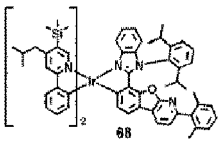
68
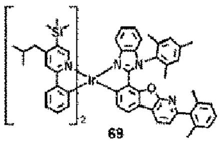
69
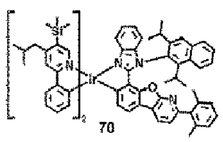
70

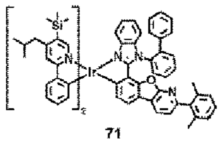
71
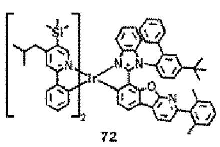
72
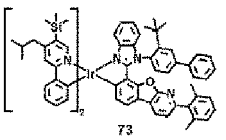
73
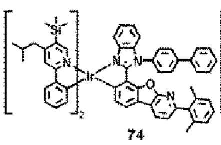
74
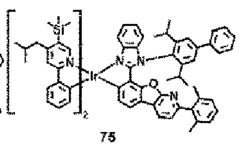
75

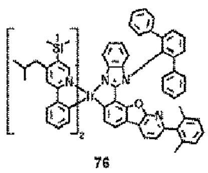
76
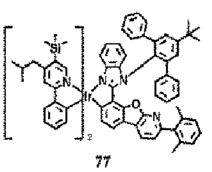
77
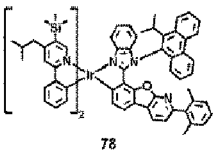
78
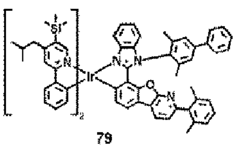
79
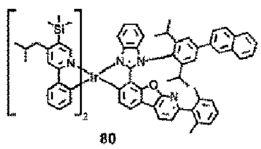
80

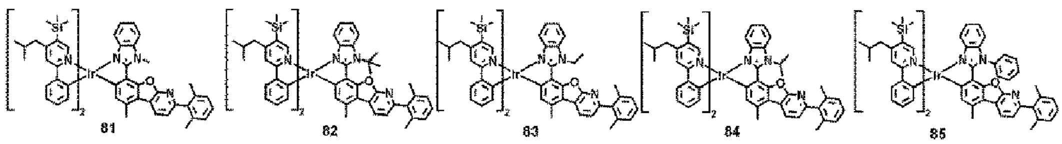
81 82 83 84 85

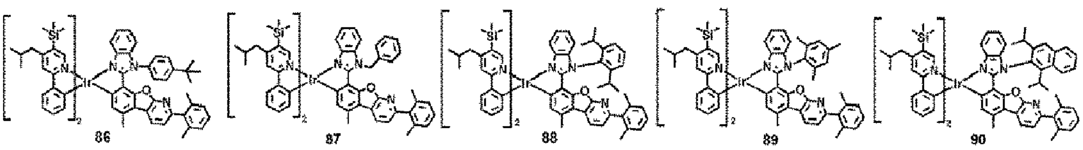
86 87 88 89 90

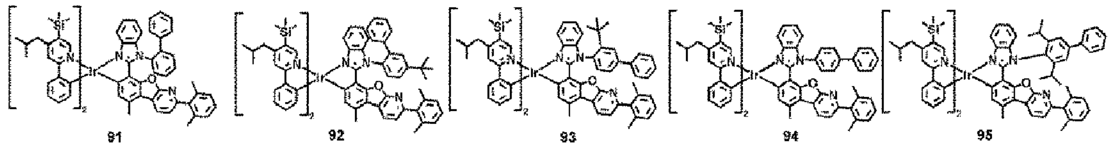

91 92 93 94 95

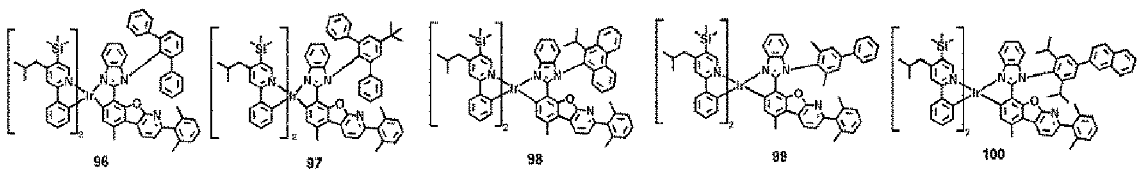

96 97 98 99 100

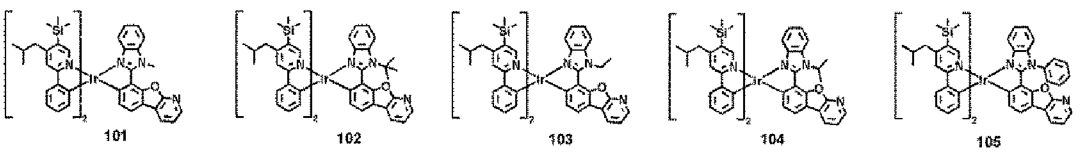

101 102 103 104 105

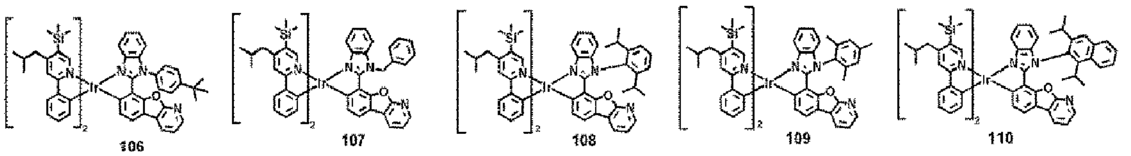

106 107 108 109 110

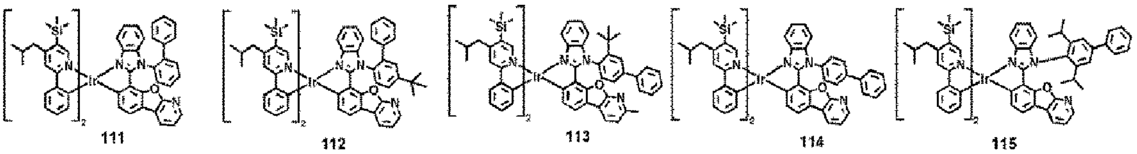

111 112 113 114 115

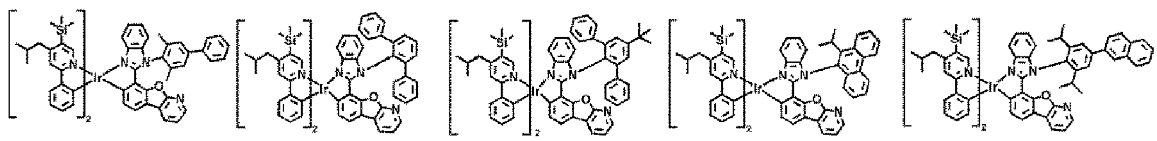

116 117 118 119 120

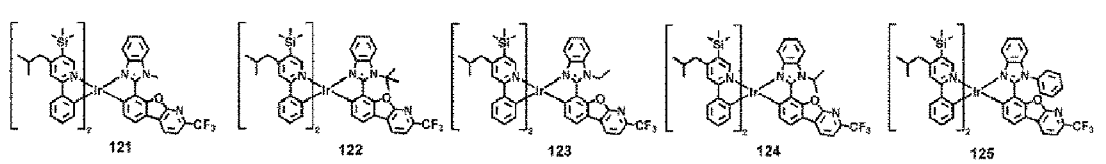

121 122 123 124 125

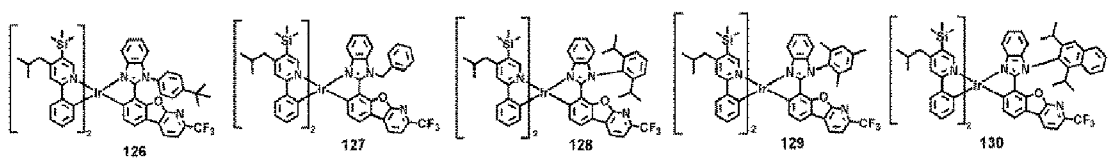

126 127 128 129 130

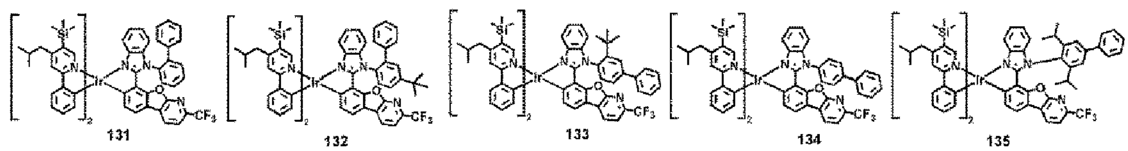

131 132 133 134 135

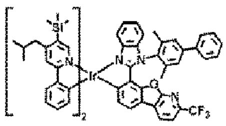
136
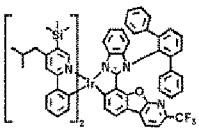
137
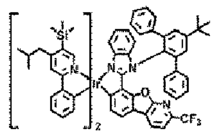
138
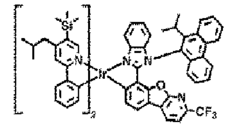
139
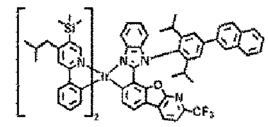
140

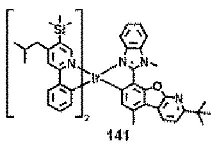
141
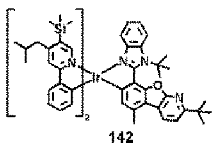
142
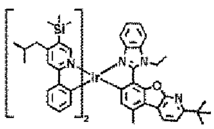
143
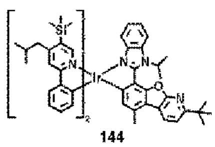
144
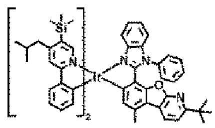
145

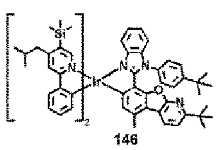
146
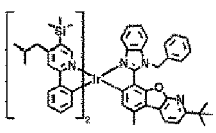
147
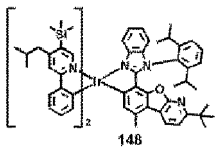
148
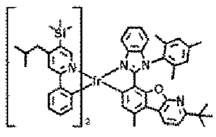
149
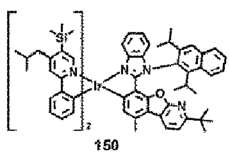
150

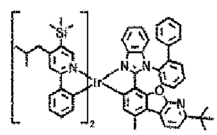
151
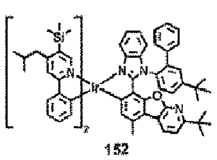
152
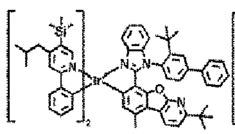
153
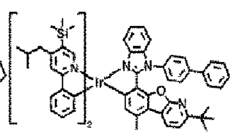
154
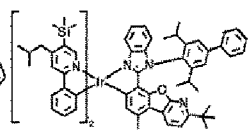
155

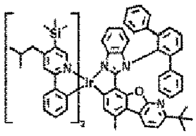
156
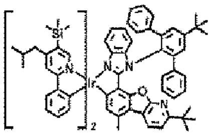
157
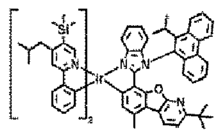
158
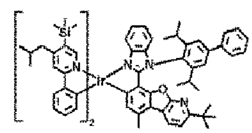
159
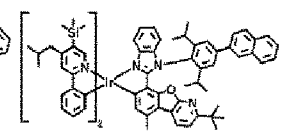
160

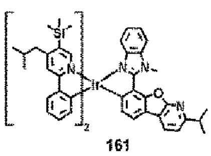
161
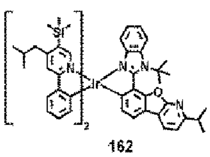
162
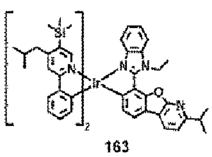
163
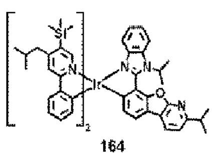
164
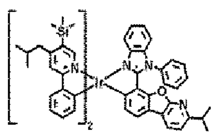
165

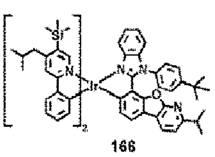
166
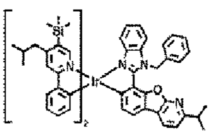
167
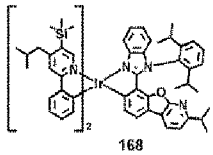
168
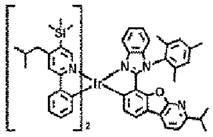
169
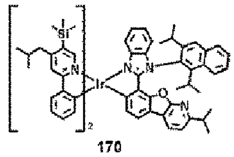
170

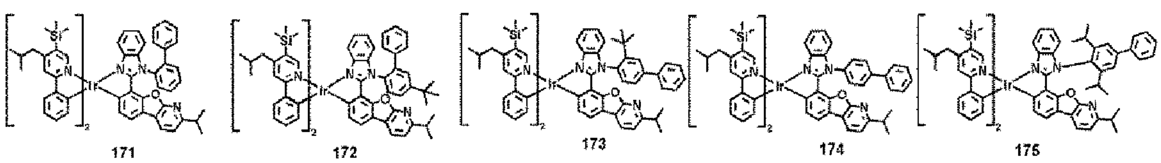
171
172
173
174
175

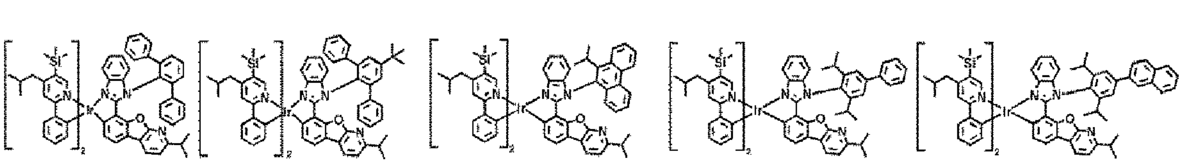
176
177
178
179
180

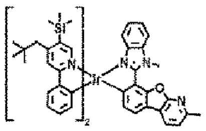
181
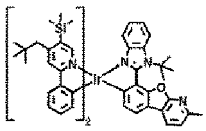
182
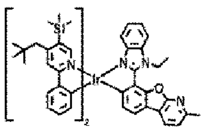
183
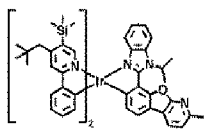
184
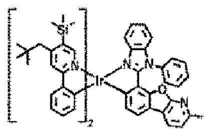
185
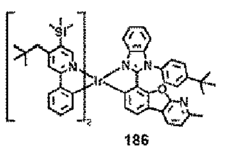
186
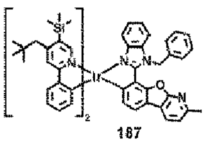
187
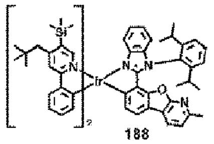
188
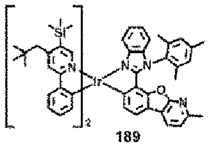
189
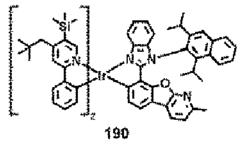
190
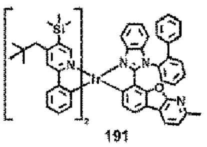
191
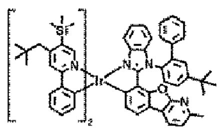
192
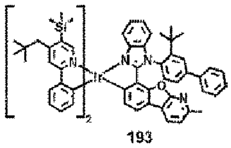
193
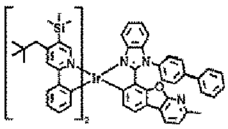
194
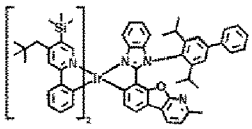
195
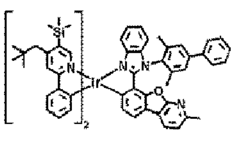
196
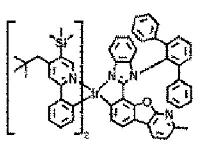
197
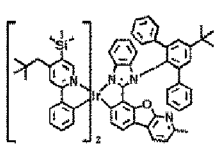
198
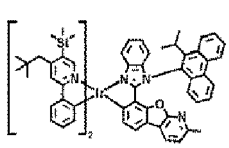
199
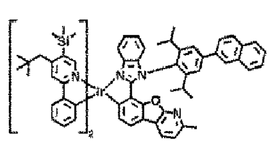
200
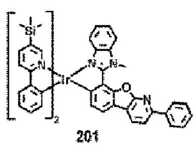
201
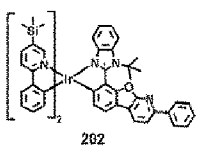
202
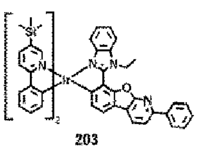
203
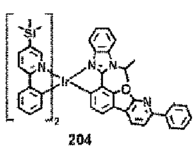
204
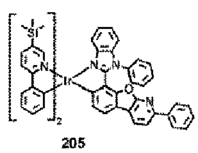
205
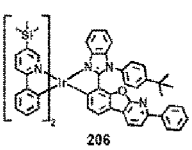
206
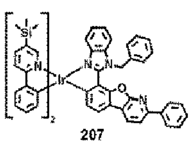
207
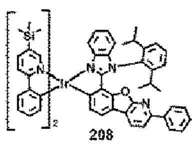
208
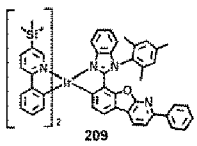
209
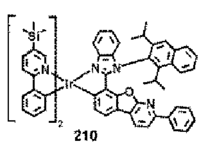
210
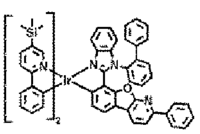
211
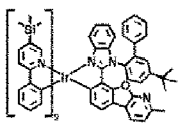
212
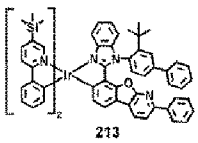
213
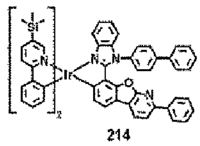
214
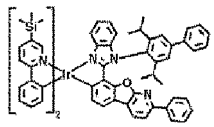
215
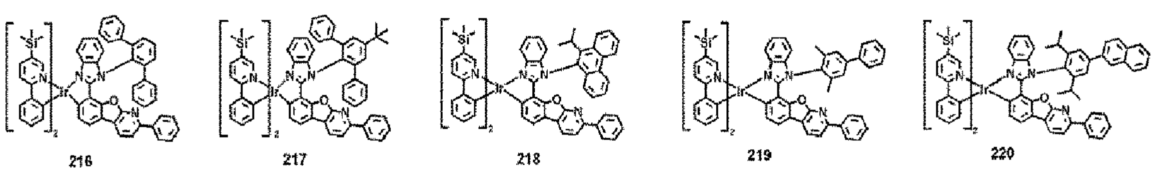
216 217 218 219 220
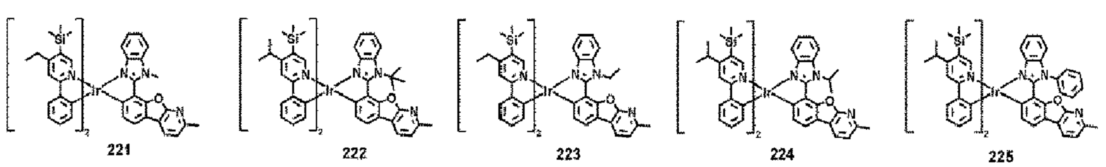
221 222 223 224 225

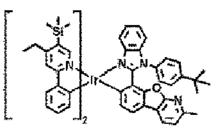
226
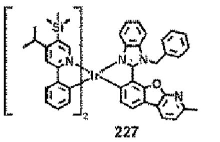
227
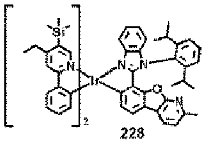
228
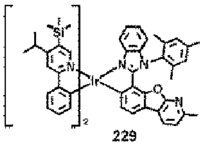
229
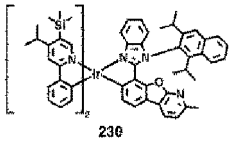
230
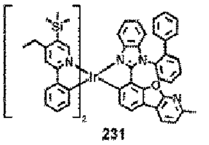
231
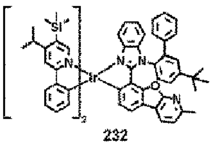
232
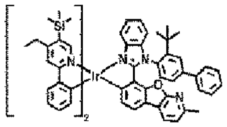
233
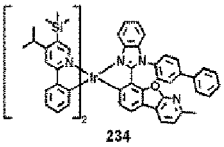
234
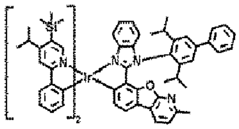
235
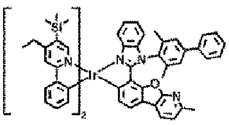
236
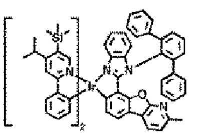
237
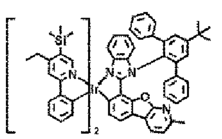
238
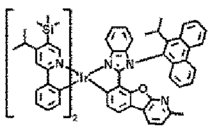
239
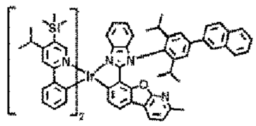
240
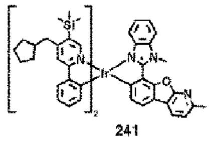
241
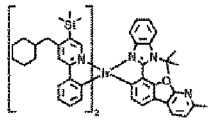
242
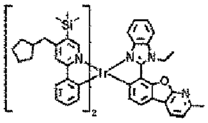
243
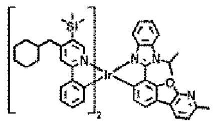
244
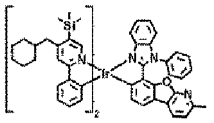
245
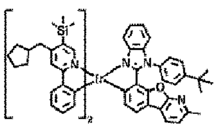
246
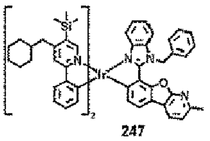
247
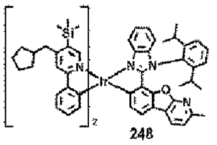
248
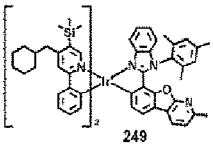
249
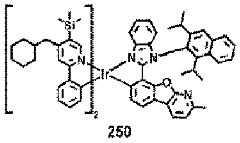
250
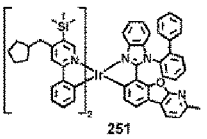
251
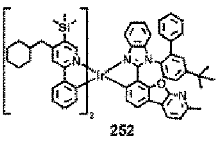
252
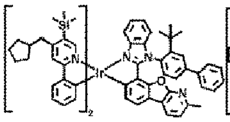
253
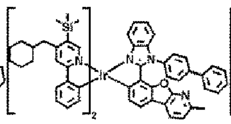
254
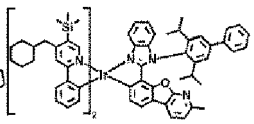
255
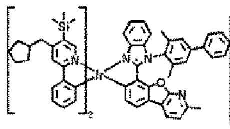
256
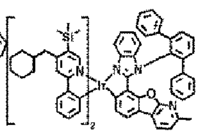
257
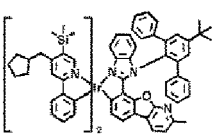
258
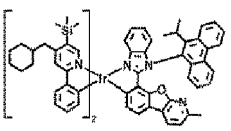
259
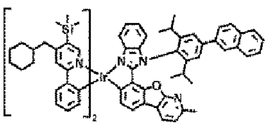
260
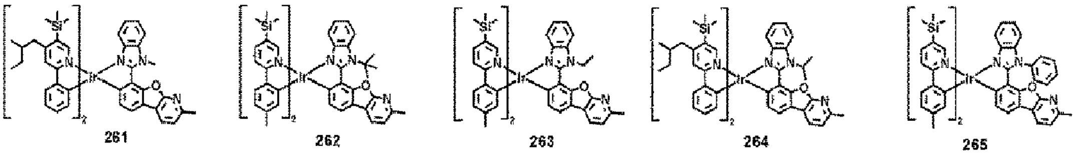
261 262 263 264 265
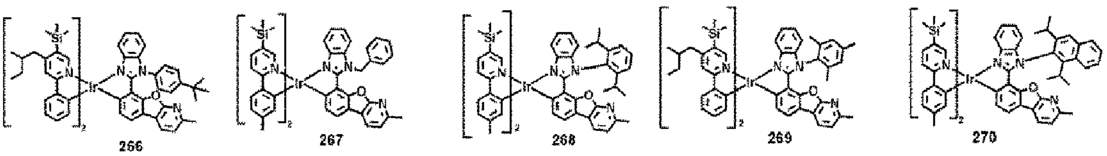
266 267 268 269 270

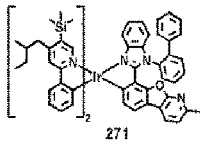
271
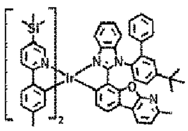
272
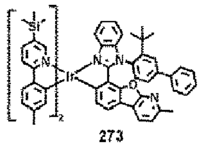
273
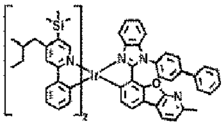
274
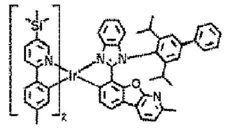
275

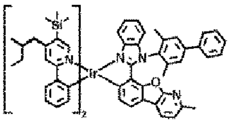
276
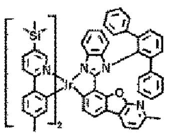
277
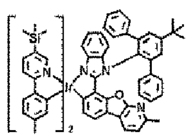
278
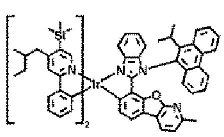
279
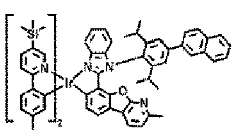
280

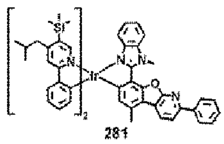
281
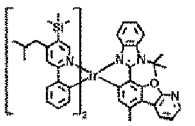
282
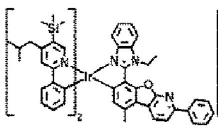
283
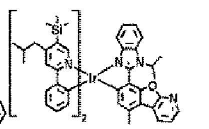
284
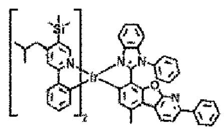
285

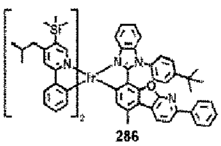
286
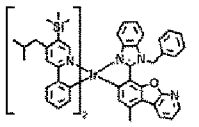
287
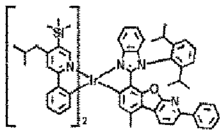
288
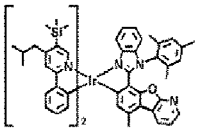
289
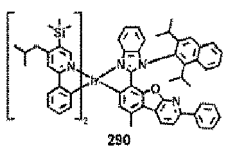
290

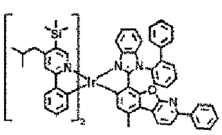
291
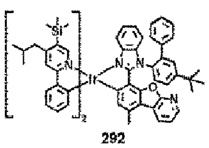
292
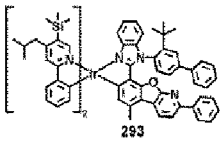
293
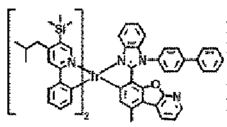
294
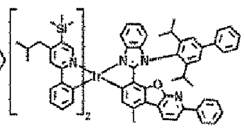
295

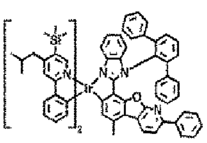
296
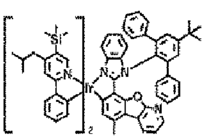
297
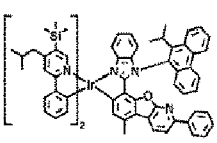
298
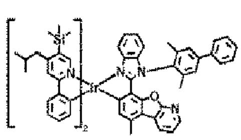
299
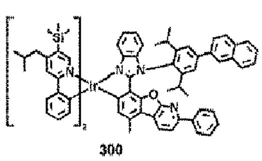
300

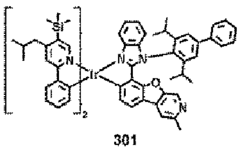
301

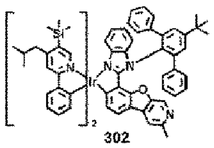
302

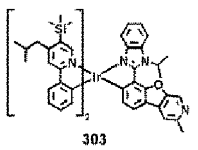
303

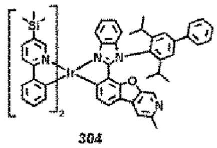
304

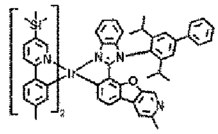
305

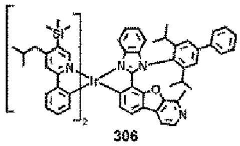
306

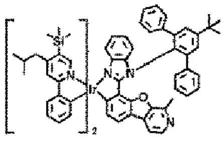
307

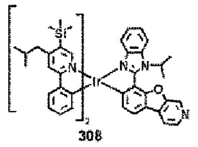
308

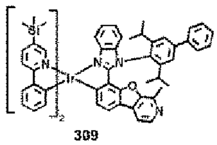
309

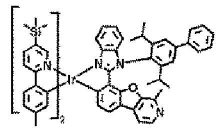
310

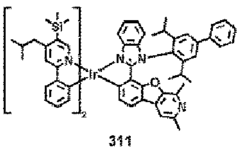
311

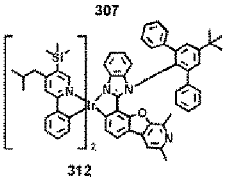
312

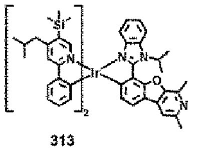
313

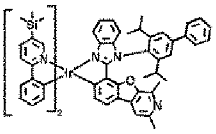
314

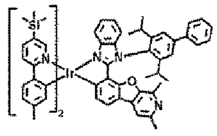
315

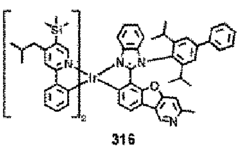
316

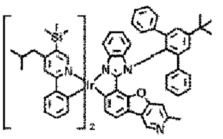
317

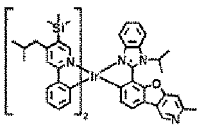
318

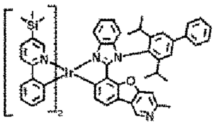
319

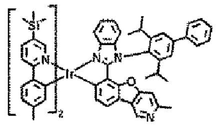
320

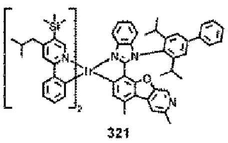
321

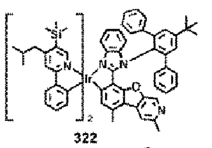
322

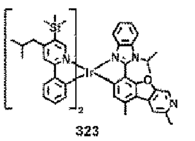
323

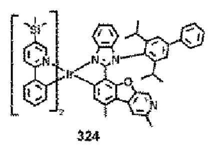
324

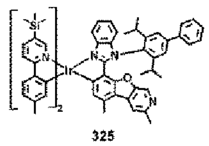
325

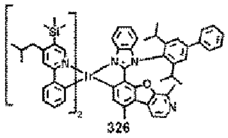
326

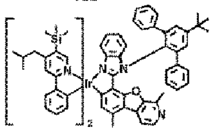
327

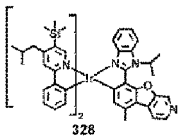
328

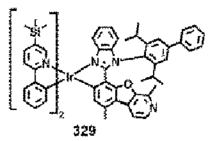
329

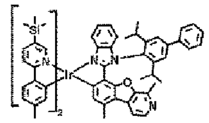
330

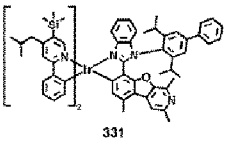
331

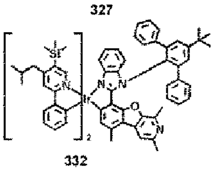
332

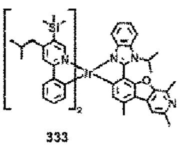
333

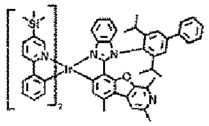
334

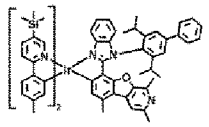
335

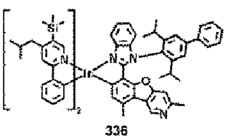
336

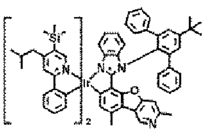
337

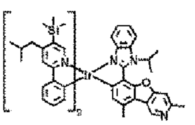
338

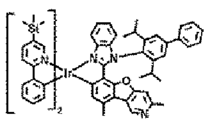
339

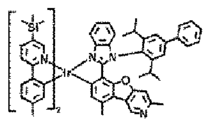
340

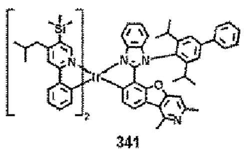
341
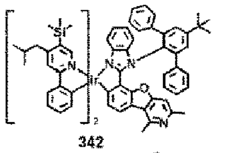
342
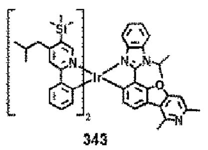
343
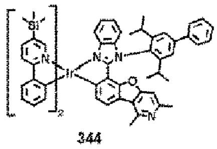
344
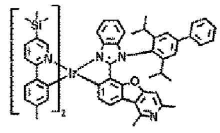
345

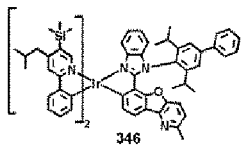
346
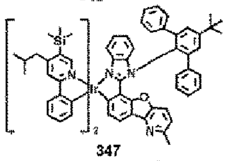
347
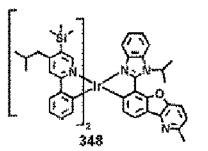
348
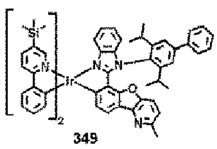
349
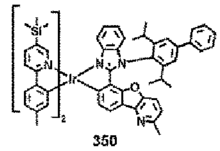
350

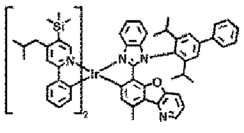
351
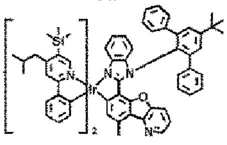
352
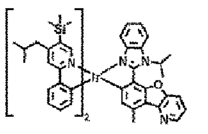
353
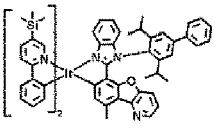
354
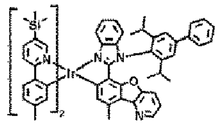
355

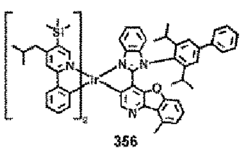
356
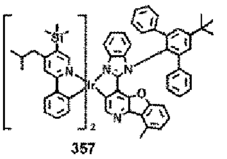
357
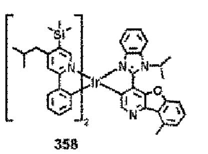
358
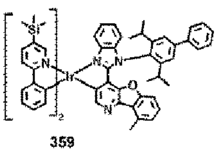
359
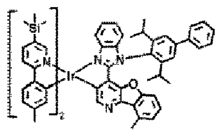
360

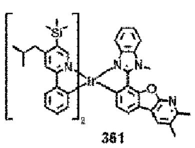
361
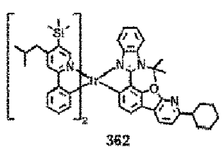
362
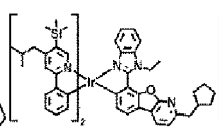
363
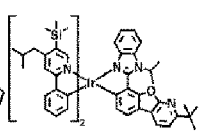
364
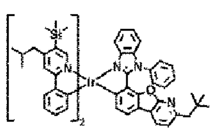
365

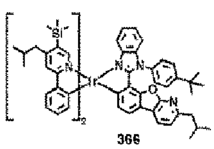
366
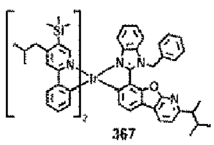
367
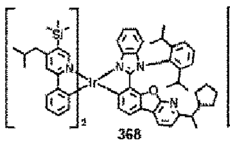
368
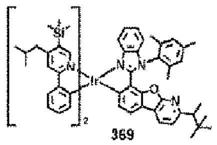
369
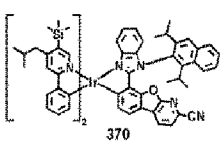
370

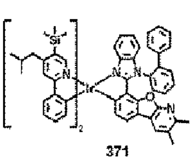
371
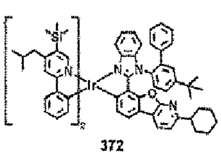
372
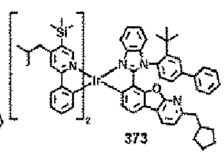
373
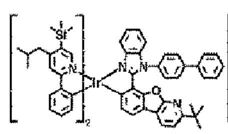
374
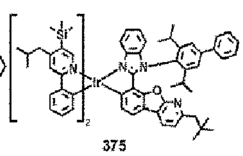
375

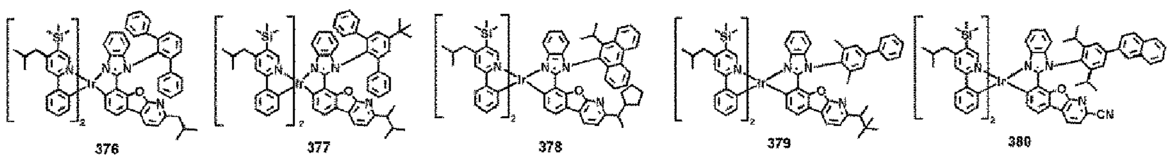
376
377
378
379
380

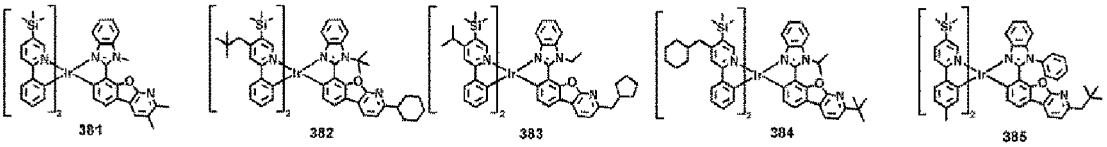
381
382
383
384
385

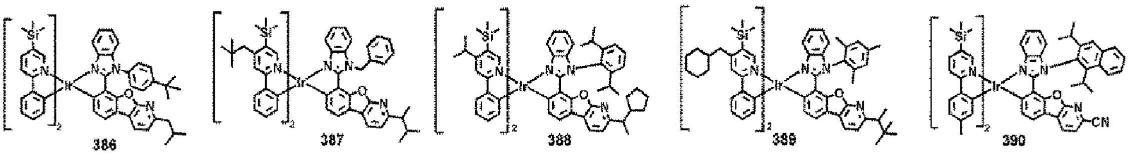
386
387
388
389
390

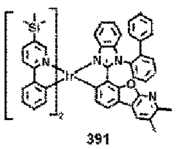
391

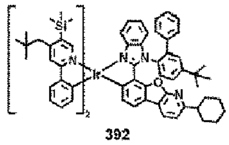
392

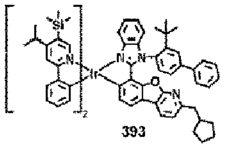
393

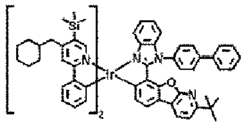
394

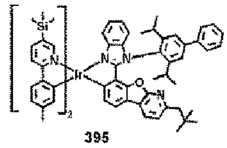
395

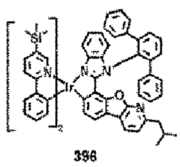
396

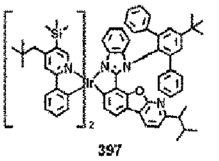
397

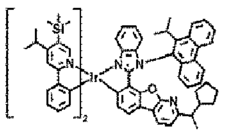
398

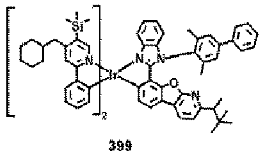
399

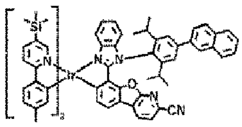
400

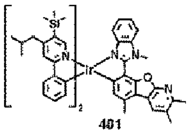
401

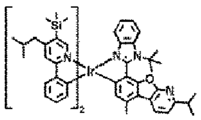
402

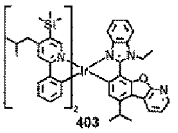
403

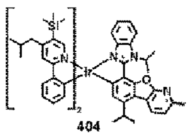
404

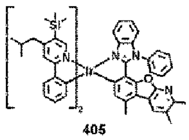
405

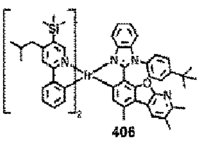
406

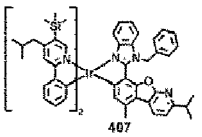
407

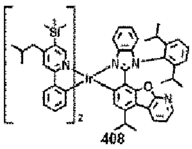
408

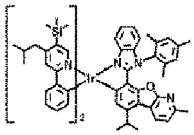
409

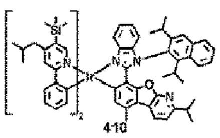
410

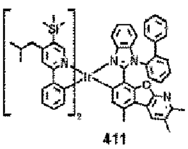
411

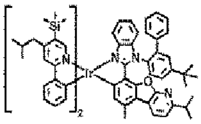
412

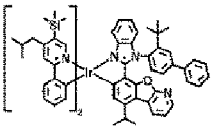
413

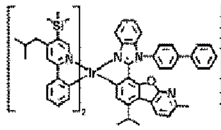
414

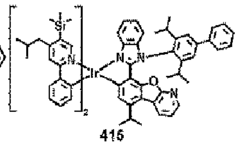
415

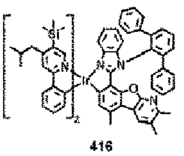
416

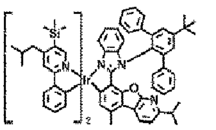
417

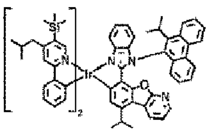
418

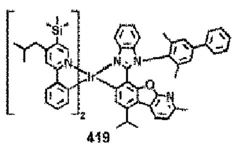
419

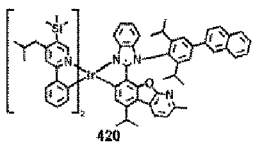
420

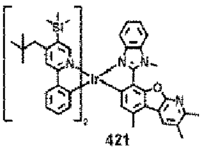
421

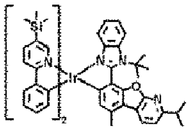
422

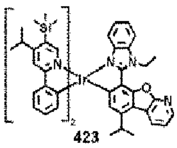
423

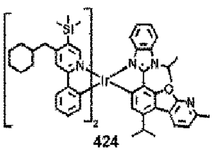
424

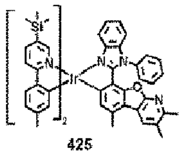
425

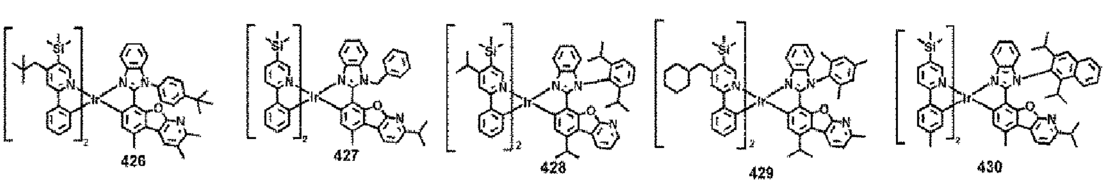
426 427 428 429 430

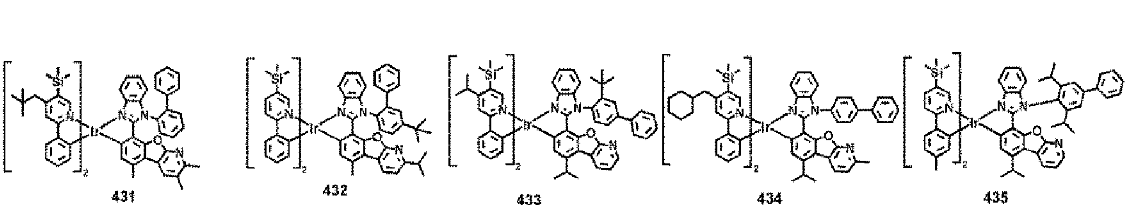
431 432 433 434 435

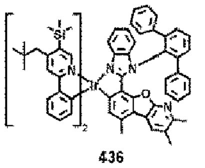
436
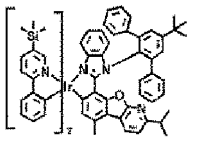
437
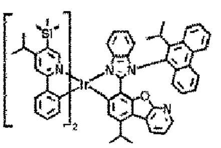
438
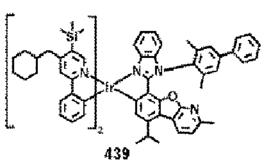
439
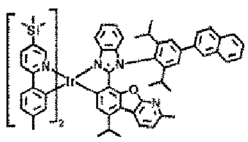
440

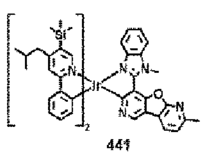
441
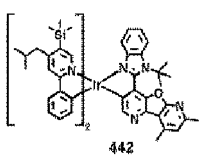
442
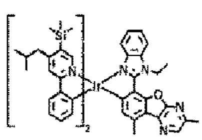
443
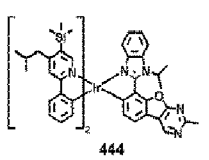
444
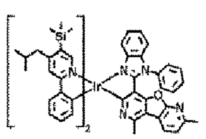
445

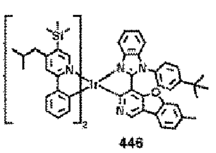
446
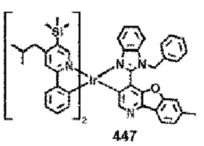
447
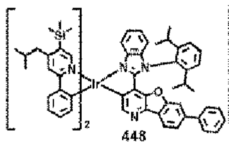
448
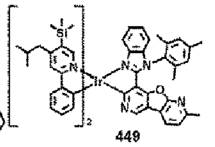
449
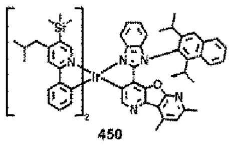
450

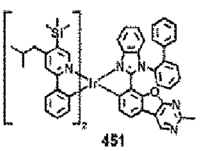
451
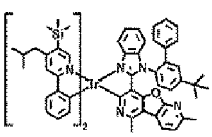
452
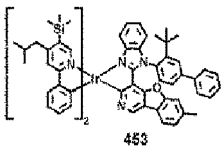
453
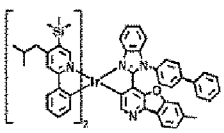
454
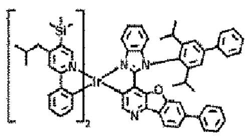
455

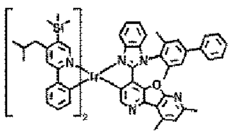
456
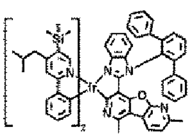
457
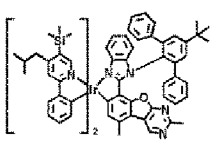
458
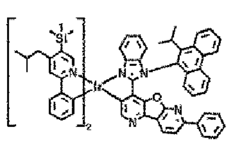
459
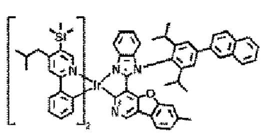
460

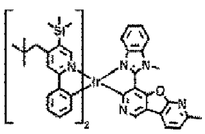
461
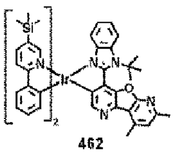
462
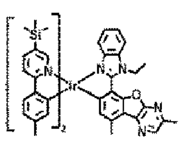
463
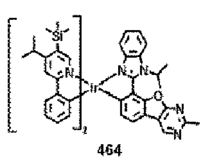
464
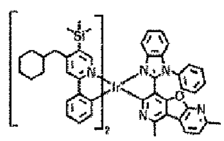
465

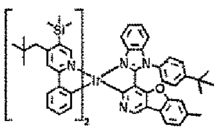
466
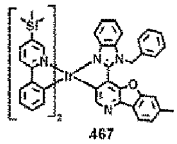
467
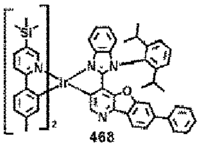
468
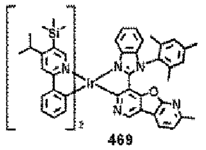
469
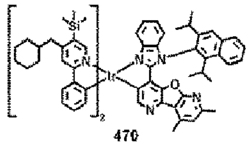
470

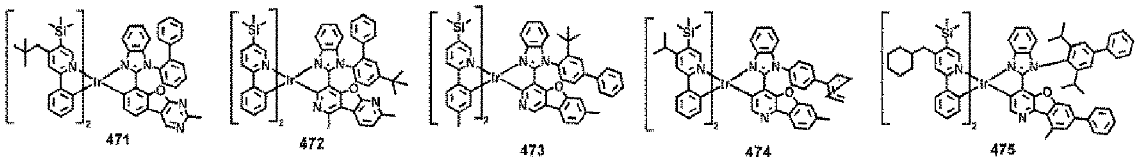
471
472
473
474
475

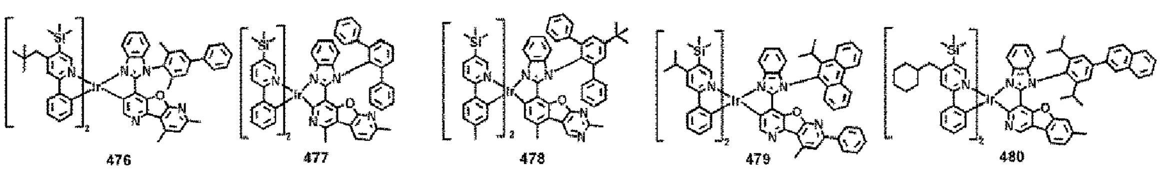
476
477
478
479
480

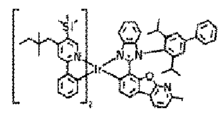
481

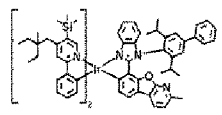
482

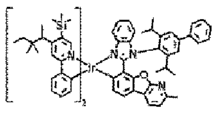
483

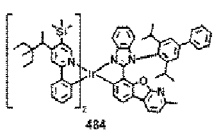
484

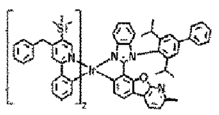
485

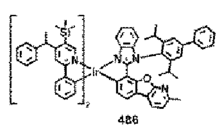
486

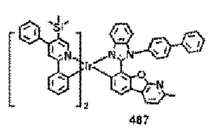
487

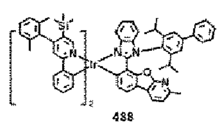
488

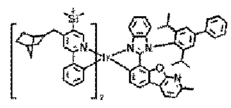
489

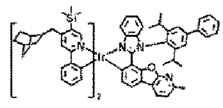
490

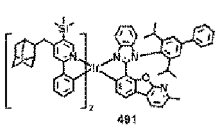
491

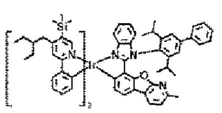
492

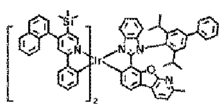
493

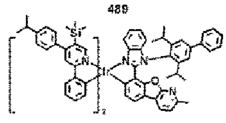
494

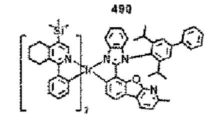
495

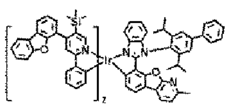
496

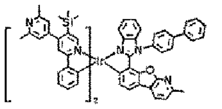
497

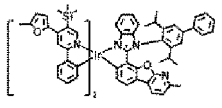
498

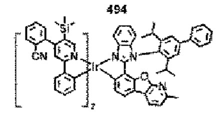
499

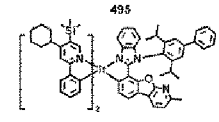
500

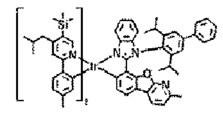
501

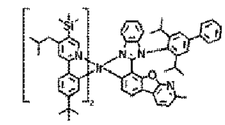
502

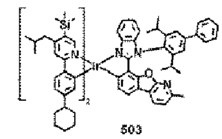
503

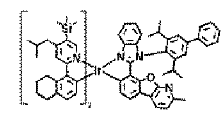
504

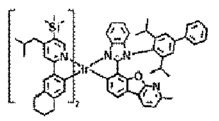
505

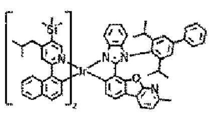
506

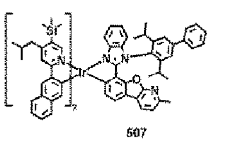
507

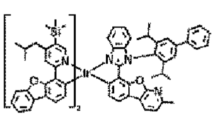
508

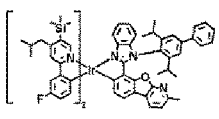
509

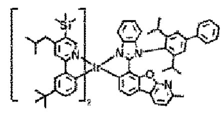
510

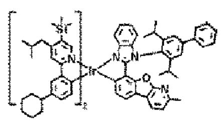
511

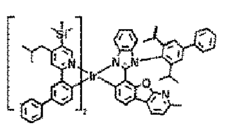
512

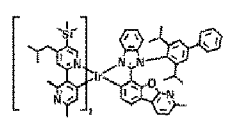
513

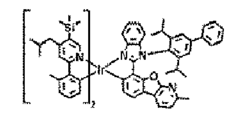
514

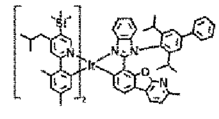
515

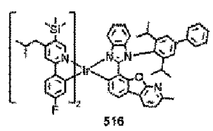
516

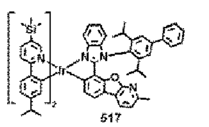
517

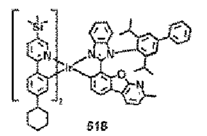
518

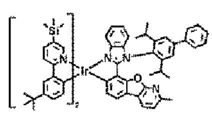
519

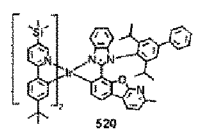
520

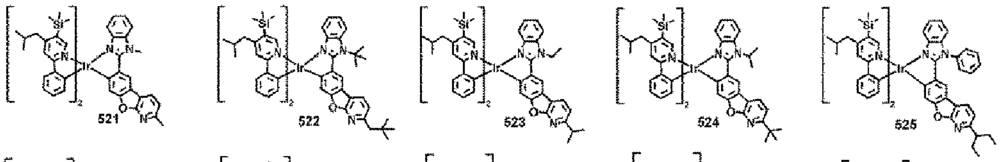
521 522 523 524 525

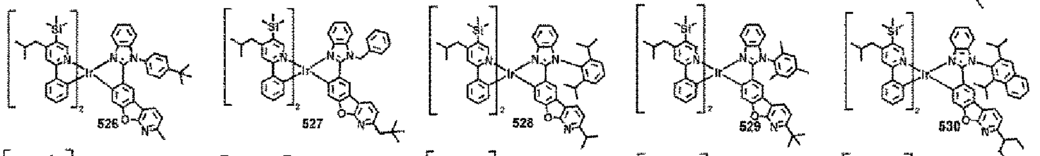
526 527 528 529 530

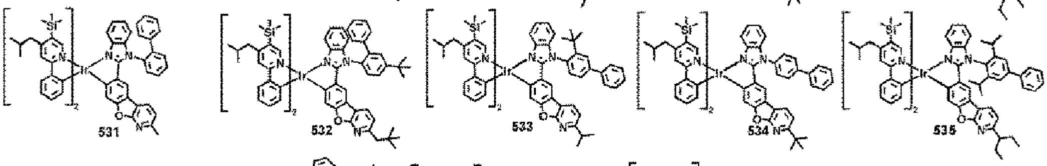
531 532 533 534 535

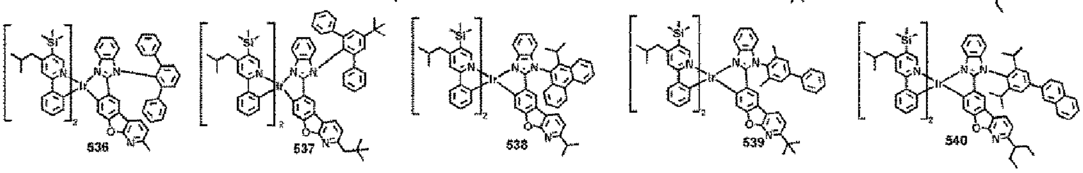
536 537 538 539 540

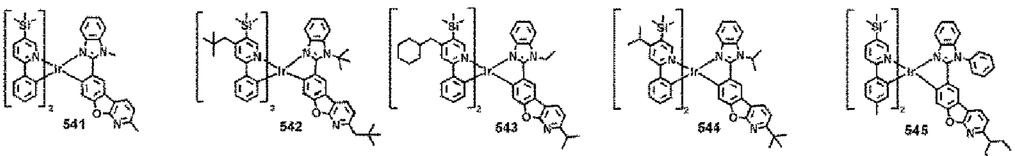
541 542 543 544 545

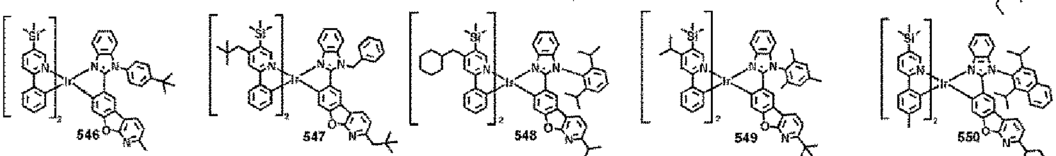
546 547 548 549 550

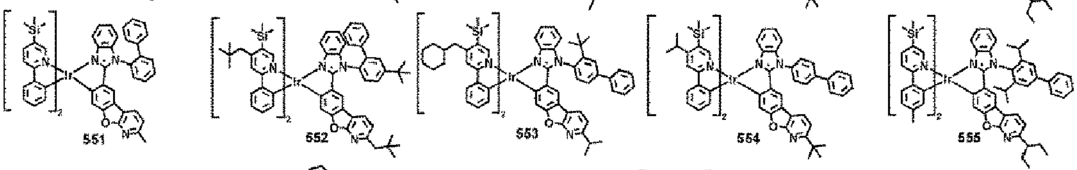
551 552 553 554 555

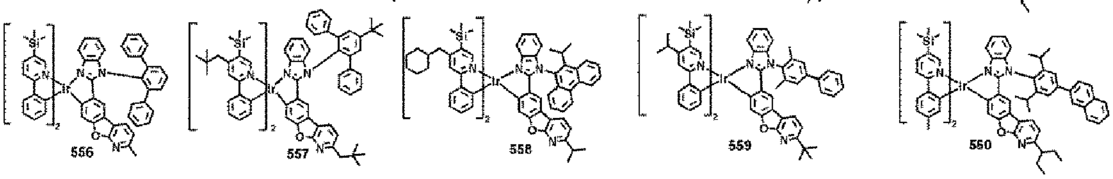
556 557 558 559 560

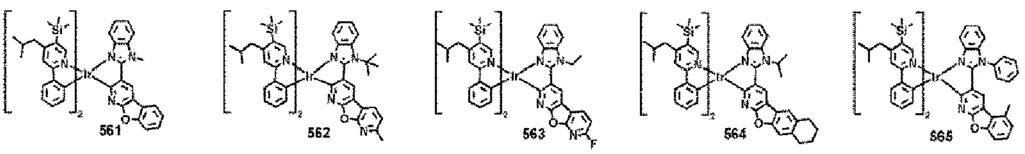
561 562 563 564 565

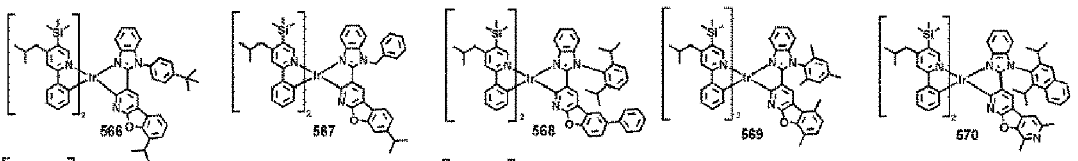

566 567 568 569 570

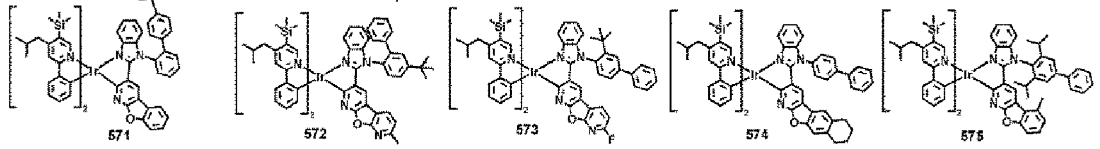

571 572 573 574 575

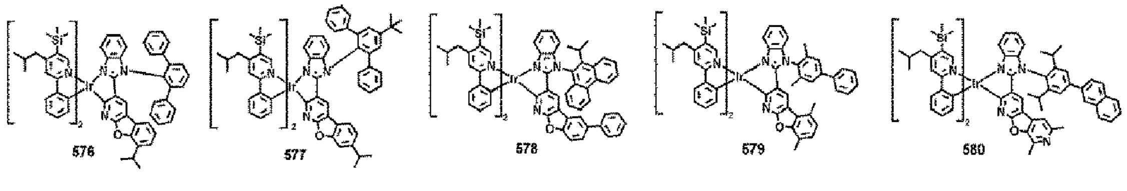

576 577 578 579 580

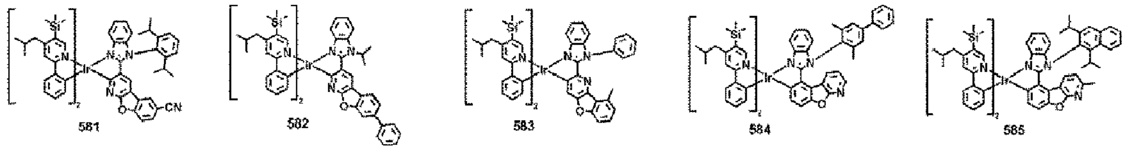

581 582 583 584 585

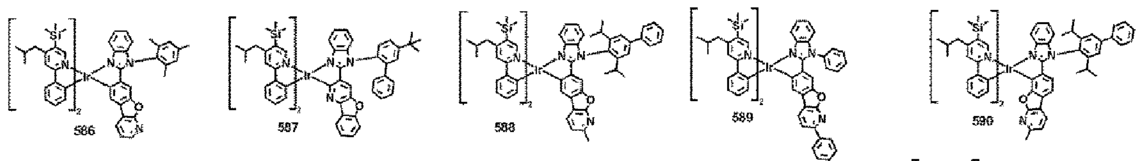

586 587 588 589 590

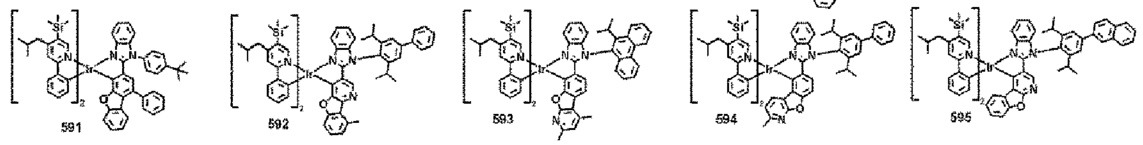

591 592 593 594 595

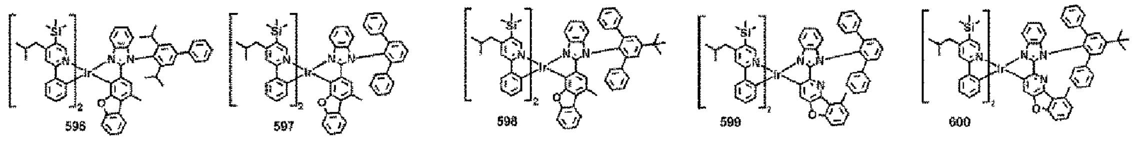

596 597 598 599 600

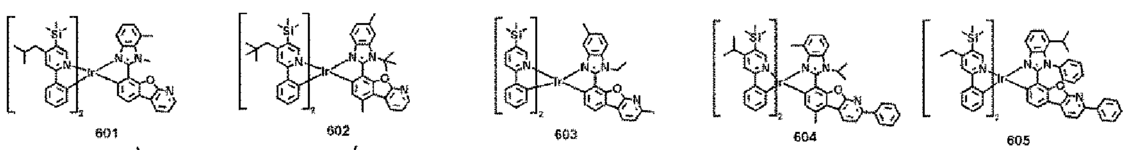

601 602 603 604 605

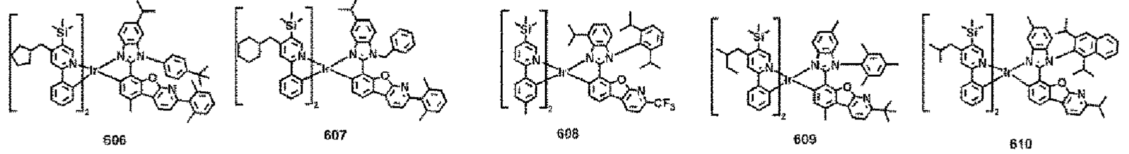

606 607 608 609 610

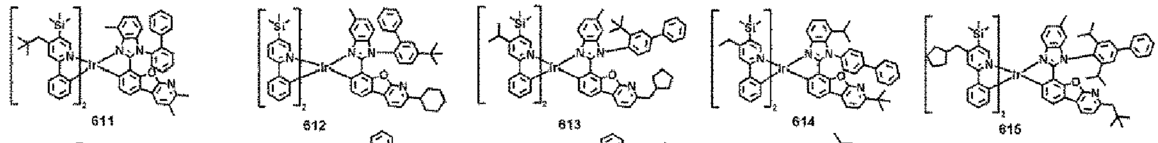

611 612 613 614 615

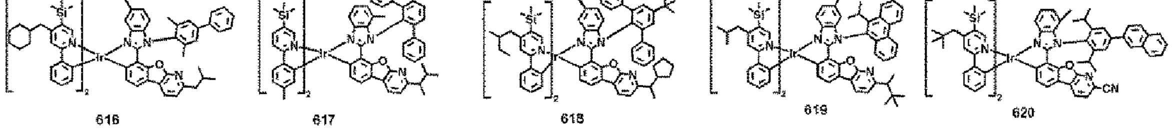

616 617 618 619 620

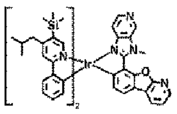
621
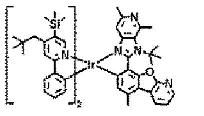
622
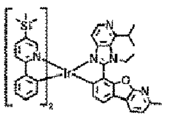
623
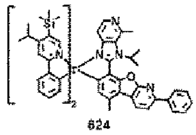
624
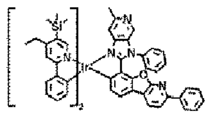
625

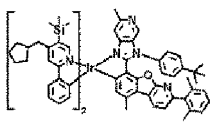
626
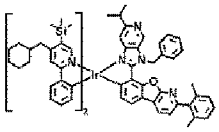
627
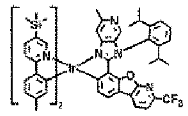
628
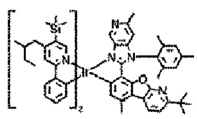
629
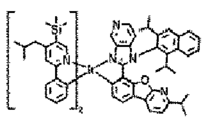
630

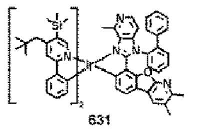
631
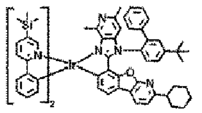
632
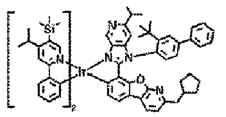
633
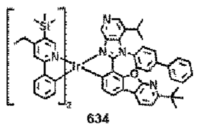
634
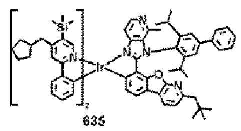
635

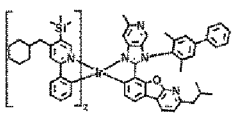
636
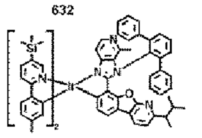
637
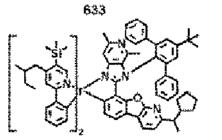
638
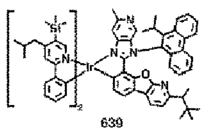
639
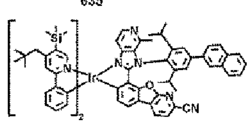
640

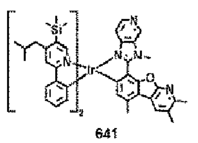
641
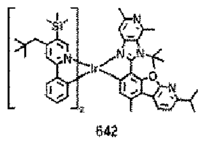
642
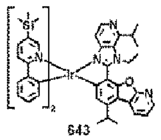
643
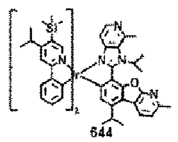
644
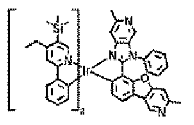
645

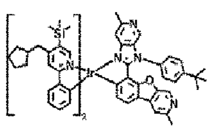
646
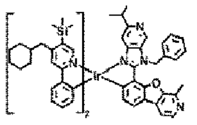
647
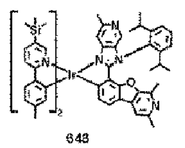
648
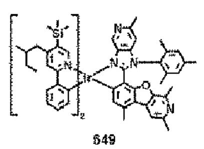
649
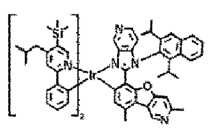
650

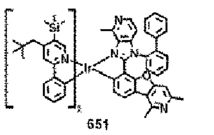
651
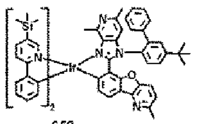
652
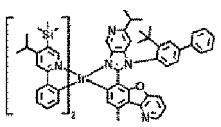
653
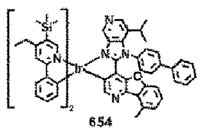
654
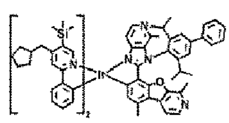
655

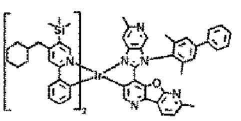
656
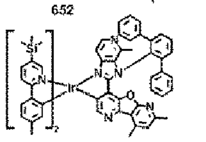
657
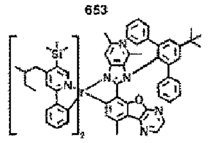
658
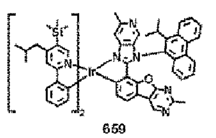
659
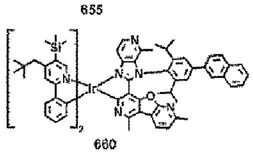
660

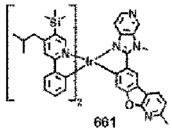
661

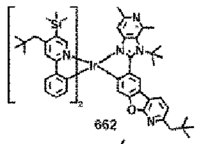
662

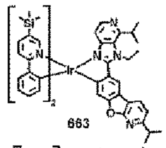
663

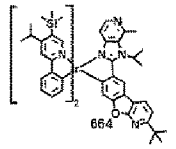
664

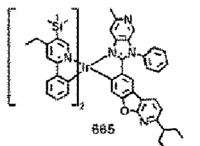
665

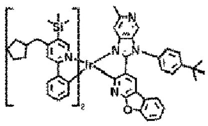
666

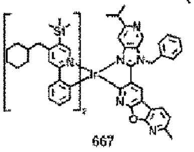
667

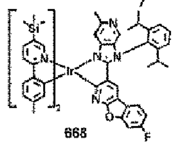
668

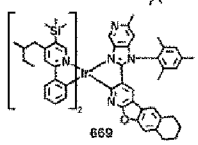
669

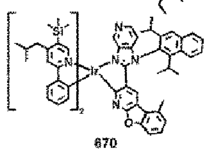
670

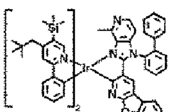
671

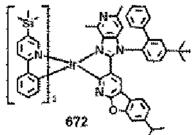
672

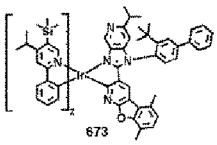
673

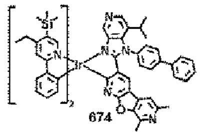
674

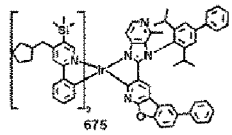
675

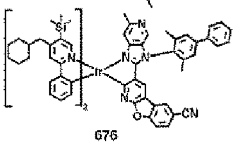
676

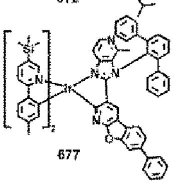
677

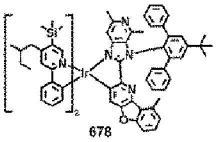
678

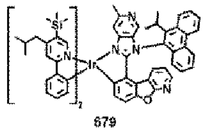
679

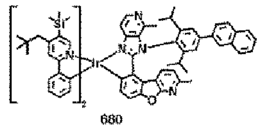
680

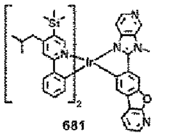
681

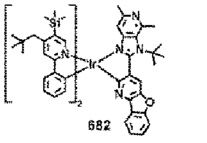
682

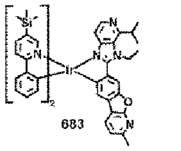
683

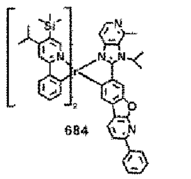
684

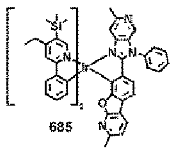
685

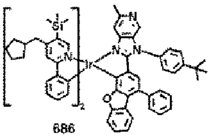
686

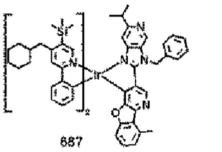
687

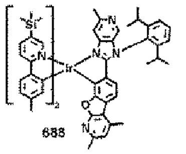
688

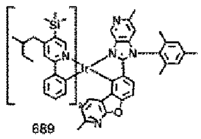
689

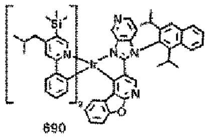
690

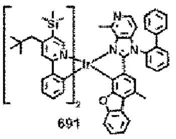
691

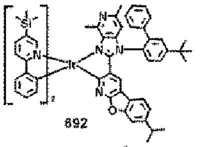
692

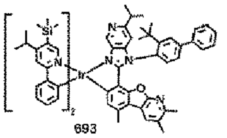
693

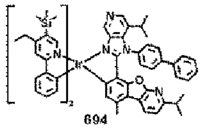
694

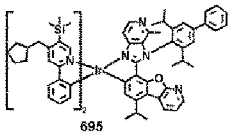
695

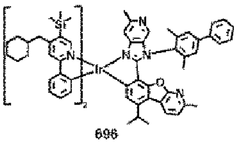
696

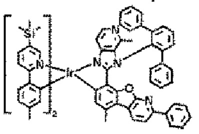
697

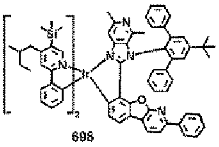
698

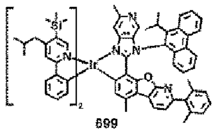
699

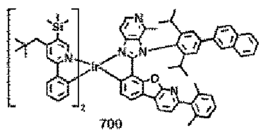
700

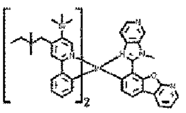
701

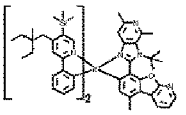
702

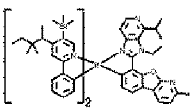
703

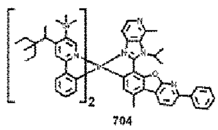
704

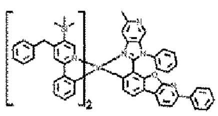
705

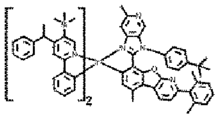
706

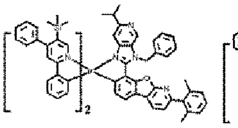
707

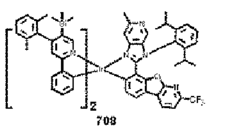
708

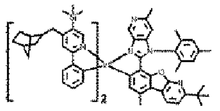
709

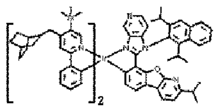
710

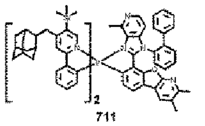
711

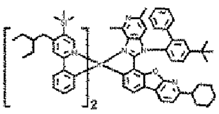
712

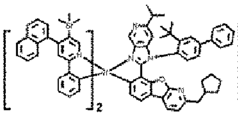
713

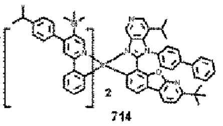
714

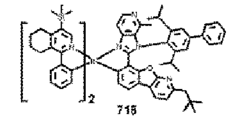
715

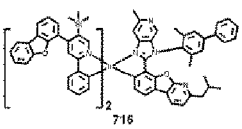
716

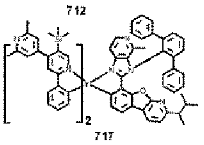
717

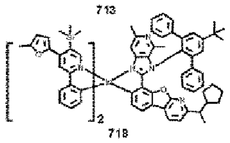
718

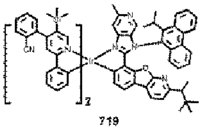
719

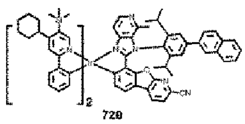
720

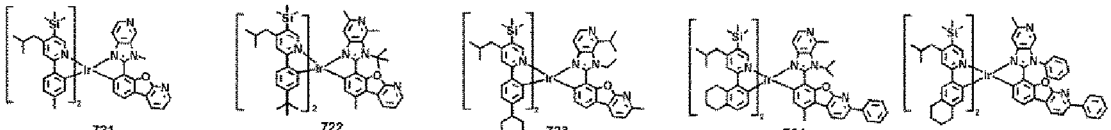

721 722 723 724 725

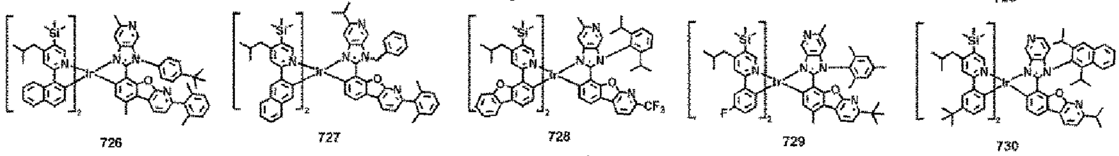

726 727 728 729 730

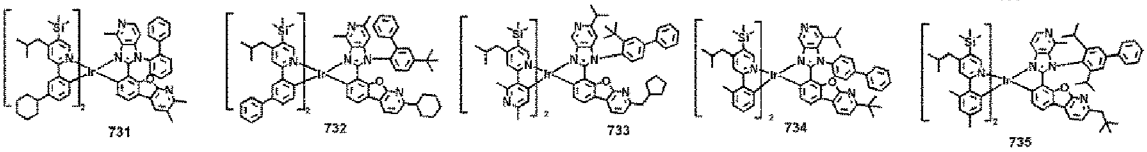

731 732 733 734 735

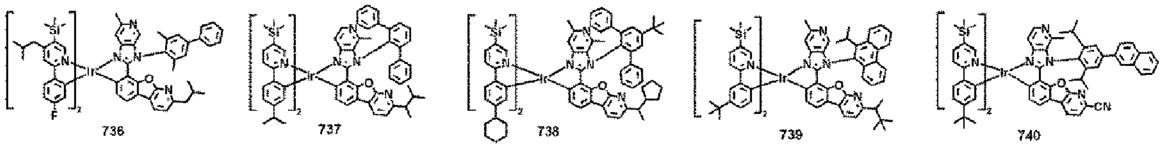

736 737 738 739 740

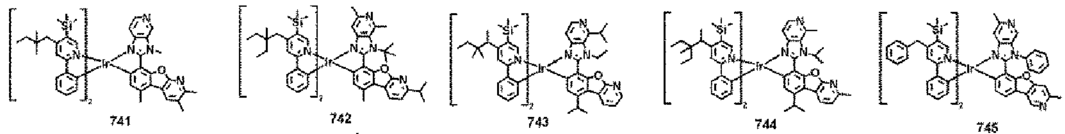

741 742 743 744 745

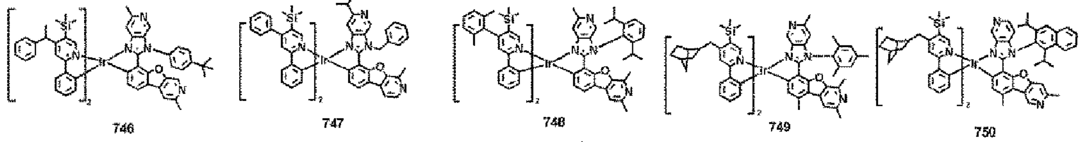

746 747 748 749 750

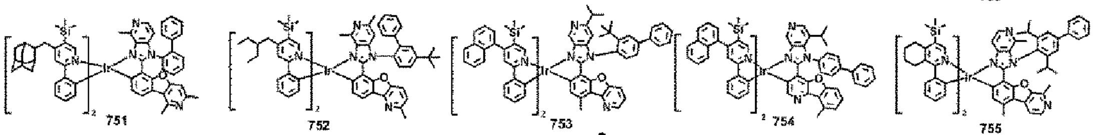

751 752 753 754 755

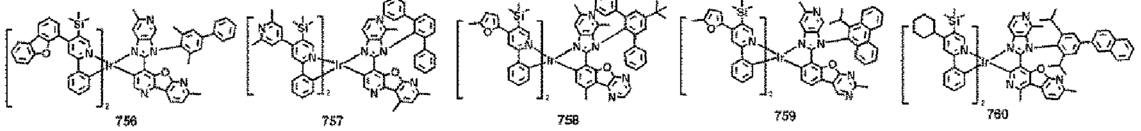

756 757 758 759 760

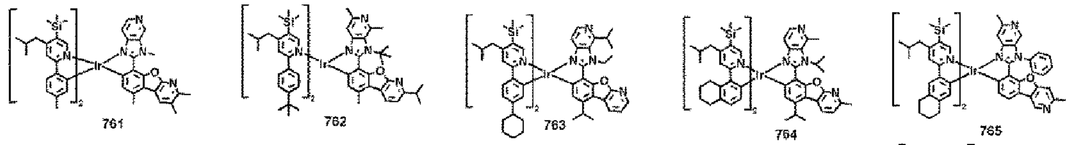

761 762 763 764 765

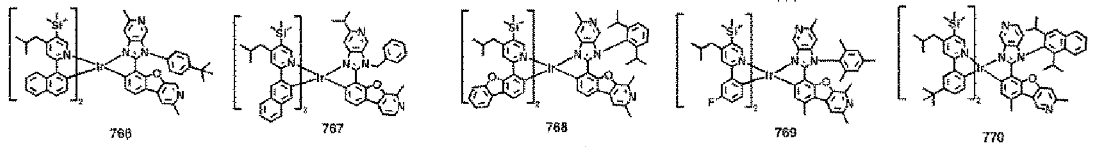

766 767 768 769 770

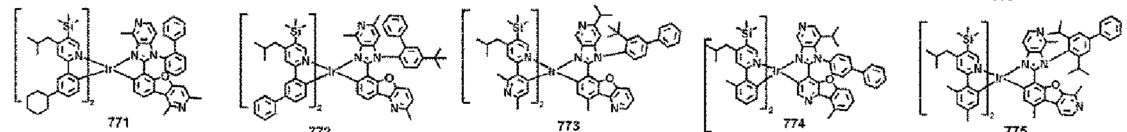

771 772 773 774 775

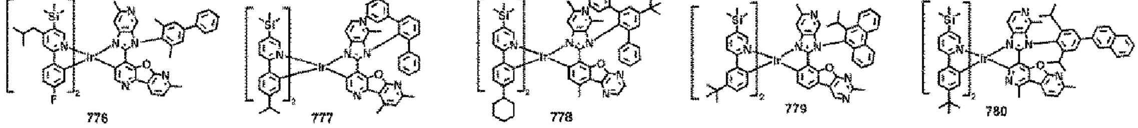

776 777 778 779 780

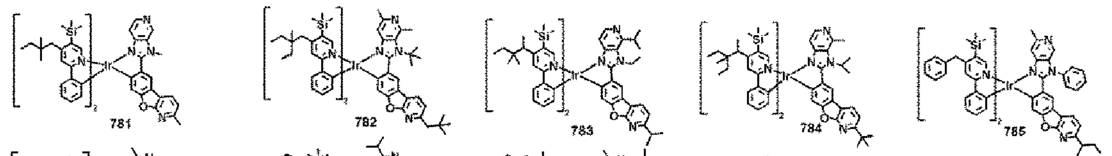

781 782 783 784 785

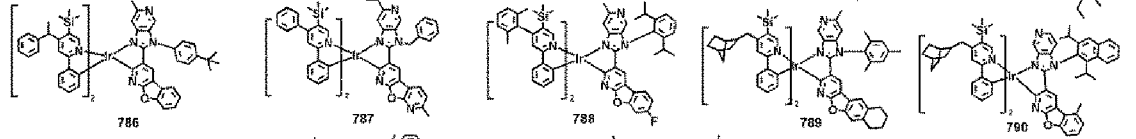

786 787 788 789 790

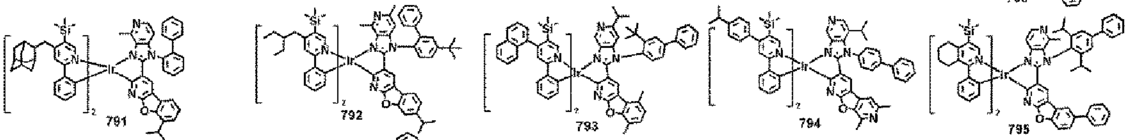

791 792 793 794 795

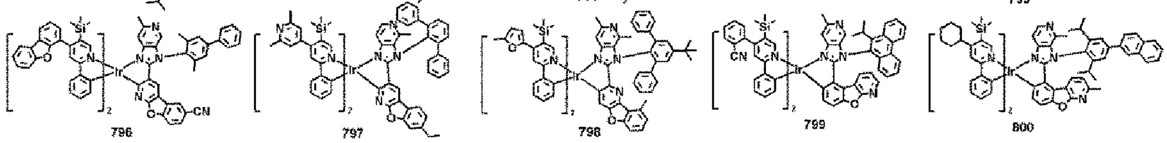

796 797 798 799 800

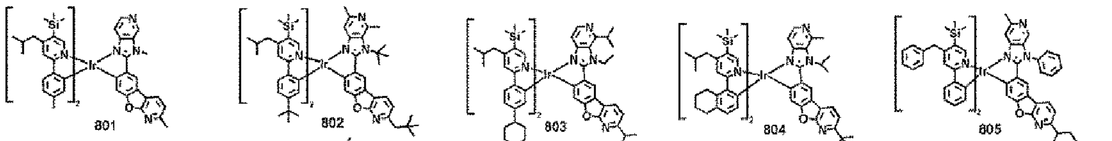

801 802 803 804 805

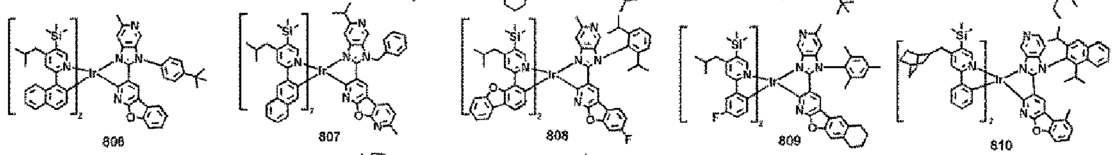

806 807 808 809 810

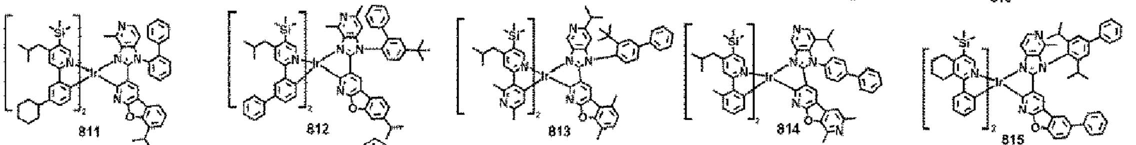

811 812 813 814 815

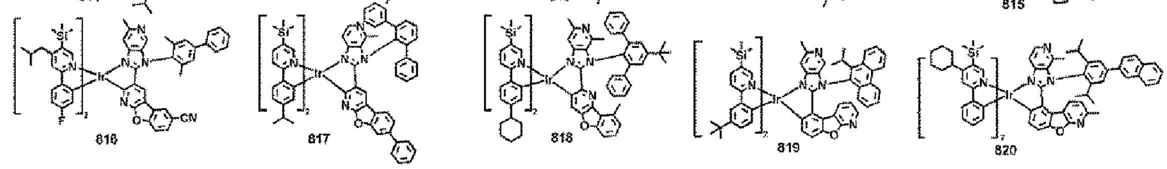

816 817 818 819 820

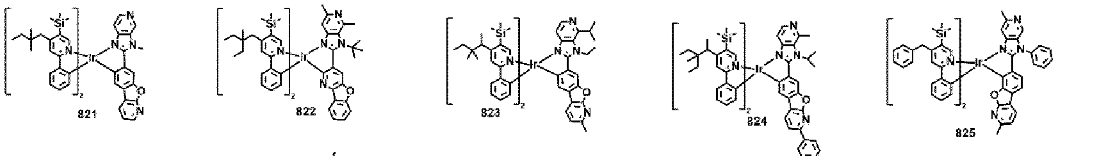

821 822 823 824 825

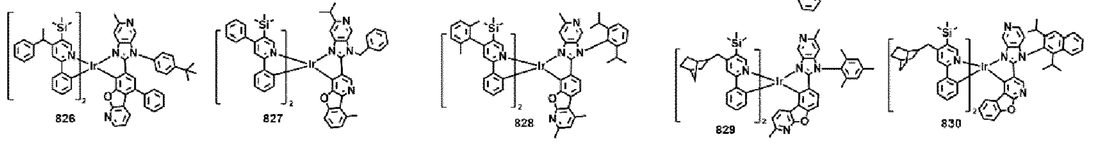

826 827 828 829 830

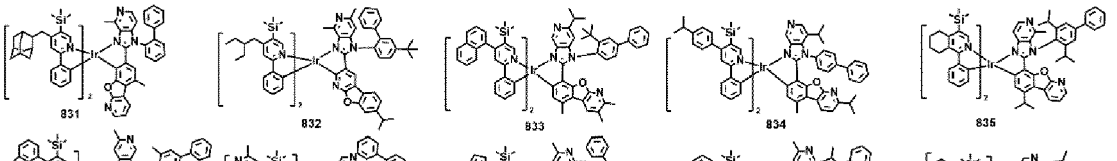

831 832 833 834 835

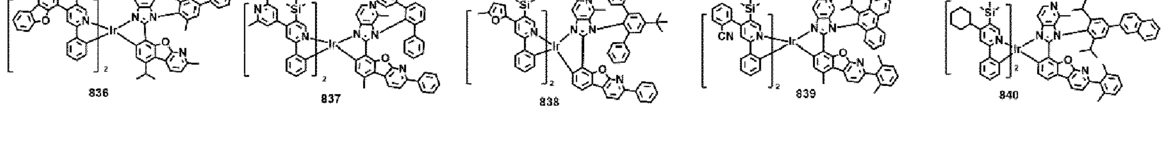

836 837 838 839 840

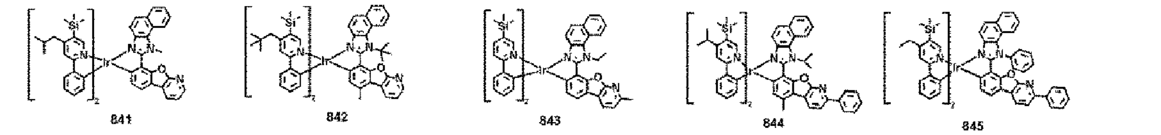
841 842 843 844 845

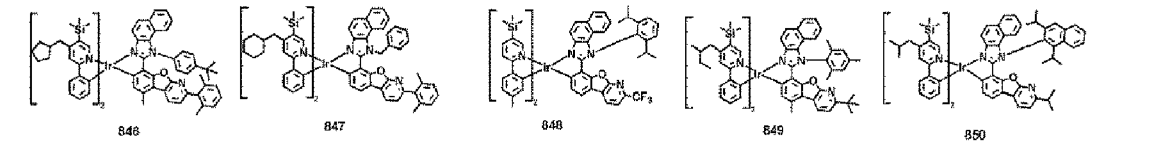
846 847 848 849 850

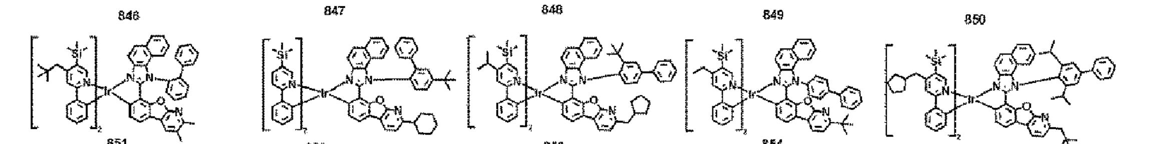
851 852 853 854 855

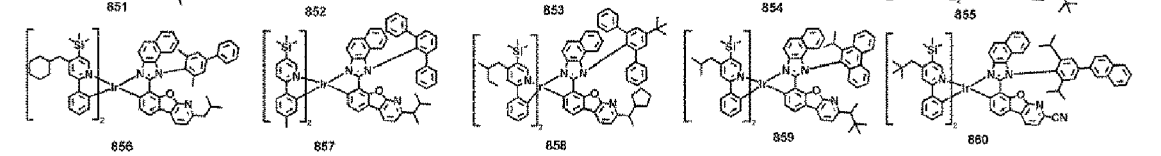
856 857 858 859 860

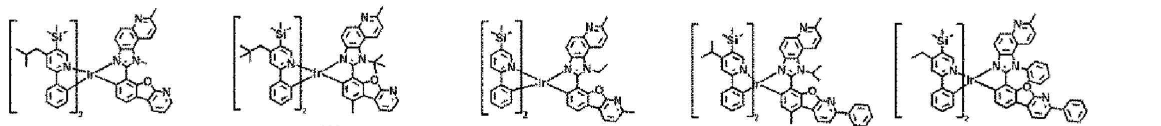
861 862 863 864 865

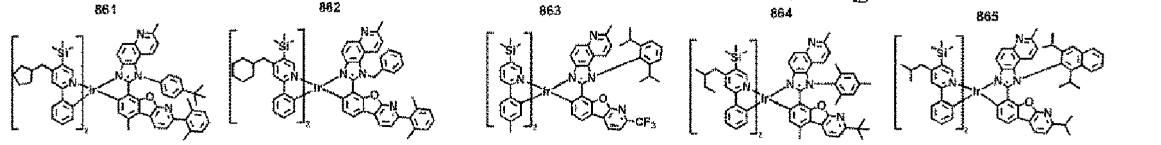
866 867 868 869 870

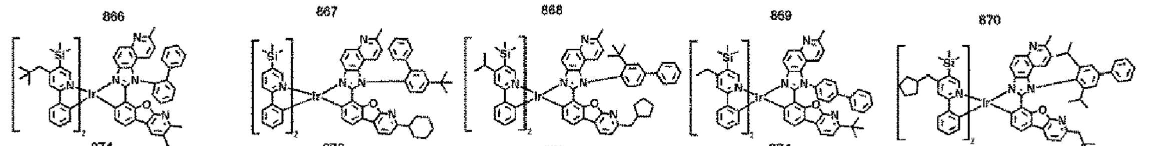
871 872 873 874 875

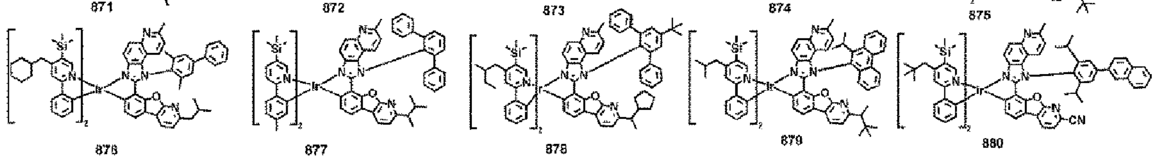
876 877 878 879 880

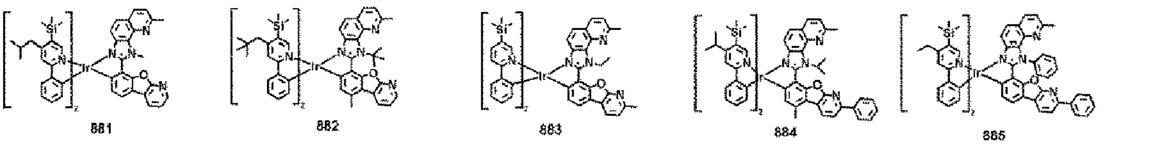
881 882 883 884 885

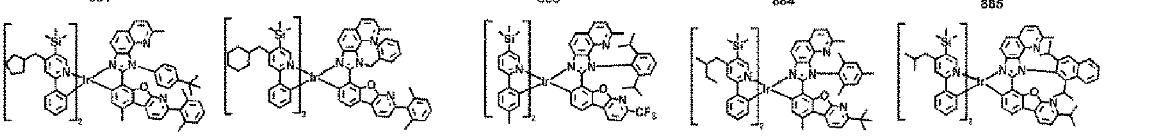
886 887 888 889 890

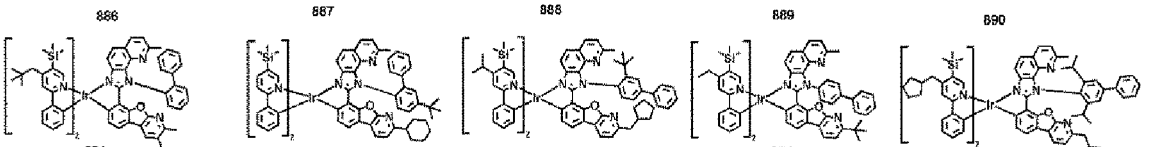
891 892 893 894 895

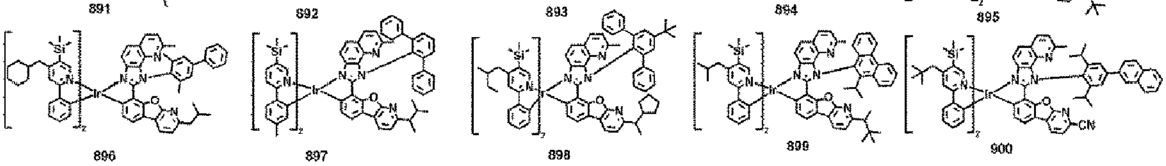
896 897 898 899 900

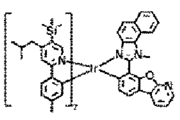
901
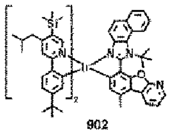
902
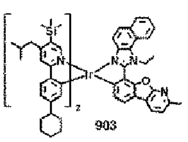
903
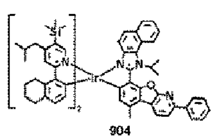
904
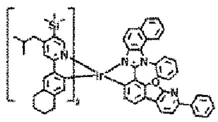
905
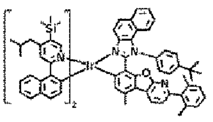
906
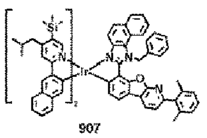
907
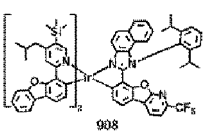
908
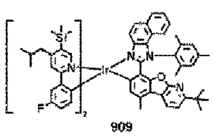
909
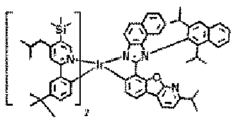
910
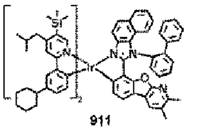
911
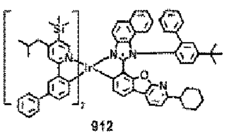
912
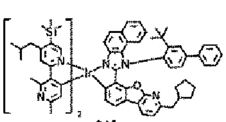
913
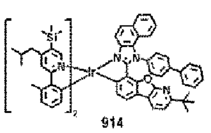
914
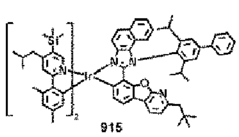
915
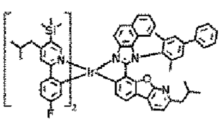
916
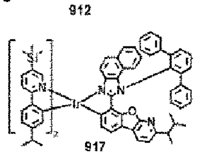
917
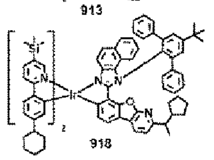
918
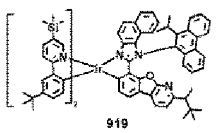
919
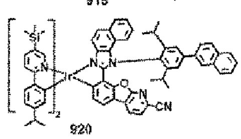
920
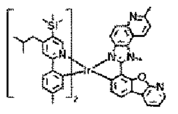
921
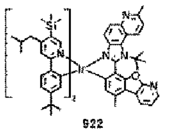
922
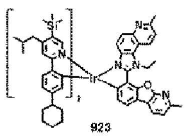
923
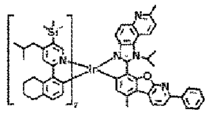
924
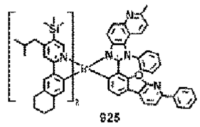
925
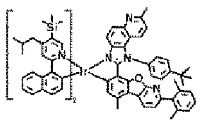
926
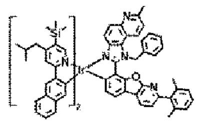
927
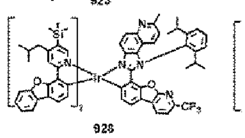
928
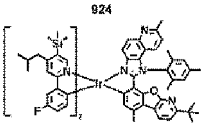
929
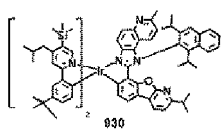
930
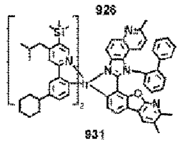
931
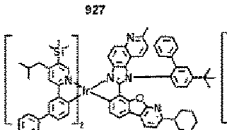
932
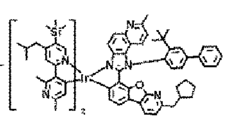
933
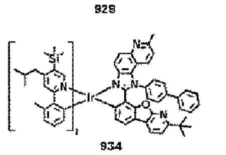
934
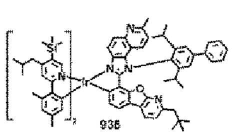
935
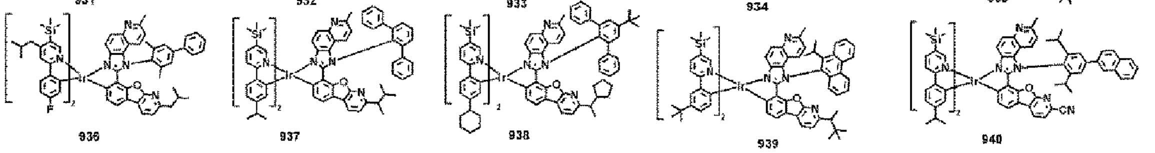
936 937 938 939 940
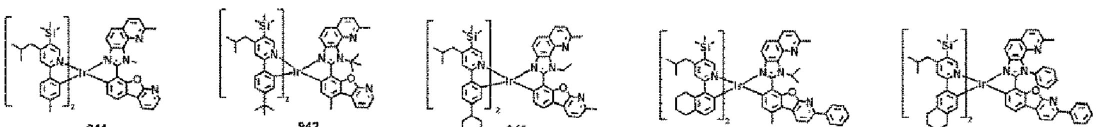
941 942 943 944 945
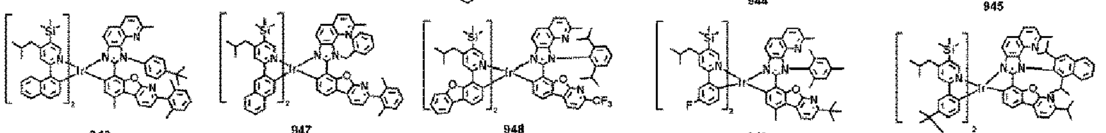
946 947 948 949 950
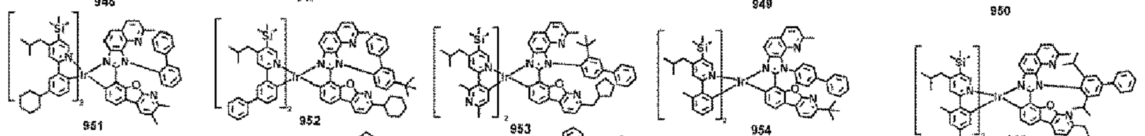
951 952 953 954 955
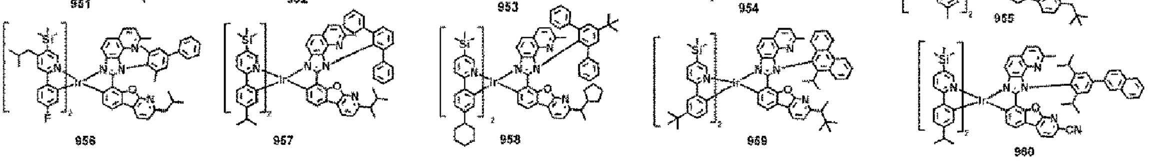
956 957 958 959 960

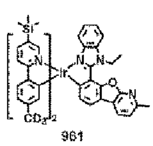
961
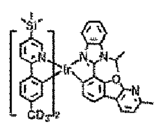
962
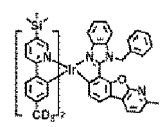
963
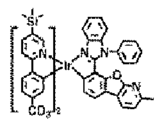
964
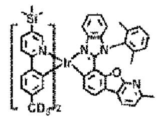
965

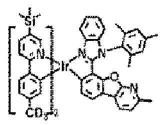
966
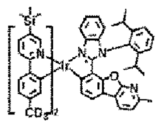
967
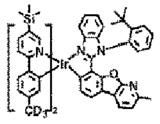
968
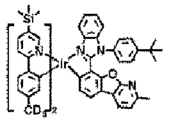
969
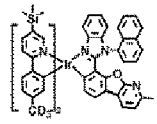
970

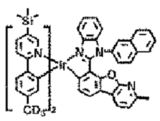
971
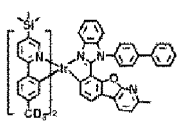
972
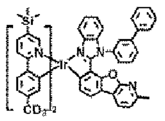
973
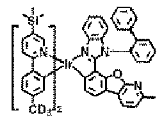
974
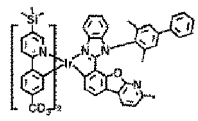
975

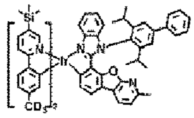
976
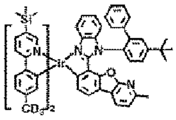
977
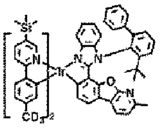
978
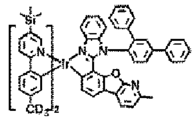
979
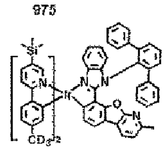
980

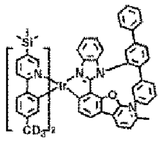
981
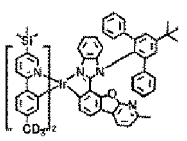
982
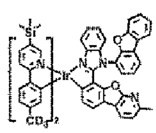
983
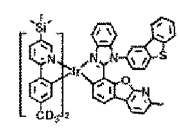
984
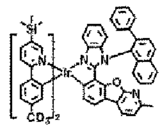
985

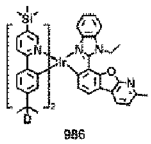
986
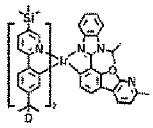
987
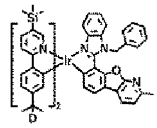
988
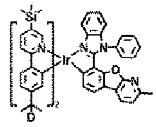
989
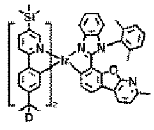
990

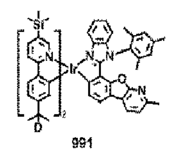
991
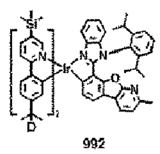
992
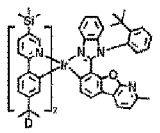
993
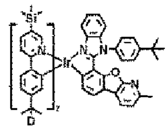
994
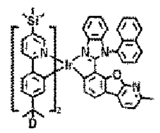
995

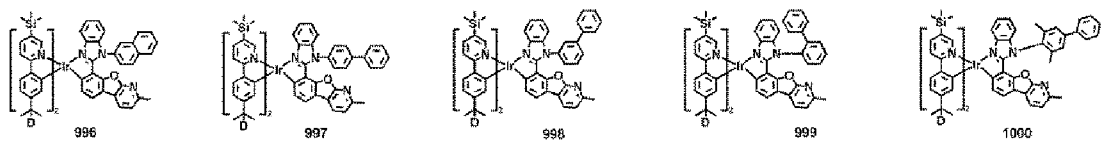
996 997 998 999 1000

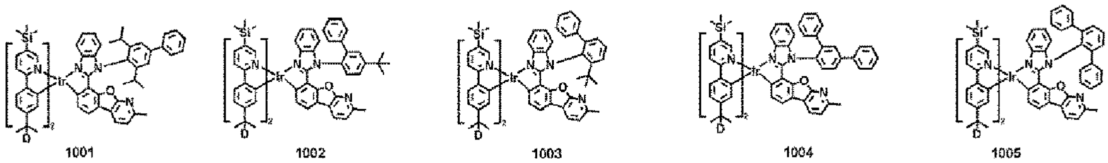
1001 1002 1003 1004 1005

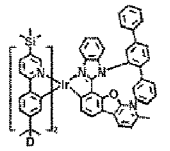
1006
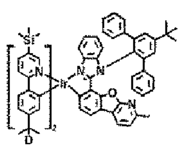
1007
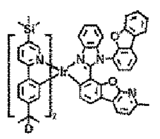
1008
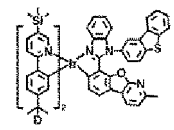
1009
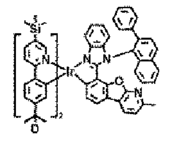
1010

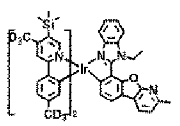
1011
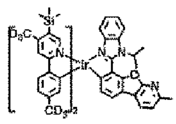
1012
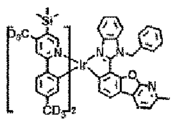
1013
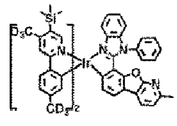
1014
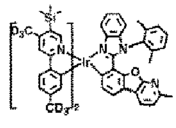
1015

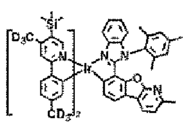
1016
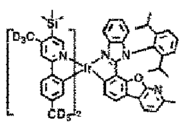
1017
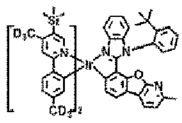
1018
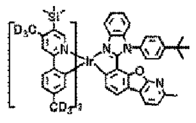
1019
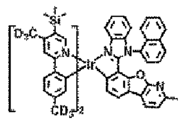
1020

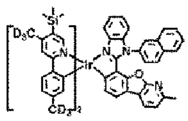
1021
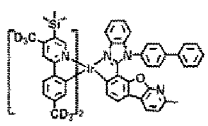
1022
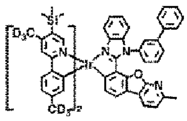
1023
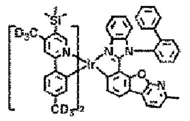
1024
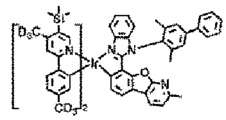
1025

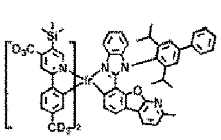
1026
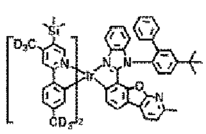
1027
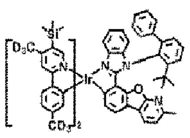
1028
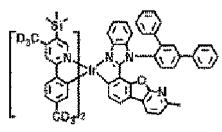
1029
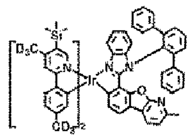
1030

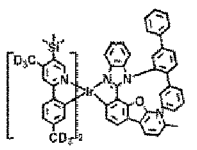
1031
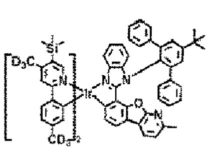
1032
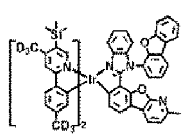
1033
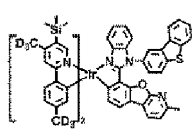
1034
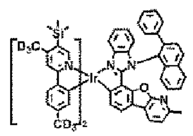
1035

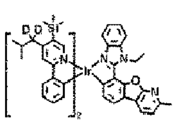
1036
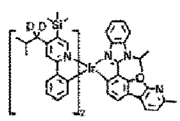
1037
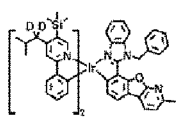
1038
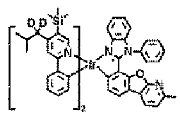
1039
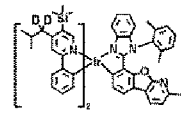
1040

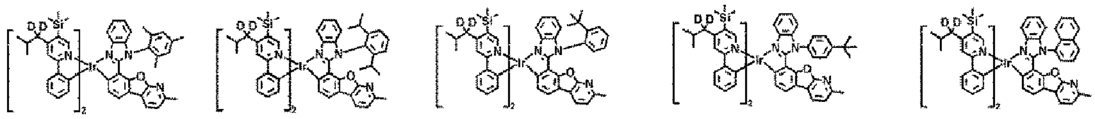
1041
1042
1043
1044
1045

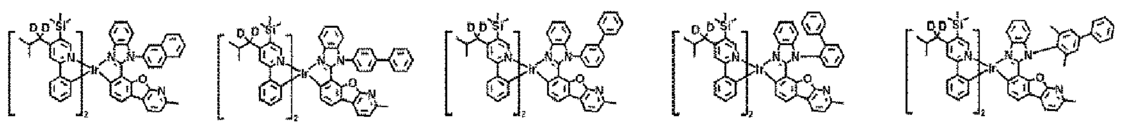
1046
1047
1048
1049
1050

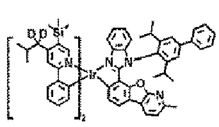
1051

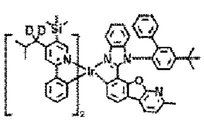
1052

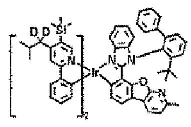
1053

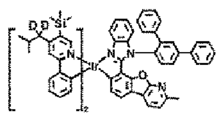
1054

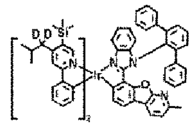
1055

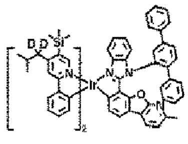
1056

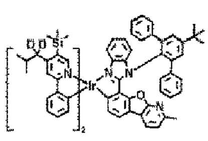
1057

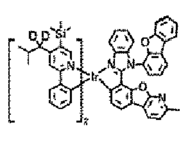
1058

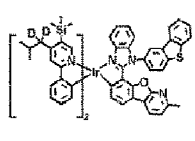
1059

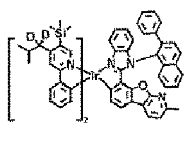
1060

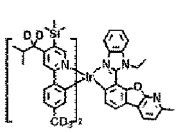
1061

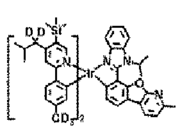
1062

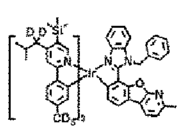
1063

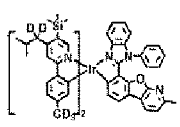
1064

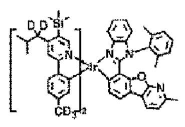
1065

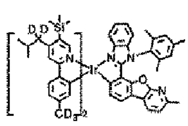
1066

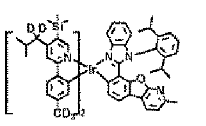
1067

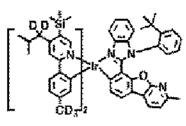
1068

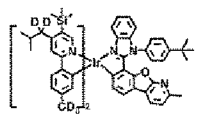
1069

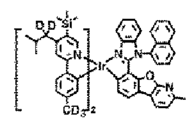
1070

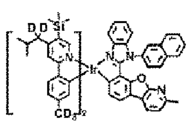
1071

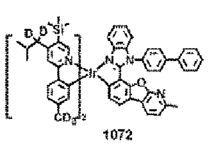
1072

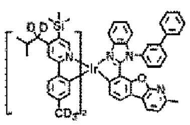
1073

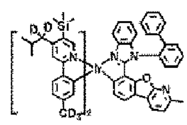
1074

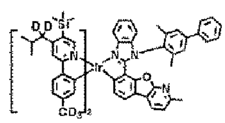
1075

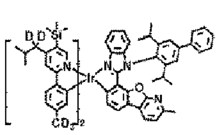
1076

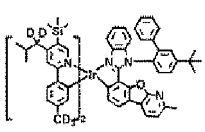
1077

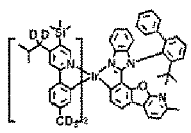
1078

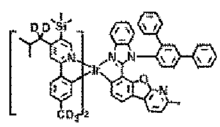
1079

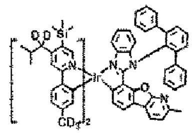
1080

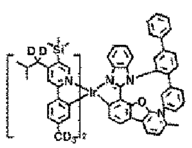
1081

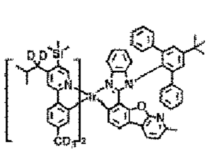
1082

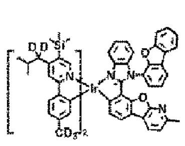
1083

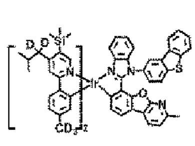
1084

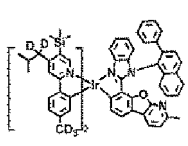
1085

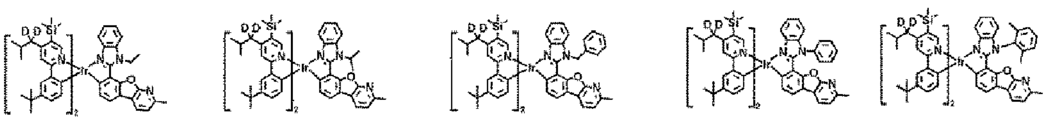
1086 1087 1088 1089 1090

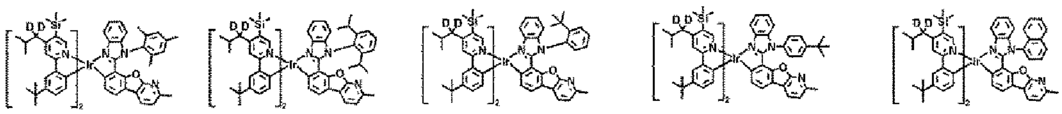
1091 1092 1093 1094 1095

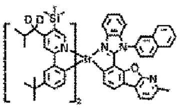
1096
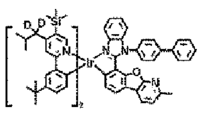
1097
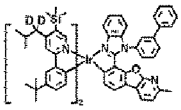
1098
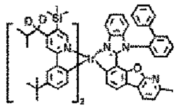
1099
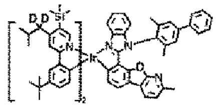
1100
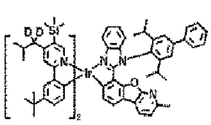
1101
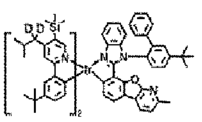
1102
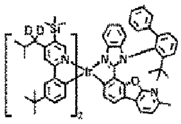
1103
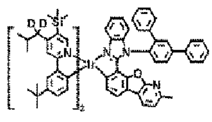
1104
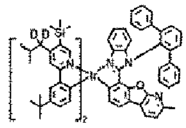
1105
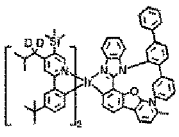
1106
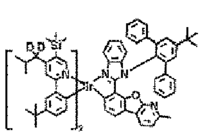
1107
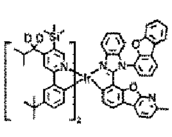
1108
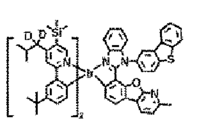
1109
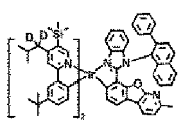
1110
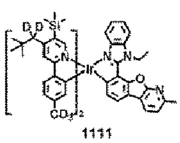
1111
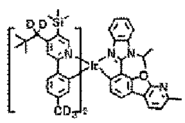
1112
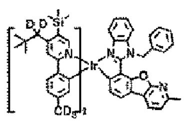
1113
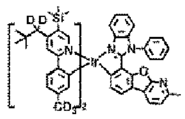
1114
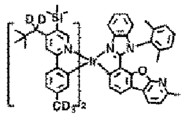
1115
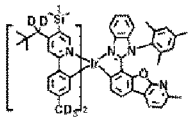
1116
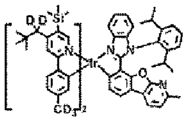
1117
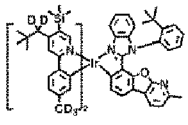
1118
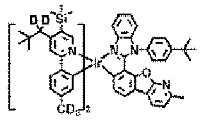
1119
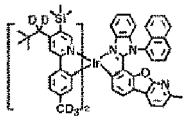
1120
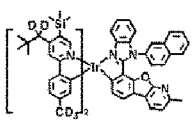
1121
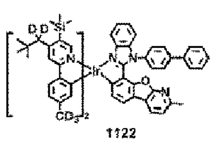
1122
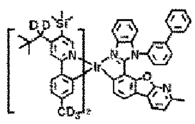
1123
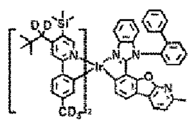
1124
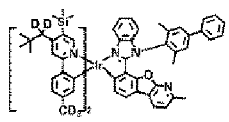
1125
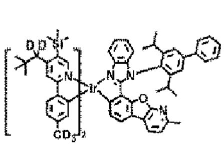
1126
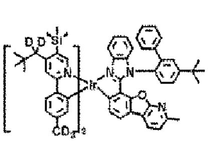
1127
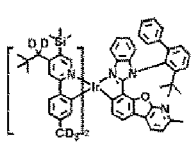
1128
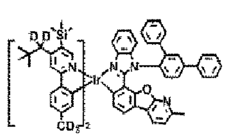
1129
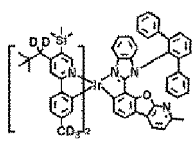
1130
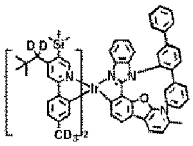
1131
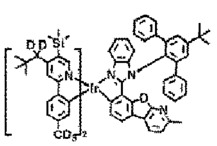
1132
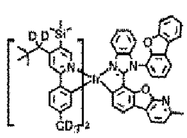
1133
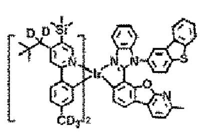
1134
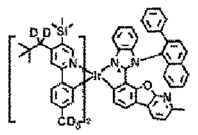
1135
1136
1137
1138
1139
1140

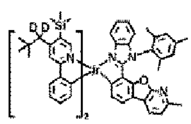
1141

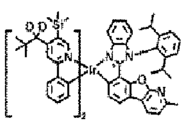
1142

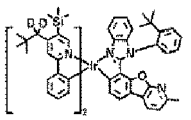
1143

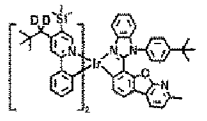
1144

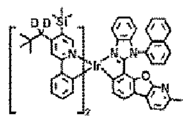
1145

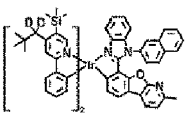
1146

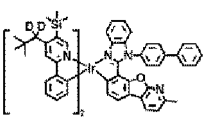
1147

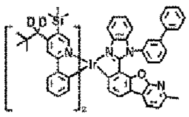
1148

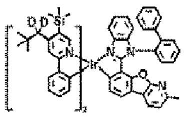
1149

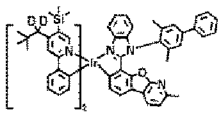
1150

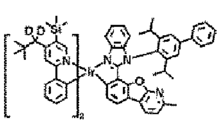
1151

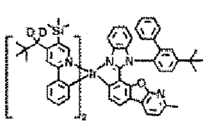
1152

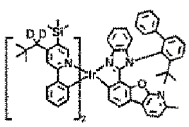
1153

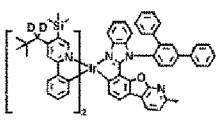
1154

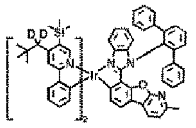
1155

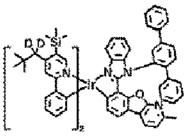
1156

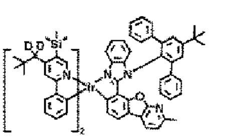
1157

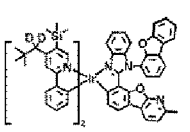
1158

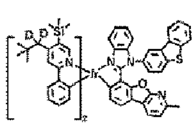
1159

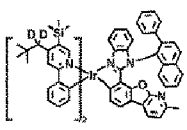
1160

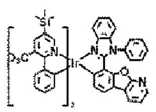
1161

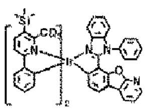
1162

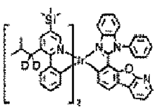
1163

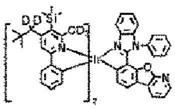
1164

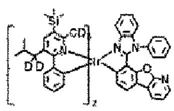
1165

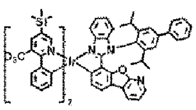
1166

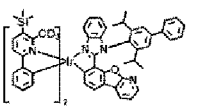
1167

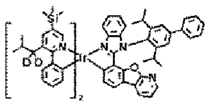
1168

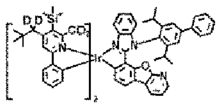
1169

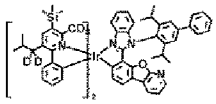
1170

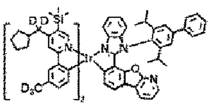
1171

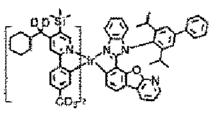
1172

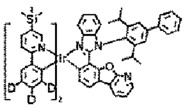
1173

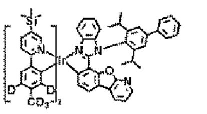
1174

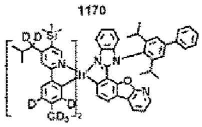
1175

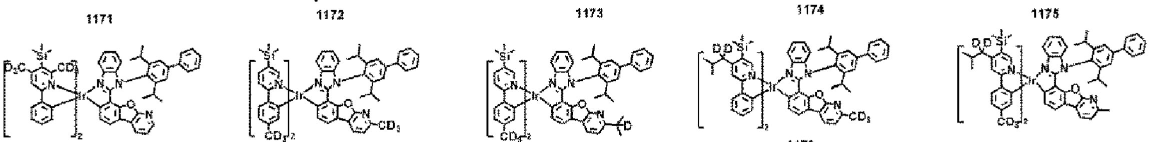
1176 1177 1178 1179 1180

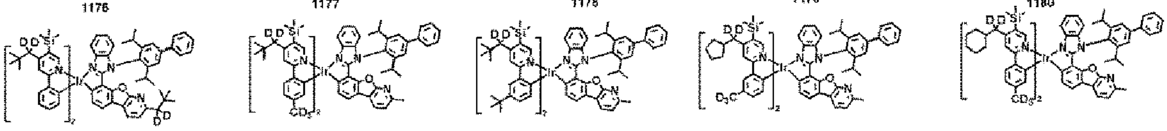
1181 1182 1183 1184 1185

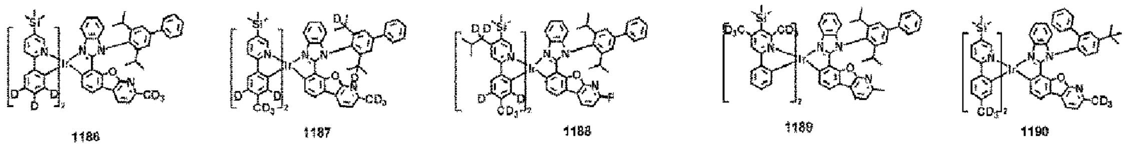
1186 1187 1188 1189 1190

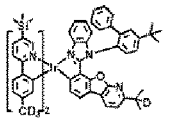
1191

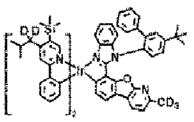
1192

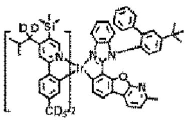
1193

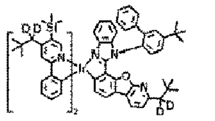
1194

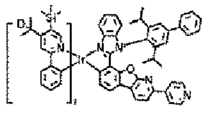
1195

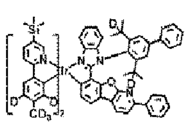
1196

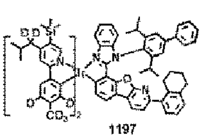
1197

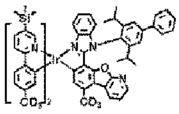
1198

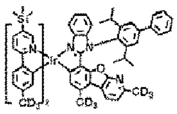
1199

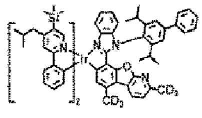
1200

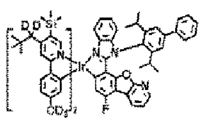
1201

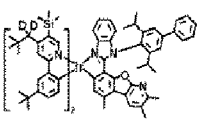
1202

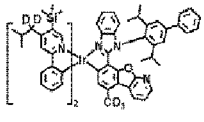
1203

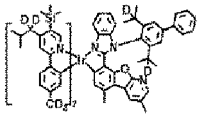
1204

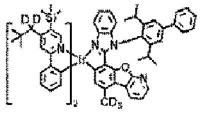
1205

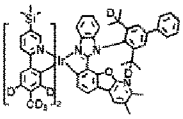
1206

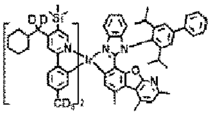
1207

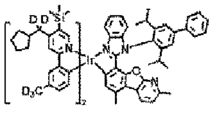
1208

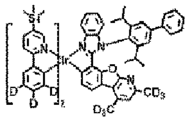
1209

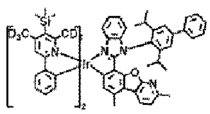
1210

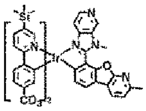
1211

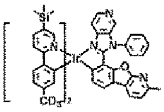
1212

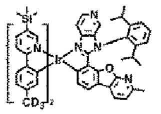
1213

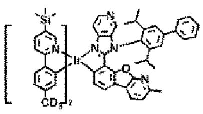
1214

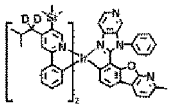
1215

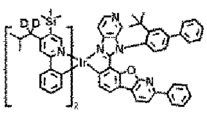
1216

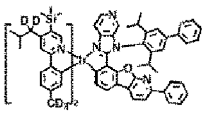
1217

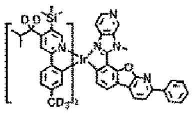
1218

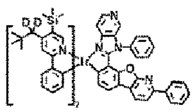
1219

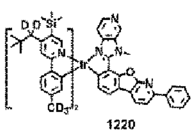
1220

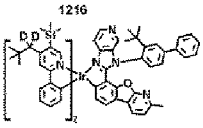
1221

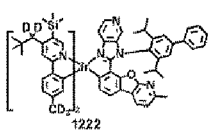
1222

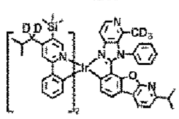
1223

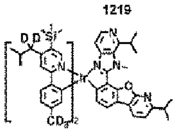
1224

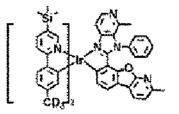
1225

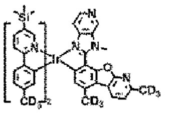
1226

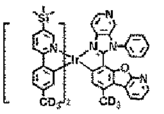
1227

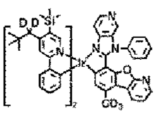
1228

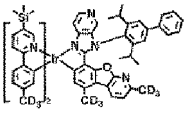
1229

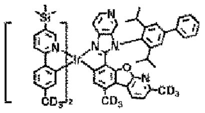
1230

1231

1232

1233

1234

1235

1236

1237

1238

1239

1240

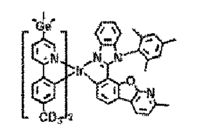
1241
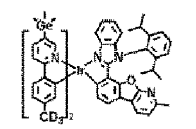
1242
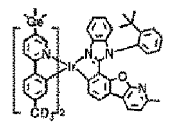
1243
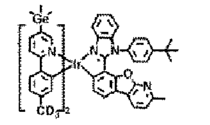
1244
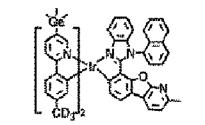
1245

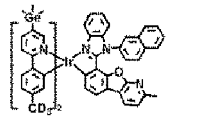
1246
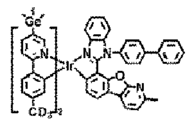
1247
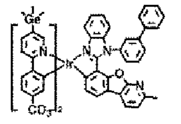
1248
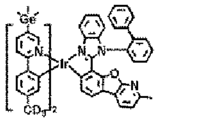
1249
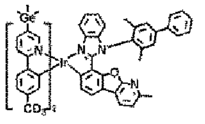
1250

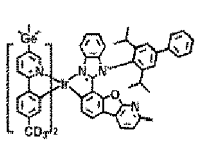
1251
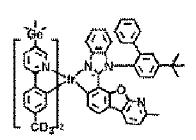
1252
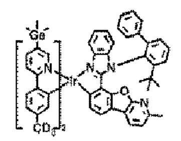
1253
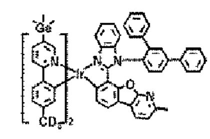
1254
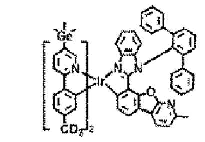
1255

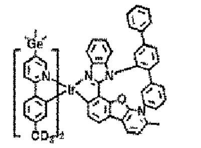
1256
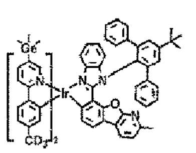
1257
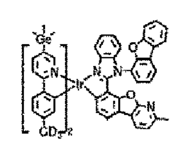
1258
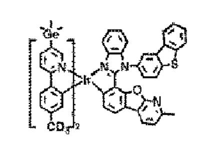
1259
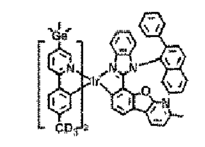
1260

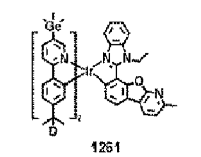
1261
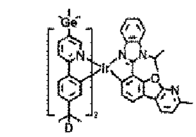
1262
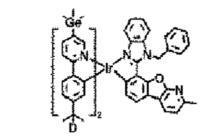
1263
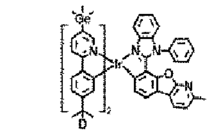
1264
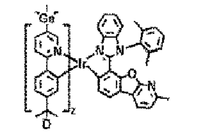
1265

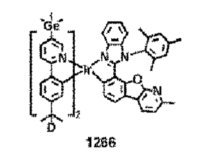
1266
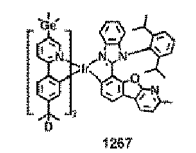
1267
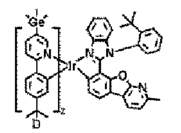
1268
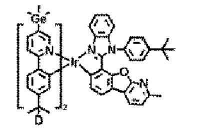
1269
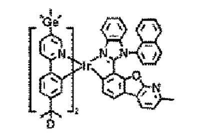
1270

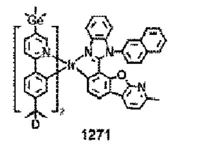
1271
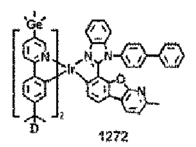
1272
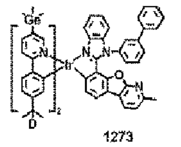
1273
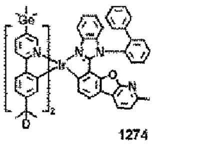
1274
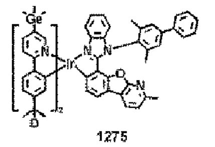
1275

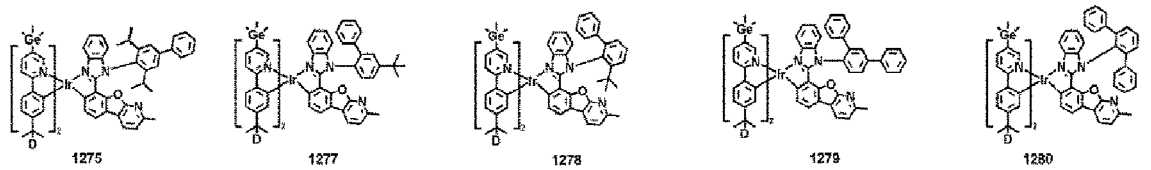
1275
1277
1278
1279
1280

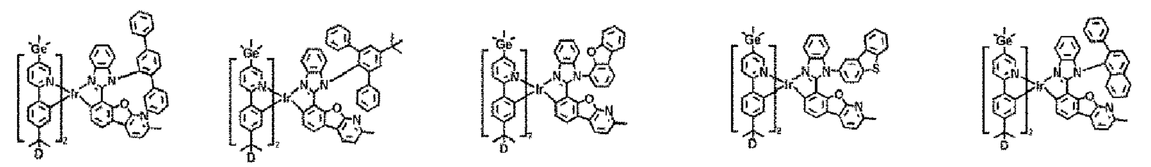
1281
1282
1283
1284
1285

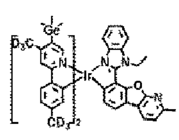
1286
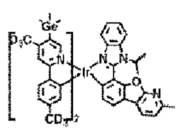
1287
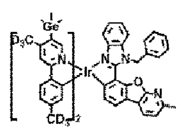
1288
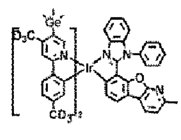
1289
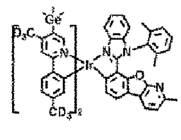
1290

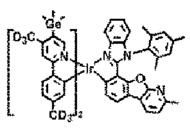
1291
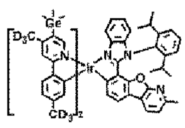
1292
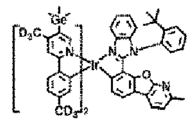
1293
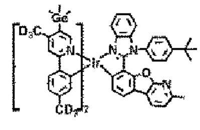
1294
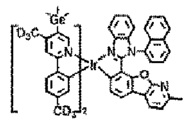
1295

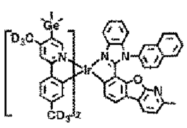
1296
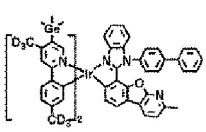
1297
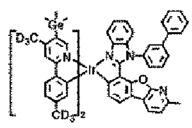
1298
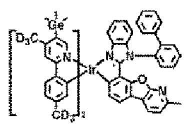
1299
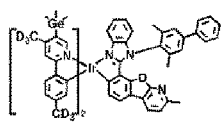
1300

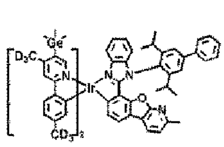
1301
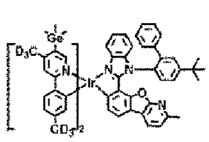
1302
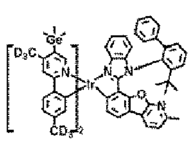
1303
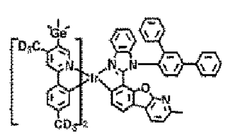
1304
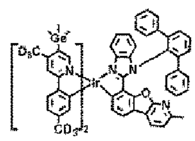
1305

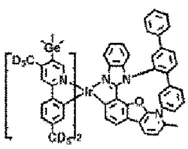
1306
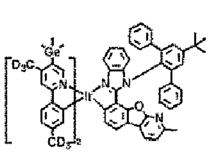
1307
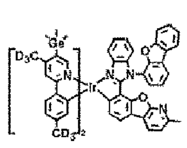
1308
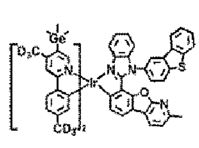
1309
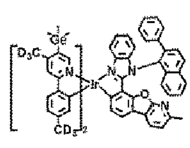
1310

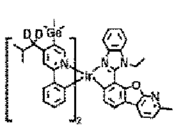
1311
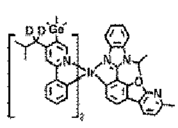
1312
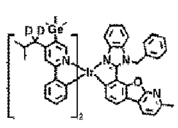
1313
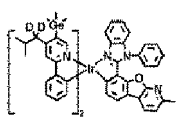
1314
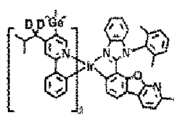
1315

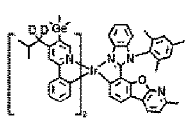
1316
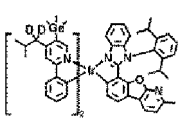
1317
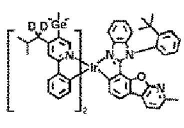
1318
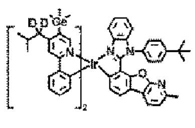
1319
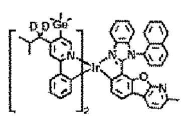
1320

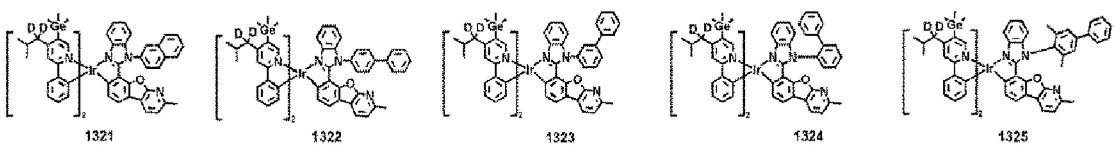
1321
1322
1323
1324
1325

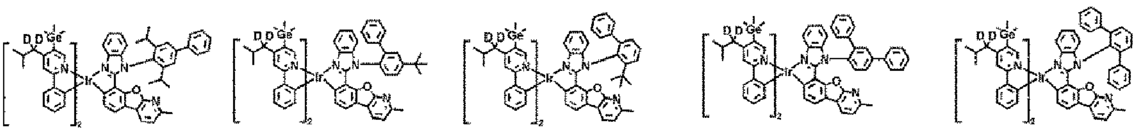
1326
1327
1328
1329
1330

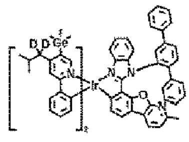
1331
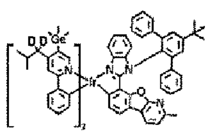
1332
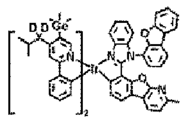
1333
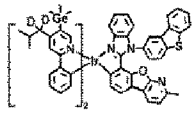
1334
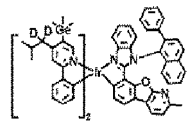
1335

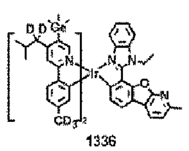
1336
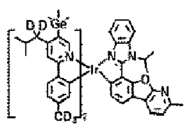
1337
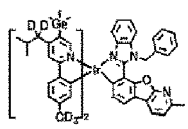
1338
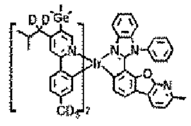
1339
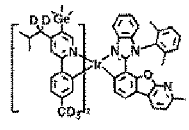
1340

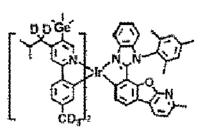
1341
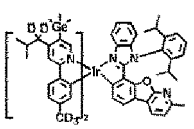
1342
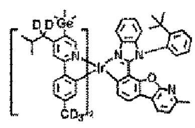
1343
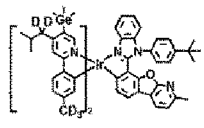
1344
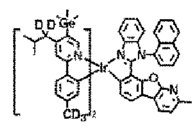
1345

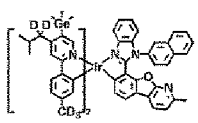
1346
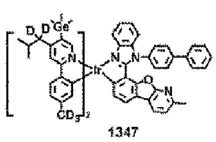
1347
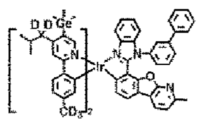
1348
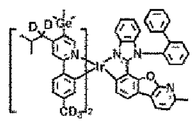
1349
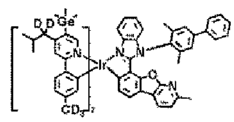
1350

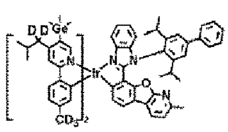
1351
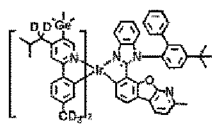
1352
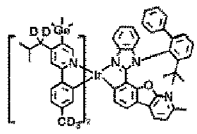
1353
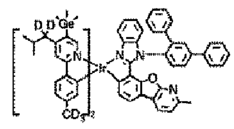
1354
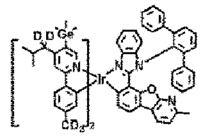
1355

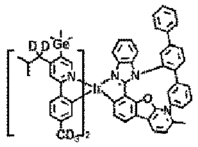
1356
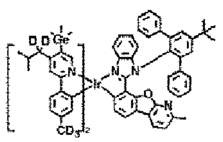
1357
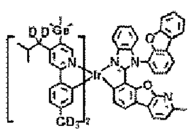
1358
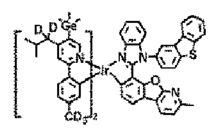
1359
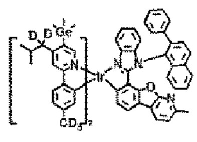
1360

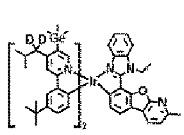
1361
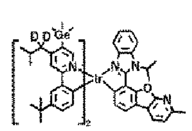
1362
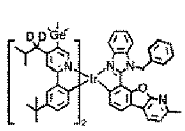
1363
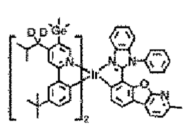
1364
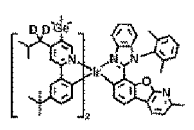
1365

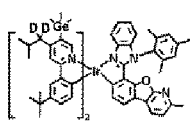
1366
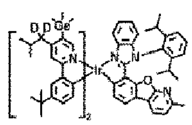
1367
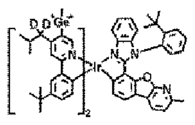
1368
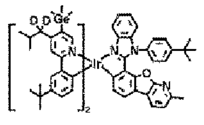
1369
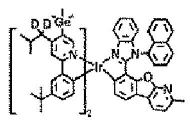
1370

1371
1372
1373
1374
1375

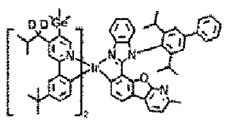
1376

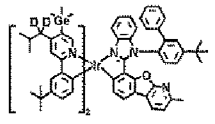
1377

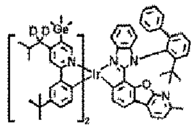
1378

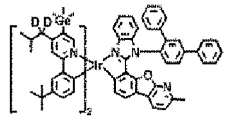
1379

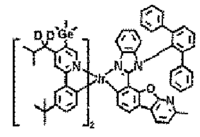
1380

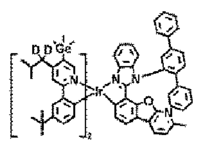
1381

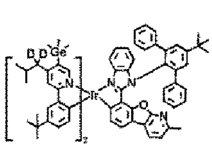
1382

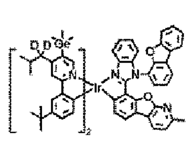
1383

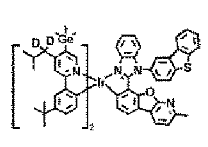
1384

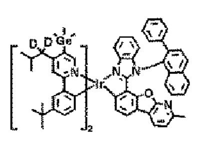
1385

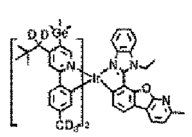
1386

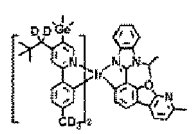
1387

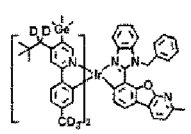
1388

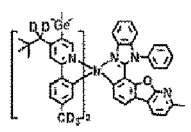
1389

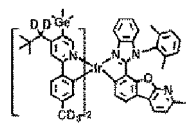
1390

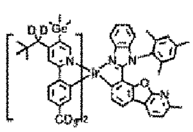
1391

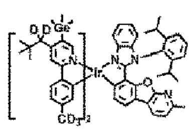
1392

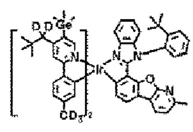
1393

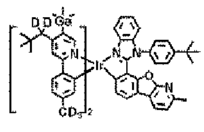
1394

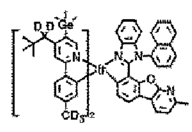
1395

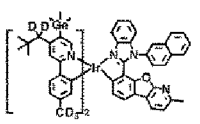
1396

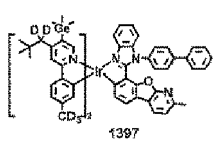
1397

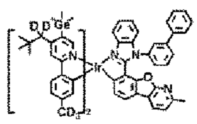
1398

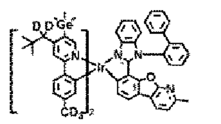
1399

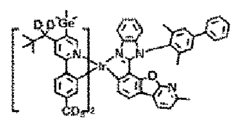
1400

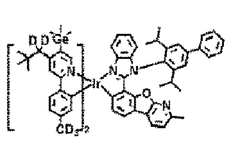
1401

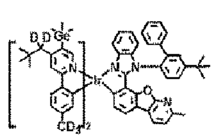
1402

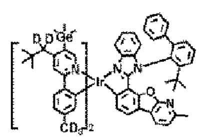
1403

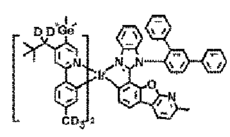
1404

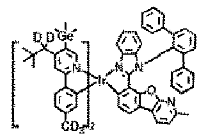
1405

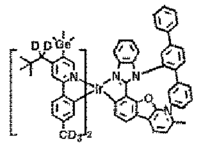
1406

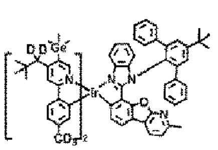
1407

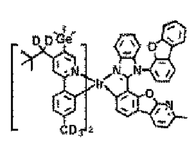
1408

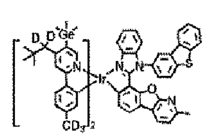
1409

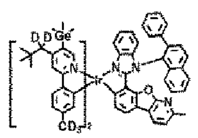
1410

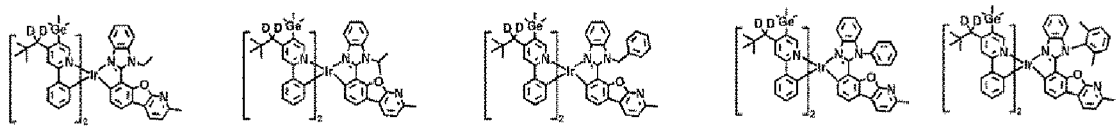
1411 1412 1413 1414 1415

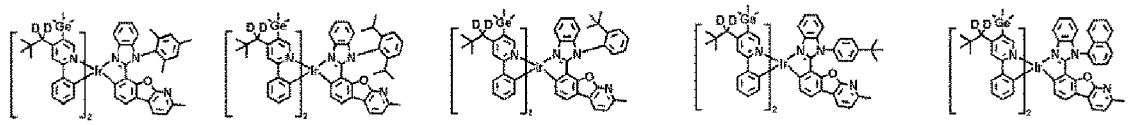
1416 1417 1418 1419 1420

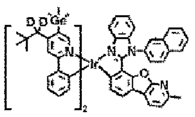
1421
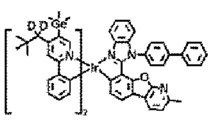
1422
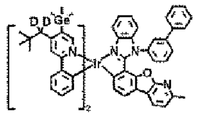
1423
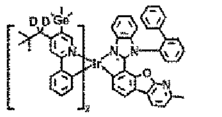
1424
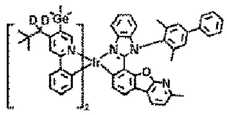
1425

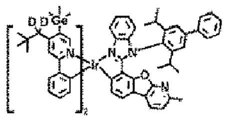
1426
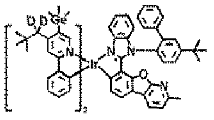
1427
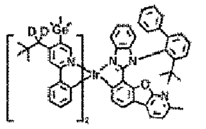
1428
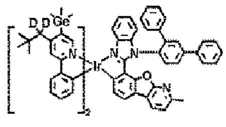
1429
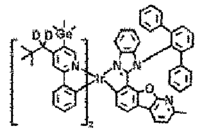
1430

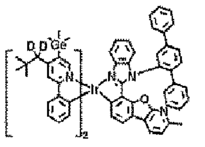
1431
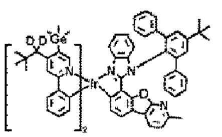
1432
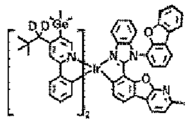
1433
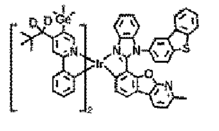
1434
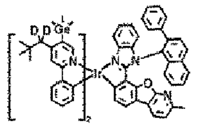
1435

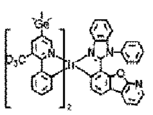
1436
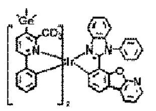
1437
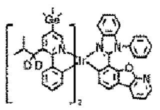
1438
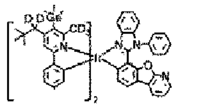
1439
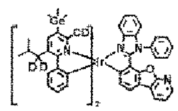
1440

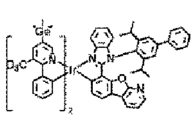
1441
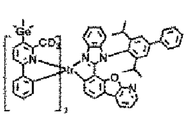
1442
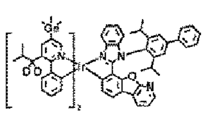
1443
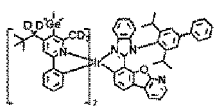
1444
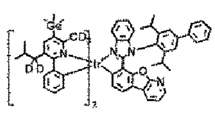
1445

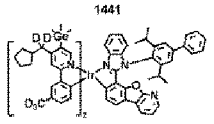
1446
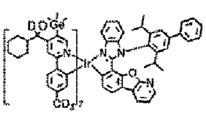
1447
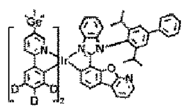
1448
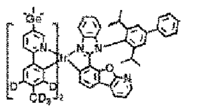
1449
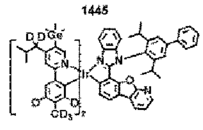
1450

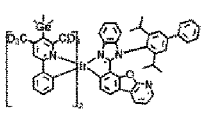
1451
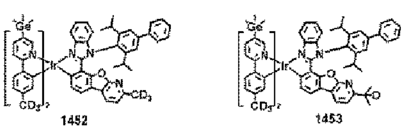
1452
1453
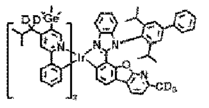
1454
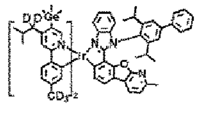
1455

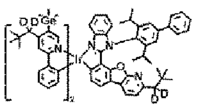
1456
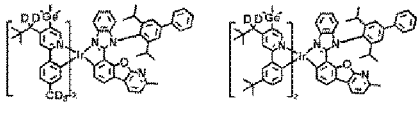
1457
1458
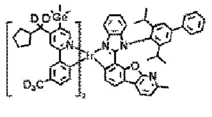
1459
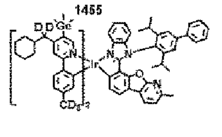
1460

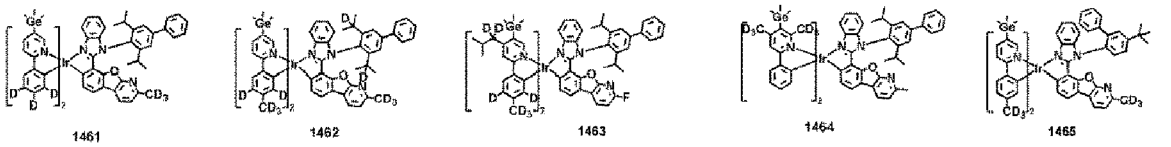
1461
1462
1463
1464
1465

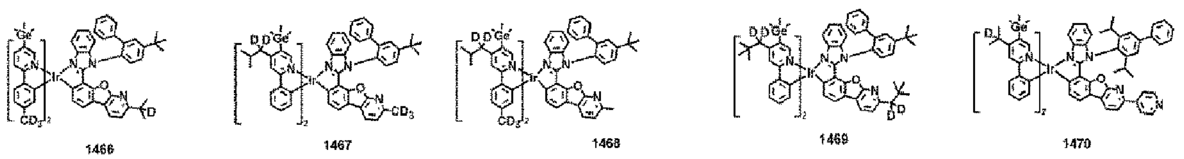
1466
1467
1468
1469
1470

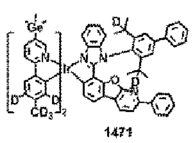
1471
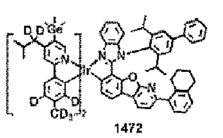
1472
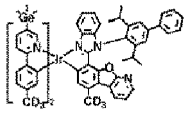
1473
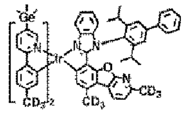
1474
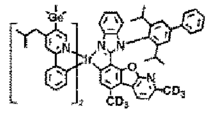
1475

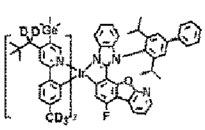
1476
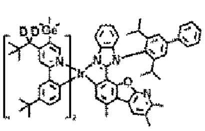
1477
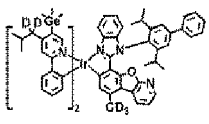
1478
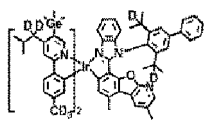
1479
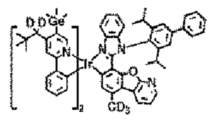
1480

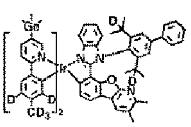
1481
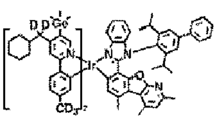
1482
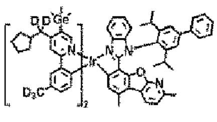
1483
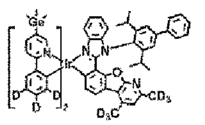
1484
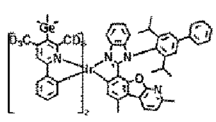
1485

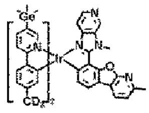
1486
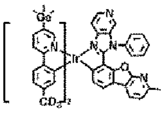
1487
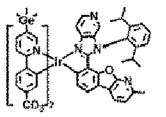
1488
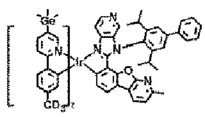
1489
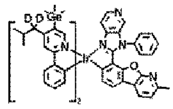
1490

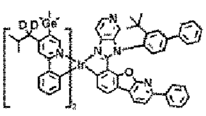
1491
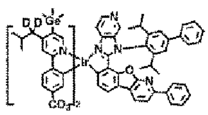
1492
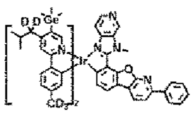
1493
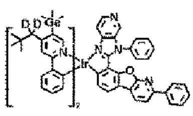
1494
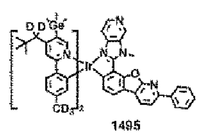
1495

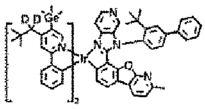
1496
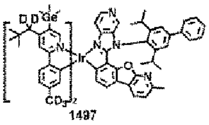
1497
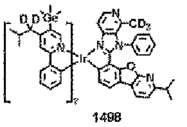
1498
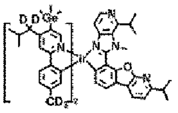
1499
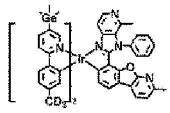
1500

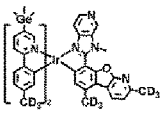
1501
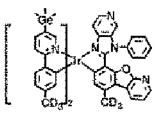
1502
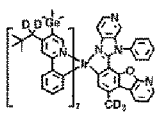
1503
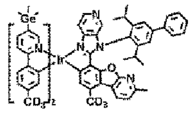
1504
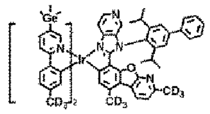
1505

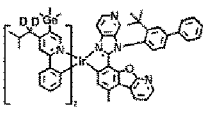
1506
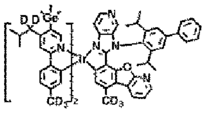
1507
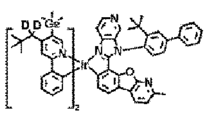
1508
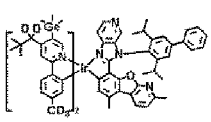
1509
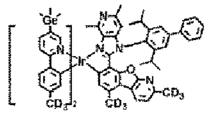
1510

1511
1512
1513
1514
1515

1516
1517
1518
1519
1520

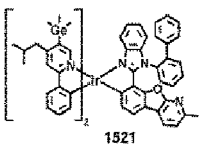
1521
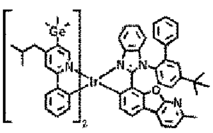
1522
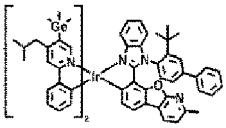
1523
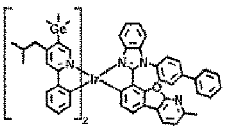
1524
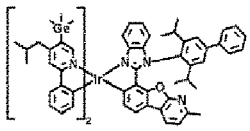
1525

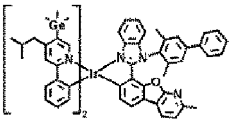
1526
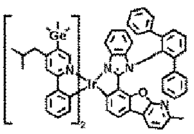
1527
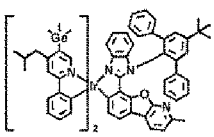
1528
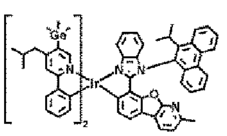
1529
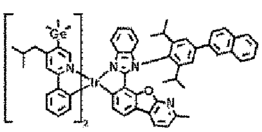
1530

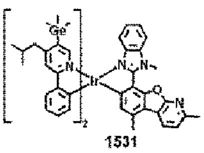
1531
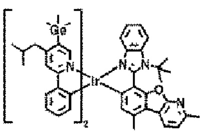
1532
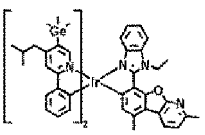
1533
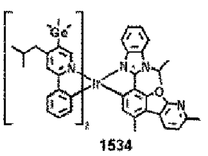
1534
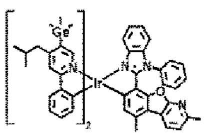
1535

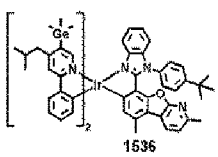
1536
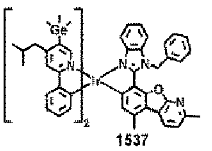
1537
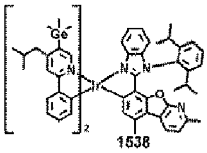
1538
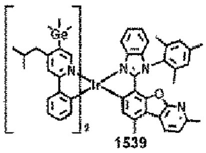
1539
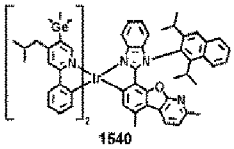
1540

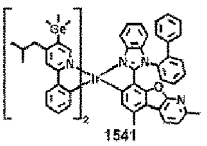
1541
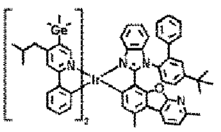
1542
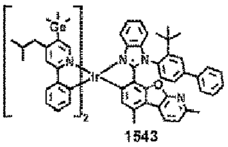
1543
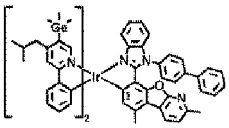
1544
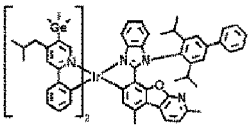
1545

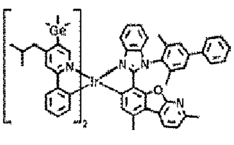
1546
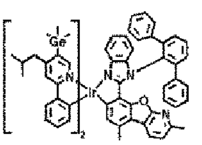
1547
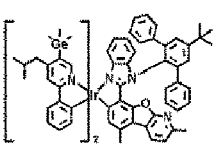
1548
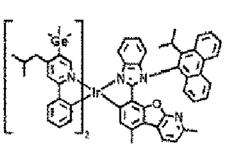
1549
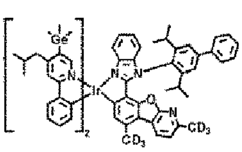
1550

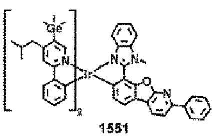
1551
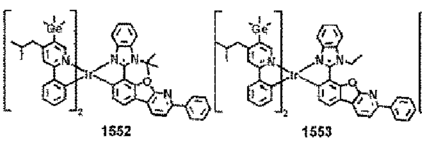
1552
1553
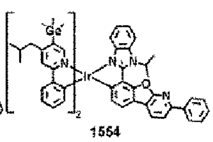
1554
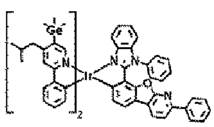
1555

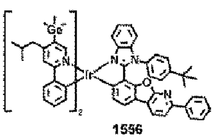
1556
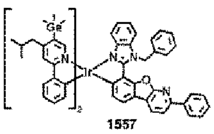
1557
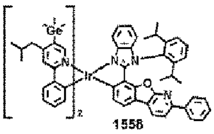
1558
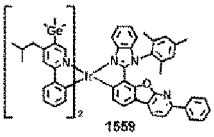
1559
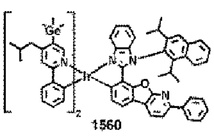
1560

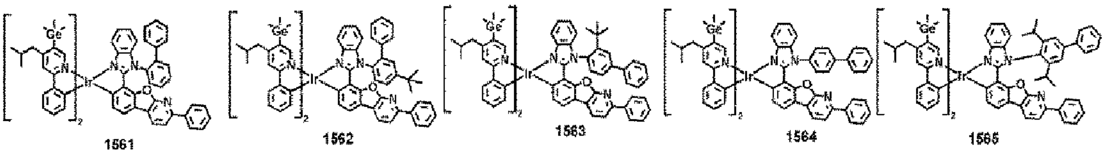
1561
1562
1563
1564
1565

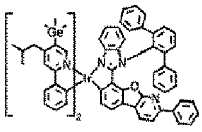
1566
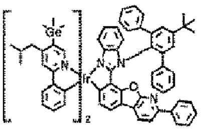
1567
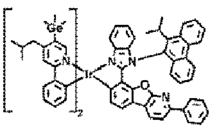
1568
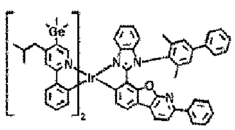
1569
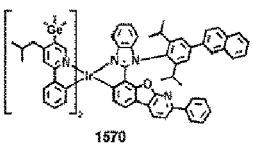
1570

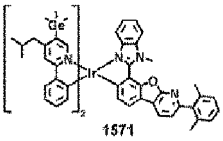
1571
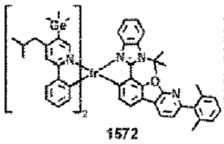
1572
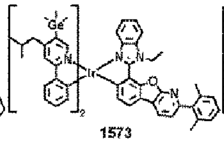
1573
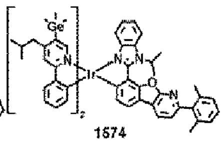
1574
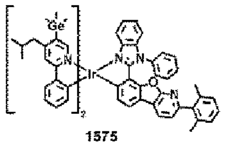
1575

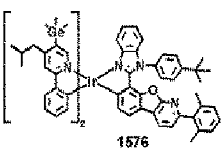
1576
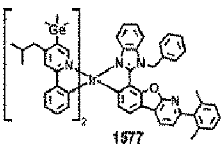
1577
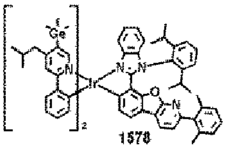
1578
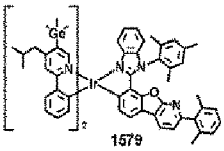
1579
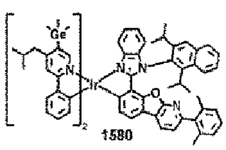
1580

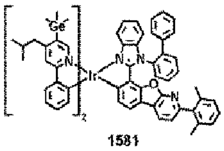
1581
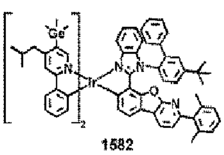
1582
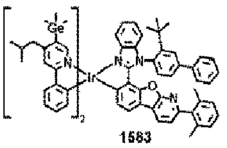
1583
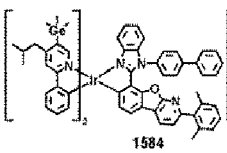
1584
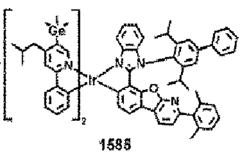
1585

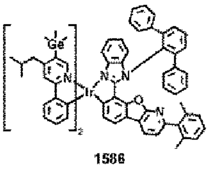
1586
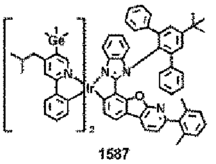
1587
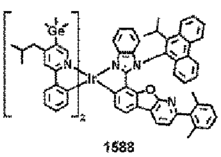
1588
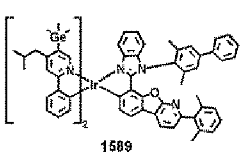
1589
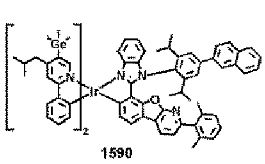
1590

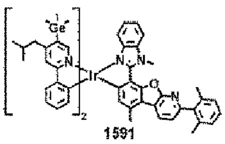
1591
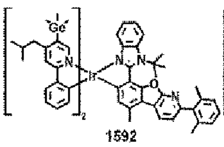
1592
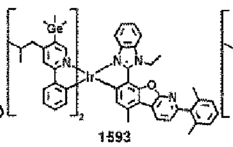
1593
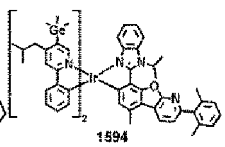
1594
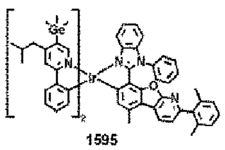
1595

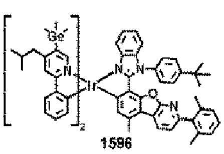
1596
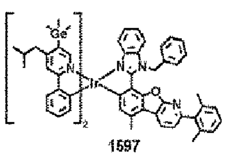
1597
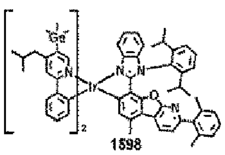
1598
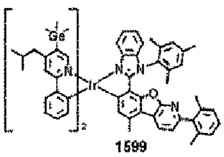
1599
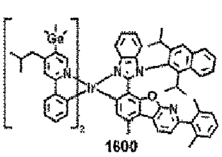
1600

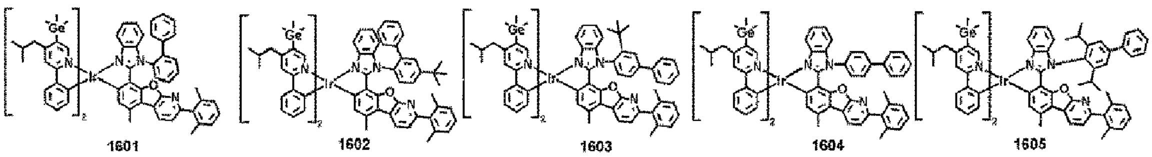
1601 1602 1603 1604 1605

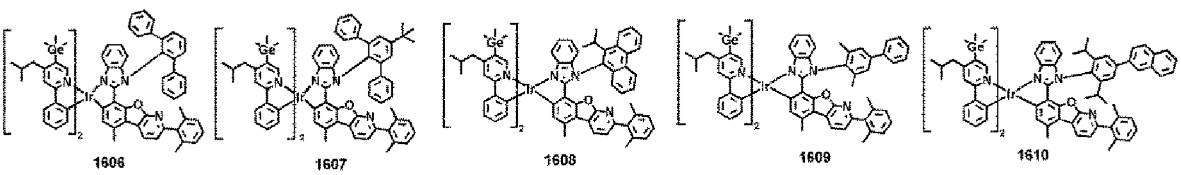
1606 1607 1608 1609 1610

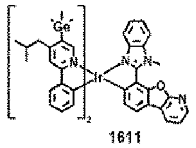
1611
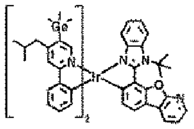
1612
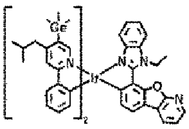
1613
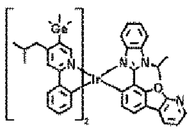
1614
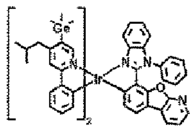
1615

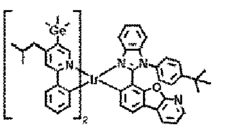
1616
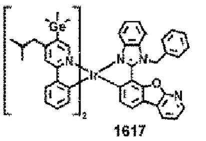
1617
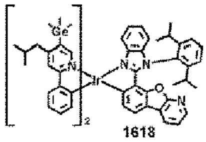
1618
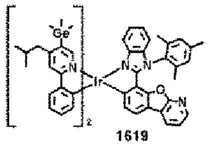
1619
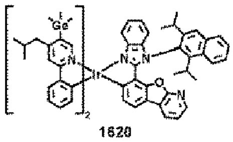
1620

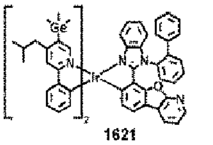
1621
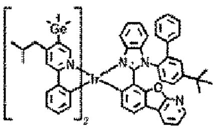
1622
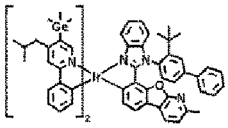
1623
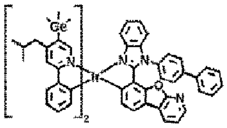
1624
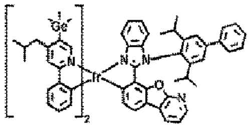
1625

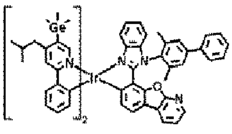
1626
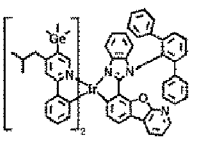
1627
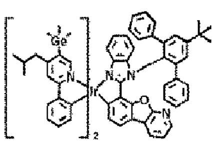
1628
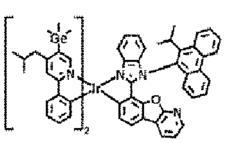
1629
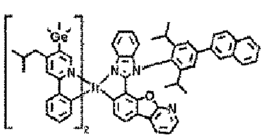
1630

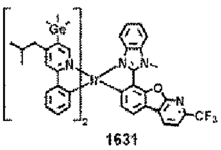
1631
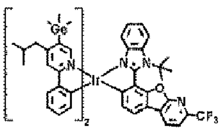
1632
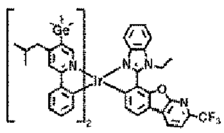
1633
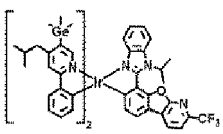
1634
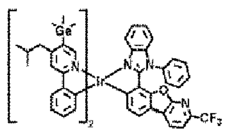
1635

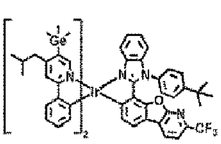
1636
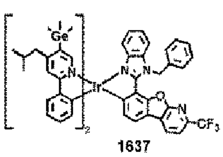
1637
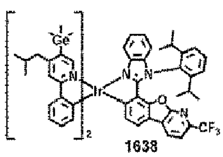
1638
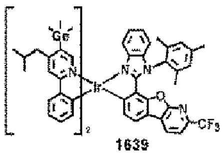
1639
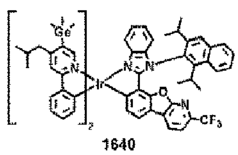
1640

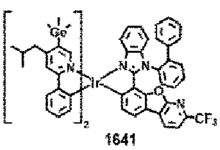
1641
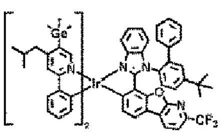
1642
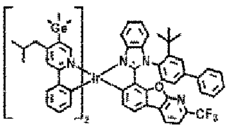
1643
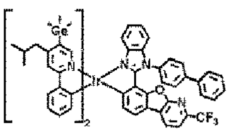
1644
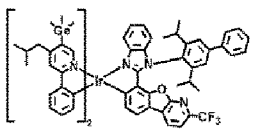
1645

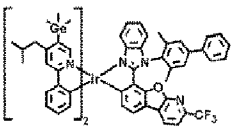
1646
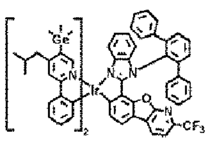
1647
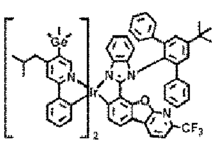
1648
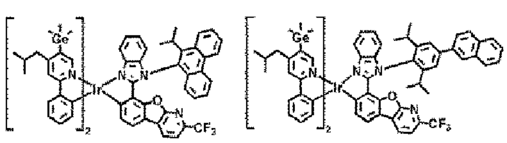
1649
1650

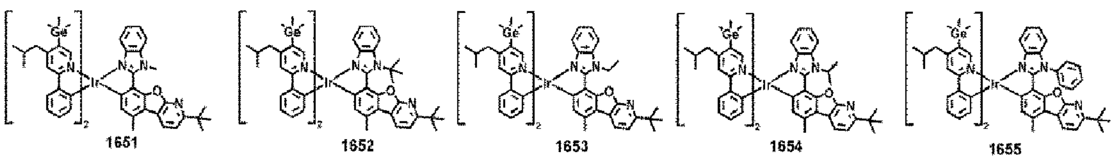
1651
1652
1653
1654
1655

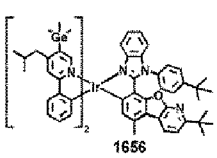
1656

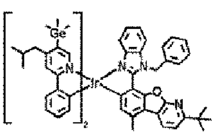
1657

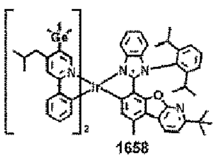
1658

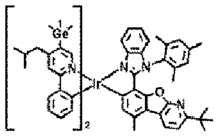
1659

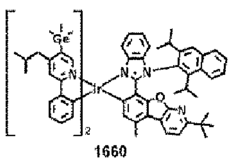
1660

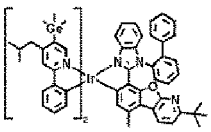
1661

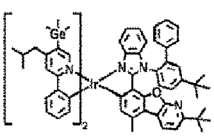
1662

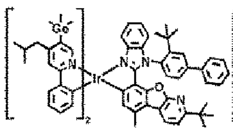
1663

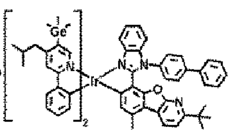
1664

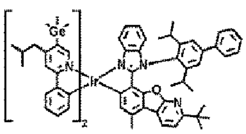
1665

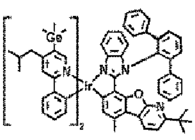
1666

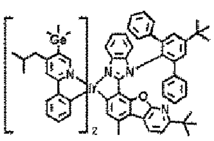
1667

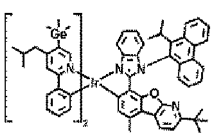
1668

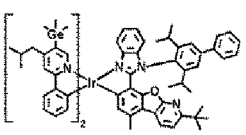
1669

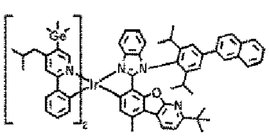
1670

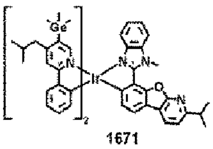
1671

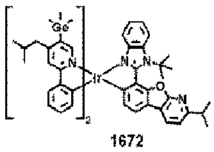
1672

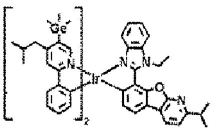
1673

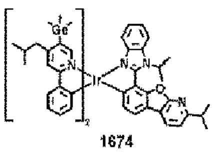
1674

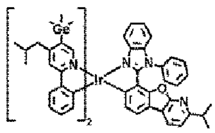
1675

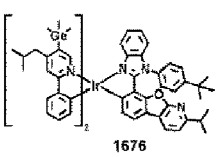
1676

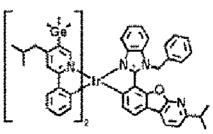
1677

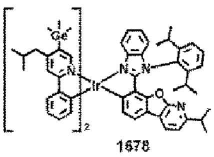
1678

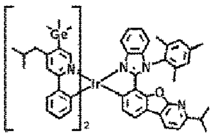
1679

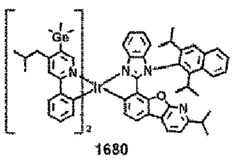
1680

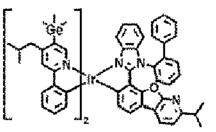
1681

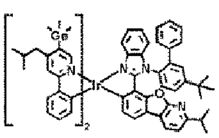
1682

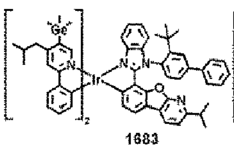
1683

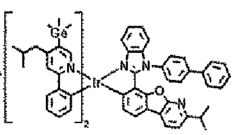
1684

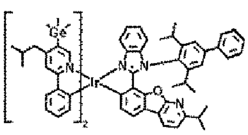
1685

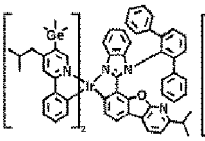
1686

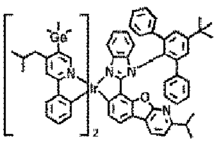
1687

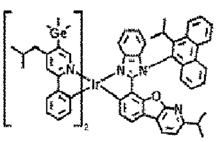
1688

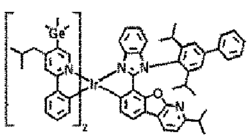
1689

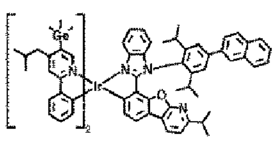
1690

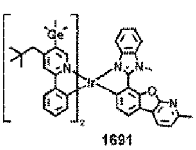
1691

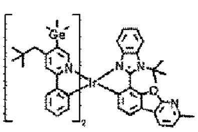
1692

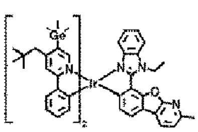
1693

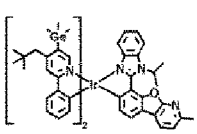
1694

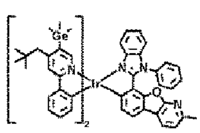
1695

1696

1697

1698

1699

1700

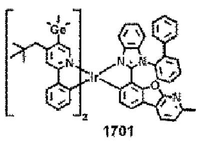
1701

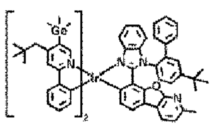
1702

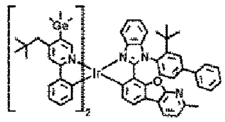
1703

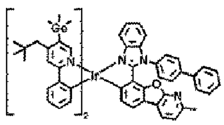
1704

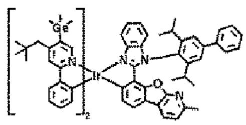
1705

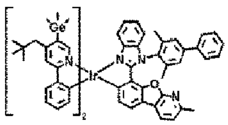
1706

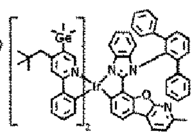
1707

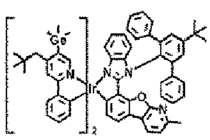
1708

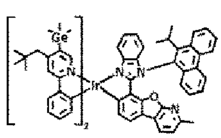
1709

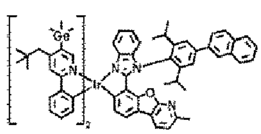
1710

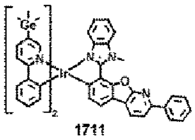
1711

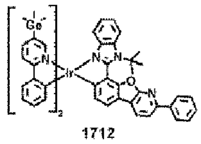
1712

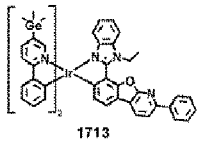
1713

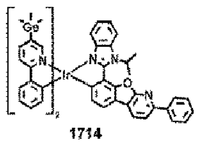
1714

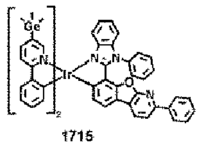
1715

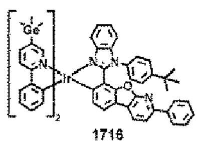
1716

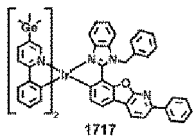
1717

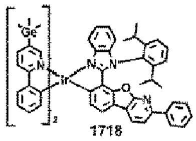
1718

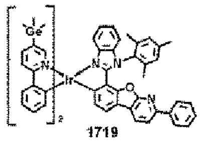
1719

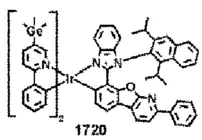
1720

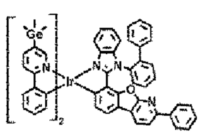
1721

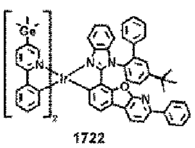
1722

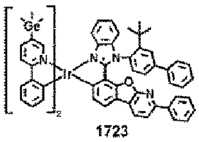
1723

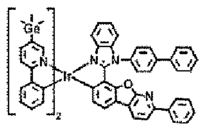
1724

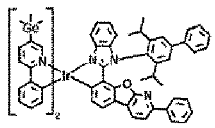
1725

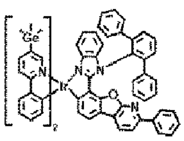
1726

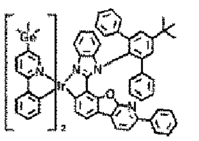
1727

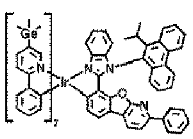
1728

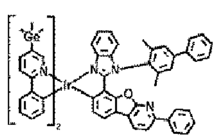
1729

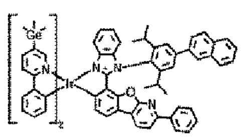
1730

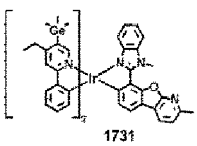
1731

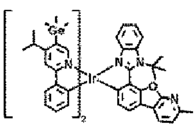
1732

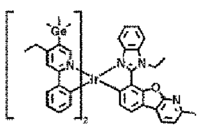
1733

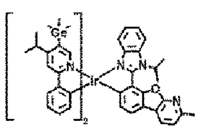
1734

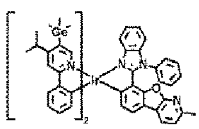
1735

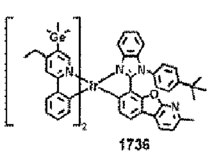
1736

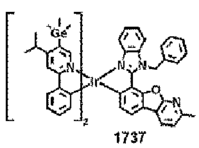
1737

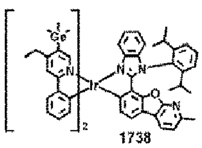
1738

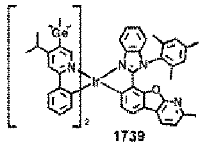
1739

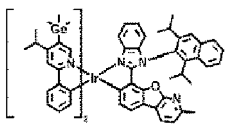
1740

1741

1742

1743

1744

1745

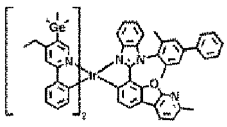
1746
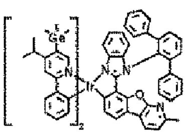
1747
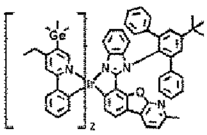
1748
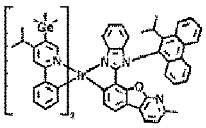
1749
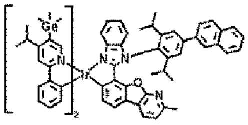
1750

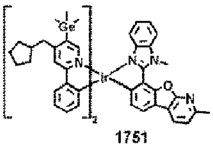
1751
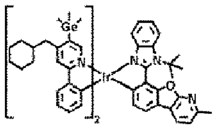
1752
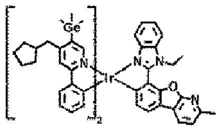
1753
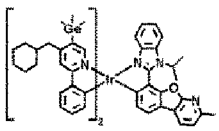
1754
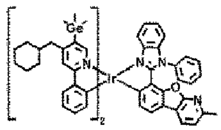
1755

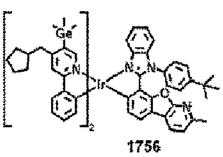
1756
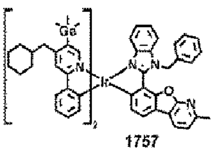
1757
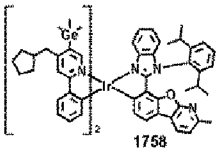
1758
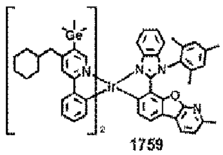
1759
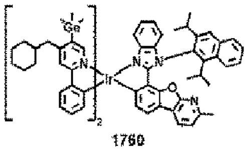
1760

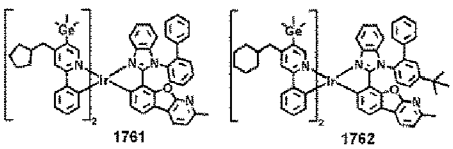
1761
1762
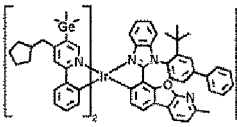
1763
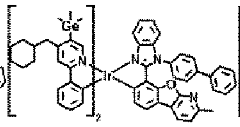
1764
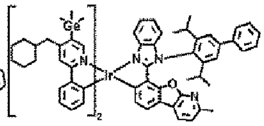
1765

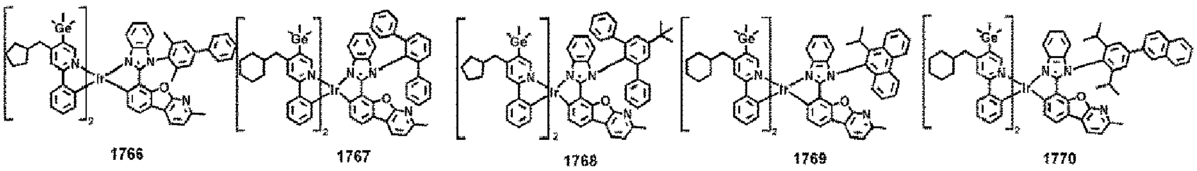
1766
1767
1768
1769
1770

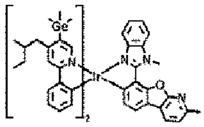
1771
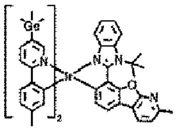
1772
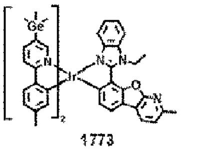
1773
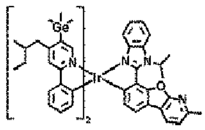
1774
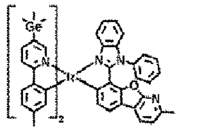
1775

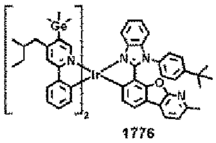
1776
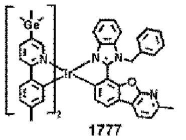
1777
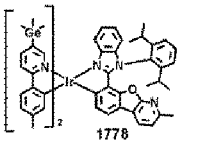
1778
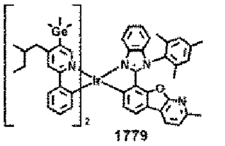
1779
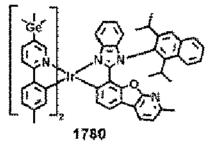
1780

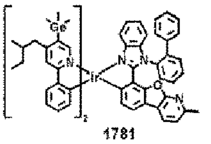
1781
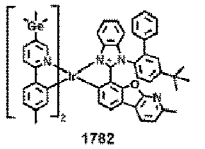
1782
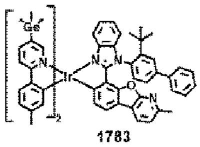
1783
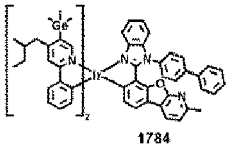
1784
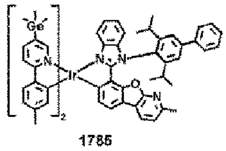
1785

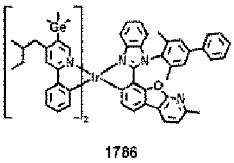
1786
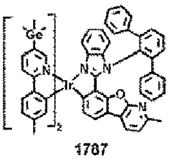
1787
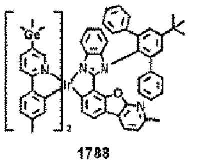
1788
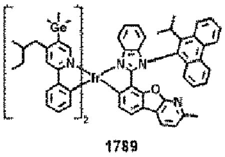
1789
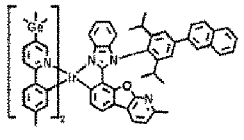
1790

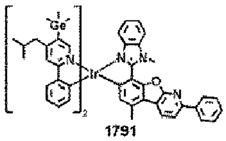
1791
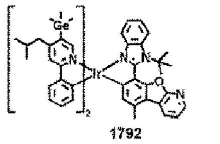
1792
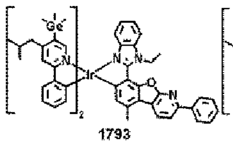
1793
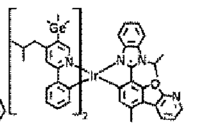
1794
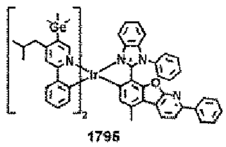
1795

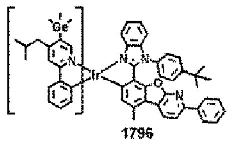
1796
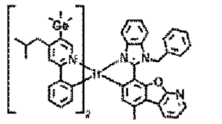
1797
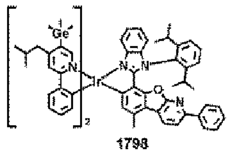
1798
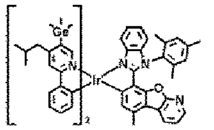
1799
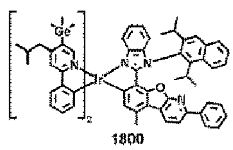
1800

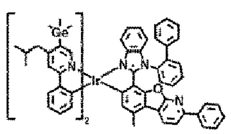
1801
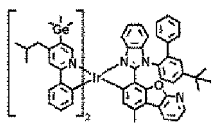
1802
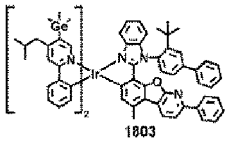
1803
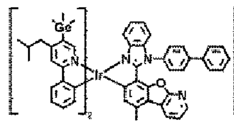
1804
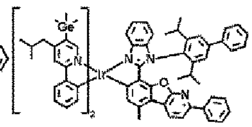
1805

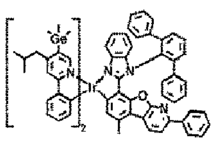
1806
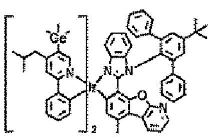
1807
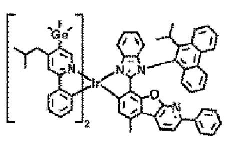
1808
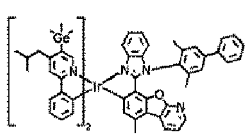
1809
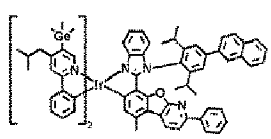
1810

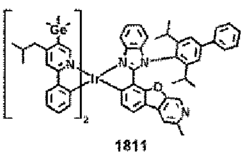
1811
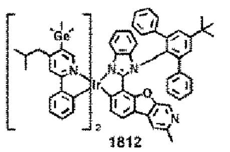
1812
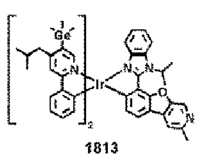
1813
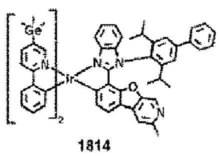
1814
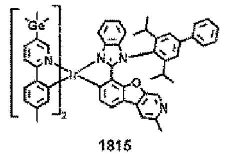
1815

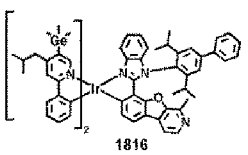
1816
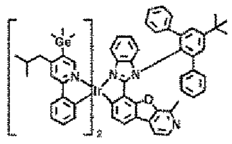
1817
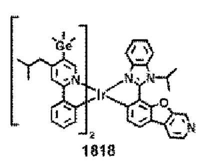
1818
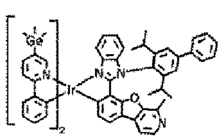
1819
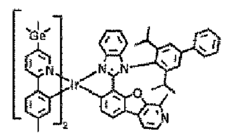
1820

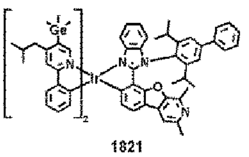
1821
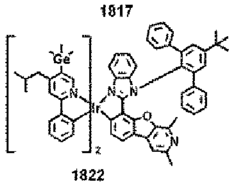
1822
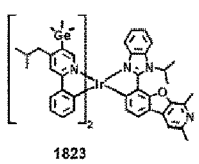
1823
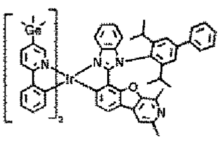
1824
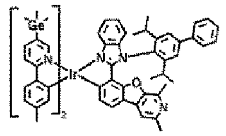
1825

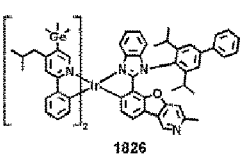
1826
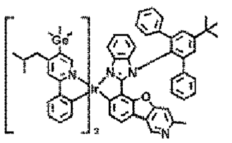
1827
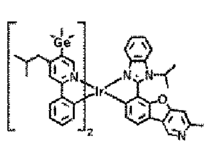
1828
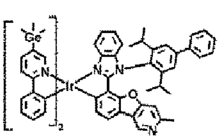
1829
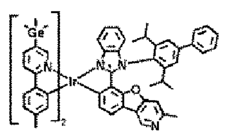
1830

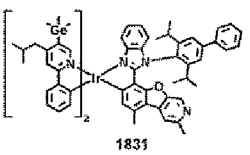
1831

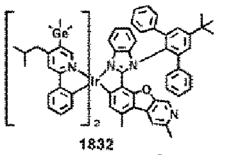
1832

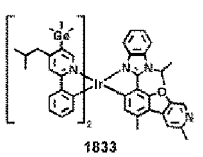
1833

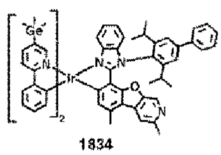
1834

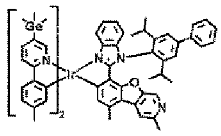
1835

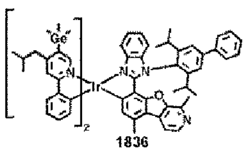
1836

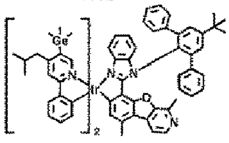
1837

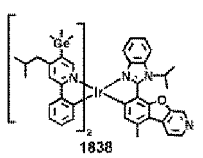
1838

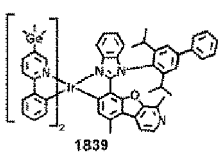
1839

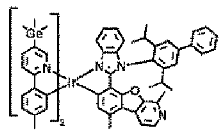
1840

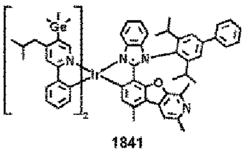
1841

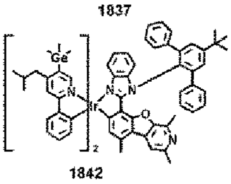
1842

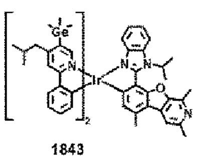
1843

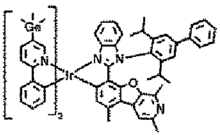
1844

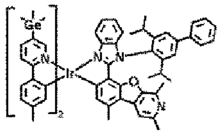
1845

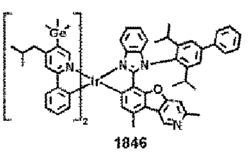
1846

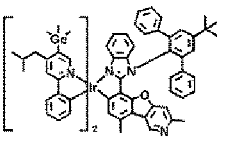
1847

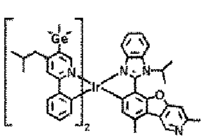
1848

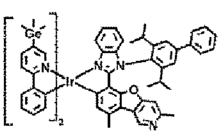
1849

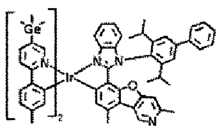
1850

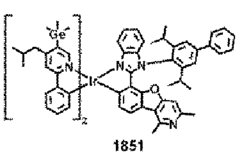
1851

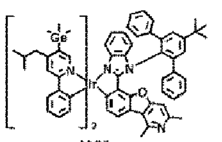
1852

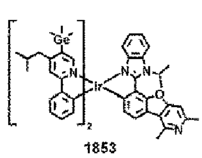
1853

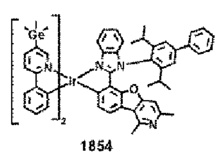
1854

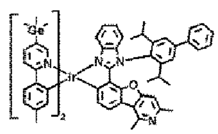
1855

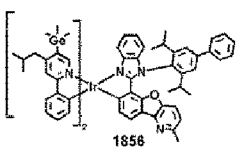
1856

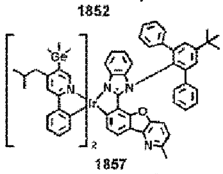
1857

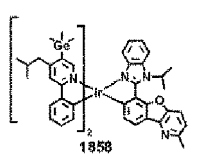
1858

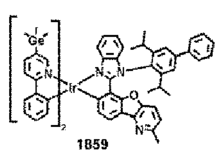
1859

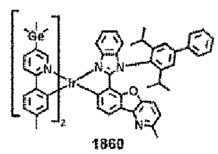
1860

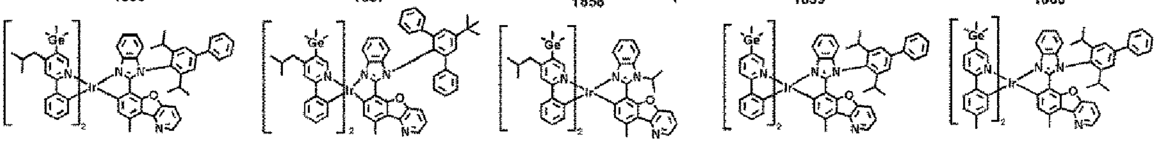
1861 1862 1863 1864 1865

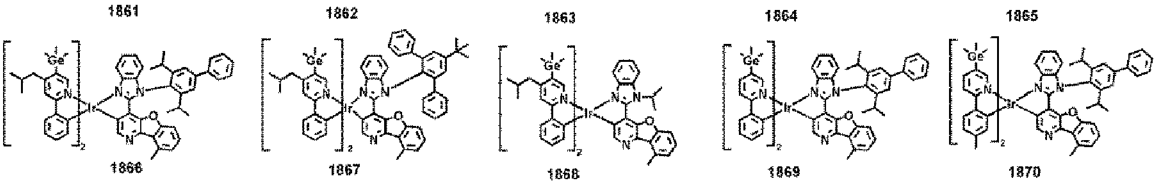
1866 1867 1868 1869 1870

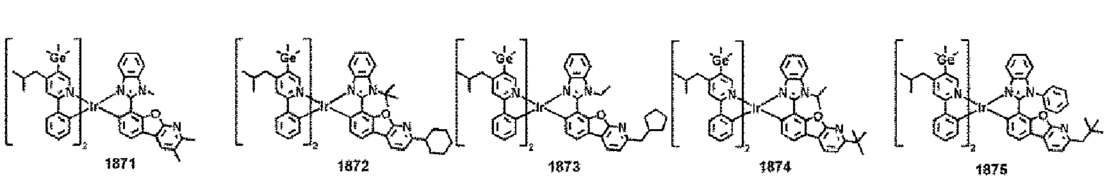
1871 1872 1873 1874 1875

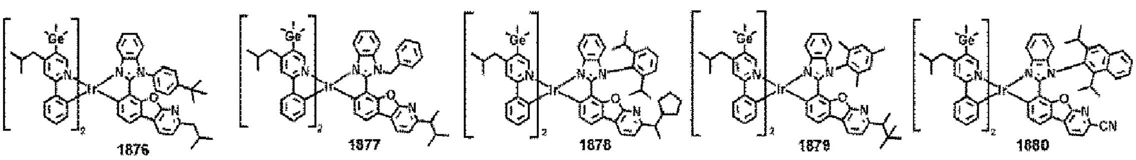
1876 1877 1878 1879 1880

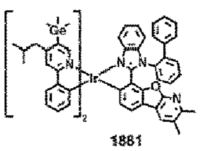
1881

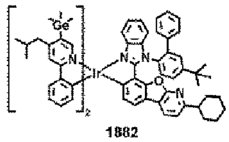
1882

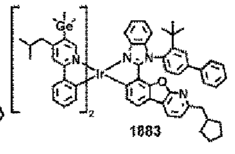
1883

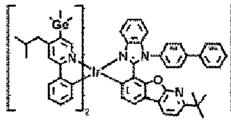
1884

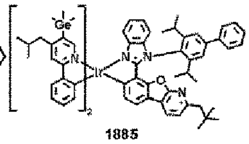
1885

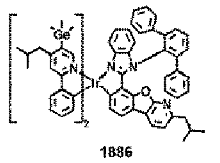
1886

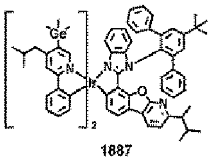
1887

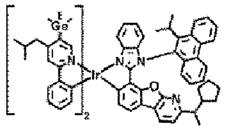
1888

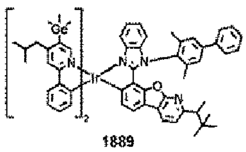
1889

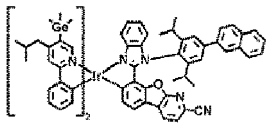
1890

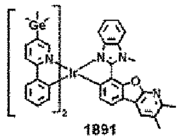
1891

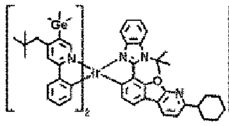
1892

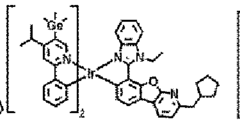
1893

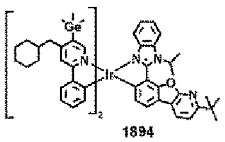
1894

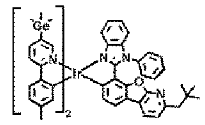
1895

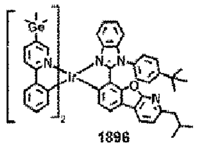
1896

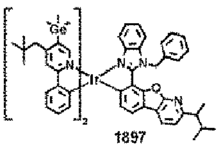
1897

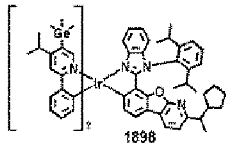
1898

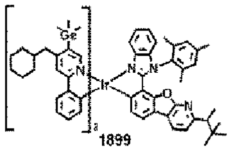
1899

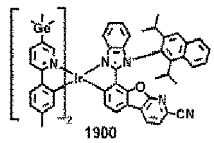
1900

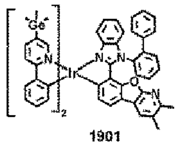
1901

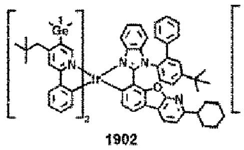
1902

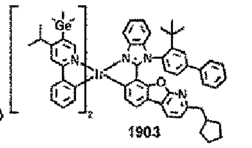
1903

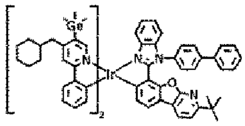
1904

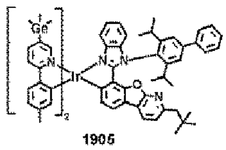
1905

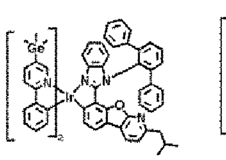
1906

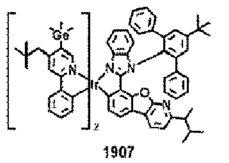
1907

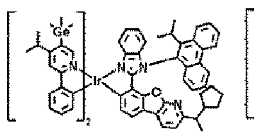
1908

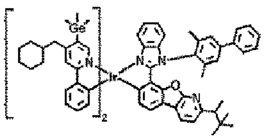
1909

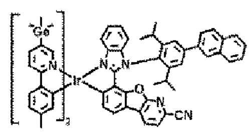
1910

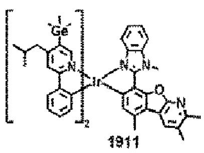
1911

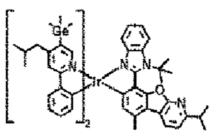
1912

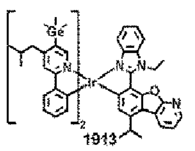
1913

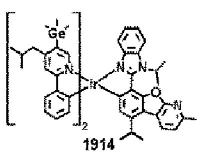
1914

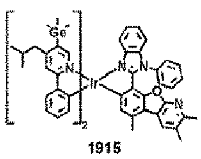
1915

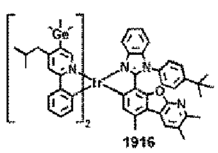
1916

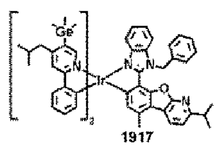
1917

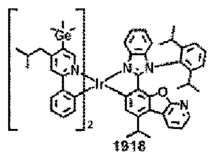
1918

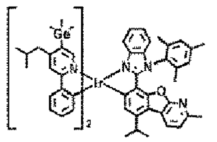
1919

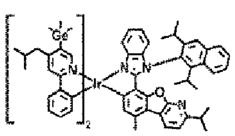
1920

1921

1922

1923

1924

1925

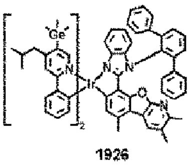
1926
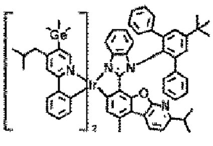
1927
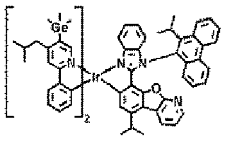
1928
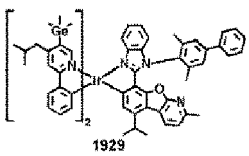
1929
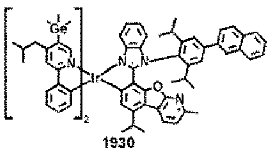
1930

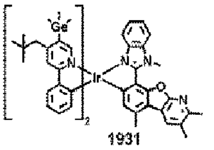
1931
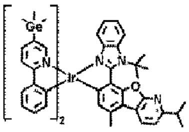
1932
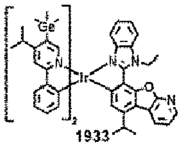
1933
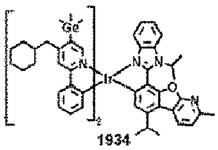
1934
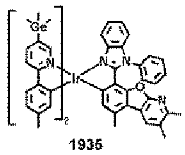
1935

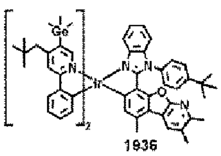
1936
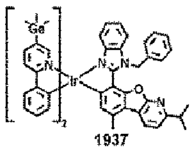
1937
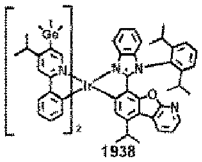
1938
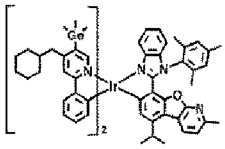
1939
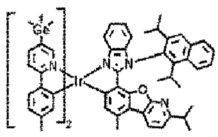
1940

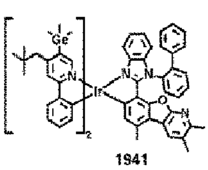
1941
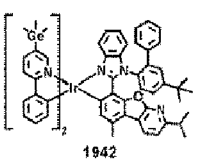
1942
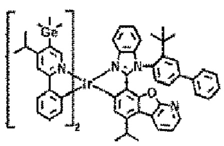
1943
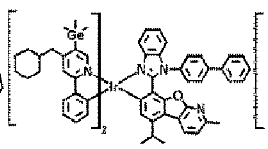
1944
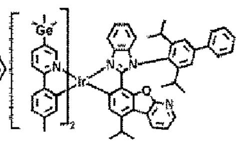
1945

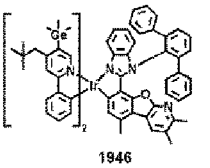
1946
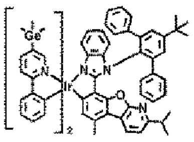
1947
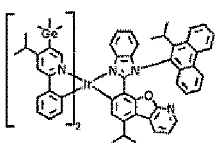
1948
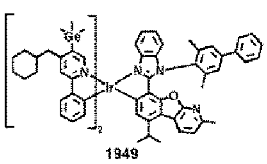
1949
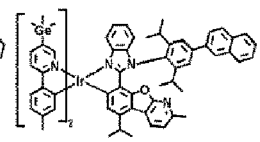
1950

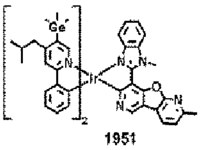
1951
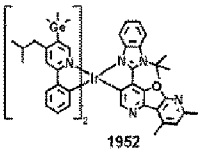
1952
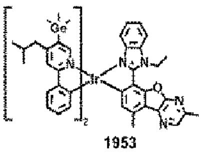
1953
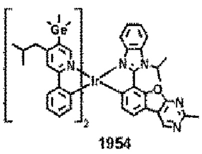
1954
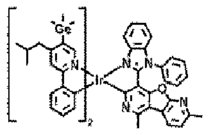
1955

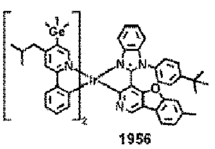
1956
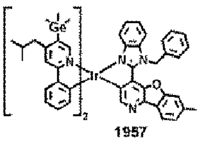
1957
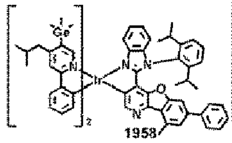
1958
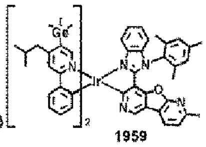
1959
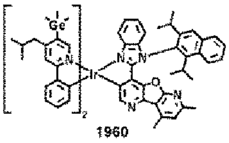
1960

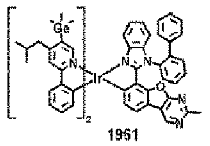
1961
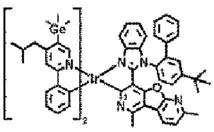
1962
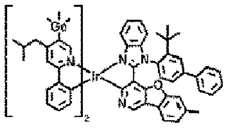
1963
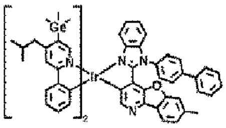
1964
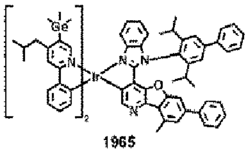
1965

1966
1967
1968
1969
1970

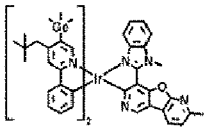
1971

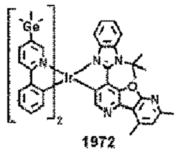
1972

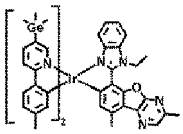
1973

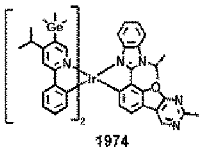
1974

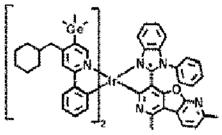
1975

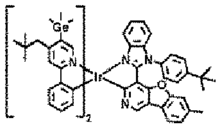
1976

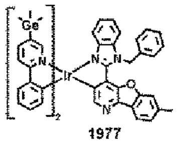
1977

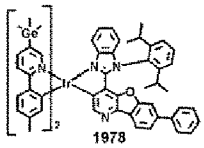
1978

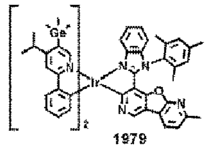
1979

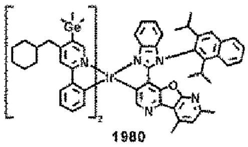
1980

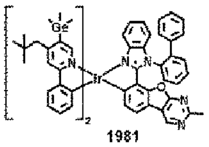
1981

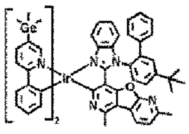
1982

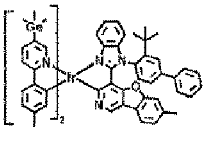
1983

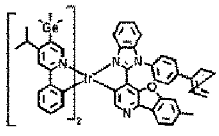
1984

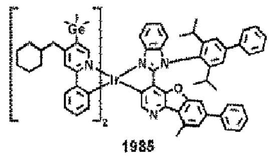
1985

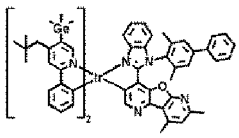
1986

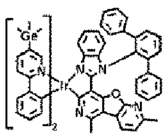
1987

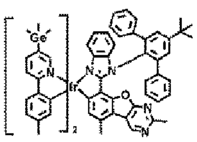
1988

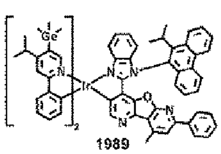
1989

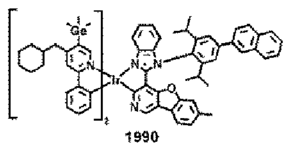
1990

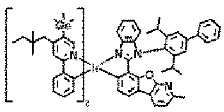
1991

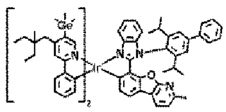
1992

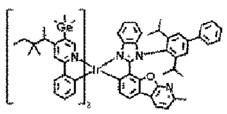
1993

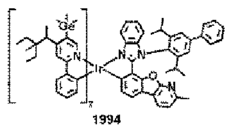
1994

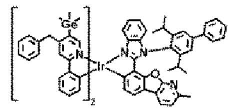
1995

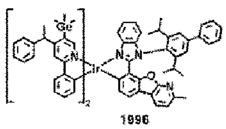
1996

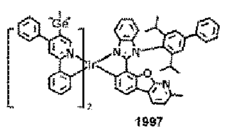
1997

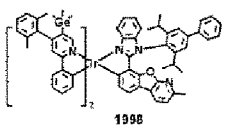
1998

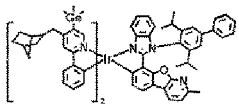
1999

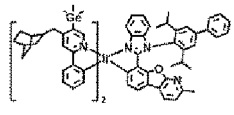
2000

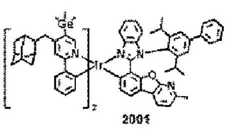
2001

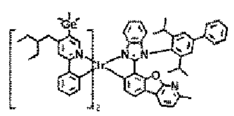
2002

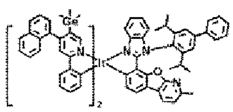
2003

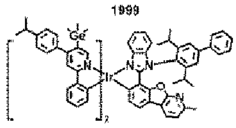
2004

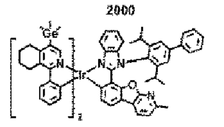
2005

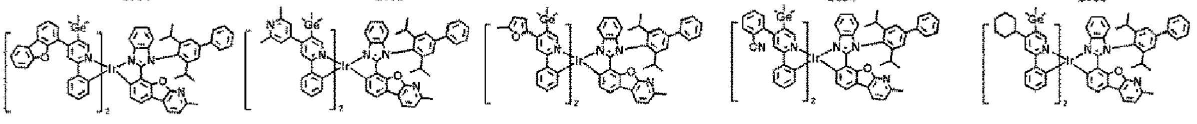
2006 2007 2008 2009 2010

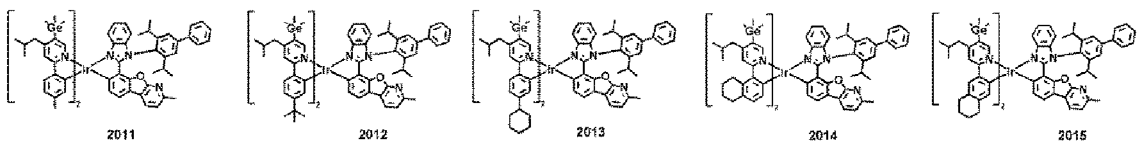
2011 2012 2013 2014 2015

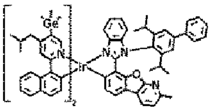
2016

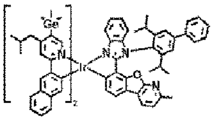
2017

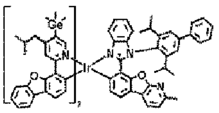
2018

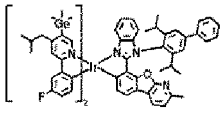
2019

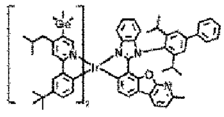
2020

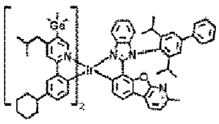
2021

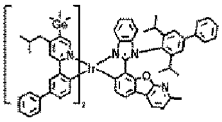
2022

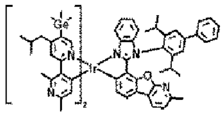
2023

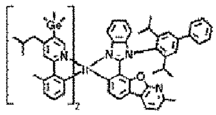
2024

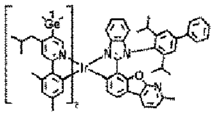
2025

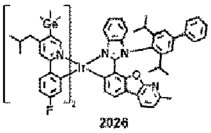
2026

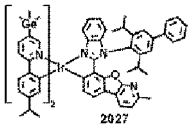
2027

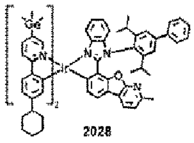
2028

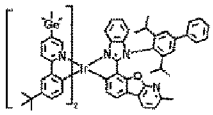
2029

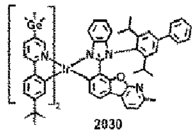
2030

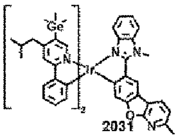
2031

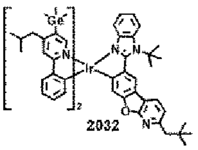
2032

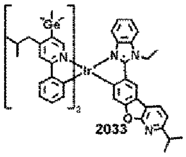
2033

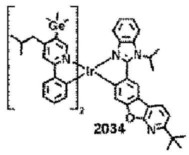
2034

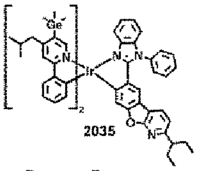
2035

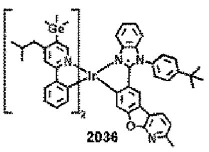
2036

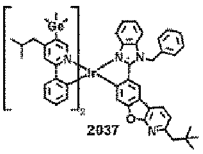
2037

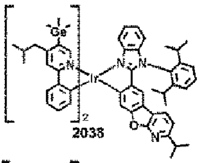
2038

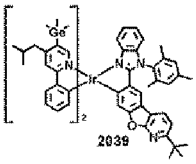
2039

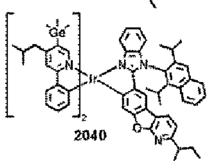
2040

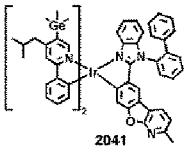
2041

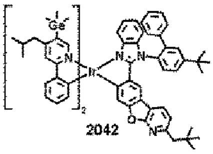
2042

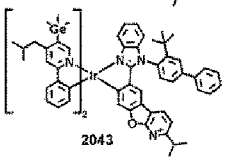
2043

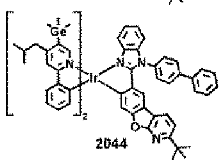
2044

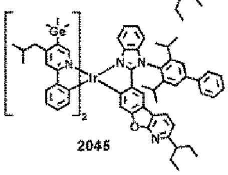
2045

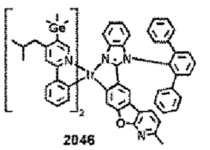
2046

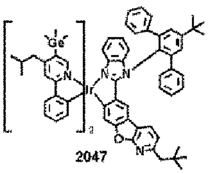
2047

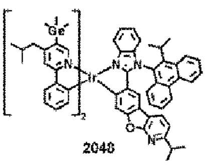
2048

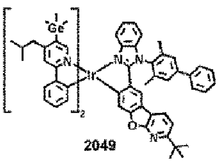
2049

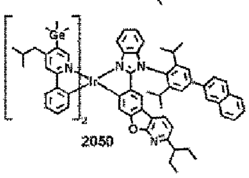
2050

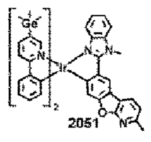
2051

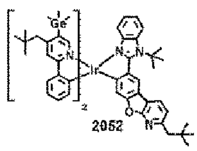
2052

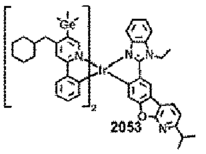
2053

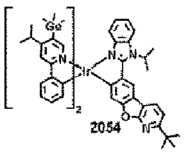
2054

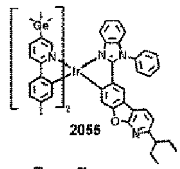
2055

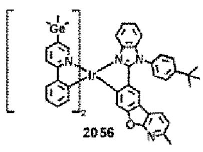
2056

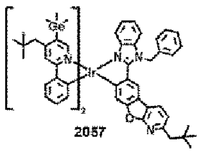
2057

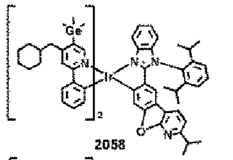
2058

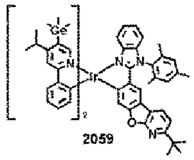
2059

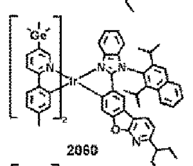
2060

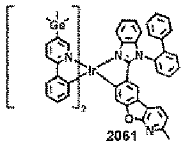
2061

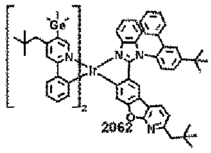
2062

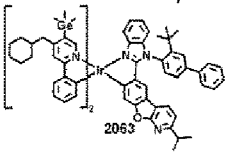
2063

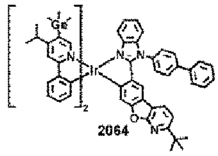
2064

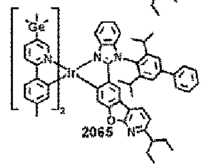
2065

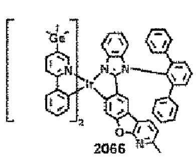
2066

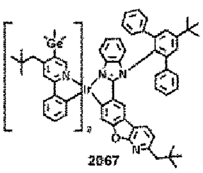
2067

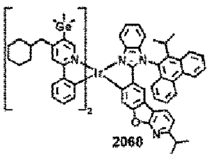
2068

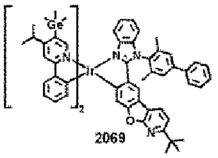
2069

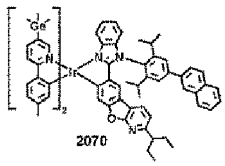
2070

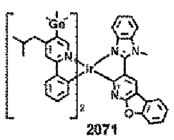
2071

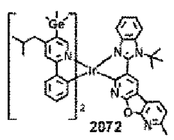
2072

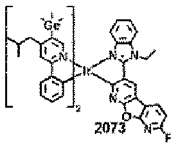
2073

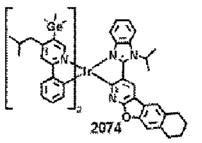
2074

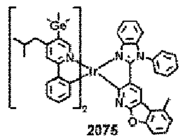
2075

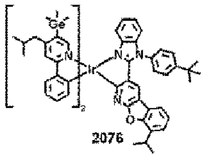
2076

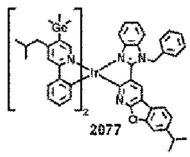
2077

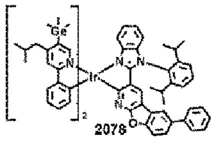
2078

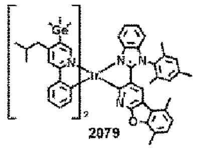
2079

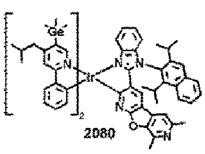
2080

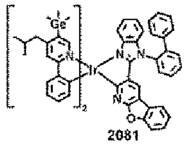
2081

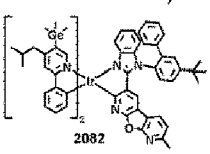
2082

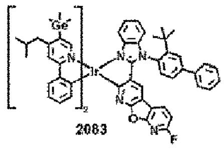
2083

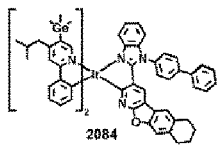
2084

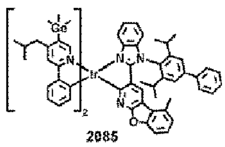
2085

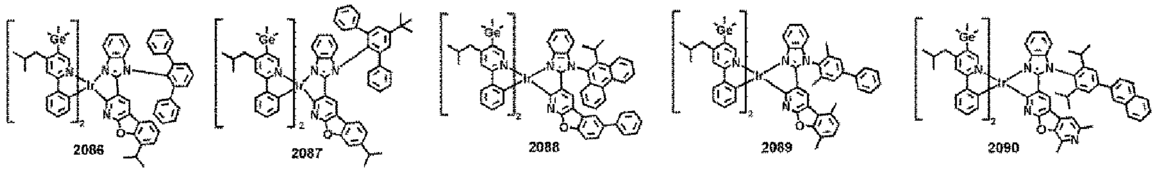
2086 2087 2088 2089 2090

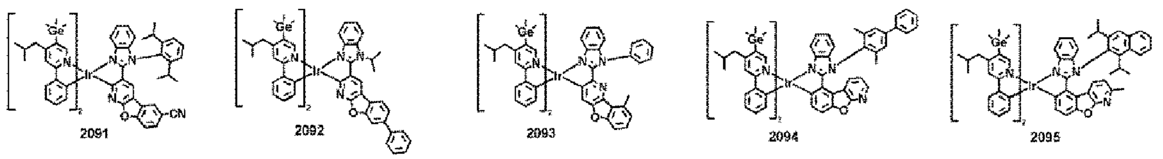
2091 2092 2093 2094 2095

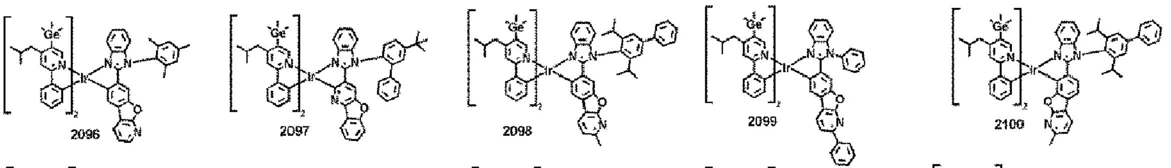

2096 2097 2098 2099 2100

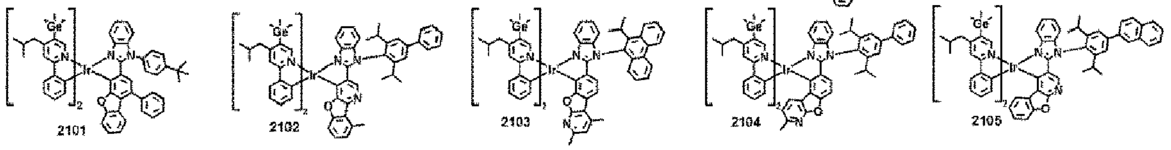

2101 2102 2103 2104 2105

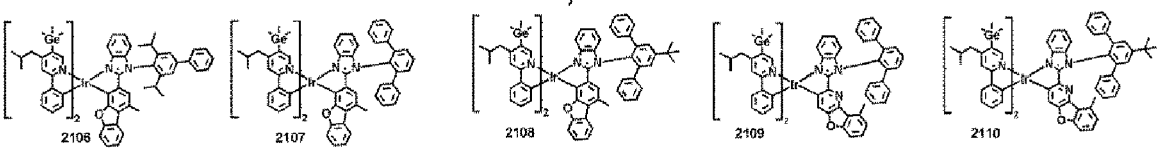

2106 2107 2108 2109 2110

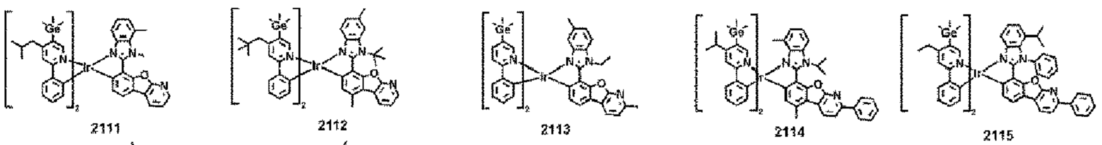

2111 2112 2113 2114 2115

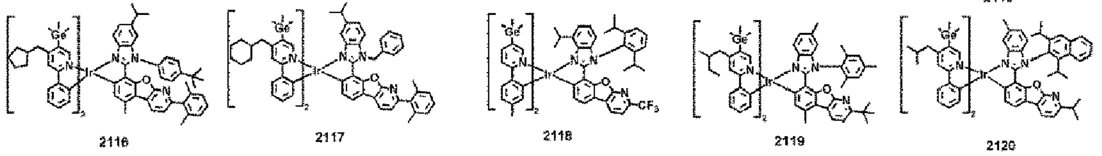

2116 2117 2118 2119 2120

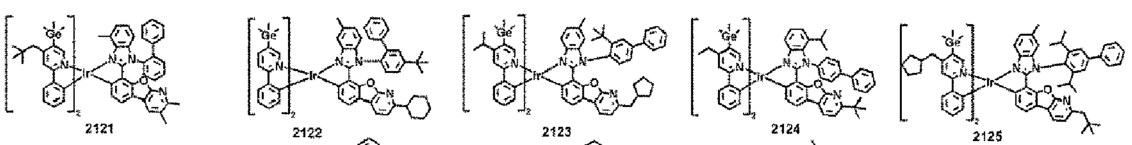

2121 2122 2123 2124 2125

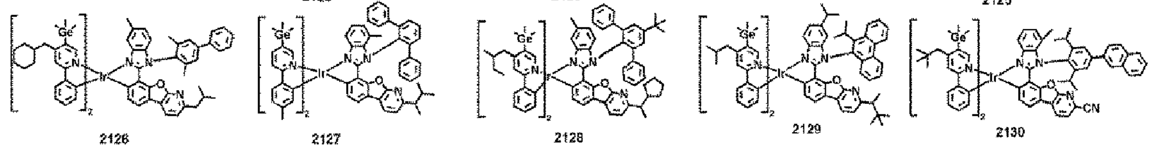

2126 2127 2128 2129 2130

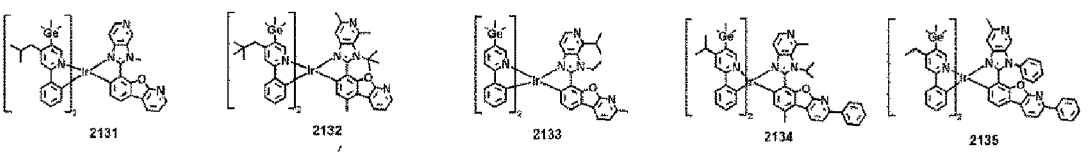

2131 2132 2133 2134 2135

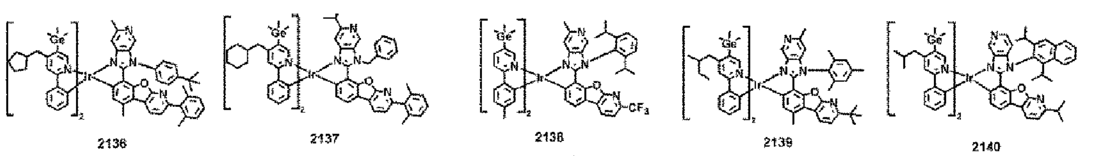

2136 2137 2138 2139 2140

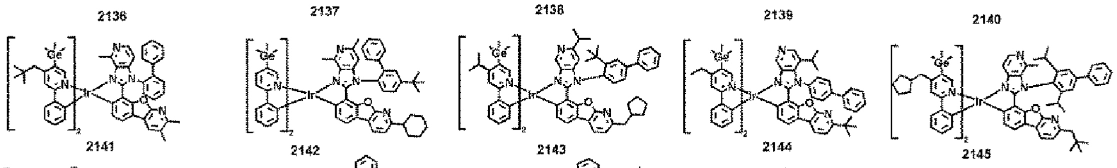

2141 2142 2143 2144 2145

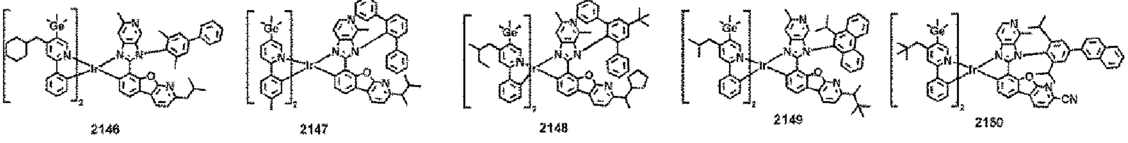

2146 2147 2148 2149 2150

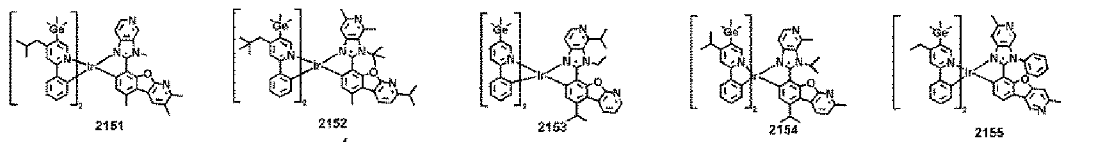

2151 2152 2153 2154 2155

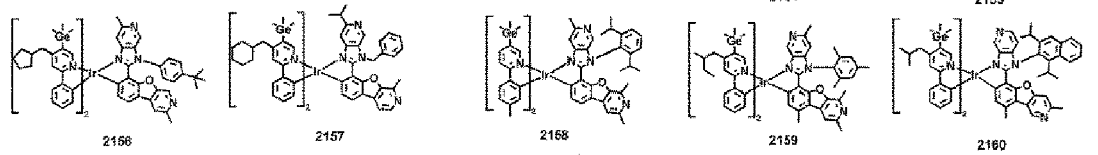

2156 2157 2158 2159 2160

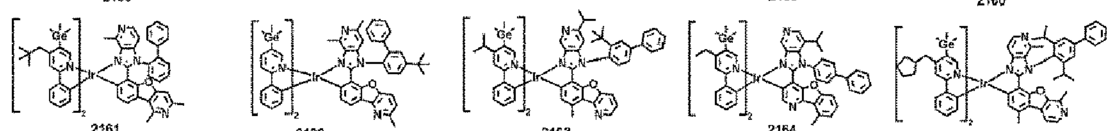

2161 2162 2163 2164 2165

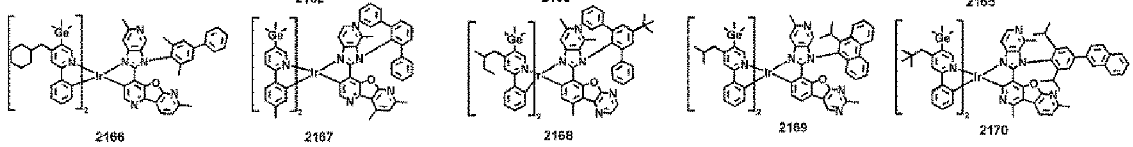

2166 2167 2168 2169 2170

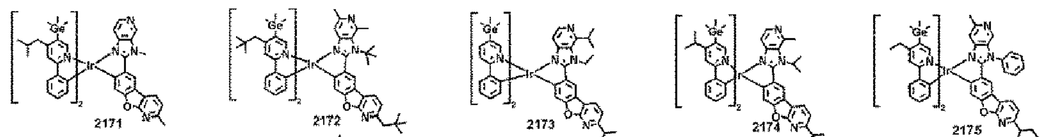

2171 2172 2173 2174 2175

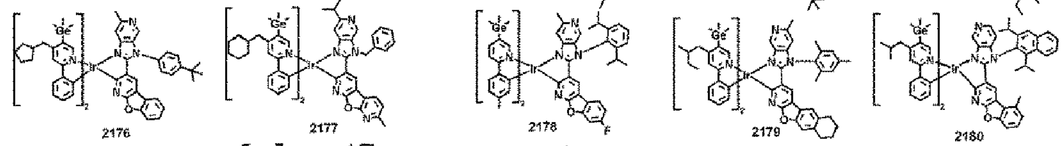

2176 2177 2178 2179 2180

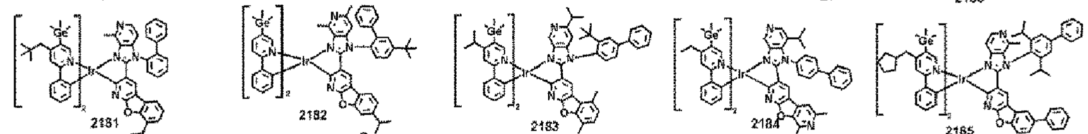

2181 2182 2183 2184 2185

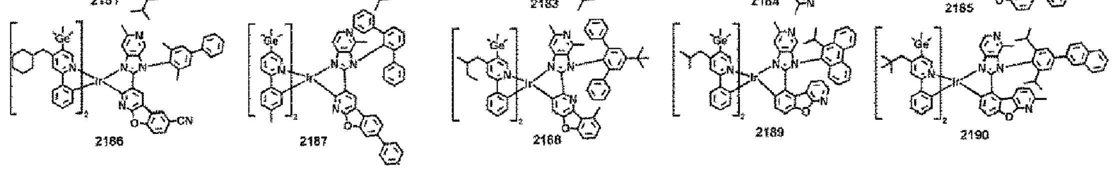

2186 2187 2188 2189 2190

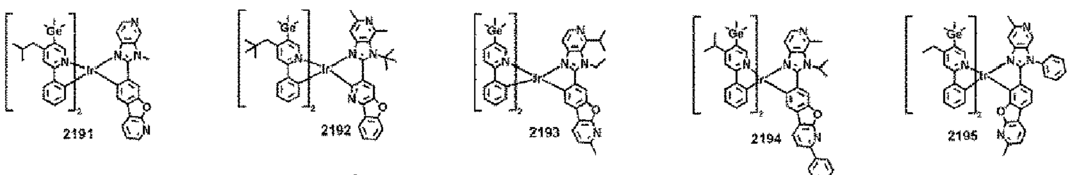

2191 2192 2193 2194 2195

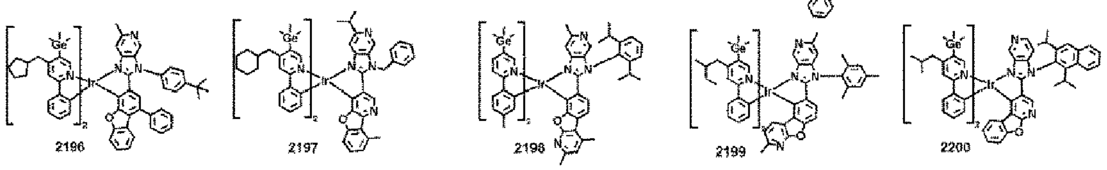

2196 2197 2198 2199 2200

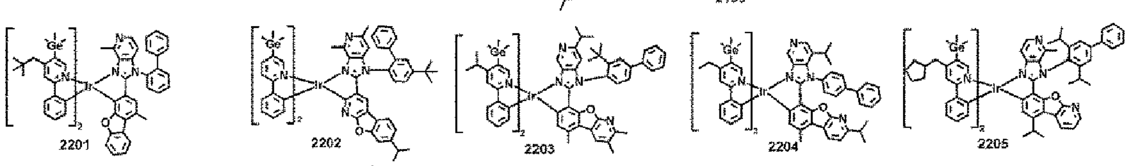

2201 2202 2203 2204 2205

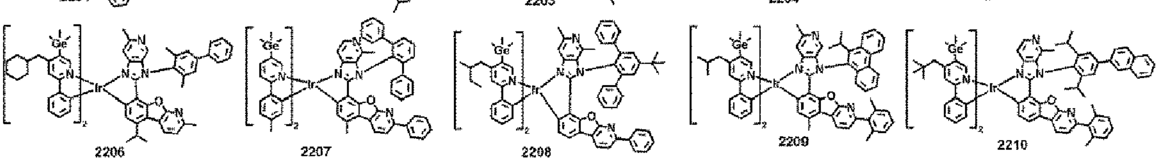

2206 2207 2208 2209 2210

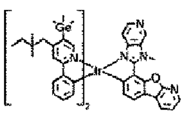
2211

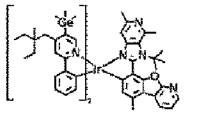
2212

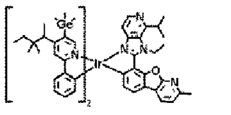
2213

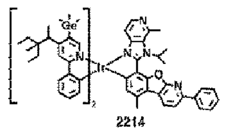
2214

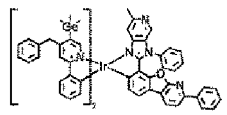
2215

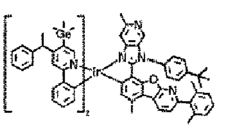
2216

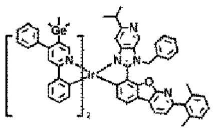
2217

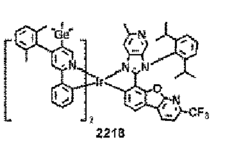
2218

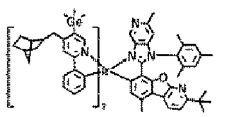
2219

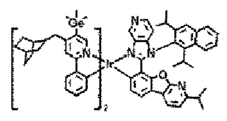
2220

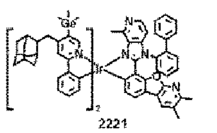
2221

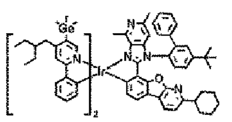
2222

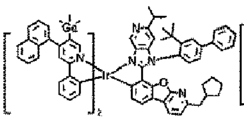
2223

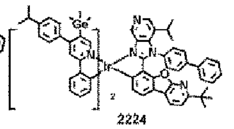
2224

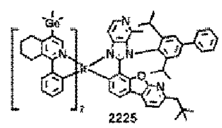
2225

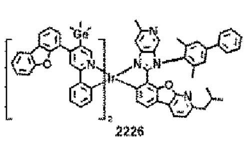
2226

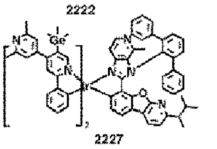
2227

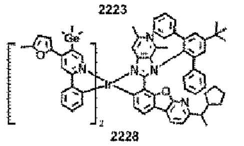
2228

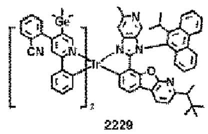
2229

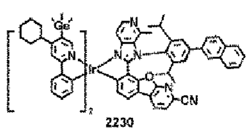
2230

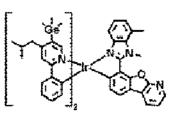
2231

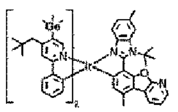
2232

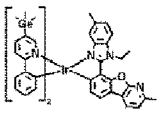
2233

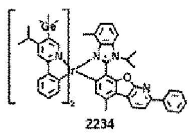
2234

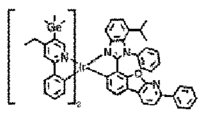
2235

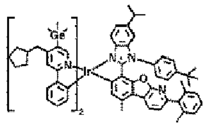
2236

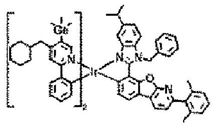
2237

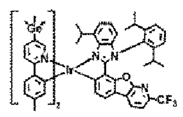
2238

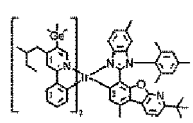
2239

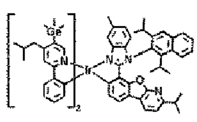
2240

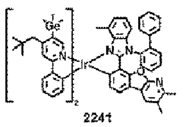
2241

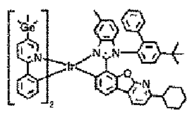
2242

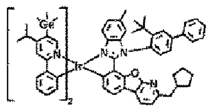
2243

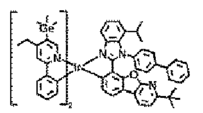
2244

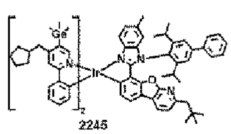
2245

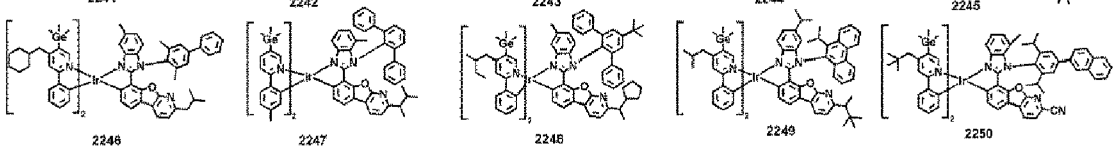
2246 2247 2248 2249 2250

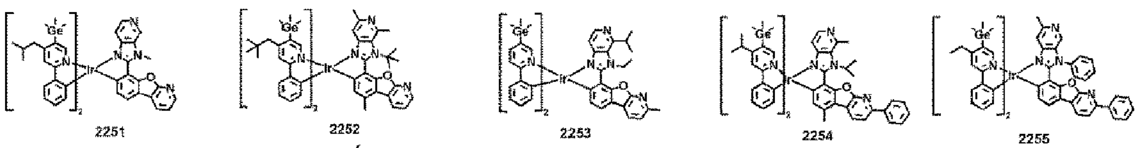
2251 2252 2253 2254 2255

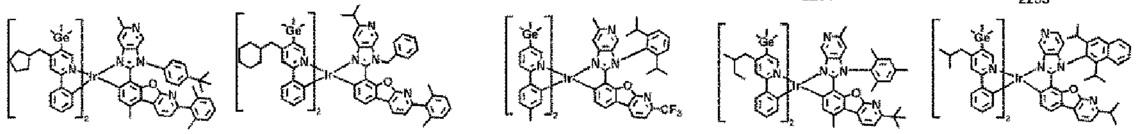
2256 2257 2258 2259 2260

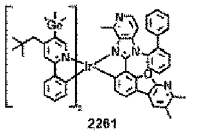
2261
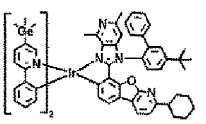
2262
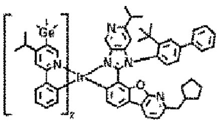
2263
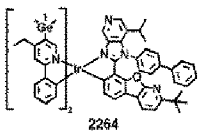
2264
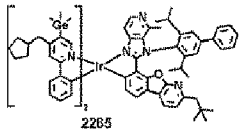
2265
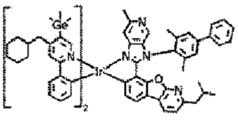
2266
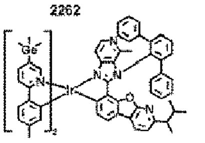
2267
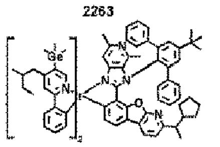
2268
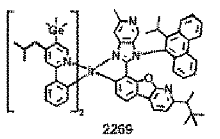
2269
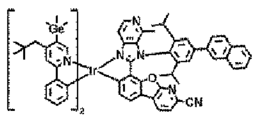
2270
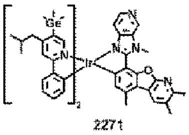
2271
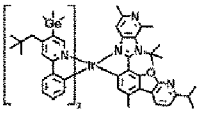
2272
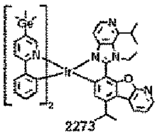
2273
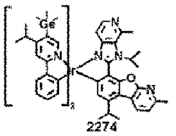
2274
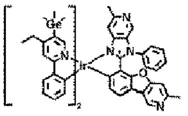
2275
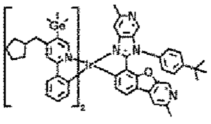
2276
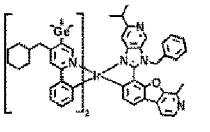
2277
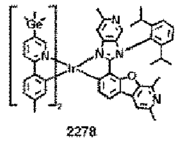
2278
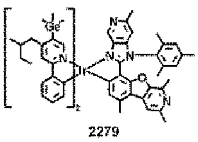
2279
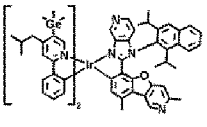
2280
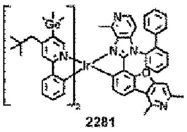
2281
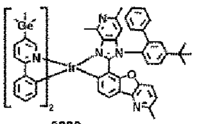
2282
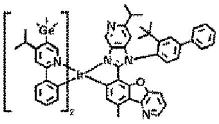
2283
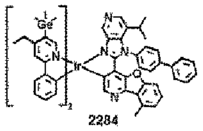
2284
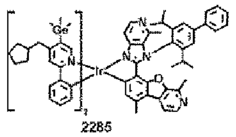
2285
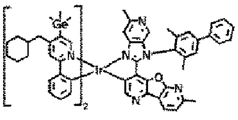
2286
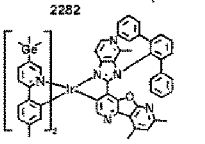
2287
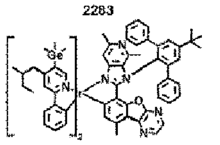
2288
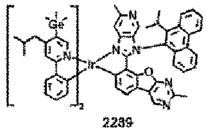
2289
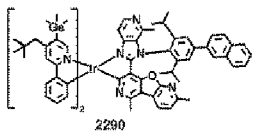
2290
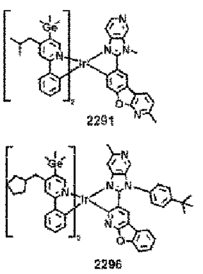
2291
2296
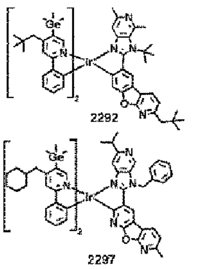
2292
2297
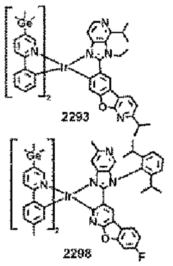
2293
2298
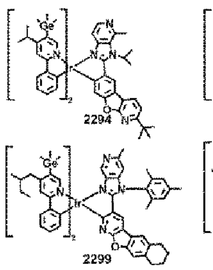
2294
2299
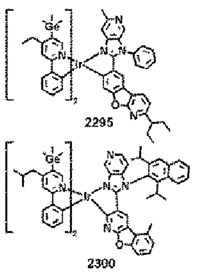
2295
2300
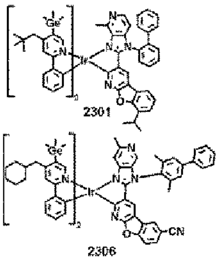
2301
2306
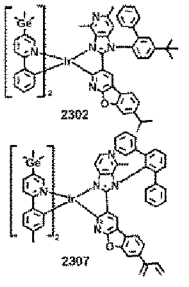
2302
2307
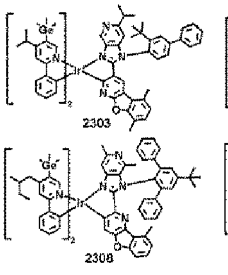
2303
2308
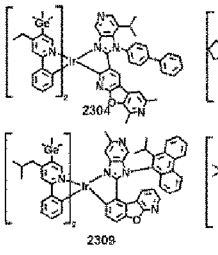
2304
2309
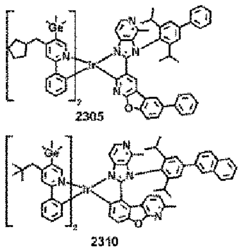
2305
2310

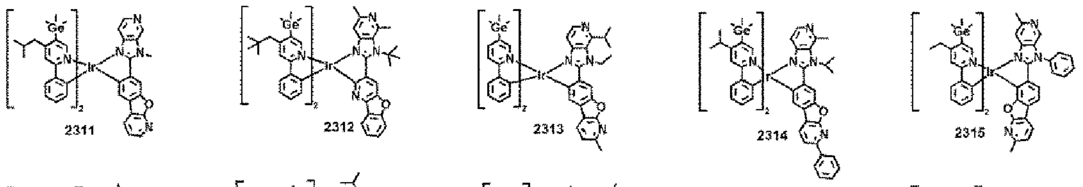

2311 2312 2313 2314 2315

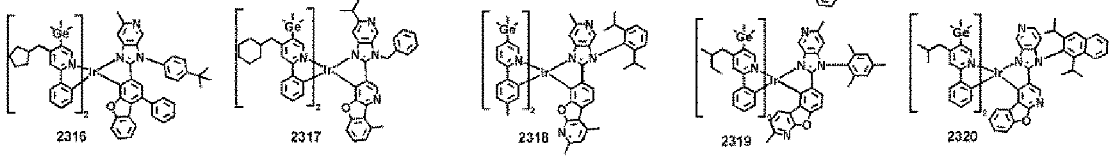

2316 2317 2318 2319 2320

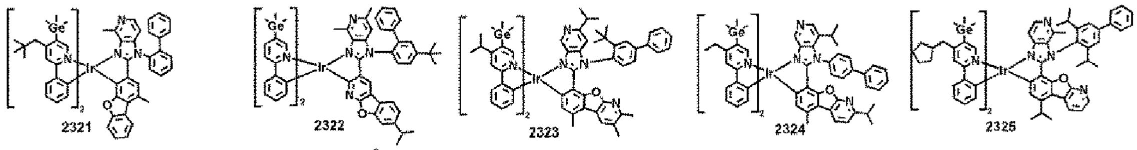

2321 2322 2323 2324 2325

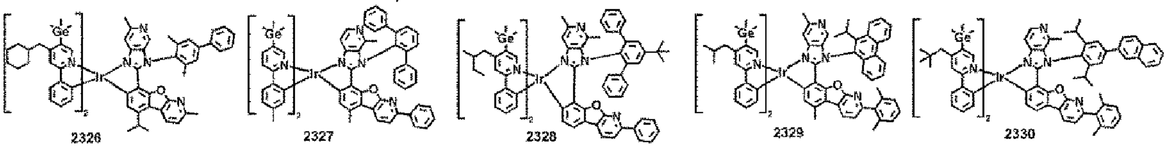

2326 2327 2328 2329 2330

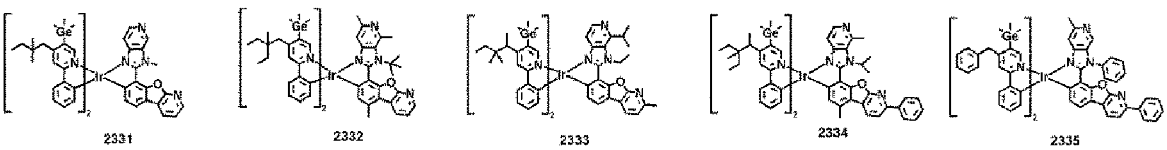

2331 2332 2333 2334 2335

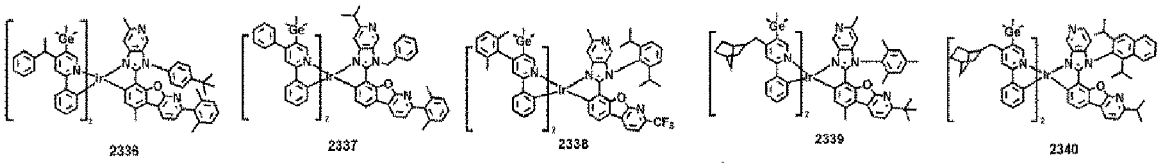

2336 2337 2338 2339 2340

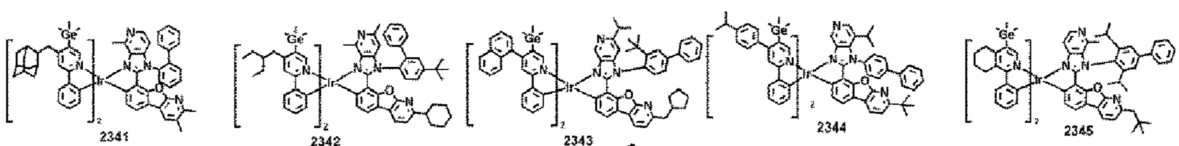

2341 2342 2343 2344 2345

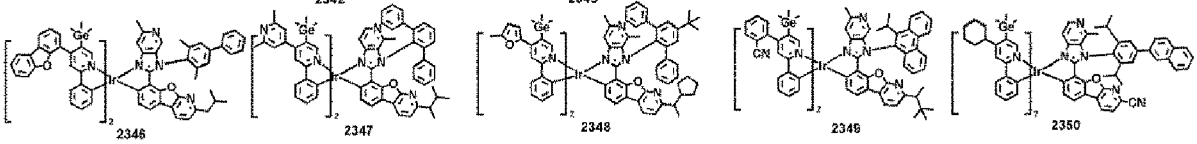

2346 2347 2348 2349 2350

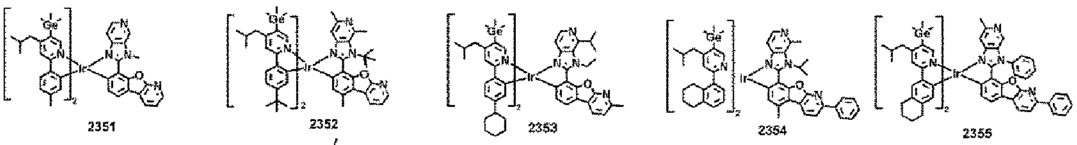

2351 2352 2353 2354 2355

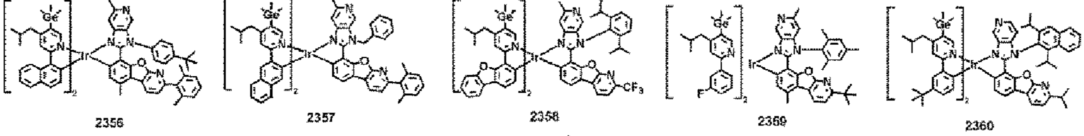

2356 2357 2358 2359 2360

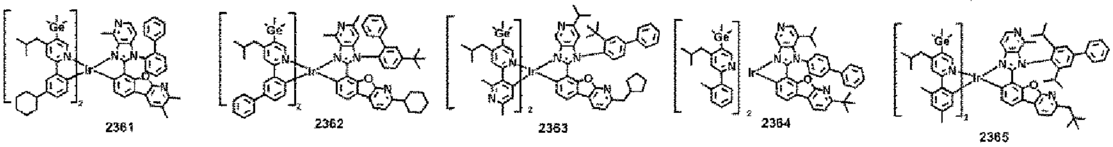

2361 2362 2363 2364 2365

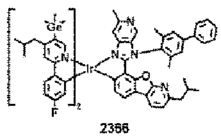
2366

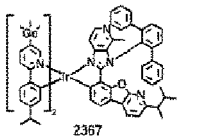
2367

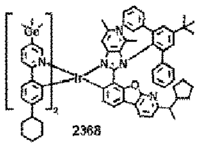
2368

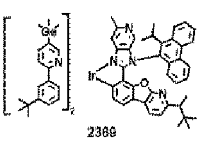
2369

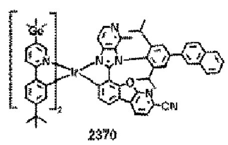
2370

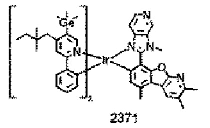
2371

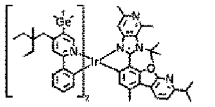
2372

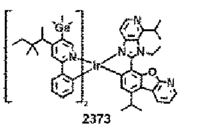
2373

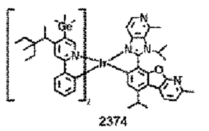
2374

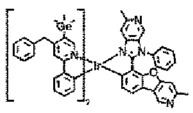
2375

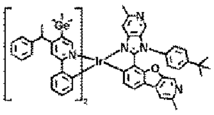
2376

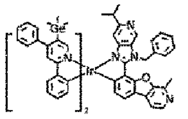
2377

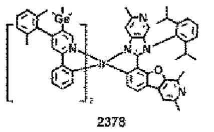
2378

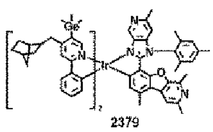
2379

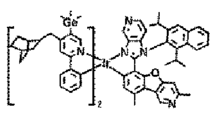
2380

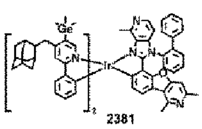
2381

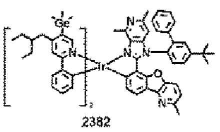
2382

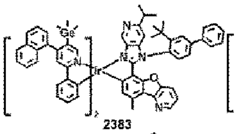
2383

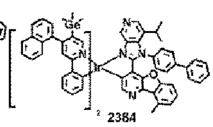
2384

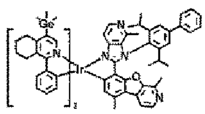
2385

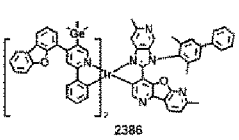
2386

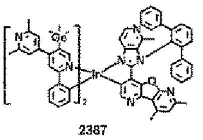
2387

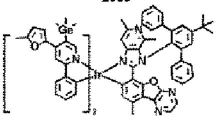
2388

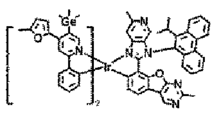
2389

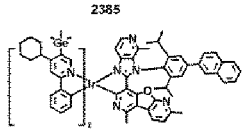
2390

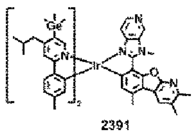
2391

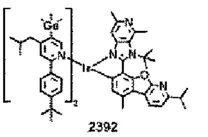
2392

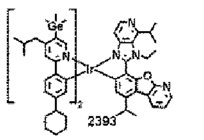
2393

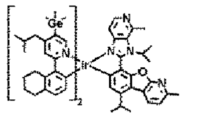
2394

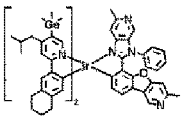
2395

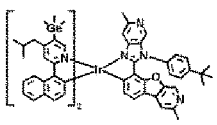
2396

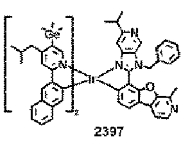
2397

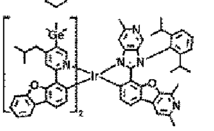
2398

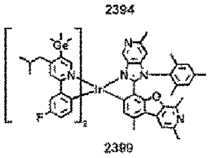
2399

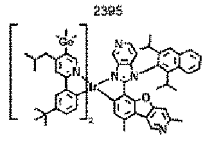
2400

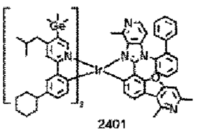
2401

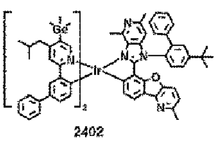
2402

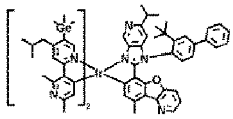
2403

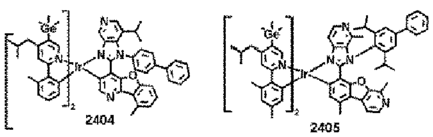
2404 2405

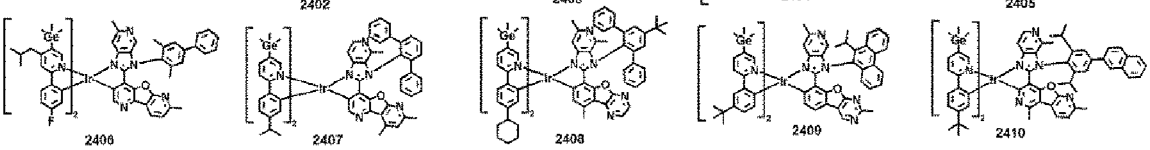
2406 2407 2408 2409 2410

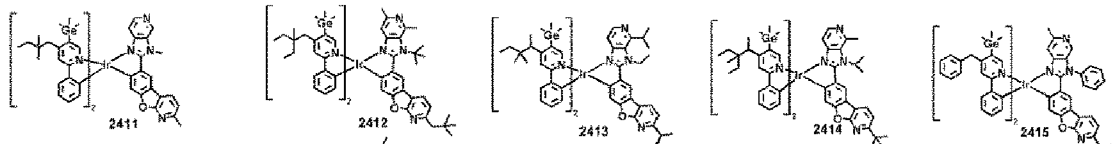

2411 2412 2413 2414 2415

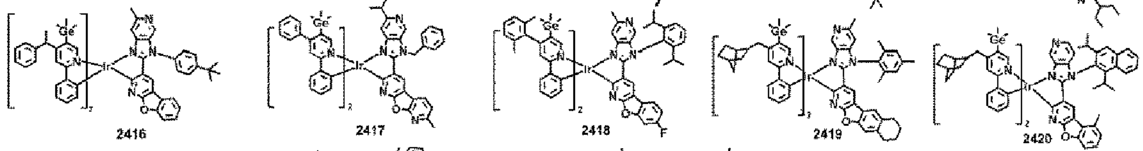

2416 2417 2418 2419 2420

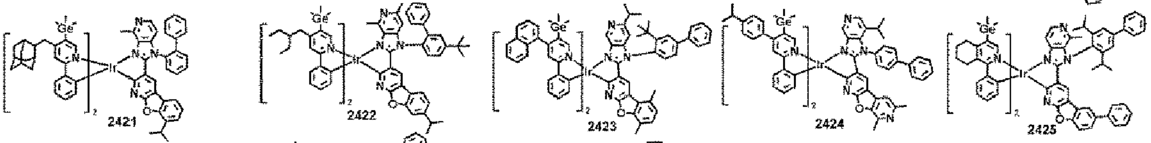

2421 2422 2423 2424 2425

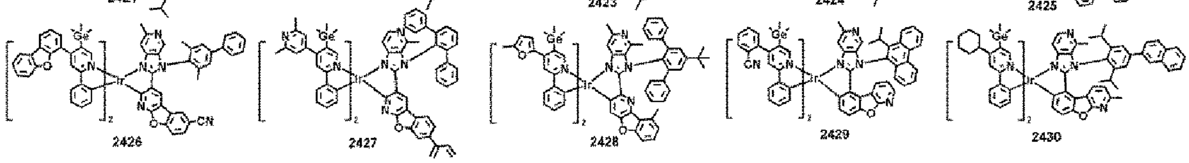

2426 2427 2428 2429 2430

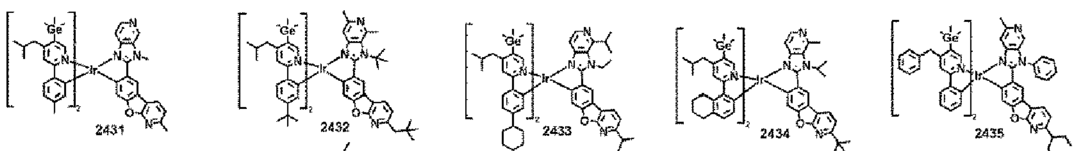

2431 2432 2433 2434 2435

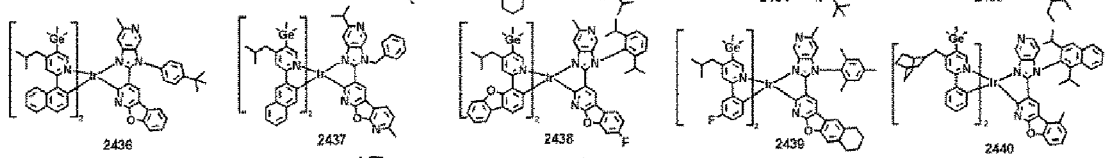

2436 2437 2438 2439 2440

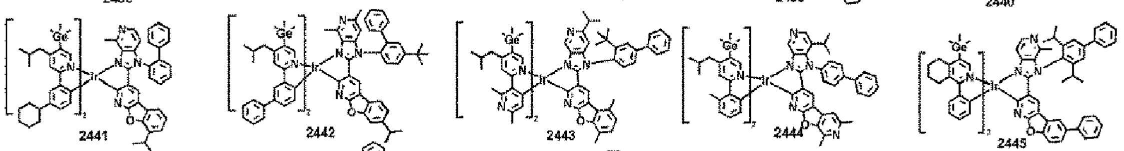

2441 2442 2443 2444 2445

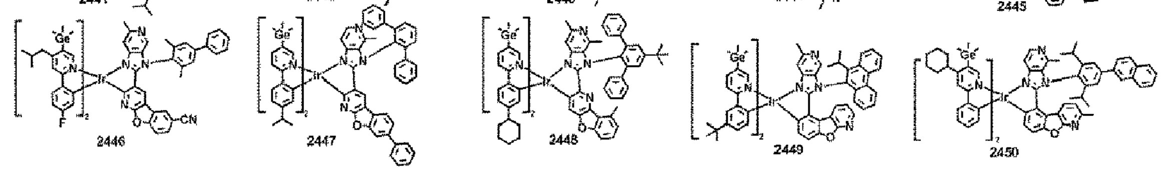

2446 2447 2448 2449 2450

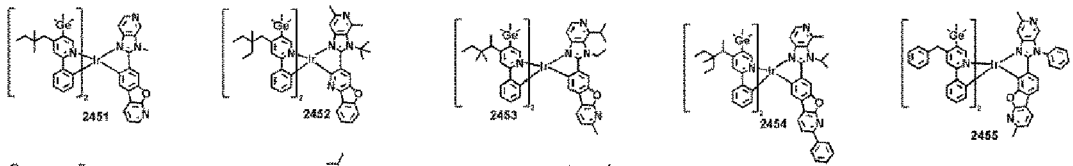

2451 2452 2453 2454 2455

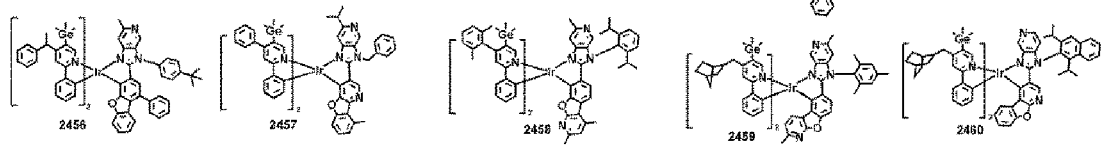

2456 2457 2458 2459 2460

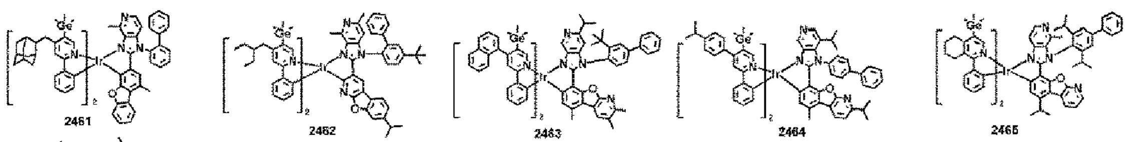

2461 2462 2463 2464 2465

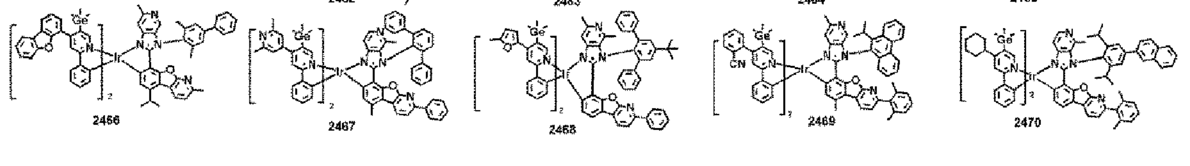

2466 2467 2468 2469 2470

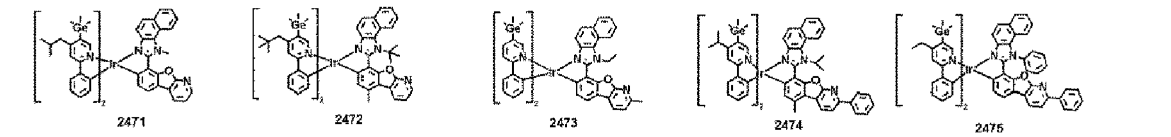
2471 2472 2473 2474 2475

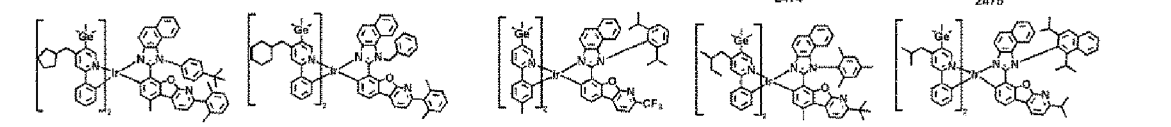
2476 2477 2478 2479 2480

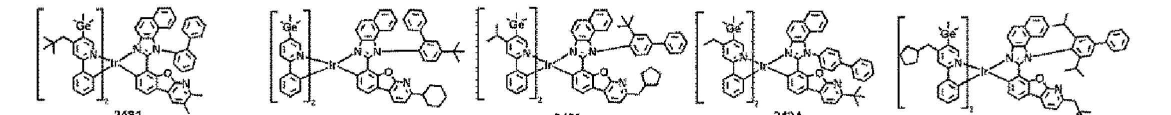
2481 2482 2483 2484 2485

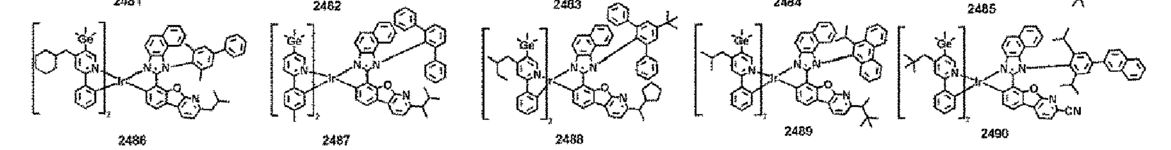
2486 2487 2488 2489 2490

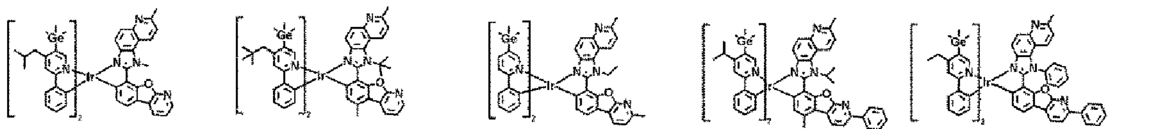
2491 2492 2493 2494 2495

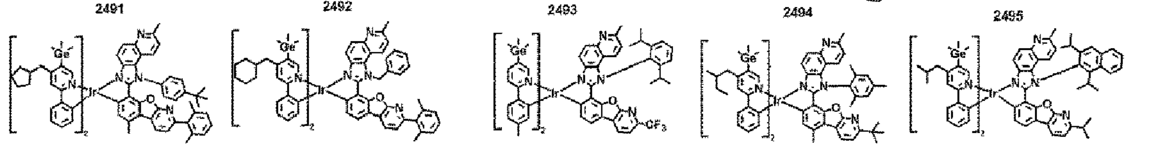
2496 2497 2498 2499 2500

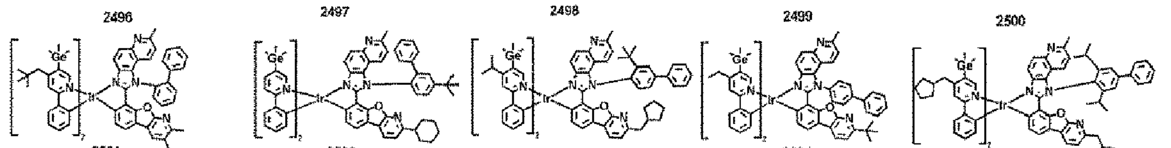
2501 2502 2503 2504 2505

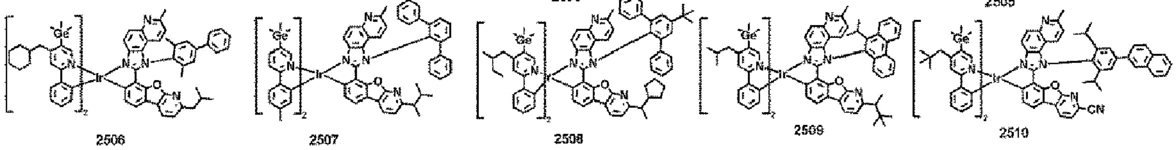
2506 2507 2508 2509 2510

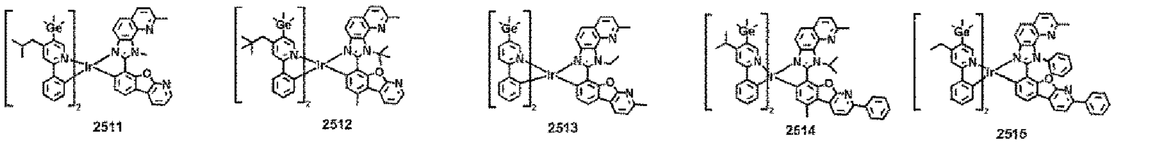
2511 2512 2513 2514 2515

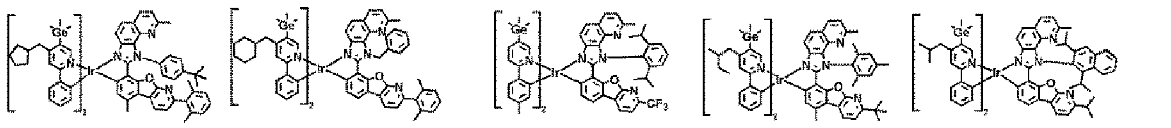
2516 2517 2518 2519 2520

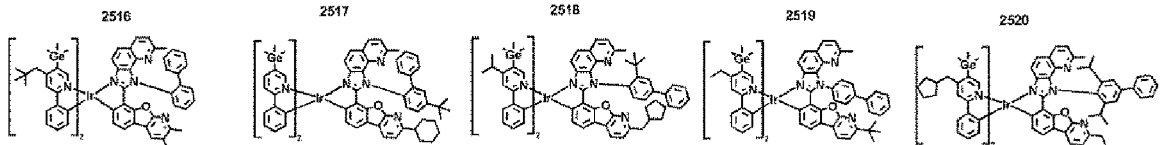
2521 2522 2523 2524 2525

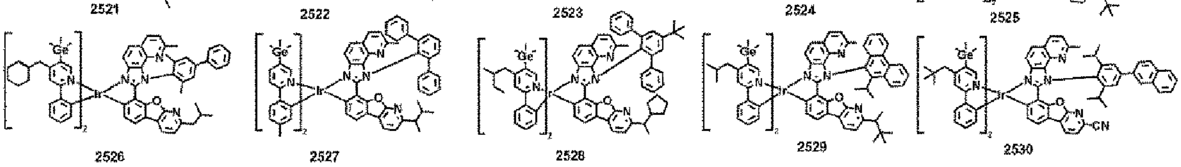
2526 2527 2528 2529 2530

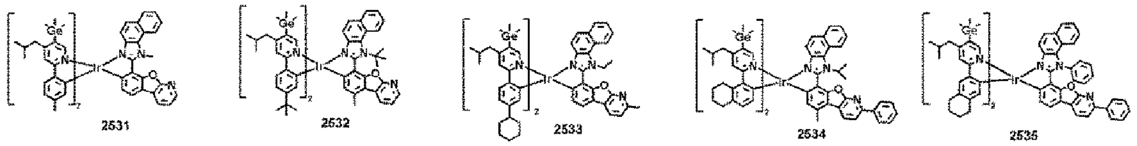

2531 2532 2533 2534 2535

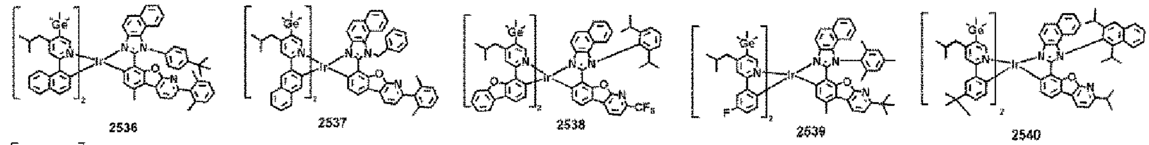

2536 2537 2538 2539 2540

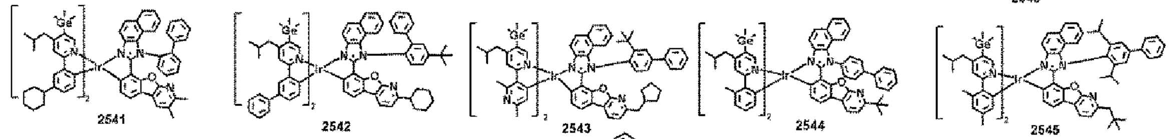

2541 2542 2543 2544 2545

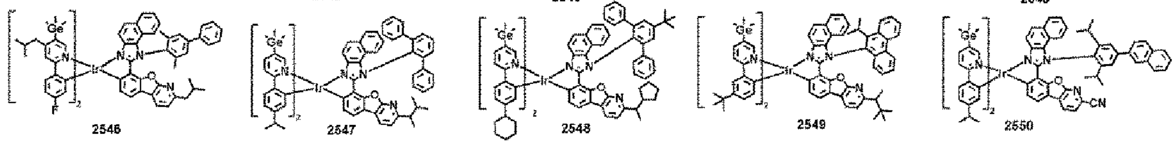

2546 2547 2548 2549 2550

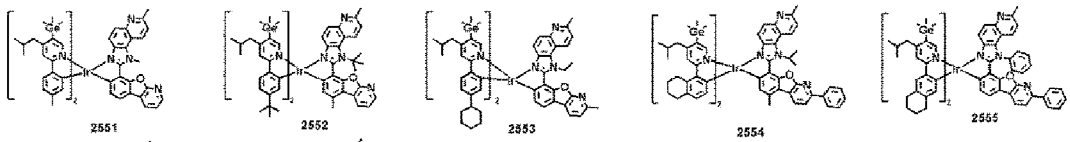

2551 2552 2553 2554 2555

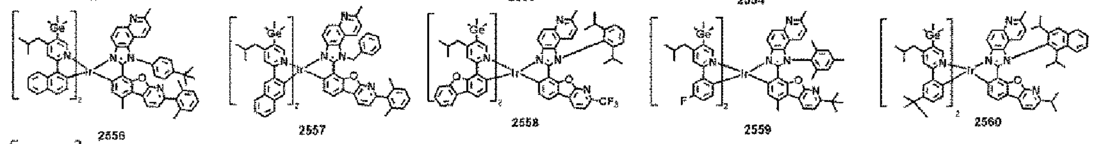

2556 2557 2558 2559 2560

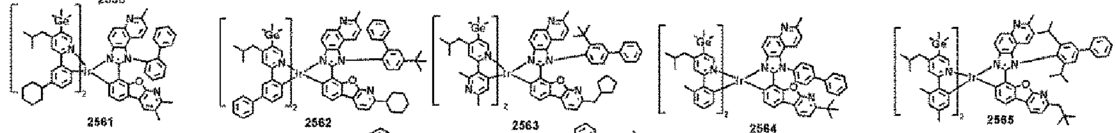

2561 2562 2563 2564 2565

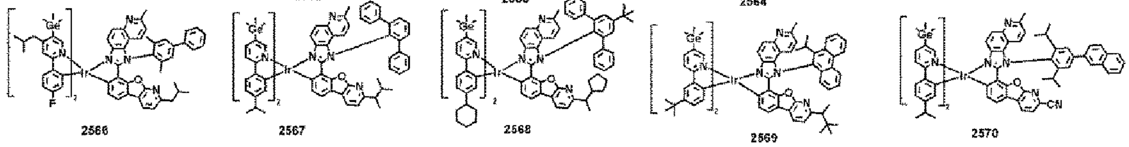

2566 2567 2568 2569 2570

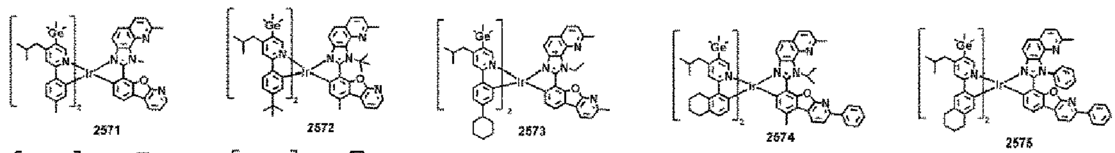

2571 2572 2573 2574 2575

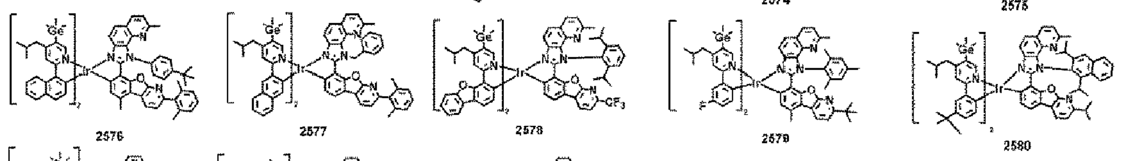

2576 2577 2578 2579 2580

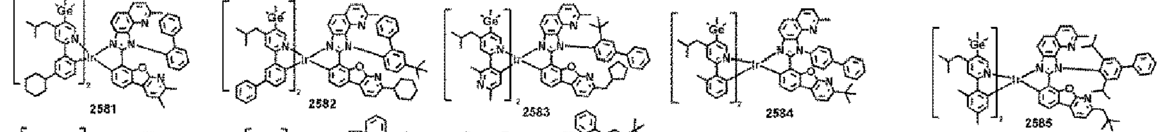

2581 2582 2583 2584 2585

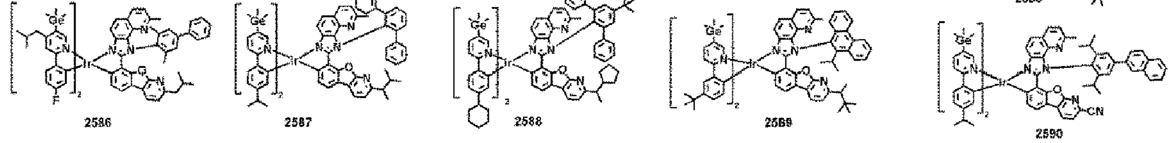

2586 2587 2588 2589 2590

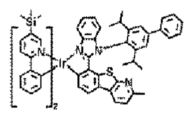
2591

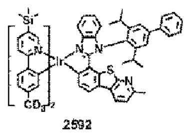
2592

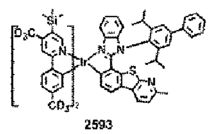
2593

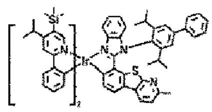
2594

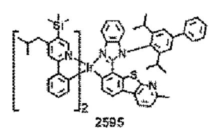
2595

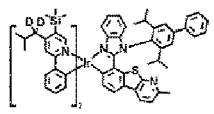
2596

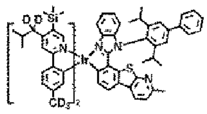
2597

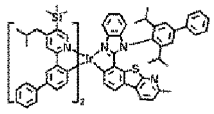
2598

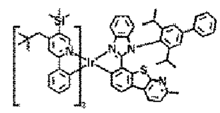
2599

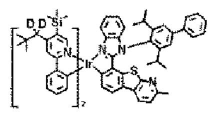
2600

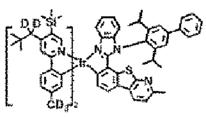
2601

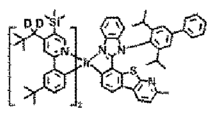
2602

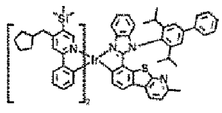
2603

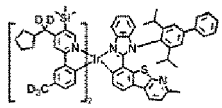
2604

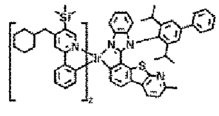
2605

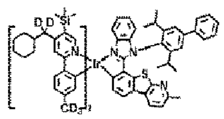
2606

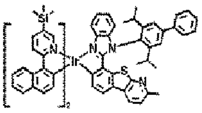
2607

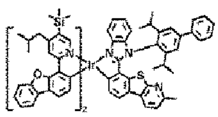
2608

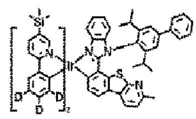
2609

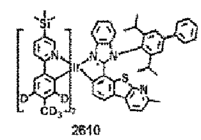
2610

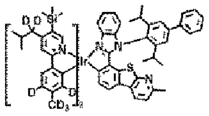
2611

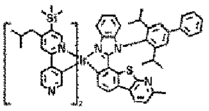
2612

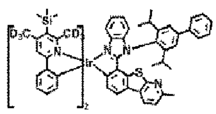
2613

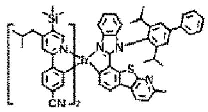
2614

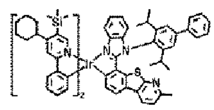
2615

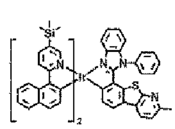
2616

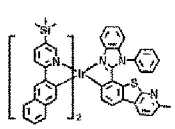
2617

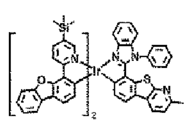
2618

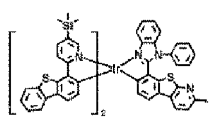
2619

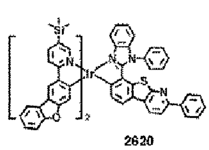
2620

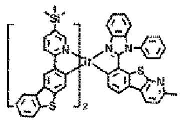
2621

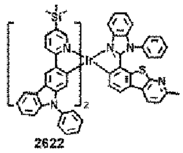
2622

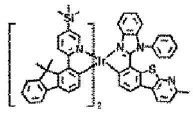
2623

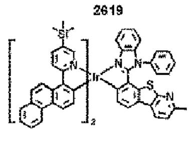
2624

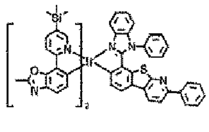
2625

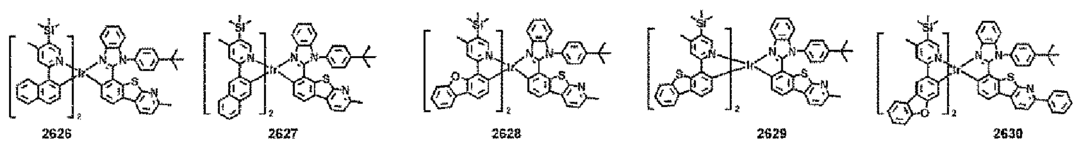
2626 2627 2628 2629 2630

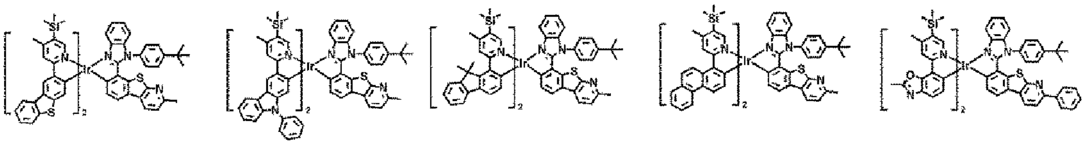
2631 2632 2633 2634 2635

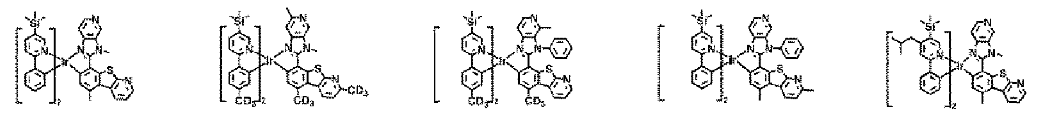

2636 2637 2638 2639 2640

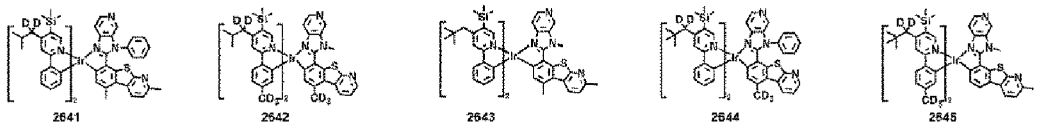

2641 2642 2643 2644 2645

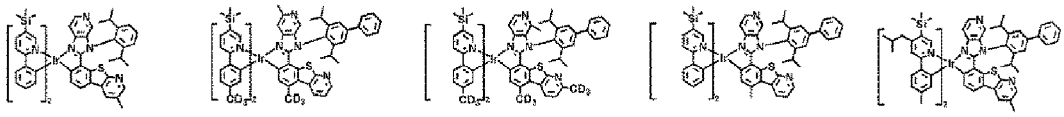

2646 2647 2648 2649 2650

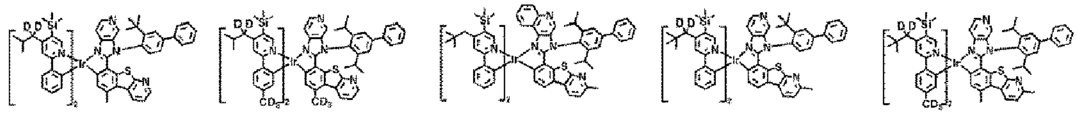

2651 2652 2653 2651 2655

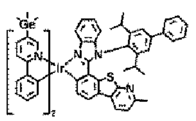

2656

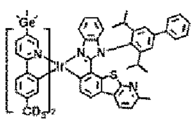

2657

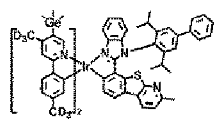

2658

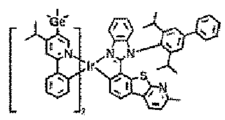

2659

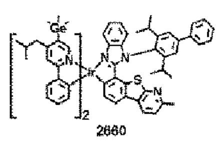

2660

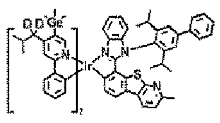

2661

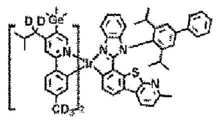

2662

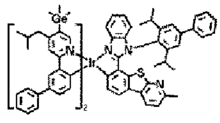

2663

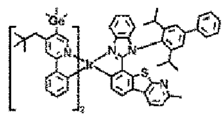

2664

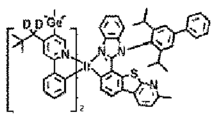

2665

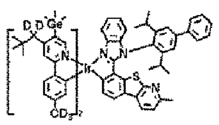

2666

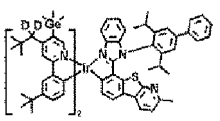

2667

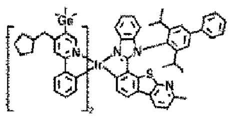

2668

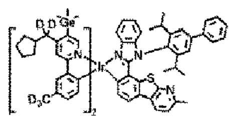

2669

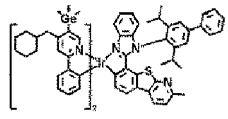

2670

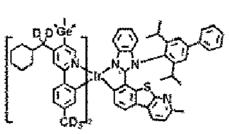

2671

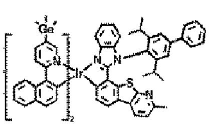

2672

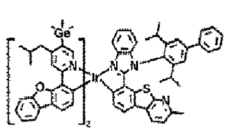

2673

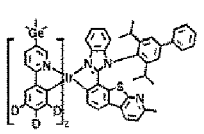

2674

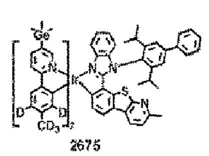

2675

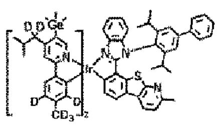

2676

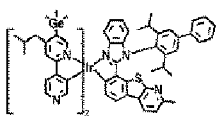

2677

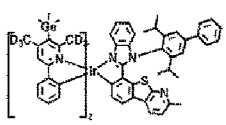

2678

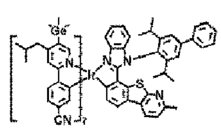

2679

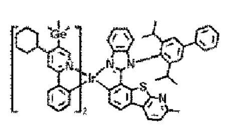

2680

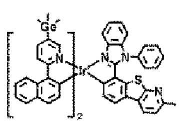
2681
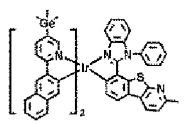
2682
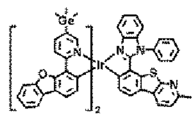
2683
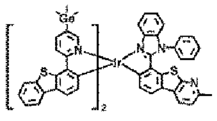
2684
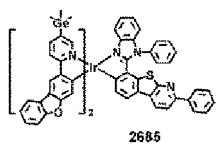
2685
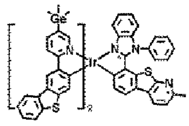
2686
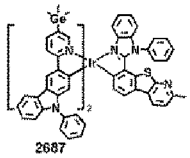
2687
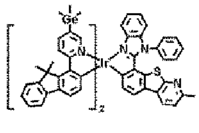
2688
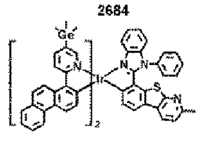
2689
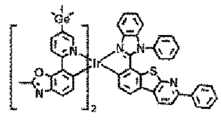
2690
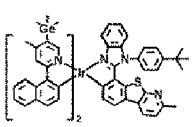
2691
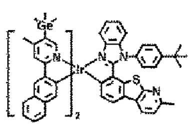
2692
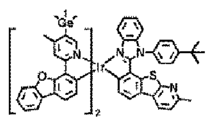
2693
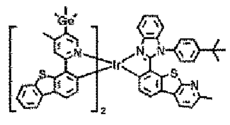
2694
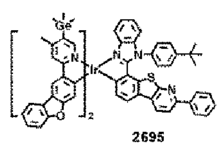
2695
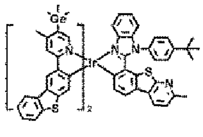
2696
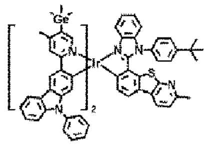
2697
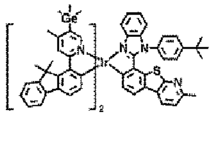
2698
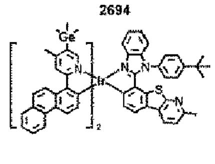
2699
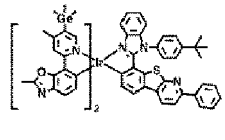
2700
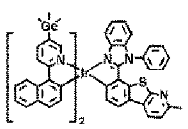
2701
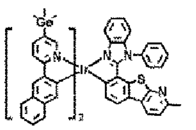
2702
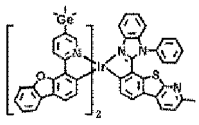
2703
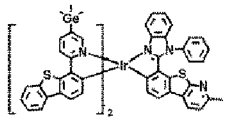
2704
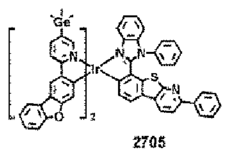
2705
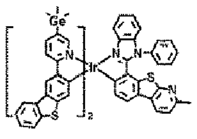
2706
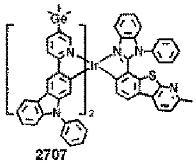
2707
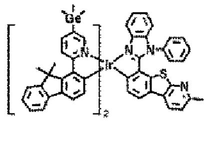
2708
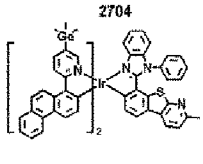
2709
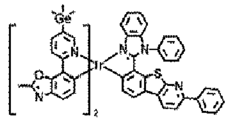
2710
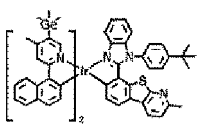
2711
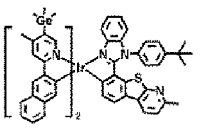
2712
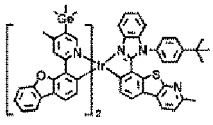
2713
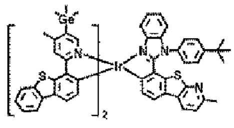
2714
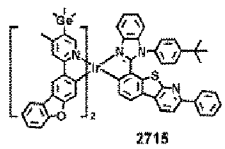
2715
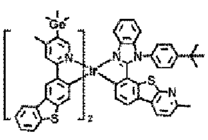
2716
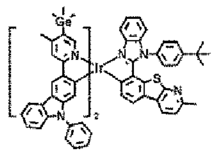
2717
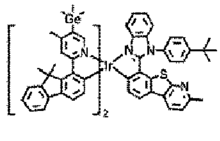
2718
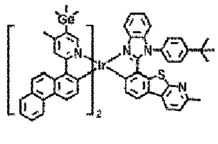
2719
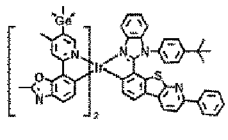
2720

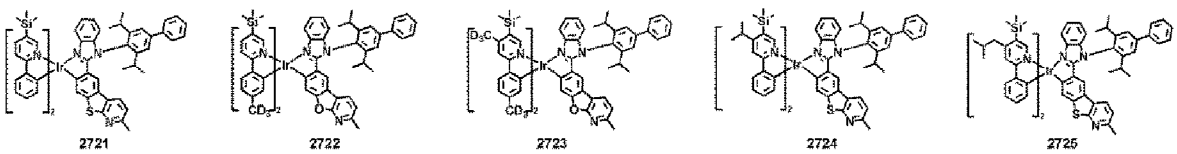
2721 2722 2723 2724 2725

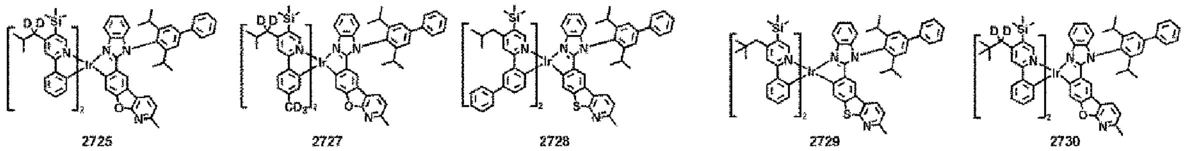
2725 2727 2728 2729 2730

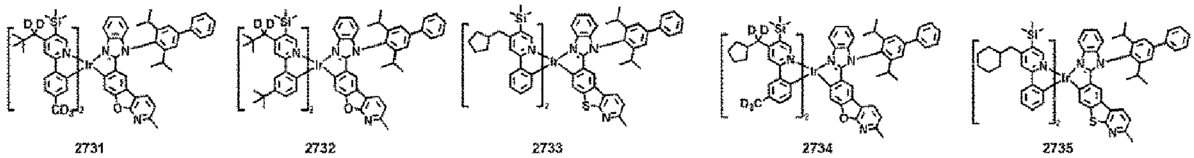
2731 2732 2733 2734 2735

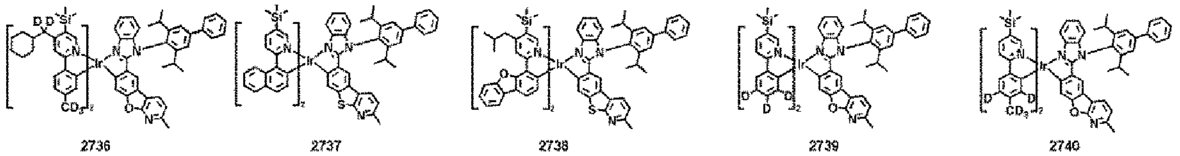
2736 2737 2738 2739 2740

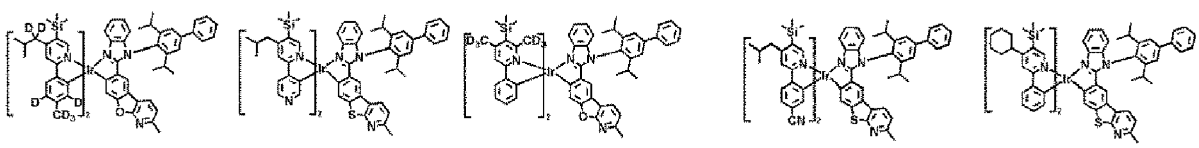
2741 2742 2743 2744 2745

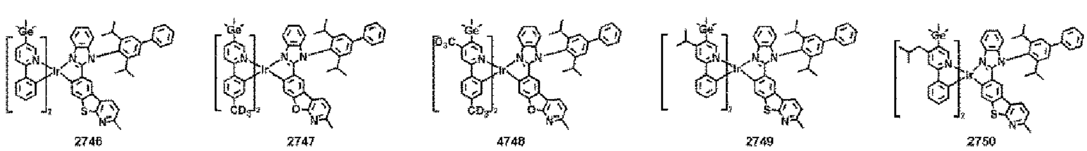
2746 2747 4748 2749 2750

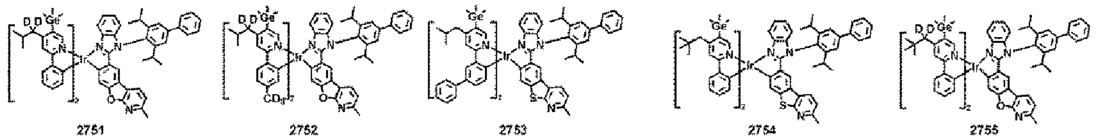
2751 2752 2753 2754 2755

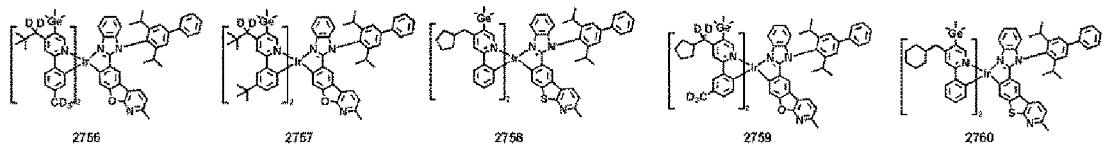
2756 2757 2758 2759 2760

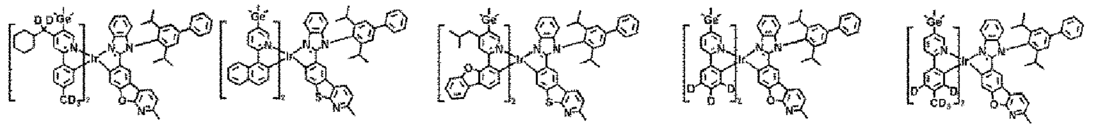
2761 2762 2763 2764 2765

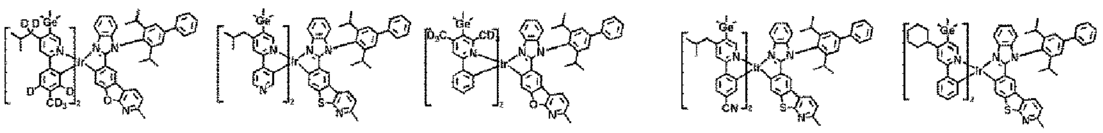
2766 2767 2768 2769 2770

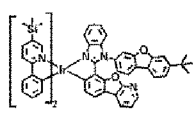
2771
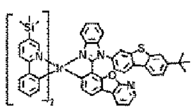
2772
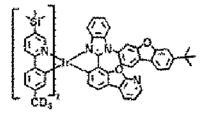
2773
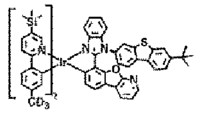
2774
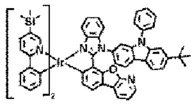
2775
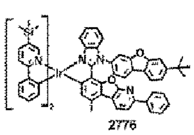
2776
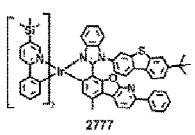
2777
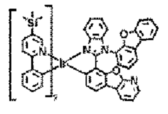
2778
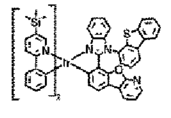
2779
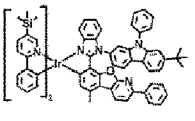
2780
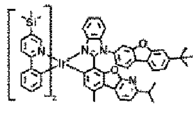
2781
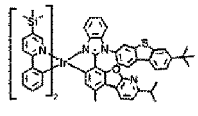
2782
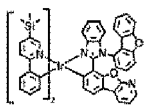
2783
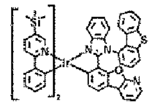
2784
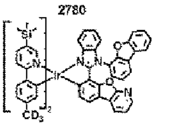
2785
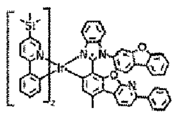
2786
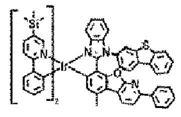
2787
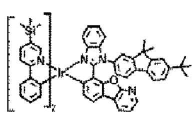
2788
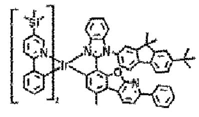
2789
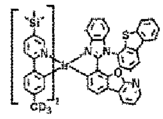
2790
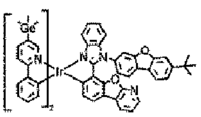
2791
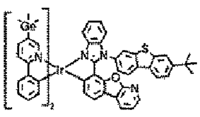
2792
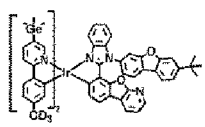
2793
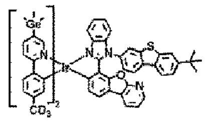
2794
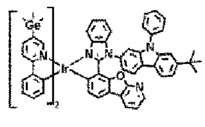
2795
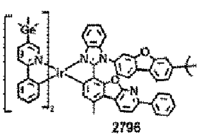
2796
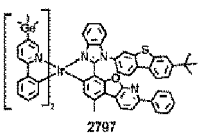
2797
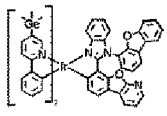
2798
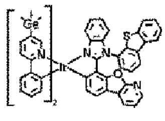
2799
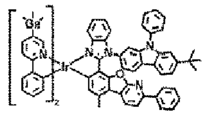
2800
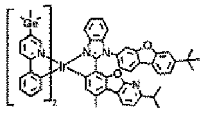
2801
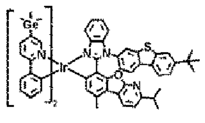
2802
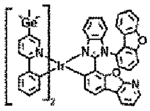
2803
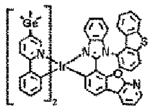
2804
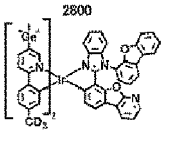
2805
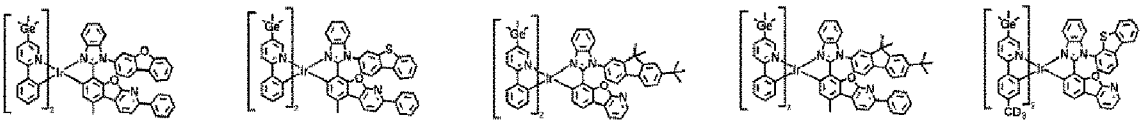
2806 2807 2808 2809 2810
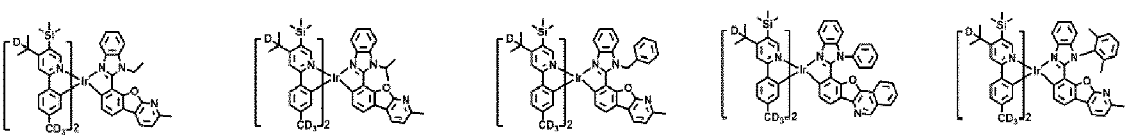
2811 2812 2813 2814 2815
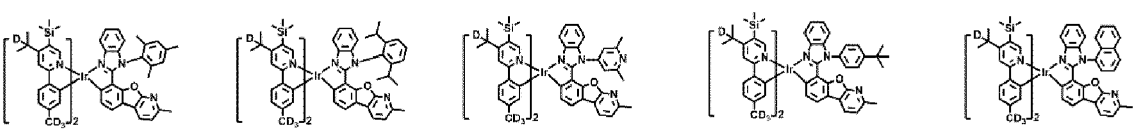
2816 2817 2818 2819 2820

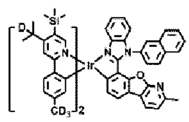
2821
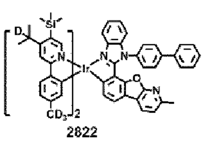
2822
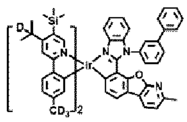
2823
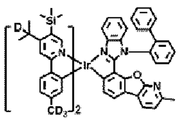
2824
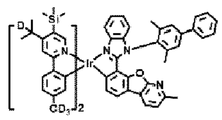
2825
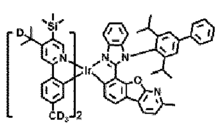
2826
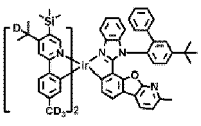
2827
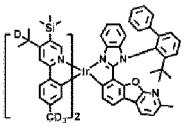
2828
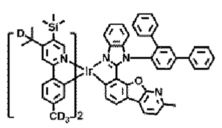
2829
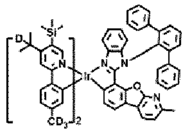
2830
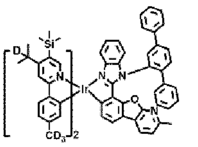
2831
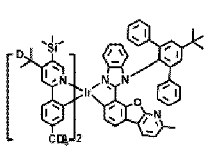
2832
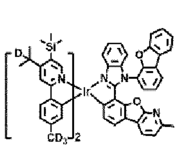
2833
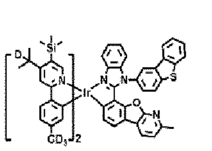
2834
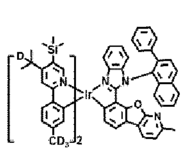
2835
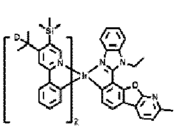
2836
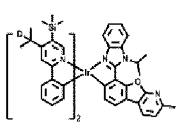
2837
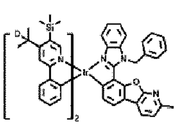
2838
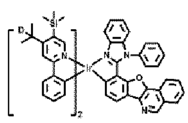
2839
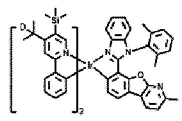
2840
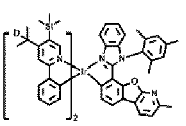
2841
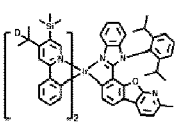
2842
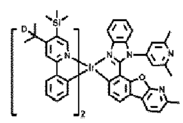
2843
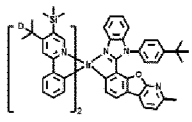
2844
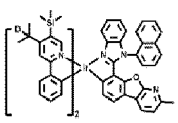
2845
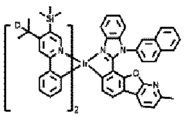
2846
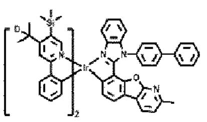
2847
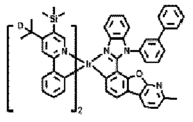
2848
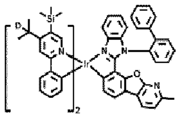
2849
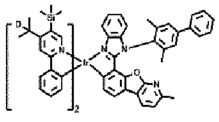
2850
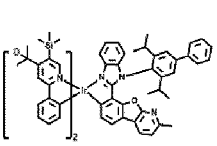
2851
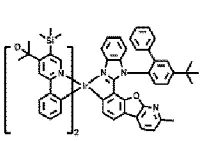
2852
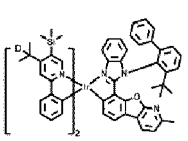
2853
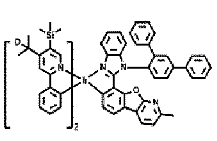
2854
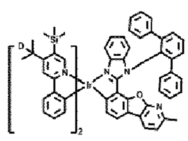
2855
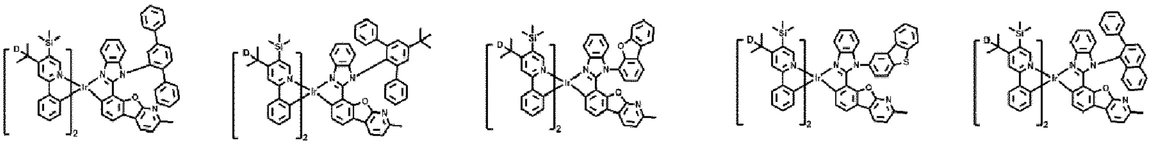
2856 2857 2858 2859 2860
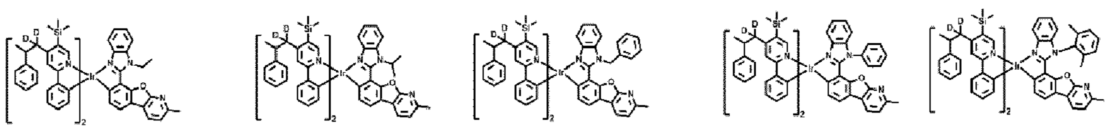
2861 2862 2863 2864 2865

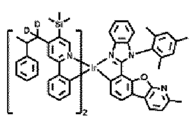
2866
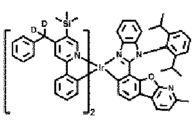
2867
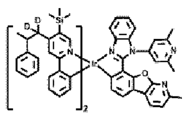
2868
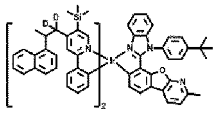
2869
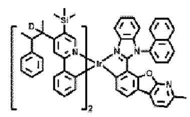
2870
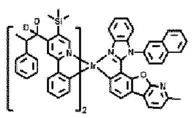
2871
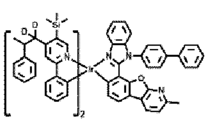
2872
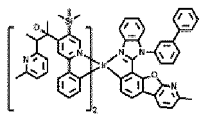
2873
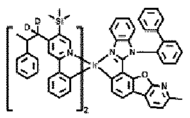
2874
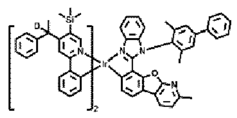
2875
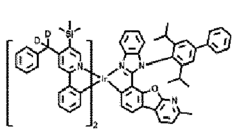
2876
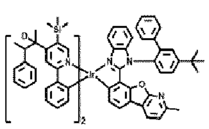
2877
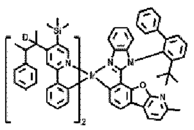
2878
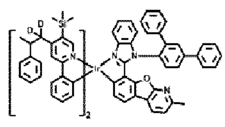
2879
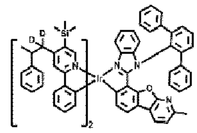
2880
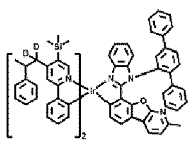
2881
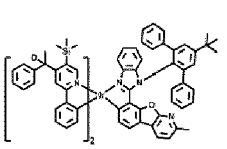
2882
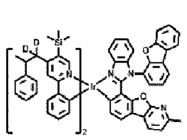
2883
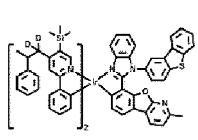
2884
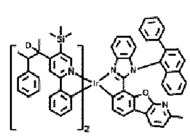
2885
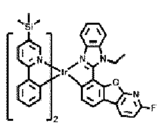
2886
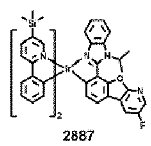
2887
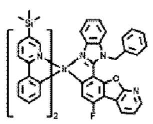
2888
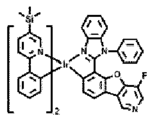
2889
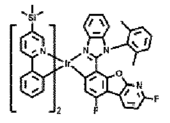
2890
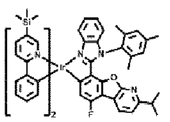
2891
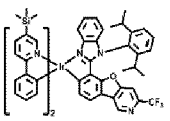
2892
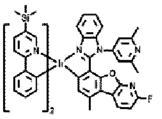
2893
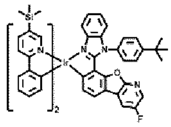
2894
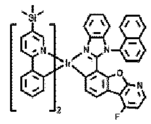
2895
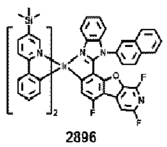
2896
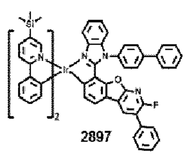
2897
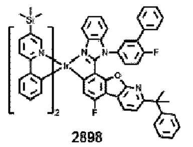
2898
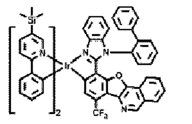
2899
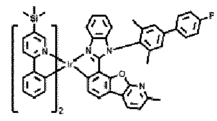
2900
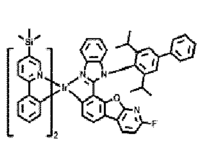
2901
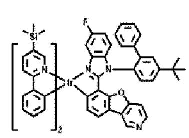
2902
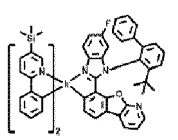
2903
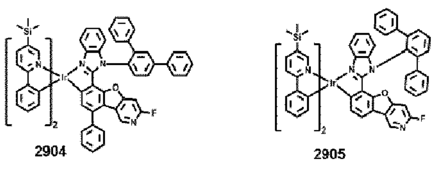
2904

2905

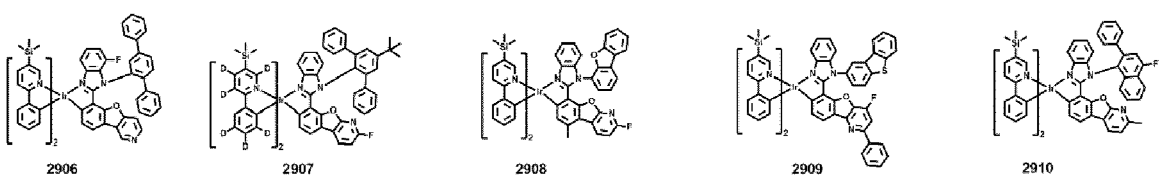
2906

2907

2908

2909

2910

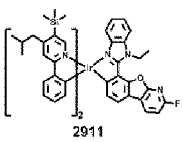
2911
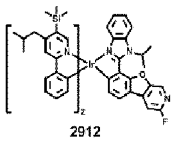
2912
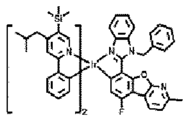
2913
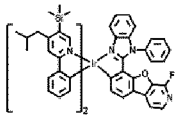
2914
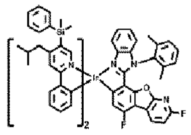
2915

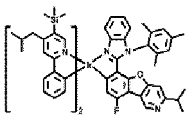
2916
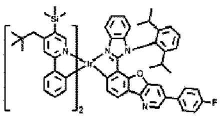
2917
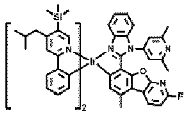
2918
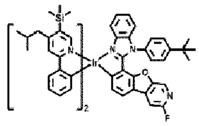
2919
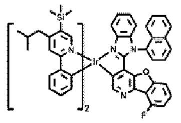
2920

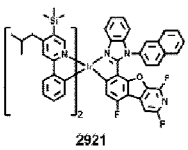
2921
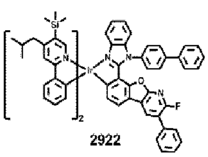
2922
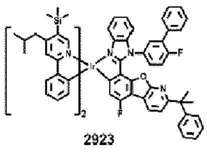
2923
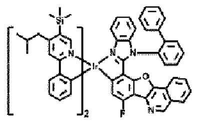
2924
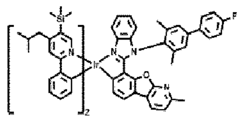
2925

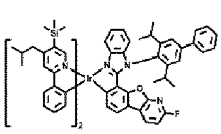
2926
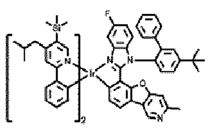
2927
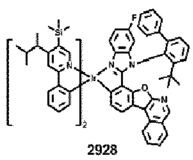
2928
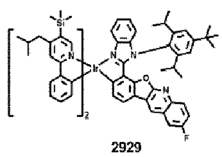
2929
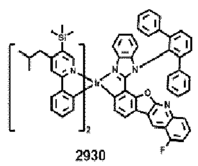
2930

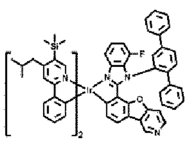
2931
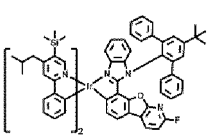
2932
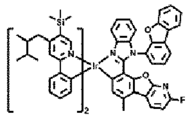
2933
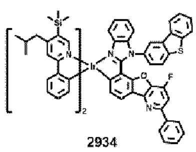
2934
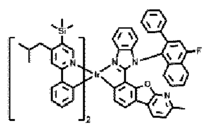
2935

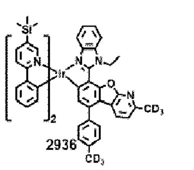
2936
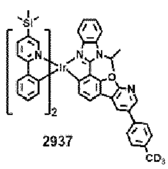
2937
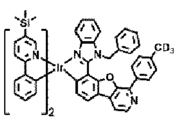
2938
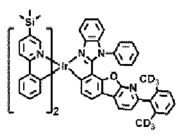
2939
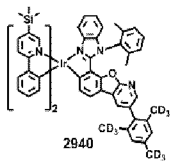
2940

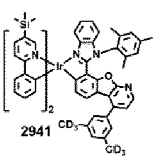
2941
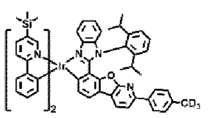
2942
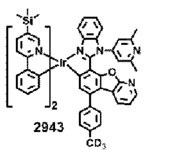
2943
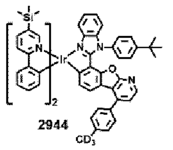
2944
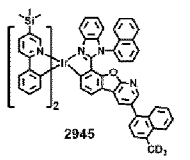
2945

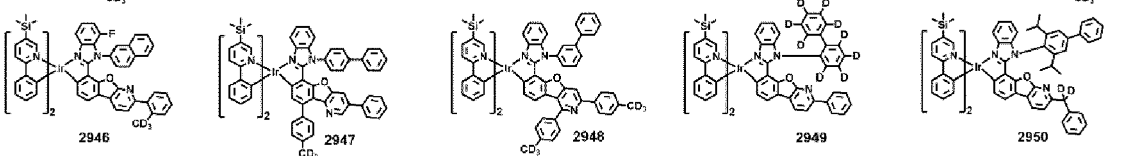
2946
2947
2948
2949
2950

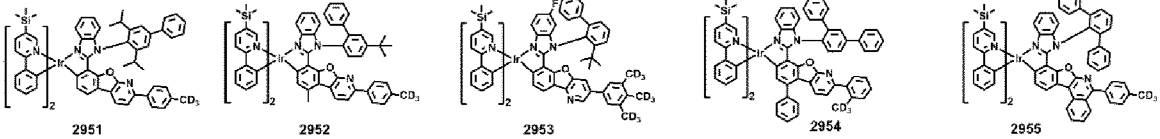
2951
2952
2953
2954
2955

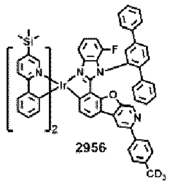
2956
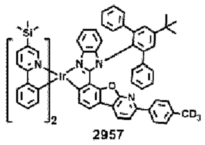
2957
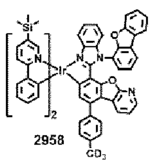
2958
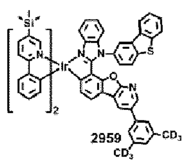
2959
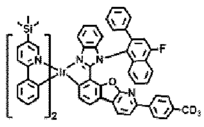
2960

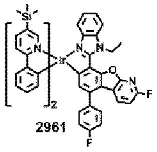
2961
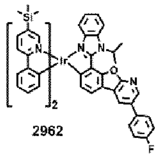
2962
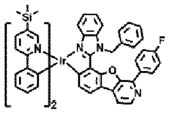
2963
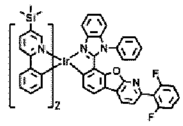
2964
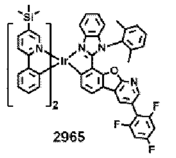
2965

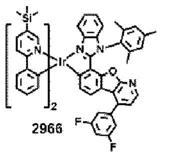
2966
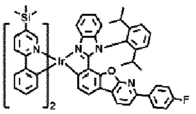
2967
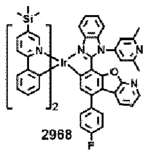
2968
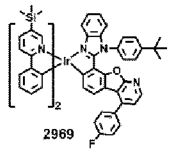
2969
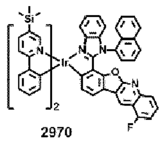
2970

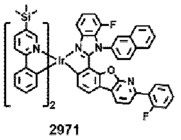
2971
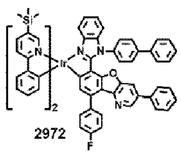
2972
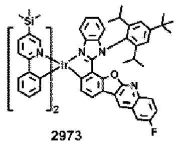
2973
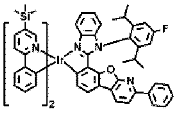
2974
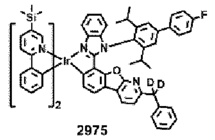
2975

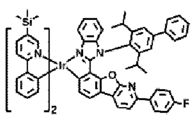
2976
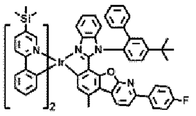
2977
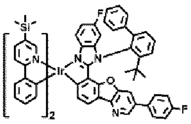
2978
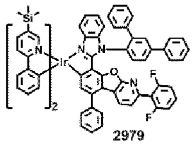
2979
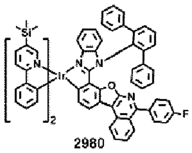
2980

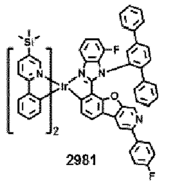
2981
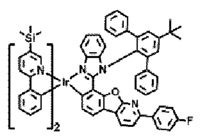
2982
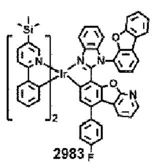
2983
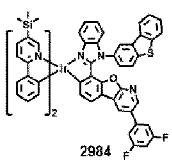
2984
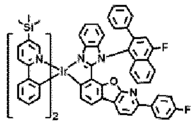
2985

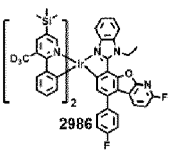
2986
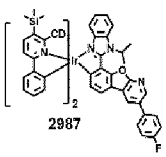
2987
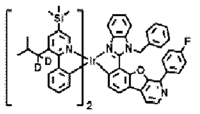
2988
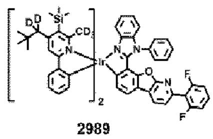
2989
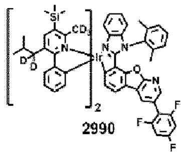
2990

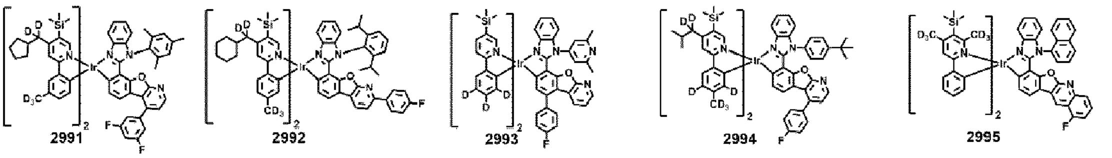
2991
2992
2993
2994
2995

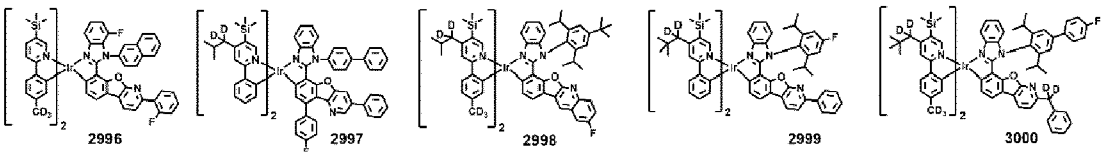
2996
2997
2998
2999
3000

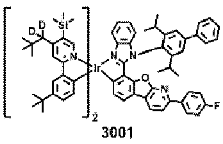
3001

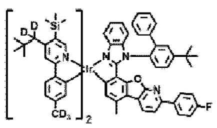
3002

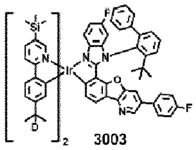
3003

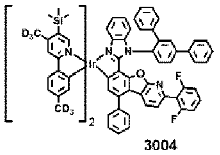
3004

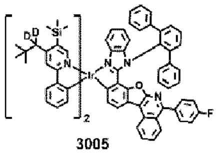
3005

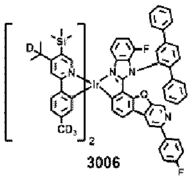
3006

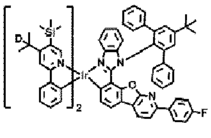
3007

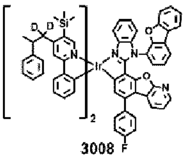
3008

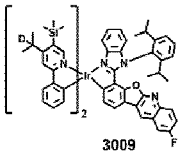
3009

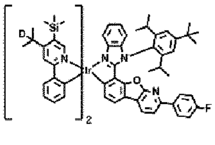
3010

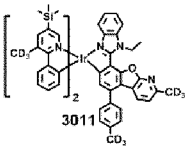
3011

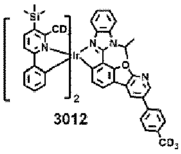
3012

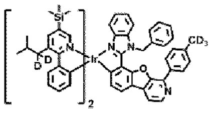
3013

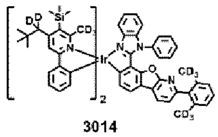
3014

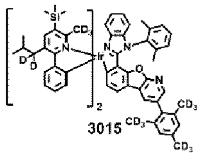
3015

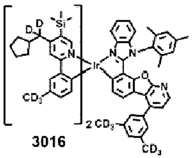
3016

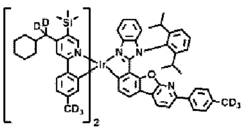
3017

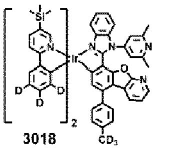
3018

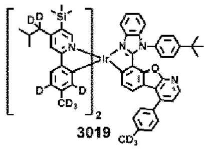
3019

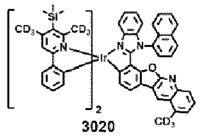
3020

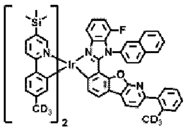
3021

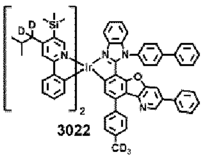
3022

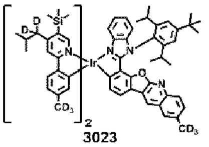
3023

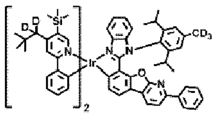
3024

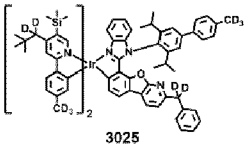
3025

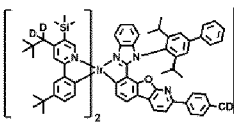
3026

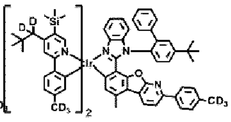
3027

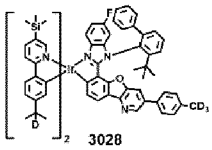
3028

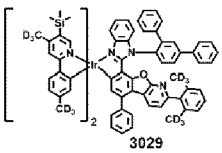
3029

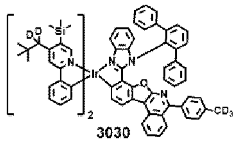
3030

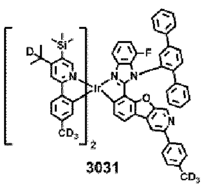
3031

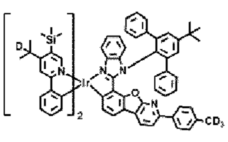
3032

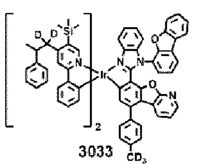
3033

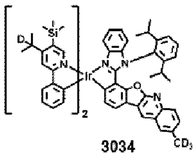
3034

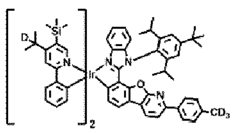
3035

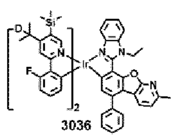
3036
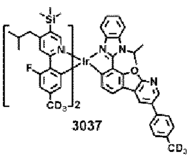
3037
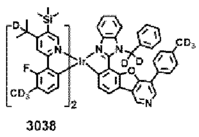
3038
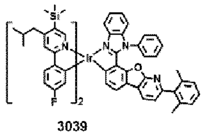
3039
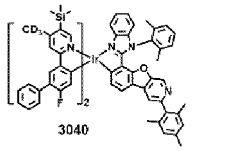
3040
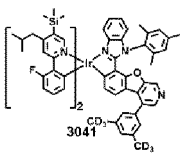
3041
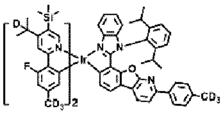
3042
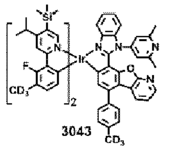
3043
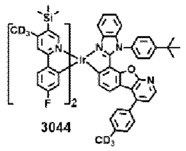
3044
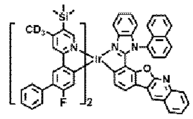
3045
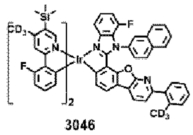
3046
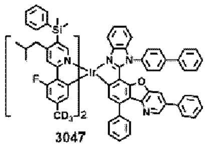
3047
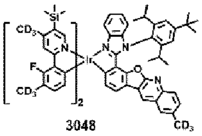
3048
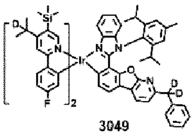
3049
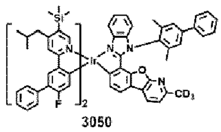
3050
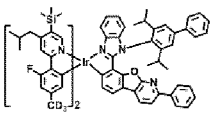
3051
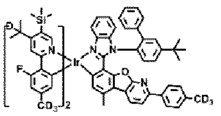
3052
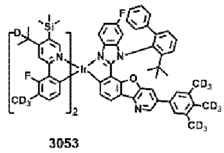
3053
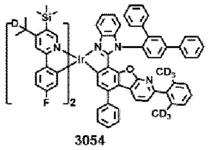
3054
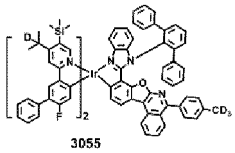
3055
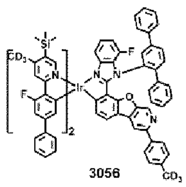
3056
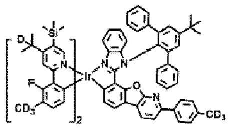
3057
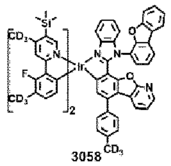
3058
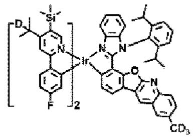
3059
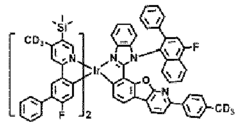
3060
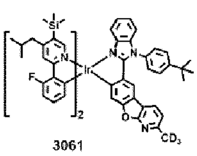
3061
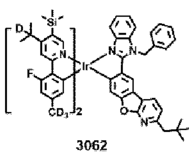
3062
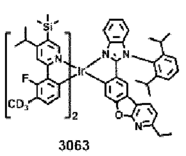
3063
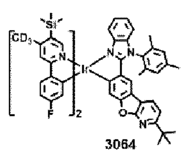
3064
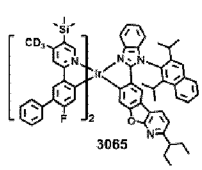
3065
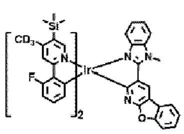
3066
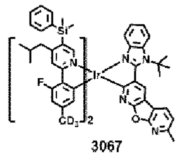
3067
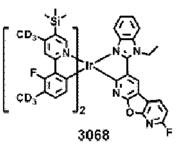
3068
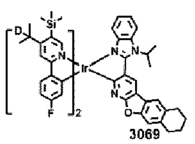
3069
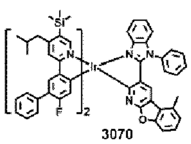
3070
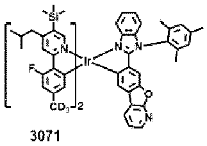
3071
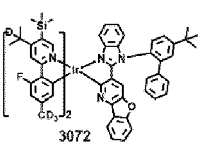
3072
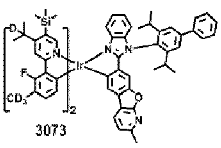
3073
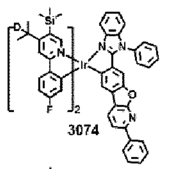
3074
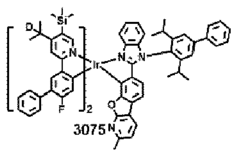
3075
3076
3077
3078
3079
3080

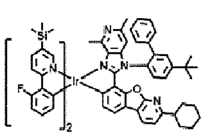
3081
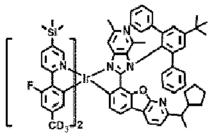
3082
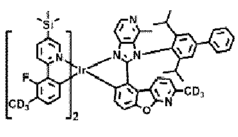
3083
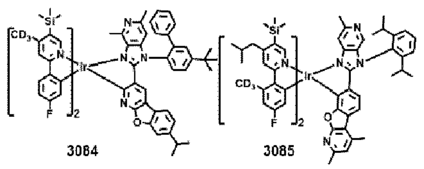
3084
3085

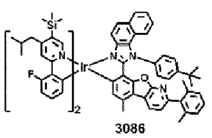
3086
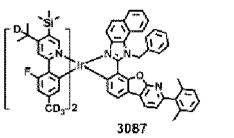
3087
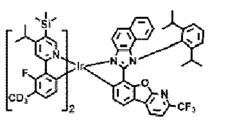
3088
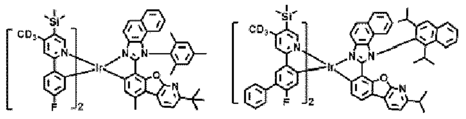
3089
3090

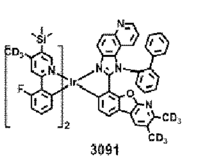
3091
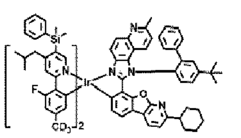
3092
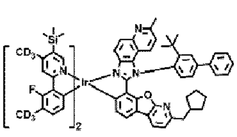
3093
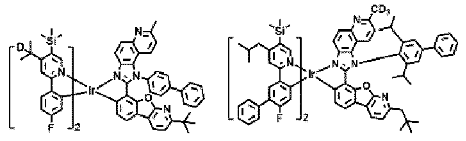
3094
3095

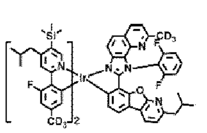
3096
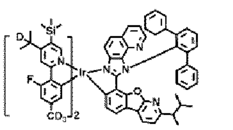
3097
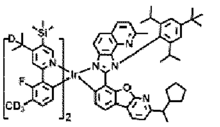
3098
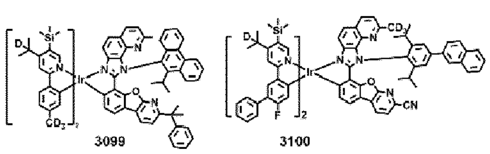
3099
3100

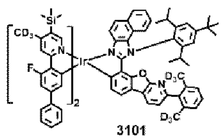
3101
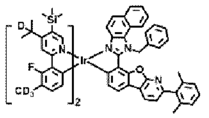
3102
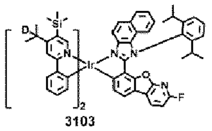
3103
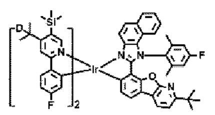
3104
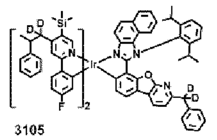
3105

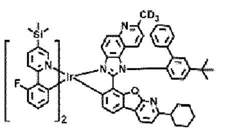
3106
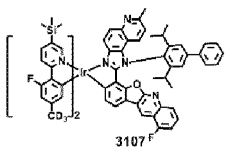
3107
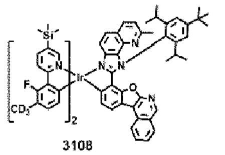
3108
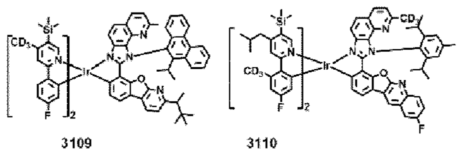
3109
3110

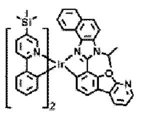
3111
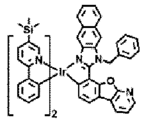
3112
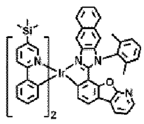
3113
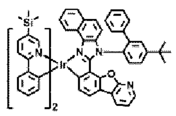
3114
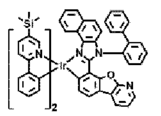
3115

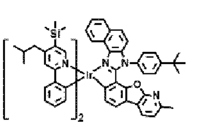
3116
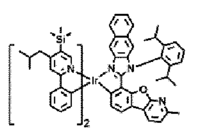
3117
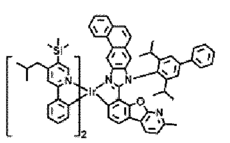
3118
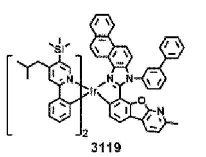
3119
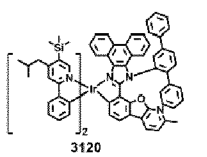
3120

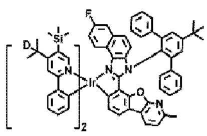
3121
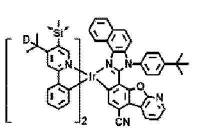
3122
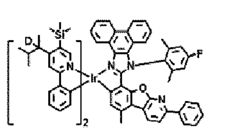
3123
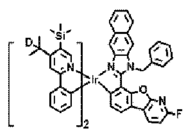
3124
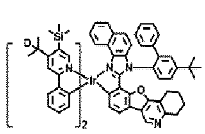
3125

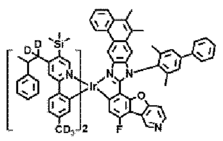
3126
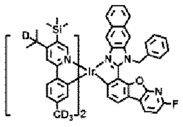
3127
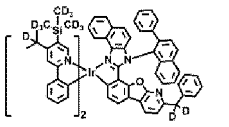
3128
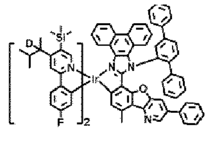
3129
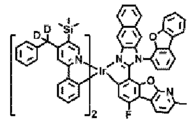
3130
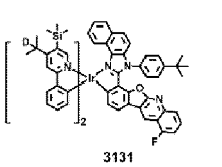
3131
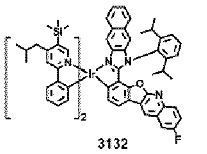
3132
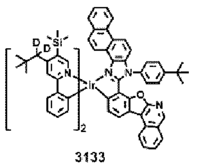
3133
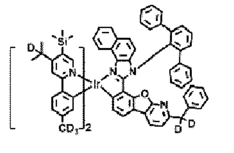
3134
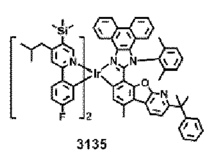
3135
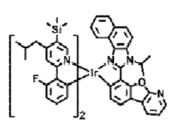
3136
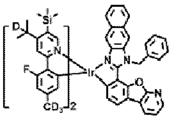
3137
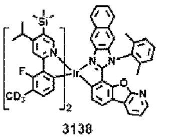
3138
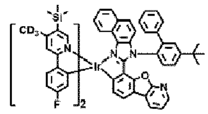
3139
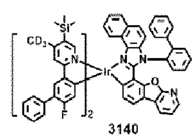
3140
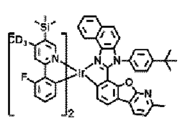
3141
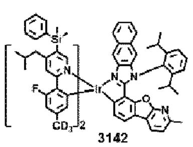
3142
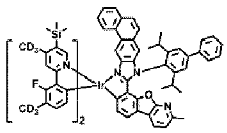
3143
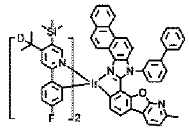
3144
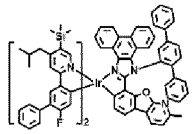
3145
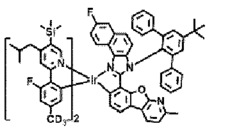
3146
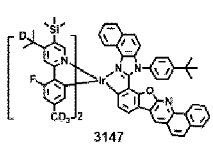
3147
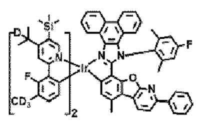
3148
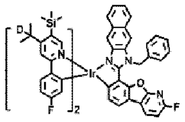
3149
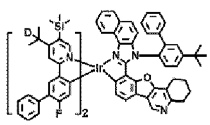
3150
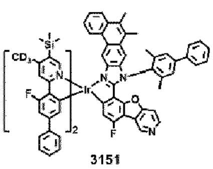
3151
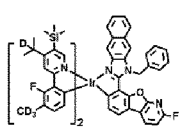
3152
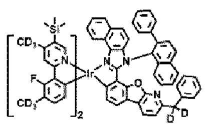
3153
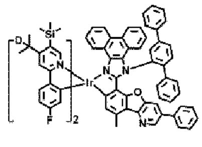
3154
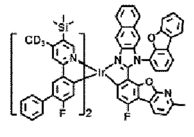
3155
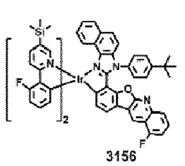
3156
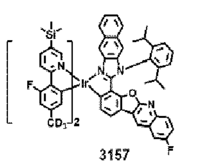
3157
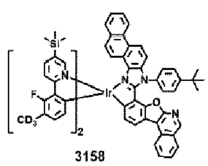
3158
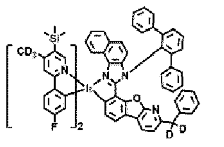
3159
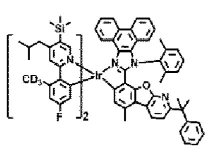
3160
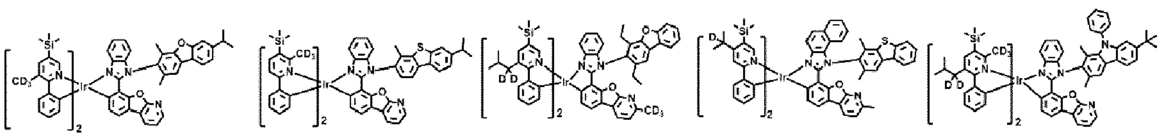
3161 3162 3163 3164 3165
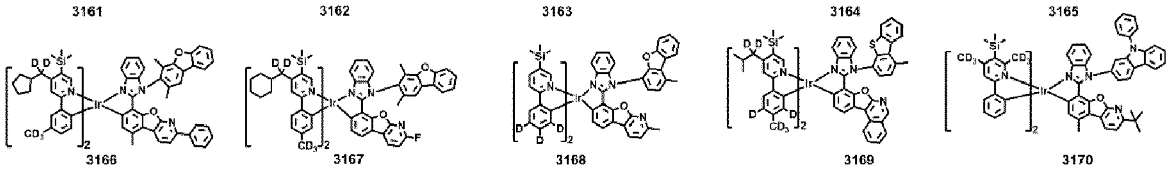
3166 3167 3168 3169 3170

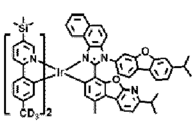
3171
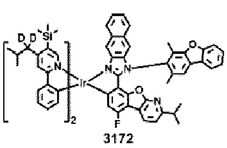
3172
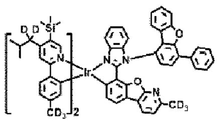
3173
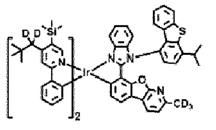
3174
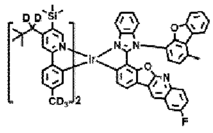
3175

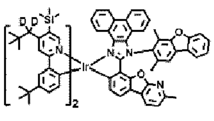
3176
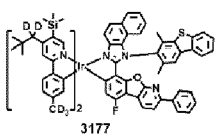
3177
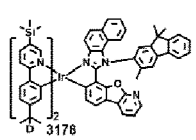
3178
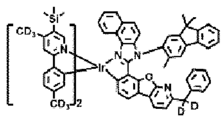
3179
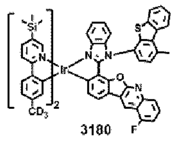
3180

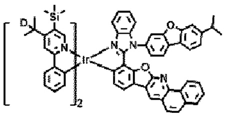
3181
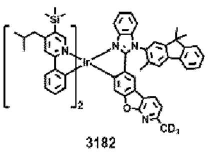
3182
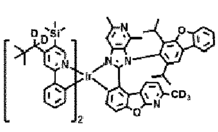
3183
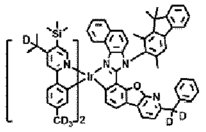
3184
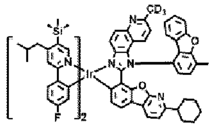
3185

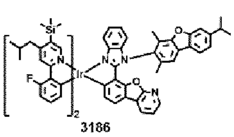
3186
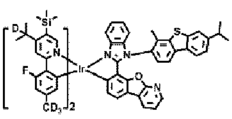
3187
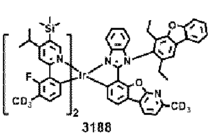
3188
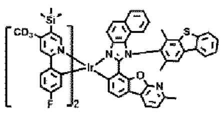
3189
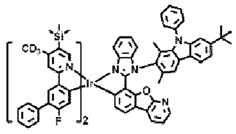
3190

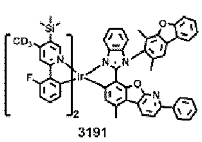
3191
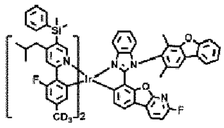
3192
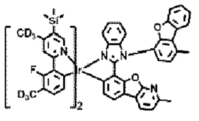
3193
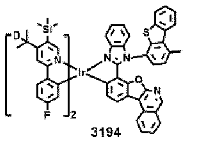
3194
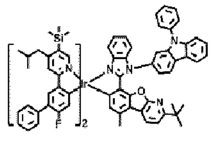
3195

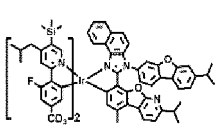
3196
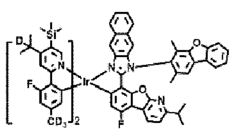
3197
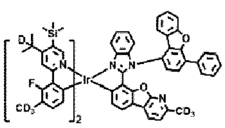
3198
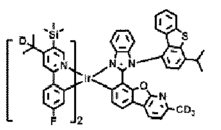
3199
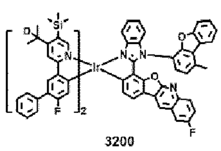
3200

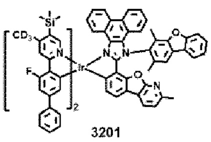
3201
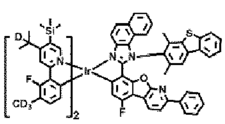
3202
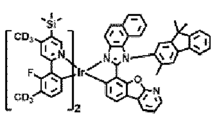
3203
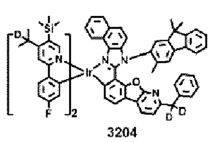
3204
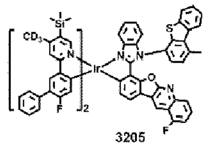
3205

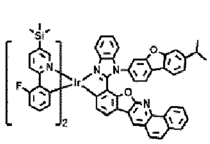
3206
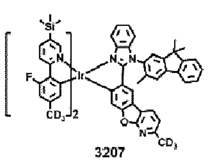
3207
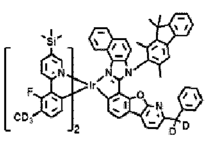
3208
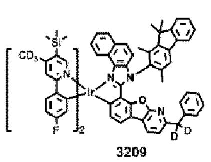
3209
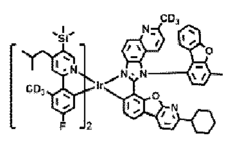
3210

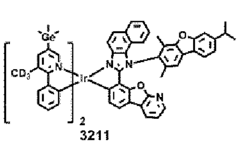
3211
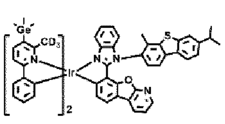
3212
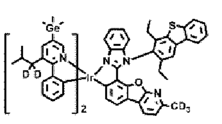
3213
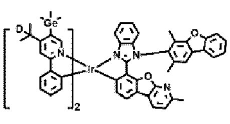
3214
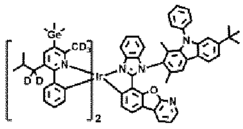
3215
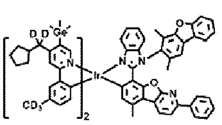
3216
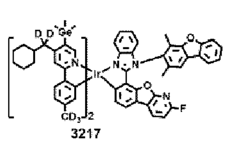
3217
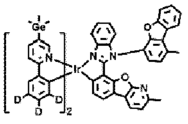
3218
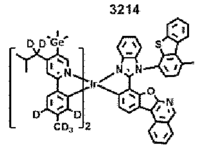
3219
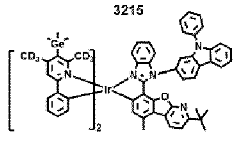
3220
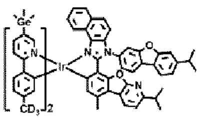
3221
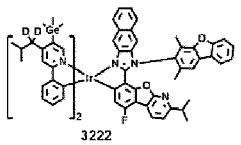
3222
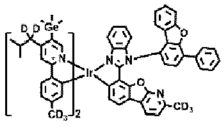
3223
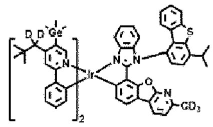
3224
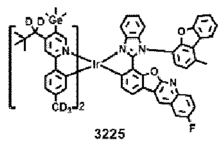
3225
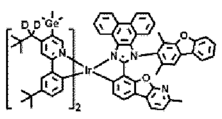
3226
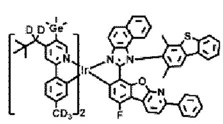
3227
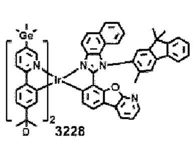
3228
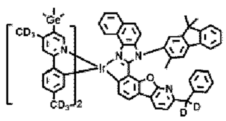
3229
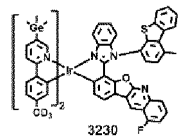
3230
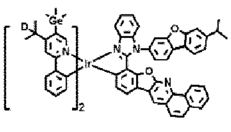
3231
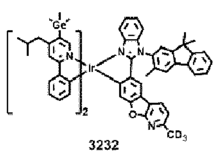
3232
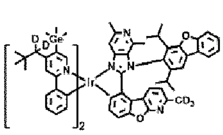
3233
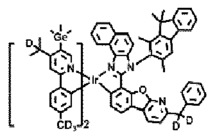
3234
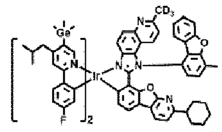
3235
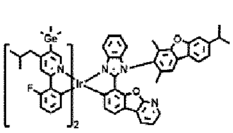
3236
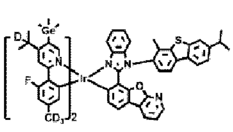
3237
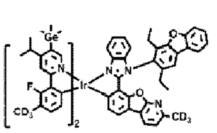
3238
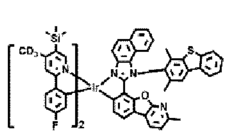
3239
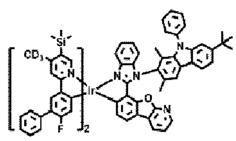
3240
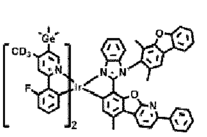
3241
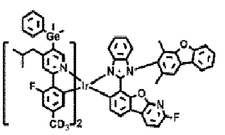
3242
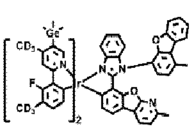
3243
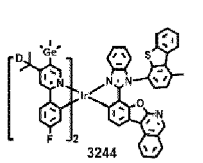
3244
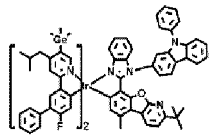
3245
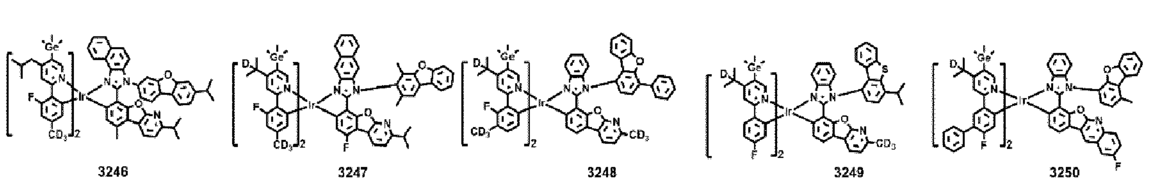
3246 3247 3248 3249 3250
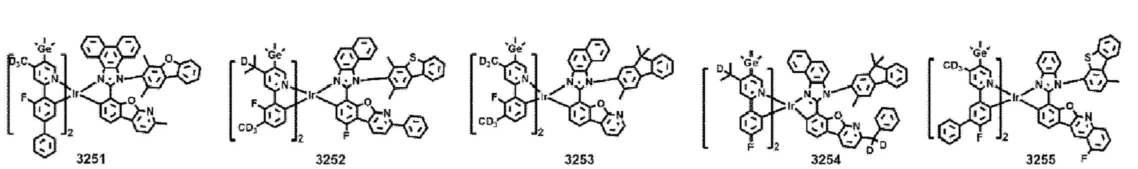
3251 3252 3253 3254 3255

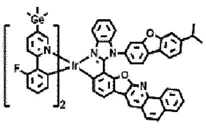 3256 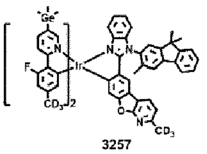 3257 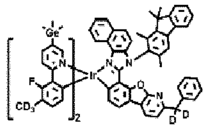 3258 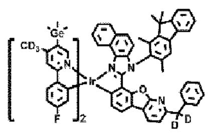 3259 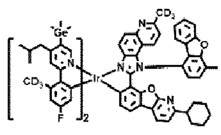 3260

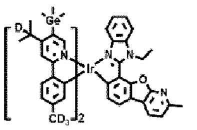 3261 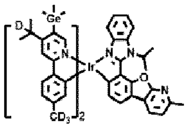 3262 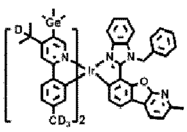 3263 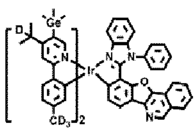 3264 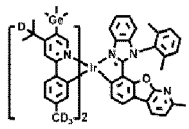 3265

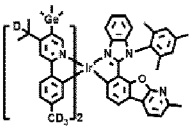 3266 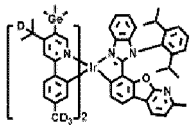 3267 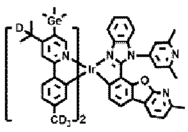 3268 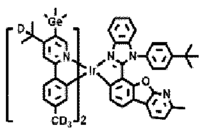 3269 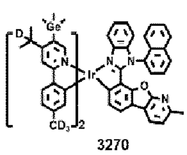 3270

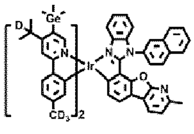 3271 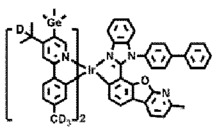 3272 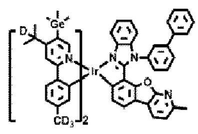 3273 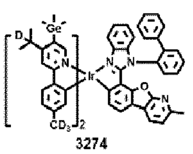 3274 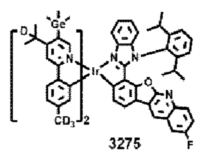 3275

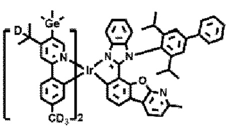 3276 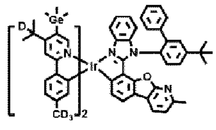 3277 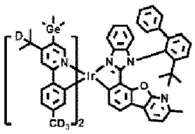 3278 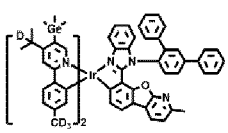 3279 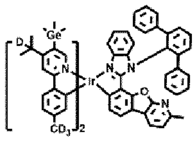 3280

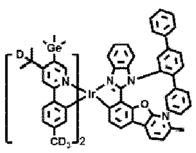 3281 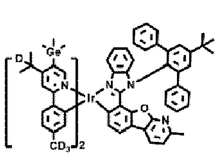 3282 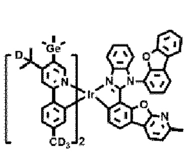 3283 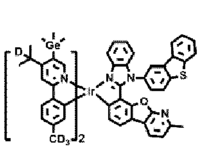 3284 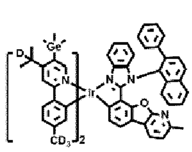 3285

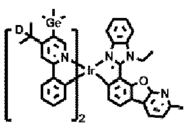 3286 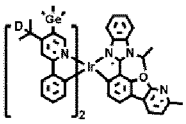 3287 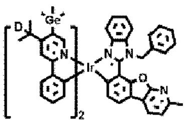 3288 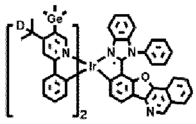 3289 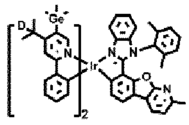 3290

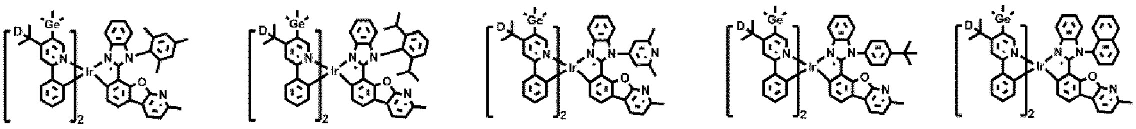

3291 3292 3293 3294 3295

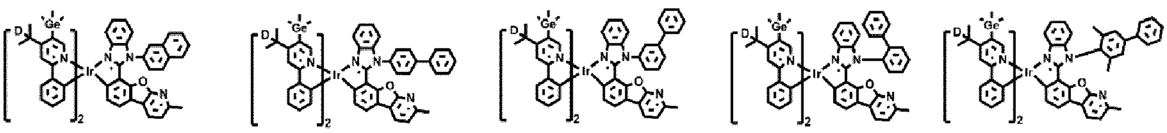

3296 3297 3298 3299 3300

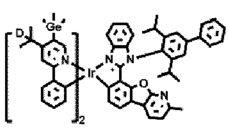
3301
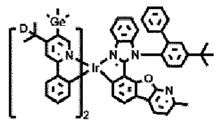
3302
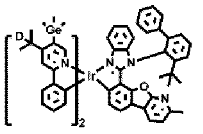
3303
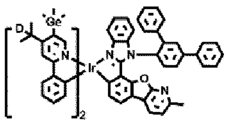
3304
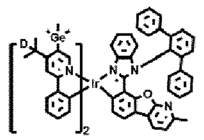
3305

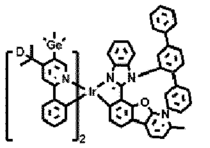
3306
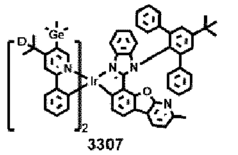
3307
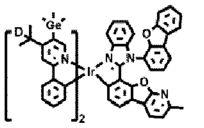
3308
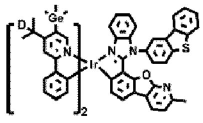
3309
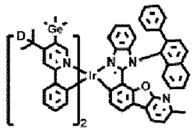
3310

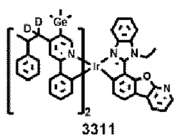
3311
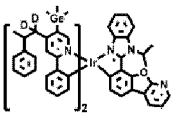
3312
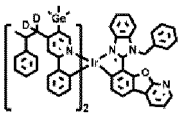
3313
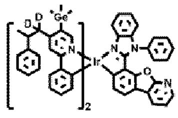
3314
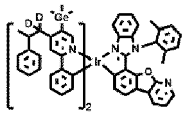
3315

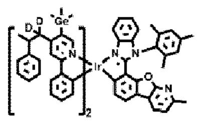
3316
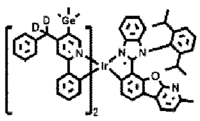
3317
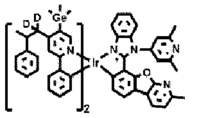
3318
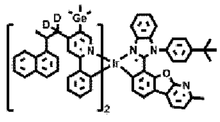
3319
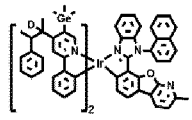
3320

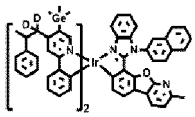
3321
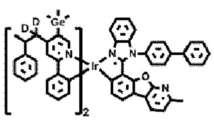
3322
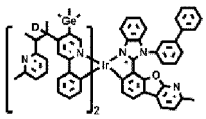
3323
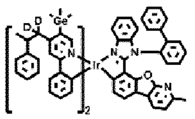
3324
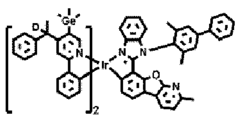
3325

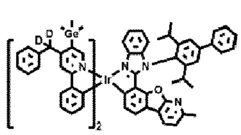
3326
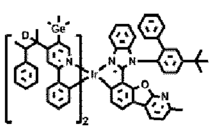
3327
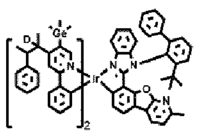
3328
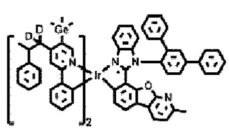
3329
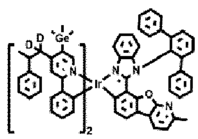
3330

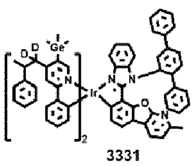
3331
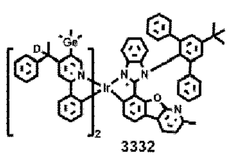
3332
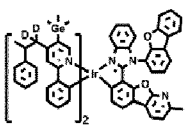
3333
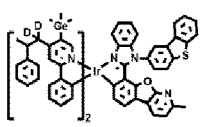
3334
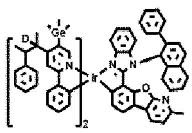
3335

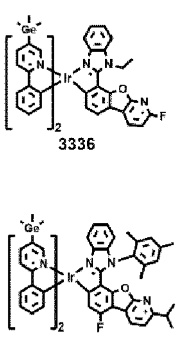
3336
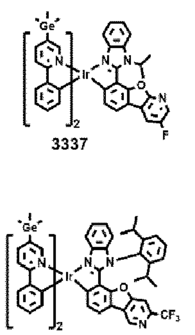
3337
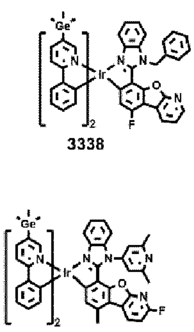
3338
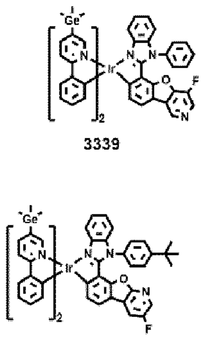
3339
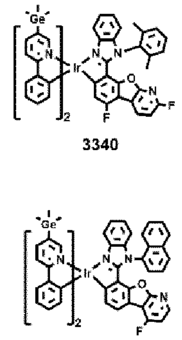
3340

3341
3342
3343
3344
3345

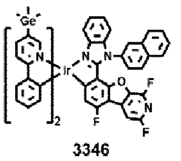
3346
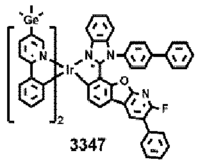
3347
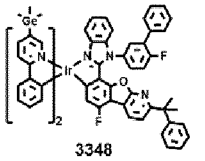
3348
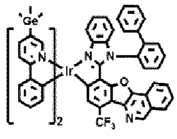
3349
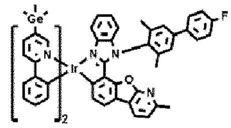
3350

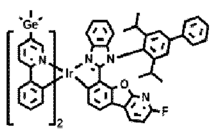
3351
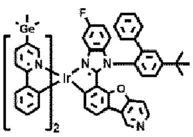
3352
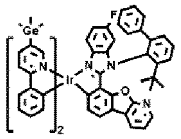
3353
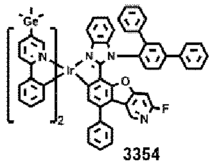
3354
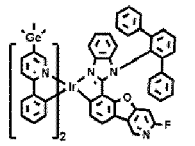
3355

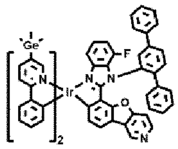
3356
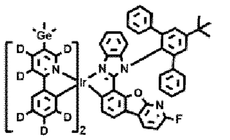
3357
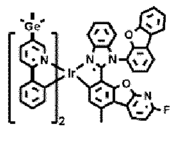
3358
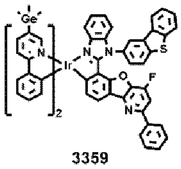
3359
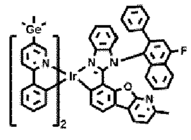
3360

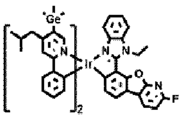
3361
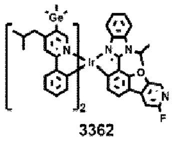
3362
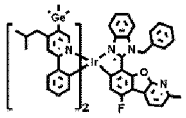
3363
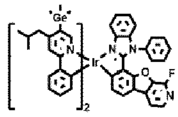
3364
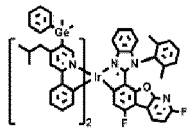
3365

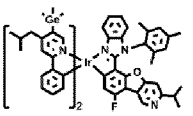
3366
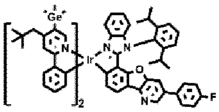
3367
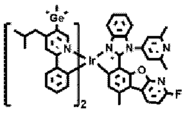
3368
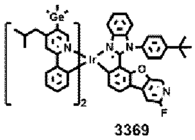
3369
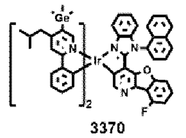
3370

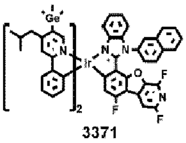
3371
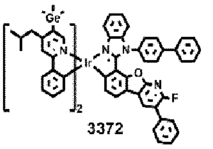
3372
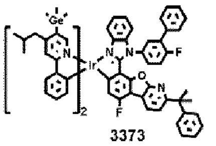
3373
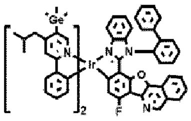
3374
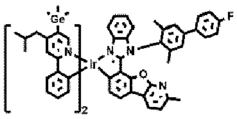
3375

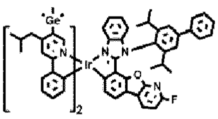
3376
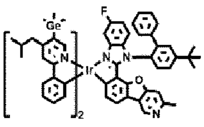
3377
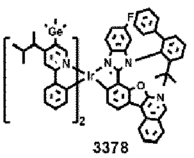
3378
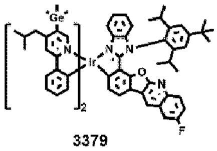
3379
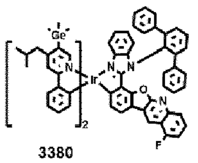
3380

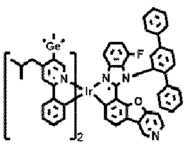
3381
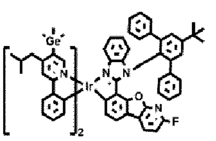
3382
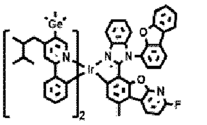
3383
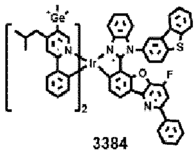
3384
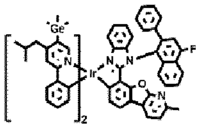
3385

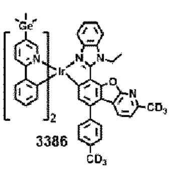
3386
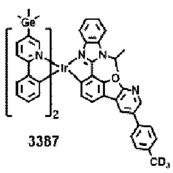
3387
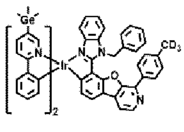
3388
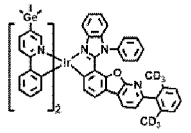
3389
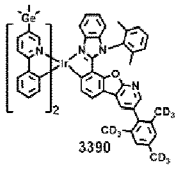
3390

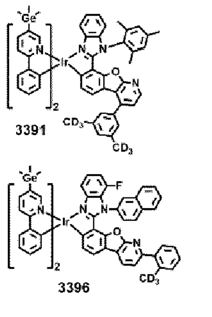
3391
3396
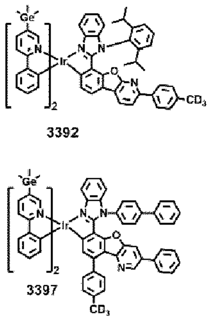
3392
3397
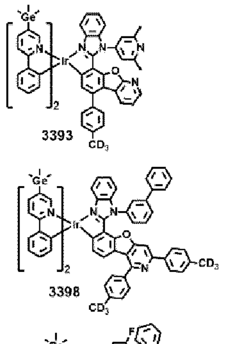
3393
3398
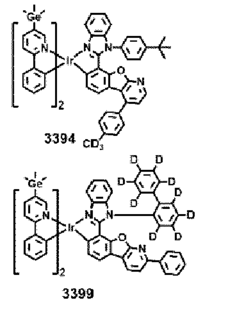
3394
3399
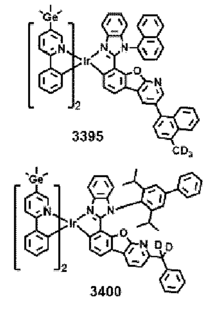
3395
3400

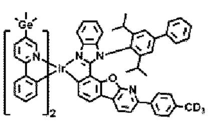
3401
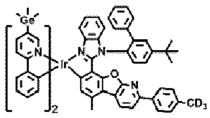
3402
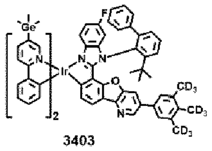
3403
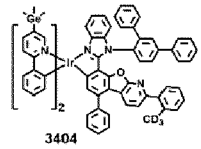
3404
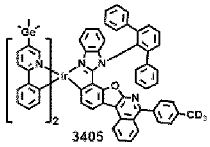
3405

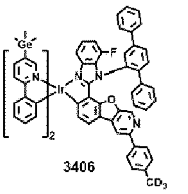
3406
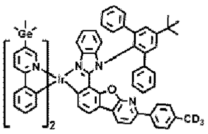
3407
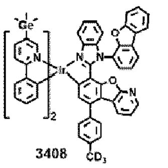
3408
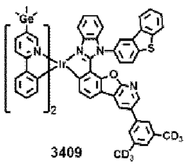
3409
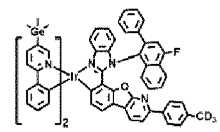
3410

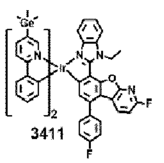
3411
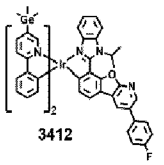
3412
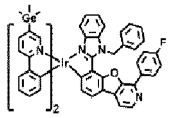
3413
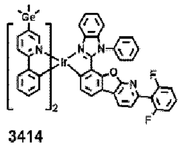
3414
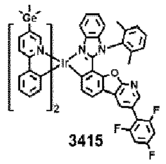
3415

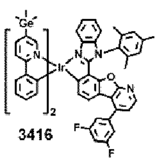
3416
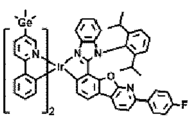
3417
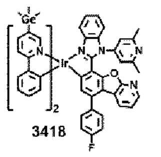
3418
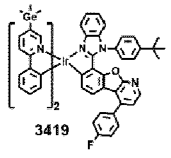
3419
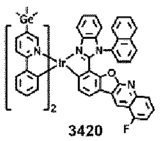
3420

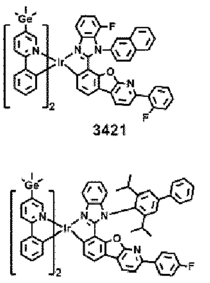
3421
3426
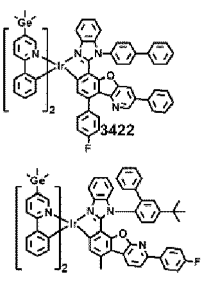
3422
3427
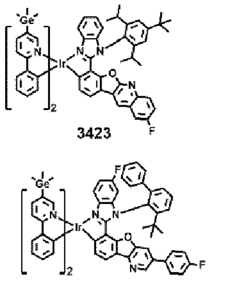
3423
3428
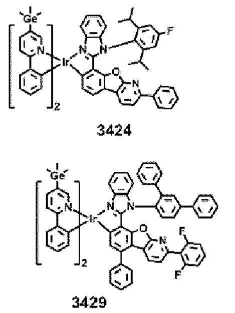
3424
3429
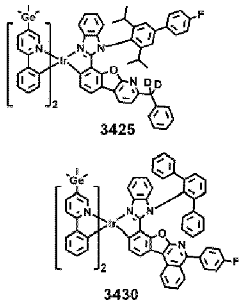
3425
3430

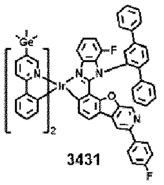
3431

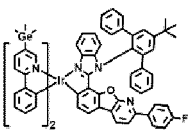
3432

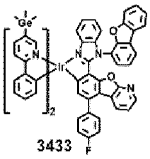
3433

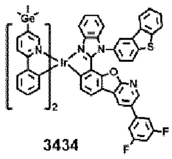
3434

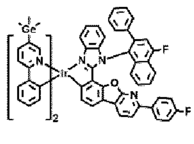
3435

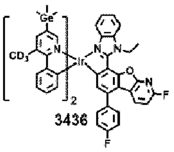
3436

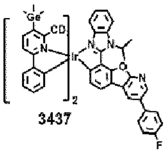
3437

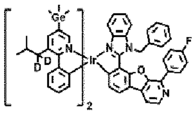
3438

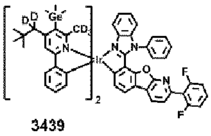
3439

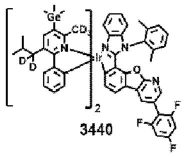
3440

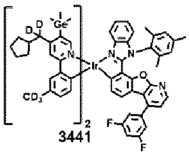
3441

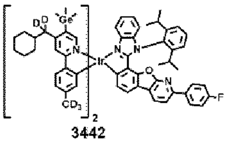
3442

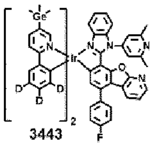
3443

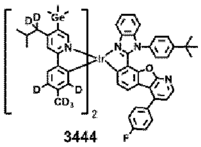
3444

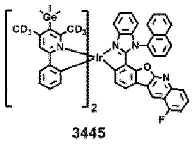
3445

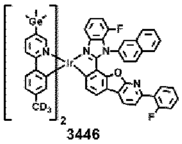
3446

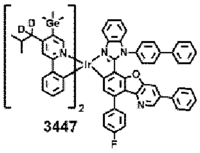
3447

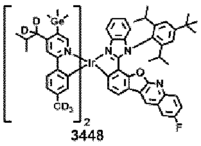
3448

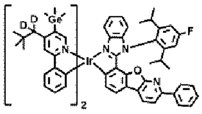
3449

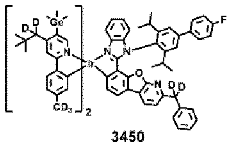
3450

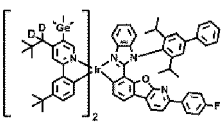
3451

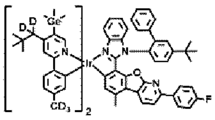
3452

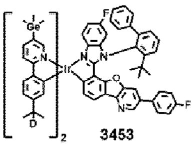
3453

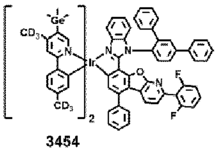
3454

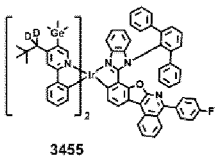
3455

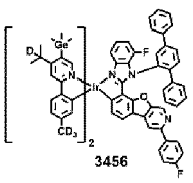
3456

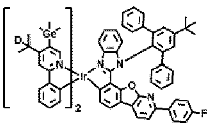
3457

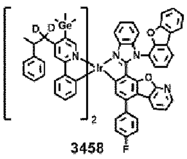
3458

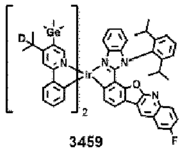
3459

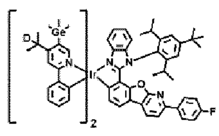
3460

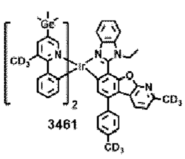
3461

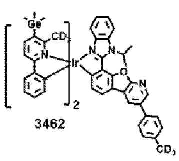
3462

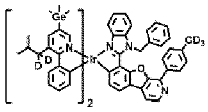
3463

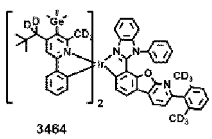
3464

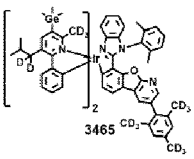
3465

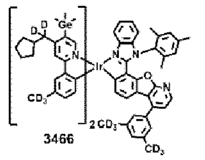
3466
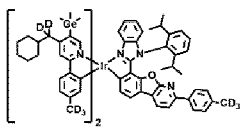
3467
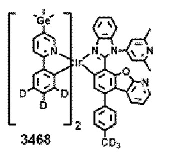
3468
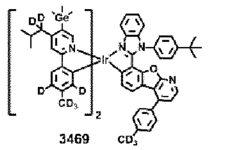
3469
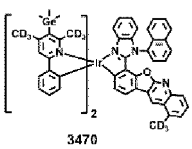
3470
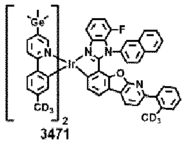
3471
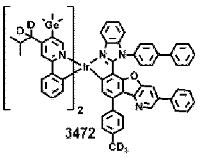
3472
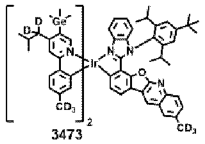
3473
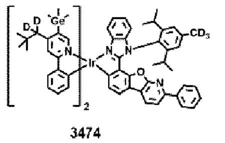
3474
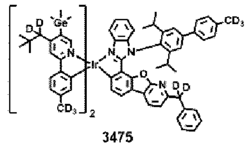
3475
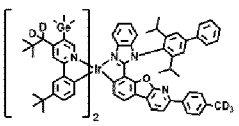
3476
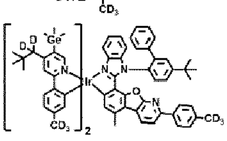
3477
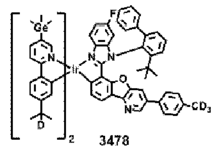
3478
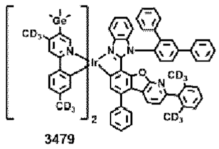
3479
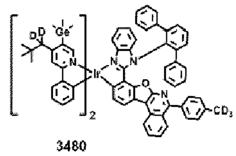
3480
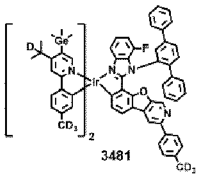
3481
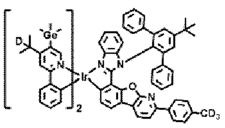
3482
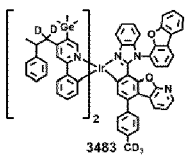
3483
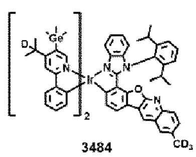
3484
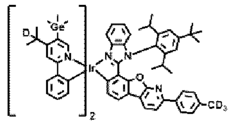
3485
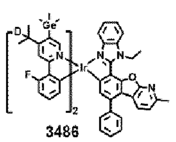
3486
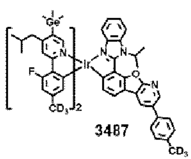
3487
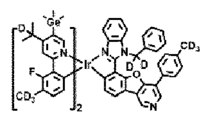
3488
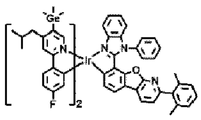
3489
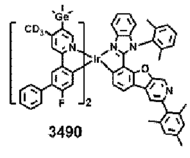
3490
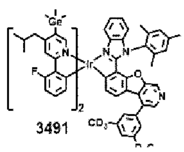
3491
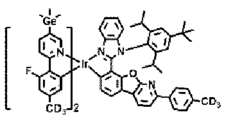
3492
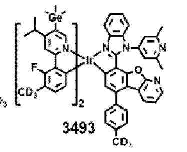
3493
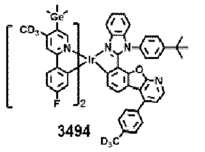
3494
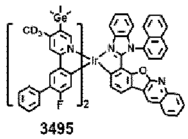
3495
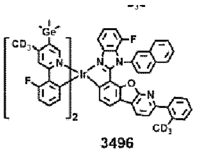
3496
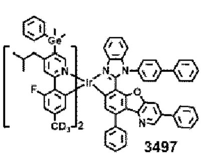
3497
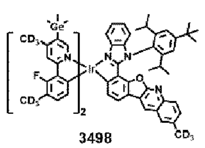
3498
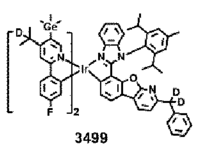
3499
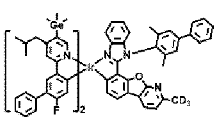
3500
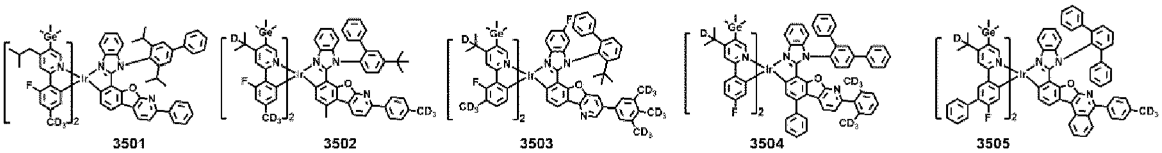
3501
3502
3503
3504
3505
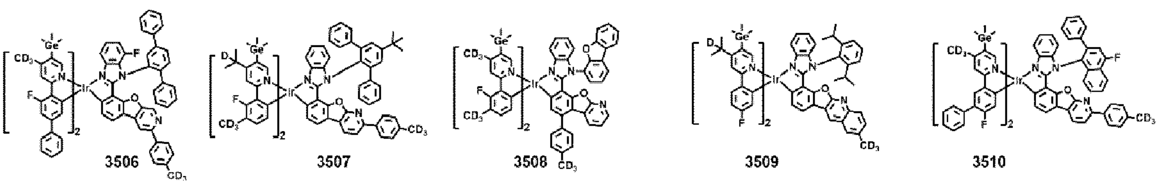
3506
3507
3508
3509
3510

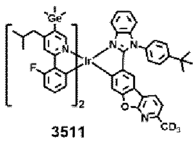
3511
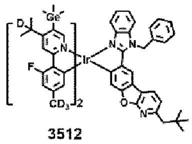
3512
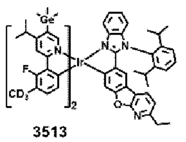
3513
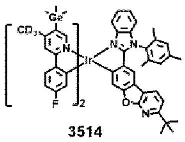
3514
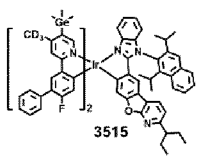
3515

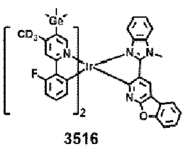
3516
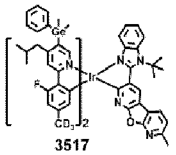
3517
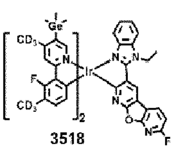
3518
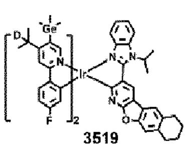
3519
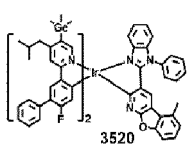
3520

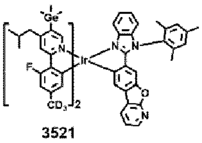
3521
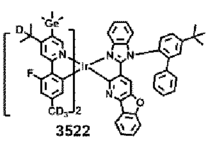
3522
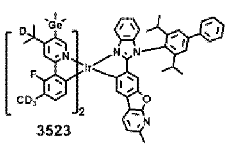
3523
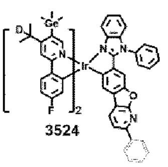
3524
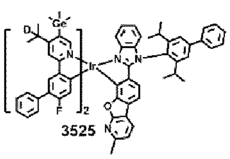
3525

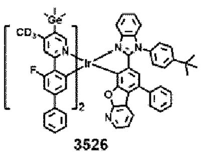
3526
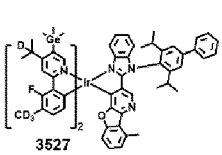
3527
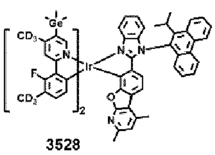
3528
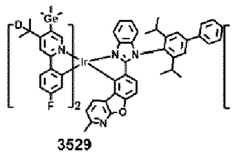
3529
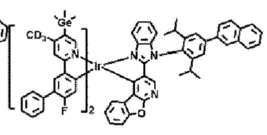
3530

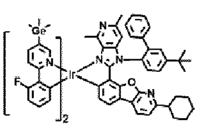
3531
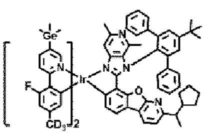
3532
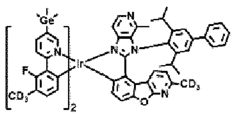
3533
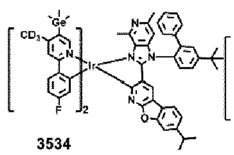
3534
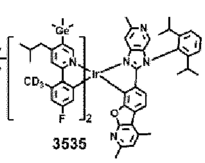
3535

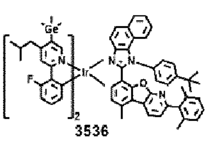
3536
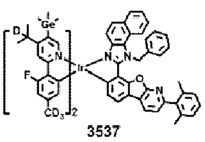
3537
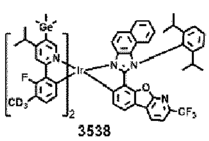
3538
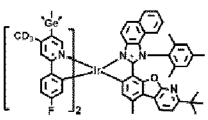
3539
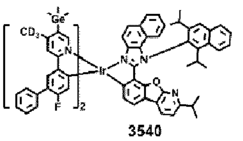
3540

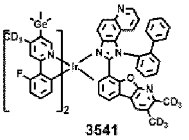
3541
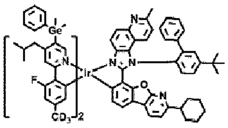
3542
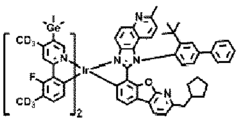
3543
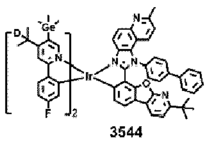
3544
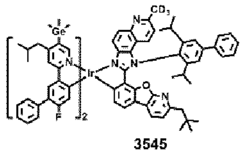
3545

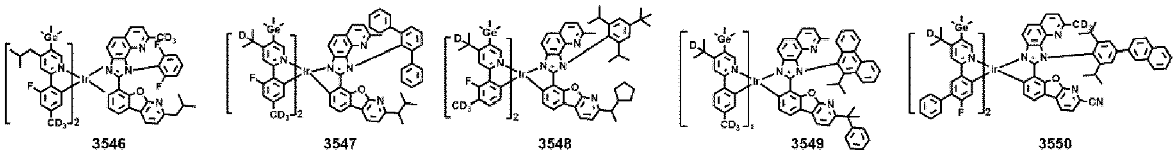
3546
3547
3548
3549
3550

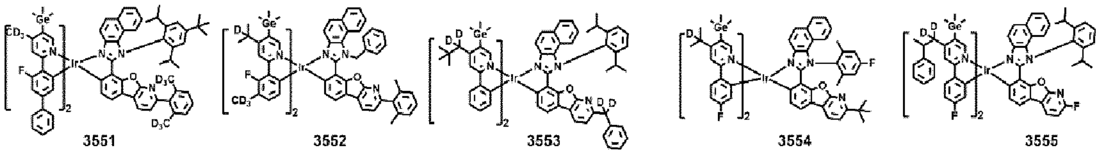
3551
3552
3553
3554
3555

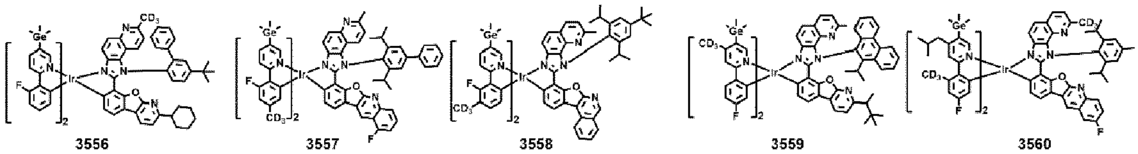
3556 3557 3558 3559 3560

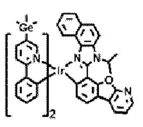
3561
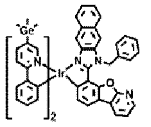
3562
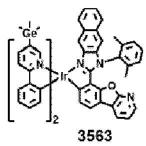
3563
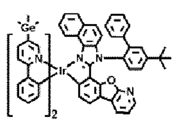
3564
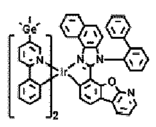
3565

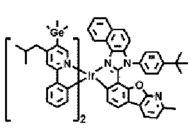
3566
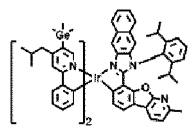
3567
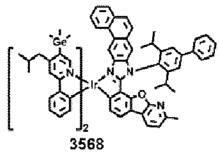
3568
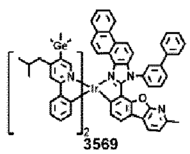
3569
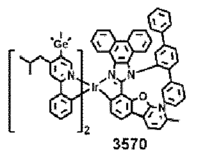
3570

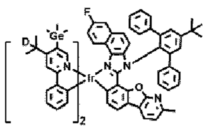
3571
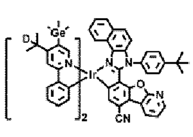
3572
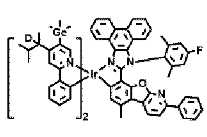
3573
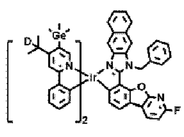
3574
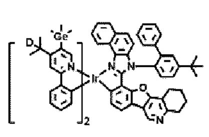
3575

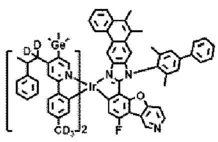
3576
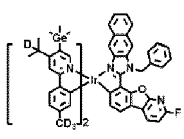
3577
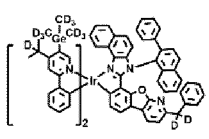
3578
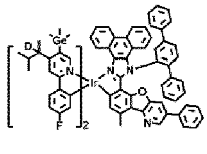
3579
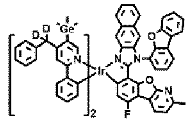
3580

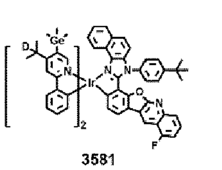
3581
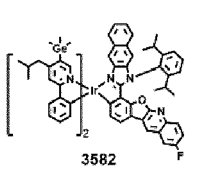
3582
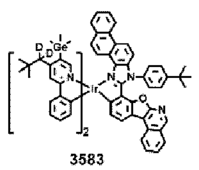
3583
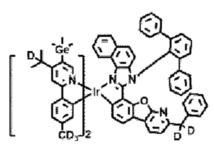
3584
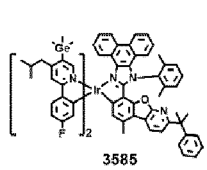
3585

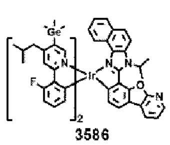
3586
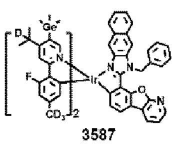
3587
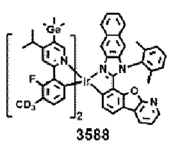
3588
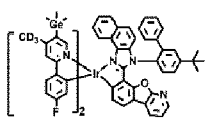
3589
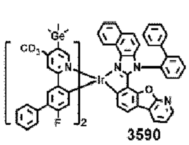
3590

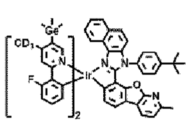
3591
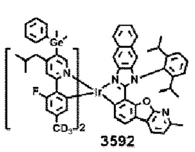
3592
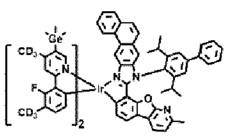
3593
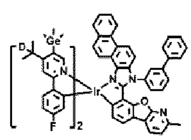
3594
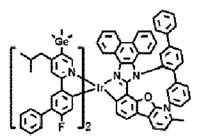
3595

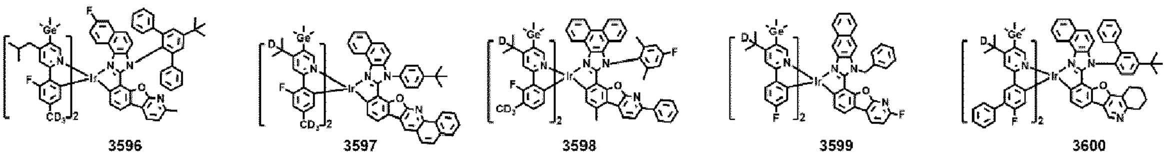
3596 3597 3598 3599 3600

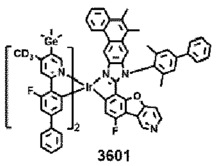
3601

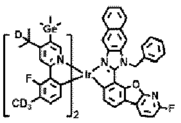
3602

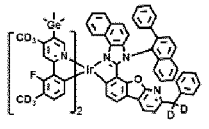
3603

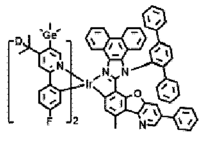
3604

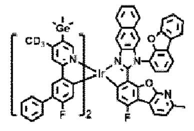
3605

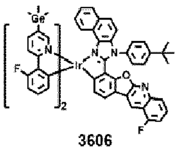
3606

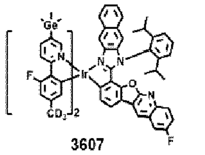
3607

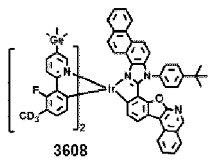
3608

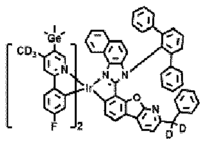
3609

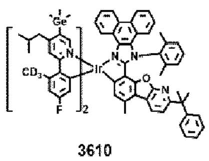
3610

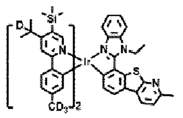
3611

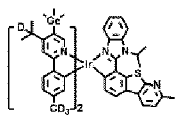
3612

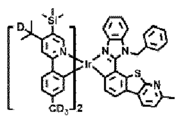
3613

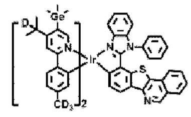
3614

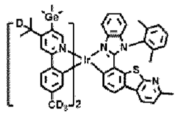
3615

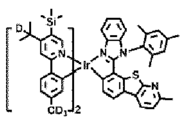
3616

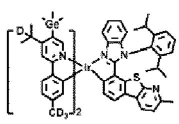
3617

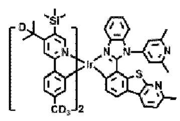
3618

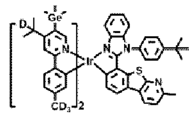
3619

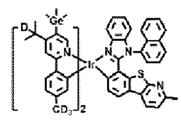
3620

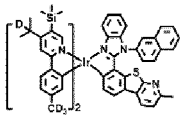
3621

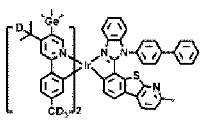
3622

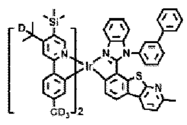
3623

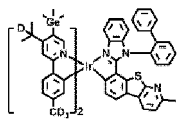
3624

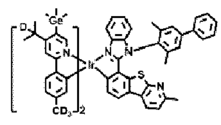
3625

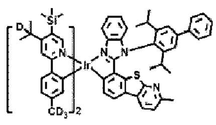
3626

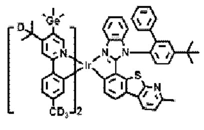
3627

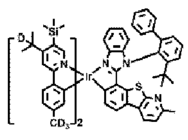
3628

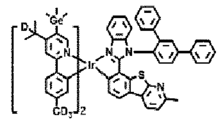
3629

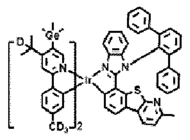
3630

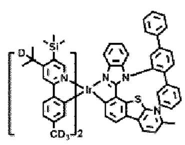
3631

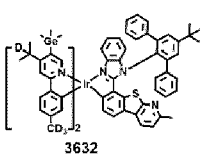
3632

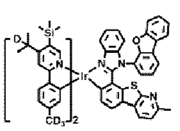
3633

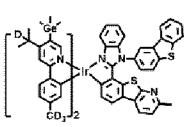
3634

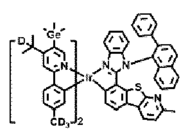
3635

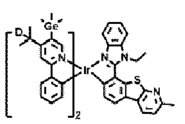
3636

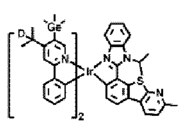
3637

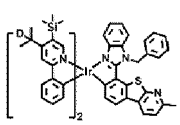
3638

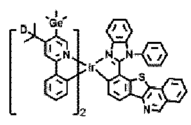
3639

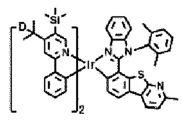
3640

3641

3642

3643

3644

3645

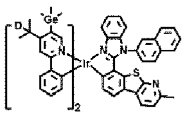
3646

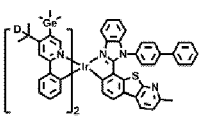
3647

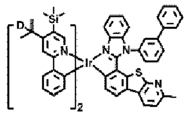
3648

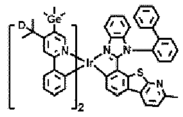
3649

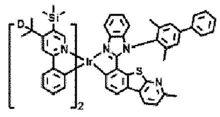
3650

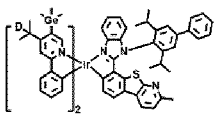
3651

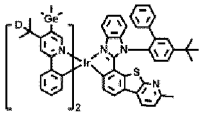
3652

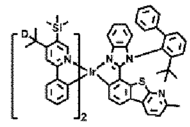
3653

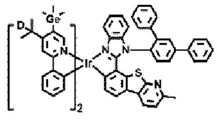
3654

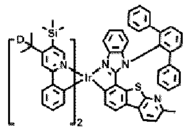
3655

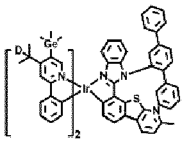
3656

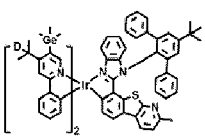
3657

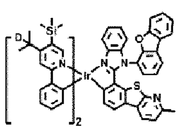
3658

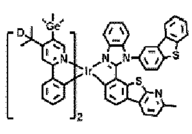
3659

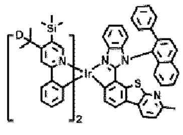
3660

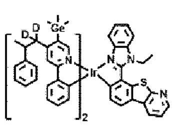
3661

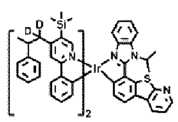
3662

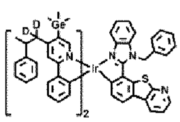
3663

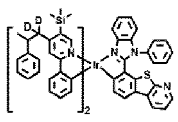
3664

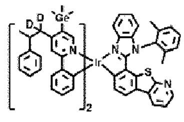
3665

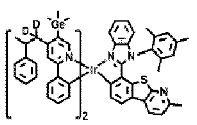
3666

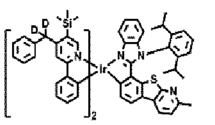
3667

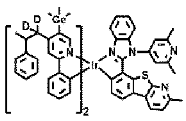
3668

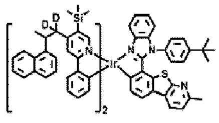
3669

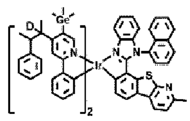
3670

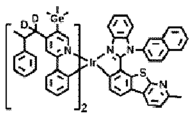
3671

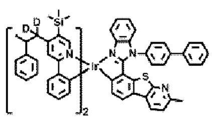
3672

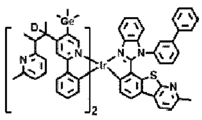
3673

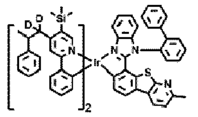
3674

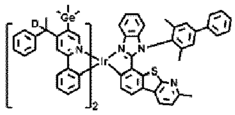
3675

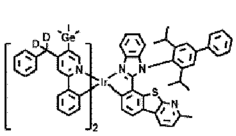
3676

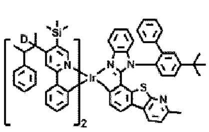
3677

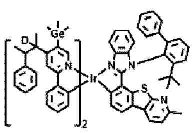
3678

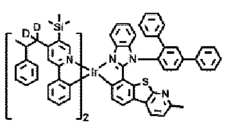
3679

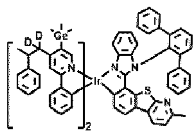
3680

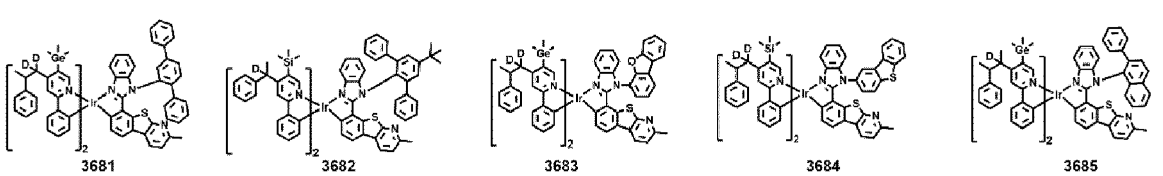
3681 3682 3683 3684 3685

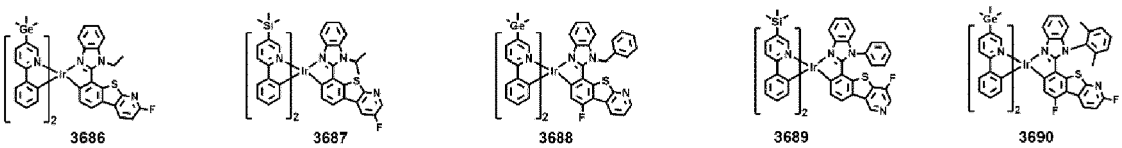
3686 3687 3688 3689 3690

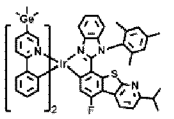
3691
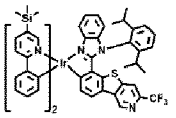
3692
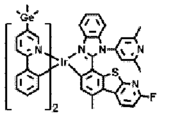
3693
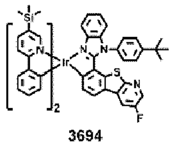
3694
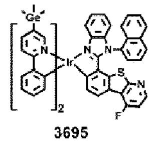
3695

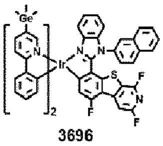
3696
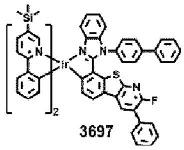
3697
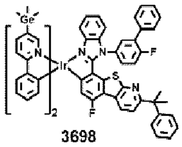
3698
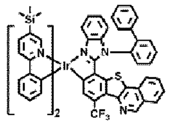
3699
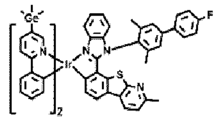
3700

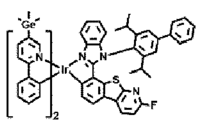
3701
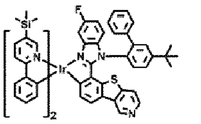
3702
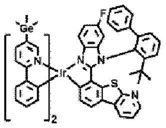
3703
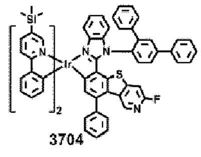
3704
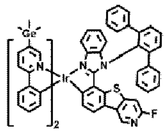
3705

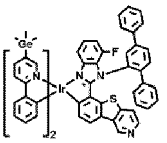
3706
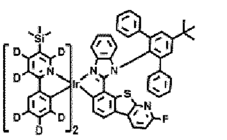
3707
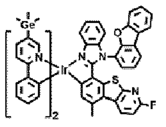
3708
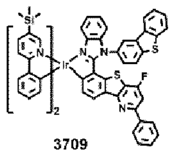
3709
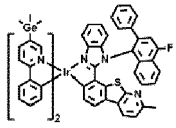
3710

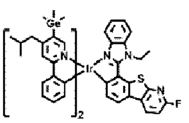
3711
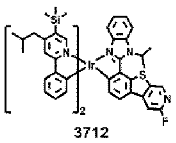
3712
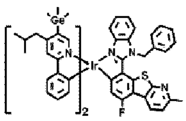
3713
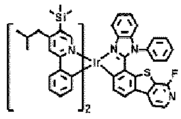
3714
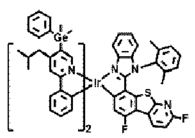
3715

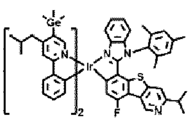
3716
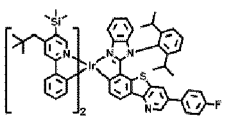
3717
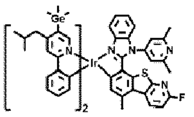
3718
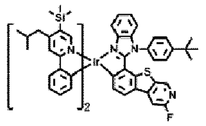
3719
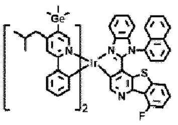
3720

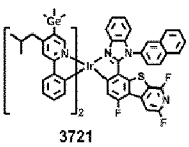
3721
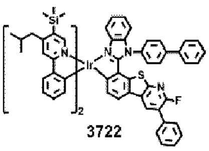
3722
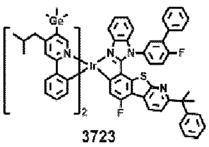
3723
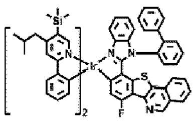
3724
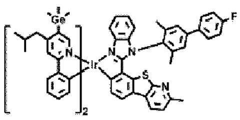
3725

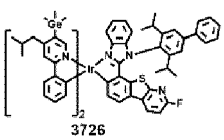
3726
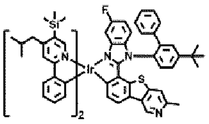
3727
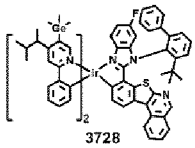
3728
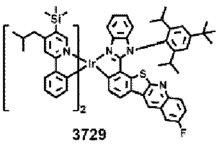
3729
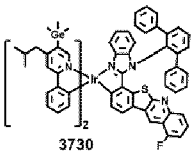
3730

3731
3732
3733
3734
3735

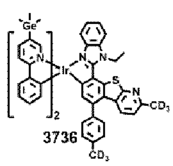
3736

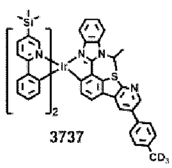
3737

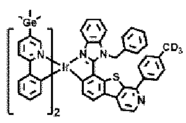
3738

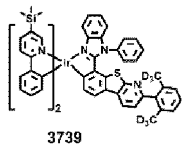
3739

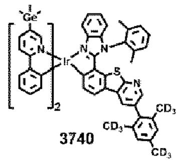
3740

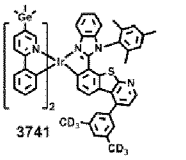
3741

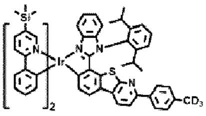
3742

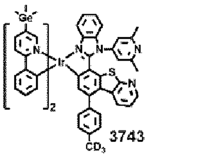
3743

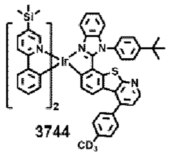
3744

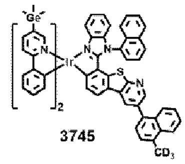
3745

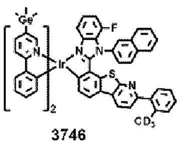
3746

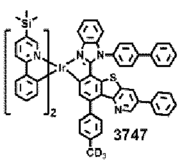
3747

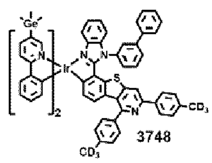
3748

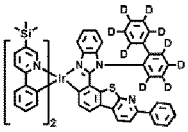
3749

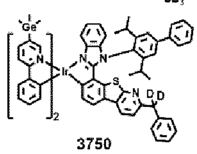
3750

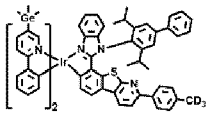
3751

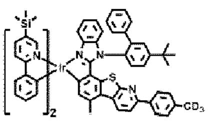
3752

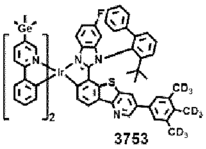
3753

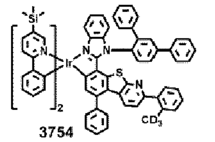
3754

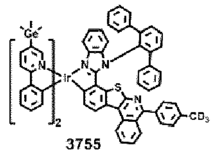
3755

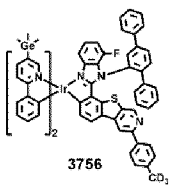
3756

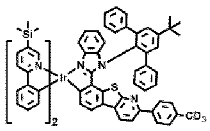
3757

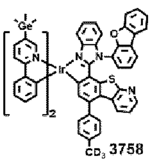
3758

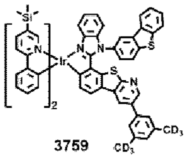
3759

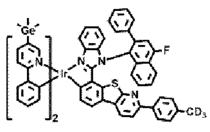
3760

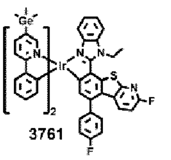
3761

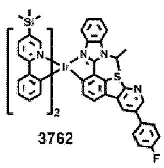
3762

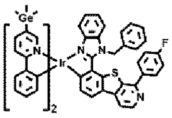
3763

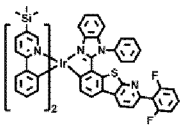
3764

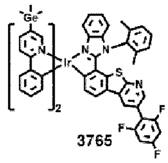
3765

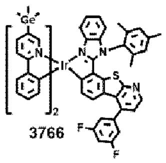
3766

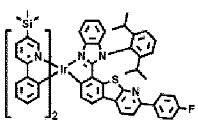
3767

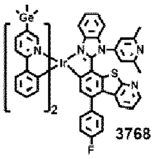
3768

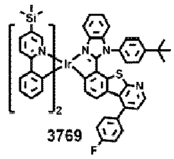
3769

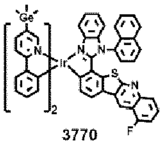
3770

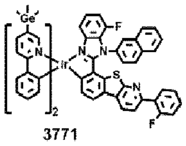
3771

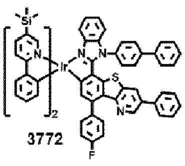
3772

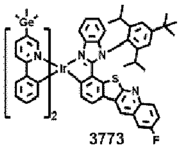
3773

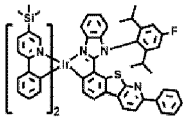
3774

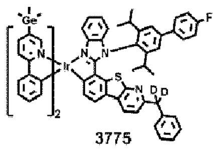
3775

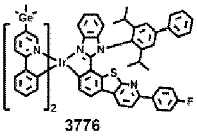
3776

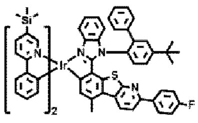
3777

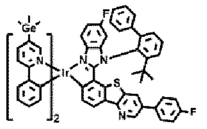
3778

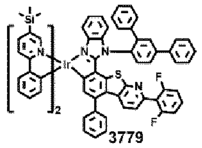
3779

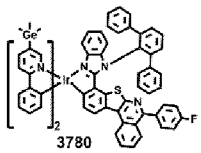
3780

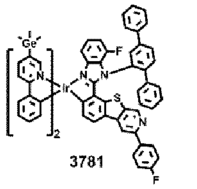
3781

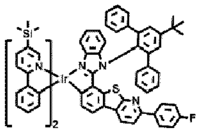
3782

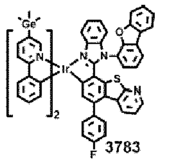
3783

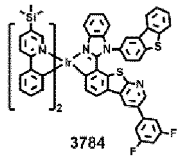
3784

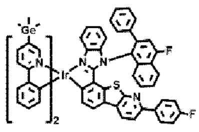
3785

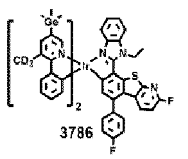
3786

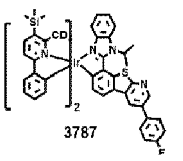
3787

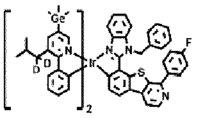
3788

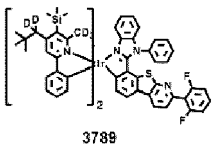
3789

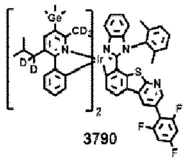
3790

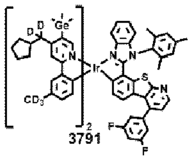
3791

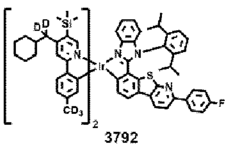
3792

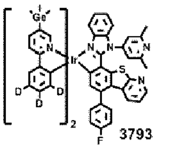
3793

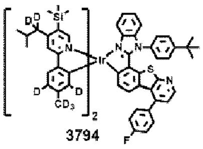
3794

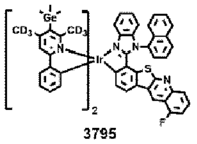
3795

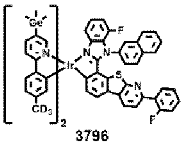
3796

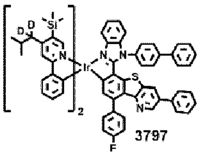
3797

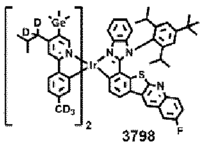
3798

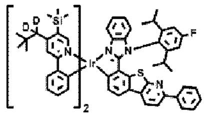
3799

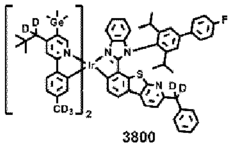
3800

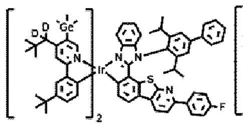
3801

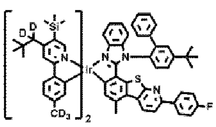
3802

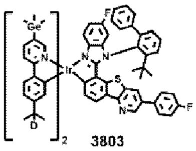
3803

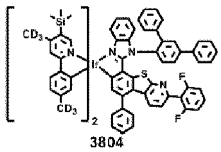
3804

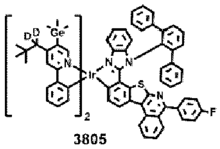
3805

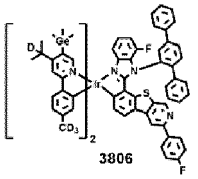
3806

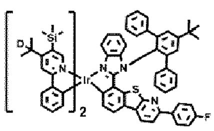
3807

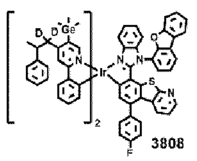
3808

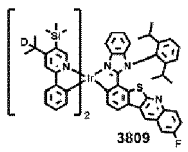
3809

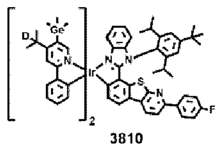
3810

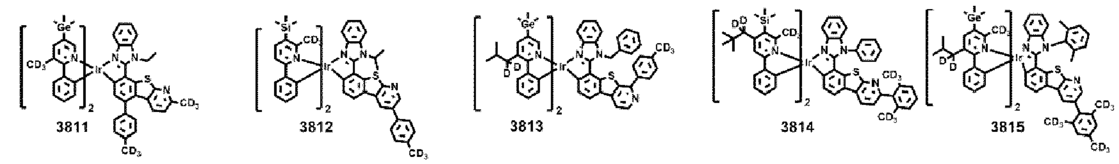

3811 3812 3813 3814 3815

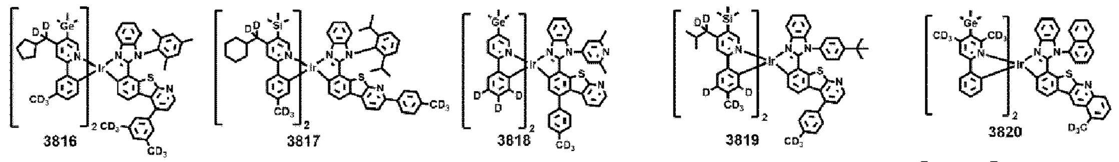

3816 3817 3818 3819 3820

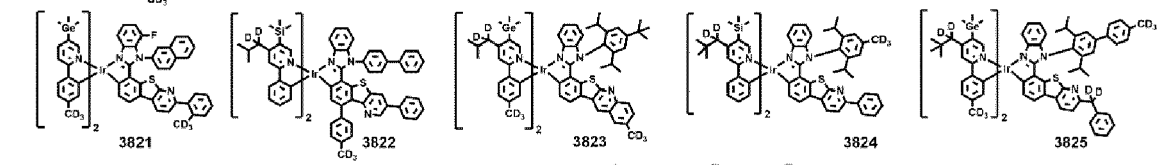

3821 3822 3823 3824 3825

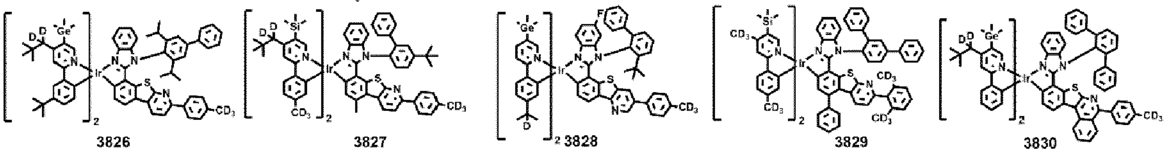

3826 3827 3828 3829 3830

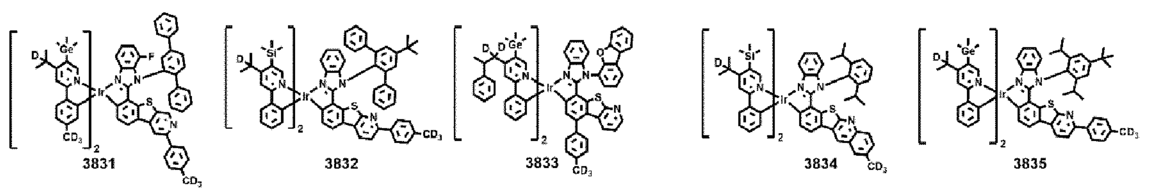

3831 3832 3833 3834 3835

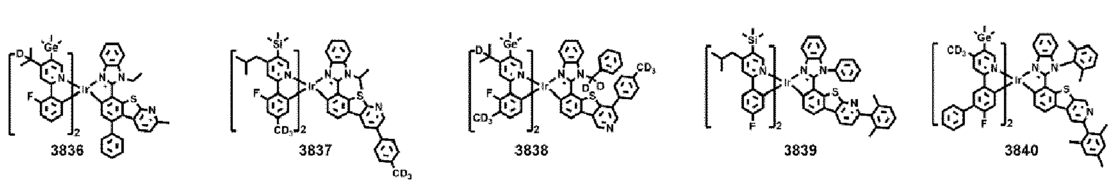

3836 3837 3838 3839 3840

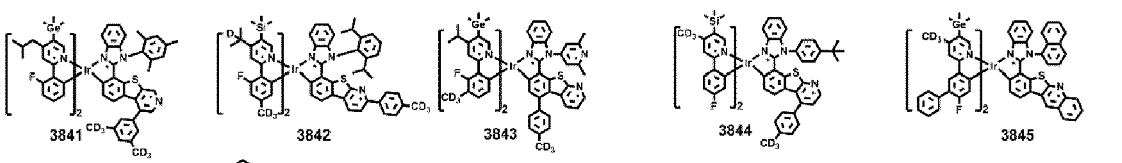

3841 3842 3843 3844 3845

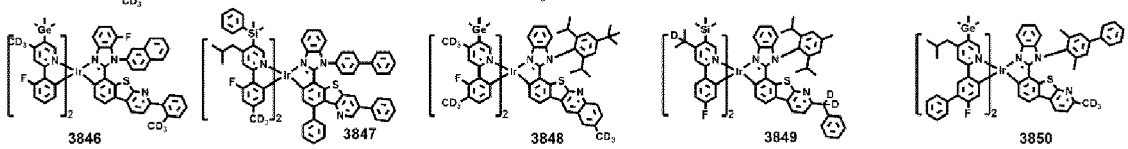

3846 3847 3848 3849 3850

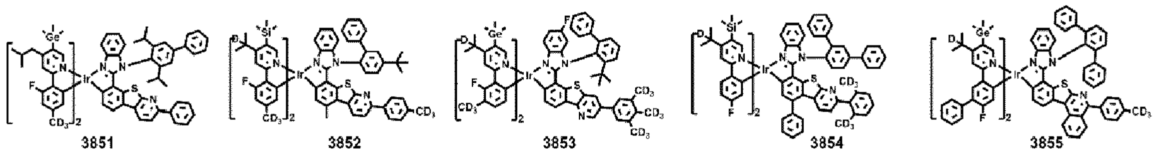

3851 3852 3853 3854 3855

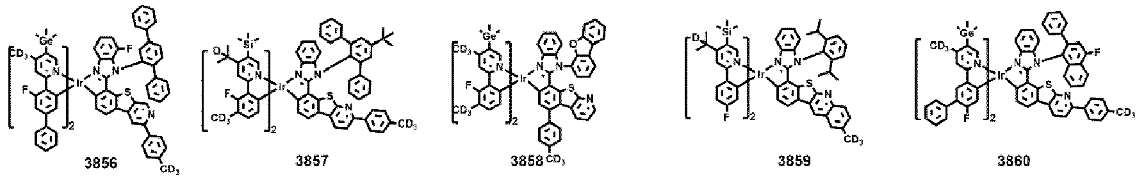

3856 3857 3858 3859 3860

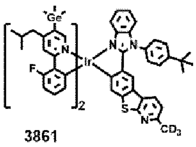
3861
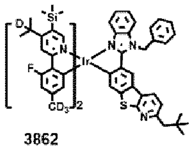
3862
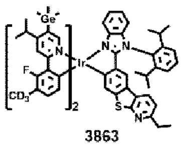
3863
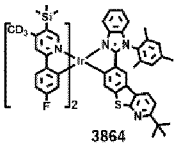
3864
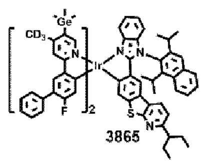
3865

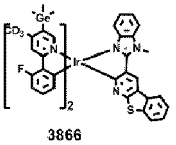
3866
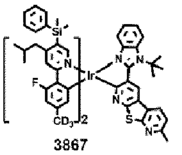
3867
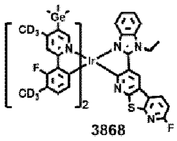
3868
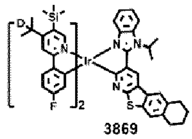
3869
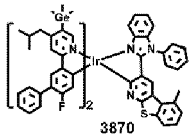
3870

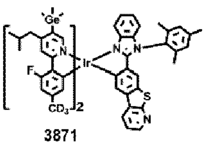
3871
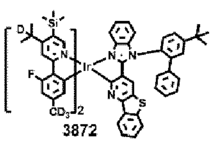
3872
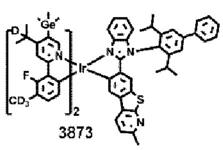
3873
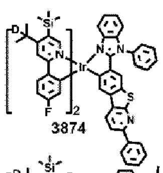
3874
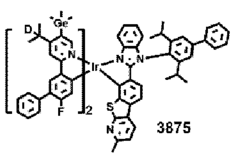
3875

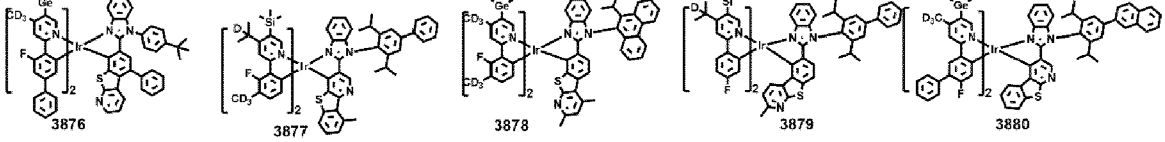
3876 3877 3878 3879 3880

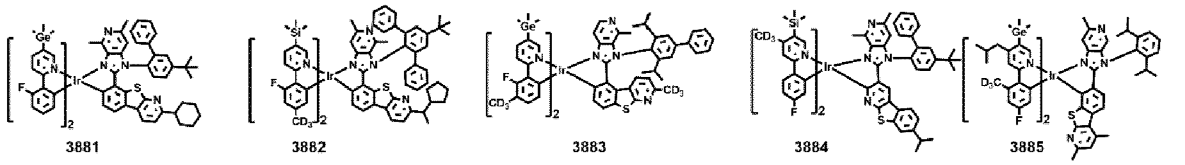
3881 3882 3883 3884 3885

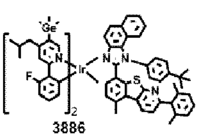
3886
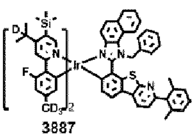
3887
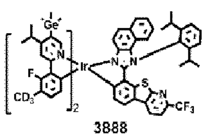
3888
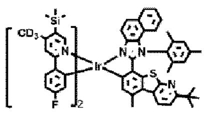
3889
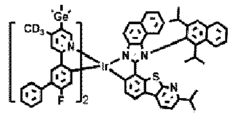
3890

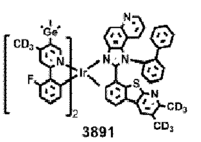
3891
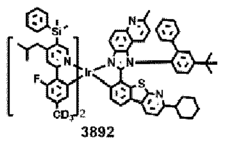
3892
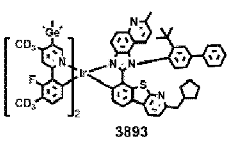
3893
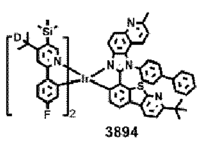
3894
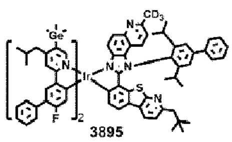
3895

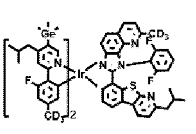
3896
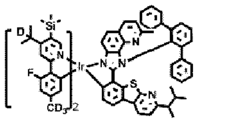
3897
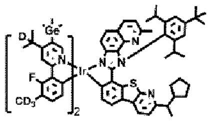
3898
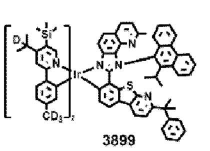
3899
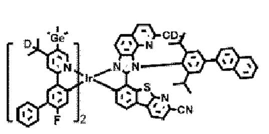
3900

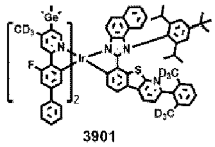
3901
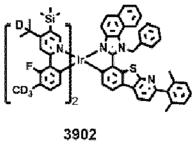
3902
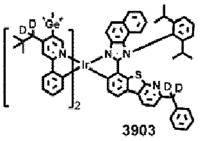
3903
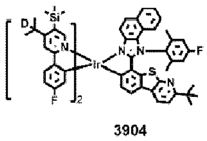
3904
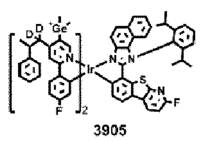
3905

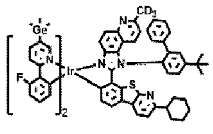
3906
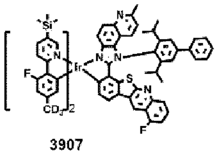
3907
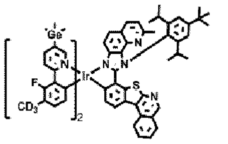
3908
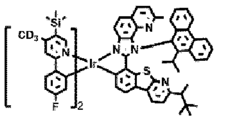
3909
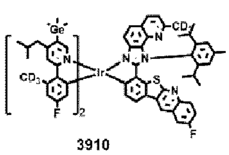
3910

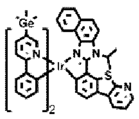
3911
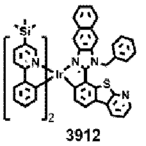
3912
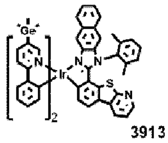
3913
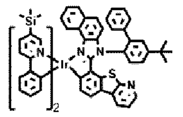
3914
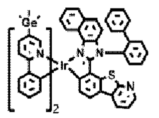
3915

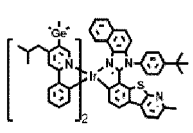
3916
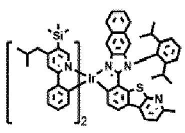
3917
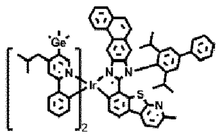
3918
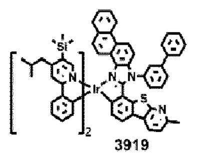
3919
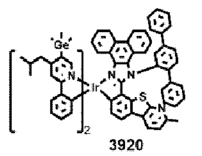
3920

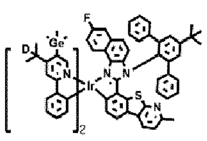
3921
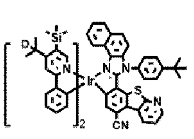
3922
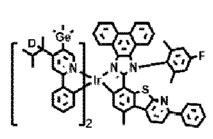
3923
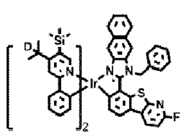
3924
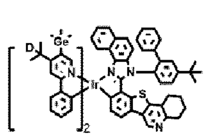
3925

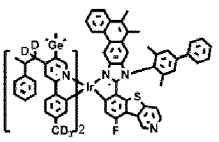
3926
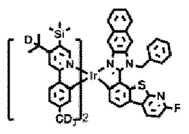
3927
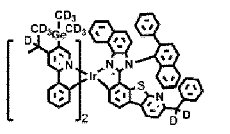
3928
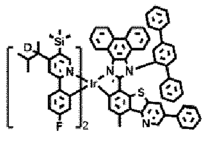
3929
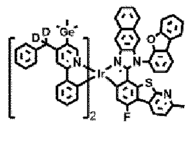
3930

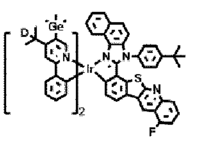
3931
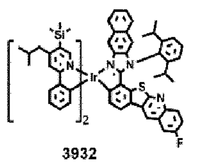
3932
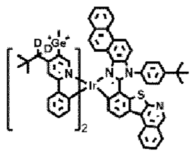
3933
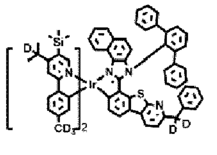
3934
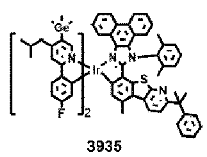
3935

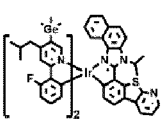
3936
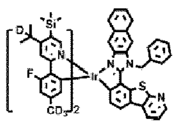
3937
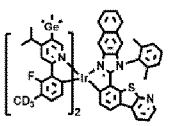
3938
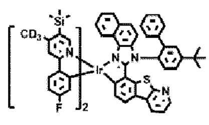
3939
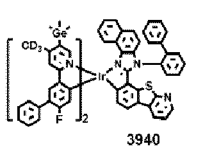
3940

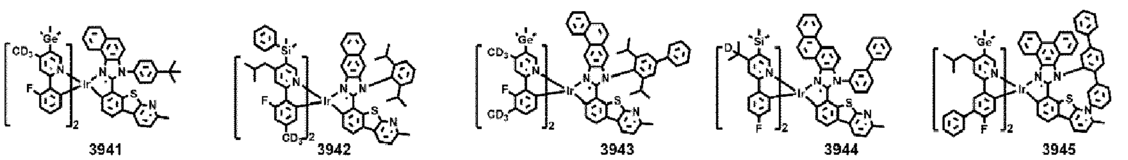
3941 3942 3943 3944 3945

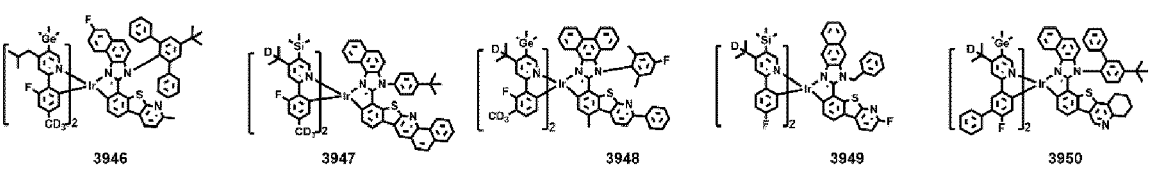
3946 3947 3948 3949 3950

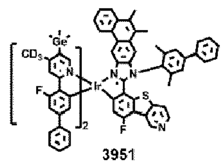
3951
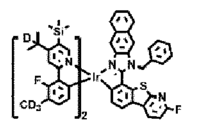
3952
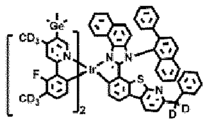
3953
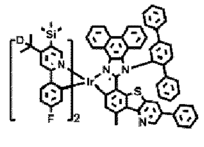
3954
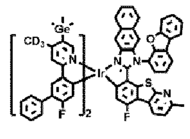
3955

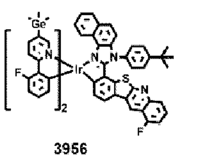
3956
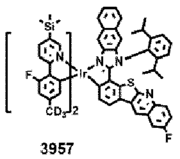
3957
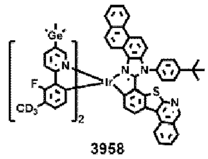
3958
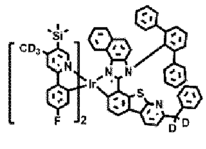
3959
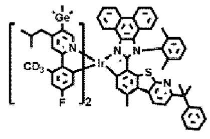
3960

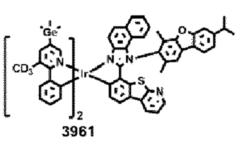
3961
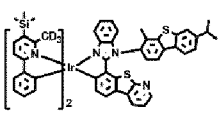
3962
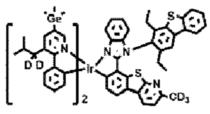
3963
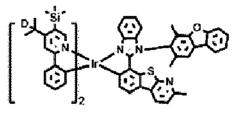
3964
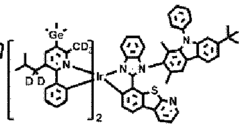
3965

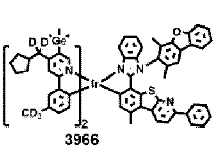
3966
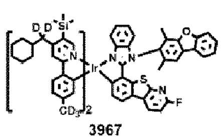
3967
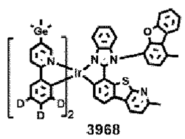
3968
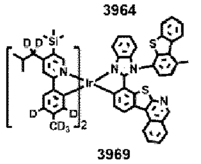
3969
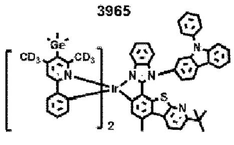
3970

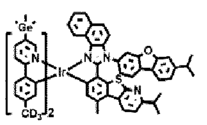
3971
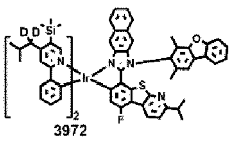
3972
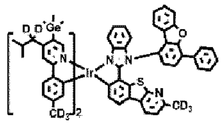
3973
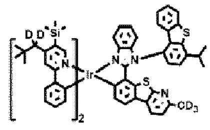
3974
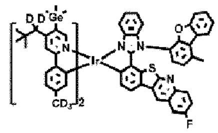
3975

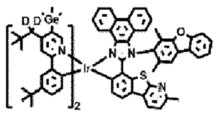
3976
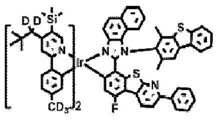
3977
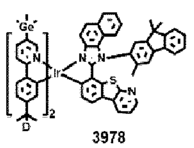
3978
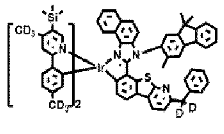
3979
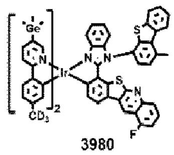
3980

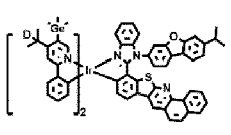
3981
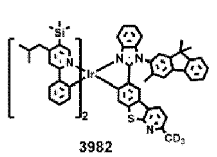
3982
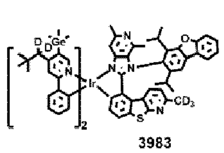
3983
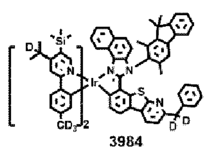
3984
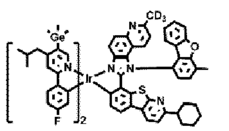
3985

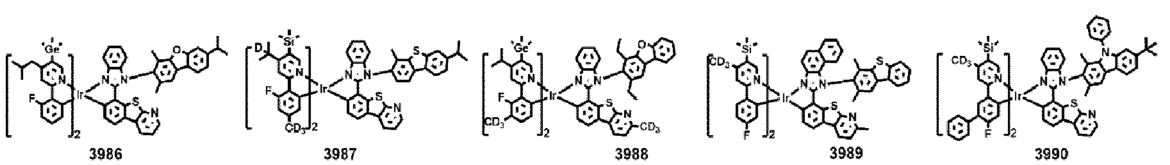
3986
3987
3988
3989
3990

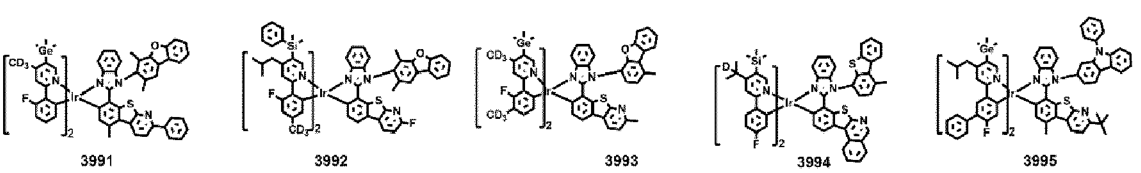
3991
3992
3993
3994
3995

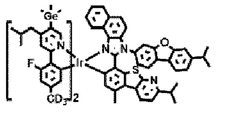
3996
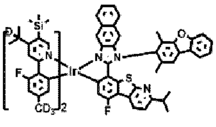
3997
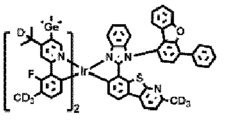
3998
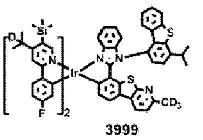
3999
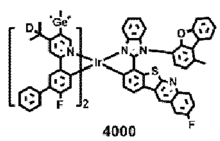
4000

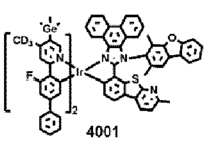
4001
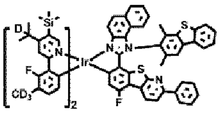
4002
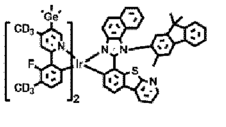
4003
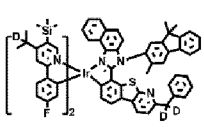
4004
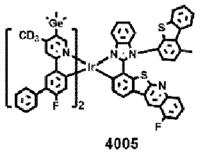
4005

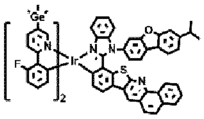
4006
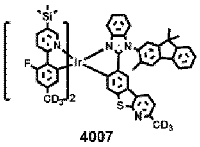
4007
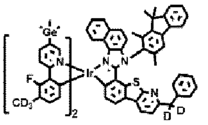
4008
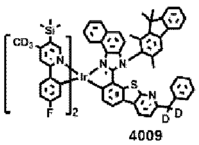
4009
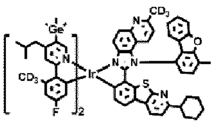
4010

In one or more embodiments, the first hole-transporting compound and the second hole-transporting compound may each independently be at least one of Compounds H1-1 to H1-72 of [Group 5-1], Compounds H1-1 to H1-20 of [Group 5-2], or a combination thereof:

Group 5-1

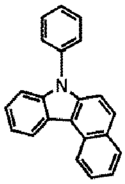
H1-1
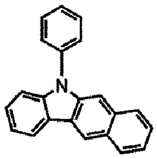
H1-2
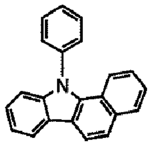
H1-3
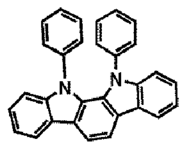
H1-4

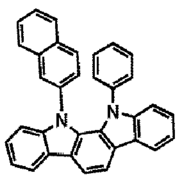
H1-5
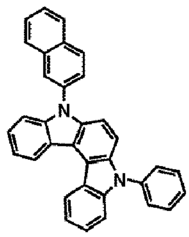
H1-6
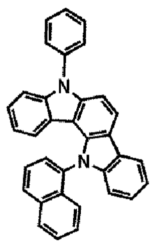
H1-7
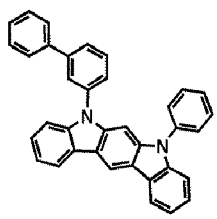
H1-8

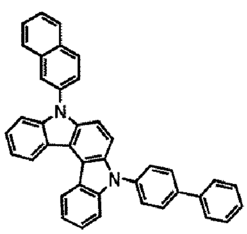
H1-9
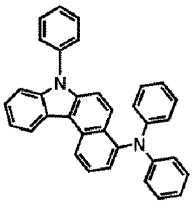
H1-10
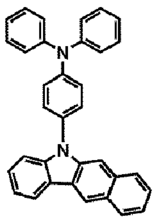
H1-11
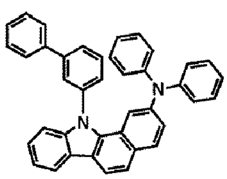
H1-12

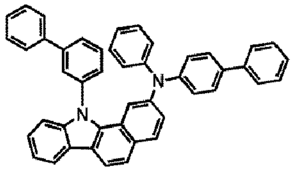

H1-13

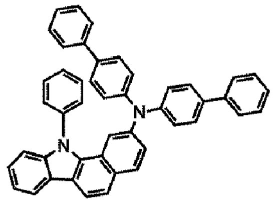

H1-14

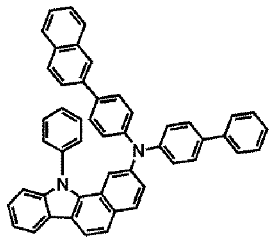

H1-15

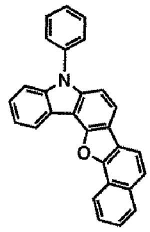

H1-16

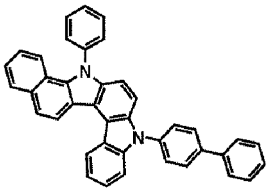

H1-17

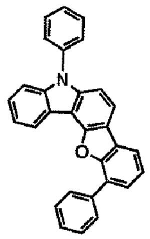

H1-18

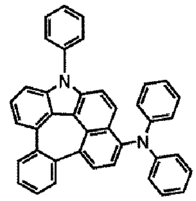

H1-19

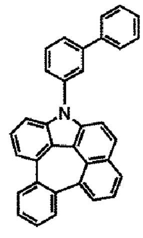

H1-20

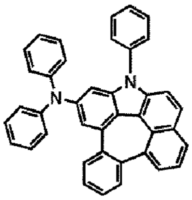

H1-21

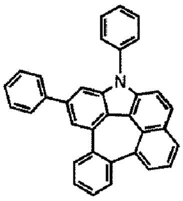

H1-22

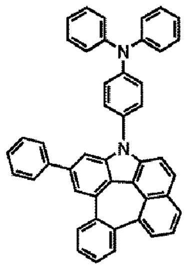

H1-23

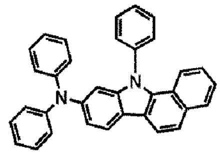

H1-24

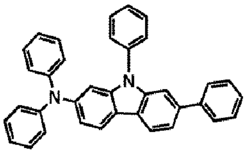

H1-25

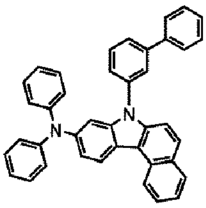

H1-26

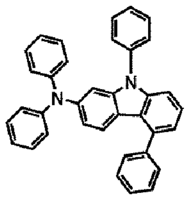

H1-27

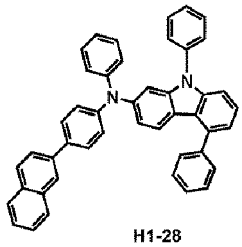

H1-28

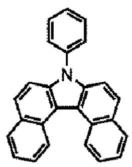

H1-29

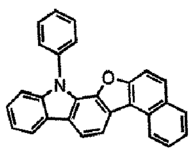

H1-30

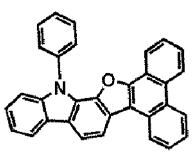

H1-31

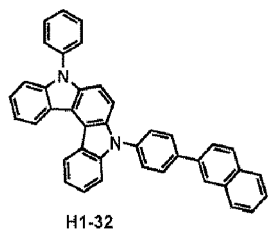

H1-32

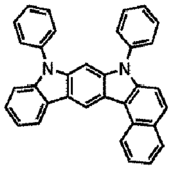
H1-33

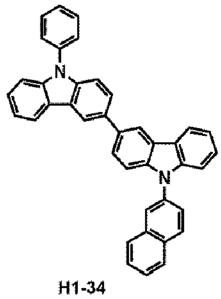
H1-34

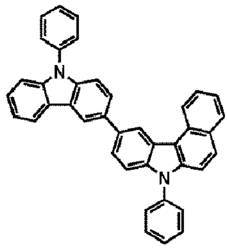
H1-35

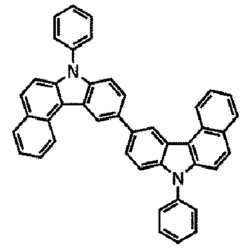
H1-36

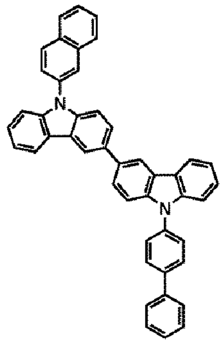
H1-37

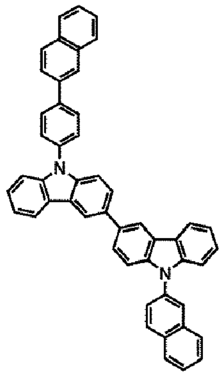
H1-38

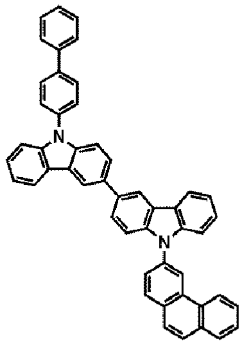
H1-39

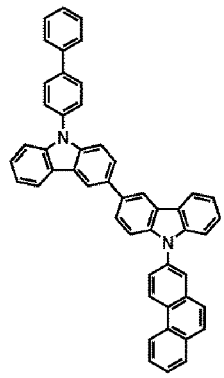
H1-40

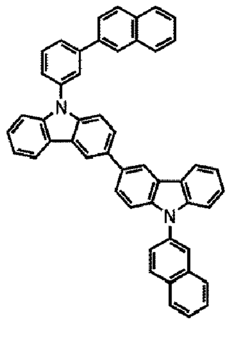
H1-41

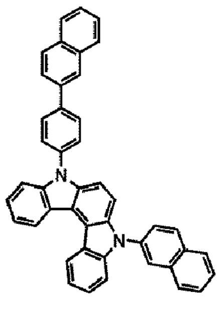
H1-42

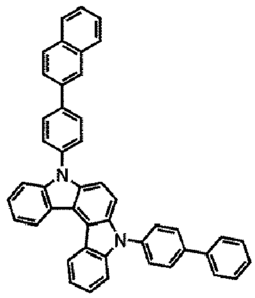
H1-43

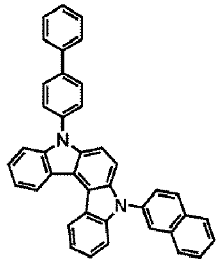
H1-44

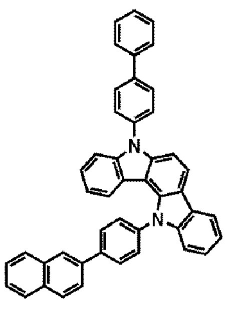
H1-45

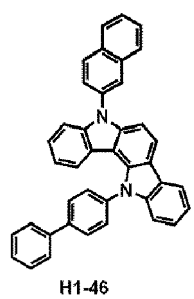
H1-46

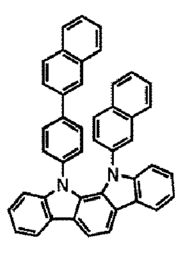
H1-47

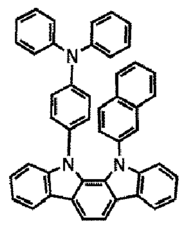
H1-48

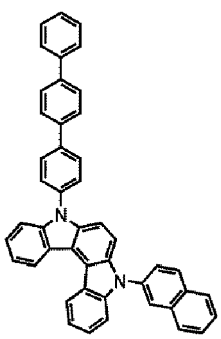

H1-49

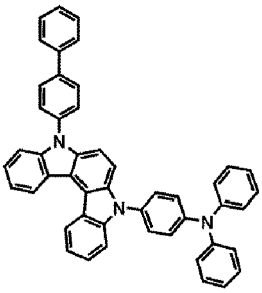

H1-50

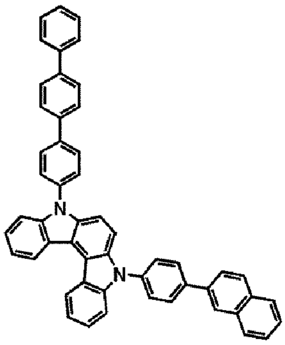

H1-51

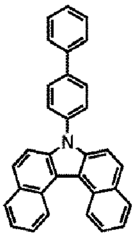

H1-52

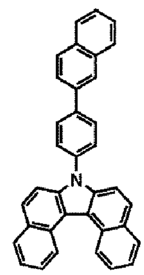

H1-53

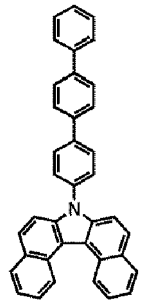

H1-54

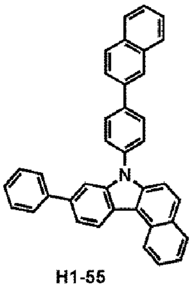

H1-55

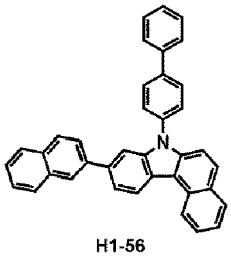

H1-56

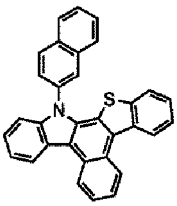

H1-57

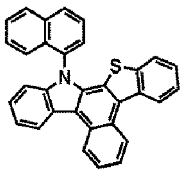

H1-58

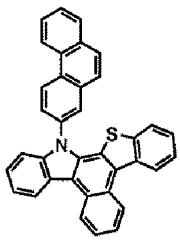

H1-59

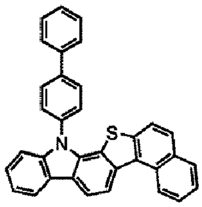

H1-60

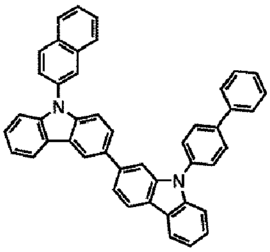

H1-61

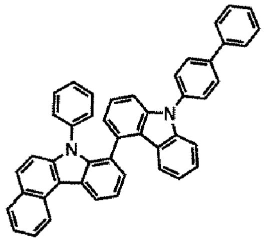

H1-62

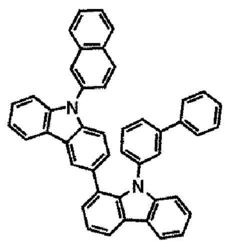

H1-63

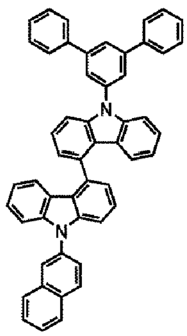

H1-64

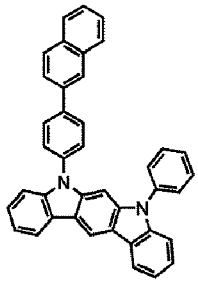
H1-65

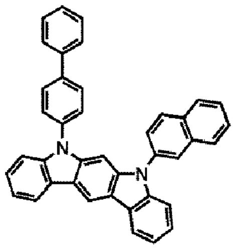
H1-66

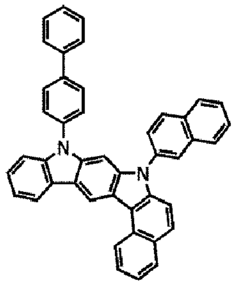
H1-67

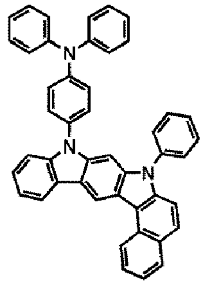
H1-68

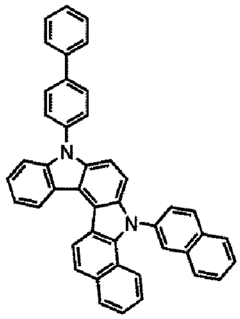
H1-69

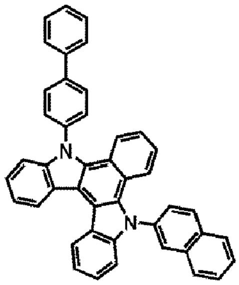
H1-70

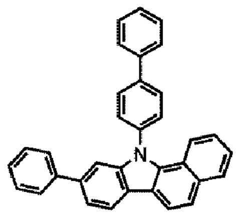
H1-71

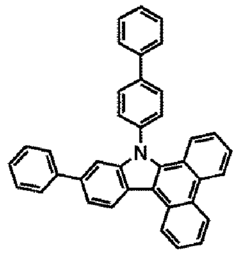
H1-72

Group 5-2

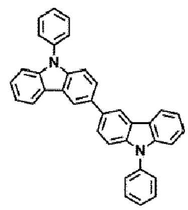
H1-1

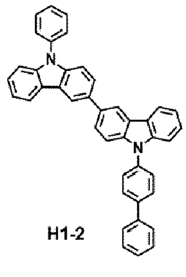
H1-2

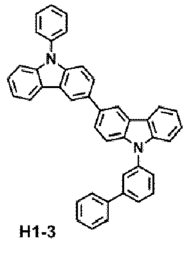
H1-3

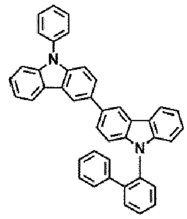
H1-4

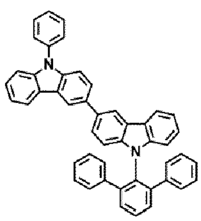
H1-5

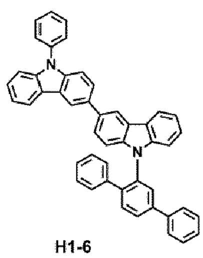
H1-6

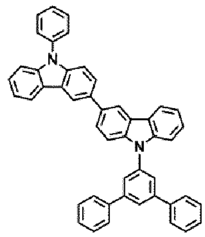
H1-7

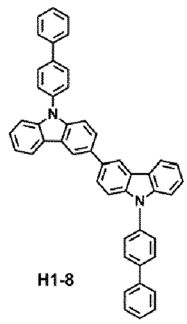
H1-8

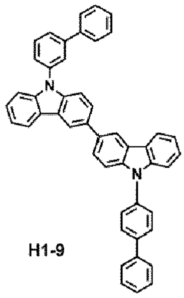
H1-9

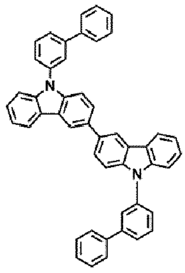
H1-10

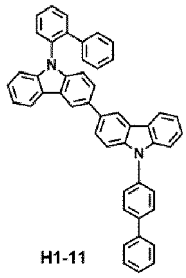
H1-11

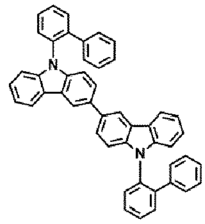
H1-12

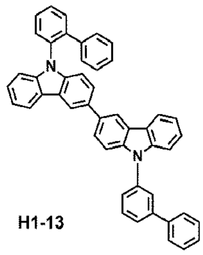
H1-13

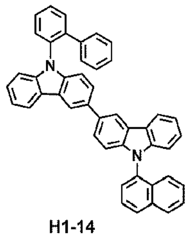
H1-14

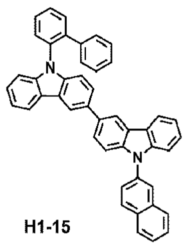
H1-15

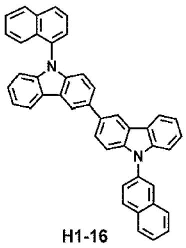
H1-16

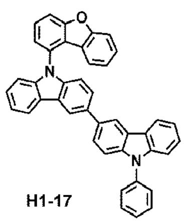
H1-17

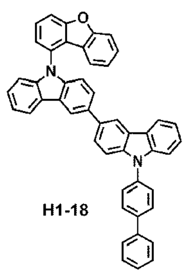
H1-18

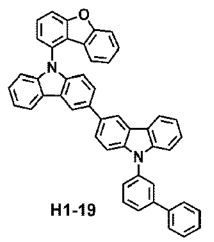
H1-19

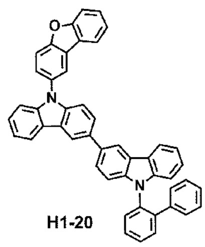
H1-20

In one or more embodiments, the first compound may be at least one of Compounds E1-1 to E1-62:

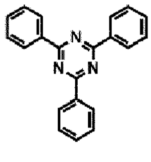
E1-1

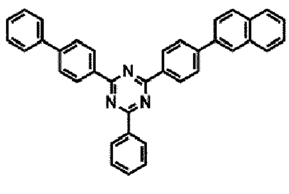
E1-2

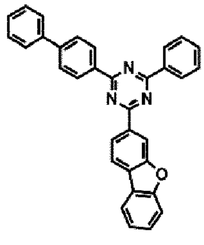
E1-3

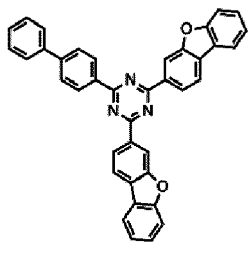
E1-4

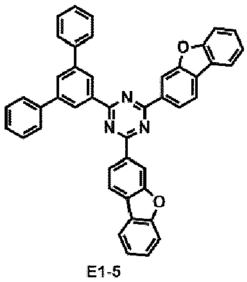
E1-5

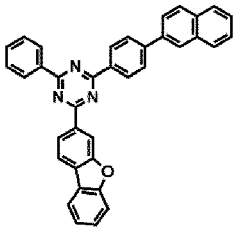
E1-6

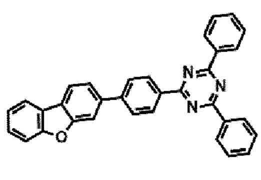
E1-7

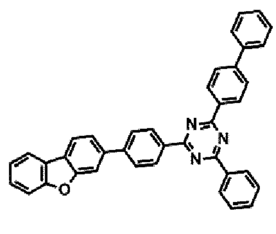
E1-8

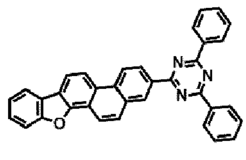
E1-9

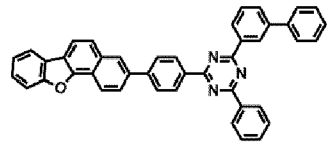
E1-10

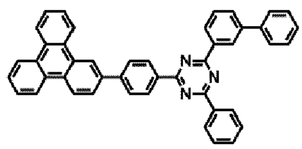
E1-11

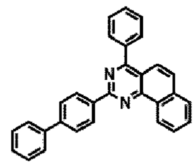
E1-12

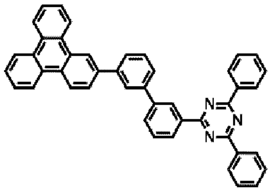
E1-13

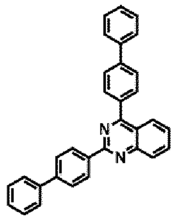
E1-14

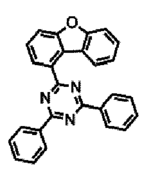
E1-15

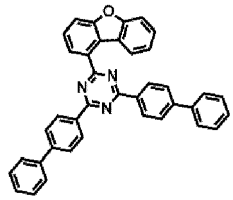
E1-16

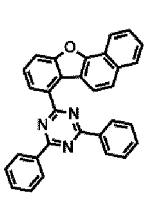
E1-17

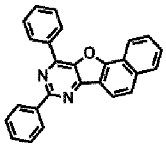
E1-18

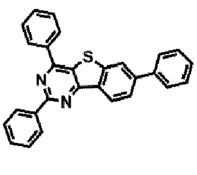
E1-19

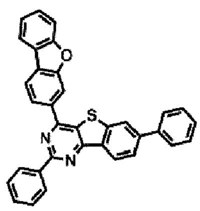
E1-20

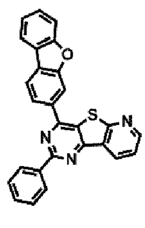
E1-21

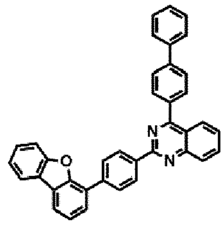
E1-22

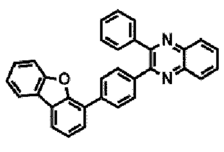
E1-23

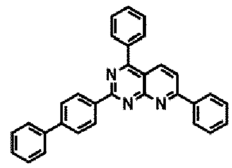
E1-24

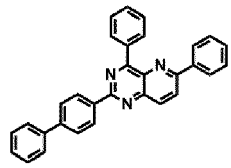
E1-25

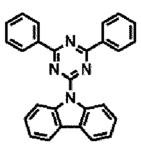
E1-26

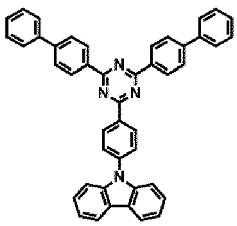
E1-27

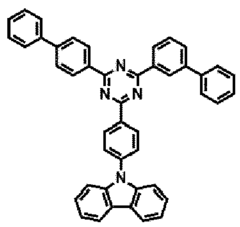
E1-28

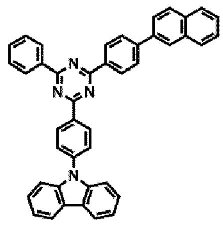
E1-29

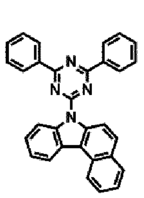
E1-30

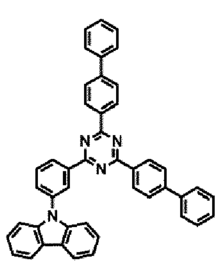
E1-31

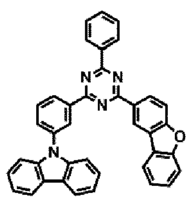
E1-32

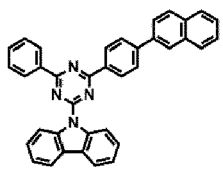
E1-33

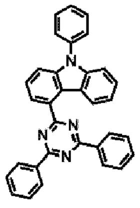

E1-34

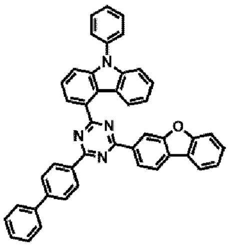

E1-35

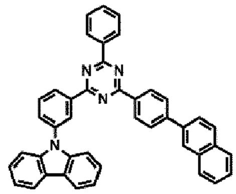

E1-36

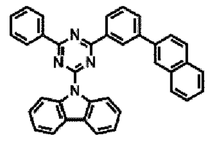

E1-37

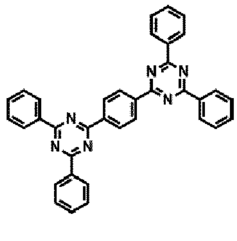

E1-38

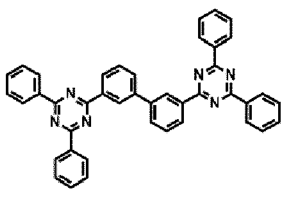

E1-39

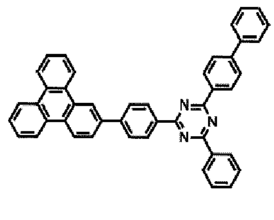

E1-40

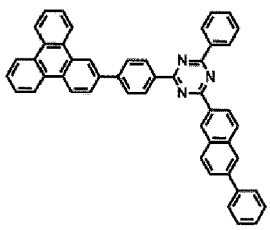

E1-41

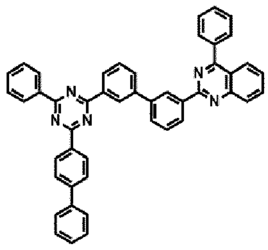

E1-42

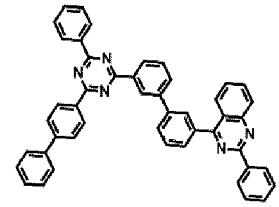

E1-43

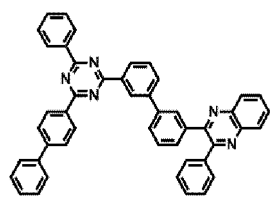

E1-44

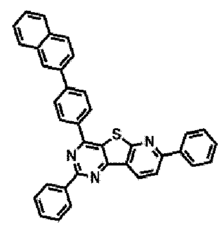

E1-45

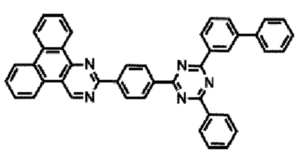

E1-46

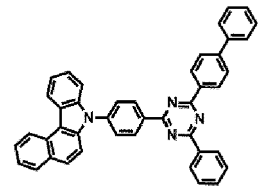

E1-47

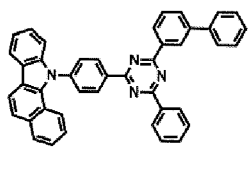

E1-48

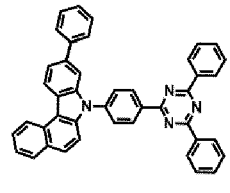

E1-49

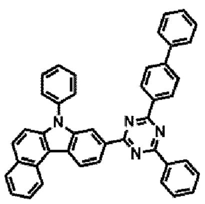

E1-50

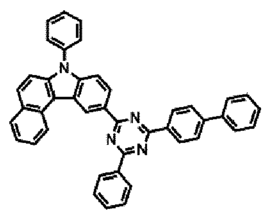

E1-51

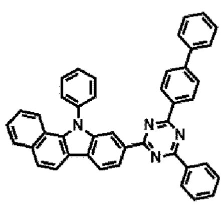

E1-52

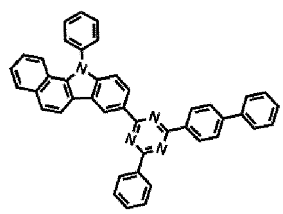

E1-53

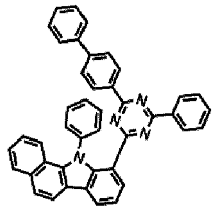

E1-54

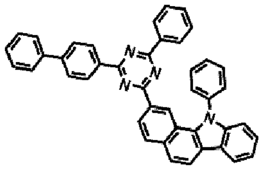

E1-55

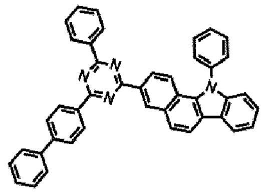

E1-56

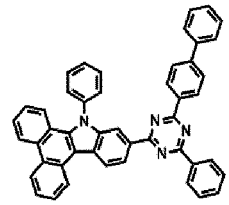

E1-57

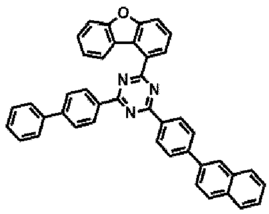

E1-58

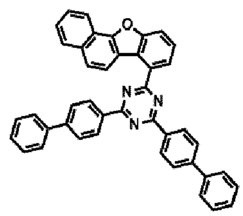

E1-59

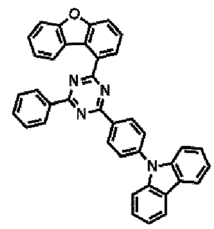

E1-60

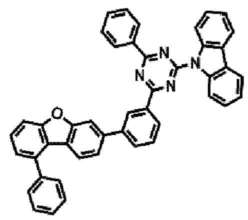

E1-61

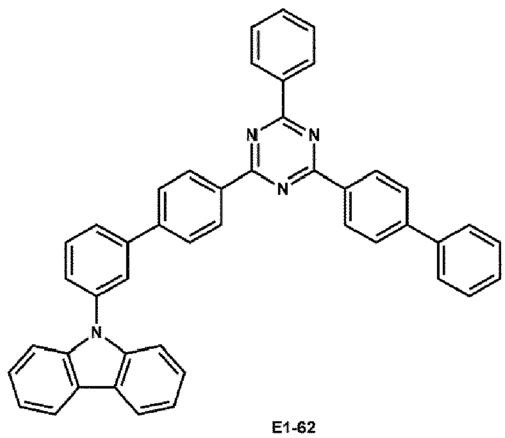

E1-62

In one or more embodiments, the second compound may be at least one of Compounds BP1-1 to BP1-17:

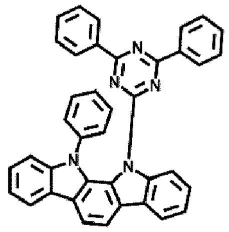

**BP1-1**

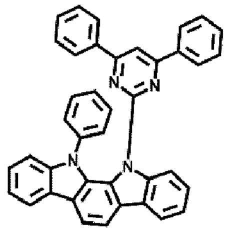

**BP1-2**

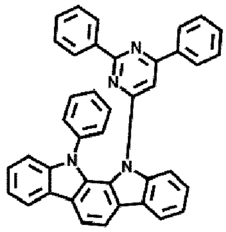

**BP1-3**

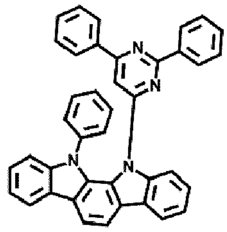

**BP1-4**

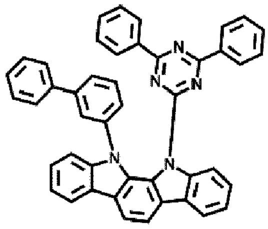

**BP1-5**

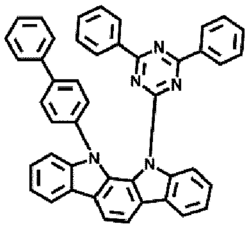

**BP1-6**

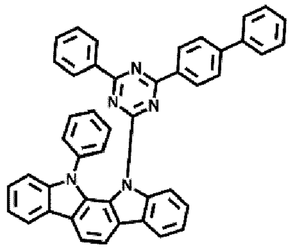

**BP1-7**

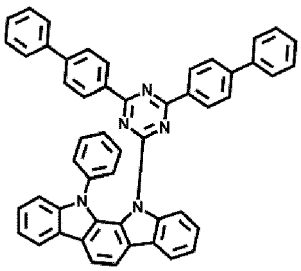

**BP1-8**

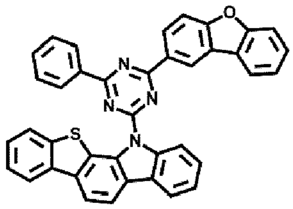

BP1-9

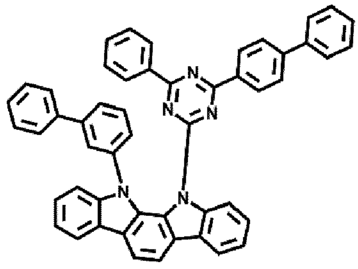

BP1-10

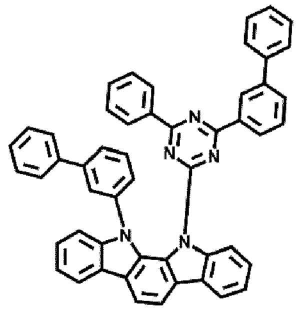

BP1-11

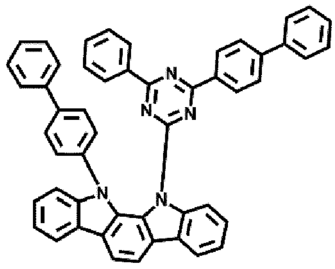

BP1-12

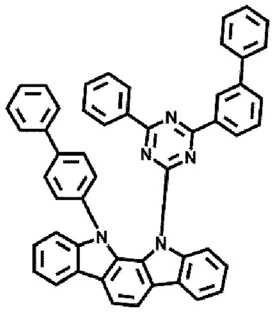

BP1-13

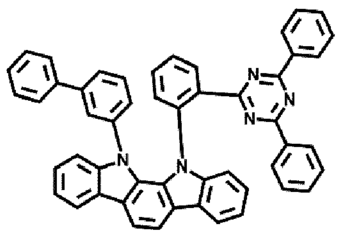

BP1-14

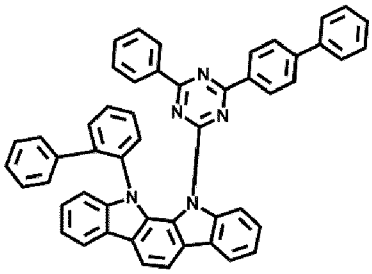

BP1-15

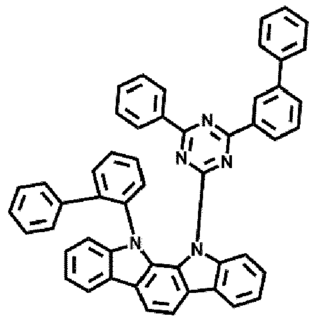

BP1-16

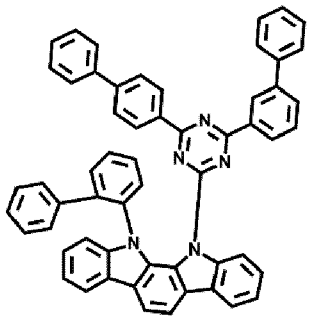

BP1-17

Description of FIG. 2

FIG. 2 schematically illustrates a cross-sectional view of an organic light-emitting device 10, which is a light-emitting device according to an embodiment. Hereinafter, the structure of an organic light-emitting device according to an embodiment of the present disclosure and a method of manufacturing an organic light-emitting device according to an embodiment of the present disclosure will be described in connection with FIG. 2.

The organic light-emitting device 10 of FIG. 2 includes a first electrode 11, a hole-transporting region 13, an emission layer 15, an electron-transporting region 17 and a second electrode 19, which are sequentially stacked. The emission layer 15 includes a first emission layer 15-1 and a second emission layer 15-2.

A substrate may be additionally located under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode 11 on the substrate. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide ($SnO_2$), or zinc oxide (ZnO). In one or more embodiments, the material for forming the first electrode 11 may be metal, such as magnesium (Mg), aluminum

(Al), aluminum-lithium (Al-Li), calcium (Ca), magnesium-indium (Mg-In), or magnesium-silver (Mg-Ag).

The first electrode 11 may have a single-layered structure or a multi-layered structure including two or more layers. For example, the first electrode 11 may have a three-layered structure of ITO/Ag/ITO, but the structure of the first electrode 11 is not limited thereto.

The hole-transporting region 13 may be located between the first electrode 11 and the emission layer 15.

The hole-transporting region 13 may include a hole injection layer, a hole-transporting layer, an electron-blocking layer, a buffer layer, or a combination thereof.

The hole-transporting region 13 may include only a hole injection layer or only a hole-transporting layer. In one or more embodiments, the hole-transporting region 13 may have a hole injection layer/hole-transporting layer structure or a hole injection layer/hole-transporting layer/electron-blocking layer structure, which are sequentially stacked in this stated order from the first electrode 11.

When the hole-transporting region 13 includes a hole injection layer, the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary depending on a material that is used to form the hole injection layer, and the structure and thermal characteristics of the hole injection layer. For example, the deposition conditions may include a deposition temperature of about 100 °C to about 500 °C, a vacuum pressure of about $10^{-8}$ torr to about $10^{-3}$ torr, and a deposition rate of about 0.01 Å/sec to about 100 Å/sec.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80 °C to about 200 °C. However, the coating conditions are not limited thereto.

The conditions for forming the hole-transporting layer and the electron-blocking layer may be the same as the conditions for forming the hole injection layer.

The hole-transporting region 13 may include m-MTDATA, TDATA, 2-TNATA, NPB, β-NPB, TPD, Spiro-TPD, Spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonicacid (PANI/CSA), polyaniline/poly(4-styrenesulfonate) (PANI/PSS), a compound represented by Formula 201 below, a compound represented by Formula 202 below, or any combination thereof:

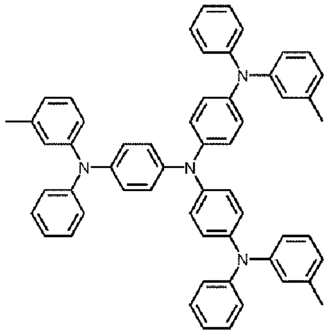

m-MTDATA

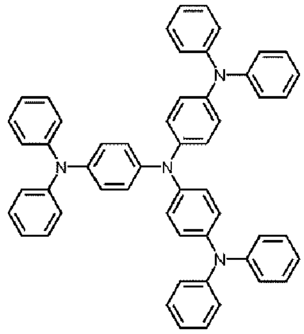

TDATA

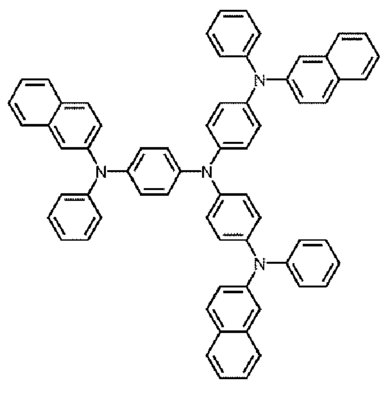

2-TNATA

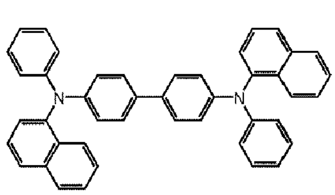

NPB

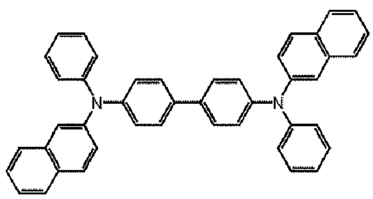

β-NPB

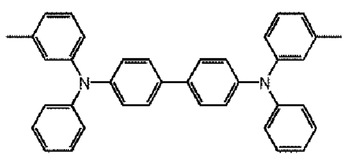

TPD

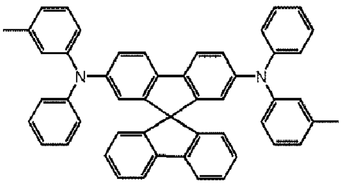

Spiro-TPD

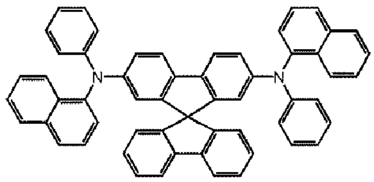

Spiro-NPB

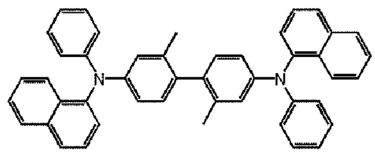

methylated NPB

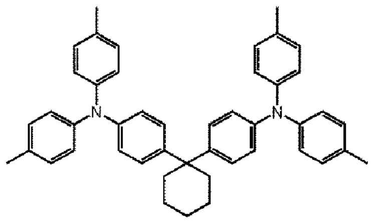

TAPC

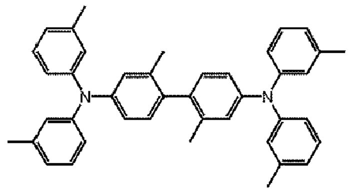

HMTPD

Formula 201

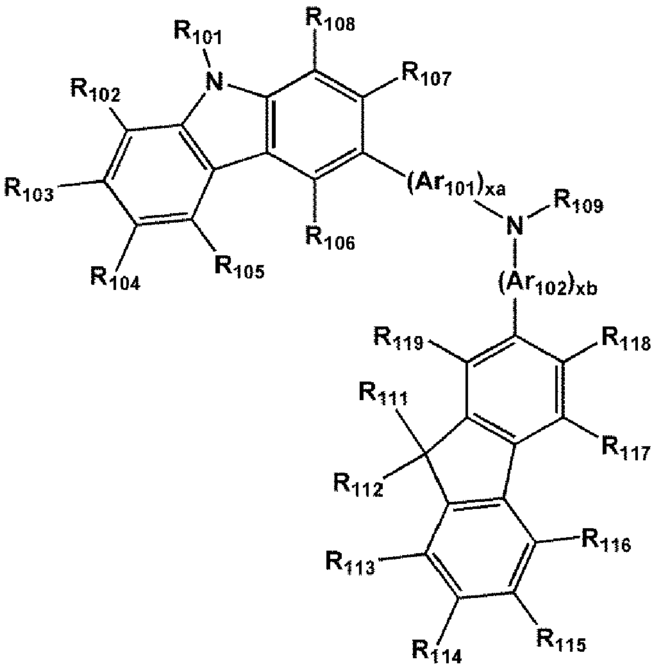

Formula 202

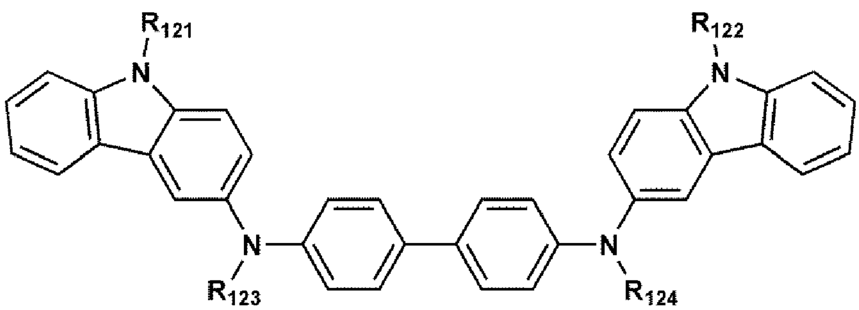

$Ar_{101}$ and $Ar_{102}$ in Formula 201 may each independently be a phenylene group, a pentalenylene group, an

indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_6$-$C_{60}$ aryloxy group, a $C_6$-$C_{60}$ arylthio group, a $C_1$-$C_{60}$ heteroaryl group, a monovalent non-aromatic condensed polycyclic group, a monovalent non-aromatic condensed heteropolycyclic group, or any combination thereof.

xa and xb in Formula 201 may each independently be an integer from 0 to 5, or 0, 1, or 2. For example, xa may be 1 and xb may be 0, but xa and xb are not limited thereto.

$R_{101}$ to $R_{108}$, $R_{111}$ to $R_{119}$ and $R_{121}$ to $R_{124}$ in Formulae 201 and 202 may each independently be:

hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, pentyl group, a hexyl group, or the like) or a $C_1$-$C_{10}$ alkoxy group (for example, a methoxy group, an ethoxy group, a propoxy group, a butoxy group, a pentoxy group, or the like);

a $C_1$-$C_{10}$ alkyl group or a $C_1$-$C_{10}$ alkoxy group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or any combination thereof; or

a phenyl group, a naphthyl group, an anthracenyl group, a fluorenyl group or a pyrenyl group, each unsubstituted or substituted with deuterium, - F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, or any combination thereof.

$R_{109}$ in Formula 201 may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a phenyl group, a naphthyl group, an anthracenyl group, a pyridinyl group, or any combination thereof.

In one or more embodiments, the compound represented by Formula 201 may be represented by Formula 201A:

Formula 201A

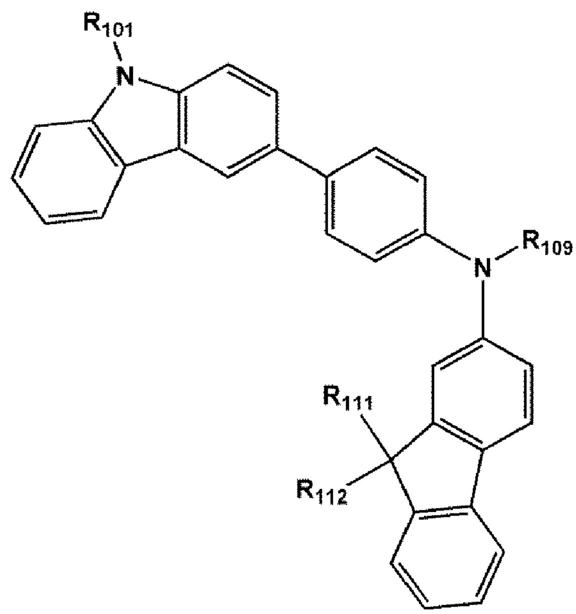

$R_{101}$, $R_{111}$, $R_{112}$, and $R_{109}$ in Formula 201A may be understood by referring to the description provided herein.

For example, the hole-transporting region 13 may include one of Compounds HT1 to HT20 or any combination thereof:

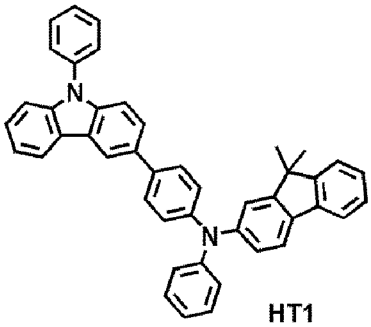
HT1

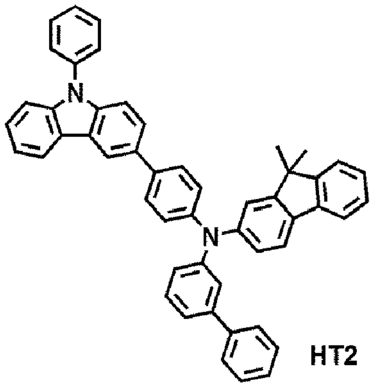
HT2

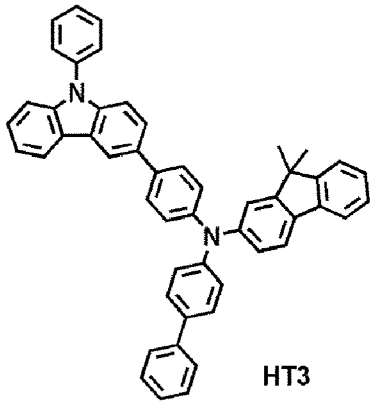
HT3

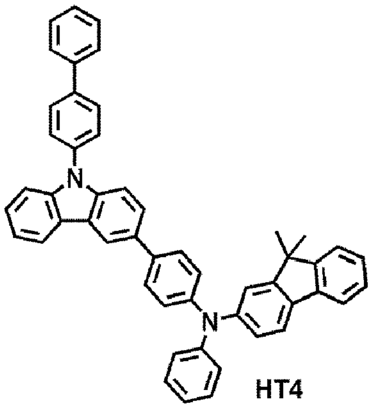
HT4

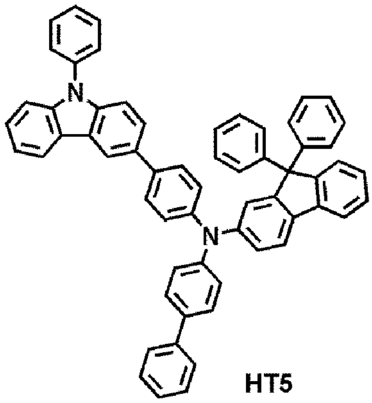
HT5

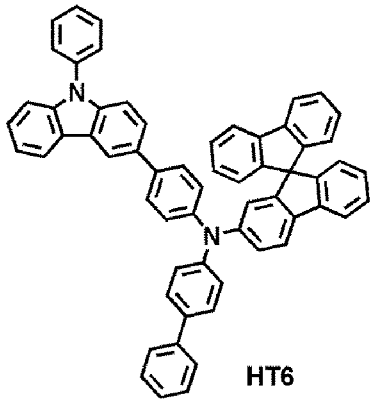
HT6

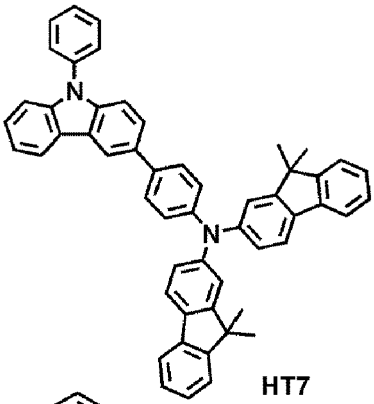

HT7

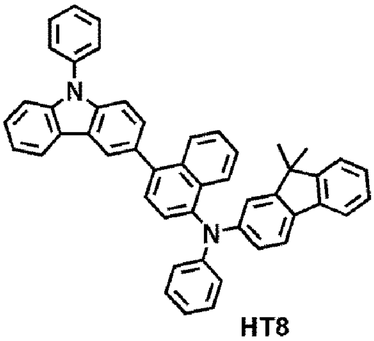

HT8

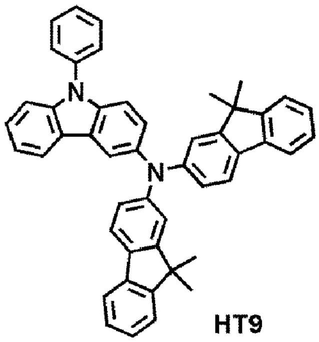

HT9

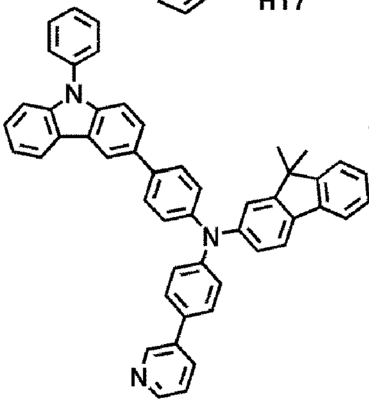

HT10

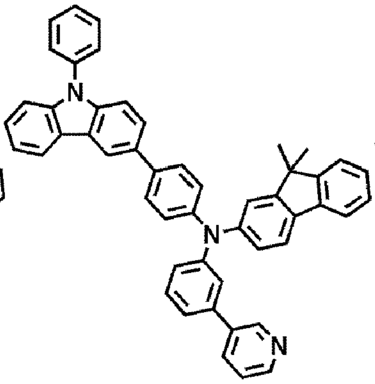

HT11

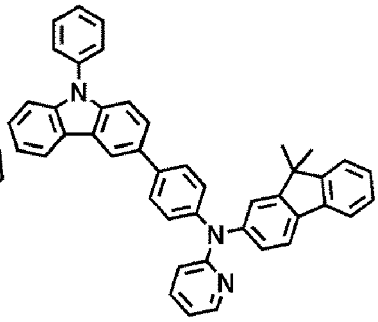

HT12

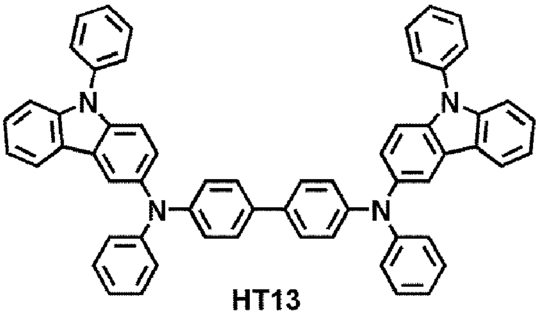

HT13

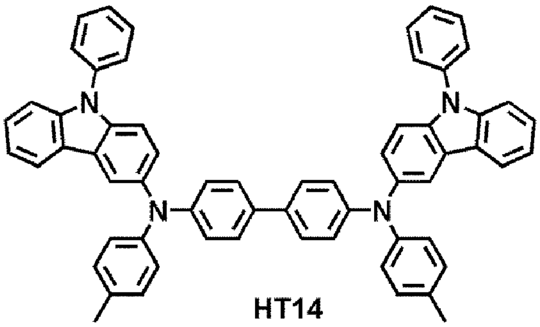

HT14

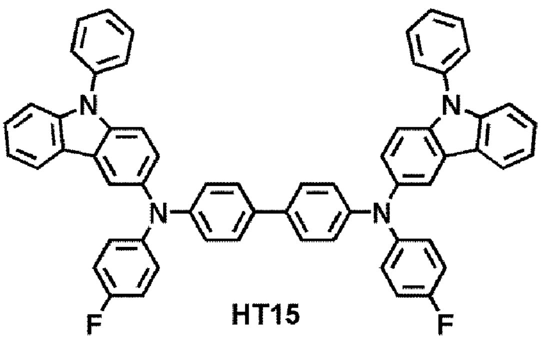

HT15

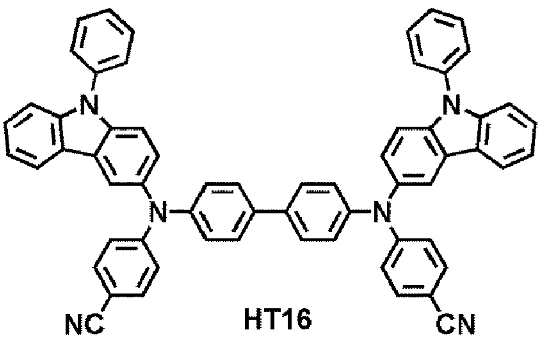

HT16

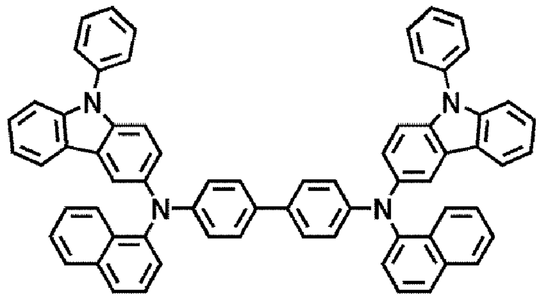

HT17

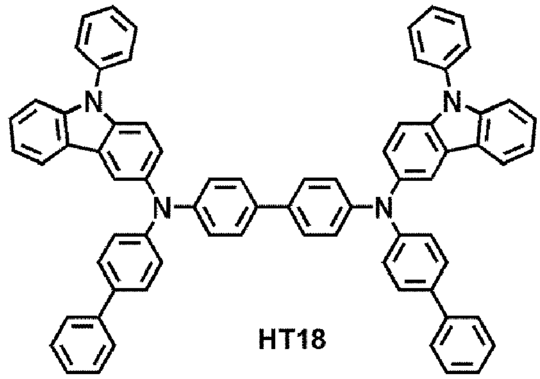

HT18

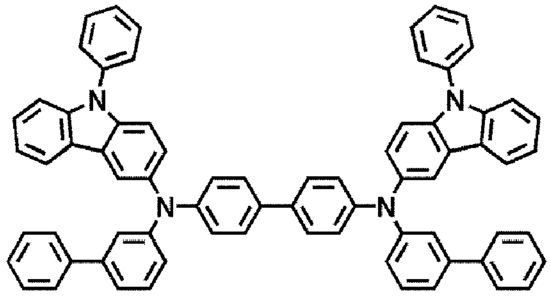

HT19

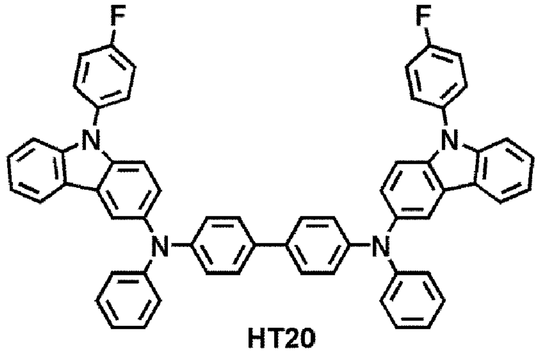

HT20

The thickness of the hole-transporting region 13 may be from about 100 Å to about 10000 Å, for example about 100 Å to about 1000 Å. When the hole-transporting region 13 includes a hole injection layer, a hole-transporting layer, an electron-blocking layer or a combination thereof, the thickness of the hole injection layer may be in a range of about 100 Å to about 10,000 Å, for example, about 100 Å to about 1,000 Å, and a thickness of the hole-transporting layer may be in a range of about 50 Å to about 2,000 Å, for example, about 100 Å to about 1,500 Å. When the thicknesses of the hole-transporting region, the hole injection layer and the hole-transporting layer are within these ranges, satisfactory hole-transporting characteristics may be obtained without a substantial increase in driving voltage.

In addition to the above-described materials, the hole-transporting region 13 may further include a charge-generation material to improve conductivity. The charge-generation material may be homogeneously or non-homogeneously dispersed in the hole-transporting region.

The charge-generation material may be, for example, a p-dopant. The p-dopant may include a quinone derivative, a metal oxide, a cyano group-containing compound, or any combination thereof. For example, the p-dopant may be: a quinone derivative such as tetracyanoquinonedimethane (TCNQ), 2,3,5,6-tetrafluoro-tetracyano-1,4-benzoquinonedimethane (F4-TCNQ), or F6-TCNNQ; metal oxide, such as tungsten oxide and molybdenum oxide; a cyano group-containing compound, such as Compound HT-D1; or any combination thereof.

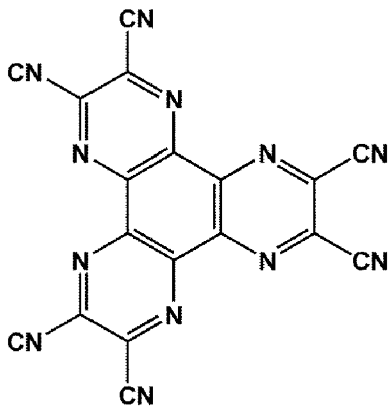

HT-D1

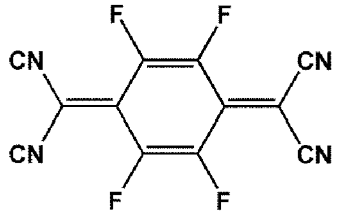

F4-TCNQ

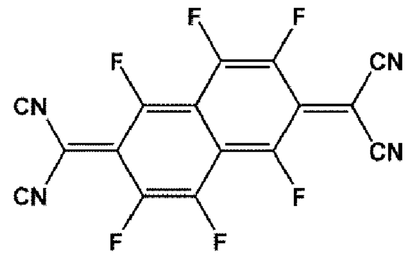

F6-TCNNQ

The hole-transporting region 13 may further include a buffer layer.

Also, the buffer layer may compensate for an optical resonance distance according to a wavelength of light emitted from the emission layer, and thus, efficiency of a formed organic light-emitting device may be improved.

Meanwhile, when the hole-transporting region 13 includes an electron-blocking layer, the material for the electron-blocking layer may include a material that can be used in the hole-transporting region 13 as described above, a host material, or a combination thereof. For example, when the hole-transporting region includes an electron-blocking layer, mCP, Compound H1-8 of [Group 5-2], or the like may be used as a material for the electron-blocking layer.

The emission layer 15 may be formed on the hole-transporting region 13 by using, for example, a vacuum deposition method, a spin coating method, a cast method, or an LB method. When the emission layer 15 is formed by vacuum deposition or spin coating, the deposition or coating conditions may be similar to those applied in forming the hole injection layer although the deposition or coating conditions may vary depending on a material that is used to form the emission layer.

The emission layer 15 may include a first emission layer 15-1 and a second emission layer 15-2 as described herein.

The amount (weight) of the dopant in the first emission layer 15-1 may be from about 0.01 to about 20 parts by weight based on 100 parts by weight, which is the total weight of the first hole-transporting compound and the first compound.

The amount (weight) of the dopant in the second emission layer 15-2 may be from about 0.01 to about 20 parts by weight based on 100 parts by weight, which is the total weight of the second hole-transporting compound and the second compound.

A thickness of the emission layer 15 may be in a range of about 100 Å to about 1,000 Å, for example, about 200 Å to about 600 Å. When the thickness of the emission layer 15 is within these ranges, excellent light-emission characteristics may be obtained without a substantial increase in driving voltage.

Next, the electron-transporting region 17 may be located on the emission layer 15.

The electron-transporting region 17 may include a hole-blocking layer, an electron-transporting layer, an electron injection layer, or a combination thereof.

For example, the electron-transporting region 17 may have a hole-blocking layer/electron-transporting layer/electron injection layer structure or an electron-transporting layer/electron injection layer structure. The electron-transporting layer may have a single-layered structure or a multi-layered structure including two or more different materials.

The conditions for the formation of the hole-blocking layer, the electron-transporting layer and the electron injection layer in the electron-transporting region 17 are the same as the conditions for the formation of the hole injection layer.

When the electron-transporting region 17 includes a hole-blocking layer, the hole-blocking layer may include, for example, at least one of the following BCP, Bphen and BAlq.

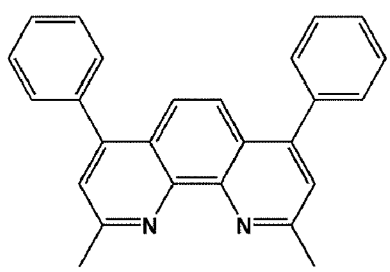

BCP

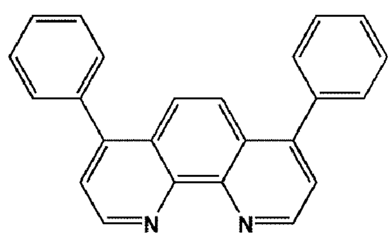

Bphen

In one or more embodiments, the hole-blocking layer may include any host material, and a material for an electron-transporting layer, a material for an electron injection layer, or a combination thereof, which will be described later.

A thickness of the hole-blocking layer may be in a range of about 20 Å to about 1,000 Å, for example, about 30 Å to about 300 Å. When the thickness of the hole-blocking layer is within these ranges, excellent hole-blocking characteristics can be obtained without a substantial increase in driving voltage.

The electron-transporting layer may include BCP, Bphen, TPBi, $Alq_3$, Balq, TAZ, NTAZ, or any combination thereof:

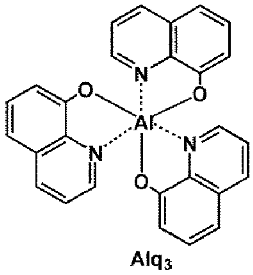

$Alq_3$

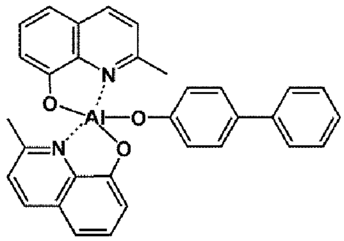

BAlq

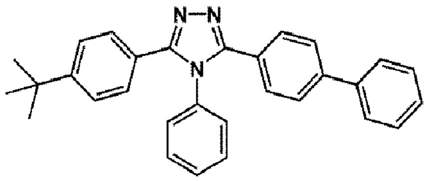

TAZ

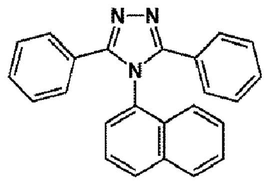

NTAZ

In one or more embodiments, the electron-transporting layer may include at least one of Compounds ET1 to ET25.

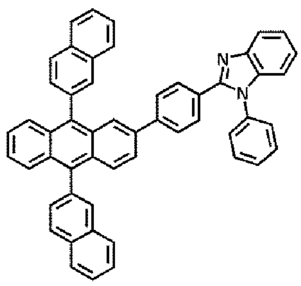

ET1

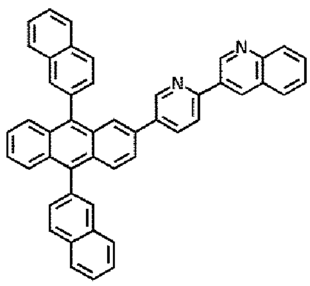

ET2

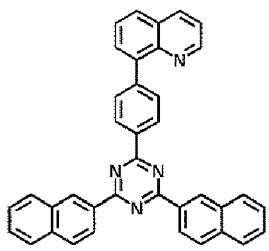

ET3

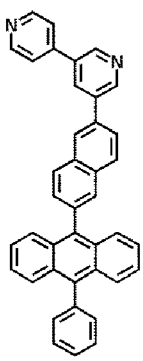

ET4

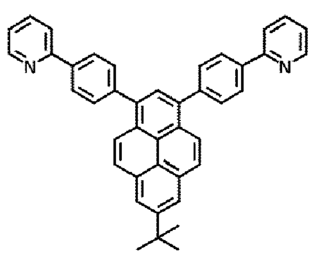

ET5

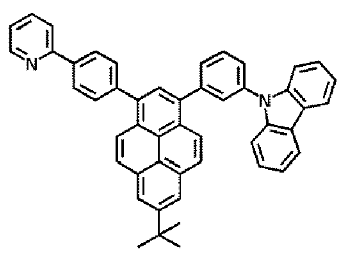

ET6

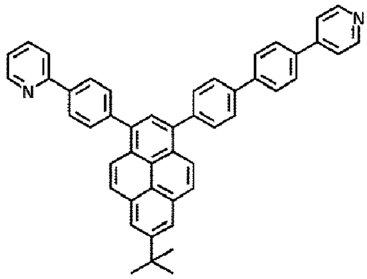

ET7

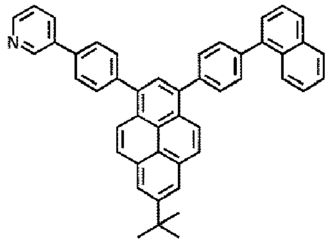

ET8

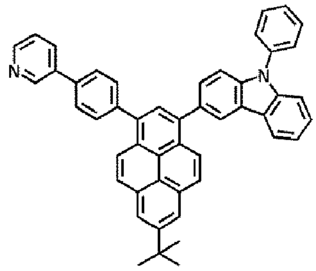

ET9

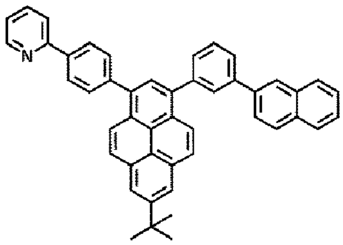

ET10

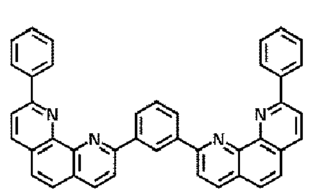

ET11

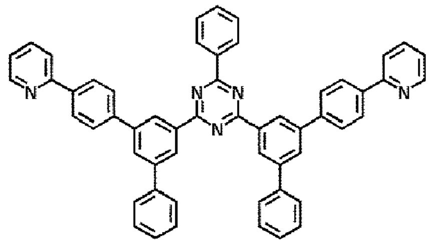

ET12

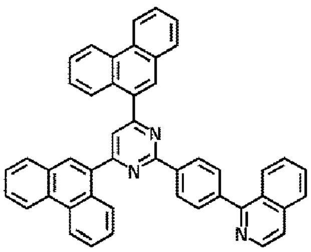

ET13

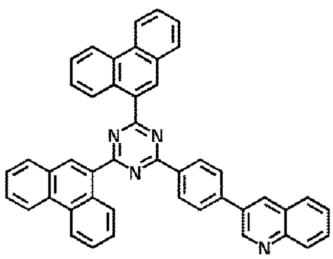

ET14

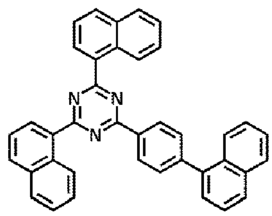

ET15

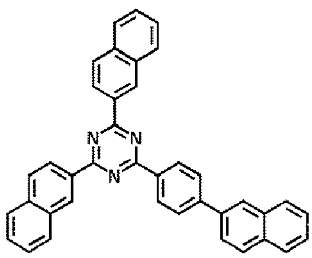

ET16

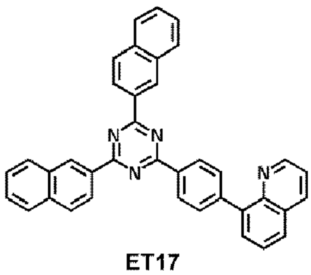

ET17

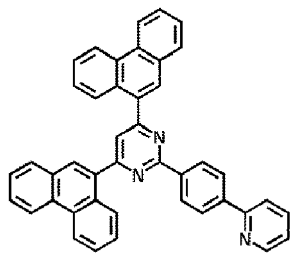

ET18

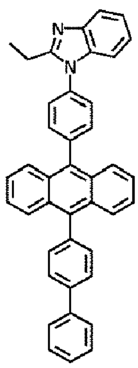

ET19

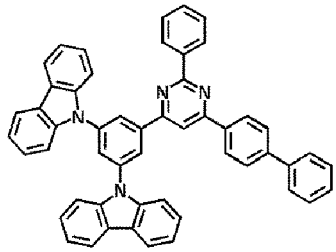

ET20

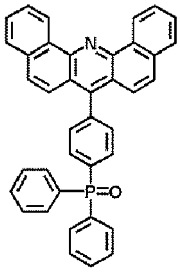

ET21

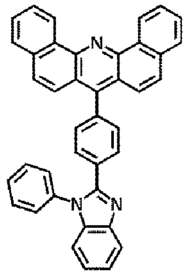

ET22

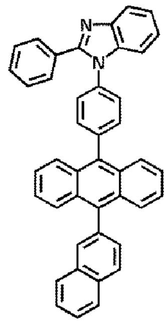

ET23

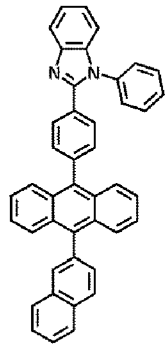

ET24

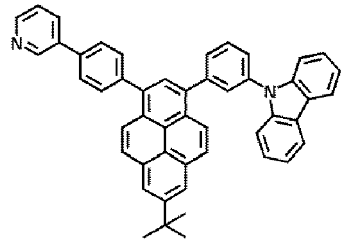

ET25

A thickness of the electron-transporting layer may be in the range of about 100 Å to about 1,000 Å, for example, about 150 Å to about 500 Å. When the thickness of the electron-transporting layer is within the range described above, the electron-transporting layer may have satisfactory electron-transporting characteristics without a substantial increase in driving voltage.

The electron-transporting layer may include a metal-containing material in addition to the material as described above.

The metal-containing material may include a Li complex. The Li complex may include, for example, Compound ET-D1 or ET-D2:

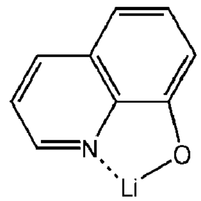

ET-D1

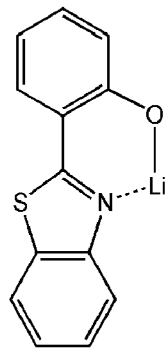

ET-D2

In one or more embodiments, the electron-transporting region 17 may include an electron injection layer (EIL) that facilitates injection of electrons from the second electrode 19.

The electron injection layer may include LiF, NaCl, CsF, $Li_2O$, BaO, or any combination thereof.

A thickness of the electron injection layer may be in a range of about 1 Å to about 100 Å, and, for example, about 3 Å to about 90 Å. When the thickness of the electron injection layer is within the range described above, the electron injection layer may have satisfactory electron injection characteristics without a substantial increase in driving voltage.

A second electrode 19 may be provided on the electron-transporting region 17. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to FIG. 2, but embodiments of the present disclosure are not limited thereto.

According to another aspect, the light-emitting device may be included in an electronic apparatus. Thus, an electronic apparatus including the light-emitting device is provided. The electronic apparatus may include, for example, a display, an illumination, a sensor, and the like.

The term "$C_1$-$C_{60}$ alkyl group" as used herein refers to a linear or branched saturated aliphatic hydrocarbons monovalent group having 1 to 60 carbon atoms, and the term "$C_1$-$C_{60}$ alkylene group" as used herein refers to a divalent group having the same structure as the $C_1$-$C_{60}$ alkyl group.

Examples of the $C_1$-$C_{60}$ alkyl group, the $C_1$-$C_{20}$ alkyl group, and/or the $C_1$-$C_{10}$ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or any combination thereof. For example, Formula 9-33 is a branched $C_6$ alkyl group, for example, a tert-butyl group that is substituted with two methyl groups.

The term "$C_1$-$C_{60}$ alkoxy group" used herein refers to a monovalent group represented by $-OA_{101}$ (wherein $A_{101}$ is the $C_1$-$C_{60}$ alkyl group), and examples thereof are a methoxy group, an ethoxy group, a propoxy group, a butoxy group, and a pentoxy group.

The term "$C_2$-$C_{60}$ alkenyl group" as used herein refers to a hydrocarbon group formed by substituting at least one carbon-carbon double bond in the middle or at the terminus of the $C_2$-$C_{60}$ alkyl group, and examples thereof include an ethenyl group, a propenyl group, and a butenyl group. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and examples thereof include an ethynyl group, and a propynyl group. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon cyclic group having 3 to 10 carbon atoms, and the $C_3$-$C_{10}$ cycloalkylene group is a divalent group having the same structure as the $C_3$-$C_{10}$ cycloalkyl group.

Examples of the $C_3$-$C_{10}$ cycloalkyl group are a cyclopropyl group, a cyclobutyl group, a cyclopentyl, cyclohexyl group, a cycloheptyl group, a cyclooctyl group, an adamantanyl group, a norbornanyl group (or a bicyclo[2.2.1]heptyl group), a bicyclo[1.1.1]pentyl group, a bicyclo[2.1.1]hexyl group, and a bicyclo[2.2.2]octyl group.

The term "$C_1$-$C_{10}$ heterocycloalkyl group" as used herein refers to a monocyclic group that includes at least one hetero atom selected from N, O, P, Si, S, Se, Ge, and B as a ring-forming atom and 1 to 10 carbon atoms, and the $C_1$-$C_{10}$ heterocycloalkylene group refers to a divalent group having the same structure as the $C_1$-$C_{10}$ heterocycloalkyl group.

Examples of the $C_1$-$C_{10}$ heterocycloalkyl group are a silolanyl group, a silinanyl group, tetrahydrofuranyl group, a tetrahydro-2H-pyranyl group, and a tetrahydrothiophenyl group.

The term "$C_3$-$C_{10}$ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent monocyclic group that has at least one hetero atom selected from N, O, P, Si, S, Se, Ge, and B as a ring-forming atom, 1 to 10 carbon atoms, and at least one carbon-carbon double bond in its ring. Examples of the $C_1$-$C_{10}$ heterocycloalkenyl group are a 2,3-dihydrofuranyl group, and a 2,3-dihydrothiophenyl group. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic system having 6 to 60 carbon atoms, and the term "$C_6$-$C_{60}$ arylene group" as used herein refers to a divalent group having a carbocyclic aromatic system having 6 to 60 carbon atoms. Examples of the $C_6$-$C_{60}$ aryl group include a phenyl group, a naphthyl group, an anthracenyl group, a phenanthrenyl group, a pyrenyl group, and a chrysenyl group. When the $C_6$-$C_{60}$ aryl group and the $C_6$-$C_{60}$ arylene group each include two or more rings, the rings may be fused to each other.

The $C_7$-$C_{60}$ alkylaryl group used herein refers to a $C_6$-$C_{60}$ aryl group substituted with at least one $C_1$-$C_{60}$ alkyl group.

The term "$C_1$-$C_{60}$ heteroaryl group" as used herein refers to a monovalent group having at least one hetero atom selected from N, O, P, Si, S, Se, Ge, and B as a ring-forming atom and a cyclic aromatic system having 1 to 60 carbon atoms, and the term "$C_1$-$C_{60}$ heteroarylene group" as used herein refers to a divalent group having at least one hetero atom selected from N, O, P, Si, S, Se, Ge, and B as a ring-forming atom and a carbocyclic aromatic system

having 1 to 60 carbon atoms. Examples of the $C_1$-$C_{60}$ heteroaryl group include a pyridinyl group, a pyrimidinyl group, a pyrazinyl group, a pyridazinyl group, a triazinyl group, a quinolinyl group, and an isoquinolinyl group. When the $C_6$-$C_{60}$ heteroaryl group and the $C_6$-$C_{60}$ heteroarylene group each include two or more rings, the rings may be fused to each other.

The $C_2$-$C_{60}$ alkylheteroaryl group used herein refers to a $C_1$-$C_{60}$ heteroaryl group substituted with at least one $C_1$-$C_{60}$ alkyl group.

The term "$C_6$-$C_{60}$ aryloxy group" as used herein indicates -$OA_{102}$ (wherein $A_{102}$ indicates the $C_6$-$C_{60}$ aryl group), the $C_6$-$C_{60}$ arylthio group indicates -$SA_{103}$ (wherein $A_{103}$ indicates the $C_6$-$C_{60}$ aryl group), and the $C_1$-$C_{60}$ alkylthio group indicates -$SA_{104}$ (wherein $A_{104}$ indicates the $C_1$-$C_{60}$ alkyl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as a monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, at least one heteroatom selected from N, O, P, Si, S, Se, Ge, and B, other than carbon atoms, as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as a monovalent non-aromatic heterocondensed polycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group. Examples of the "$C_5$-$C_{30}$ carbocyclic group (unsubstituted or substituted with at least one $R_{10a}$)" used herein are an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, and a fluorene group (each unsubstituted or substituted with at least one $R_{10a}$).

The term "$C_1$-$C_{30}$ heterocyclic group" as used herein refers to a saturated or unsaturated cyclic group having, as a ring-forming atom, at least one heteroatom selected from N, O, P, Si, S, Se, Ge, and B other than 1 to 30 carbon atoms. The $C_1$-$C_{30}$ heterocyclic group may be a monocyclic group or a polycyclic group. The "$C_1$-$C_{30}$ heterocyclic group (unsubstituted or substituted with at least one $R_{10a}$)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one $R_{10a}$).

In one or more embodiments, examples of the "$C_5$-$C_{30}$ carbocyclic group" and "$C_1$-$C_{30}$ heterocyclic group" used herein include i) a third ring, ii) a fourth ring, iii) a condensed ring in which two or more third rings are condensed with each other, iv) a condensed ring in which two or more fourth rings are condensed with each other, or v) a condensed ring in which at least one third ring is condensed with at least one fourth ring,

the third ring may be a cyclopentane group, a cyclopentene group, a furan group, a thiophene group, a pyrrole group, a silole group, a borole group, a phosphole group, a germole group, a selenophene group, an oxazole group, an oxadiazole group, an oxatriazole group, a thiazole group, a thiadiazole group, a thiatriazole group, a pyrazole group, an imidazole group, a triazole group, a tetrazole group, or an azasilole group, and

the fourth ring may be an adamantane group, a norbornane group, a norbornene group, a cyclohexane group, a

cyclohexene group, a benzene group, a pyridine group, a pyrimidine group, a pyrazine group, a pyridazine group, or a triazine group.

The terms "fluorinated $C_1$-$C_{60}$ alkyl group (or a fluorinated $C_1$-$C_{20}$ alkyl group or the like)", "fluorinated $C_3$-$C_{10}$ cycloalkyl group", "fluorinated $C_1$-$C_{10}$ heterocycloalkyl group," and "fluorinated phenyl group" respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one fluoro group (-F). For example, the term "fluorinated $C_1$ alkyl group (that is, a fluorinated methyl group)" includes $-CF_3$, $-CF_2H$, and $-CFH_2$. The "fluorinated $C_1$-$C_{60}$ alkyl group (or, a fluorinated $C_1$-$C_{20}$ alkyl group, or the like)", "the fluorinated $C_3$-$C_{10}$ cycloalkyl group", "the fluorinated $C_1$-$C_{10}$ heterocycloalkyl group", or "the fluorinated a phenyl group" may be i) a fully fluorinated $C_1$-$C_{60}$ alkyl group (or, a fully fluorinated $C_1$-$C_{20}$ alkyl group, or the like), a fully fluorinated $C_3$-$C_{10}$ cycloalkyl group, a fully fluorinated $C_1$-$C_{10}$ heterocycloalkyl group, or a fully fluorinated phenyl group, wherein, in each group, all hydrogen included therein is substituted with a fluoro group, or ii) a partially fluorinated $C_1$-$C_{60}$ alkyl group (or, a partially fluorinated $C_1$-$C_{20}$ alkyl group, or the like), a partially fluorinated $C_3$-$C_{10}$ cycloalkyl group, a partially fluorinated $C_1$-$C_{10}$ heterocycloalkyl group, or partially fluorinated phenyl group, wherein, in each group, all hydrogen included therein is not substituted with a fluoro group.

The terms "deuterated $C_1$-$C_{60}$ alkyl group (or a deuterated $C_1$-$C_{20}$ alkyl group or the like)", "deuterated $C_3$-$C_{10}$ cycloalkyl group", "deuterated $C_1$-$C_{10}$ heterocycloalkyl group," and "deuterated phenyl group" respectively indicate a $C_1$-$C_{60}$ alkyl group (or a $C_1$-$C_{20}$ alkyl group or the like), a $C_3$-$C_{10}$ cycloalkyl group, a $C_1$-$C_{10}$ heterocycloalkyl group, and a phenyl group, each substituted with at least one deuterium. For example, the "deuterated $C_1$ alkyl group (that is, the deuterated methyl group)" may include - $CD_3$, $-CD_2H$, and $-CDH_2$, and examples of the "deuterated $C_3$-$C_{10}$ cycloalkyl group" are, for example, Formula 10-501 and the like. The "deuterated $C_1$-$C_{60}$ alkyl group (or, the deuterated $C_1$-$C_{20}$ alkyl group or the like)", "the deuterated $C_3$-$C_{10}$ cycloalkyl group", "the deuterated $C_1$-$C_{10}$ heterocycloalkyl group", or "the deuterated phenyl group" may be i) a fully deuterated $C_1$-$C_{60}$ alkyl group (or, a fully deuterated $C_1$-$C_{20}$ alkyl group or the like), a fully deuterated $C_3$-$C_{10}$ cycloalkyl group, a fully deuterated $C_1$-$C_{10}$ heterocycloalkyl group, or a fully deuterated phenyl group, in which, in each group, all hydrogen included therein are substituted with deuterium, or ii) a partially deuterated $C_1$-$C_{60}$ alkyl group (or, a partially deuterated $C_1$-$C_{20}$ alkyl group or the like), a partially deuterated $C_3$-$C_{10}$ cycloalkyl group, a partially deuterated $C_1$-$C_{10}$ heterocycloalkyl group, or a partially deuterated phenyl group, in which, in each group, all hydrogen included therein are not substituted with deuterium.

The term "($C_1$-$C_{20}$ alkyl) 'X' group" as used herein refers to a 'X' group that is substituted with at least one $C_1$-$C_{20}$ alkyl group. For example, the term "($C_1$-$C_{20}$ alkyl)$C_3$-$C_{10}$ cycloalkyl group" as used herein refers to a $C_3$-$C_{10}$ cycloalkyl group substituted with at least one $C_1$-$C_{20}$ alkyl group, and the term "($C_1$-$C_{20}$ alkyl)phenyl group" as used herein refers to a phenyl group substituted with at least one $C_1$-$C_{20}$ alkyl group. An example of a ($C_1$ alkyl) phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, and an azadibenzothiophene 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, and a dibenzothiophene 5,5-dioxide group," in which, in each group, at least one carbon selected from ring-forming carbons is substituted with nitrogen.

At least one substituent of the substituted $C_5$-$C_{30}$ carbocyclic group, the substituted $C_2$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkylaryl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted monovalent non-aromatic condensed polycyclic group, and the substituted monovalent non-aromatic condensed heteropolycyclic group may each independently be:

deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, a monovalent non-aromatic condensed heteropolycyclic group, $-N(Q_{11})(Q_{12})$, $-Si(Q_{13})(Q_{14})(Q_{15})$, $-B(Q_{16})(Q_{17})$, $-P(=O)(Q_{18})(Q_{19})$, - $P(Q_{18})(Q_{19})$, or any combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, or a monovalent non-aromatic condensed heteropolycyclic group, each unsubstituted or substituted with deuterium, -F, -Cl, -Br, -I, $-CD_3$, $-CD_2H$, $-CDH_2$, $-CF_3$, $-CF_2H$, $-CFH_2$, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group $C_3$-$C_{10}$ cycloalkyl group, a $C_1$-$C_{10}$ heterocycloalkyl group, a $C_3$-$C_{10}$ cycloalkenyl group, a $C_1$-$C_{10}$heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a monovalent non-aromatic condensed polycyclic group, a monovalent non-aromatic condensed heteropolycyclic group, $-N(Q_{21})(Q_{22})$, $-Si(Q_{23})(Q_{24})(Q_{25})$, - B(Q26)(Q27), $-P(=O)(Q_{28})(Q_{29})$, -P(Q28)(Q29), or any combination thereof;
-N(Q31)(Q32), $-Si(Q_{33})(Q_{34})(Q_{35})$, $-B(Q_{36})(Q_{37})$, $-P(=O)(Q_{38})(Q_{39})$, or - $P(Q_{38})(Q_{39})$; or
any combination thereof,
$Q_1$ to $Q_9$, $Q_{11}$ to $Q_{19}$, $Q_{21}$ to $Q_{29}$ and $Q_{31}$ to $Q_{39}$ described herein may each independently be: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a $C_1$-$C_{60}$ alkyl group which is unsubstituted or substituted with deuterium, a $C_1$-$C_{60}$ alkyl group, a $C_6$-$C_{60}$ aryl group, or any combination thereof; a $C_2$-$C_{60}$ alkenyl group; a $C_2$-$C_{60}$ alkynyl group; a $C_1$-$C_{60}$ alkoxy group; a $C_1$-$C_{60}$ alkylthio group; a $C_3$-$C_{10}$ cycloalkyl group; a $C_1$-$C_{10}$ heterocycloalkyl group; a $C_3$-$C_{10}$ cycloalkenyl group; a $C_1$-$C_{10}$ heterocycloalkenyl group; a $C_6$-$C_{60}$ aryl group which is unsubstituted or substituted with deuterium, a $C_1$-$C_{60}$ alkyl group, a $C_6$-$C_{60}$ aryl group, or any combination thereof; a $C_6$-$C_{60}$ aryloxy group; a $C_6$-$C_{60}$ arylthio group; a $C_1$-$C_{60}$ heteroaryl group; a monovalent non-aromatic condensed polycyclic group; or a monovalent non-aromatic condensed heteropolycyclic group.

For example, $Q_1$ to $Q_9$, $Q_{11}$ to $Q_{19}$, $Q_{21}$ to $Q_{29}$ and $Q_{31}$ to $Q_{39}$ described herein may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or - $CD_2CDH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, a $C_1$-$C_{10}$ alkyl group, a phenyl group, or any combination thereof.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

Examples

Synthesis Example 1 (D-Ir(1))

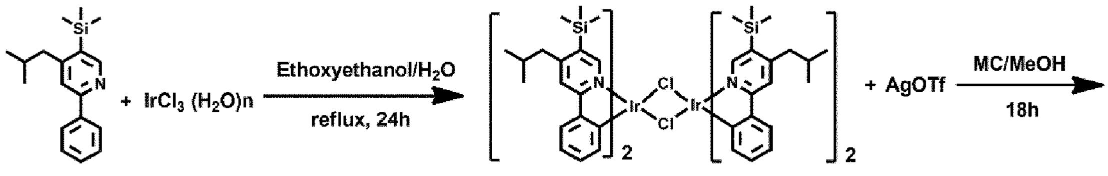


1390A

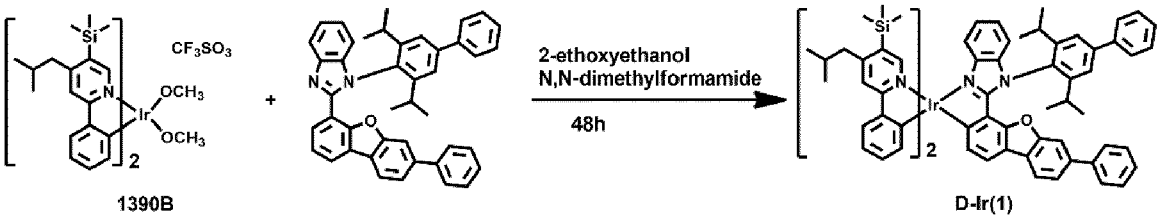


1390B D-Ir(1)

Synthesis of Compound 1390A

4-isobutyl-2-phenyl-5-(trimethylsilyl)pyridine (33.1 mmol) and iridium chloride ($IrCl_3(H_2O)_n$) (5.2 g, 14.7 mmol) were mixed with 120 mL of ethoxyethanol and 40 mL of distilled water and then, stirred under reflux for 24 hours, and then the temperature was lowered to room temperature. The resulting solid was separated by filtration, washed sufficiently with water, methanol, and hexane, in this stated order, and then dried in a vacuum oven to obtain 7.4 g (74% of yield) of Compound 1390A.

Synthesis of Compound 1390B

Compound 1390A (1.2 mmol) and 45mL of methylene chloride were mixed, and then, AgOTf (silver trifluoromethanesulfonate) (0.6 g, 2.3 mmol) was added thereto after being mixed with 15 mL of methanol. Thereafter, the mixture was stirred for 18 hours at room temperature while light was blocked with aluminum foil, and then filtered through Celite to remove the resulting solid, and the filtrate was subjected to reduced pressure to obtain a solid (Compound 1390B). Compound 1390B was used in the next reaction without an additional purification process.

Synthesis of D-Ir(1)(Compound 1390 of [Group 1-3])

Compound 1390B (2.3 mmol) and 1-(3,5-diisopropyl-[1,1'-biphenyl]-4-yl)-2-(7-phenyldibenzo[b,d]furan-4-yl)-1H-benzo[d]imidazole (2.8 mmol) were mixed with 50 mL of 2-ethoxyethanol and 50 mL of N,N-dimethylformamide and then, stirred under reflux for 48 hours and then, the temperature was lowered to a room temperature. The obtained mixture was subjected to a reduced pressure to obtain a solid, on which column chromatography (eluent: methylene chloride (MC) and hexane) was performed to obtain 0.56 g (yield of 39%) of D-Ir(1) (Compound 1390 of [Group 1-3]). The obtained compound was identified by mass spectrometry (MS) and high performance liquid chromatography (HPLC) analysis.

High resolution mass spectrometry (matrix-assisted laser desorption ionization) (HRMS(MALDI)) calcd for $C_{79}H_{83}IrN_4OSi_2$: m/z 1352.5735 Found: 1352.5733 Evaluation Example 1

The HOMO energy levels of the following compounds were found by the measurement using a photoelectron spectrometer (manufactured by RIKEN KEIKI Co., Ltd.: AC3) in air, and the found values are shown in Table 1.

Table 1

| | Compound | Measured value of HOMO energy level (eV) |
|---|---|---|
| Compounds used in Examples | HT(1) (Compound H1-8 of [Group 5-2]) | -5.60 |
| | HT(2) (Compound H1-2 of [Group 5-2]) | -5.58 |
| | E1-62 | -6.08 |
| | BP1-10 | -5.74 |
| | D-Ir(1) (Compound 1390 of [Group 1-3]) | -5.34 |
| Compounds used in Comparative Example 3 | CBP | -6.05 |
| | TCTA | -5.77 |
| | UGH3 | < -7.00 |
| | TAZ | -6.25 |
| - | $Ir(ppy)_3$ | -5.35 |

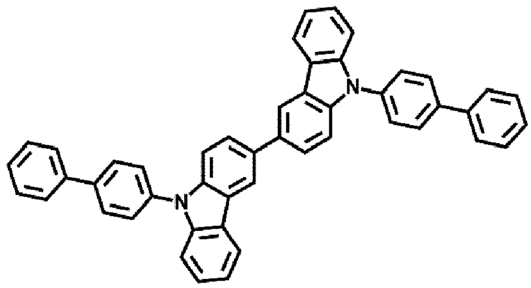

HT(1)

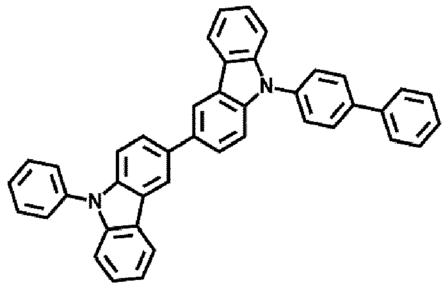

HT(2)

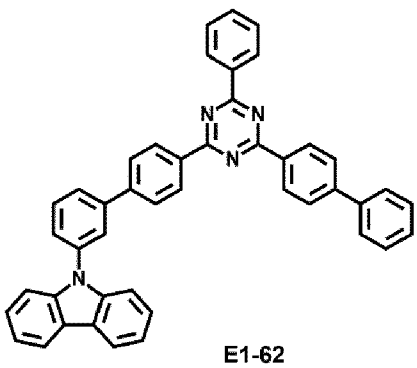

E1-62

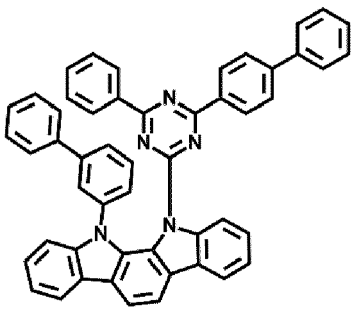

BP1-10

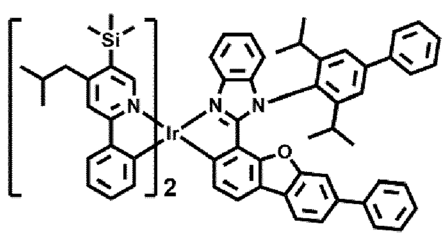

D-Ir(1)

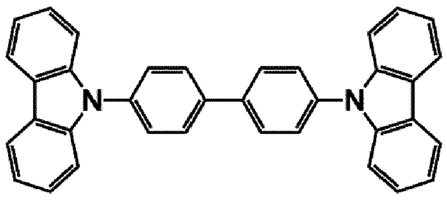

CBP

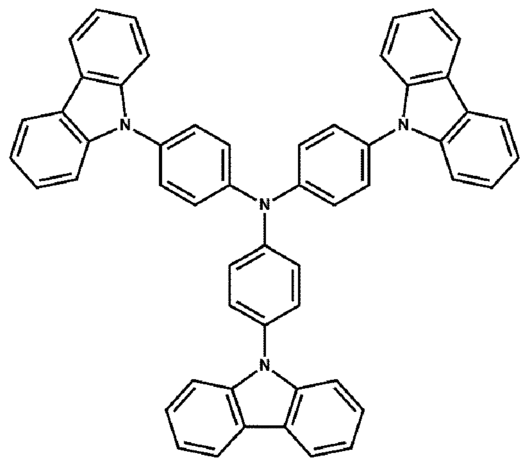

TCTA(4,4',4"-tris(carbazol-9-yl)triphenylamine)

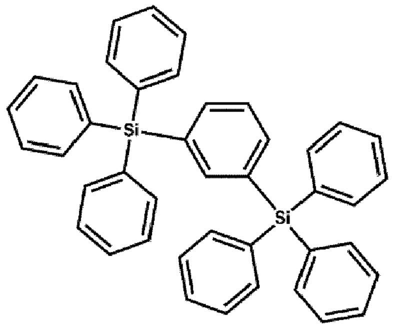

UGH3(m-bis-(triphenylsilyl)benzene)

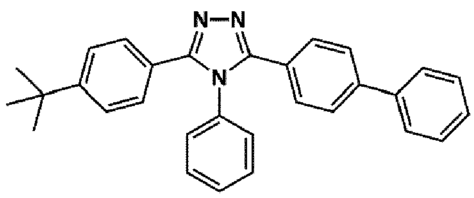

TAZ

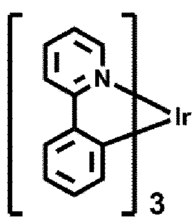

$Ir(ppy)_3$

Example 1

An ITO (as an anode)-patterned glass substrate was cut to a size of 50 mm x 50 mm x 0.5 mm, sonicated with isopropyl alcohol and pure water, each for 5 minutes, and then cleaned by exposure to ultraviolet rays and ozone for 30 minutes. The resultant glass substrate was loaded onto a vacuum deposition apparatus.

HT3 and F6-TCNNQ were vacuum deposited on the anode at the weight ratio of 98:2 to form a hole injection layer having a thickness of 100 Å, and then, HT3 was vacuum-deposited on the hole injection layer to form a hole-transporting layer having a thickness of 1,350 Å. HT(1) was vacuum-deposited on the hole-transporting layer to form an electron-blocking layer having a thickness of 300 Å.

Then, a first hole-transporting compound (HT(1)), a first compound (E1-62), and dopant ($Ir(ppy)_3$) were co-deposited on the electron-blocking layer to form a first emission layer having a thickness of 100 Å (10 nm), and a second hole-transporting compound (HT(2)), a second compound (BP1-10), and dopant ($Ir(ppy)_3$) were co-deposited on the first emission layer to form a second emission layer having a thickness of 300 Å (30 nm). The amount of the dopant in the first emission layer was 7 parts by weight based on 100 parts by weight of the first emission layer, the weight ratio of the first hole-transporting compound to the first compound in the first emission layer is shown in Table 2, and the amount of the dopant in the second emission layer was 7 parts by weight based on 100 parts by weight of the second emission layer, and the weight ratio of the second hole-transporting compound to the second compound in the second emission layers is shown in Table 2.

Then, ET3 and ET-D1 were co-deposited at the volume ratio of 50:50 on the emission layer to form an electron-transporting layer having a thickness of 350 Å, and ET-D1 was vacuum-deposited on the electron-transporting layer to form an electron injection layer having a thickness of 10 Å, and Al was vacuum-deposited on the electron injection layer to form a cathode having a thickness of 1000 Å, thereby completing the manufacture of an organic light-emitting device.

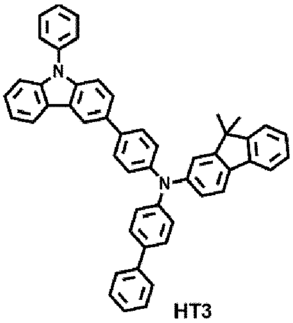
HT3

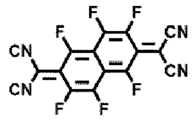
F6-TCNNQ

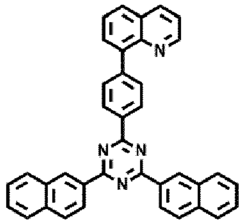
ET3

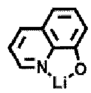
ET-D1

Comparative Examples 1 to 3

Organic light-emitting devices were manufactured in the same method as in Example 1, except that the configuration of an emission layer was changed as described in Table 2 (Comparative Example 1 did not include a second emission layer and Comparative Example 2 did not include a first emission layer)

Table 2

| Emission layer | | Example 1 | Comparative Example 1 | Comparative Example 2 | Comparative Example 3 |
|---|---|---|---|---|---|
| Second emission layer | Second hole-transporting compound | HT(2) | - | HT(2) | TCTA |
| | Second compound | BP1-10 | - | BP1-10 | TAZ |
| | Dopant | $Ir(ppy)_3$ | - | $Ir(ppy)_3$ | $Ir(ppy)_3$ |
| | Absolute value of the difference between the HOMO energy level of the second hole-transporting compound and the HOMO energy level of the second compound | 0.16eV | - | 0.16eV | 0.48eV |
| | weight ratio of second hole-transporting compound to second compound | 5:5 | - | 5:5 | 5:5 |
| | thickness of the second emission layer | 30 nm | - | 40 nm | 30 nm |
| First emission layer | First hole-transporting compound | HT(1) | HT(1) | - | CBP |
| | First compound | E1-62 | E1-62 | - | UGH3 |
| | Dopant | $Ir(ppy)_3$ | $Ir(ppy)_3$ | - | $Ir(ppy)_3$ |
| | Weight ratio of first hole-transporting compound to first compound | 7.5:2.5 | 7.5:2.5 | - | 7.5:2.5 |
| | Thickness of the first emission layer | 10 nm | 40 nm | - | 10 nm |

Evaluation Example 2

For each of the organic light-emitting devices manufactured in Example 1 and Comparative Examples 1 to 3, the driving voltage (V), maximum value of luminescence efficiency (cd/A), roll-off ratio (%), power efficiency (lm/W), and lifespan($LT_{97}$) were evaluated, and the results are shown in Table 3. As an evaluation device, a current-voltmeter (Keithley 2400) and a luminance meter (Minolta Cs-1000A) were used, and the lifespan ($LT_{97}$) (at 8000 nit) was evaluated as the time taken for luminance to reduce to 97% of 100% of the initial luminance. Lifespan ($LT_{97}$) of Table 3 was represented as a relative value (%). The roll-off ratio was calculated according to Equation 20 below.

<Equation 20>

Roll-off ratio= {1- (luminescence efficiency (at 8000nit) / maximum luminescence efficiency)} X 100%

Table 3

| | Driving voltage (V) | Maximum value of current efficiency (cd/A) (Relative value, %) | Roll-off ratio (%) | Power efficiency (lm/W at 8000nit) (Relative value, %) | $LT_{97}$ (Relative value, %) |
|---|---|---|---|---|---|
| Example 1 | 4.1 | 107 | 13 | 121 | 155 |
| Comparative Example 1 | 4.5 | 100 | 17 | 100 | 100 |
| Comparative Example 2 | 4.4 | 103 | 17 | 104 | 81 |
| Comparative Example 3 | 5.2 | 75 | 28 | 55 | 7 |

From Table 3, it is confirmed that the organic light-emitting device of Example 1 has improved characteristics in terms of driving voltage, luminescence efficiency, roll-off ratio, power efficiency and lifespan, compared to the organic light-emitting devices of Comparative Examples 1 to 3.

Examples 11 to 16

Organic light-emitting devices were manufactured in the same manner as in Example 1, except that the configuration of an emission layer is changed as shown in Table 4.

Table 4

| Emission layer | | Example 11 | Example 12 | Example 13 | Example 14 | Example 15 | Example 16 |
|---|---|---|---|---|---|---|---|
| Second emission layer | Second hole-transporting compound | HT(2) | HT(2) | HT(2) | HT(2) | HT(2) | HT(2) |
| | Second compound | BP1-10 | BP1-10 | BP1-10 | BP1-10 | BP1-10 | BP1-10 |
| | Dopant | D-Ir(1) | D-Ir(1) | D-Ir(1) | D-Ir(1) | D-Ir(1) | D-Ir(1) |
| | Weight ratio of second hole-transporting compound and second compound | 6:4 | 5:5 | 4:6 | 5:5 | 4:6 | 3:7 |
| | Thickness of the second emission layer | 30 nm | 30 nm | 30 nm | 20 nm | 20 nm | 20 nm |

(continued)

| Emission layer | | Example 11 | Example 12 | Example 13 | Example 14 | Example 15 | Example 16 |
|---|---|---|---|---|---|---|---|
| First emission layer | First hole-transporting compound | HT(1) | HT(1) | HT(1) | HT(1) | HT(1) | HT(1) |
| | First compound | E1-62 | E1-62 | E1-62 | E1-62 | E1-62 | E1-62 |
| | Dopant | D-Ir(1) | D-Ir(1) | D-Ir(1) | D-Ir(1) | D-Ir(1) | D-Ir(1) |
| | Weight ratio of first hole-transporting compound to first compound | 7.5:2.5 | 7.5:2.5 | 7.5:2.5 | 7.5:2.5 | 7.5:2.5 | 7.5:2.5 |
| | Thickness of the first emission layer | 10 nm | 10 nm | 10 nm | 20 nm | 20 nm | 20 nm |

Evaluation Example 3

For each of the organic light-emitting devices manufactured according to Examples 11 to 16, the driving voltage (V), the maximum value of luminescence efficiency (cd/A), the roll-off ratio (%), power efficiency (lm/W), and the lifespan ($LT_{97}$) were evaluated by using the same method as described in Evaluation Example 2, and the results are shown in Table 5. For reference, the data of Comparative Example 3 are shown in Table 5.

Table 5

| | Driving voltage (V) | | Maximum value of current efficiency (cd/A) (Relative value, %) | Roll-off ratio (%) | Power efficiency (lm/W at 8000 nit) (Relative value, %) | $LT_{97}$ (Relative value, %) |
|---|---|---|---|---|---|---|
| Comparative Example 3 | 5.2 | | 75 | 28 | 55 | 7 |
| Example 11 | 3.8 | | 144 | 10 | 184 | 479 |
| Example 12 | 3.5 | | 148 | 9 | 203 | 424 |
| Example 13 | 3.5 | | 141 | 9 | 199 | 386 |
| Example 14 | 3.9 | | 144 | 8 | 183 | 548 |
| Example 15 | 3.8 | | 142 | 8 | 184 | 545 |
| Example 16 | 3.7 | | 144 | 6 | 193 | 445 |

From Table 5, it can be seen that the organic light-emitting devices of Examples 11 to 16 have excellent characteristics in terms of driving voltage, luminescence efficiency, roll-off ratio, power efficiency and lifespan.

Light-emitting devices according to embodiments of the present disclosure have excellent characteristics in terms of driving voltage, luminescence efficiency, roll-off ratio, power efficiency and lifespan. Accordingly, high-quality electronic devices can be manufactured using the light-emitting devices.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

**1.** A light-emitting device comprising:

a first electrode;

a second electrode facing the first electrode; and
an emission layer between the first electrode and the second electrode,

wherein

the emission layer comprises i) a first emission layer and ii) a second emission layer located between the first emission layer and the second electrode,
the first emission layer is in direct contact with the second emission layer,
the first emission layer comprises a dopant, a first hole-transporting compound, and a first compound,
the second emission layer comprises a dopant, a second hole-transporting compound, and a second compound,
the dopant included in the first emission layer and the dopant included in the second emission layer are identical to each other,
the first compound and the second compound are different from each other,
an absolute value of the difference between a highest occupied molecular orbital (HOMO) energy level of the second hole-transporting compound and a HOMO energy level of the second compound is 0.3 eV or less, and
a HOMO energy level of the second hole-transporting compound and a HOMO energy level of the second compound are each a negative value measured by using a photoelectron spectroscopy in air.

**2.** The light-emitting device of claim 1, wherein the dopant is a phosphorescent dopant.

**3.** The light-emitting device of claims 1 or 2, wherein the first hole-transporting compound and the second hole-transporting compound are different from each other.

**4.** The light-emitting device of any of claims 1-3, wherein the first hole-transporting compound and the second hole-transporting compound are identical to each other.

**5.** The light-emitting device of any of claims 1-4, wherein a minimum value of the HOMO energy level of the first hole-transporting compound and the HOMO energy level of the second hole-transporting compound is -5.80 eV or more.

**6.** The light-emitting device of any of claims 1-5, wherein the HOMO energy level of the first hole-transporting compound and the HOMO energy level of the second hole-transporting compound are each -5.80 eV or more.

**7.** The light-emitting device of any of claims 1-6, wherein the HOMO energy level of the first compound is smaller than the HOMO energy level of the second compound; and/or
wherein the HOMO energy level of the first compound and the HOMO energy level of the second compound are each -6.15 eV or more.

**8.** The light-emitting device of any of claims 1-7, wherein the HOMO energy level of the second compound is -6.00 eV or more, preferably -5.80 eV or more.

**9.** The light-emitting device of any of claims 1-8, wherein an absolute value of the difference between the HOMO energy level of the second hole-transporting compound and the HOMO energy level of the second compound is 0.16 eV or less; and/or
wherein a maximum value from among the HOMO energy level of the first hole-transporting compound, the HOMO energy level of the first compound, the HOMO energy level of the second hole-transporting compound, and the HOMO energy level of the second compound is smaller than a HOMO energy level of the dopant.

**10.** The light-emitting device of any of claims 1-9, wherein a HOMO energy level of the dopant is from -5.60 eV to -5.20 eV.

**11.** The light-emitting device of any of claims 1-10, wherein a thickness of the second emission layer is identical to a thickness of the first emission layer; or
wherein a thickness of the second emission layer is greater than a thickness of the first emission layer.

**12.** The light-emitting device of any of claims 1-11, wherein light emitted from the emission layer to the outside through at least one of the first electrode and the second electrode is not white light.

**13.** The light-emitting device of any of claims 1-12, wherein light emitted from the emission layer to the outside through at least one of the first electrode and the second electrode is green light having a maximum emission wavelength

of 500 nm to 580 nm.

**14.** The light-emitting device of any of claims 1-13, further comprising a hole-transporting region located between the first electrode and the emission layer, wherein the hole-transporting region does not include a charge-generation layer and an emission layer; and/or
further comprising an electron-transporting region, which is located between the emission layer and the second electrode, wherein the electron-transporting region does not include a charge-generation layer and an emission layer.

**15.** An electronic apparatus comprising the light-emitting device of any of claims 1-14.

FIG. 1

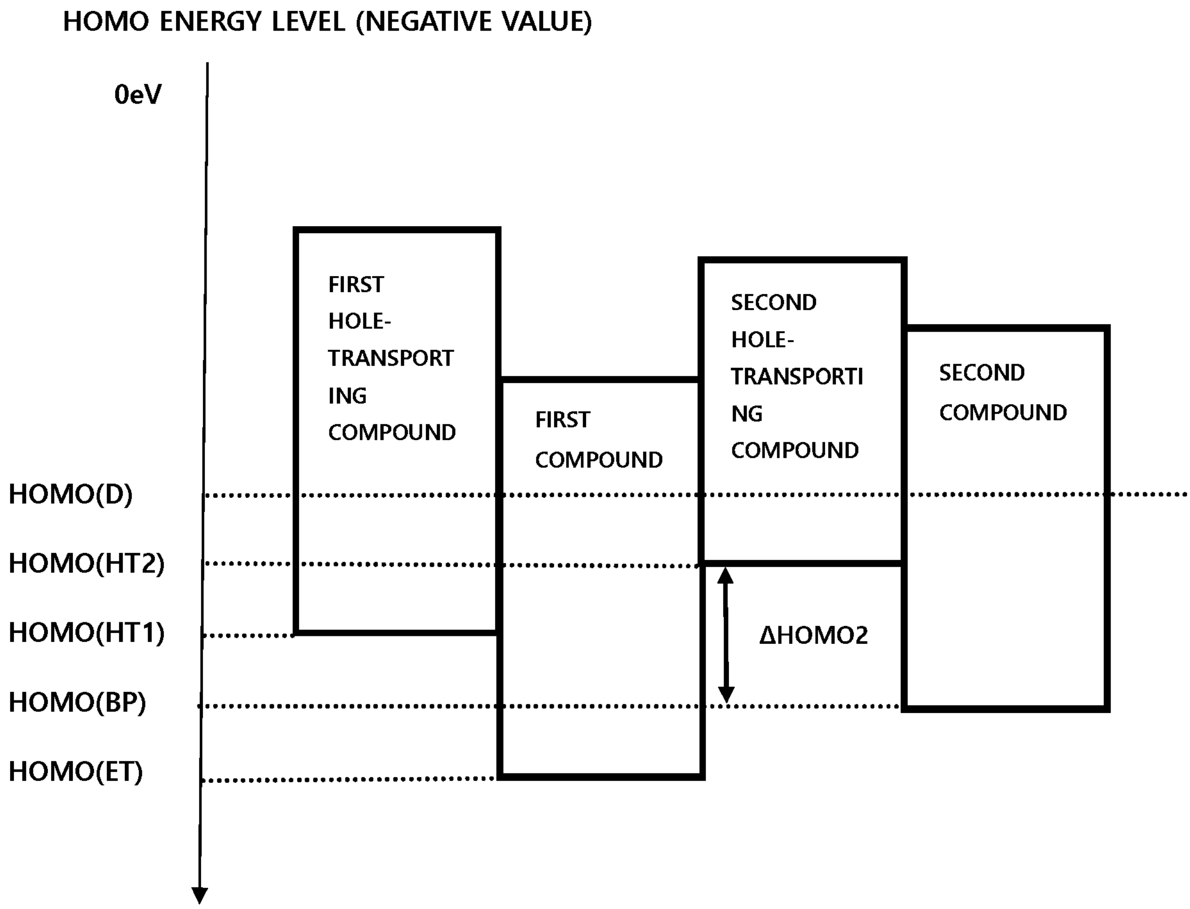
HOMO ENERGY LEVEL (NEGATIVE VALUE)
0eV
FIRST HOLE-TRANSPORTING COMPOUND
FIRST COMPOUND
SECOND HOLE-TRANSPORTING COMPOUND
SECOND COMPOUND
HOMO(D)
HOMO(HT2)
HOMO(HT1)
HOMO(BP)
HOMO(ET)
ΔHOMO2

FIG. 2

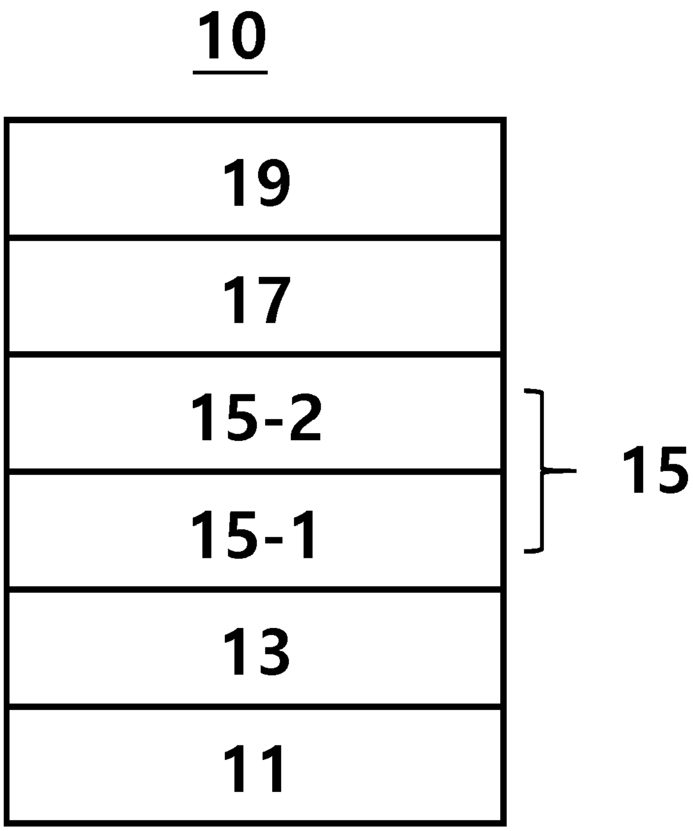

Europäisches Patentamt
European Patent Office
Office européen des brevets

# EUROPEAN SEARCH REPORT

Application Number
EP 21 20 8148

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2020/274087 A1 (LEE JAEHYUN [KR] ET AL) 27 August 2020 (2020-08-27) * Experimental Example 12; page 48, paragraph 319 - paragraph 328; claim 1 * * page 41, paragraph 237 * ----- | 1-15 | INV. H01L51/54 |

TECHNICAL FIELDS SEARCHED (IPC)

H01L

The present search report has been drawn up for all claims

1

| Place of search | Date of completion of the search | Examiner |
|---|---|---|
| The Hague | 1 April 2022 | Parashkov, Radoslav |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.......................................................................
& : member of the same patent family, corresponding document

EPO FORM 1503 03.82 (P04C01)

## ANNEX TO THE EUROPEAN SEARCH REPORT ON EUROPEAN PATENT APPLICATION NO. EP 21 20 8148

This annex lists the patent family members relating to the patent documents cited in the above-mentioned European search report. The members are as contained in the European Patent Office EDP file on
The European Patent Office is in no way liable for these particulars which are merely given for the purpose of information.

01-04-2022

| Patent document cited in search report | Publication date | Patent family member(s) | Publication date |
|---|---|---|---|
| US 2020274087 A1 | 27-08-2020 | CN 111613730 A | 01-09-2020 |
| | | KR 20200103235 A | 02-09-2020 |
| | | US 2020274087 A1 | 27-08-2020 |

EPO FORM P0459

For more details about this annex : see Official Journal of the European Patent Office, No. 12/82